# EUROPEAN PATENT APPLICATION

(11) **EP 4 714 962 A2**
(43) Date of publication of application: **25.03.2026**
(21) Application number: 25192787.7
(22) Date of filing: 30.07.2025
(51) Int. Cl.: C07F 15/00, C09K 11/06, H10K 85/30, H10K 50/11

(54) **ORGANIC ELECTROLUMINESCENT MATERIALS AND DEVICES**

(30) Priority: 01.08.2024 US 202463678268 P; 23.08.2024 US 202418814301; 19.12.2024 US 202463736461 P; 24.12.2024 US 202463738566 P; 05.02.2025 US 202563754002 P; 10.04.2025 US 202519176025; 23.04.2025 US 202563793115 P; 28.04.2025 US 202563795731 P; 23.07.2025 US 202519277464
(71) Applicant: Universal Display Corporation, Ewing, NJ 08618 (US)
(72) Inventor: WOZNIAK, Derek Ian, Ewing, 08618 (US); SHIH, Wei-Chun, Ewing, 08618 (US); YEAGER, Walter, Ewing, 08618 (US); FELDMAN, Jerald, Ewing, 08618 (US); BOUDREAULT, Pierre-Luc T., Ewing, 08618 (US); TUDGE, Matthew T., Ewing, 08618 (US); TSAI, Jui-Yi, Ewing, 08618 (US); DYATKIN, Alexey Borisovich, Ewing, 08618 (US); CHEN, Hsiao-Fan, Ewing, 08618 (US); FLEETHAM, Tyler, Ewing, 08618 (US); TOTOKOTSOPOULOS, Sotirios, Ewing, 08618 (US)
(74) Representative: Dragotti & Associati S.P.A.

(57) **Abstract**

A compound having a first ligand L_{A} with a structure of Formula I 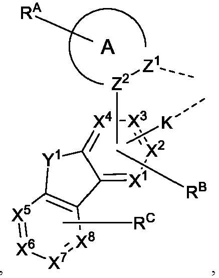 where two consecutive ones of X¹ to X⁸ are C and are joined to a structure of Formula II, 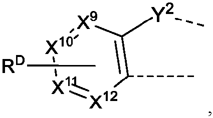 is provided. In Formula I, moiety A is a monocyclic ring or a polycyclic fused ring system; each of Z¹ to Z² and X¹ to X¹² is C or N; each of Y¹ and Y² is a linker; K is a direct bond or a linker; each substituent is hydrogen or a General Substituent defined herein; and L_{A} is coordinated to a metal M. Also provided is a compound having a formula Ir(L_{A*})ₓ(L_{B*})_{y}(L_{C*})_{z} as defined herein. Formulations, OLEDs, and consumer products containing these compounds are further provided.

## Description

### CROSS-REFERENCES TO RELATED APPLICATIONS

This application is a continuation-in-part of co-pending United States patent application Nos. 18/814,301, filed on August 23, 2024, and 19/176,025, filed on April 10, 2025. This application also claims priority under 35 U.S.C. § 119(e) to United States Provisional Application No. 63/678,268, filed August 1, 2024, United States Provisional Application No. 63/754,002, filed February 5, 2025, United States Provisional Application No. 63/793,115, filed April 23, 2025, United States Provisional Application No. 63/738,566, filed December 24, 2024, , United States Provisional Application No. 63/795,731, filed April 28, 2025, and United States Provisional Application No. 63/736,461, filed December 19, 2024, and the entire contents of all the above referenced applications are incorporated herein by reference.

### FIELD

The present disclosure generally relates to organic or metal coordination compounds and formulations and their various uses including as emitters, sensitizers, charge transporters, or exciton transporters in devices such as organic light emitting diodes and related electronic devices and consumer products.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, organic scintillators, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as displays, illumination, and backlighting.

One application for emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

### SUMMARY

In one aspect, the present disclosure provides a compound having a first ligand L_{A} comprising a structure of Formula I, 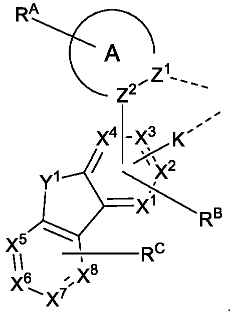 In Formula I:
two adjacent X¹ to X⁸ are C and are joined to a structure of Formula II, 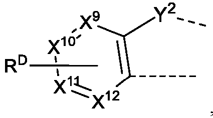 or to a structure of 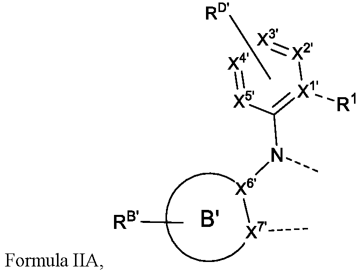 through the indicated dashed lines;
each of moiety A and moiety B' is independently a monocyclic ring or a polycyclic fused ring system, wherein the monocyclic ring or each ring of the
each of Z¹, Z², X^{1'} to X^{7'}, and X¹ to X¹² is independently C or N;
each of Y¹ and Y² is independently selected from the group consisting of BR, BRR', NR, PR, P(O)R, O, S, Se, C=O, C=S, C=Se, C=NR', C=CRR', S=O, SO₂, CRR', SiRR', GeRR';
K is selected from the group consisting of a direct bond, O, S, N(R^{α}), P(R^{α}), B(R^{α}), C(R^{α})(R^{β}), and Si(R^{α})(R^{β}),
each of R^{A}, R^{B}, R^{B'}, R^{C}, R^{D}, and R^{D'} independently represents mono to the maximum allowable substitution, or no substitution;
each R, R', R^{α}, R^{β}, R^{A}, R^{B}, R^{B'}, R^{C}, R^{D}, and R^{D'} is independently hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
any two substituents may be joined or fused to form a ring;
L_{A} is coordinated to a metal M;
metal M is selected from the group consisting of Ir, Rh, Re, Ru, Os, Pt, Pd, Ag, Au, and Cu.
metal M may be coordinated to other ligands; and
the first ligand L_{A} may be joined with other ligands to comprise a tridentate, tetradentate, pentadentate, or hexadentate ligand.

In another aspect, the present disclosure also provides a compound having a formula Ir(L_{A*})ₓ(L_{B*})_{y}(L_{C*})_{z} as defined herein.

In another aspect, the present disclosure provides a formulation comprising a compound having a first ligand L_{A} comprising a structure of Formula I or a compound having a formula Ir(L_{A*})iL_{B*})_{y}(L_{C*})_{z} as defined herein.

In yet another aspect, the present disclosure provides an OLED having an organic layer comprising a compound having a first ligand L_{A} comprising a structure of Formula I or a compound having a formula Ir(L_{A*})ₓ(L_{B*})_{y}(L_{C*})_{z} as defined herein.

In yet another aspect, the present disclosure provides a consumer product comprising an OLED with an organic layer comprising a compound having a first ligand L_{A} comprising a structure of Formula I or a compound having a formula Ir(L_{A*})ₓ(L_{B*})_{y}(L_{C*})_{z} as defined herein.

### BRIEF DESCRIPTION OF THE DRAWINGS

FIG. 1 shows an organic light emitting device.
FIG. 2 shows an inverted organic light emitting device that does not have a separate electron transport layer.

### DETAILED DESCRIPTION

### A. Terminology

Unless otherwise specified, the below terms used herein are defined as follows:

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

Layers, materials, regions, and devices may be described herein in reference to the color of light they emit. In general, as used herein, an emissive region that is described as producing a specific color of light may include one or more emissive layers disposed over each other in a stack.

As used herein, a "NIR", "red", "green", "blue", "yellow" layer, material, region, or device refers to a layer, a material, a region, or a device that emits light in the wavelength range of about 700-1500 nm, 580-700 nm, 500-600 nm, 400-500 nm, 540-600 nm, respectively, or a layer, a material, a region, or a device that has a highest peak in its emission spectrum in the respective wavelength region. In some arrangements, separate regions, layers, materials, or devices may provide separate "deep blue" and "light blue" emissions. As used herein, the "deep blue" emission component refers to an emission having a peak emission wavelength that is at least about 4 nm less than the peak emission wavelength of the "light blue" emission component. Typically, a "light blue" emission component has a peak emission wavelength in the range of about 465-500 nm, and a "deep blue" emission component has a peak emission wavelength in the range of about 400-470 nm, though these ranges may vary for some configurations.

In some arrangements, a color altering layer that converts, modifies, or shifts the color of the light emitted by another layer to an emission having a different wavelength is provided. Such a color altering layer can be formulated to shift wavelength of the light emitted by the other layer by a defined amount, as measured by the difference in the wavelength of the emitted light and the wavelength of the resulting light. In general, there are two classes of color altering layers: color filters that modify a spectrum by removing light of unwanted wavelengths, and color changing layers that convert photons of higher energy to lower energy. For example, a "red" color filter can be present in order to filter an input light to remove light having a wavelength outside the range of about 580-700 nm. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material, region, or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| **Color** | **CIE Shape Parameters** |
|---|---|
| Central Red | Locus: [0.6270,0.3725];[0.7347,0.2653]; |
| | Interior: [0.5086,0.2657] |
| Central Green | Locus: [0.0326,0.3530];[0.3731,0.6245]; |
| | Interior: [0.2268,0.3321 |
| Central Blue | Locus: [0.1746,0.0052];[0.0326,0.3530]; |
| | Interior: [0.2268,0.3321] |
| Central Yellow | Locus: [0.3731,0.6245];[0.6270,0.3725]; |
| | Interior: [0.3700,0.4087];[0.2886,0.4572] |

The terms "halo," "halogen," and "halide" are used interchangeably and refer to fluorine, chlorine, bromine, and iodine.

The term "acyl" refers to a substituted carbonyl group (-C(O)-Rₛ).

The term "ester" refers to a substituted oxycarbonyl (-O-C(O)-Rₛ or -C(O)-O-Rₛ) group.

The term "ether" refers to an -ORₛ group.

The terms "sulfanyl" or "thio-ether" are used interchangeably and refer to a -SRₛ group.

The term "selenyl" refers to a -SeRₛ group.

The term "sulfinyl" refers to a -S(O)-Rₛ group.

The term "sulfonyl" refers to a -SO₂-Rₛ group.

The term "phosphino" refers to a group containing at least one phosphorus atom bonded to the relevant structure. Common examples of phosphino groups include, but are not limited to, groups such as a -P(Rₛ)₂ group or a -PO(Rₛ)₂ group, wherein each Rₛ can be same or different.

The term "silyl" refers to a group containing at least one silicon atom bonded to the relevant structure. Common examples of silyl groups include, but are not limited to, groups such as a -Si(Rₛ)₃ group, wherein each Rₛ can be same or different.

The term "germyl" refers to a group containing at least one germanium atom bonded to the relevant structure. Common examples of germyl groups include, but are not limited to, groups such as a -Ge(Rₛ)₃ group, wherein each Rₛ can be same or different.

The term "boryl" refers to a group containing at least one boron atom bonded to the relevant structure. Common examples of boryl groups include, but are not limited to, groups such as a -B(Rₛ)₂ group or its Lewis adduct -B(Rₛ)₃ group, wherein Rₛ can be same or different.

In each of the above, Rₛ can be hydrogen or a substituent selected from the group consisting of the general substituents as defined in this application. Preferred Rₛ is selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. More preferably Rₛ is selected from the group consisting of alkyl, cycloalkyl, aryl, heteroaryl, and combination thereof.

The term "alkyl" refers to and includes both straight and branched chain alkyl groups having an alkyl carbon atom bonded to the relevant structure. Preferred alkyl groups are those containing from one to fifteen carbon atoms, preferably one to nine carbon atoms, and the preferred alkyl groups include methyl, ethyl, n-propyl, iso-propyl, n-butyl, sec-butyl, iso-butyl, tert-butyl, n-pentyl, 2-methylbutyl, 3-methylbutyl, 2,2-dimethylpropyl, 1,3-dimethylpropyl, 1,1-dimethylpropyl, 2-ethylpropyl, 1,2-dimethylpropyl, n-hexyl, 2-methylpentyl, 3-methylpentyl, 2,2-dimethylbutyl, 2,3-dimethylbutyl, n-heptyl, 2-methylhexyl, 3-methylhexyl, 2,2-dimethylpentyl, 2,3-dimethylpentyl, 2,4-dimethylpentyl, 3,3-dimethylpentyl, 3-ethylpentyl, 2,2,3-trimethylbutyl, and the like. Additionally, the alkyl group can be further substituted.

The term "cycloalkyl" refers to and includes monocyclic, polycyclic, and spiro alkyl groups having a ring alkyl carbon atom bonded to the relevant structure. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group can be further substituted.

The terms "heteroalkyl" or "heterocycloalkyl" refer to an alkyl or a cycloalkyl group, respectively, having at least one carbon atom replaced by a heteroatom. Optionally the at least one heteroatom is selected from O, S, N, P, B, Si, Ge and Se, preferably, O, S or N. Additionally, the heteroalkyl or heterocycloalkyl group can be further substituted.

The term "alkenyl" refers to and includes both straight and branched chain alkene groups. Alkenyl groups are essentially alkyl groups that include at least one carbon-carbon double bond in the alkyl chain with one carbon atom from the carbon-carbon double bond that is bonded to the relevant structure. Cycloalkenyl groups are essentially cycloalkyl groups that include at least one carbon-carbon double bond in the cycloalkyl ring. The term "heteroalkenyl" as used herein refers to an alkenyl group having at least one carbon atom replaced by a heteroatom. Optionally the at least one heteroatom is selected from O, S, N, P, B, Si, Ge, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group can be further substituted.

The term "alkynyl" refers to and includes both straight and branched chain alkyne groups. Alkynyl groups are essentially alkyl groups that include at least one carbon-carbon triple bond in the alkyl chain with one carbon atom from the carbon-carbon triple bond that is bonded to the relevant structure. Preferred alkynyl groups are those containing two to fifteen carbon atoms. Additionally, the alkynyl group can be further substituted.

The terms "aralkyl" or "arylalkyl" are used interchangeably and refer to an aryl-substituted alkyl group having an alkyl carbon atom bonded to the relevant structure. Additionally, the aralkyl group can be further substituted.

The term "heterocyclic group" refers to and includes aromatic and non-aromatic cyclic groups containing at least one heteroatom. Optionally the at least one heteroatom is selected from O, S, Se, N, P, B, Si, Ge, and Se, preferably, O, S, N, or B. Hetero-aromatic cyclic groups may be used interchangeably with heteroaryl. Preferred hetero-non-aromatic cyclic groups are those containing 3 to 10 ring atoms, preferably those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group can be further substituted or fused.

The term "aryl" refers to and includes both single-ring and polycyclic aromatic hydrocarbyl groups. The polycyclic rings may have two or more rings in which two carbons are common to two adjoining rings (the rings are "fused"). Preferred aryl groups are those containing six to thirty carbon atoms, preferably six to twenty-four carbon atoms, six to eighteen carbon atoms, and more preferably six to twelve carbon atoms. Especially preferred is an aryl group having six carbons, ten carbons, twelve carbons, fourteen carbons, or eighteen carbons. Suitable aryl groups include phenyl, biphenyl, triphenyl, triphenylene, tetraphenylene, naphthalene, anthracene, phenalene, phenanthrene, pyrene, chrysene, perylene, and azulene, preferably phenyl, biphenyl, triphenyl, triphenylene, and naphthalene. Additionally, the aryl group can be further substituted or fused, such as, without limitation, fluorene.

The term "heteroaryl" refers to and includes both single-ring aromatic groups and polycyclic aromatic ring systems that include at least one heteroatom. The heteroatoms include, but are not limited to O, S, Se, N, P, B, Si, Ge, and Se. In many instances, O, S, N, or B are the preferred heteroatoms. Hetero-single ring aromatic systems are preferably single rings with 5 or 6 ring atoms, and the ring can have from one to six heteroatoms. The hetero-polycyclic ring systems can have two or more aromatic rings in which two atoms are common to two adjoining rings (the rings are "fused") wherein at least one of the rings is a heteroaryl. The hetero-polycyclic aromatic ring systems can have from one to six heteroatoms per ring of the polycyclic aromatic ring system. Preferred heteroaryl groups are those containing three to thirty carbon atoms, preferably three to twenty-four carbon atoms, three to eighteen carbon atoms, and more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, selenophenodipyridine, azaborine, borazine, 5λ²,9λ²-diaza-13b-boranaphtho[2,3,4-*de*]anthracene, 5λ²-benzo[*d*]benzo[4,5]imidazo[3,2-*a*]imidazole, and 5,9-dioxa-13b-boranaphtho[3,2,1-*de*]anthracene, preferably dibenzothiophene, dibenzofuran, dibenzoselenophene, carbazole, indolocarbazole, imidazole, pyridine, triazine, benzimidazole, 5λ²,9λ²-diaza-13b-boranaphtho[2,3,4-*de*]anthracene, 5λ²-benzo[*d*]benzo[4,5]imidazo[3,2-*a*]imidazole, and 5,9-dioxa-13b-boranaphtho[3,2,1-*de*]anthracene. Additionally, the heteroaryl group can be further substituted or fused.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, benzimidazole, 5λ²,9λ²-diaza-13b-boranaphtho[2,3,4-*de*]anthracene, 5λ²-benzo[*d*]benzo[4,5]imidazo[3,2-*a*]imidazole, 5,9-dioxa-13b-boranaphtho[3,2,1-*de*]anthracene, and the respective aza-analogs of each thereof are of particular interest.

In many instances, the General Substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the Preferred General Substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the More Preferred General Substituents are selected from the group consisting of deuterium, fluorine, alkyl, cycloalkyl, alkoxy, aryloxy, amino, silyl, germyl, boryl, aryl, heteroaryl, nitrile, sulfanyl, and combinations thereof.

In some instances, the Even More Preferred General Substituents are selected from the group consisting of deuterium, fluorine, alkyl, cycloalkyl, silyl, aryl, heteroaryl, nitrile, and combinations thereof.

In yet other instances, the Most Preferred General Substituents are selected from the group consisting of deuterium, alkyl, cycloalkyl, aryl, heteroaryl, and combinations thereof.

In the event one or more substituents (*e.g.,* R, R', R", R^{A}, R^{A}, R¹, R₁, etc.) is not specifically defined, each of the one or more substituents shall be understood to independently represent hydrogen or a substituent selected from the group consisting of the General Substituents defined herein. Similarly, each of the one or more substituents can optionally be joined or fused with another substituent to form a ring. It shall also be understood that any substituent that can be selected from the General Substituents defined herein can also be selected from the Preferred General Substituents defined herein, the More Preferred General Substituents defined herein, the Even More Preferred General Substituents defined herein, or the Most Preferred General Substituents defined herein.

The terms "substituted" and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for all available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f*,*h*]quinoxaline and dibenzo[*f*,*h*]quinoline One of ordinary skill in the art can readily envision other nitrogen analogs of the aza-derivatives described above, and all such analogs are intended to be encompassed by the terms as set forth herein.

The present disclosure includes all acceptable isotopically-labelled compounds of the present disclosure wherein one or more atoms are replaced by atoms having the same atomic number, but an atomic mass or mass number different from the atomic mass or mass number usually found in nature.

Examples of isotopes suitable for inclusion in the compounds of the present disclosure include isotopes of hydrogen, such as ²H and ³H, carbon, such as ¹¹C, ¹³C and ¹⁴C, chlorine, such as ³⁶Cl, fluorine, such as ¹⁸F, iodine, such as ¹²³I, ¹²⁴I and ¹²⁵I, nitrogen, such as ¹³N and ¹⁵N, oxygen, such as ¹⁵O, ¹⁷O and ¹⁸O, phosphorus, such as ³²P, and sulphur, such as ³⁵S.

Certain isotopically-labelled compounds of the present disclosure, for example, those incorporating a radioactive isotope, are useful in diagnostic and other studies. The radioactive isotopes tritium, i.e.³H, and carbon-14, i.e. ¹⁴C, are particularly useful for this purpose in view of their ease of incorporation and ready means of detection.

Substitution with heavier isotopes such as deuterium, i.e. ²H, may afford certain advantages resulting from greater stability, and hence may be preferred in some circumstances.

Isotopically labelled compounds of the invention can generally be prepared by conventional techniques known to those skilled in the art or by processes analogous to those described in the accompanying Examples and Preparations using an appropriate isotopically labelled reagent in place of the non-labelled reagent previously employed.

For example, deuterated compounds can be readily prepared using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

As used herein, any specifically listed substituent, such as, without limitation, methyl, phenyl, pyridyl, etc. includes undeuterated, partially deuterated, and fully deuterated versions thereof. Similarly, classes of substituents such as, without limitation, alkyl, aryl, cycloalkyl, heteroaryl, etc. also include undeuterated, partially deuterated, and fully deuterated versions thereof. Unless otherwise specified, atoms in chemical structures without valences fully filled by H or D should be considered to include undeuterated, partially deuterated, and fully deuterated versions thereof. For example, the chemical structure of 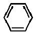 implies to include C₆H₆, C₆D₆, C₆H₃D₃, and any other partially deuterated variants thereof. Some common basic partially or fully deuterated groups include, without limitation, CD₃, CD₂C(CH₃)₃, C(CD₃)₃, and C₆D₅. Similarly, where partially or fully defined atomic structures show a particular position may be or is deuterium, the same atomic structures with one, two, or up to all deuterium atoms replaced by hydrogen are also envisioned.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instances, a pair of substituents in the molecule can be optionally joined or fused into a ring. The preferred ring is a five to nine-membered carbocyclic or heterocyclic ring, includes both instances where the portion of the ring formed by the pair of substituents is saturated and where the portion of the ring formed by the pair of substituents is unsaturated. In yet other instances, a pair of adjacent substituents can be optionally joined or fused into a ring. As used herein, "adjacent" means that the two substituents involved can be on the same ring next to each other, or on two neighboring rings having the two closest available substitutable positions, such as 2, 2' positions in a biphenyl, or 1, 8 position in a naphthalene.

### B. The Compounds of the Present Disclosure

In one aspect, the present disclosure provides a compound having a first ligand L_{A} comprising a structure of Formula I, 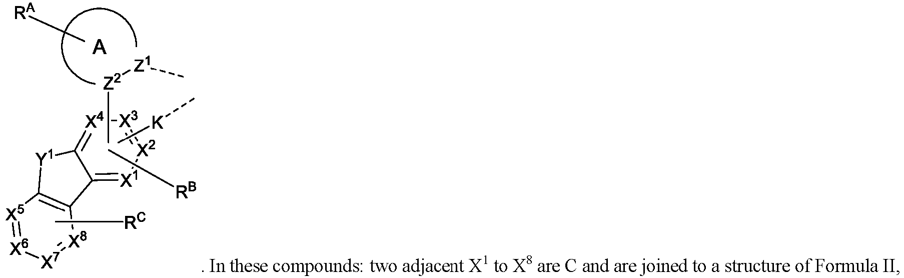 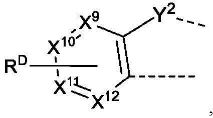 or 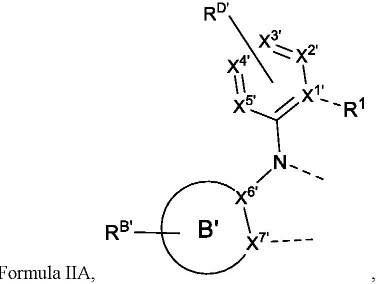 through the indicated dashed lines;
each of moiety A and moiety B' is independently a monocyclic ring or a polycyclic fused ring system, wherein the monocyclic ring or each ring of the polycyclic fused ring system is independently a 5-membered to 10-membered carbocyclic or heterocyclic ring;
each of Z¹, Z², X¹ to X¹², and X^{1'} to X^{7'} is independently C or N;
each of Y¹ and Y² is independently selected from the group consisting of BR, BRR', NR, PR, P(O)R, O, S, Se, C=O, C=S, C=Se, C=NR', C=CRR', S=O, SO₂, CRR', SiRR', GeRR';
K is selected from the group consisting of a direct bond, O, S, N(R^{α}), P(R^{α}), B(R^{α}), C(R^{α})(R^{β}), and Si(R^{α})(R^{β}),
each of R^{A}, R^{B}, R^{B'}, R^{C}, R^{D}, and R^{D'} independently represents mono to the maximum allowable substitution, or no substitution;
each R, R', R^{α}, R^{β}, R^{A}, R^{B}, R^{B'}, R^{C}, R^{D}, R^{D'}, and, when present, R¹ is independently hydrogen or a substituent selected from the group consisting of the General Substituents defined herein;
any two substituents may be joined or fused to form a ring;
L_{A} is coordinated to a metal M;
metal M is selected from the group consisting of Ir, Rh, Re, Ru, Os, Pt, Pd, Ag, Au, and Cu.
metal M may be coordinated to other ligands; and
first ligand L_{A} may be joined with other ligands to comprise a tridentate, tetradentate, pentadentate, or hexadentate ligand.

In some embodiments, if Z¹ is N and moiety A is pyridine, then Y² is SiRR' or GeRR'.

In some embodiments, if the ring containing Z¹ to Z² is an imidazole ring where Z¹ and the ring atom close to Z² are N, then at least one of the following conditions is true:
(a) Y¹ is CRR', SiRR', or GeRR';
(b) Y² is SiRR' or GeRR'; or
(c) the R^{A} substituent attached to the imidazole ring nitrogen comprises three or more carbocyclic or heterocyclic moieties that are not fused to each other.

In some embodiments, two adjacent X¹ to X⁸ are C and are joined to form a structure of Formula II,

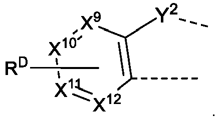

In some embodiments, two adjacent X¹ to X⁸ are C and are joined to form a structure of Formula IIA, 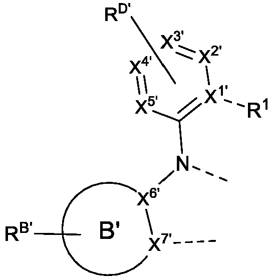 through the indicated dashed lines. In some embodiments, X^{1'} is C and R¹ is present.

In some embodiments of Formula IIA, if R¹ is present, then moiety B containing X^{6'} and X^{7'} is a 6-membered monocyclic ring, and R¹ is not H.

In some embodiments of Formula IIA, moiety B' is an aromatic ring. In some embodiments, moiety B' is a heteroaromatic ring. In some embodiments, moiety B' is a 6-membered ring. In some embodiments, moiety B' is a 6-membered aromatic ring. In some embodiments, moiety B' is a 5-membered heteroaromatic ring. In some embodiments, moiety B' is selected from the group consisting of benzene, pyridine, pyrimidine, pyridazine, pyrazine, triazine, imidazole, imidazole-derived carbene, pyrazole, pyrrole, oxazole, furan, thiophene, thiazole, and triazole. In some embodiments, moiety B' is selected from the group consisting of benzene, pyridine, pyrimidine, and imidazole. In some embodiments, moiety B' is benzene.

In some embodiments of Formula IIA, two R^{B'} are joined to form a ring. In some embodiments, two R^{B'} are joined to form an aromatic or heteroaromatic ring. In some embodiments, two R^{B'} are joined to form a 6 membered ring. In some embodiments, two R^{B'} are joined to form a 5 membered ring. In some embodiments, two R^{B'} are joined to form a polycyclic fused ring system. In some embodiments, two R^{B'} are joined to form a ring selected from the group consisting of benzene, pyridine, pyrimidine, pyridazine, pyrazine, triazine, imidazole, imidazole-derived carbene, pyrazole, pyrrole, oxazole, furan, thiophene, thiazole, and triazole. In some embodiments, two R^{B'} are joined to form a benzene ring.

In some embodiments of Formula IIA, X^{7'} is N. In some embodiments, each of X^{1'}-X^{5'} is carbon. In some embodiments, at least one of X^{1'}-X^{5'} is N. In some embodiments, at least two of X^{1'}-X^{5'} are N.

In some embodiments of Formula IIA, R¹ is present. In some embodiments, R¹ is an alkyl, cycloalkyl, aryl, or heteroaryl group. In some embodiments, R¹ is a partially or fully deuterated alkyl group. In some embodiments, R¹ is a branched alkyl group. In some embodiments, R¹ is tBu or isopropyl. In some embodiments, R¹ is a substituted or unsubstituted aryl group.

In some embodiments of Formula IIA, at least one R^{D'} is a cyclic group. In some embodiments, at least one R^{D'} is a cycloalkyl group. In some embodiments, at least one R^{D'} is a substituted or unsubstituted aryl group.

In some embodiments, Formula IIA is joined to X⁵ and X⁶ of Formula I. In some embodiments, Formula IIA is joined to X⁶ and X⁷ of Formula I.

In some embodiments, ligand L_{A} consists essentially of Formula I. In some embodiments, ligand L_{A} has a structure of Formula I.

In some embodiments, at least one R^{A}, R^{B}, R^{B'}, R^{C}, R^{D}, or R^{D'} is selected from the group consisting of the General Substituents defined herein. In some embodiments, at least one R^{A} is selected from the group consisting of the General Substituents defined herein. In some embodiments, at least one R^{B} is selected from the group consisting of the General Substituents defined herein. In some embodiments, at least one R^{B'} is selected from the group consisting of the General Substituents defined herein. In some embodiments, at least one R^{C} is selected from the group consisting of the General Substituents defined herein. In some embodiments, at least one R^{D} is selected from the group consisting of the General Substituents defined herein. In some embodiments, at least one R^{D'} is selected from the group consisting of the General Substituents defined herein. In some embodiments, at least one R^{A}, R^{B}, R^{B'}, R^{C}, R^{D}, or R^{D'} is selected from the group consisting of the Preferred General Substituents defined herein.

In some embodiments of Formula I, at least one R, R', R^{α}, R^{β}, R^{A}, R^{B}, R^{C}, or R^{D} is partially or fully deuterated. In some embodiments, at least one R^{A} is partially or fully deuterated. In some embodiments, at least one R^{B} is partially or fully deuterated. In some embodiments, at least one R^{B'} is partially or fully deuterated. In some embodiments, at least one R^{C} is partially or fully deuterated. In some embodiments, at least one R^{D} is partially or fully deuterated. In some embodiments, at least one R^{D'} is partially or fully deuterated. In some embodiments, at least one of R or R' is partially or fully deuterated.

In some embodiments, moiety A is independently a monocyclic ring or a polycyclic fused ring system, wherein the monocyclic ring or each ring of the polycyclic fused ring system is independently a 5-membered or 6-membered carbocyclic or heterocyclic ring.

In some embodiments, moiety A is independently a monocyclic ring or a polycyclic fused ring system, wherein the monocyclic ring or each ring of the polycyclic fused ring system is independently a 5-membered or 6-membered aryl or heteroaryl ring.

In some embodiments, each R, R', R^{α}, R^{β}, R^{A}, R^{B}, R^{B'}, R^{C}, R^{D}, and R^{D'} is independently a hydrogen or a substituent selected from the group consisting of the Preferred General Substituents defined herein. In some embodiments, each R, R', R^{α}, R^{β}, R^{A}, R^{B}, R^{B'}, R^{C}, R^{D}, and R^{D'} is independently a hydrogen or a substituent selected from the group consisting of the More Preferred General Substituents defined herein. In some embodiments, each R, R', R^{α}, R^{β}, R^{A}, R^{B}, R^{B'}, R^{C}, R^{D}, and R^{D'} is independently a hydrogen or a substituent selected from the group consisting of the Even More Preferred General Substituents defined herein. In some embodiments, each R, R', R^{α}, R^{β}, R^{A}, R^{B}, R^{B'}, R^{C}, R^{D}, and R^{D'} is independently a hydrogen or a substituent selected from the group consisting of the Most Preferred General Substituents defined herein.

In some embodiments, each of moiety A and moiety B' is independently selected from the group consisting of following Cyclic Moiety List: benzene, pyridine, pyrimidine, pyridazine, pyrazine, triazine, imidazole, imidazole-derived carbene, pyrazole, pyrrole, oxazole, furan, thiophene, thiazole, triazole, naphthalene, quinoline, isoquinoline, quinazoline, benzofuran, aza-benzofuran, phenanthro[3,2-b]benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, benzimidazole-derived carbene, aza-benzimidazole, benzobenzimidazole, aza-benzobenzimidazole, carbazole, aza-carbazole, dibenzofuran, aza-dibenzofuran, dibenzothiophene, aza-dibenzothiophene, quinoxaline, phthalazine, phenanthrene, aza-phenanthrene, anthracene, aza-anthracene, phenanthridine, fluorene, and aza-fluorene. In some embodiments, the aza variant includes one N on a benzo ring. In some embodiments, the aza variant includes one N on a benzo ring and the N is bonded to the metal M.

In some embodiments, moiety A is a monocyclic ring. In some embodiments, moiety A is selected from the group consisting of benzene, pyridine, pyrimidine, pyridazine, pyrazine, triazine, imidazole, imidazole-derived carbene, pyrazole, pyrrole, oxazole, furan, thiophene, thiazole, and triazole. In some embodiments, moiety A is pyridine, pyrimidine, or imidazole. In some embodiments, moiety A is pyridine. In some embodiments, moiety A is pyrimidine. In some embodiments, moiety A is imidazole.

In some embodiments, moiety A is a polycyclic fused ring system. In some embodiments, moiety A is selected from the group consisting of naphthalene, quinoline, isoquinoline, quinazoline, benzofuran, aza-benzofuran, phenanthro[3,2-b]benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, benzimidazole-derived carbene, aza-benzimidazole, benzobenzimidazole, aza-benzobenzimidazole, carbazole, aza-carbazole, dibenzofuran, aza-dibenzofuran, dibenzothiophene, aza-dibenzothiophene, quinoxaline, phthalazine, phenanthrene, aza-phenanthrene, anthracene, aza-anthracene, phenanthridine, fluorene, and aza-fluorene. In some embodiments, moiety A is benzimidazole.

In some embodiments, moiety A can be a polycyclic fused ring structure. In some embodiments, moiety A can be a polycyclic fused ring structure comprising at least two fused rings. In some embodiments, the polycyclic fused ring structure has one 6-membered ring and one 5-membered ring. In some such embodiments, either the 5-membered ring or the 6-membered ring can coordinate to the metal. In some embodiments, the polycyclic fused ring structure has two 6-membered rings. In some embodiments, moiety A can be selected from the group consisting of benzofuran, benzothiophene, benzoselenophene, naphthalene, and aza-variants thereof.

In some embodiments, moiety A can be a polycyclic fused ring structure comprising at least three fused rings. In some embodiments, the polycyclic fused ring structure has two 6-membered rings and one 5-membered ring. In some such embodiments, the 5-membered ring is fused to the ring coordinated to metal M and the second 6-membered ring is fused to the 5-membered ring. In some embodiments, moiety A can be selected from the group consisting of dibenzofuran, dibenzothiophene, dibenzoselenophene, and aza-variants thereof. In some such embodiments, moiety A can be further substituted at the ortho- or meta-position of the O, S, or Se atom by a substituent selected from the group consisting of deuterium, fluorine, nitrile, alkyl, cycloalkyl, aryl, heteroaryl, and combinations thereof. In some such embodiments, the aza-variants contain exactly one N atom at the 6-position (ortho to the O, S, or Se) with a substituent at the 7-position (meta to the O, S, or Se).

In some embodiments, moiety A can be a polycyclic fused ring structure comprising at least four fused rings. In some embodiments, the polycyclic fused ring structure comprises three 6-membered rings and one 5-membered ring. In some such embodiments, the 5-membered ring is fused to the ring coordinated to metal M, the second 6-membered ring is fused to the 5-membered ring, and the third 6-membered ring is fused to the second 6-membered ring. In some such embodiments, the third 6-membered ring is further substituted by a substituent selected from the group consisting of deuterium, fluorine, nitrile, alkyl, cycloalkyl, aryl, heteroaryl, and combinations thereof.

In some embodiments, moiety A can be a polycyclic fused ring structure comprising at least five fused rings. In some embodiments, the polycyclic fused ring structure comprises four 6-membered rings and one 5-membered ring or three 6-membered rings and two 5-membered rings. In some embodiments comprising two 5-membered rings, the 5-membered rings are fused together. In some embodiments comprising two 5-membered rings, the 5-membered rings are separated by at least one 6-membered ring. In some embodiments with one 5-membered ring, the 5-membered ring is fused to the ring coordinated to metal M, the second 6-membered ring is fused to the 5-membered ring, the third 6-membered ring is fused to the second 6-membered ring, and the fourth 6-membered ring is fused to the third 6-membered ring.

In some embodiments, moiety A can be an aza version of the polycyclic fused rings described above. In some such embodiments, moiety A can contain exactly one aza N atom. In some such embodiments, moiety A can contain exactly two aza N atoms, which can be in one ring, or in two different rings. In some such embodiments, the ring having aza N atom is separated by at least two other rings from the metal M atom. In some such embodiments, the ring having aza N atom is separated by at least three other rings from the metal M atom. In some such embodiments, each of the ortho position of the aza N atom is substituted.

In some embodiments, X¹ and X² or X³ and X⁴ are joined to a structure of Formula II.

In some embodiments, two consecutive ones of X⁵ to X⁸ are joined to a structure of Formula II.

In some embodiments, X⁵ and X⁶ are joined to a structure of Formula II. In some such embodiments, Y² is bonded to X⁵. In some such embodiments, Y² is bonded to X⁶.

In some embodiments, X⁶ and X⁷ are joined to a structure of Formula II. In some embodiments, Y² is bonded to X⁶. In some embodiments, Y² is bonded to X⁷.

In some embodiments, X⁷ and X⁸ are joined to a structure of Formula II. In some embodiments, Y² is bonded to X⁷. In some embodiments, Y² is bonded to X⁸.

In some embodiments, Z¹ is N and the one of X¹ to X⁴ attached to K is C.

In some embodiments, Z¹ is C, K is a direct bond, and the one of X¹ to X⁴ attached to metal M is N.

In some embodiments, Z² is C. In some embodiments, Z² is C and the ring atom close to Z² is N.

In some embodiments, at least one of X¹ to X⁴ is N. In some embodiments, exactly one of X¹ to X⁴ is N.

In some embodiments, the one of X¹ to X⁴ bonded to Z² is C.

In some embodiments, each of X¹ to X⁴ is C.

In some embodiments, at least one of X⁵ to X⁸ is N. In some embodiments, exactly one of X⁵ to X⁸ is N.

In some embodiments, each of X⁵ to X⁸ is C.

In some embodiments, at least one of X⁹ to X¹² is N. In some embodiments, exactly of X⁹ to X¹² is N.

In some embodiments, each of X⁹ to X¹² is C.

In some embodiments, the ring containing Z¹ to Z² is an imidazole ring and Z¹ and the ring atom close to Z² are N.

In some embodiments, moiety A is pyridine and Z¹ is N.

In some embodiments, Y¹ is selected from the group consisting of O, S, and Se. In some embodiments, Y¹ is O. In some embodiments, Y¹ is selected from the group consisting of BR, NR, and PR.

In some embodiments, Y¹ is selected from the group consisting of BRR', CRR', SiRR', and GeRR'. In some embodiments, Y¹ is selected from the group consisting of CRR', SiRR', and GeRR'. In some embodiments, Y¹ is SiRR'. In some embodiments, Y¹ is GeRR'. In some embodiments, Y¹ is CRR'.

In some embodiments, Y¹ is selected from the group consisting of P(O)R, C=O, C=S, C=Se, C=NR, C=CRR', S=O, and SO₂. In some embodiments, Y¹ is CRR'.

In some embodiments, Y¹ is selected from the group consisting of O, S, Se, NR, BR, CRR', SiRR', and GeRR'.

In some embodiments, Y² is selected from the group consisting of O, S, and Se. In some embodiments, Y² is O.

In some embodiments, Y² is selected from the group consisting of BR, NR, and PR.

In some embodiments, Y² is selected from the group consisting of BRR', CRR', SiRR', and GeRR'. In some embodiments, Y² is selected from the group consisting of SiRR' and GeRR'. In some embodiments, Y² is SiRR'. In some embodiments, Y² is GeRR'.

In some embodiments, ^{y2} is selected from the group consisting of P(O)R, C=O, C=S, C=Se, C=NR, C=CRR', S=O, and SO₂. In some embodiments, Y² is CRR'.

In some embodiments, Y² is selected from the group consisting of O, S, Se, NR, BR, CRR', SiRR', and GeRR'.

In some embodiments, Y¹ is O, and Y² is SiRR' or GeRR'.

In some embodiments, K is a direct bond.

In some embodiments, K is O or S. In some embodiments, K is N(R^{α}), P(R^{α}), or B(R^{α}). In some embodiments, K is C(R^{α})(R^{β}) or Si(R^{α})(R^{β}).

In some embodiments, metal M is Ir. In some embodiments, metal M is Os, Ir, Pd, Pt, Cu, Ag, or Au

In some embodiments, metal M is Pt.

In some embodiments, the first ligand L_{A} comprises a structure of Formula III: 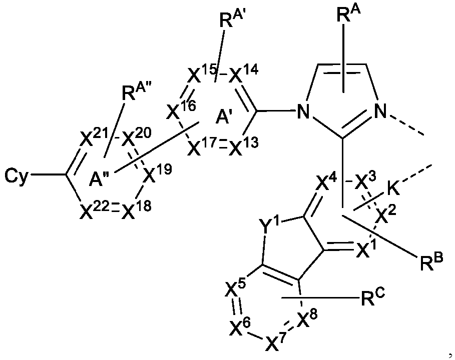 wherein:
moiety Cy is a substituted or unsubstituted monocyclic ring or polycyclic fused ring system, wherein the monocyclic ring or each ring of the polycyclic fused ring system is independently a 5-membered to 10-membered carbocyclic or heterocyclic ring;
each of X¹³ to X²² is independently C or N;
each of R^{A'} and R^{A"} independently represents mono to the maximum allowable substitutions, or no substitutions;
each R^{A'} and R^{A"} is independently hydrogen or a substituent selected from the group consisting of the General Substituents defined herein; and
any two substituents may be joined or fused to form a ring.

In some embodiments, moiety Cy is independently a monocyclic ring or a polycyclic fused ring system, wherein the monocyclic ring or each ring of the polycyclic fused ring system is independently a 5-membered or 6-membered carbocyclic or heterocyclic ring. In some embodiments, moiety Cy is independently a monocyclic ring or a polycyclic fused ring system, wherein the monocyclic ring or each ring of the polycyclic fused ring system is independently a 5-membered or 6-membered aryl or heteroaryl ring.

In some embodiments of Formula III, each of X¹³ to X¹⁷ is C.

In some embodiments of Formula III, at least one of X¹³ to X¹⁷ is N. In some embodiments of Formula III, exactly one of X¹³ to X¹⁷ is N.

In some embodiments of Formula III, each of X¹⁸ to X²² is C.

In some embodiments of Formula III, at least one of X¹⁸ to X²² is N. In some embodiments of Formula III, exactly one of X¹⁸ to X²² is N.

In some embodiments of Formula III, ring A' and ring A" are not fused together.

In some embodiments of Formula III, ring A' is bonded to ring A" at X¹³. In some embodiments of Formula III, ring A' is bonded to ring A" at X¹⁴. In some embodiments of Formula III, ring A' is bonded to ring A" at X¹⁵. In some embodiments of Formula III, ring A' is bonded to ring A" at X¹⁶. In some embodiments of Formula III, ring A' is bonded to ring A" at X¹⁷.

In some embodiments of Formula III, ring A" is bonded to ring A' at X¹⁸. In some embodiments of Formula III, ring A" is bonded to ring A' at X¹⁹. In some embodiments of Formula III, ring A" is bonded to ring A' at X²⁰. In some embodiments of Formula III, ring A" is bonded to ring A' at X²¹. In some embodiments of Formula III, ring A" is bonded to ring A' at X²².

In some embodiments of Formula III, ring A' and ring A" are joined by a bond between X¹⁶ and X¹⁹.

In some embodiments of Formula III, moiety Cy is a cycloalkyl or heterocycloalkyl moiety. In some such embodiments, moiety Cy is a 5-membered or 6-membered ring. In some embodiments, moiety Cy is a spiro moiety.

In some embodiments of Formula III, moiety Cy is an aryl or heteroaryl moiety.

In some embodiments of Formula III, moiety Cy is selected from the group consisting of the Cyclic Moiety List defined herein.

In some embodiments, moiety Cy is a monocyclic ring. In some embodiments, moiety Cy is benzene.

In some embodiments, moiety Cy is a polycyclic fused ring system. In some embodiments, moiety Cy is naphthalene.

In some embodiments, moiety Cy is substituted by at least one substituent selected from the group consisting of the General Substituents defined herein.

In some embodiments, moiety Cy is substituted by at least one substituent comprising at least one C atom. In some embodiments, moiety Cy is substituted by at least one substituent comprising at least two C atoms. In some embodiments, moiety Cy is substituted by at least one substituent comprising at least three C atoms. In some embodiments, moiety Cy is substituted by at least one substituent comprising at least four C atoms.

In some embodiments, moiety Cy is substituted by at least one substituent comprising a substituent selected from the group consisting of alkyl, cycloalkyl, silyl, germyl, aryl, heteroaryl, and combinations thereof.

In some embodiments, the compound comprises an electron-withdrawing group. In some embodiments, the electron-withdrawing group has a Hammett constant larger than 0. In some embodiments, the electron-withdrawing group has a Hammett constant equal or larger than 0.1, 0.2, 0.3, 0.4, 0.5, 0.6, 0.7, 0.8, 0.9, 1.0, or 1.1.

In some embodiments, the ligand L_{A} comprises an electron-withdrawn group selected from the group consisting of the structures of the following EWG1 LIST: F, CF₃, CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, (R^{k2})₂CCN, (R^{k2})₂CCF₃, CNC(CF₃)₂, BR^{k3}R^{k2}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano-containing alkyl, cyano-containing aryl, cyano-containing heteroaryl, isocyanate, 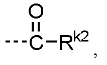 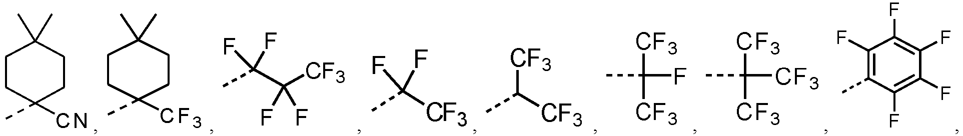 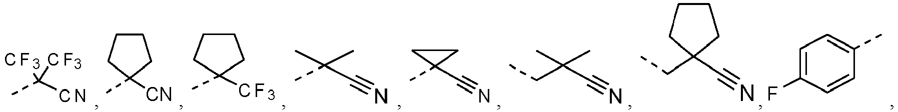 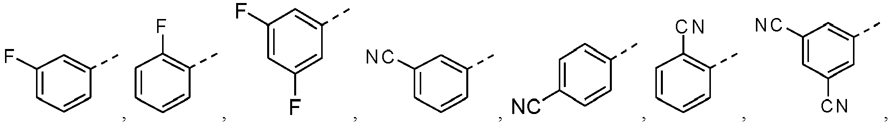 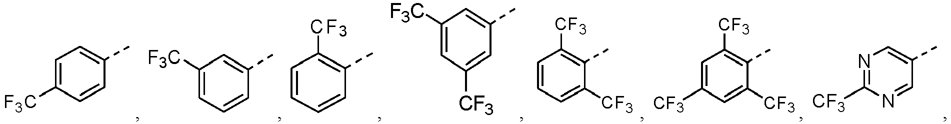 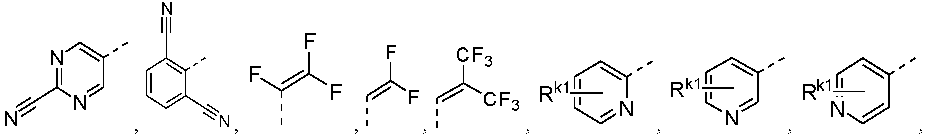 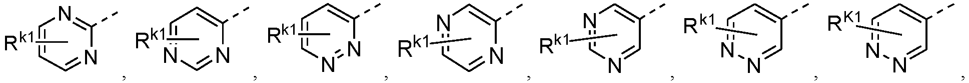 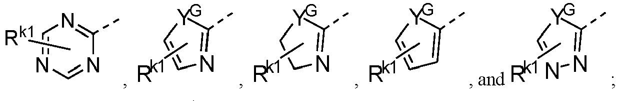
wherein each R^{k1} represents mono to the maximum allowable substitution, or no substitutions,
wherein Y^{G} is selected from the group consisting of BRₑ, NRₑ, PRₑ, O, S, Se, C=O, S=O, SO₂, CRₑR_{f}, SiRₑR_{f}, and GeRₑR_{f}; and
wherein each of R^{k1} R^{k2}, R^{k3}, Rₑ, and R_{f} is independently a hydrogen or a substituent selected from the group consisting of the General Substituents defined herein.

In some embodiments, the first ligand L_{A} comprises an electron-withdrawing group selected from the group consisting of the structures of the following EWG2 List 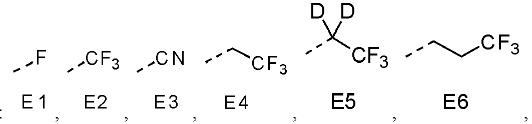 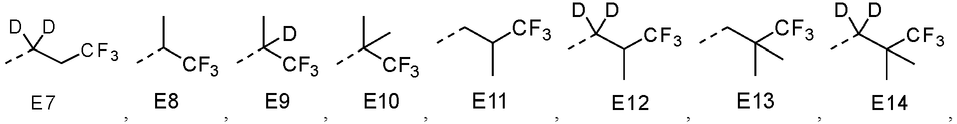 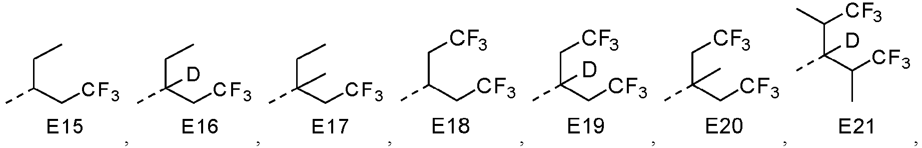 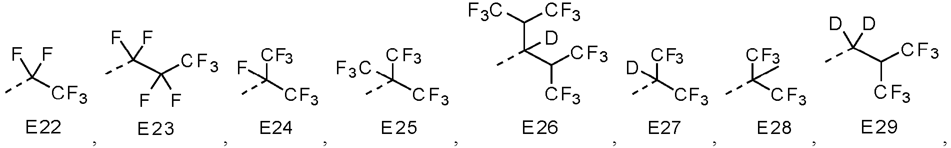 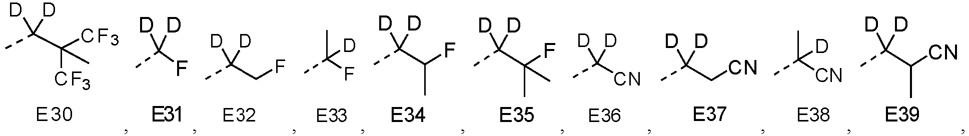 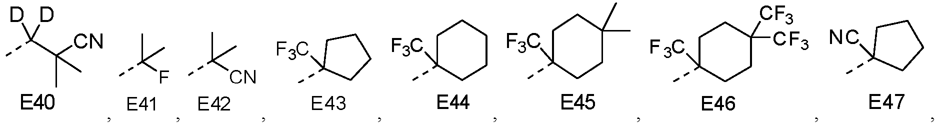 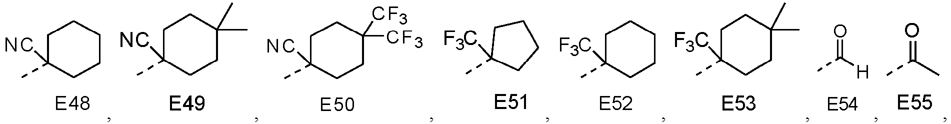 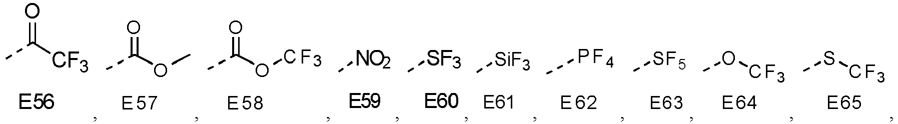 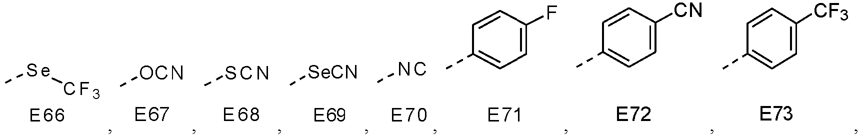 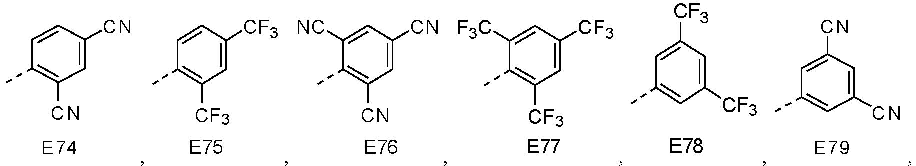 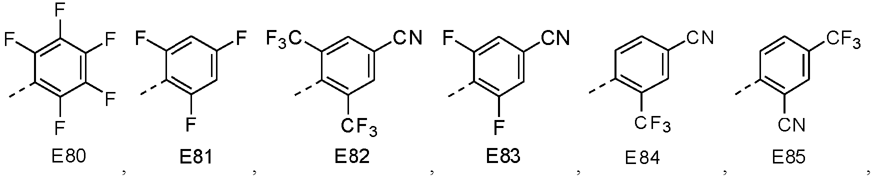 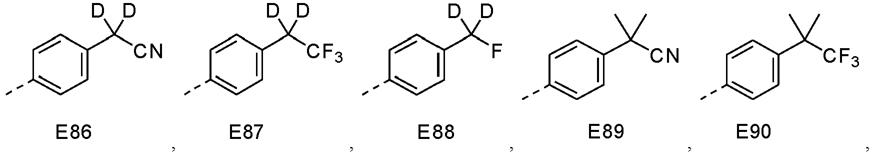 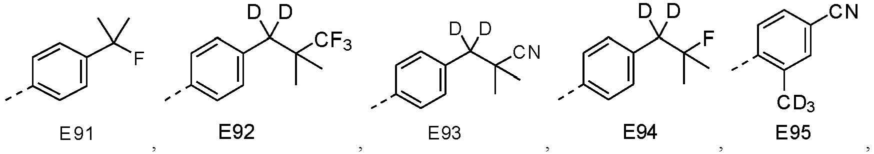 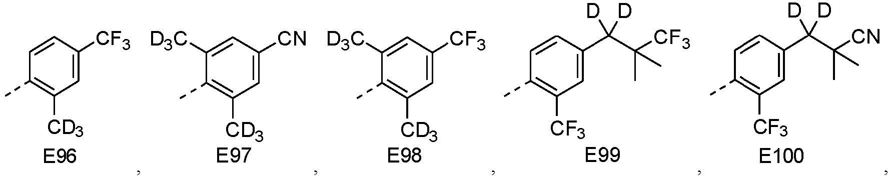 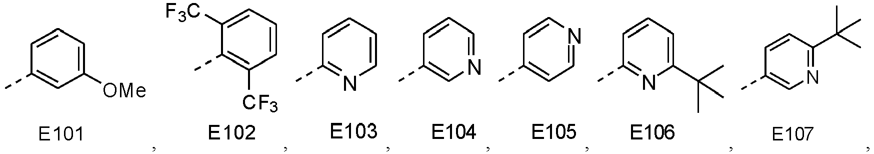 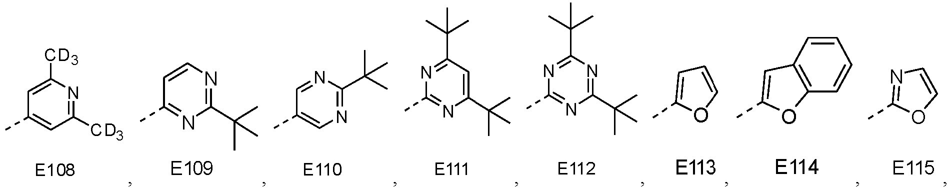 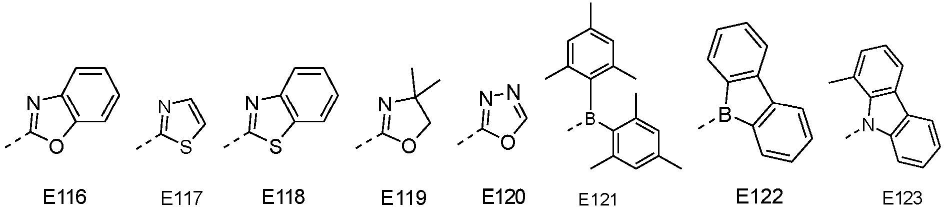 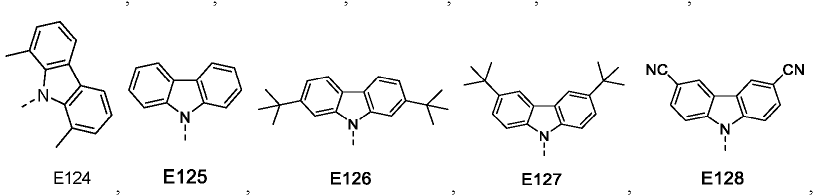 and

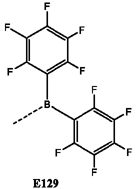

In some embodiments, the first ligand L_{A} comprises an electron-withdrawing group selected from the group consisting of the structures of the following EWG3 LIST:

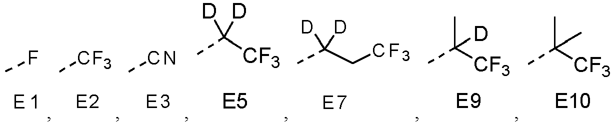

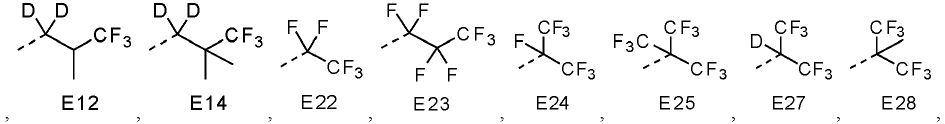

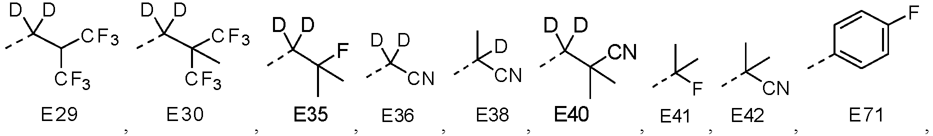

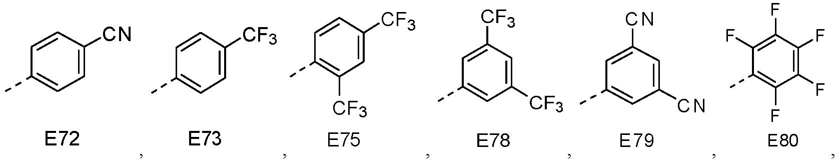

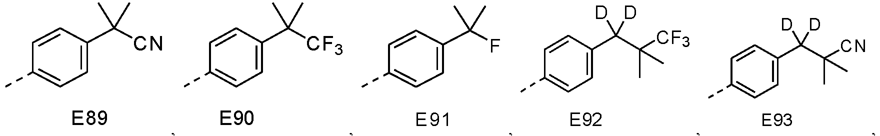

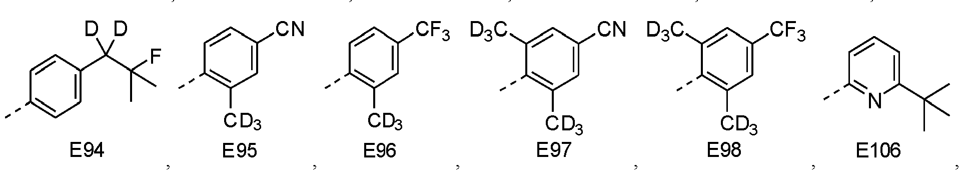

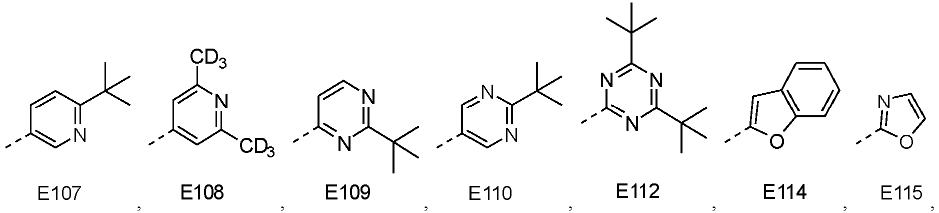

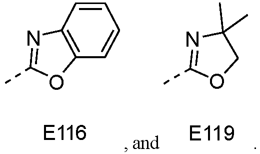

In some embodiments, the first ligand L_{A} comprises an electron-withdrawing group selected from the group consisting of the structures of the following EWG4 LIST:

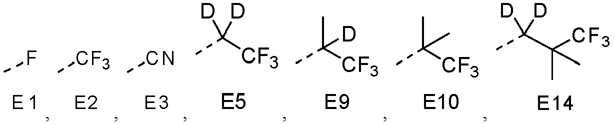

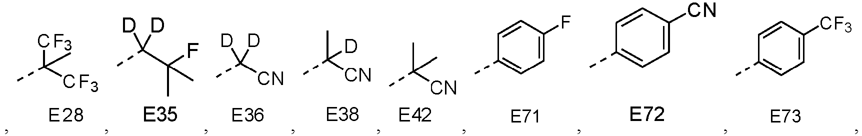

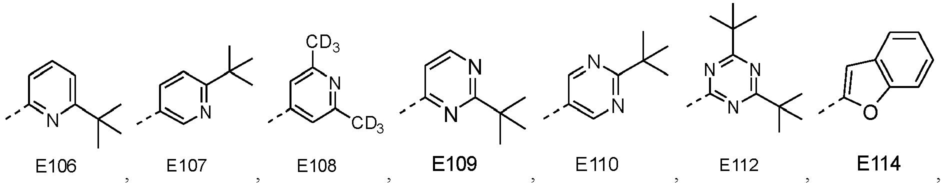

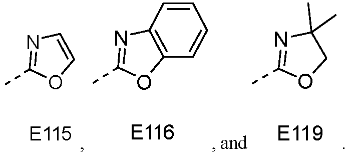

In some embodiments, the first ligand L_{A} comprises a π-electron deficient electron-withdrawing group selected from the group consisting of the structures of the following Pi-EWG LIST: CN, COCH₃, CHO, COCF₃, COOMe, COOCF₃, NO₂, SF₃, SiF₃, PF₄, SF ₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, BR^{k2}R^{k3}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridazine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated aryl, partially and fully fluorinated heteroaryl, cyano-containing aryl, cyano-containing heteroaryl, isocyanate, 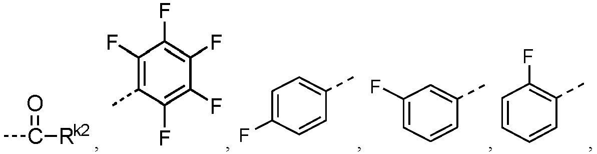 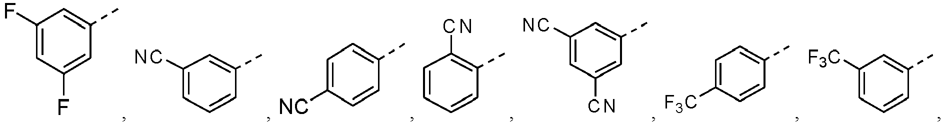 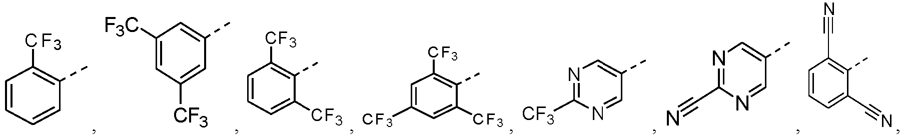 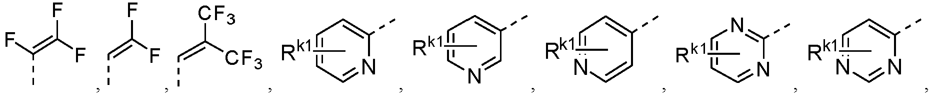 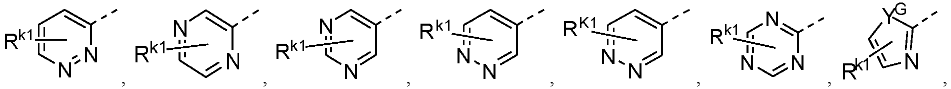 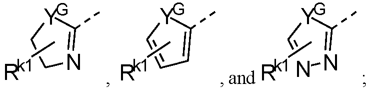 wherein the variables are the same as previously defined.

In some embodiments, the compound comprises an electron-withdrawing group from the EWG1 LIST as defined herein. In some embodiments, the compound comprises an electron-withdrawing group from the EWG2 LIST as defined herein. In some embodiments, the compound comprises an electron-withdrawing group from the EWG3 LIST as defined herein. In some embodiments, the compound comprises an electron-withdrawing group from the EWG4 LIST as defined herein. In some embodiments, the compound comprises an electron-withdrawing group from the Pi-EWG LIST as defined herein.

In some embodiments, at least one R^{A} is or comprises an electron-withdrawing group from the EWG1 LIST as defined herein. In some embodiments, at least one R^{A} is or comprises an electron-withdrawing group from the EWG2 LIST as defined herein. In some embodiments, at least one R^{A} is or comprises an electron-withdrawing group from the EWG3 LIST as defined herein. In some embodiments, at least one R^{A} is or comprises an electron-withdrawing group from the EWG4 LIST as defined herein. In some embodiments, at least one R^{A} is or comprises an electron-withdrawing group from the Pi-EWG LIST as defined herein.

In some embodiments, at least one R^{A'} is or comprises an electron-withdrawing group from the EWG1 LIST as defined herein. In some embodiments, at least one R^{A'} is or comprises an electron-withdrawing group from the EWG2 LIST as defined herein. In some embodiments, at least one R^{A'} is or comprises an electron-withdrawing group from the EWG3 LIST as defined herein. In some embodiments, at least one R^{A'} is or comprises an electron-withdrawing group from the EWG4 LIST as defined herein. In some embodiments, at least one R^{A'} is or comprises an electron-withdrawing group from the Pi-EWG LIST as defined herein.

In some embodiments, at least one R^{A"} is or comprises an electron-withdrawing group from the EWG1 LIST as defined herein. In some embodiments, at least one R^{A"} is or comprises an electron-withdrawing group from the EWG2 LIST as defined herein. In some embodiments, at least one R^{A"} is or comprises an electron-withdrawing group from the EWG3 LIST as defined herein. In some embodiments, at least one R^{A"} is or comprises an electron-withdrawing group from the EWG4 LIST as defined herein. In some embodiments, at least one R^{A"} is or comprises an electron-withdrawing group from the Pi-EWG LIST as defined herein.

In some embodiments, at least one R^{B} is or comprises an electron-withdrawing group from the EWG1 LIST as defined herein. In some embodiments, at least one R^{B} is or comprises an electron-withdrawing group from the EWG2 LIST as defined herein. In some embodiments, at least one R^{B} is or comprises an electron-withdrawing group from the EWG3 LIST as defined herein. In some embodiments, at least one R^{B} is or comprises an electron-withdrawing group from the EWG4 LIST as defined herein. In some embodiments, at least one R^{B} is or comprises an electron-withdrawing group from the Pi-EWG LIST as defined herein.

In some embodiments, at least one R^{C} is or comprises an electron-withdrawing group from the EWG1 LIST as defined herein. In some embodiments, at least one R^{C} is or comprises an electron-withdrawing group from the EWG2 LIST as defined herein. In some embodiments, at least one R^{C} is or comprises an electron-withdrawing group from the EWG3 LIST as defined herein. In some embodiments, at least one R^{C} is or comprises an electron-withdrawing group from the EWG4 LIST as defined herein. In some embodiments, at least one R^{C} is or comprises an electron-withdrawing group from the Pi-EWG LIST as defined herein.

In some embodiments, at least one R^{D} is or comprises an electron-withdrawing group from the EWG1 LIST as defined herein. In some embodiments, at least one R^{D} is or comprises an electron-withdrawing group from the EWG2 LIST as defined herein. In some embodiments, at least one R^{D} is or comprises an electron-withdrawing group from the EWG3 LIST as defined herein. In some embodiments, at least one R^{D} is or comprises an electron-withdrawing group from the EWG4 LIST as defined herein. In some embodiments, at least one R^{D} is or comprises an electron-withdrawing group from the Pi-EWG LIST as defined herein.

In some embodiments, moiety Cy is substituted by a substituent that is or comprises an electron-withdrawing group from the EWG1 LIST as defined herein. In some embodiments, moiety Cy is substituted by a substituent that is or comprises an electron-withdrawing group from the EWG2 LIST as defined herein. In some embodiments, moiety Cy is substituted by a substituent that is or comprises an electron-withdrawing group from the EWG3 LIST as defined herein. In some embodiments, moiety Cy is substituted by a substituent that is or comprises an electron-withdrawing group from the EWG4 LIST as defined herein. In some embodiments, moiety Cy is substituted by a substituent that is or comprises an electron-withdrawing group from the Pi-EWG LIST as defined herein.

In some embodiments, at least one R or R' is or comprises an electron-withdrawing group from the EWG1 LIST as defined herein. In some embodiments, at least one R or R' is or comprises an electron-withdrawing group from the EWG2 LIST as defined herein. In some embodiments, at least one R or R' is or comprises an electron-withdrawing group from the EWG3 LIST as defined herein. In some embodiments, at least one R or R' is or comprises an electron-withdrawing group from the EWG4 LIST as defined herein. In some embodiments, at least one R or R' is or comprises an electron-withdrawing group from the Pi-EWG LIST as defined herein.

In some embodiments, at least one R^{A} is not hydrogen.

In some embodiments, at least one R^{A} comprises at least one C atom. In some embodiments, at least one R^{A} comprises at least two C atoms. In some embodiments, at least one R^{A} comprises at least three C atoms. In some embodiments, at least one R^{A} comprises at least four C atoms.

In some embodiments, at least one R^{A} comprises a substituent selected from the group consisting of alkyl, cycloalkyl, silyl, germyl, aryl, heteroaryl, and combinations thereof.

In some embodiments, the R^{A} attached to the imidazole ring nitrogen is R^{A3}.

In some embodiments, R^{A3} is or comprises a structure of Formula XA, 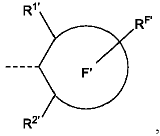 wherein:
ring F' is a 5-membered to 10-membered carbocyclic or heterocyclic ring,
R^{F'} represents mono to tri-substitutions, or no substitutions, and
each R^{1'}, R^{2'}, and R^{F'} is independently hydrogen or a substituent selected from the group consisting of deuterium, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, ether, ester, phosphino, selenyl, and combinations thereof, and combinations thereof.

In some embodiments, ring F' is a 5-membered or 6-membered carbocyclic or heterocyclic ring. In some embodiments, ring F' is a 5-membered or 6-membered aryl or heteroaryl ring.

In some embodiments, R^{1'} and R^{2'} are each independently hydrogen, deuterium, or R^{1'} and R^{2'} are joined with an R^{F'} to form a ring. In some embodiments, at least one of R^{1'} and R^{2'} is not hydrogen or deuterium.

In some embodiments, each of R^{1'} and R^{2'} is independently selected from the group consisting of alkyl, cycloalkyl, silyl, germyl, and combinations thereof.

In some embodiments, R^{1'} and R^{2'} are the same. In some embodiments, R^{1'} and R^{2'} are different.

In some embodiments, each of R^{1'} and R^{2'} comprises at least one carbon atom. In some embodiments, each of R^{1'} and R^{2'} comprises at least two carbon atoms. In some embodiments, each of R^{1'} and R^{2'} comprises at least three carbon atoms. In some embodiments, each of R^{1'} and R^{2'} comprises at least four carbon atoms.

In some embodiments, at least one R^{F'} is not hydrogen or deuterium. In some embodiments, at least one R^{F'} is selected from the group consisting of alkyl, cycloalkyl, silyl, germyl, and combinations thereof.

In some embodiments, ring F' is selected from the group consisting of benzene, pyridine, pyrimidine, pyridazine, pyrazine, triazine, imidazole, imidazole-derived carbene, pyrazole, pyrrole, oxazole, furan, thiophene, thiazole, and triazole.

In some embodiments, R^{A3} is or comprises a structure of Formula XB, 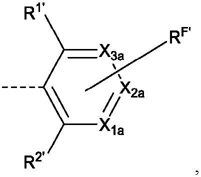 wherein each of X₁ₐ, X₂ₐ, and X₃ₐ is independently C or N.

In some embodiments, the R^{F'} bonded to X₂ₐ is selected from the group consisting of alkyl, cycloalkyl, silyl, germyl, and combinations thereof. In some embodiments, the R^{F'} bonded to X₂ₐ is alkyl. In some embodiments, the R^{F'} bonded to X₂ₐ is aryl or heteroaryl. In some embodiments, the R^{F'} bonded to X₂, is silyl. In some embodiments, the R^{F'} bonded to X₂ₐ is germyl.

In some embodiments, each of X₁ₐ, X₂ₐ, and X₃ₐ is C.

In some embodiments, R^{A3} is or comprises a structure of Formula XC,

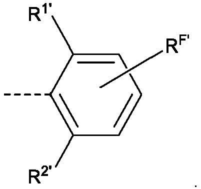

In some embodiments of Formula XC, the R^{F'} meta to both R^{1'} and R^{2'} has a structure of Formula XC.

In some embodiments of Formula XC, at least one of R^{1'} or R^{2'} is not hydrogen or deuterium. In some embodiments of Formula XC, each of R^{1'} and R^{2'} is independently selected from the group consisting of alkyl, cycloalkyl, aryl, heteroaryl, silyl, germyl, and combinations thereof. In some such embodiments, R^{1'} and R^{2'} are the same, while R^{1'} and R^{2'} are different in other embodiments.

In some embodiments of Formula XC, each of R^{1'} and R^{2'} is hydrogen or deuterium.

In some embodiments of Formula XC, at least one R^{F'} is not hydrogen or deuterium.

In some embodiments of Formula XC, at least one R^{F'} is selected from the group consisting of alkyl, cycloalkyl, aryl, heteroaryl, silyl, germyl, and combinations thereof. In some embodiments of Formula XC, the R^{F'} meta to both R^{1'} and R^{2'} is selected from the group consisting of alkyl, cycloalkyl, aryl, heteroaryl, silyl, germyl, and combinations thereof.

In some embodiments of Formula XC, the R^{F'} meta to both R^{1'} and R^{2'} is selected from the group consisting of aryl, alkyl, silyl, germyl, and combinations thereof. In some embodiments of Formula XC, the R^{F'} meta to both R^{1'} and R^{2'} is selected from the group consisting of phenyl, t-butyl, Si(Me)₃, Si(Ph)₃, Ge(Me)₃, Ge(Ph)₃, and combinations thereof. In some embodiments of Formula XC, the R^{F'} meta to both R^{1'} and R^{2'} is phenyl, t-butyl, Si(Me)₃, Si(Ph)₃, Ge(Me)₃, or Ge(Ph)₃.

In some embodiments of Formula XC, the R^{F'} meta to both R^{1'} and R^{2'} is phenyl. In some embodiments of Formula XC, the R^{F'} meta to both R^{1'} and R^{2'} is t-butyl. In some embodiments of Formula XC, the R^{F'} meta to both R^{1'} and R^{2'} is Si(Me)₃ or Si(Ph)₃. In some embodiments of Formula XC, the R^{F'} meta to both R^{1'} and R^{2'} is Ge(Me)₃ or Ge(Ph)₃.

In some embodiments, the R^{A} attached to the imidazole ring nitrogen is R^{A3}. In some embodiments, the R^{A} attached to the imidazole ring nitrogen comprises three or more carbocyclic or heterocyclic moieties that are not fused to each other. In some embodiments, each of the three or more carbocyclic or heterocyclic moieties of R^{A3} is independently a monocyclic ring or a polycyclic fused ring system, wherein the monocyclic ring or each ring of the polycyclic fused ring system is independently a 5-membered or 6-membered carbocyclic or heterocyclic ring.

In some embodiments, each of the three or more carbocyclic or heterocyclic moieties of R^{A3} is independently a monocyclic ring or a polycyclic fused ring system, wherein the monocyclic ring or each ring of the polycyclic fused ring system is independently a 5-membered or 6-membered aryl or heteroaryl ring.

In some embodiments, each of the three or more carbocyclic or heterocyclic moieties of R^{A3} is independently selected from the group consisting of the Cyclic Moiety List defined herein.

In some embodiments, each of the three or more carbocyclic or heterocyclic moieties of R^{A3} is a monocyclic moiety.

In some embodiments, at least one of the three or more carbocyclic or heterocyclic moieties of R^{A3} is a polycyclic fused ring system.

In some embodiments, each of the three or more carbocyclic or heterocyclic moieties of R^{A3} is independently benzene.

In some embodiments, R^{A3} comprises four or more carbocyclic or heterocyclic moieties that are not fused to each other.

In some embodiments, R^{A3} comprises a structure selected from the group consisting of the structures of the following LIST 1: 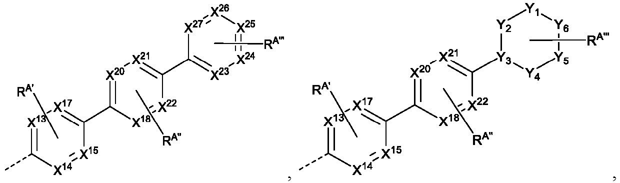 and 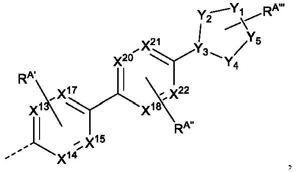 wherein:
each of X¹³-X²⁷ is independently C or N;
each of Y₁ to Y₆ is independently selected from the group consisting of BR, BRR', NR, PR, P(O)R, O, S, Se, C=O, C=S, C=Se, C=NR', C=CRR', S=O, SO₂, CRR', SiRR', GeRR';
each of R^{A'}, R^{A"}, and R^{A‴} independently represents mono to the maximum allowable substitutions, or no substitutions;
each of R^{A'}, R^{A"}, and R^{A‴} is independently hydrogen or a substituent selected from the group consisting of the General Substituents defined herein; and
any two substituents may be joined or fused to form a ring.

In some embodiments of LIST 1, only one of Y¹ to Y⁶ is other than CRR'. In some embodiments of LIST 1, only one of Y¹ to Y⁵ is other than CRR'. In some embodiments of LIST 1, one of Y¹ to Y⁶ is NR, O, or S. In some embodiments of LIST 1, one of Y¹ to Y⁵ is NR, O, or S.
In some embodiments, R^{A3} comprises a structure selected from the group consisting of the structures of the following LIST 2: 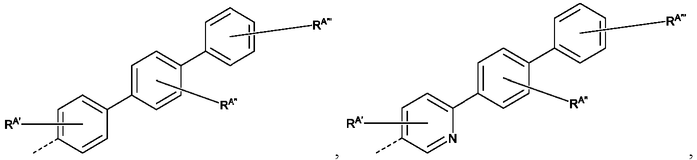 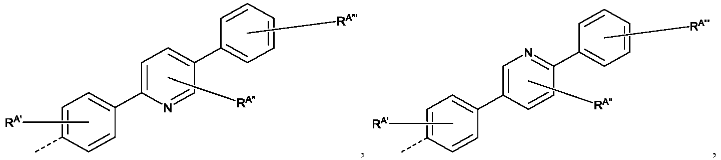 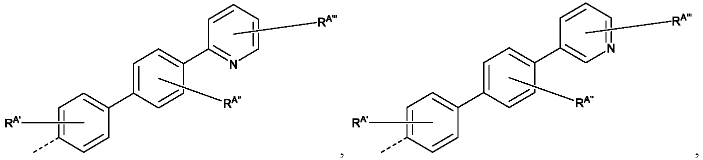 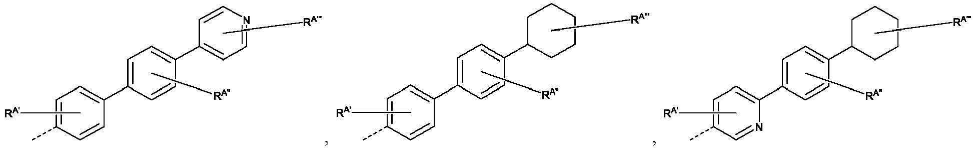 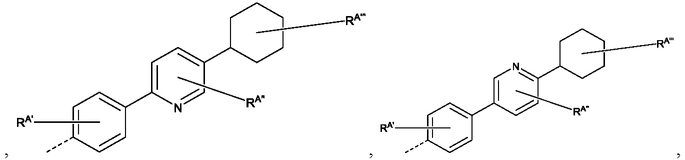 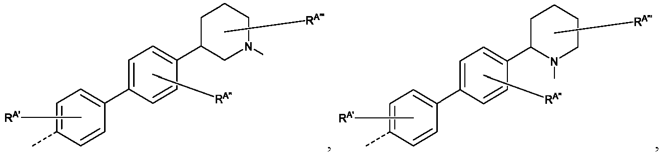 and 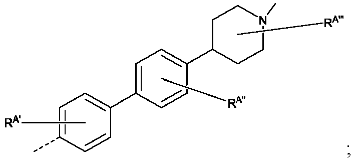
each of R^{A'}, R^{A"}, R^{A‴} independently represents mono to the maximum allowable substitutions, or no substitutions,
each R^{A'}, R^{A"}, R^{A‴} is independently hydrogen or a substituent selected from the group consisting of the General Substituents defined herein; and
any two substituents may be joined or fused to form a ring.

In some embodiments, R^{A3} comprises a structure selected from the group consisting of the structures of the following LIST 3:

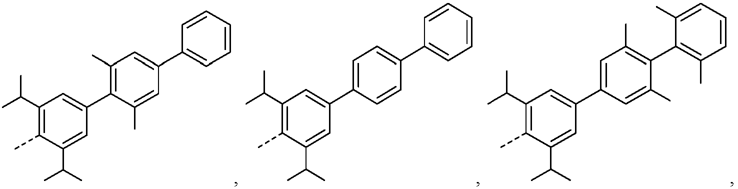

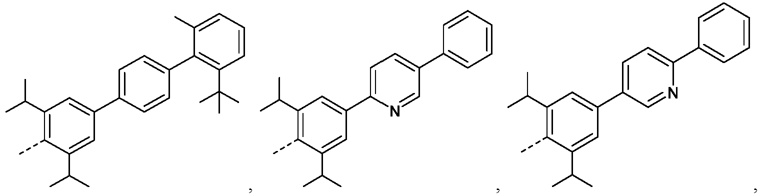

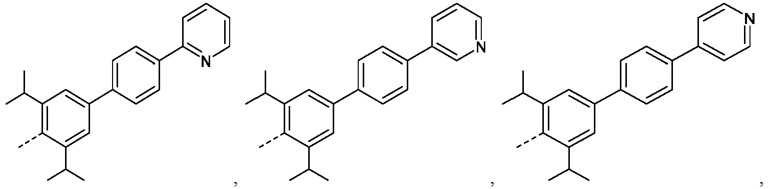

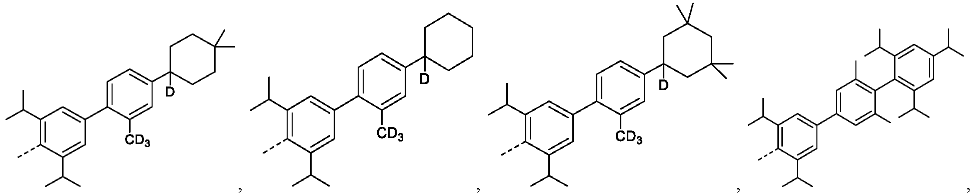

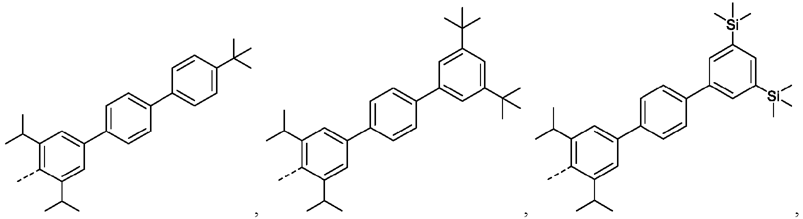

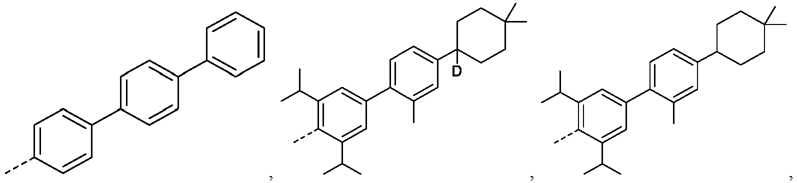

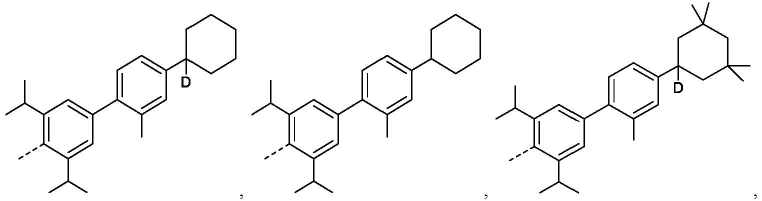

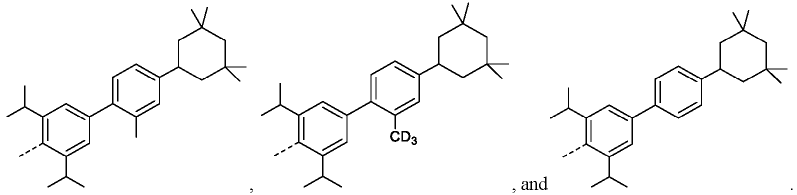

In some embodiments, R^{A3} comprises a structure selected from the group consisting of the structures of the following LIST 3a: 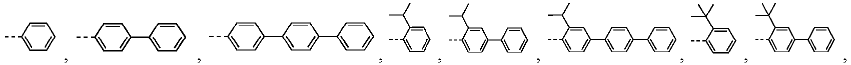 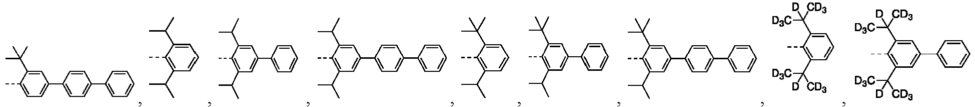 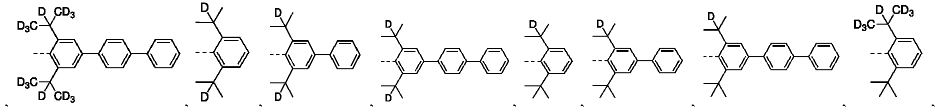 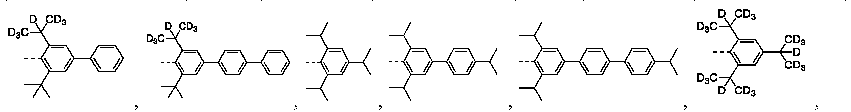 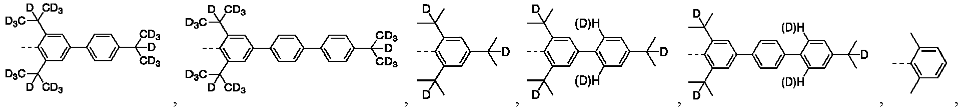 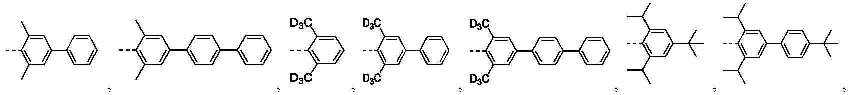 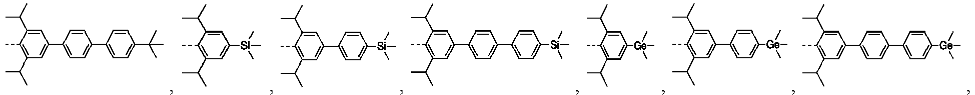 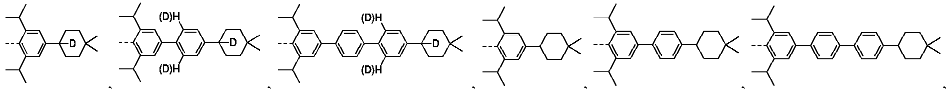 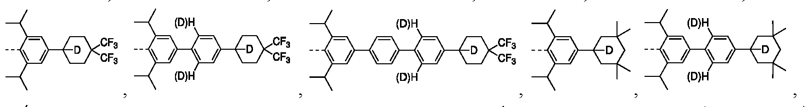 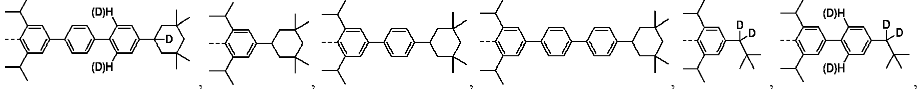 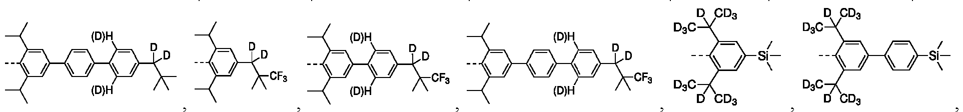 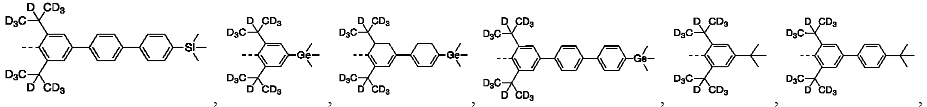 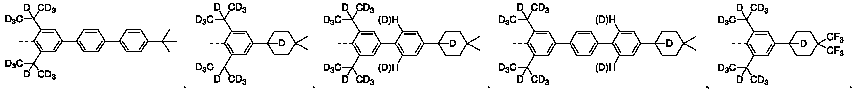 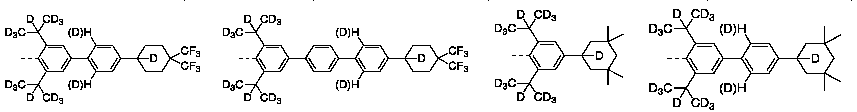 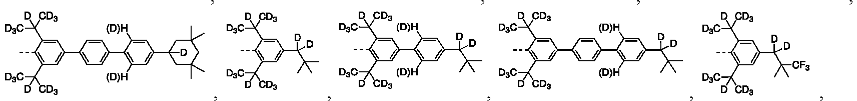 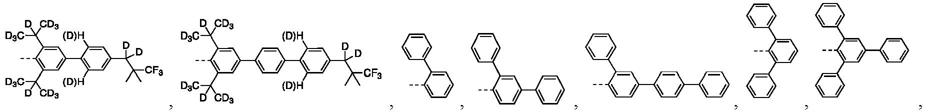 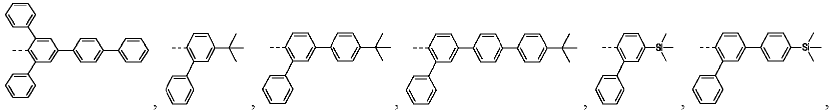 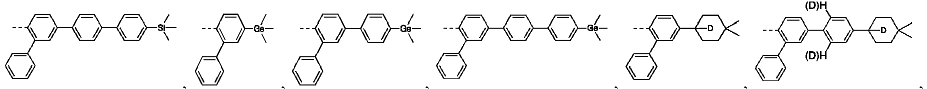 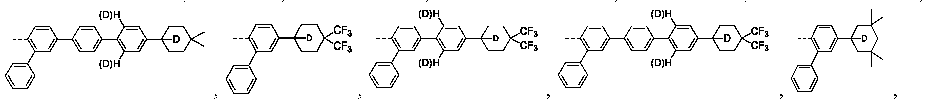 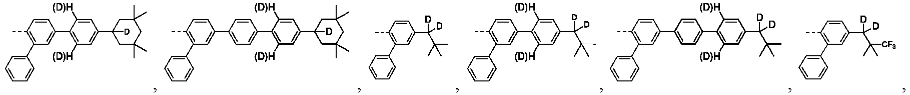 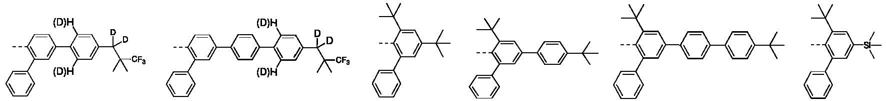 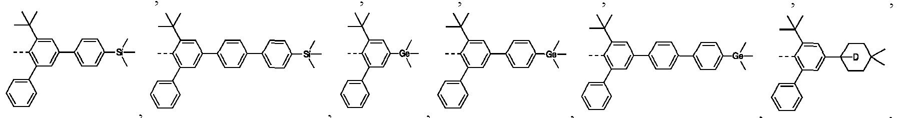 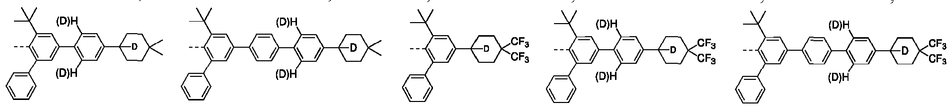 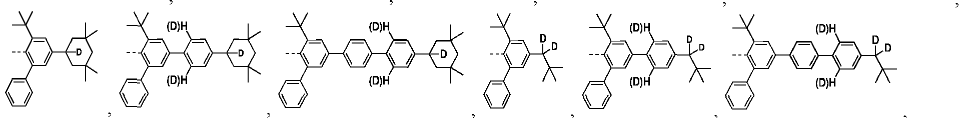 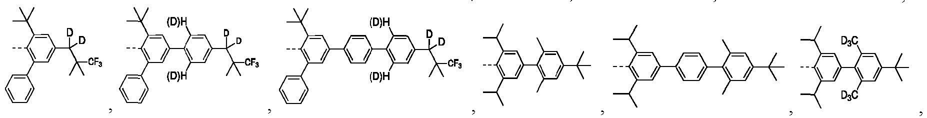 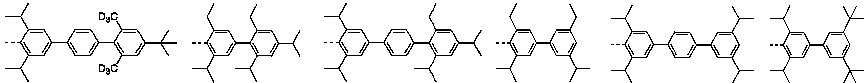 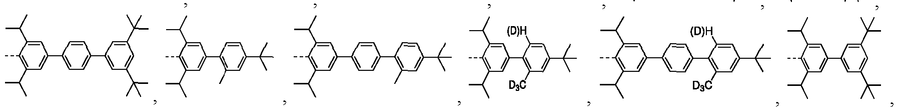 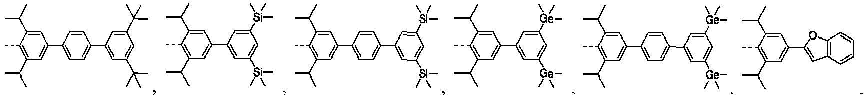 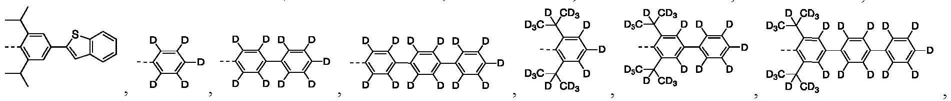 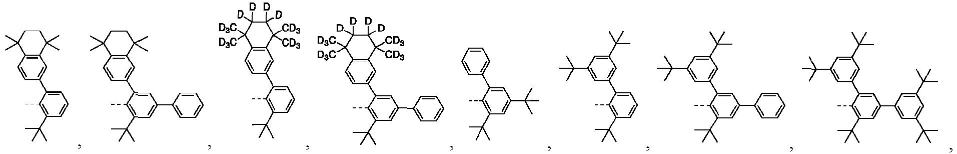 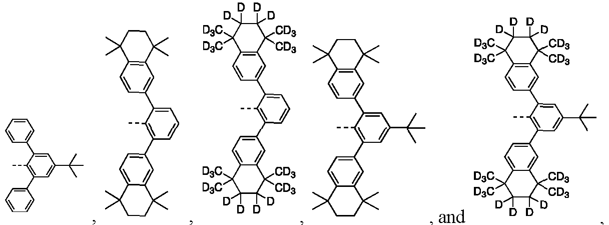 where (D)H represents either a D or an H.

In some embodiments, R^{A3} comprises a structure selected from the group consisting of the structures of the following LIST 3b: 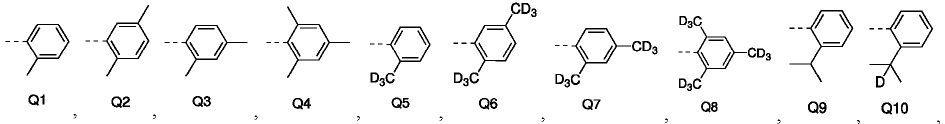 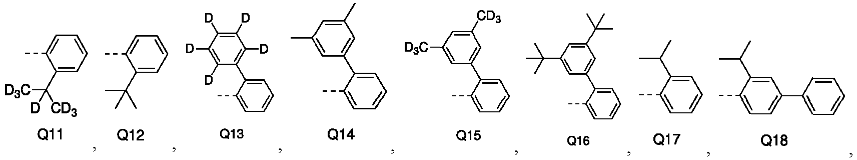 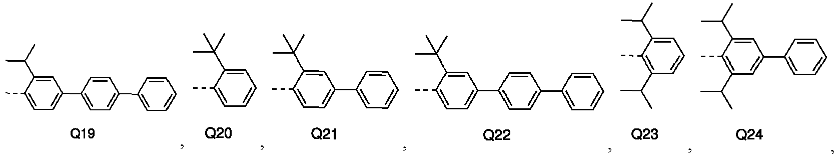 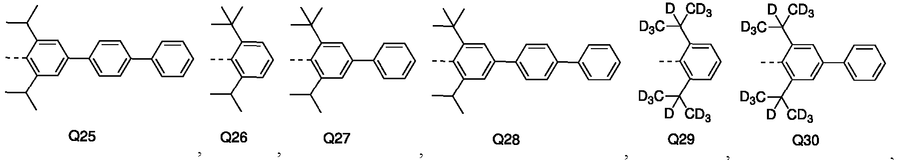 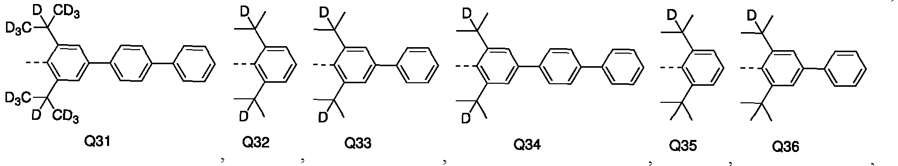 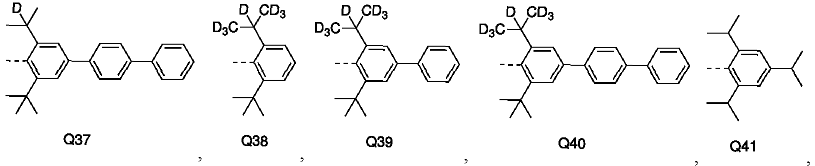 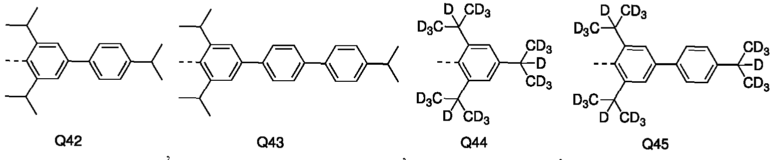 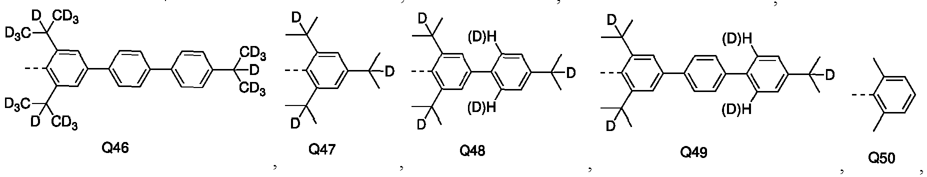 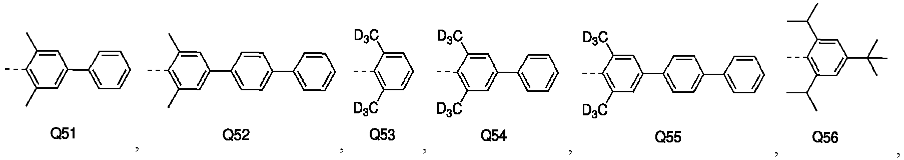 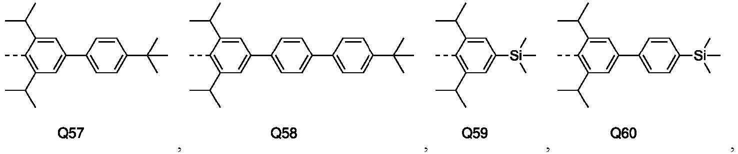 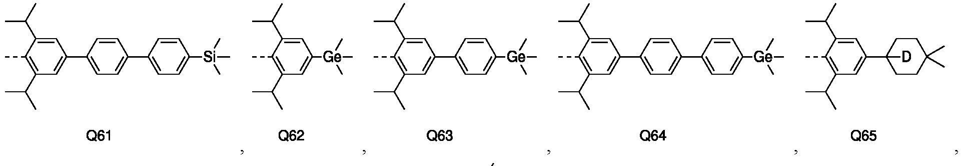 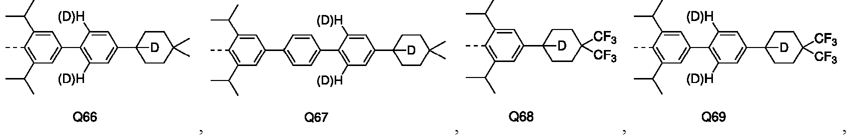 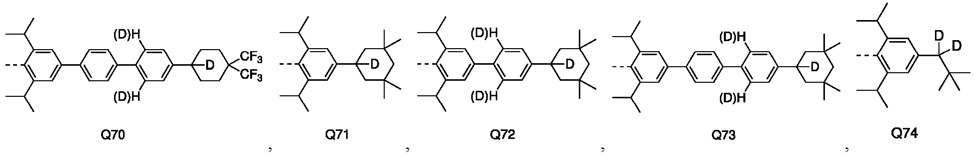 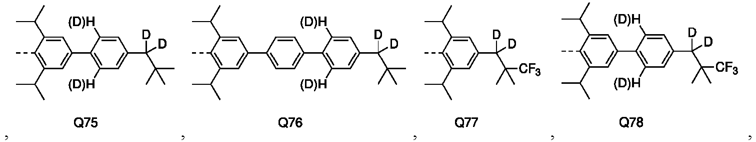 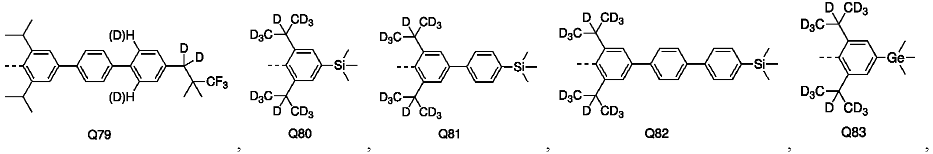 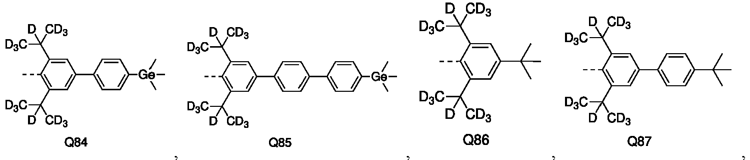 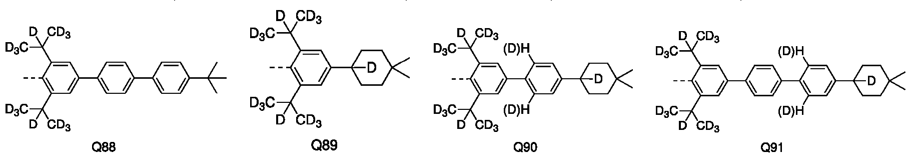 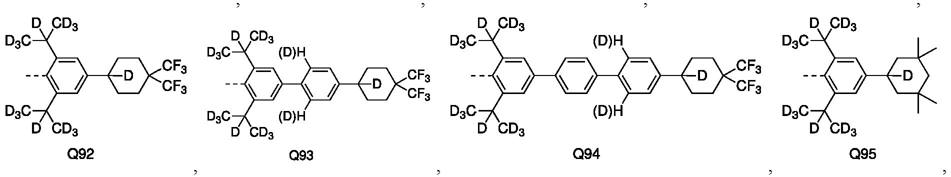 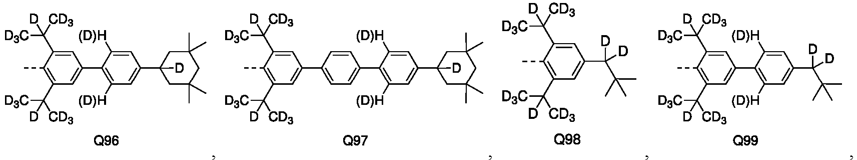 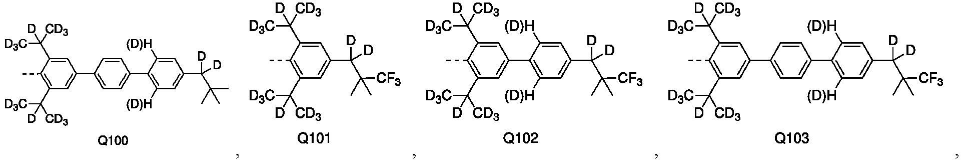 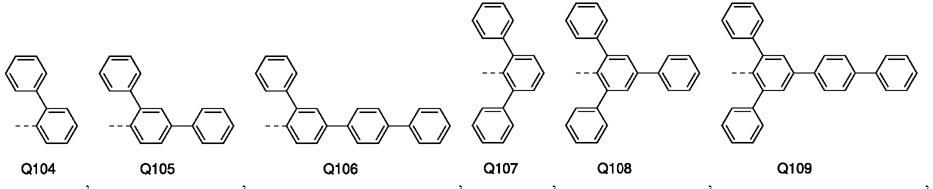 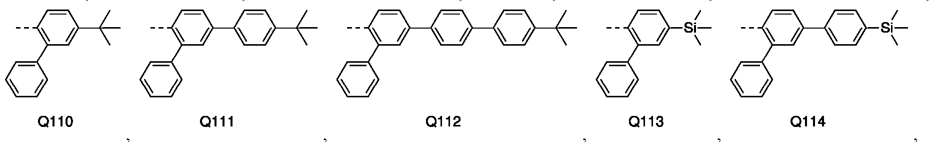 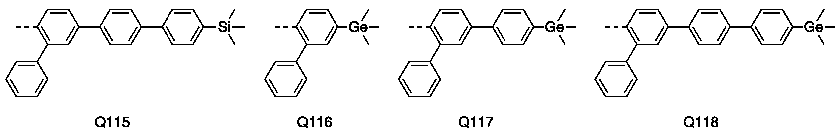 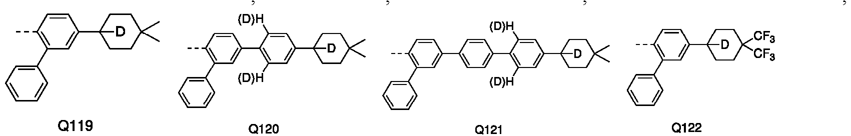 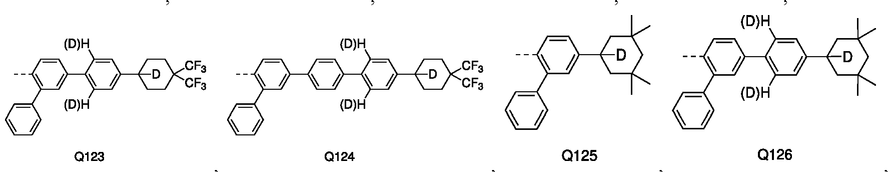 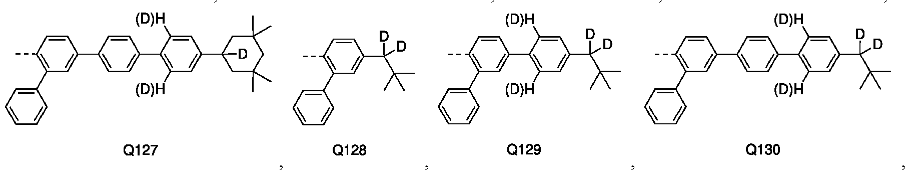 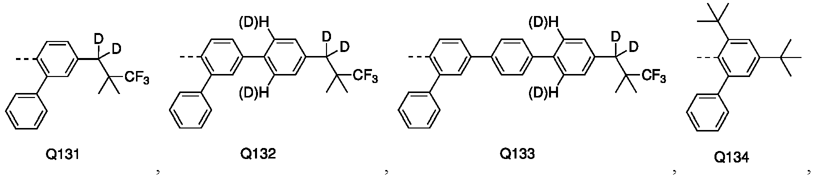 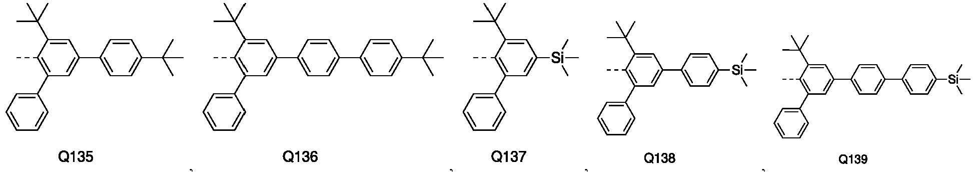 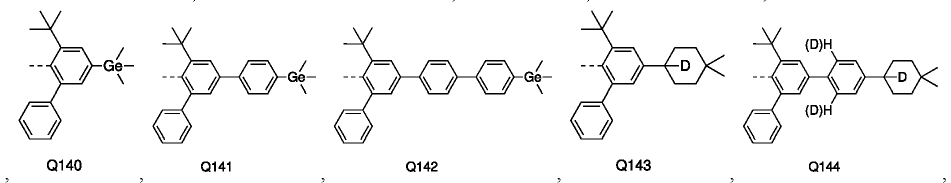 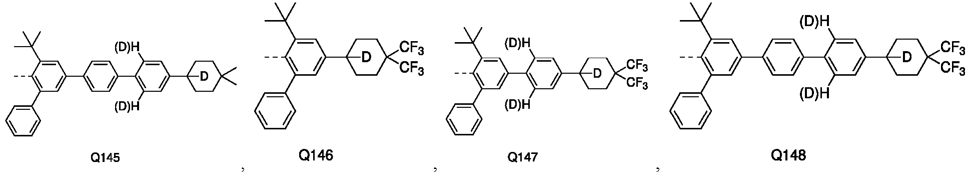 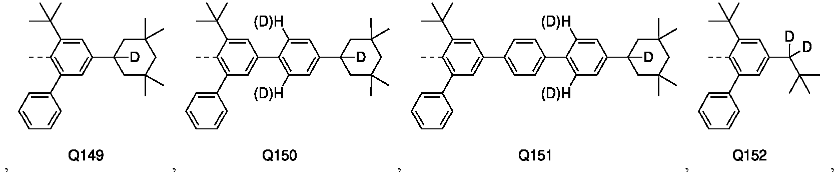 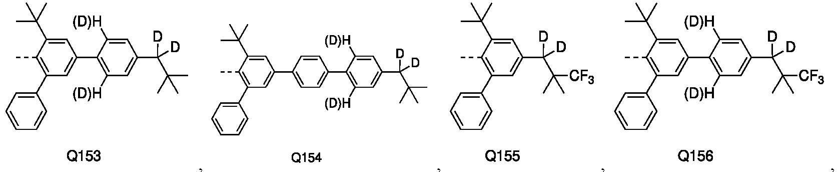 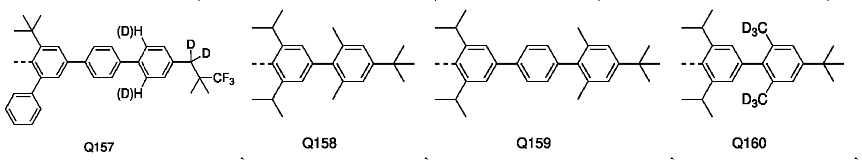 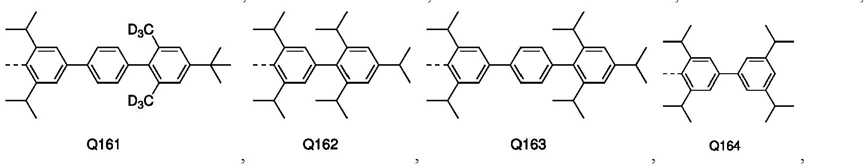 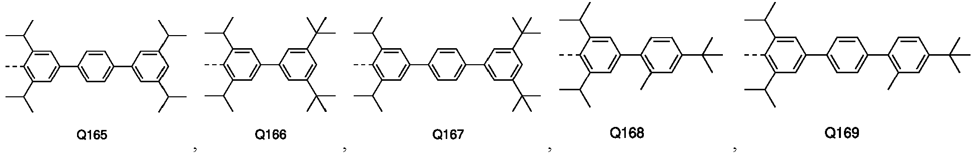 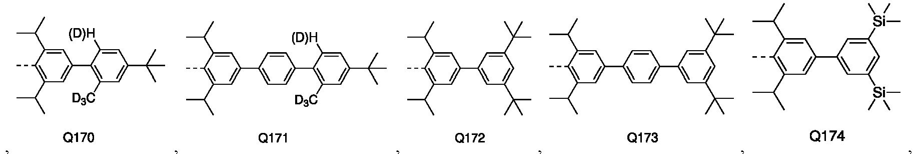 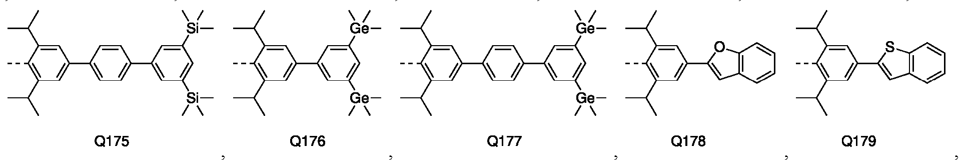 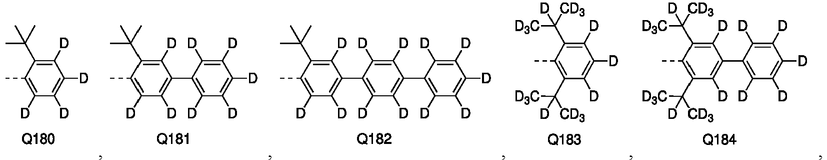 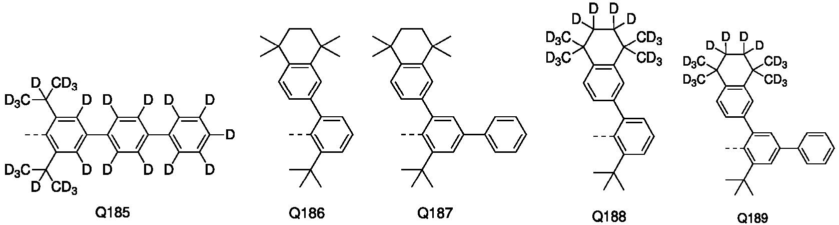 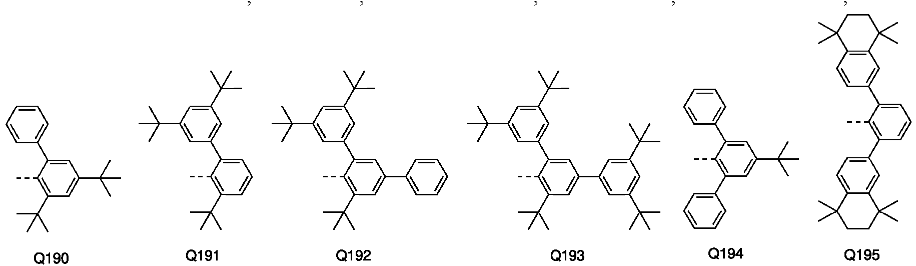 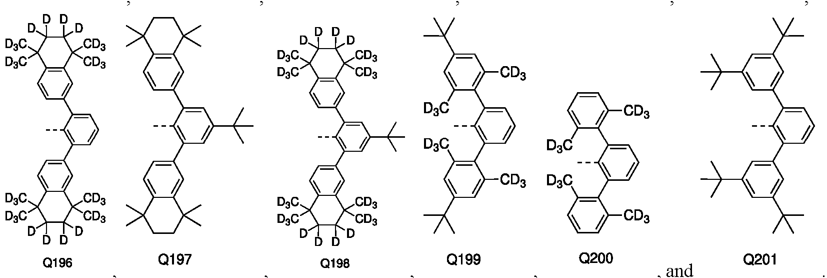 wherein the dotted line is attached to N.

In some embodiments, at least one R^{B} is not hydrogen.

In some embodiments, at least one R^{B} comprises at least one C atom. In some embodiments, at least one R^{B} comprises at least two C atoms. In some embodiments, at least one R^{B} comprises at least three C atoms. In some embodiments, at least one R^{B} comprises at least four C atoms.

In some embodiments, at least one R^{B} comprises a substituent selected from the group consisting of alkyl, cycloalkyl, silyl, germyl, aryl, heteroaryl, and combinations thereof.

In some embodiments, at least one R^{C} is not hydrogen.

In some embodiments, at least one R^{C} comprises at least one C atom. In some embodiments, at least one R^{C} comprises at least two C atoms. In some embodiments, at least one R^{C} comprises at least three C atoms. In some embodiments, at least one R^{C} comprises at least four C atoms.

In some embodiments, at least one R^{C} comprises a substituent selected from the group consisting of alkyl, cycloalkyl, silyl, germyl, aryl, heteroaryl, and combinations thereof.

In some embodiments, at least one R^{D} is not hydrogen.

In some embodiments, at least one R^{D} comprises at least one C atom. In some embodiments, at least one R^{D} comprises at least two C atoms. In some embodiments, at least one R^{D} comprises at least three C atoms. In some embodiments, at least one R^{D} comprises at least four C atoms.

In some embodiments, at least one R^{D} comprises a substituent selected from the group consisting of alkyl, cycloalkyl, silyl, germyl, aryl, heteroaryl, and combinations thereof.

In some embodiments, two R^{D} are joined or fused to form a moiety D1, wherein moiety D1 is a monocyclic ring or a polycyclic fused ring system, wherein the monocyclic ring or each ring of the polycyclic fused ring system is independently a 5-membered or 6-membered carbocyclic or heterocyclic ring.

In some such embodiments, moiety D1 is selected from the group consisting of the Cyclic Moiety List defined herein.

In some embodiments, moiety D1 is a monocyclic ring. In some embodiments, moiety D1 is benzene.

In some embodiments, moiety D1 is a polycyclic fused ring system. In some embodiments, moiety D1 is naphthalene.

In some embodiments, at least one R^{A'} is not hydrogen. In some embodiments, the R^{A'} at X¹³ is not hydrogen. In some embodiments, R^{A'} adjacent to the bond with moiety A" is not hydrogen.

In some embodiments, at least one R^{A'} comprises at least one C atom. In some embodiments, at least one R^{A'} comprises at least two C atoms. In some embodiments, at least one R^{A'} comprises at least three C atoms. In some embodiments, at least one R^{A'} comprises at least four C atoms.

In some embodiments, at least one R^{A'} comprises a substituent selected from the group consisting of alkyl, cycloalkyl, silyl, germyl, aryl, heteroaryl, and combinations thereof.

In some embodiments, at least one R^{A"} is not hydrogen. In some embodiments, an R^{A"} adjacent to the bond with moiety A' is not hydrogen. In some embodiments, R^{A"} at X²⁰ is not hydrogen.

In some embodiments, at least one R^{A"} comprises at least one C atom. In some embodiments, at least one R^{A"} comprises at least two C atoms. In some embodiments, at least one R^{A"} comprises at least three C atoms. In some embodiments, at least one R^{A"} comprises at least four C atoms.

In some embodiments, at least one R^{A"} comprises a substituent selected from the group consisting of alkyl, cycloalkyl, silyl, germyl, aryl, heteroaryl, and combinations thereof.

In some embodiments, no R^{A'} is joined to an R^{A"}

In some embodiments, one R^{A'} is joined to one R^{A"} to form a ring fused to both ring A' and ring A".

In some embodiments, two R^{A} are joined or fused to form a moiety A1, wherein moiety A1 is a monocyclic ring or polycyclic fused ring system, wherein the monocyclic ring or each ring of the polycyclic fused ring system is independently a 5-membered to 10-membered carbocyclic or heterocyclic ring.

In some embodiments, moiety A1 is selected from the group consisting of the Cyclic Moiety List defined herein.

In some embodiments, moiety A1 is a monocyclic ring. In some embodiments, moiety A1 is benzene.

In some embodiments, moiety A1 is a polycyclic fused ring system. In some embodiments, moiety A1 is naphthalene.

In some embodiments, the ligand L_{A} is selected from the group consisting of the structures of the following LIST 4: 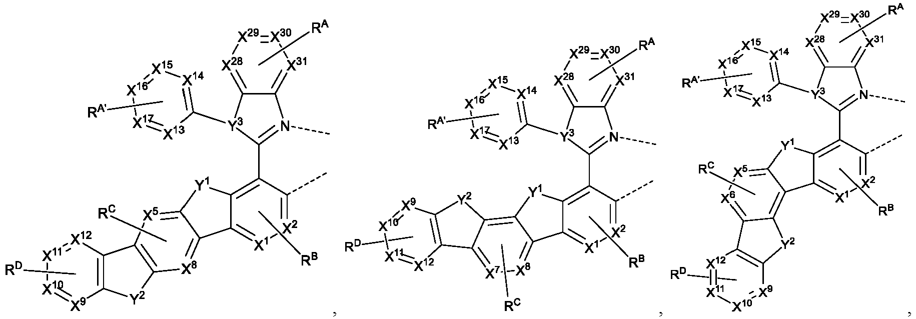 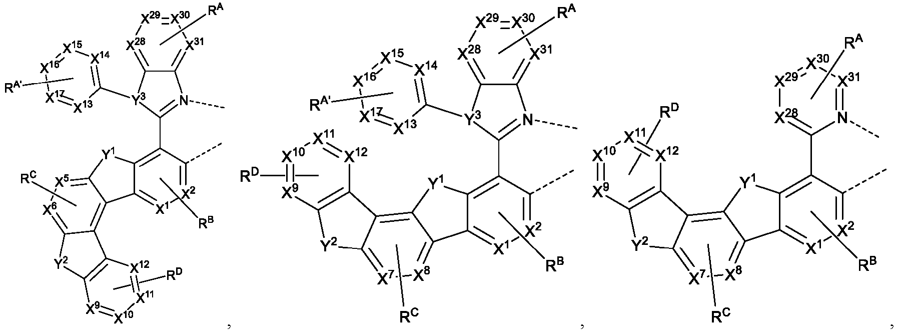 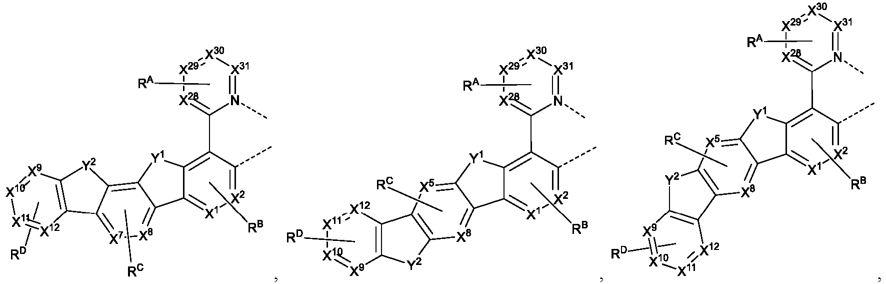 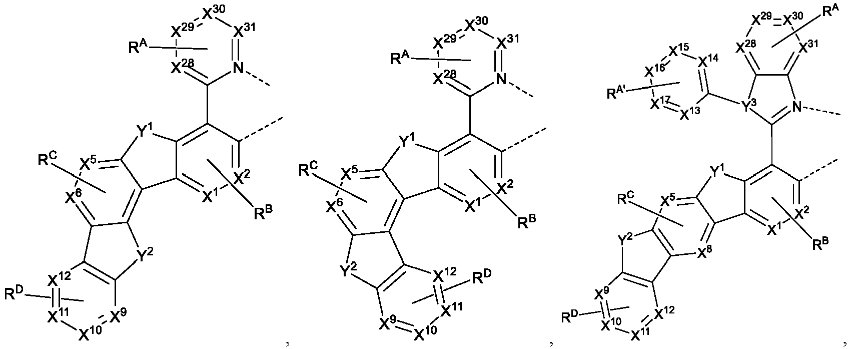 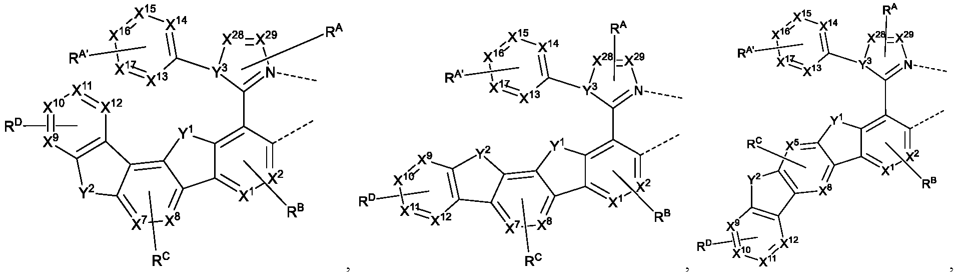 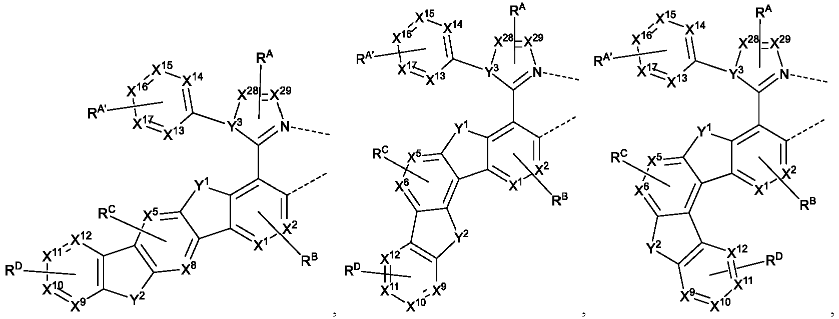 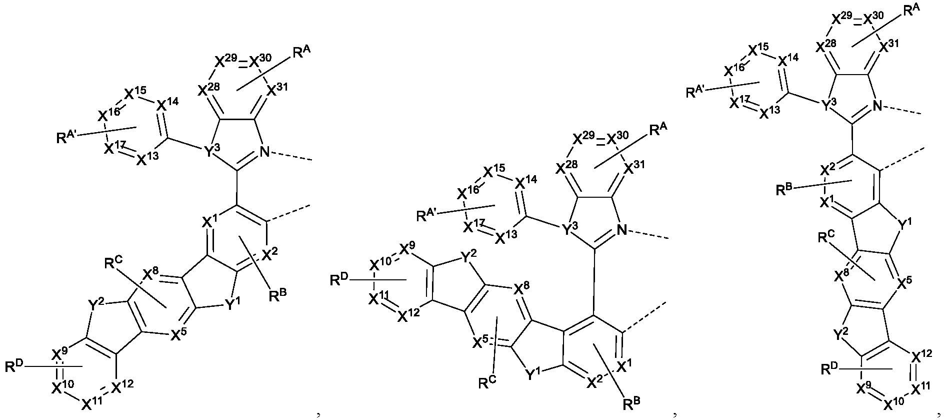 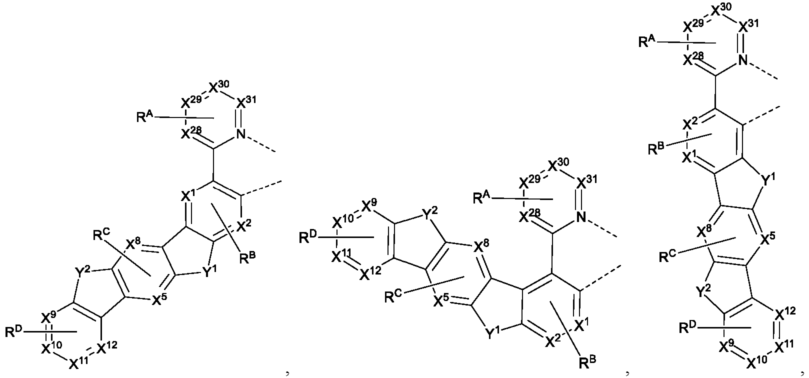 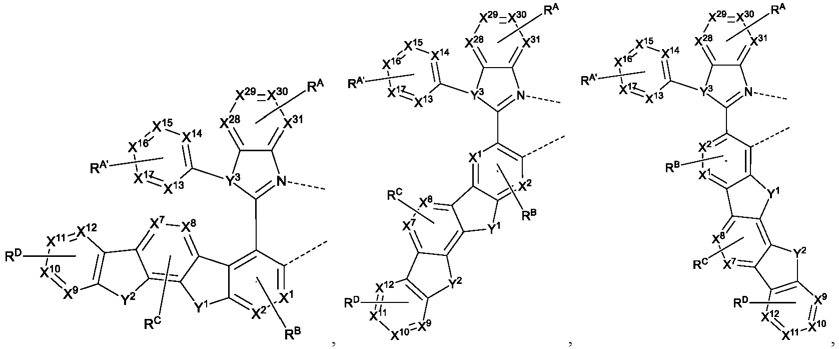 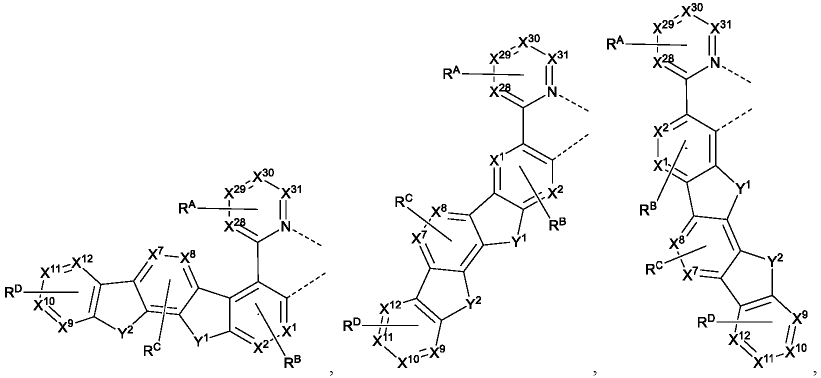 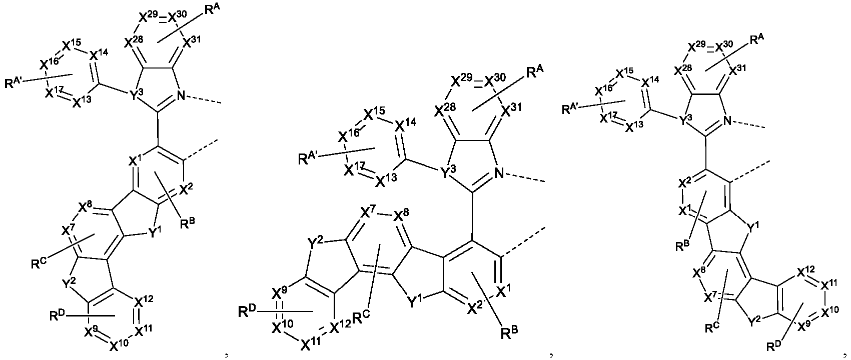 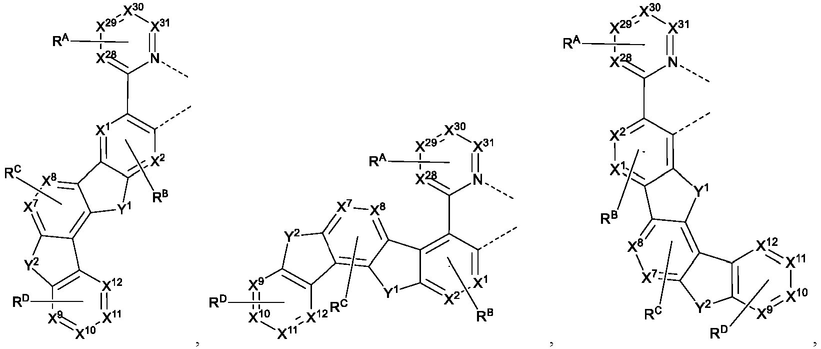 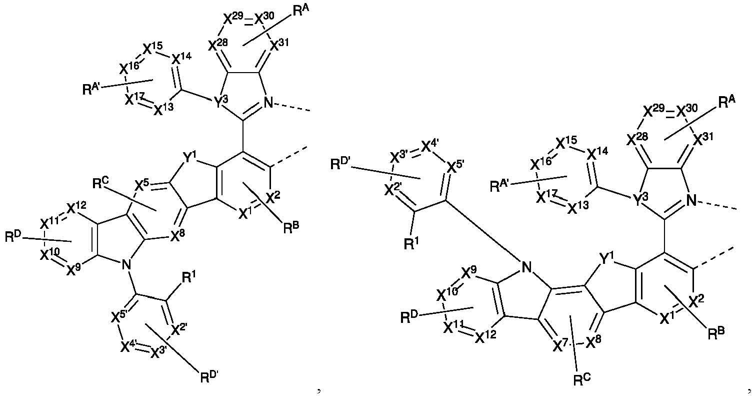 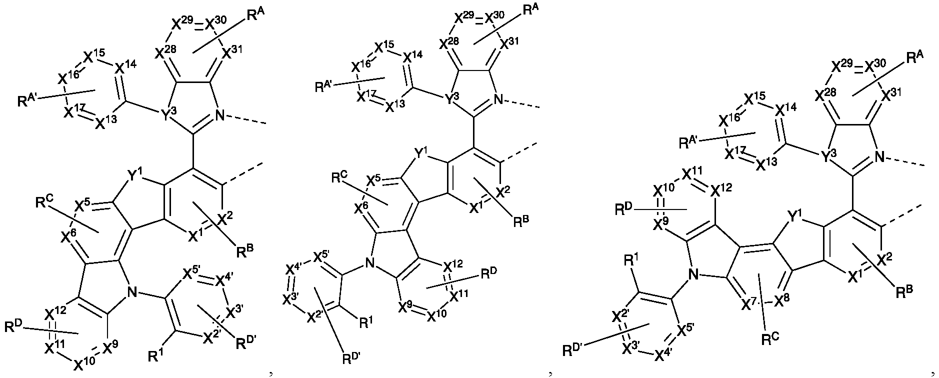 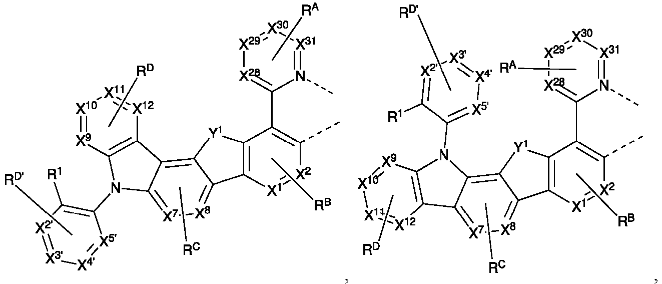 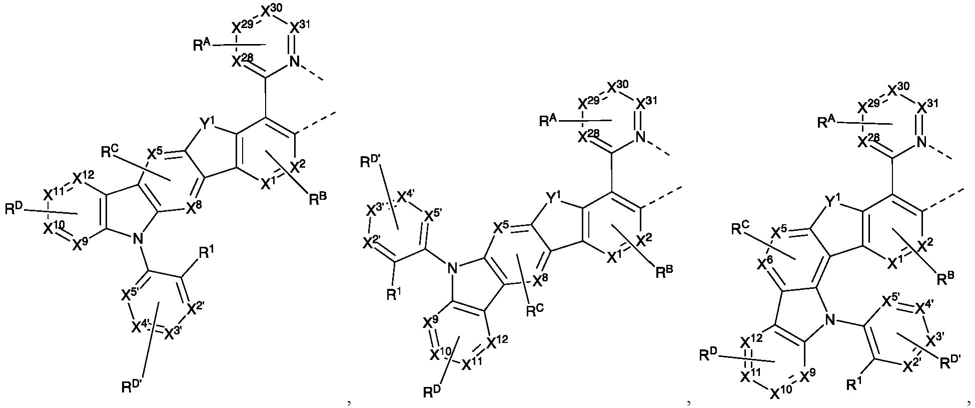 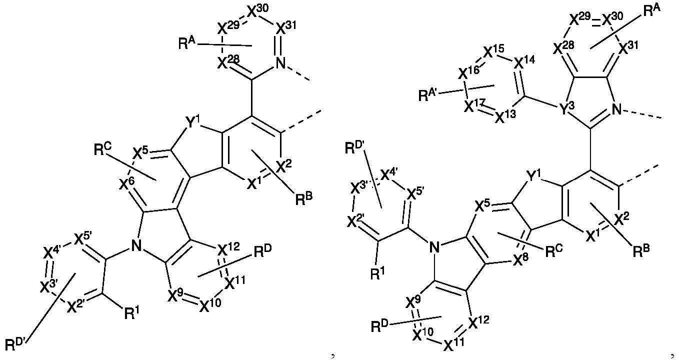 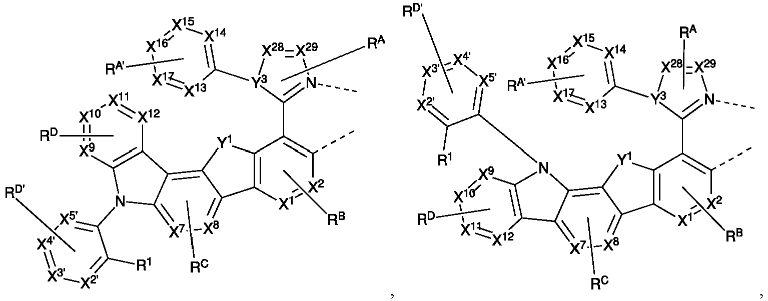 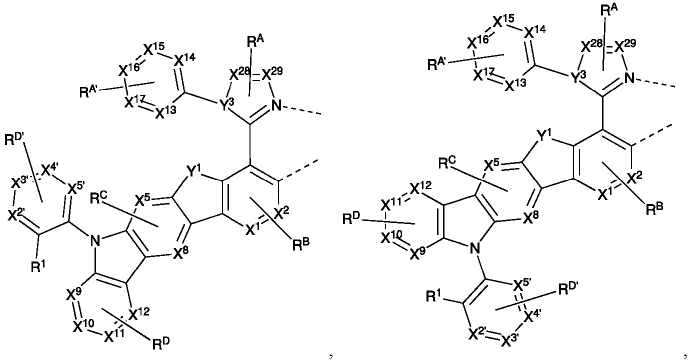 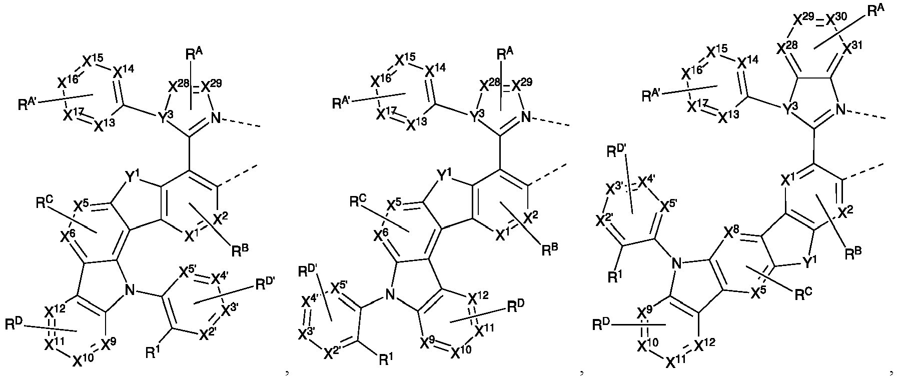 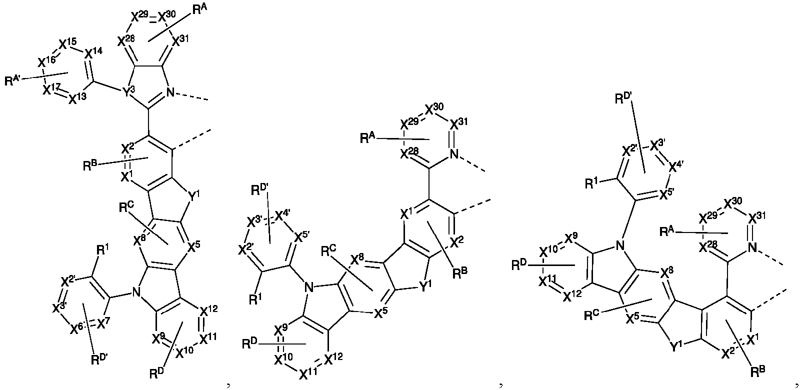 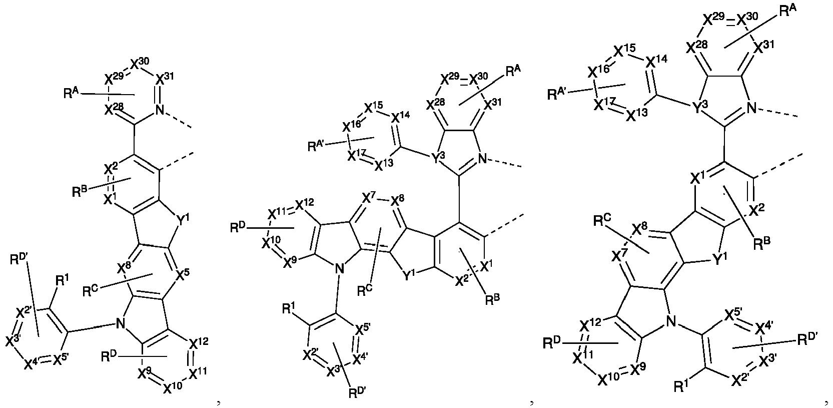 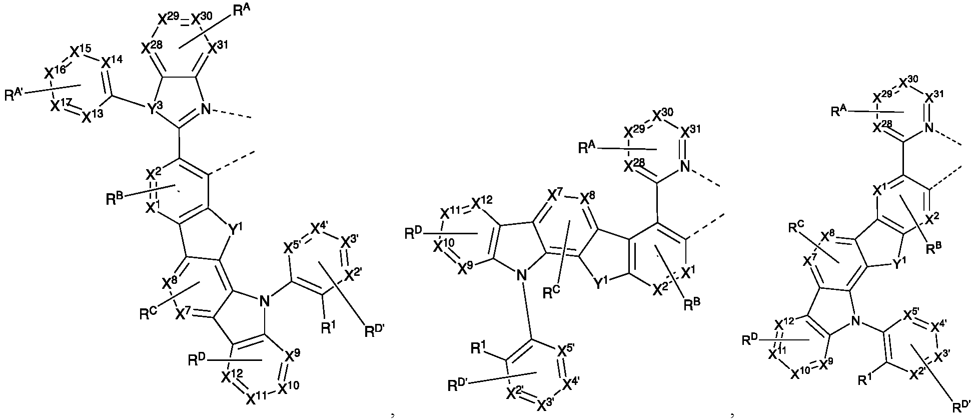 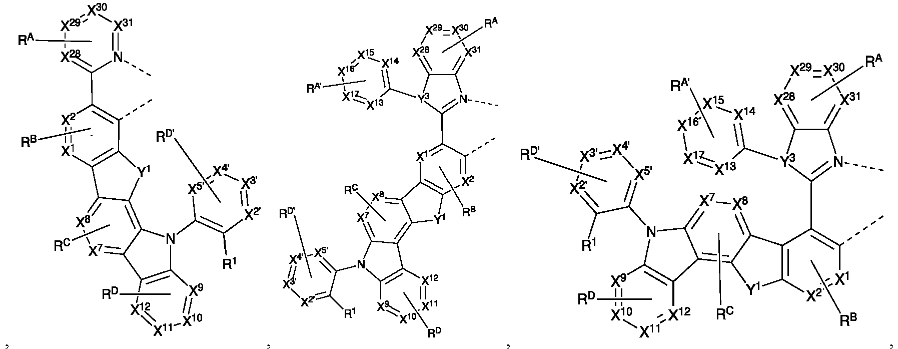 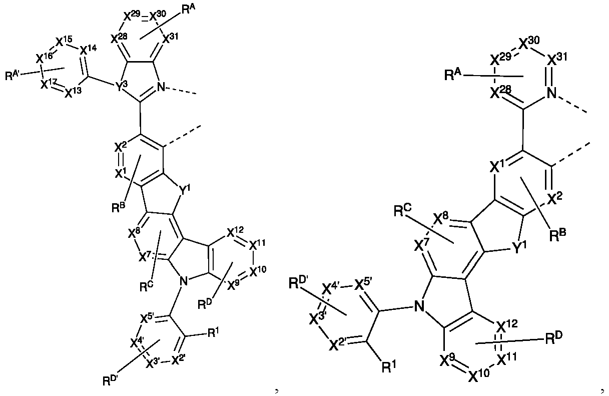 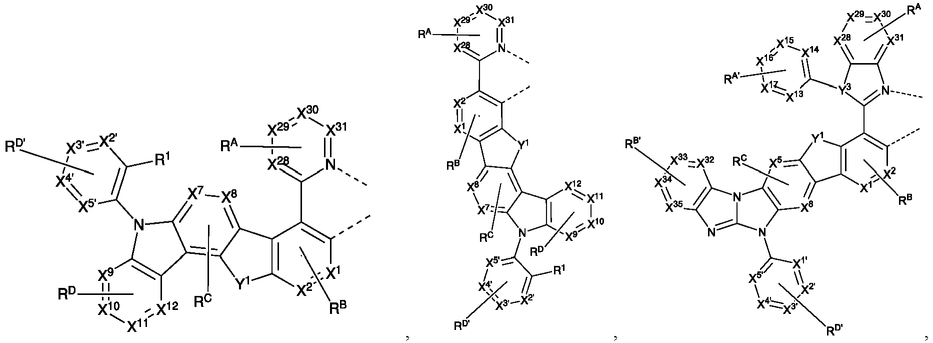 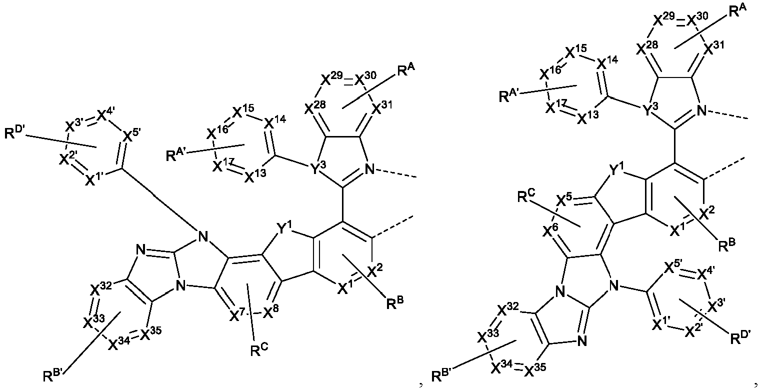 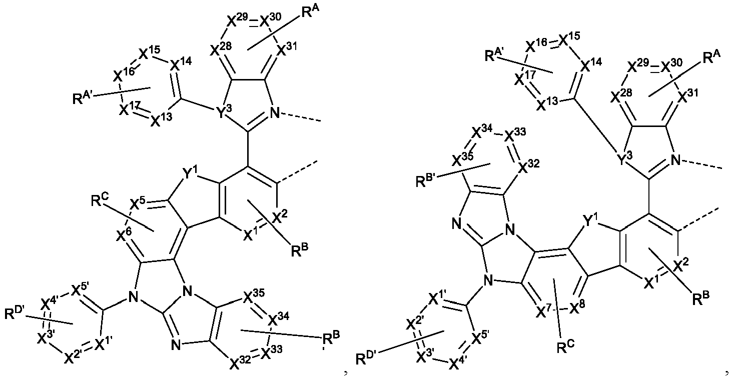 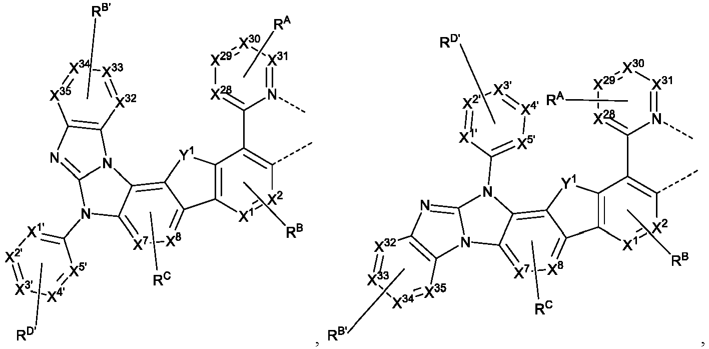 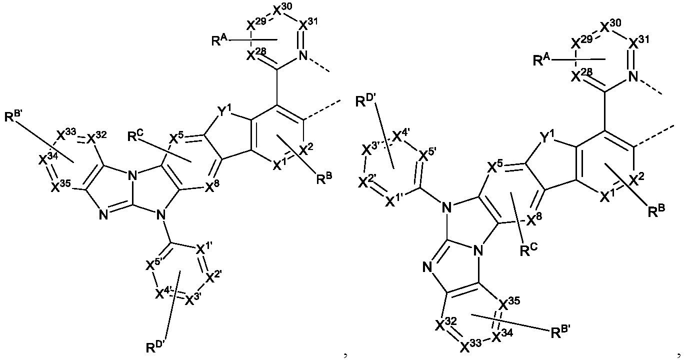 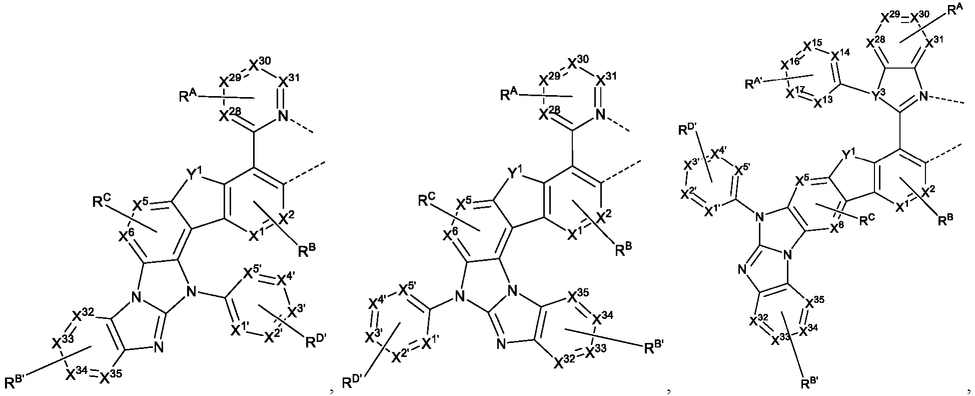 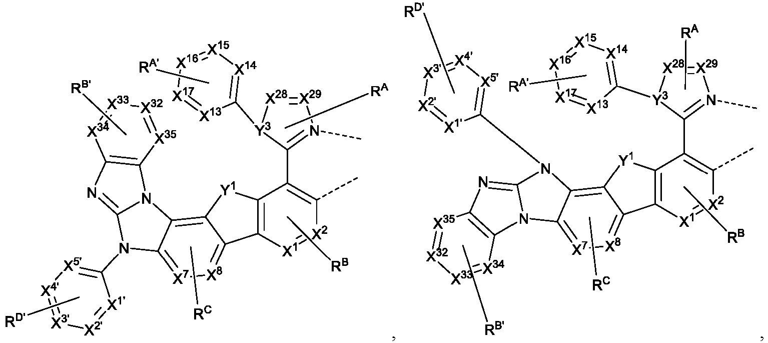 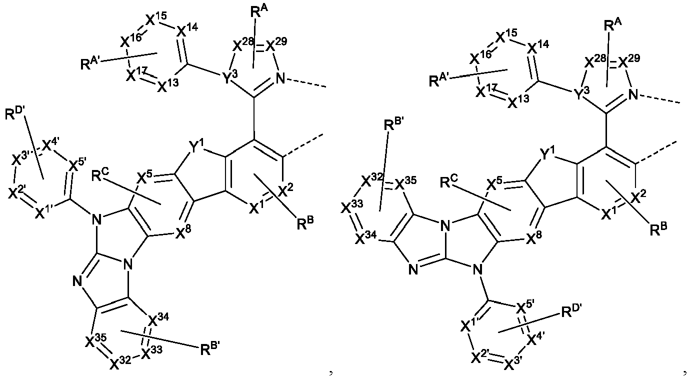 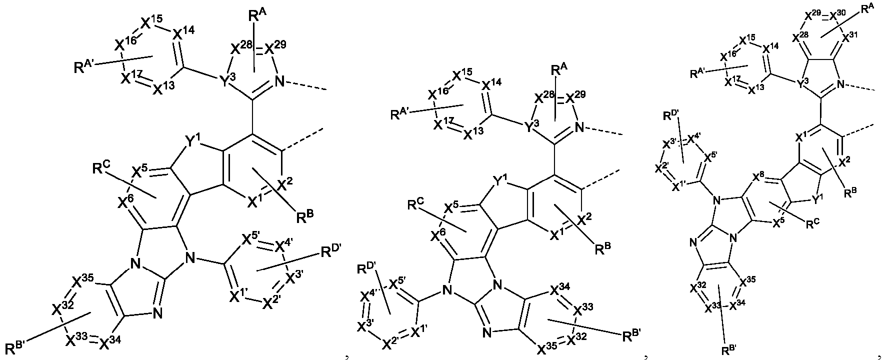 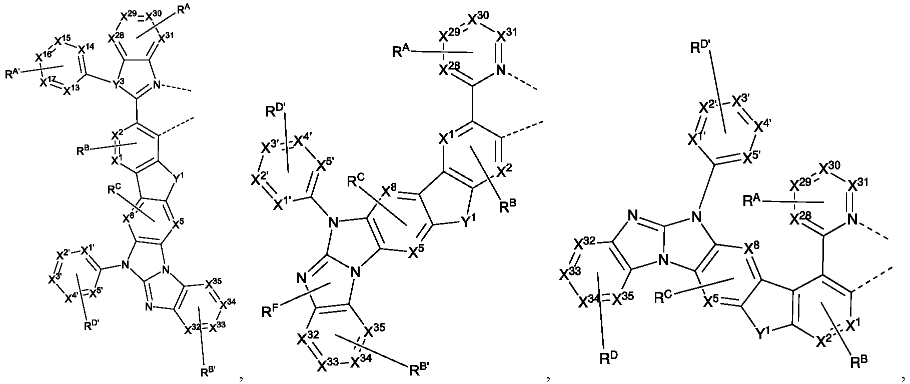 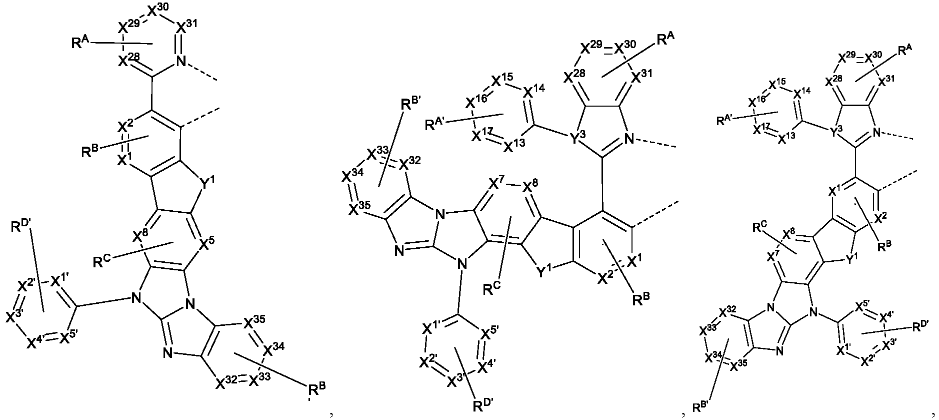 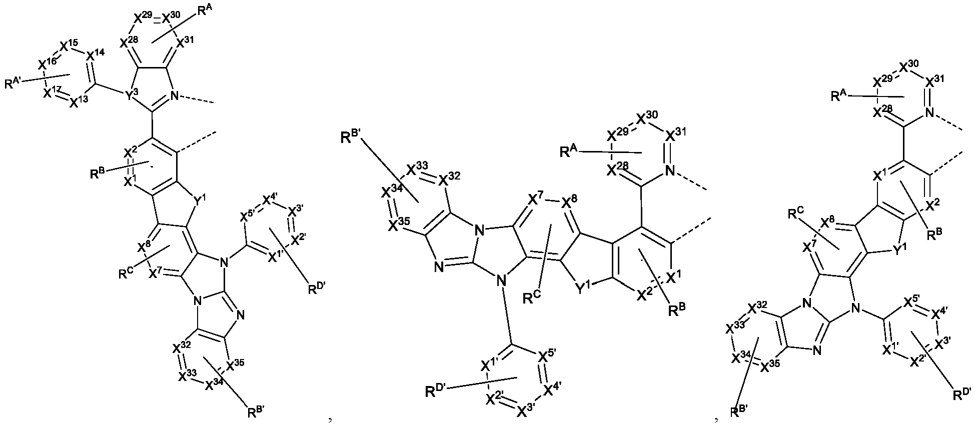 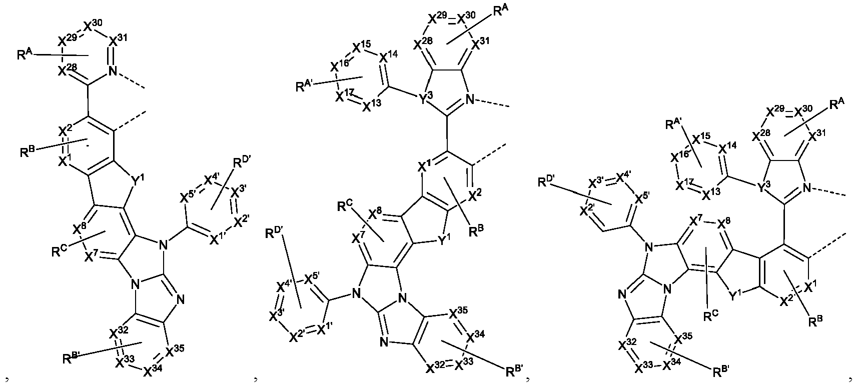 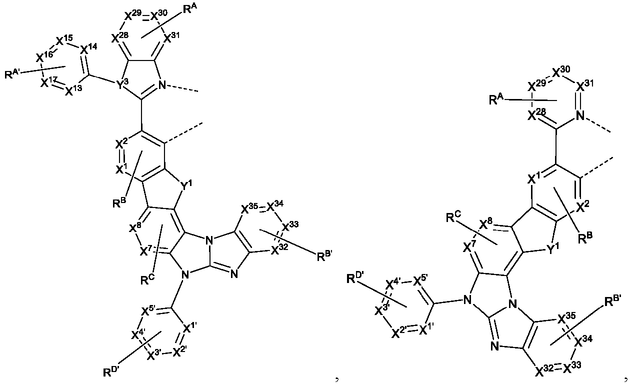 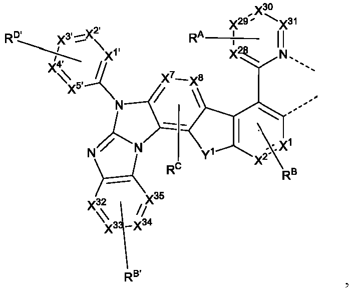 and 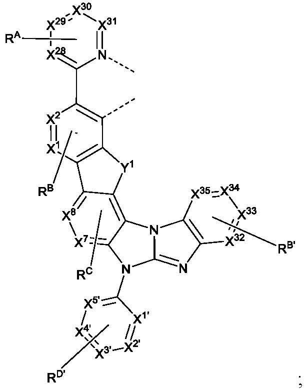 wherein:
each of X¹-X³⁶ is independently C or N;
each of Y¹ to Y² is independently selected from the group consisting of BR, BRR', NR, PR, P(O)R, O, S, Se, C=O, C=S, C=Se, C=NR', C=CRR', S=O, SO₂, CRR', SiRR', GeRR';
Y³ is B, N, P, CR, SiR, or GeR;
R^{A'} represents mono to the maximum allowable substitutions, or no substitutions;
each R^{A'} is independently hydrogen or a substituent selected from the group consisting of the General Substituents defined herein;
the remaining variables are the same as previously defined; and
any two adjacent substituents may be fused or joined to form a ring or form a multidentate ligand.

In some embodiments where ligand L_{A} is a structure selected from LIST 4, two R^{A} are joined to form a fused ring. In some such embodiments, the fused ring may be benzene, pyridine, pyrimidine, pyridazine, pyrazine, triazine, imidazole, pyrazole, pyrrole, oxazole, furan, thiophene, or thiazole. In some such embodiments, the fused ring may be benzene. In some embodiments, Y³ is N. In some embodiments, Y¹ and Y² are each independently O.

In some embodiments where ligand L_{A} is selected from LIST 4, at least one R^{A}, R^{A'}, R^{B}, R^{B'}, R^{C}, R^{D}, or R^{D'} is selected from the group consisting of the General Substituents defined herein. In some embodiments, at least one R^{A} is selected from the group consisting of the General Substituents defined herein. In some embodiments, at least one R^{A'} is selected from the group consisting of the General Substituents defined herein. In some embodiments, at least one R^{B} is selected from the group consisting of the General Substituents defined herein. In some embodiments, at least one R^{B'} is selected from the group consisting of the General Substituents defined herein. In some embodiments, at least one R^{C} is selected from the group consisting of the General Substituents defined herein. In some embodiments, at least one R^{D} is selected from the group consisting of the General Substituents defined herein. In some embodiments, at least one R^{D'} is selected from the group consisting of the General Substituents defined herein. In some embodiments, at least one R^{A}, R^{A'}, R^{B}, R^{B'},R^{C}, R^{D}, or R^{D'} is selected from the group consisting of the Preferred General Substituents defined herein.

In some embodiments, where ligand L_{A} is selected from LIST 4, at least one of R^{A'}, R^{A}, R^{B}, R^{B'}, R^{C}, R^{D}, or R^{D'} is partially or fully deuterated. In some embodiments, at least one R^{A'} is partially or fully deuterated. In some embodiments, at least one R^{A} is partially or fully deuterated. In some embodiments, at least one R^{B} is partially or fully deuterated. In some embodiments, at least one R^{C} is partially or fully deuterated. In some embodiments, at least one R^{D} is partially or fully deuterated. In some embodiments, at least one R^{D'} is partially or fully deuterated.

In some embodiments where ligand L_{A} is selected from LIST 4, at least one R^{A} is or comprises an electron-withdrawing group from the EWG1 LIST as defined herein. In some embodiments, at least one R^{A} is or comprises an electron-withdrawing group from the EWG2 LIST as defined herein. In some embodiments, at least one R^{A} is or comprises an electron-withdrawing group from the EWG3 LIST as defined herein. In some embodiments, at least one R^{A} is or comprises an electron-withdrawing group from the EWG4 LIST as defined herein. In some embodiments, at least one R^{A} is or comprises an electron-withdrawing group from the Pi-EWG LIST as defined herein.

In some embodiments where ligand L_{A} is selected from LIST 4, at least one R^{A'} is or comprises an electron-withdrawing group from the EWG1 LIST as defined herein. In some embodiments, at least one R^{A'} is or comprises an electron-withdrawing group from the EWG2 LIST as defined herein. In some embodiments, at least one R^{A'} is or comprises an electron-withdrawing group from the EWG3 LIST as defined herein. In some embodiments, at least one R^{A'} is or comprises an electron-withdrawing group from the EWG4 LIST as defined herein. In some embodiments, at least one R^{A'} is or comprises an electron-withdrawing group from the Pi-EWG LIST as defined herein.

In some embodiments where ligand L_{A} is selected from LIST 4, at least one R^{B} is or comprises an electron-withdrawing group from the EWG1 LIST as defined herein. In some embodiments, at least one R^{B} is or comprises an electron-withdrawing group from the EWG2 LIST as defined herein. In some embodiments, at least one R^{B} is or comprises an electron-withdrawing group from the EWG3 LIST as defined herein. In some embodiments, at least one R^{B} is or comprises an electron-withdrawing group from the EWG4 LIST as defined herein. In some embodiments, at least one R^{B} is or comprises an electron-withdrawing group from the Pi-EWG LIST as defined herein.

In some embodiments where ligand L_{A} is selected from LIST 4, at least one R^{B'} is or comprises an electron-withdrawing group from the EWG1 LIST as defined herein. In some embodiments, at least one R^{B'} is or comprises an electron-withdrawing group from the EWG2 LIST as defined herein. In some embodiments, at least one R^{B'} is or comprises an electron-withdrawing group from the EWG3 LIST as defined herein. In some embodiments, at least one R^{B'} is or comprises an electron-withdrawing group from the EWG4 LIST as defined herein. In some embodiments, at least one R^{B'} is or comprises an electron-withdrawing group from the Pi-EWG LIST as defined herein.

In some embodiments where ligand L_{A} is selected from LIST 4, at least one R^{C} is or comprises an electron-withdrawing group from the EWG1 LIST as defined herein. In some embodiments, at least one R^{C} is or comprises an electron-withdrawing group from the EWG2 LIST as defined herein. In some embodiments, at least one R^{C} is or comprises an electron-withdrawing group from the EWG3 LIST as defined herein. In some embodiments, at least one R^{C} is or comprises an electron-withdrawing group from the EWG4 LIST as defined herein. In some embodiments, at least one R^{C} is or comprises an electron-withdrawing group from the Pi-EWG LIST as defined herein.

In some embodiments where ligand L_{A} is selected from LIST 4, at least one R^{D} is or comprises an electron-withdrawing group from the EWG1 LIST as defined herein. In some embodiments, at least one R^{D} is or comprises an electron-withdrawing group from the EWG2 LIST as defined herein. In some embodiments, at least one R^{D} is or comprises an electron-withdrawing group from the EWG3 LIST as defined herein. In some embodiments, at least one R^{D} is or comprises an electron-withdrawing group from the EWG4 LIST as defined herein. In some embodiments, at least one R^{D} s or comprises an electron-withdrawing group from the Pi-EWG LIST as defined herein.

In some embodiments where ligand L_{A} is selected from LIST 4, at least one R^{D'} is or comprises an electron-withdrawing group from the EWG1 LIST as defined herein. In some embodiments, at least one R^{D'} is or comprises an electron-withdrawing group from the EWG2 LIST as defined herein. In some embodiments, at least one R^{D'} is or comprises an electron-withdrawing group from the EWG3 LIST as defined herein. In some embodiments, at least one R^{D'} is or comprises an electron-withdrawing group from the EWG4 LIST as defined herein. In some embodiments, at least one R^{D'} s or comprises an electron-withdrawing group from the Pi-EWG LIST as defined herein.

In some embodiments, the ligand L_{A} is selected from the group consisting of the structures of the following LIST 5: 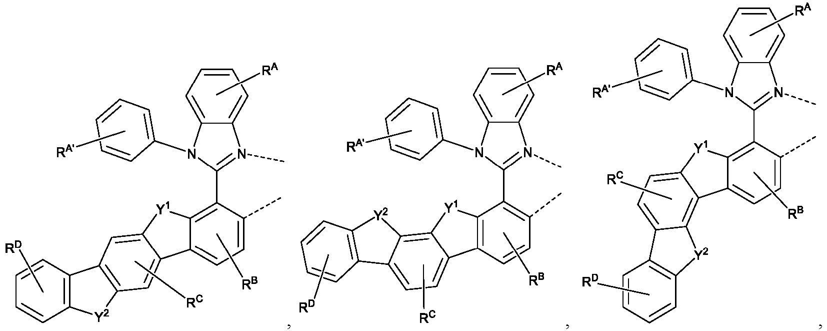 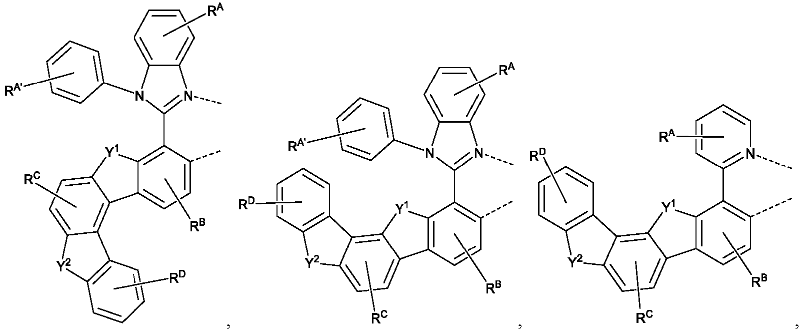 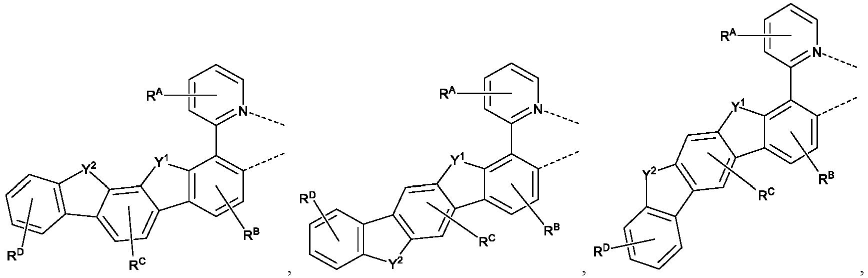 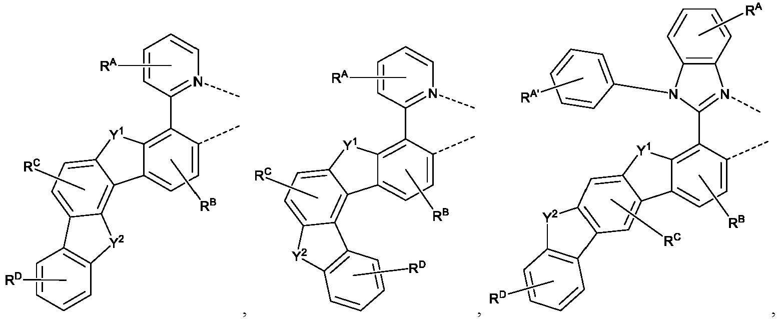 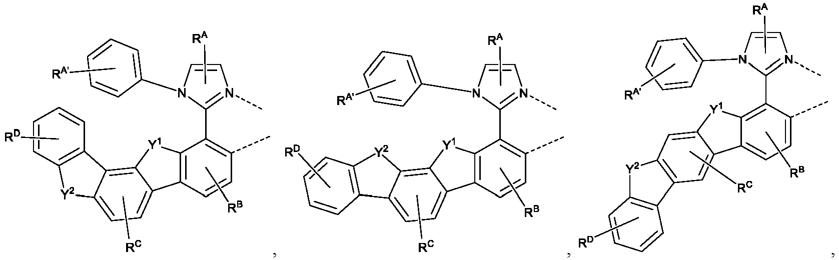 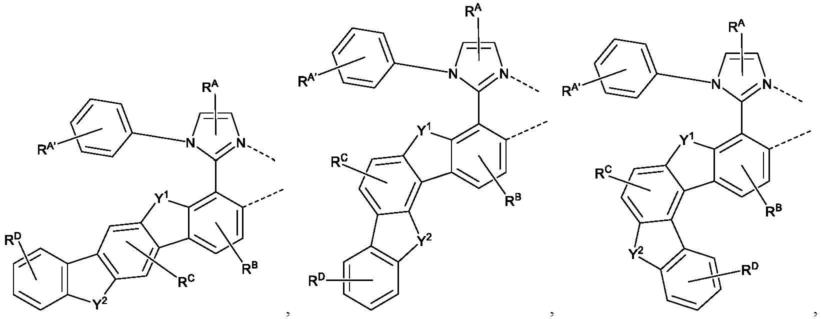 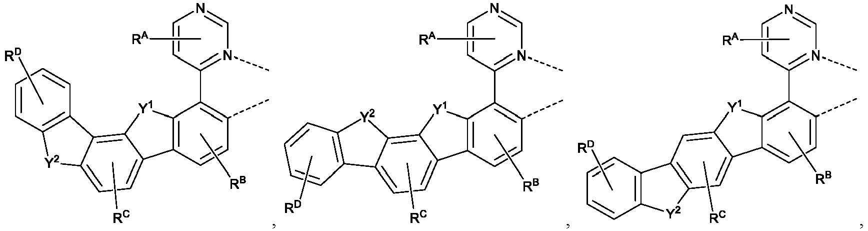 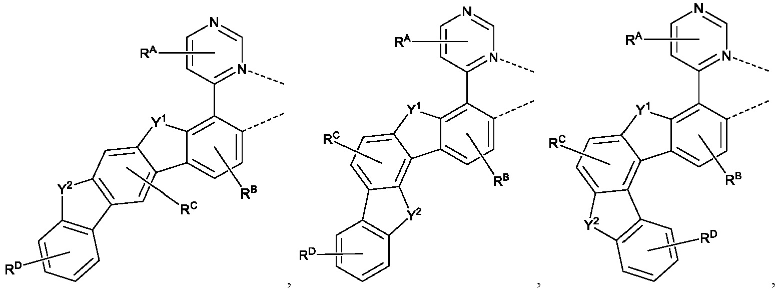 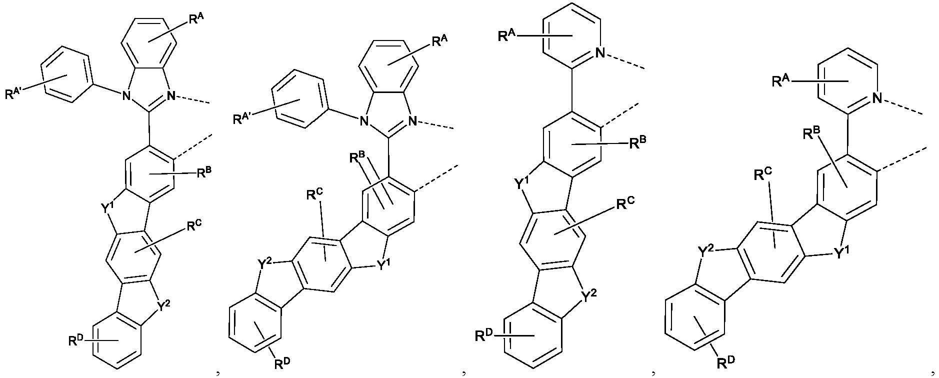 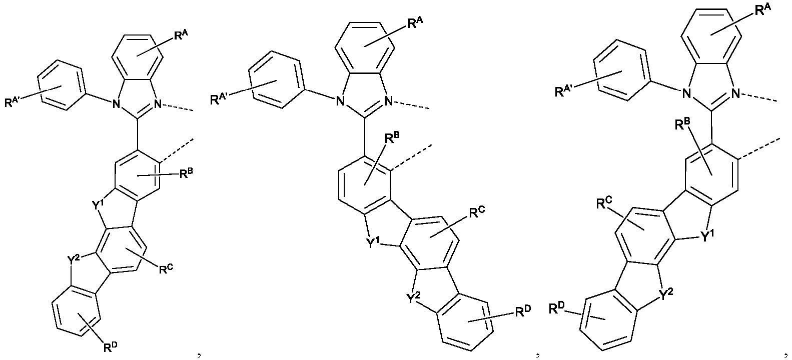 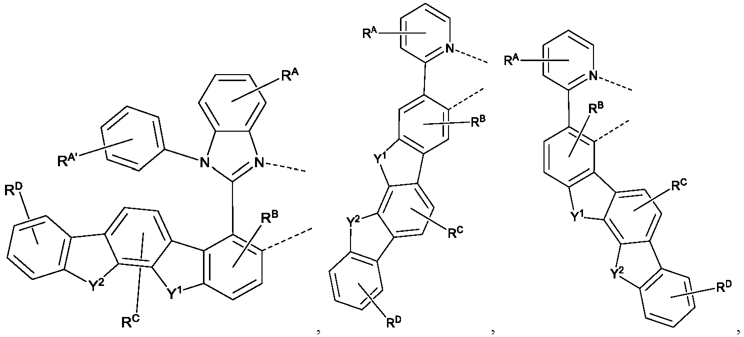 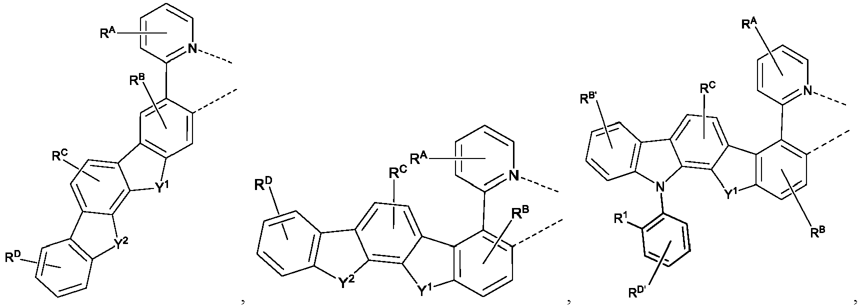 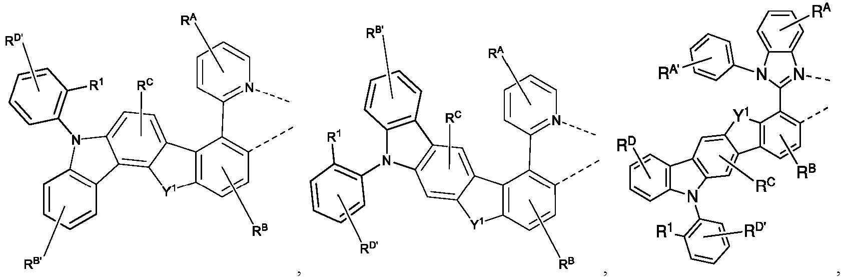 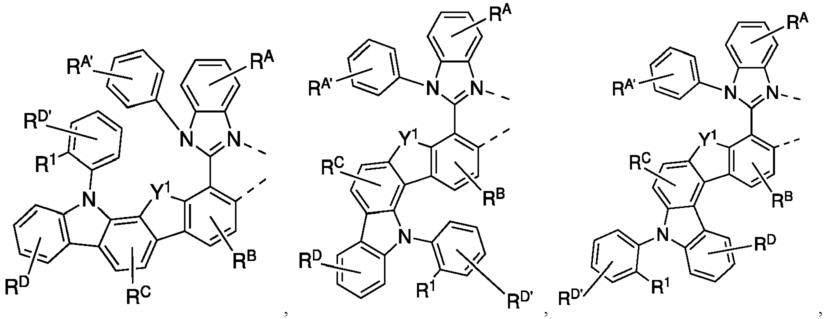 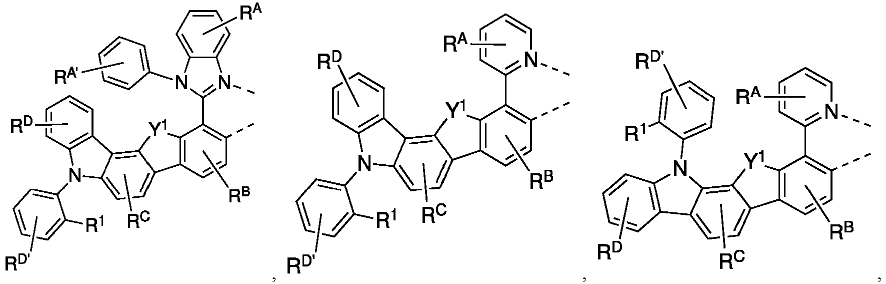 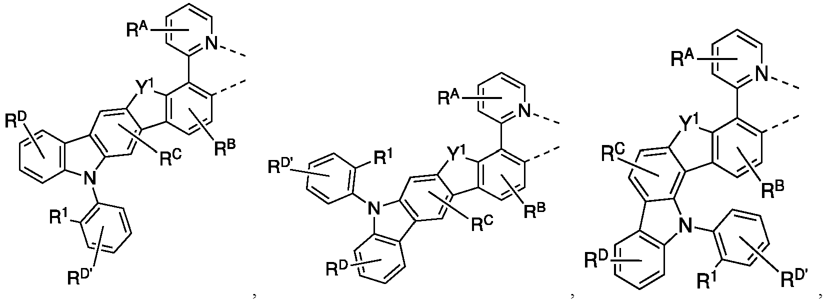 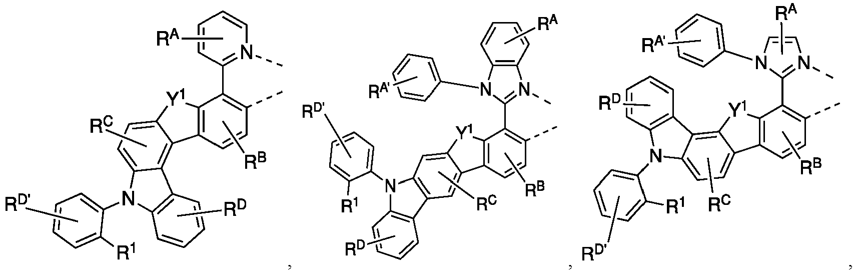 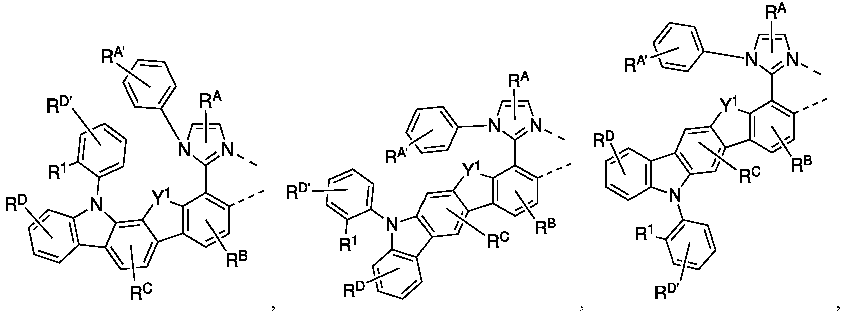 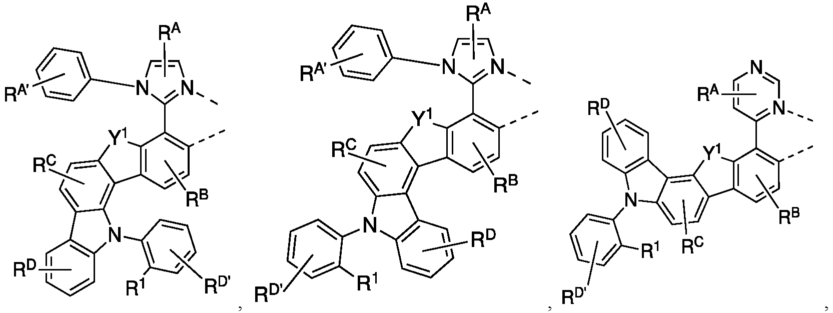 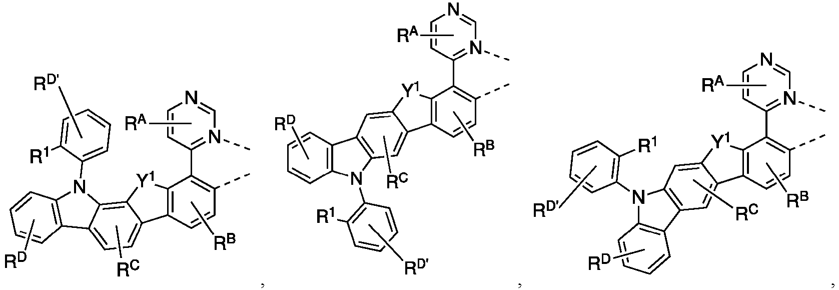 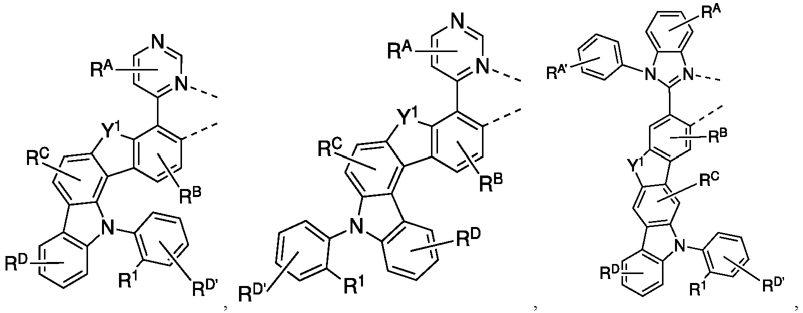 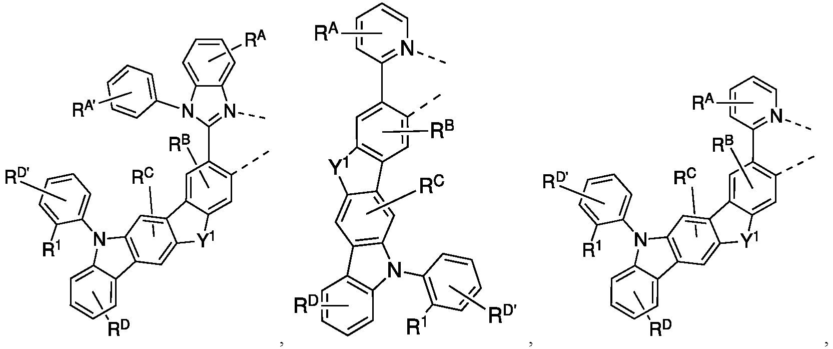 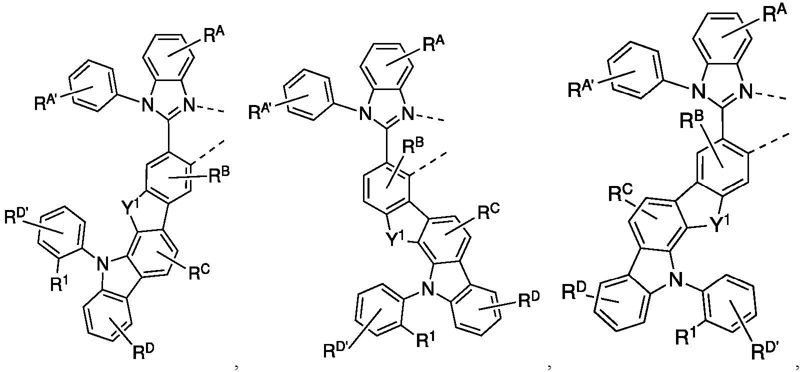 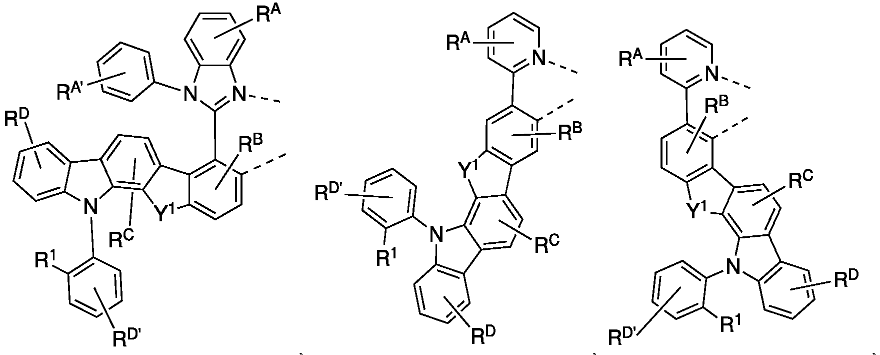 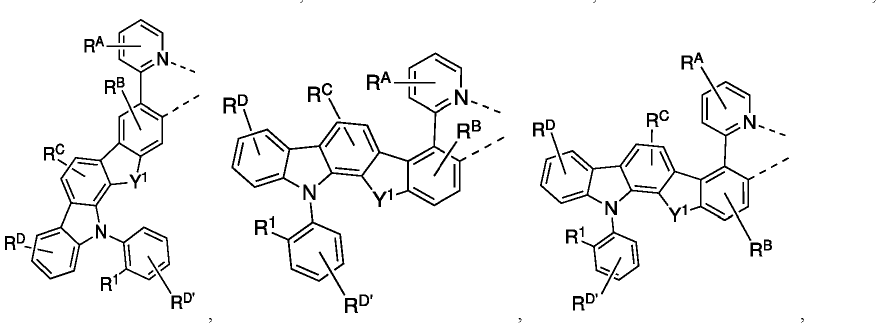 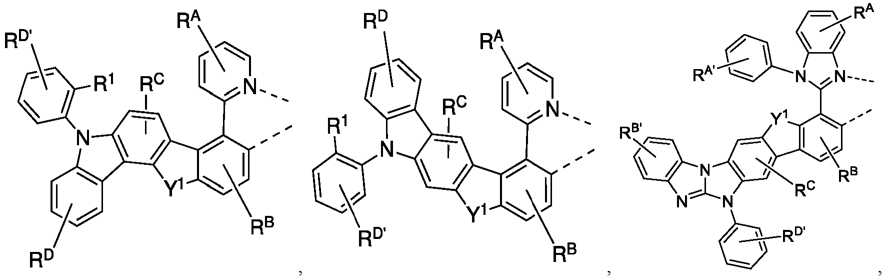 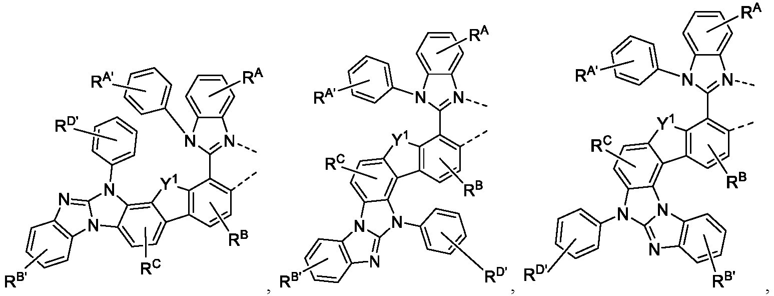 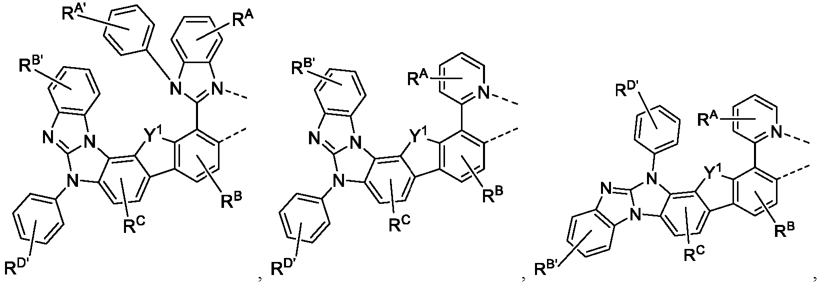 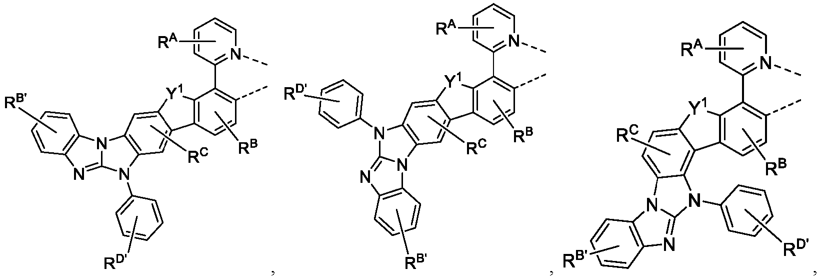 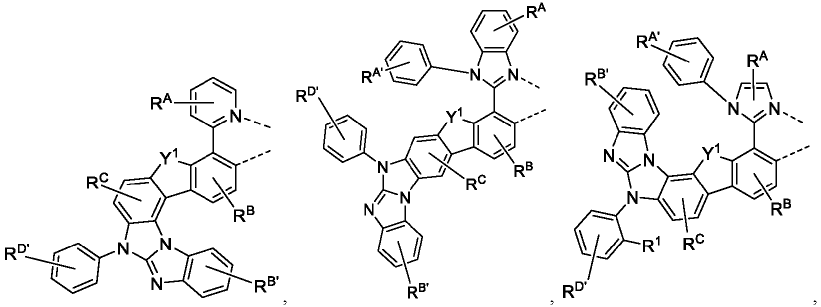 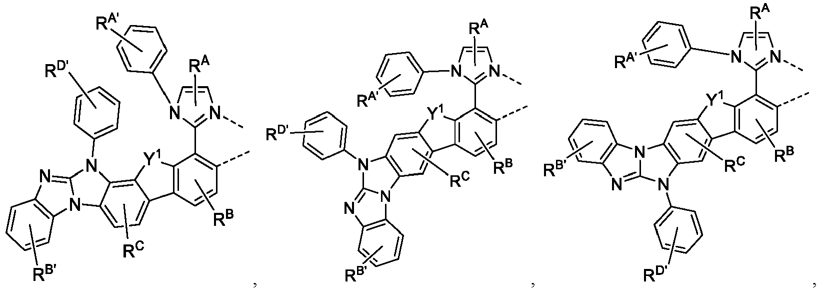 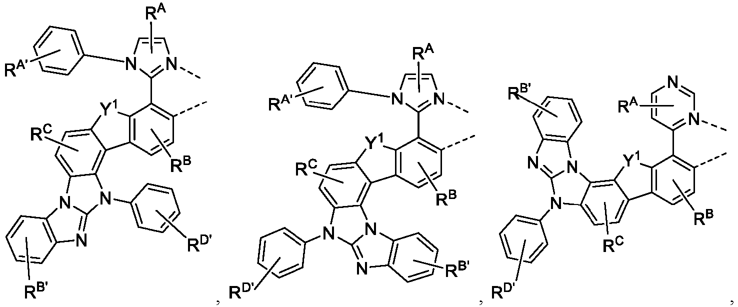 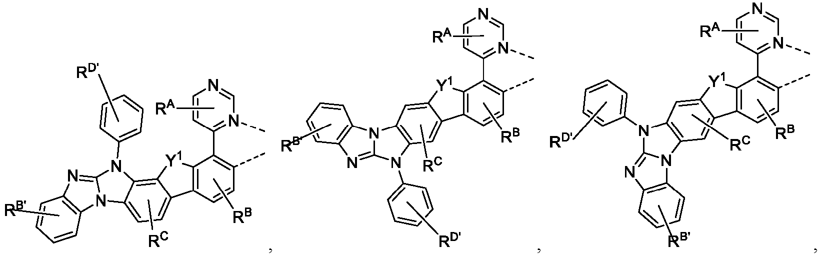 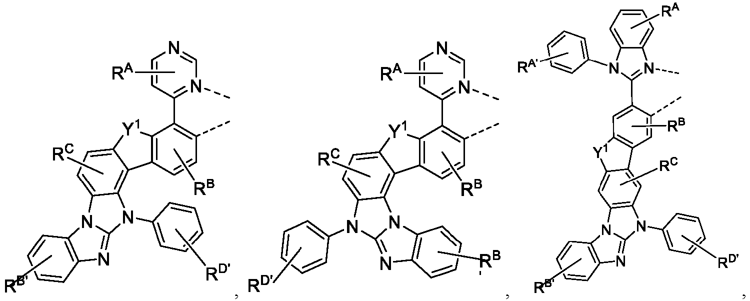 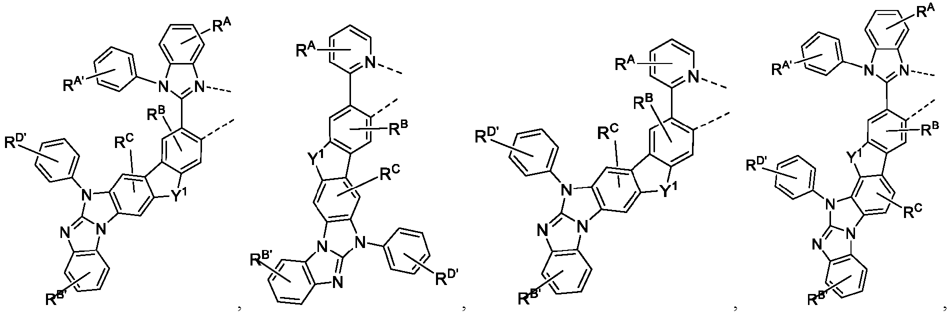 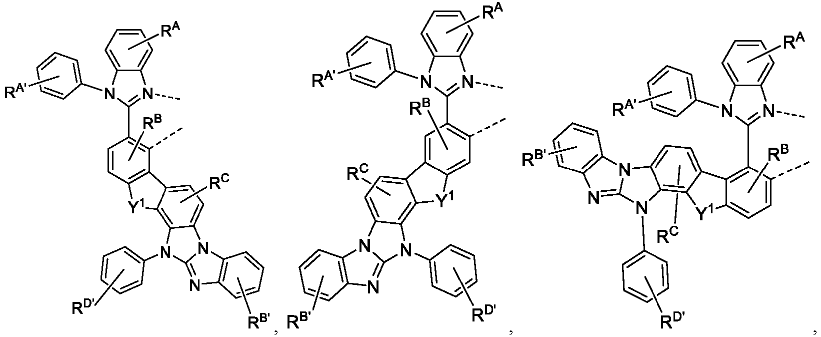 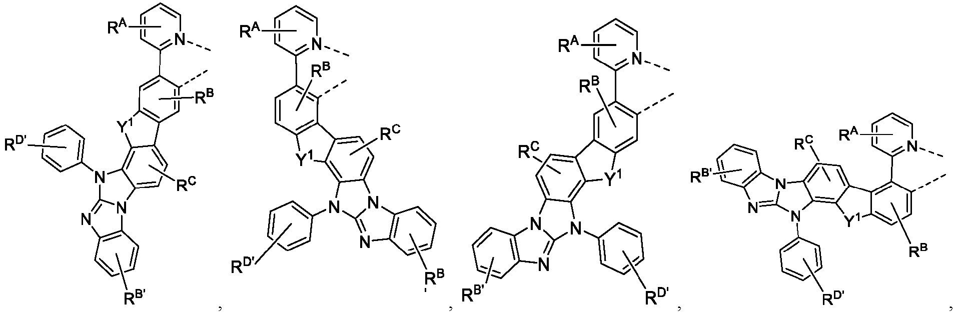 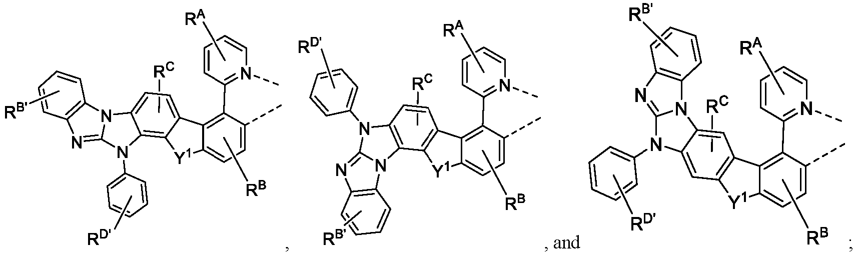 wherein:
each of Y¹ to Y² is independently selected from the group consisting of BR, BRR', NR, PR, P(O)R, O, S, Se, C=O, C=S, C=Se, C=NR', C=CRR', S=O, SO₂, CRR', SiRR', GeRR';
R^{A'} represents mono to the maximum allowable substitutions, or no substitutions;
each R^{A'} is independently hydrogen or a substituent selected from the group consisting of the General Substituents defined herein;
the remaining variables are the same as previously defined; and
any two adjacent substituents may be fused or joined to form a ring or form a multidentate ligand.

In some embodiments where ligand L_{A} is a structure selected from LIST 5, two R^{A} are joined to form a fused ring. In some such embodiments, the fused ring may be benzene, pyridine, pyrimidine, pyridazine, pyrazine, triazine, imidazole, pyrazole, pyrrole, oxazole, furan, thiophene, or thiazole. In some such embodiments, the feud ring may be benzene. In some embodiments, Y¹ and Y² are each independently O.

In some embodiments where ligand L_{A} is selected from LIST 5, at least one R^{A}, R^{A'}, R^{B}, R^{B'}, R^{C}, R^{D}, or R^{D'} is selected from the group consisting of the General Substituents defined herein. In some embodiments, at least one R^{A} is selected from the group consisting of the General Substituents defined herein. In some embodiments, at least one R^{A'} is selected from the group consisting of the General Substituents defined herein. In some embodiments, at least one R^{B} is selected from the group consisting of the General Substituents defined herein. In some embodiments, at least one R^{B'} is selected from the group consisting of the General Substituents defined herein. In some embodiments, at least one R^{C} is selected from the group consisting of the General Substituents defined herein. In some embodiments, at least one R^{D} is selected from the group consisting of the General Substituents defined herein. In some embodiments, at least one R^{D'} is selected from the group consisting of the General Substituents defined herein. In some embodiments, at least one R^{A}, R^{A'}, R^{B}, R^{C}, R^{D}, or R^{D'} is selected from the group consisting of the Preferred General Substituents defined herein.

In some embodiments, where ligand L_{A} is selected from LIST 5, at least one of R^{A}, R^{A'}, R^{B}, R^{B'}, R^{C}, R^{D}, or R^{D'} is partially or fully deuterated. In some embodiments, at least one R^{A} is partially or fully deuterated. In some embodiments, at least one R^{A'} is partially or fully deuterated. In some embodiments, at least one R^{B} is partially or fully deuterated. In some embodiments, at least one R^{B'} is partially or fully deuterated. In some embodiments, at least one R^{C} is partially or fully deuterated. In some embodiments, at least one R^{D} is partially or fully deuterated. In some embodiments, at least one R^{D'} is partially or fully deuterated.

In some embodiments where ligand L_{A} is selected from LIST 5, at least one R^{A} is or comprises an electron-withdrawing group from the EWG1 LIST as defined herein. In some embodiments, at least one R^{A} is or comprises an electron-withdrawing group from the EWG2 LIST as defined herein. In some embodiments, at least one R^{A} is or comprises an electron-withdrawing group from the EWG3 LIST as defined herein. In some embodiments, at least one R^{A} is or comprises an electron-withdrawing group from the EWG4 LIST as defined herein. In some embodiments, at least one R^{A} is or comprises an electron-withdrawing group from the Pi-EWG LIST as defined herein.

In some embodiments where ligand L_{A} is selected from LIST 5, at least one R^{A'} is or comprises an electron-withdrawing group from the EWG1 LIST as defined herein. In some embodiments, at least one R^{A'} is or comprises an electron-withdrawing group from the EWG2 LIST as defined herein. In some embodiments, at least one R^{A'} is or comprises an electron-withdrawing group from the EWG3 LIST as defined herein. In some embodiments, at least one R^{A'} is or comprises an electron-withdrawing group from the EWG4 LIST as defined herein. In some embodiments, at least one R^{A'} is or comprises an electron-withdrawing group from the Pi-EWG LIST as defined herein.

In some embodiments where ligand L_{A} is selected from LIST 5, at least one R^{B} is or comprises an electron-withdrawing group from the EWG1 LIST as defined herein. In some embodiments, at least one R^{B} is or comprises an electron-withdrawing group from the EWG2 LIST as defined herein. In some embodiments, at least one R^{B} is or comprises an electron-withdrawing group from the EWG3 LIST as defined herein. In some embodiments, at least one R^{B} is or comprises an electron-withdrawing group from the EWG4 LIST as defined herein. In some embodiments, at least one R^{B} is or comprises an electron-withdrawing group from the Pi-EWG LIST as defined herein.

In some embodiments where ligand L_{A} is selected from LIST 5, at least one R^{B'} is or comprises an electron-withdrawing group from the EWG1 LIST as defined herein. In some embodiments, at least one R^{B'} is or comprises an electron-withdrawing group from the EWG2 LIST as defined herein. In some embodiments, at least one R^{B'} is or comprises an electron-withdrawing group from the EWG3 LIST as defined herein. In some embodiments, at least one R^{B'} is or comprises an electron-withdrawing group from the EWG4 LIST as defined herein. In some embodiments, at least one R^{B'} is or comprises an electron-withdrawing group from the Pi-EWG LIST as defined herein.

In some embodiments where ligand L_{A} is selected from LIST 5, at least one R^{C} is or comprises an electron-withdrawing group from the EWG1 LIST as defined herein. In some embodiments, at least one R^{C} is or comprises an electron-withdrawing group from the EWG2 LIST as defined herein. In some embodiments, at least one R^{C} is or comprises an electron-withdrawing group from the EWG3 LIST as defined herein. In some embodiments, at least one R^{C} is or comprises an electron-withdrawing group from the EWG4 LIST as defined herein. In some embodiments, at least one R^{C} is or comprises an electron-withdrawing group from the Pi-EWG LIST as defined herein.

In some embodiments where ligand L_{A} is selected from LIST 5, at least one R^{D} is or comprises an electron-withdrawing group from the EWG1 LIST as defined herein. In some embodiments, at least one R^{D} is or comprises an electron-withdrawing group from the EWG2 LIST as defined herein. In some embodiments, at least one R^{D} is or comprises an electron-withdrawing group from the EWG3 LIST as defined herein. In some embodiments, at least one R^{D} is or comprises an electron-withdrawing group from the EWG4 LIST as defined herein. In some embodiments, at least one R^{D} s or comprises an electron-withdrawing group from the Pi-EWG LIST as defined herein.

In some embodiments where ligand L_{A} is selected from LIST 5, at least one R^{D'} is or comprises an electron-withdrawing group from the EWG1 LIST as defined herein. In some embodiments, at least one R^{D'} is or comprises an electron-withdrawing group from the EWG2 LIST as defined herein. In some embodiments, at least one R^{D'} is or comprises an electron-withdrawing group from the EWG3 LIST as defined herein. In some embodiments, at least one R^{D'} is or comprises an electron-withdrawing group from the EWG4 LIST as defined herein. In some embodiments, at least one R^{D'} s or comprises an electron-withdrawing group from the Pi-EWG LIST as defined herein.

In some embodiments, the ligand L_{A} is selected from L_{A*i*}(R*^{J}*)(R*^{K}*)(R^{L})(Y*^{M}*)(Y*^{N}*), wherein i is an integer from 1 to 34, each of R*^{J}*, R*^{K}*, and R^{L} is independently selected from V1 to V156; Y*^{M}* is selected from Y¹ to Y50; and Y^{*N*'} is selected from Y1 to Y44; and each of L _{A}1-(V1)(V1)(V1)(Y1)(Y1) to L _{A}34-(V156)(V156)(V156)(Y50)(Y44) is defined below in the following LIST 6:

| L_{A} | Structure of L_{A} | L_{A} | Structure of L_{A} |
|---|---|---|---|
| L_{A}1-(R*^{J}*)( R*^{K}*)( R*^{L}*)(Y*^{M}*)(Y^{*N*'}) wherein L _{A}1-(V1)(V1)(V1)(Y1)(Y1) to L_{A}1-(V156)(V156)(V1 56)(Y50 )(Y44) have the structure | 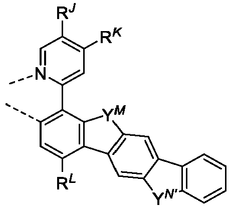 | L_{A}2-(R*^{J}*)( R*^{K}*)( R*^{L}*)(Y*^{M}*)(Y^{*N*'}) wherein L_{A}2-(V1)(V1)(V1)(Y1)(Y1) to L_{A}2-(V156)(V156)(V156)(Y5 0)(Y44) have the structure | 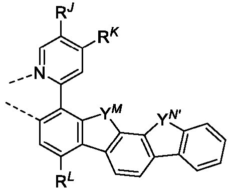 |
| L_{A}3-(R*^{J}*)(R*^{K}*)( R*^{L}*)(Y*^{M}*)(Y^{*N*'}) wherein L_{A}3-(V1)(V1)(V1)(Y1)(Y1) to L_{A}3-(V156)(V156)(V156)(Y50 )(Y44) have the structure | 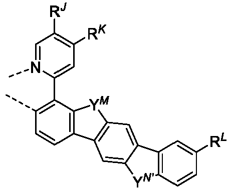 | L_{A}4-(R*^{J}*)( R*^{K}*)( R*^{L}*)(Y*^{M}*)(Y^{*N*'}) wherein L_{A}4-(V1)(V1)(V1)(Y1)(Y1) to L_{A}4-(V156)(V156)(V156)(Y5 0)(Y44) have the structure | 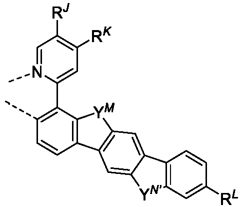 |
| *L*_{A}5-(R*^{J}*)( R*^{K}*)( *R^{L}*)(*Y^{M}*)(Y*^{N'}*) wherein L_{A}5-(V1)(V1)(V1)(Y1)(Y1) to L_{A}5-(V156)(V156)(V156)(Y50 )(Y44) have the structure | 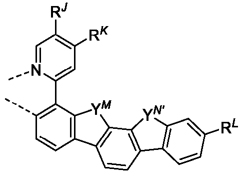 | *L*_{A}6-(*R^{J}*)( R*^{K}*)( R*^{L}*)(Y*^{M}*)(Y^{*N*'}) wherein L_{A}6-(V1)(V1)(V1)(Y1)(Y1) to L_{A}6-(V156)(V156)(V156)(Y5 0)(Y44) have the structure | 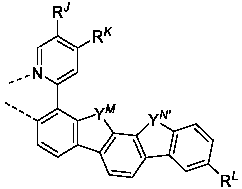 |
| L_{A}7-(R*^{J}*)( R*^{K}*)( R*^{L}*)(Y*^{M}*)(Y^{*N*'}) wherein L_{A}7-(V1)(V1)(V1)(Y1)(Y1) to L_{A}7-(V156)(V156)(V156)(Y50 )(Y44) have the structure | 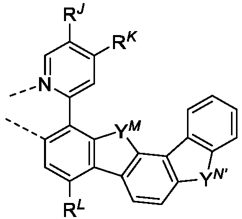 | L_{A}8-(R*^{J}*)( R*^{K}*)( R*^{L}*)(Y*^{M}*)(Y^{*N*'}) wherein L_{A}8-(V1)(V1)(V1)(Y1)(Y1) to L_{A}8-(V156)(V156)(V156)(Y5 0)(Y44) have the structure | 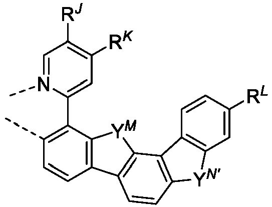 |
| L_{A}9-(R*^{J}*)( R*^{K}*)( R^{L})(Y*^{M}*)(Y*^{N'}*) wherein L_{A}9-(V1)(V1)(V1)(Y1)(Y1) to L_{A}9-(V156)(V156)(V156)(Y50 )(Y44) have the structure | 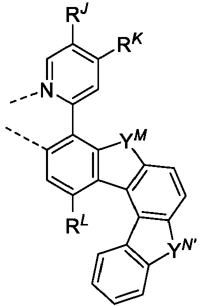 | L_{A}10-(R*^{J}*)( R*^{K}*)( R^{L})(Y*^{M}*)(Y*^{N'}*) wherein L_{A}10-(V1)(V1)(V1)(Y1)(Y1) to L_{A}10-(V156)(V156)(V156)(Y5 0)(Y44) have the structure | 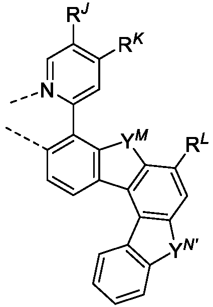 |
| L_{A}11-(R*^{J}*)( R*^{K}*)( R*^{L}*)(Y*^{M}*)(Y^{*N*'}) wherein L_{A}11-(V1)(V1)(V1)(Y1)(Y1) to L_{A}11-(V156)(V156)(V156)(Y50 )(Y44) have the structure | 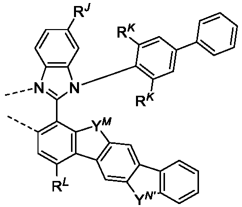 | L_{A}12-(R*^{J}*)( R*^{K}*)( R*^{L}*)(Y*^{M}*)(Y^{*N*'}) wherein L_{A}12-(V1)(V1)(V1)(Y1)(Y1) to L_{A}12-(V156)(V156)(V156)(Y5 0)(Y44) have the structure | 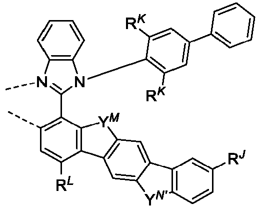 |
| L_{A}13-(R*^{J}*)( R*^{K}*)( R*^{L}*)(Y*^{M}*)(Y^{*N*'}) wherein L_{A}13-(V1)(V1)(V1)(Y1)(Y1) to L_{A}13-(V156)(V156)(V156)(Y50 )(Y44) have the structure | 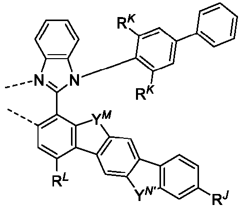 | L_{A}14-(R*^{J}*)( R*^{K}*)( R*^{L}*)(Y*^{M}*)(Y^{*N*'}) wherein L_{A}14-(V1)(V1)(V1)(Y1)(Y1) to L_{A}14-(V156)(V156)(V156)(Y5 0)(Y44) have the structure | 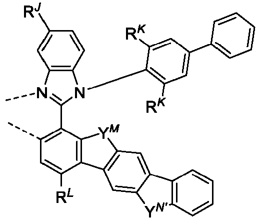 |
| L_{A}15-(R*^{J}*)( R*^{K}*)( R*^{L}*)(Y*^{M}*)(Y^{*N*'}) wherein L_{A}15-(V1)(V1)(V1)(Y1)(Y1) to L_{A}15-(V156)(V156)(V156)(Y50 )(Y44) have the structure | 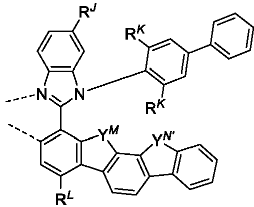 | L_{A}16-(R*^{J}*)( R*^{K}*)( R*^{L}*)(Y*^{M}*)(Y^{*N*'}) wherein L_{A}16-(V1)(V1)(V1)(Y1)(Y1) to L_{A}16-(V156)(V156)(V156)(Y5 0)(Y44) have the structure | 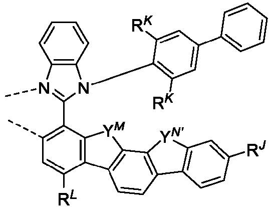 |
| L_{A}17-(R*^{J}*)( R*^{K}*)( R*^{L}*)(Y*^{M}*)(Y^{*N*'}) wherein L_{A}17-(V1)(V1)(V1)(Y1)(Y1) to L_{A}17-(V156)(V156)(V156)(Y50 )(Y44) have the structure | 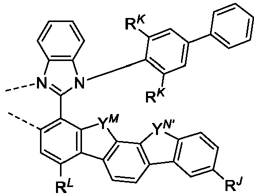 | L_{A}18-(R*^{J}*)( R*^{K}*)( R*^{L}*)(Y*^{M}*)(Y^{*N*'}) wherein L_{A}18-(V1)(V1)(V1)(Y1)(Y1) to L_{A}18-(V156)(V156)(V156)(Y5 0)(Y44) have the structure | 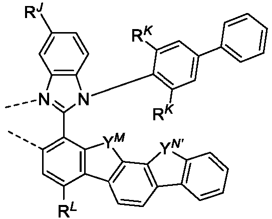 |
| L_{A}19-(R*^{J}*)( R*^{K}*)( R*^{L}*)(Y*^{M}*)(Y^{*N*'}) wherein L_{A}19-(V1)(V1)(V1)(Y1)(Y1) to L_{A}19-(V156)(V156)(V156)(Y50 )(Y44) have the structure | 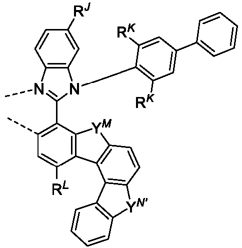 | L_{A}20-(R*^{J}*)( R*^{K}*)( R^{L})(Y*^{M}*)(Y*^{N'}*) wherein L_{A}20-(V1)(V1)(V1)(Y1)(Y1) to L_{A}20-(V156)(V156)(V156)(Y5 0)(Y44) have the structure | 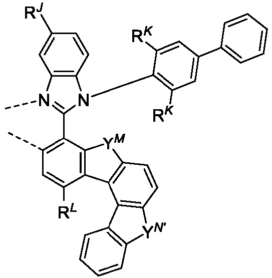 |
| L_{A}21-(R*^{J}*)( R*^{K}*)( R*^{L}*)(Y*^{M}*)(Y*^{N'}*) wherein L_{A}21-(V1)(V1)(V1)(Y1)(Y1) to L_{A}21-(V156)(V156)(V156)(Y50 )(Y44) have the structure | 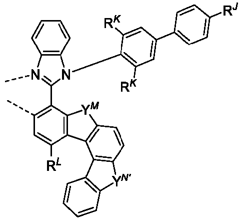 | L_{A}22-(R*^{J}*)( R*^{K}*)( R*^{L}*)(Y*^{M}*)(Y*^{N'}*) wherein L_{A}22-(V1)(V1)(V1)(Y1)(Y1) to L_{A}22-(V156)(V156)(V156)(Y5 0)(Y44) have the structure | 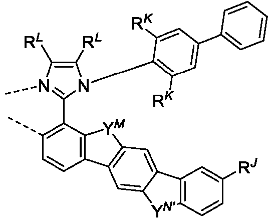 |
| L_{A}23-(R*^{J}*)(R*^{K}*)( R*^{L}*)(Y*^{M}*)(Y*^{N'}*) wherein L_{A}23-(V1)(V1)(V1)(Y1)(Y1) to L_{A}23-(V156)(V156)(V156)(Y50 )(Y44) have the structure | 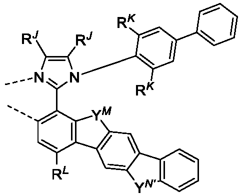 | L_{A}24-(R*^{J}*)( R*^{K}*)( R*^{L}*)(Y*^{M}*)(Y*^{N'}*) wherein L_{A}24-(V1)(V1)(V1)(Y1)(Y1) to L_{A}24-(V156)(V156)(V156)(Y5 0)(Y44) have the structure | 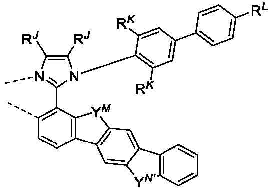 |
| L_{A}25-(R*^{J}*)( R*^{K}*)( R*^{L}*)(Y*^{M}*)(Y*^{N'}*) wherein L_{A}25-(V1)(V1)(V1)(Y1)(Y1) to L_{A}25-(V156)(V156)(V156)(Y50 )(Y44) have the structure | 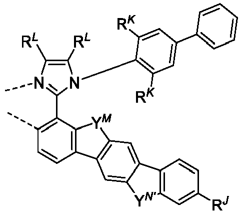 | L_{A}26-(R*^{J}*)( R*^{K}*)( R*^{L}*)(Y*^{M}*)(Y*^{N'}*) wherein L_{A}26-(V1)(V1)(V1)(Y1)(Y1) to L_{A}26-(V156)(V156)(V156)(Y5 0)(Y44) have the structure | 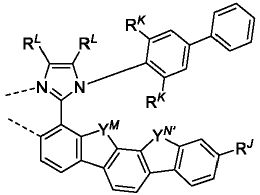 |
| L_{A}27-(R*^{J}*)( R*^{K}*)( R*^{L}*)(Y*^{M}*)(Y*^{N'}*) wherein L_{A}27-(V1)(V1)(V1)(Y1)(Y1) to L_{A}27-(V156)(V156)(V156)(Y50 )(Y44) have the structure | 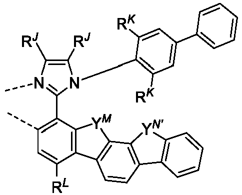 | L_{A}28-(R*^{J}*)( R*^{K}*)( R*^{L}*)(Y*^{M}*)(Y*^{N'}*) wherein L_{A}28-(V1)(V1)(V1)(Y1)(Y1) to L_{A}28-(V156)(V156)(V156)(Y5 0)(Y44) have the structure | 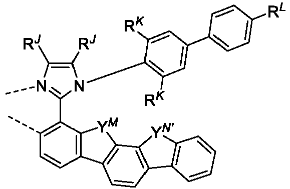 |
| L_{A}29-(R*^{J}*)( R*^{K}*)( R*^{L}*)(Y*^{M}*)(Y*^{N'}*) wherein L_{A}29-(V1)(V1)(V1)(Y1)(Y1) to L_{A}29-(V156)(V156)(V156)(Y50 )(Y44) have the structure | 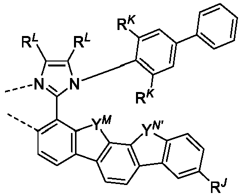 | L_{A}30-(R*^{J}*)( R*^{K}*)( R*^{L}*)(Y*^{M}*)(Y*^{N'}*) wherein L_{A}30-(V1)(V1)(V1)(Y1)(Y1) to L_{A}30-(V156)(V156)(V156)(Y5 0)(Y44) have the structure | 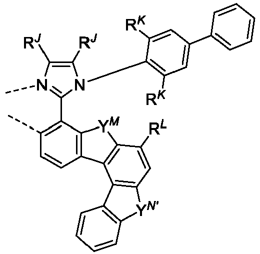 |
| L_{A}31-(R*^{J}*)( R*^{K}*)( R*^{L}*)(Y*^{M}*)(Y*^{N'}*) wherein L_{A}31-(V1)(V1)(V1)(Y1)(Y1) to L_{A}31-(V156)(V156)(V156)(Y50 )(Y44) have the structure | 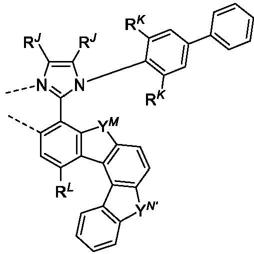 | L_{A}32-(R*^{J}*)( R*^{K}*)( R*^{L}*)(Y*^{M}*)(Y*^{N'}*) wherein L_{A}32-(V1)(V1)(V1)(Y1)(Y1) to L_{A}32-(V156)(V156)(V156)(Y5 0)(Y44) have the structure | 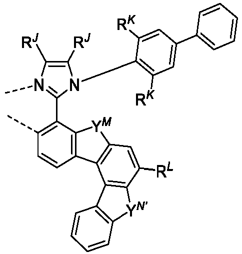 |
| L_{A}33-(R*^{J}*)( R*^{K}*)( R*^{L}*)(Y*^{M}*)(Y*^{N'}*) wherein L_{A}33-(V1)(V1)(V1)(Y1)(Y1) to L_{A}33-(V156)(V156)(V156)(Y50 )(Y44) have the structure | 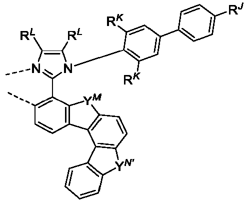 | L_{A}34-(R*^{J}*)(R*^{K}*)(R*^{L}*)(Y*^{M}*)(Y*^{N'}*) wherein L_{A}34-(V1)(V1)(V1)(Y1)(Y1) to L_{A}34-(V156)(V156)(V156)(Y5 0)(Y44) have the structure | 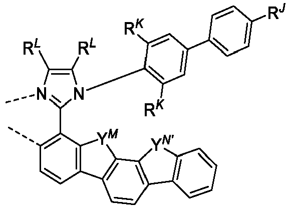 |

L*_{Ai'}*(R*^{J}*)(R*^{K}*)(R*^{L}*)(Y*^{M}*)(Y*^{N}*), wherein *i'* is an integer from 35 to 122, each of R*^{J}*, R*^{K}*, and R^{L} is independently selected from V1 to V156; and each of Y*^{M}* and Y*^{N}* is selected from Y1 to Y50; and each of L _{A}35-(V1)(V1)(V1)(Y1)(Y1) to L _{A}122-(V156)(V156)(V156)(Y50)(Y50) is defined below in the following LIST 7:

| L_{A} | Structure of L_{A} | L_{A} | Structure of L_{A} |
|---|---|---|---|
| L_{A}35-(R*^{J}*)( R*^{K}*)( R*^{L}*)(Y*^{M}*)(Y*^{N}*) wherein L_{A}35-(V1)(V1)(V1)(Y1)(Y1) to L_{A}35-(V156)(V156)(V156)(Y 50)(Y50) have the structure | 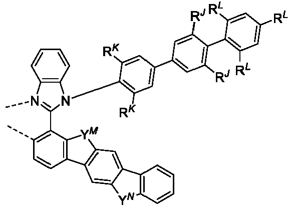 | L_{A}36-(R*^{J}*)( R*^{K}*)( R*^{L}*)(Y*^{M}*)(Y*^{N}*) wherein L _{A}36-(V1)(V1)(V1)(Y1)(Y1) to L _{A}36-(V156)(V156)(V156)(Y5 0)(Y50) have the structure | 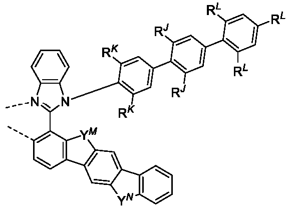 |
| L_{A}37-(R*^{J}*)( R*^{K}*)( R*^{L}*)(Y*^{M}*)(Y*^{N}*) wherein L_{A}37-(V1)(V1)(V1)(Y1)(Y1) to L_{A}37-(V156)(V156)(V156)(Y 50)(Y50) have the structure | 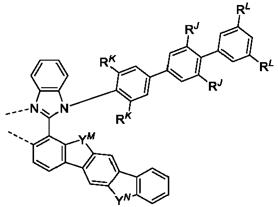 | L_{A}38-(R*^{J}*)( R*^{K}*)( R*^{L}*)(Y*^{M}*)(Y*^{N}*) wherein L_{A}38-(V1)(V1)(V1)(Y1)(Y1) to L_{A}38-(V156)(V156)(V156)(Y5 0)(Y50) have the structure | 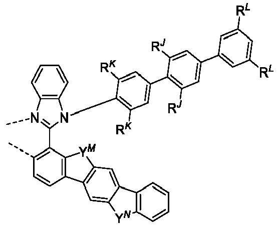 |
| L_{A}39-(R*^{J}*)( R*^{K}*)( R*^{L}*)(Y*^{M}*)(Y*^{N}*) wherein L_{A}39-(V1)(V1)(V1)(Y1)(Y1) to L_{A}39-(V156)(V156)(V156)(Y 50)(Y50) have the structure | 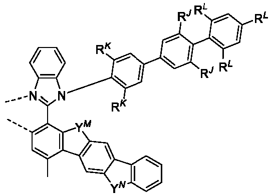 | L_{A}40-(R*^{J}*)( R*^{K}*)( R*^{L}*)(Y*^{M}*)(Y*^{N}*) wherein L_{A}40-(V1)(V1)(V1)(Y1)(Y1) to L_{A}40-(V156)(V156)(V156)(Y5 0)(Y50) have the structure | 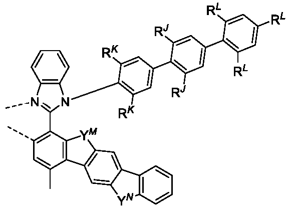 |
| L_{A}41-(R*^{J}*)( R*^{K}*)( R*^{L}*)(Y*^{M}*)(Y*^{N}*) wherein L_{A}41-(V1)(V1)(V1)(Y1)(Y1) to L_{A}41-(V156)(V156)(V156)(Y 50)(Y50) have the structure | 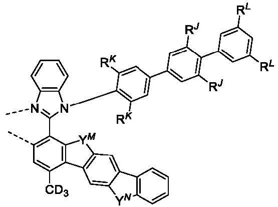 | L_{A}42-(R*^{J}*)( R*^{K}*)( R*^{L}*)(Y*^{M}*)(Y*^{N}*) wherein L_{A}42-(V1)(V1)(V1)(Y1)(Y1) to L_{A}42-(V156)(V156)(V156)(Y5 0)(Y50) have the structure | 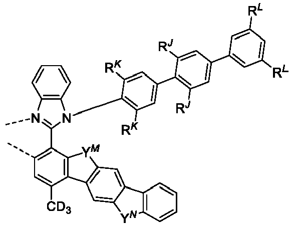 |
| L_{A}43-(R*^{J}*)( R*^{K}*)( R*^{L}*)(Y*^{M}*)(Y*^{N}*) wherein L_{A}43-(V1)(V1)(V1)(Y1)(Y1) to L_{A}43-(V156)(V156)(V156)(Y 50)(Y50) have the structure | 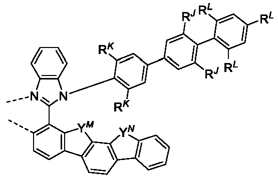 | L_{A}44-(R*^{J}*)( R*^{K}*)( R*^{L}*)(Y*^{M}*)(Y*^{N}*) wherein L_{A}44-(V1)(V1)(V1)(Y1)(Y1) to L_{A}44-(V156)(V156)(V156)(Y5 0)(Y50) have the structure | 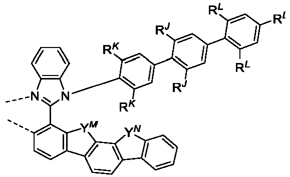 |
| L_{A}45-(R*^{J}*)( R*^{K}*)( R*^{L}*)(Y*^{M}*)(Y*^{N}*) wherein L_{A}45-(V1)(V1)(V1)(Y1)(Y1) to L_{A}45-(V156)(V156)(V156)(Y 50)(Y50) have the structure | 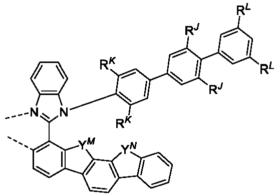 | L_{A}46-(R*^{J}*)( R*^{K}*)( R*^{L}*)(Y*^{M}*)(Y*^{N}*) wherein L_{A}46-(V1)(V1)(V1)(Y1)(Y1) to L_{A}46-(V156)(V156)(V156)(Y5 0)(Y50) have the structure | 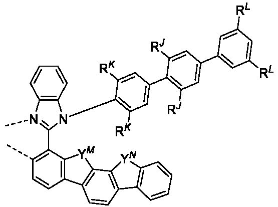 |
| L_{A}47-(R*^{J}*)( R*^{K}*)( R*^{L}*)(Y*^{M}*)(Y*^{N}*) wherein L_{A}47-(V1)(V1)(V1)(Y1)(Y1) to L_{A}47-(V156)(V156)(V156)(Y 50)(Y50) have the structure | 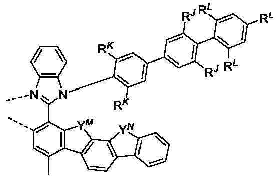 | L_{A}48-(R*^{J}*)( R*^{K}*)( R*^{L}*)(Y*^{M}*)(Y*^{N}*) wherein L_{A}48-(V1)(V1)(V1)(Y1)(Y1) to L_{A}48-(V156)(V156)(V156)(Y5 0)(Y50) have the structure | 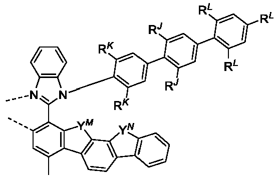 |
| L_{A}49-(R*^{J}*)( R*^{K}*)( R*^{L}*)(Y*^{M}*)(Y*^{N}*) wherein L_{A}49-(V1)(V1)(V1)(Y1)(Y1) to L_{A}49-(V156)(V156)(V156)(Y 50)(Y50) have the structure | 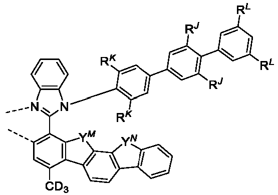 | L_{A}50-(R*^{J}*)( R*^{K}*)( R*^{L}*)(Y*^{M}*)(Y*^{N}*) wherein L_{A}50-(V1)(V1)(V1)(Y1)(Y1) to L_{A}50-(V156)(V156)(V156)(Y5 0)(Y50) have the structure | 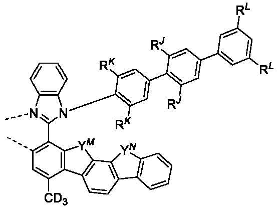 |
| L_{A}51-(R*^{J}*)( R*^{K}*)( R*^{L}*)(Y*^{M}*)(Y*^{N}*) wherein L_{A}51-(V1)(V1)(V1)(Y1)(Y1) to L_{A}51-(V156)(V156)(V156)(Y 50)(Y50) have the structure | 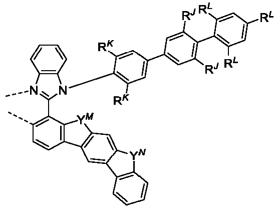 | L_{A}52-(R*^{J}*)( R*^{K}*)( R*^{L}*)(Y*^{M}*)(Y*^{N}*) wherein L_{A}52-(V1)(V1)(V1)(Y1)(Y1) to L_{A}52-(V156)(V156)(V156)(Y5 0)(Y50) have the structure | 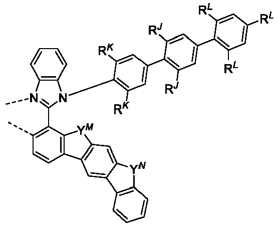 |
| L_{A}53-(R*^{J}*)( R*^{K}*)( R*^{L}*)(Y*^{M}*)(Y*^{N}*) wherein L_{A}53-(V1)(V1)(V1)(Y1)(Y1) to L_{A}53-(V156)(V156)(V156)(Y 50)(Y50) have the structure | 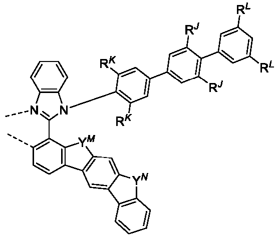 | L_{A}54-(R*^{J}*)( R*^{K}*)( R*^{L}*)(Y*^{M}*)(Y*^{N}*) wherein L_{A}54-(V1)(V1)(V1)(Y1)(Y1) to L_{A}54-(V156)(V156)(V156)(Y5 0)(Y50) have the structure | 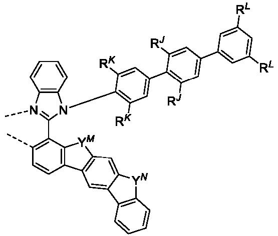 |
| L_{A}55-(R*^{J}*)( R*^{K}*)( R*^{L}*)(Y*^{M}*)(Y*^{N}*) wherein L_{A}55-(V1)(V1)(V1)(Y1)(Y1) to L_{A}55-(V156)(V156)(V156)(Y 50)(Y50) have the structure | 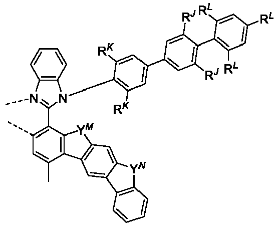 | L_{A}56-(R*^{J}*)( R*^{K}*)( R*^{L}*)(Y*^{M}*)(Y*^{N}*) wherein L_{A}56-(V1)(V1)(V1)(Y1)(Y1) to L_{A}56-(V156)(V156)(V156)(Y5 0)(Y50) have the structure | 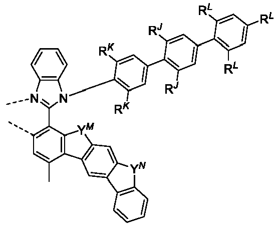 |
| L_{A}57-(R*^{J}*)( R*^{K}*)( R*^{L}*)(Y*^{M}*)(Y*^{N}*) wherein L_{A}57-(V1)(V1)(V1)(Y1)(Y1) to L_{A}57-(V156)(V156)(V156)(Y 50)(Y50) have the structure | 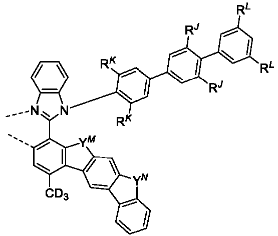 | L_{A}58-(R*J*)( R*^{K}*)( R*^{L}*)(Y*^{M}*)(Y*^{N}*) wherein L_{A}58-(V1)(V1)(V1)(Y1)(Y1) to L_{A}58-(V156)(V156)(V156)(Y5 0)(Y50) have the structure | 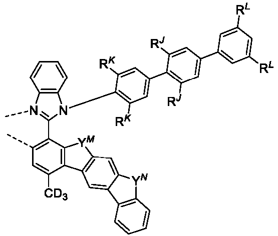 |
| L_{A}59-(R*^{J}*)( R*^{K}*)( R*^{L}*)(Y*^{M}*)(Y*^{N}*) wherein L_{A}59-(V1)(V1)(V1)(Y1)(Y1) to L_{A}59-(V156)(V156)(V156)(Y 50)(Y50) have the structure | 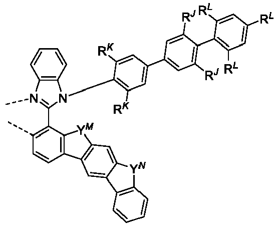 | L_{A}60-(R*^{J}*)( R*^{K}*)( R*^{L}*)(Y*^{M}*)(Y*^{N}*) wherein L_{A}60-(V1)(V1)(V1)(Y1)(Y1) to L_{A}60-(V156)(V156)(V156)(Y5 0)(Y50) have the structure | 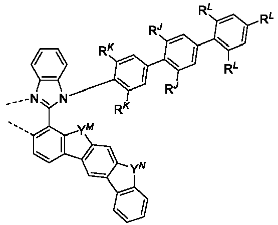 |
| L_{A61}-(R*^{J}*)( R*^{K}*)( R*^{L}*)(Y*^{M}*)(Y*^{N}*) wherein L_{A}61-(V1)(V1)(V1)(Y1)(Y1) to L_{A}61-(V156)(V156)(V156)(Y 50)(Y50) have the structure | 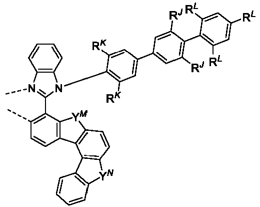 | L_{A}62-(R*^{J}*)( R*^{K}*)( R*^{L}*)(Y*^{M}*)(Y*^{N}*) wherein L_{A}62-(V1)(V1)(V1)(Y1)(Y1) to L_{A}62-(V156)(V156)(V156)(Y5 0)(Y50) have the structure | 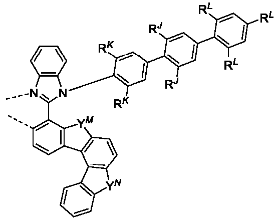 |
| L_{A}63-(R*^{J}*)( R*^{K}*)( R*^{L}*)(Y*^{M}*)(Y*^{N}*) wherein L_{A}63-(V1)(V1)(V1)(Y1)(Y1) to L_{A}63-(V156)(V156)(V156)(Y 50)(Y50) have the structure | 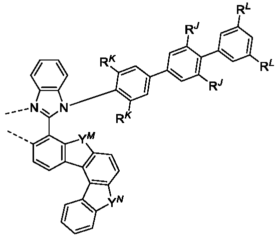 | L_{A}64-(R*^{J}*)( R*^{K}*)( R*^{L}*)(Y*^{M}*)(Y*^{N}*) wherein L_{A}64-(V1)(V1)(V1)(Y1)(Y1) to L_{A}64-(V156)(V156)(V156)(Y5 0)(Y50) have the structure | 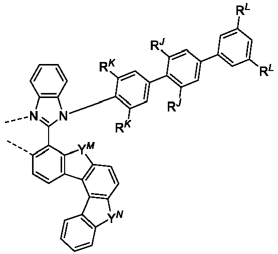 |
| L_{A}65-(R*^{J}*)( R*^{K}*)( R*^{L}*)(Y*^{M}*)(Y*^{N}*) wherein L_{A}65-(V1)(V1)(V1)(Y1)(Y1) to L_{A}65-(V156)(V156)(V156)(Y 50)(Y50) have the structure | 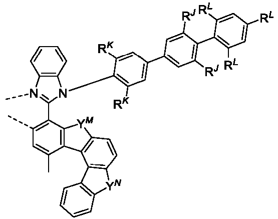 | L_{A}66-(R*^{J}*)( R*^{K}*)( R*^{L}*)(Y*^{M}*)(Y*^{N}*) wherein L_{A}66-(V1)(V1)(V1)(Y1)(Y1) to L_{A}66-(V156)(V156)(V156)(Y5 0)(Y50) have the structure | 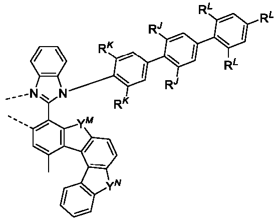 |
| L_{A}67-(R*^{J}*)( R*^{K}*)( R*^{L}*)(Y*^{M}*)(Y*^{N}*) wherein L_{A}67-(V1)(V1)(V1)(Y1)(Y1) to L_{A}67-(V156)(V156)(V156)(Y 50)(Y50) have the structure | 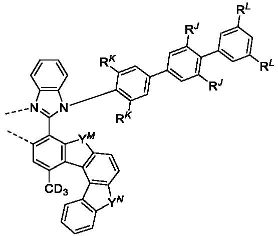 | L_{A}68-(R*^{J}*)( R*^{K}*)( R*^{L}*)(Y*^{M}*)(Y*^{N}*) wherein L_{A}68-(V1)(V1)(V1)(Y1)(Y1) to L_{A}68-(V156)(V156)(V156)(Y5 0)(Y50) have the structure | 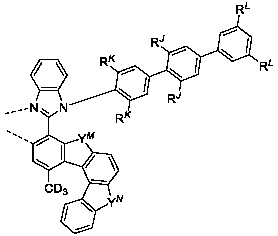 |
| L_{A}69-(R*^{J}*)( R*^{K}*)( R*^{L}*)(Y*^{M}*)(Y*^{N}*) wherein L_{A}69-(V1)(V1)(V1)(Y1)(Y1) to L_{A}69-(V156)(V156)(V156)(Y 50)(Y50) have the structure | 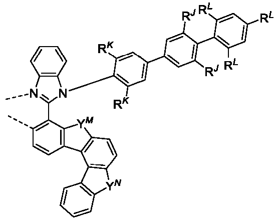 | L_{A}70-(R*^{J}*)( R*^{K}*)( R*^{L}*)(Y*^{M}*)(Y*^{N}*) wherein L_{A}70-(V1)(V1)(V1)(Y1)(Y1) to L_{A}70-(V156)(V156)(V156)(Y5 0)(Y50) have the structure | 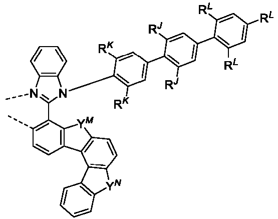 |
| L_{A}71-(R*^{J}*)( R*^{K}*)( R*^{L}*)(Y*^{M}*)(Y*^{N}*) wherein L_{A}71-(V1)(V1)(V1)(Y1)(Y1) to L_{A}71-(V156)(V156)(V156)(Y 50)(Y50) have the structure | 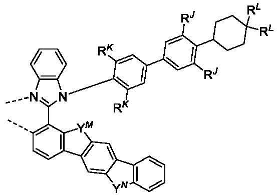 | L_{A}72-(R*^{J}*)( R*^{K}*)( R*^{L}*)(Y*^{M}*)(Y*^{N}*) wherein L_{A}72-(V1)(V1)(V1)(Y1)(Y1) to L_{A}72-(V156)(V156)(V156)(Y5 0)(Y50) have the structure | 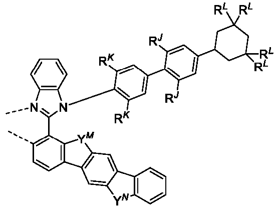 |
| L_{A}73-(R*^{J}*)( R*^{K}*)( R*^{L}*)(Y*^{M}*)(Y*^{N}*) wherein L_{A}73-(V1)(V1)(V1)(Y1)(Y1) to L_{A}73-(V156)(V156)(V156)(Y 50)(Y50) have the structure | 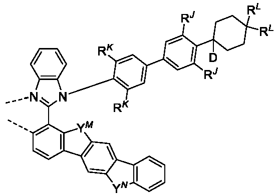 | L_{A}74-(R*^{J}*)( R*^{K}*)( R*^{L}*)(Y*^{M}*)(Y*^{N}*) wherein L_{A}74-(V1)(V1)(V1)(Y1)(Y1) to L_{A}74-(V156)(V156)(V156)(Y5 0)(Y50) have the structure | 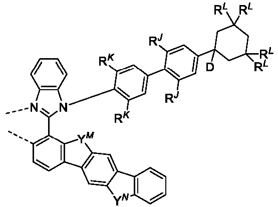 |
| L_{A}75-(R*^{J}*)( R*^{K}*)( R*^{L}*)(Y*^{M}*)(Y*^{N}*) wherein L_{A}75-(V1)(V1)(V1)(Y1)(Y1) to L_{A}75-(V156)(V156)(V156)(Y 50)(Y50) have the structure | 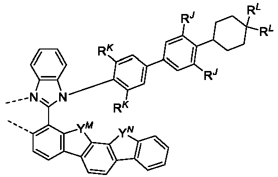 | L_{A}76-(R*^{J}*)( R*^{K}*)( R*^{L}*)(Y*^{M}*)(Y*^{N}*) wherein L_{A}76-(V1)(V1)(V1)(Y1)(Y1) to L_{A}76-(V156)(V156)(V156)(Y5 0)(Y50) have the structure | 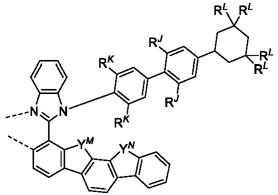 |
| L_{A}77-(R*^{J}*)( R*^{K}*)( R*^{L}*)(Y*^{M}*)(Y*^{N}*) wherein L_{A}77-(V1)(V1)(V1)(Y1)(Y1) to L_{A}77-(V156)(V156)(V156)(Y 50)(Y50) have the structure | 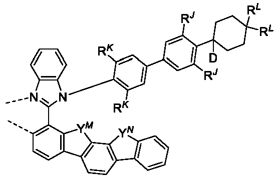 | L_{A}78-(R*^{J}*)( R*^{K}*)( R*^{L}*)(Y*^{M}*)(Y*^{N}*) wherein L_{A}78-(V1)(V1)(V1)(Y1)(Y1) to L_{A}78-(V156)(V156)(V156)(Y5 0)(Y50) have the structure | 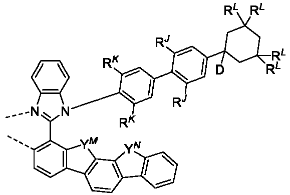 |
| L_{A}79-(R*^{J}*)( R*^{K}*)( R*^{L}*)(Y*^{M}*)(Y*^{N}*) wherein L_{A}79-(V1)(V1)(V1)(Y1)(Y1) to L_{A}79-(V156)(V156)(V156)(Y 50)(Y50) have the structure | 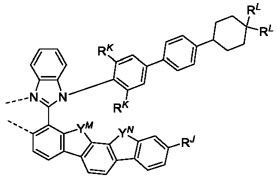 | L_{A}80-(R*^{J}*)( R*^{K}*)( R*^{L}*)(Y*^{M}*)(Y*^{N}*) wherein L_{A}80-(V1)(V1)(V1)(Y1)(Y1) to L_{A}80-(V156)(V156)(V156)(Y5 0)(Y50) have the structure | 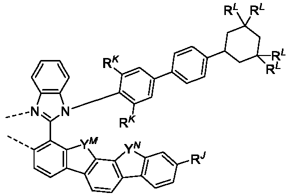 |
| L_{A}81-(R*^{J}*)( R*^{K}*)( R*^{L}*)(Y*^{M}*)(Y*^{N}*) wherein L_{A}81-(V1)(V1)(V1)(Y1)(Y1) to L_{A}81-(V156)(V156)(V156)(Y 50)(Y50) have the structure | 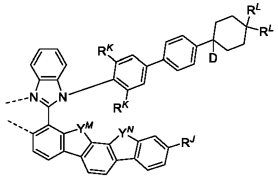 | L_{A}82-(R*^{J}*)( R*^{K}*)( R*^{L}*)(Y*^{M}*)(Y*^{N}*) wherein L_{A}82-(V1)(V1)(V1)(Y1)(Y1) to L_{A}82-(V156)(V156)(V156)(Y5 0)(Y50) have the structure | 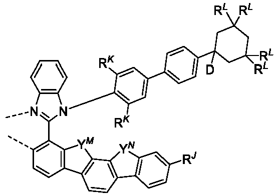 |
| L_{A}83-(R*^{J}*)( R*^{K}*)( R*^{L}*)(Y*^{M}*)(Y*^{N}*) wherein L_{A}83-(V1)(V1)(V1)(Y1)(Y1) to L_{A}83-(V156)(V156)(V156)(Y 50)(Y50) have the structure | 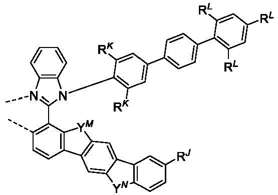 | L_{A}84-(R*^{J}*)( R*^{K}*)( R*^{L}*)(Y*^{M}*)(Y*^{N}*) wherein L_{A}84-(V1)(V1)(V1)(Y1)(Y1) to L_{A}84-(V156)(V156)(V156)(Y5 0)(Y50) have the structure | 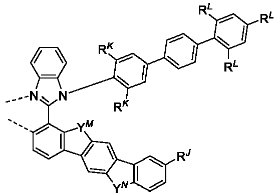 |
| L_{A}85-(R*^{J}*)( R*^{K}*)( R*^{L}*)(Y*^{M}*)(Y*^{N}*) wherein L_{A}85-(V1)(V1)(V1)(Y1)(Y1) to L_{A}85-(V156)(V156)(V156)(Y 50)(Y50) have the structure | 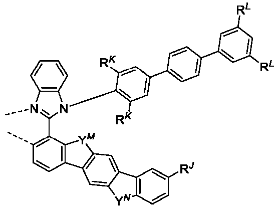 | L_{A}86-(R*^{J}*)( R*^{K}*)( R*^{L}*)(Y*^{M}*)(Y*^{N}*) wherein L_{A}86-(V1)(V1)(V1)(Y1)(Y1) to L_{A}86-(V156)(V156)(V156)(Y5 0)(Y50) have the structure | 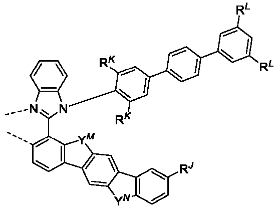 |
| L_{A}87-(R*^{J}*)( R*^{K}*)( R*^{L}*)(Y*^{M}*)(Y*^{N}*) wherein L_{A}87-(V1)(V1)(V1)(Y1)(Y1) to L_{A}87-(V156)(V156)(V156)(Y 50)(Y50) have the structure | 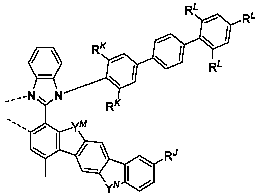 | L_{A}88-(R*^{J}*)( R*^{K}*)( R*^{L}*)(Y*^{M}*)(Y*^{N}*) wherein L_{A}88-(V1)(V1)(V1)(Y1)(Y1) to L_{A}88-(V156)(V156)(V156)(Y5 0)(Y50) have the structure | 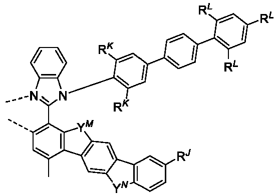 |
| L_{A}89-(R*^{J}*)( R*^{K}*)( R*^{L}*)(Y*^{M}*)(Y*^{N}*) wherein L_{A}89-(V1)(V1)(V1)(Y1)(Y1) to L_{A}89-(V156)(V156)(V156)(Y 50)(Y50) have the structure | 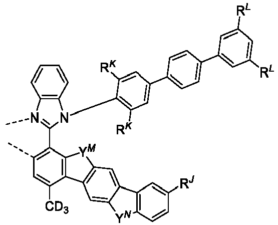 | L_{A}90-(R*^{J}*)( R*^{K}*)( R*^{L}*)(Y*^{M}*)(Y*^{N}*) wherein L_{A}90-(V1)(V1)(V1)(Y1)(Y1) to L_{A}90-(V156)(V156)(V156)(Y5 0)(Y50) have the structure | 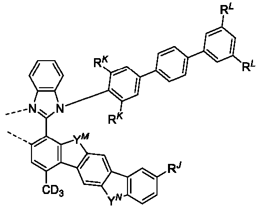 |
| L_{A}91-(R*^{J}*)( R*^{K}*)( R*^{L}*)(Y*^{M}*)(Y*^{N}*) wherein L_{A}90-(V1)(V1)(V1)(Y1)(Y1) to L_{A}90-(V156)(V156)(V156)(Y 50)(Y50) have the structure | 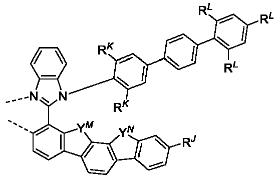 | L_{A}92-(R*^{J}*)( R*^{K}*)( R*^{L}*)(Y*^{M}*)(Y*^{N}*) wherein L_{A}92-(V1)(V1)(V1)(Y1)(Y1) to L_{A}92-(V156)(V156)(V156)(Y5 0)(Y50) have the structure | 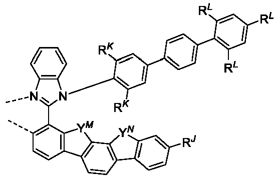 |
| L_{A}93-(R*^{J}*)( R*^{K}*)( R*^{L}*)(Y*^{M}*)(Y*^{N}*) wherein L_{A}93-(V1)(V1)(V1)(Y1)(Y1) to L_{A}93-(V156)(V156)(V156)(Y 50)(Y50) have the structure | 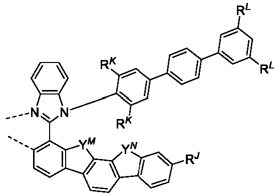 | L_{A}94-(R*^{J}*)( R*^{K}*)( R*^{L}*)(Y*^{M}*)(Y*^{N}*) wherein L_{A}94-(V1)(V1)(V1)(Y1)(Y1) to L_{A}94-(V156)(V156)(V156)(Y5 0)(Y50) have the structure | 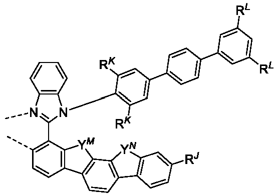 |
| L_{A}95-(R*^{J}*)( R*^{K}*)( R*^{L}*)(Y*^{M}*)(Y*^{N}*) wherein L_{A}95-(V1)(V1)(V1)(Y1)(Y1) to L_{A}95-(V156)(V156)(V156)(Y 50)(Y50) have the structure | 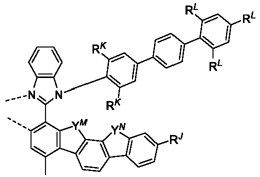 | L_{A}96-(R*^{J}*)( R*^{K}*)( R*^{L}*)(Y*^{M}*)(Y*^{N}*) wherein L_{A}96-(V1)(V1)(V1)(Y1)(Y1) to L_{A}96-(V156)(V156)(V156)(Y5 0)(Y50) have the structure | 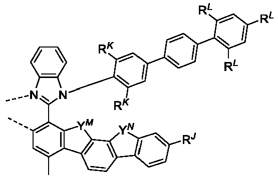 |
| L_{A}97-(R*^{J}*)( R*^{K}*)( R*^{L}*)(Y*^{M}*)(Y*^{N}*) wherein L_{A}97-(V1)(V1)(V1)(Y1)(Y1) to L_{A}97-(V156)(V156)(V156)(Y 50)(Y50) have the structure | 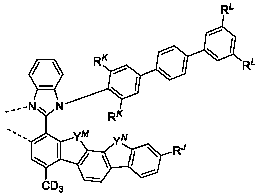 | L_{A}98-(R*^{J}*)( R*^{K}*)( R*^{L}*)(Y*^{M}*)(Y*^{N}*) wherein L_{A}98-(V1)(V1)(V1)(Y1)(Y1) to L_{A}98-(V156)(V156)(V156)(Y5 0)(Y50) have the structure | 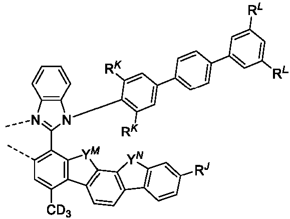 |
| L_{A}99-(R*^{J}*)( R*^{K}*)( R*^{L}*)(Y*^{M}*)(Y*^{N}*) wherein L_{A}99-(V1)(V1)(V1)(Y1)(Y1) to L_{A}99-(V156)(V156)(V156)(Y 50)(Y50) have the structure | 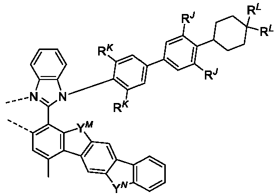 | L_{A}100-(R*^{J}*)( R*^{K}*)( R*^{L}*)(Y*^{M}*)(Y*^{N}*) wherein L_{A}100-(V1)(V1)(V1)(Y1)(Y1) to L_{A}100-(V156)(V156)(V156)(Y5 0)(Y50) have the structure | 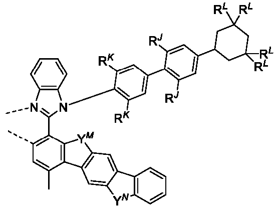 |
| L_{A}101-(R*^{J}*)( R*^{K}*)( R*^{L}*)(Y*^{M}*)(Y*^{N}*) wherein L_{A}101-(V1)(V1)(V1)(Y1)(Y1) to L_{A}101-(V156)(V156)(V156)(Y 50)(Y50) have the structure | 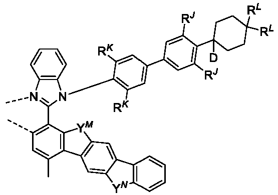 | L_{A}102-(R*^{J}*)( R*^{K}*)( R*^{L}*)(Y*^{M}*)(Y*^{N}*) wherein L_{A}102-(V1)(V1)(V1)(Y1)(Y1) to L_{A}102-(V156)(V156)(V156)(Y5 0)(Y50) have the structure | 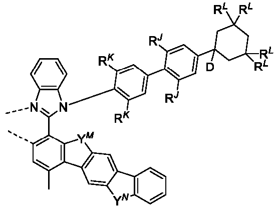 |
| L_{A}103-(R*^{J}*)( R*^{K}*)( R*^{L}*)(Y*^{M}*)(Y*^{N}*) wherein L_{A}103-(V1)(V1)(V1)(Y1)(Y1) to L_{A}103-(V156)(V156)(V156)(Y 50)(Y50) have the structure | 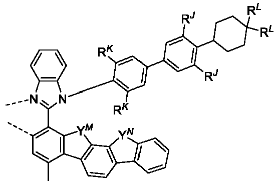 | L_{A}104-(R*^{J}*)( R*^{K}*)( R*^{L}*)(Y*^{M}*)(Y*^{N}*) wherein L_{A}104-(V1)(V1)(V1)(Y1)(Y1) to L_{A}104-(V156)(V156)(V156)(Y5 0)(Y50) have the structure | 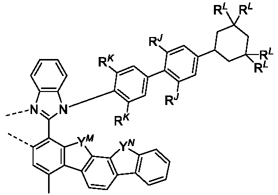 |
| L_{A}105-(R*^{J}*)( R*^{K}*)( R*^{L}*)(Y*^{M}*)(Y*^{N}*) wherein L_{A}105-(V1)(V1)(V1)(Y1)(Y1) to L_{A}105-(V156)(V156)(V156)(Y 50)(Y50) have the structure | 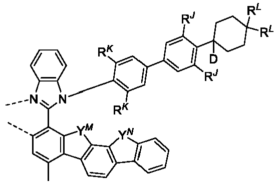 | L_{A}106-(R*^{J}*)( R*^{K}*)( R*^{L}*)(Y*^{M}*)(Y*^{N}*) wherein L_{A}106-(V1)(V1)(V1)(Y1)(Y1) to L_{A}106-(V156)(V156)(V156)(Y5 0)(Y50) have the structure | 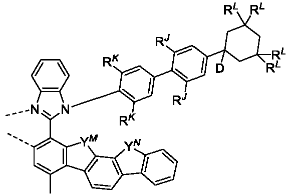 |
| L_{A}107-(R*^{J}*)( R*^{K}*)( R*^{L}*)(Y*^{M}*)(Y*^{N}*) wherein L_{A}108-(V1)(V1)(V1)(Y1)(Y1) to L_{A}108-(V156)(V156)(V156)(Y 50)(Y50) have the structure | 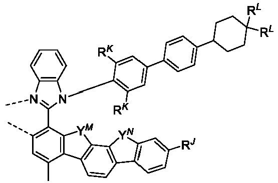 | L_{A}108-(R*^{J}*)( R*^{K}*)( R*^{L}*)(Y*^{M}*)(Y*^{N}*) wherein L_{A}108-(V1)(V1)(V1)(Y1)(Y1) to L_{A}108-(V156)(V156)(V156)(Y5 0)(Y50) have the structure | 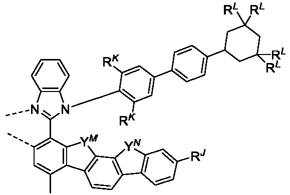 |
| L_{A}109-(R*^{J}*)( R*^{K}*)( R*^{L}*)(Y*^{M}*)(Y*^{N}*) wherein L_{A}109-(V1)(V1)(V1)(Y1)(Y1) to L_{A}109-(V156)(V156)(V156)(Y 50)(Y50) have the structure | 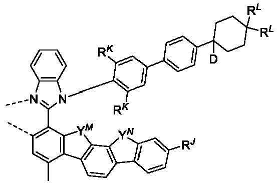 | L_{A}110-(R*^{J}*)( R*^{K}*)( R*^{L}*)(Y*^{M}*)(Y*^{N}*) wherein L_{A}110-(V1)(V1)(V1)(Y1)(Y1) to L_{A}110-(V156)(V156)(V156)(Y5 0)(Y50) have the structure | 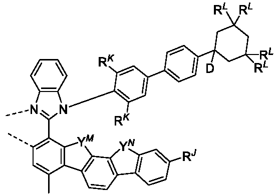 |
| L_{A}111-(R*^{J}*)( R*^{K}*)( R*^{L}*)(Y*^{M}*)(Y*^{N}*) wherein L_{A}111-(V1)(V1)(V1)(Y1)(Y1) to L_{A}111-(V156)(V156)(V156)(Y 50)(Y50) have the structure | 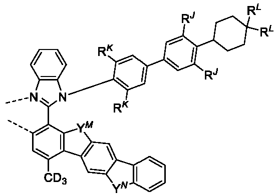 | L_{A}112-(R*^{J}*)( R*^{K}*)( R*^{L}*)(Y*^{M}*)(Y*^{N}*) wherein L_{A}112-(V1)(V1)(V1)(Y1)(Y1) to L_{A}112-(V156)(V156)(V156)(Y5 0)(Y50) have the structure | 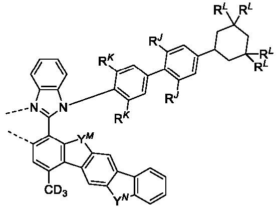 |
| L_{A}113-(R*^{J}*)( R*^{K}*)( R*^{L}*)(Y*^{M}*)(Y*^{N}*) wherein L_{A}113-(V1)(V1)(V1)(Y1)(Y1) to L_{A}113-(V156)(V156)(V156)(Y 50)(Y50) have the structure | 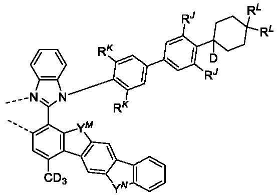 | L_{A}114-(R*^{J}*)( R*^{K}*)( R*^{L}*)(Y*^{M}*)(Y*^{N}*) wherein L_{A}114-(V1)(V1)(V1)(Y1)(Y1) to L_{A}114-(V156)(V156)(V156)(Y5 0)(Y50) have the structure | 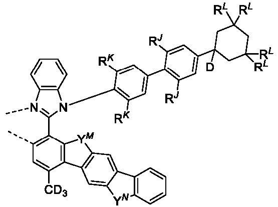 |
| L_{A}115-(R*^{J}*)( R*^{K}*)( R*^{L}*)(Y*^{M}*)(Y*^{N}*) wherein L_{A}115-(V1)(V1)(V1)(Y1)(Y1) to L_{A}115-(V156)(V156)(V156)(Y 50)(Y50) have the structure | 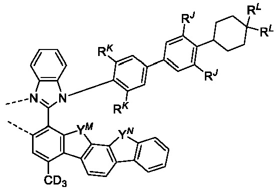 | L_{A}116-(R*^{J}*)( R*^{K}*)( R*^{L}*)(Y*^{M}*)(Y*^{N}*) wherein L_{A}116-(V1)(V1)(V1)(Y1)(Y1) to L_{A}116-(V156)(V156)(V156)(Y5 0)(Y50) have the structure | 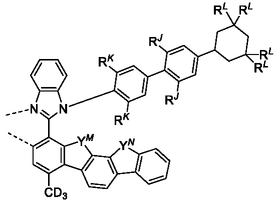 |
| L_{A}117-(R*^{J}*)( R*^{K}*)( R*^{L}*)(Y*^{M}*)(Y*^{N}*) wherein L_{A}117-(V1)(V1)(V1)(Y1)(Y1) to L_{A}117-(V156)(V156)(V156)(Y 50)(Y50) have the structure | 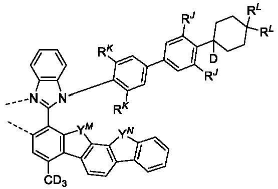 | L_{A}118-(R*^{J}*)( R*^{K}*)( R*^{L}*)(Y*^{M}*)(Y*^{N}*) wherein L_{A}118-(V1)(V1)(V1)(Y1)(Y1) to L_{A}118-(V156)(V156)(V156)(Y5 0)(Y50) have the structure | 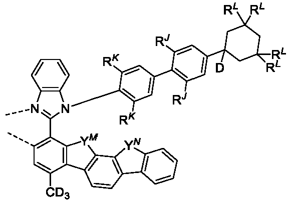 |
| L_{A}119-(R*^{J}*)( R*^{K}*)( R*^{L}*)(Y*^{M}*)(Y*^{N}*) wherein L_{A}119-(V1)(V1)(V1)(Y1)(Y1) to L_{A}119-(V156)(V156)(V156)(Y 50)(Y50) have the structure | 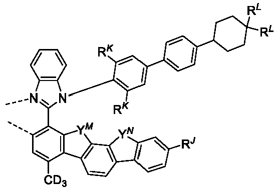 | L_{A}120-(R*^{J}*)( R*^{K}*)( R*^{L}*)(Y*^{M}*)(Y*^{N}*) wherein L_{A}120-(V1)(V1)(V1)(Y1)(Y1) to L_{A}120-(V156)(V156)(V156)(Y5 0)(Y50) have the structure | 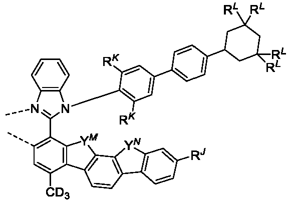 |
| L_{A}121-(R*^{J}*)( R*^{K}*)( R*^{L}*)(Y*^{M}*)(Y*^{N}*) wherein L_{A}121-(V1)(V1)(V1)(Y1)(Y1) to L_{A}121-(V156)(V156)(V156)(Y 50)(Y50) have the structure | 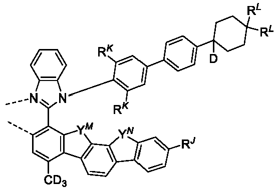 | L_{A}122-(R*^{J}*)( R*^{K}*)( R*^{L}*)(Y*^{M}*)(Y*^{N}*) wherein L_{A}122-(V1)(V1)(V1)(Y1)(Y1) to L_{A}122-(V156)(V156)(V156)(Y5 0)(Y50) have the structure | 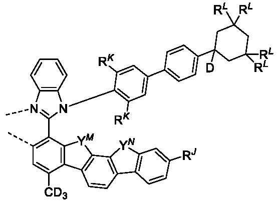 |

wherein the ligand L_{A} is selected from L_{A*i"*}(R*^{J}*)(R*^{K}*)(R*^{L}*)(Y*^{M'}*)(Y*^{N}*), wherein *i'* is an integer from 123 to 146, each of R*^{J}*, R*^{K}*, and R^{L} is independently selected from V1 to V156; Y*^{M'}* is selected from Y1 to Y47; Y*^{N}* is selected from Y1 to Y50; and each of L _{A}123-(V1)(V1)(V1)(Y1)(Y1) to L _{A}146-(V156)(V156)(V156)(Y47)(Y50) is defined below in the following LIST 8:

| L_{A} | Structure of L_{A} | L_{A} | Structure of L_{A} |
|---|---|---|---|
| L_{A}123-(R*^{J}*)( R*^{K}*)( R*^{L}*)(Y*^{M'}*)(Y*^{N}*) wherein L_{A}123-(V1)(V1)(V1)(Y1)(Y1) to L_{A}123-(V156)(V156)(V156)(Y4 7)(Y50) have the structure | 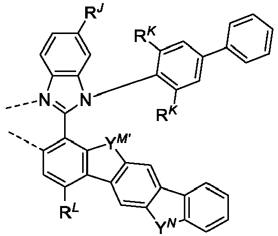 | L_{A}124-(R*^{J}*)( R*^{K}*)( R*^{L}*)(Y*^{M'}*)(Y*^{N}*) wherein L_{A}124-(V1)(V1)(V1)(Y1)(Y1) to L_{A}124-(V156)(V156)(V156)(Y4 7)(Y50) have the structure | 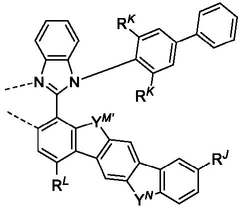 |
| L_{A}125-(R*^{J}*)( R*^{K}*)( R*^{L}*)(Y*^{M'}*)(Y*^{N}*) wherein L_{A}125-(V1)(V1)(V1)(Y1)(Y1) to L_{A}125-(V156)(V156)(V156)(Y4 7)(Y50) have the structure | 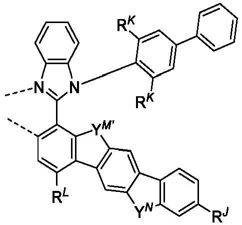 | L_{A}126-(R*^{J}*)( R*^{K}*)( R*^{L}*)(Y*^{M'}*)(Y*^{N}*) wherein L_{A}126-(V1)(V1)(V1)(Y1)(Y1) to L_{A}126-(V156)(V156)(V156)(Y4 7)(Y50) have the structure | 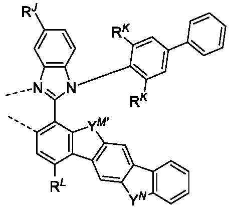 |
| L_{A}127-(R*^{J}*)( R*^{K}*)( R*^{L}*)(Y*^{M'}*)(Y*^{N}*) wherein L_{A}127-(V1)(V1)(V1)(Y1)(Y1) to L_{A}127-(V156)(V156)(V156)(Y4 7)(Y50) have the structure | 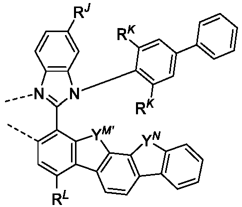 | L_{A}128-(R*^{J}*)( R*^{K}*)( R*^{L}*)(Y*^{M'}*)(Y*^{N}*) wherein L_{A}128-(V1)(V1)(V1)(Y1)(Y1) to L_{A}128-(V156)(V156)(V156)(Y4 7)(Y50) have the structure | 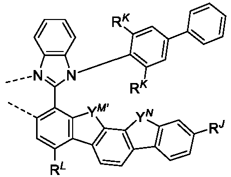 |
| L_{A}129-(R*^{J}*)( R*^{K}*)( R*^{L}*)(Y*^{M'}*)(Y*^{N}*) wherein L_{A}129-(V1)(V1)(V1)(Y1)(Y1) to L_{A}129-(V156)(V156)(V156)(Y4 7)(Y50) have the structure | 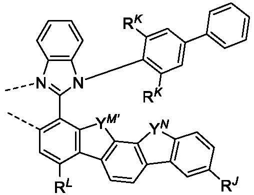 | L_{A}130-(R*^{J}*)( R*^{K}*)( R*^{L}*)(Y*^{M'}*)(Y*^{N}*) wherein L_{A}130-(V1)(V1)(V1)(Y1)(Y1) to L_{A}130-(V156)(V156)(V156)(Y4 7)(Y50) have the structure | 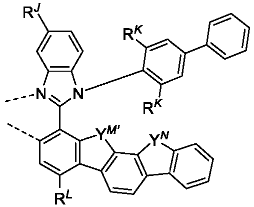 |
| L_{A}131-(R*^{J}*)( R*^{K}*)( R*^{L}*)(Y*^{M'}*)(Y*^{N}*) wherein L_{A}131-(V1)(V1)(V1)(Y1)(Y1) to L_{A}131-(V156)(V156)(V156)(Y4 7)(Y50) have the structure | 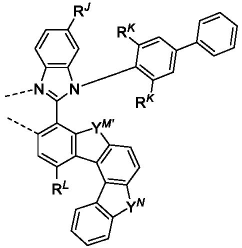 | L_{A}132-(R*^{J}*)( R*^{K}*)( R*^{L}*)(Y*^{M'}*)(Y*^{N}*) wherein L_{A}132-(V1)(V1)(V1)(Y1)(Y1) to L_{A}132-(V156)(V156)(V156)(Y4 7)(Y50) have the structure | 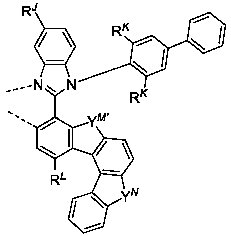 |
| L_{A}133-(R*^{J}*)( R*^{K}*)( R*^{L}*)(Y*^{M'}*)(Y*^{N}*) wherein L_{A}133-(V1)(V1)(V1)(Y1)(Y1) to L_{A}133-(V156)(V156)(V156)(Y4 7)(Y50) have the structure | 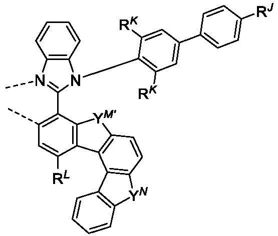 | L_{A}134-(R*^{J}*)( R*^{K}*)( R*^{L}*)(Y*^{M'}*)(Y*^{N}*) wherein L_{A}134-(V1)(V1)(V1)(Y1)(Y1) to L_{A}134-(V156)(V156)(V156)(Y4 7)(Y50) have the structure | 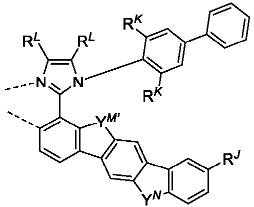 |
| L_{A}135-(R*^{J}*)( R*^{K}*)( R*^{L}*)(Y*^{M'}*)(Y*^{N}*) wherein L_{A}135-(V1)(V1)(V1)(Y1)(Y1) to L_{A}135-(V156)(V156)(V156)(Y4 7)(Y50) have the structure | 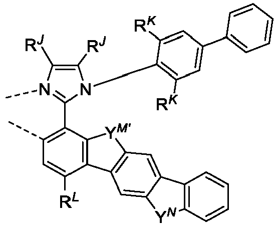 | L_{A}136-(R*^{J}*)( R*^{K}*)( R*^{L}*)(Y*^{M'}*)(Y*^{N}*) wherein L_{A}136-(V1)(V1)(V1)(Y1)(Y1) to L_{A}136-(V156)(V156)(V156)(Y4 7)(Y50) have the structure | 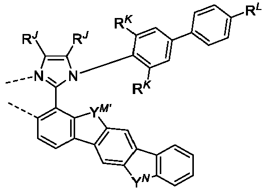 |
| L_{A}137-(R*^{J}*)( R*^{K}*)( R*^{L}*)(Y*^{M'}*)(Y*^{N}*) wherein L_{A}137-(V1)(V1)(V1)(Y1)(Y1) to L_{A}137-(V156)(V156)(V156)(Y4 7)(Y50) have the structure | 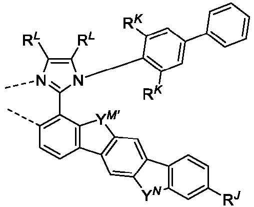 | L_{A}138-(R*^{J}*)( R*^{K}*)( R*^{L}*)(Y*^{M'}*)(Y*^{N}*) wherein L_{A}138-(V1)(V1)(V1)(Y1)(Y1) to L_{A}138-(V156)(V156)(V156)(Y4 7)(Y50) have the structure | 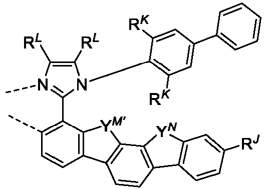 |
| L_{A}139-(R*^{J}*)( R*^{K}*)( R*^{L}*)(Y*^{M'}*)(Y*^{N}*) wherein L_{A}139-(V1)(V1)(V1)(Y1)(Y1) to L_{A}139-(V156)(V156)(V156)(Y4 7)(Y50) have the structure | 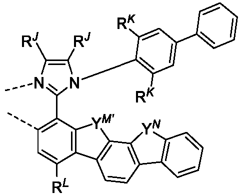 | L_{A}140-(R*^{J}*)( R*^{K}*)( R*^{L}*)(Y*^{M'}*)(Y*^{N}*) wherein L_{A}140-(V1)(V1)(V1)(Y1)(Y1) to L_{A}140-(V156)(V156)(V156)(Y4 7)(Y50) have the structure | 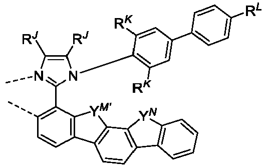 |
| L_{A}141-(R*^{J}*)( R*^{K}*)( R*^{L}*)(Y*^{M'}*)(Y*^{N}*) wherein L_{A}141-(V1)(V1)(V1)(Y1)(Y1) to L_{A}141-(V156)(V156)(V156)(Y4 7)(Y50) have the structure | 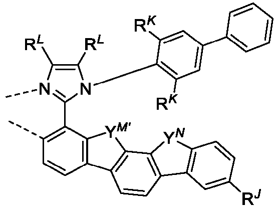 | L_{A}142-(R*^{J}*)( R*^{K}*)( R*^{L}*)(Y*^{M'}*)(Y*^{N}*) wherein L_{A}142-(V1)(V1)(V1)(Y1)(Y1) to L_{A}142-(V156)(V156)(V156)(Y4 7)(Y50) have the structure | 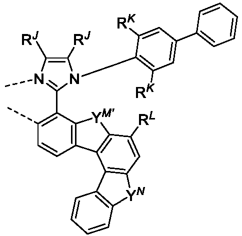 |
| L_{A}143-(R*^{J}*)( R*^{K}*)( R*^{L}*)(Y*^{M'}*)(Y*^{N}*) wherein L_{A}143-(V1)(V1)(V1)(Y1)(Y1) to L_{A}143-(V156)(V156)(V156)(Y4 7)(Y50) have the structure | 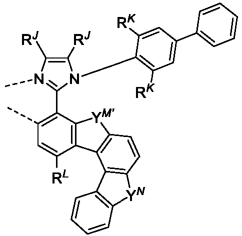 | L_{A}144-(R*^{J}*)( R*^{K}*)( R*^{L}*)(Y*^{M'}*)(Y*^{N}*) wherein L_{A}144-(V1)(V1)(V1)(Y1)(Y1) to L_{A}144-(V156)(V156)(V156)(Y4 7)(Y50) have the structure | 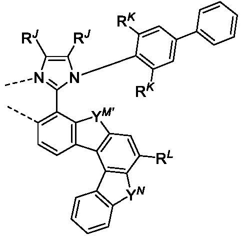 |
| L_{A}145-(R*^{J}*)( R*^{K}*)( R*^{L}*)(Y*^{M'}*)(Y*^{N}*) wherein L_{A}145-(V1)(V1)(V1)(Y1)(Y1) to L_{A}145-(V156)(V156)(V156)(Y4 7)(Y50) have the structure | 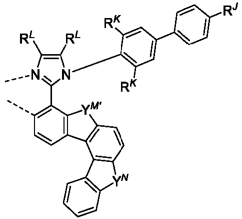 | L_{A}146-(R*^{J}*)( R*^{K}*)( R*^{L}*)(Y*^{M'}*)(Y*^{N}*) wherein L_{A}146-(V1)(V1)(V1)(Y1)(Y1) to L_{A}146-(V156)(V156)(V156)(Y4 7)(Y50) have the structure | 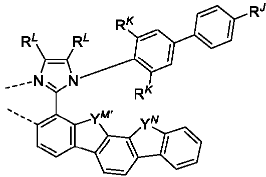 |

wherein the ligand L_{A} is selected from L_{A*n*}(R*^{H}*)(R*^{I}*)R*^{J}*)(R*^{K}*)(R*^{L}*)(Y*^{M}*), wherein n is an integer from 147 to 239, R*^{H}* is selected from V2 to V156; each of R*^{I}*, R*^{J}*, R*^{K}*, and R^{L} is independently selected from V1 to V156; and Y*^{M}* is selected from Y1 to Y50; and
wherein each of L _{A}147-(V2)(V1)(V1)(V1)(V1)(Y1) to L _{A}239-(V156)(V156)(V156)(V156)(V156)(Y50) is defined in the following LIST 8a:

| L_{A} | Structure of L_{A} | L_{A} | Structure of L_{A} |
|---|---|---|---|
| L_{A}147-(R*^{H}*)(R*^{I}*)(R*^{J}*)(R*^{K}*)(R*^{L}*)(Y*^{M}*), wherein L_{A}147-(V2)(V1)(V1)(V1)(V1)(Y1) to L_{A}147-(V156)(V156)(V156)(V156)( V156)(Y50), having the structure | 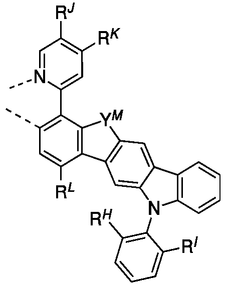 | L_{A}148-(R*^{H}*)(R*^{I}*)(R*^{J}*)(R*^{K}*)(R*^{L}*)(Y*^{M}*), wherein L_{A}148-(V2)(V1)(V1)(V1)(V1)(Y1) to L_{A}148-(V156)(V156)(V156)(V156)( V156)(Y50), having the structure | 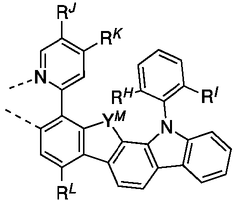 |
| L_{A}149-(R*^{H}*)(R*^{I}*)(R*^{J}*)(R*^{K}*)(R*^{L}*)(Y*^{M}*), wherein L_{A}149-(V2)(V1)(V1)(V1)(V1)(Y1) to L_{A}149-(V156)(V156)(V156)(V156)( V156)(Y50), having the structure | 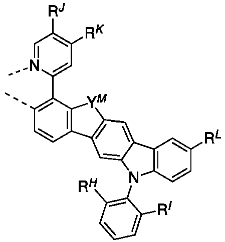 | L_{A}150-(R*^{H}*)(R*^{I}*)(R*^{J}*)(R*^{K}*)(R*^{L}*)(Y*^{M}*), wherein L_{A}150-(V2)(V1)(V1)(V1)(V1)(Y1) to L_{A}150-(V156)(V156)(V156)(V156)( V156)(Y50), having the structure | 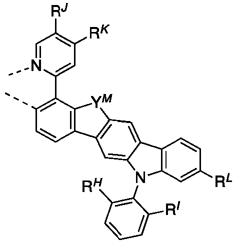 |
| L_{A}151-(R*^{H}*)(R*^{I}*)(R*^{J}*)(R*^{K}*)(R*^{L}*)(Y*^{M}*), wherein L_{A}151-(V2)(V1)(V1)(V1)(V1)(Y1) to L_{A}151-(V156)(V156)(V156)(V156)( V156)(Y50), having the structure | 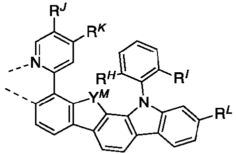 | L_{A}152-(R*^{H}*)(R*^{I}*)(R*^{J}*)(R*^{K}*)(R*^{L}*)(Y*^{M}*), wherein L_{A}152-(V2)(V1)(V1)(V1)(V1)(Y1) to L_{A}152-(V156)(V156)(V156)(V156)( V156)(Y50), having the structure | 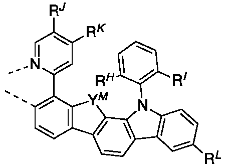 |
| L_{A}153-(R*^{H}*)(R*^{I}*)(R*^{J}*)(R*^{K}*)(R*^{L}*)(Y*^{M}*), wherein L_{A}153-(V2)(V1)(V1)(V1)(V1)(Y1) to L_{A}153-(V156)(V156)(V156)(V156)( V156)(Y50), having the structure | 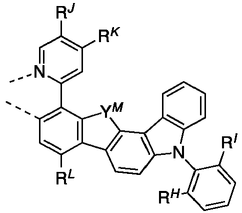 | L_{A}154-(R*^{H}*)(R*^{I}*)(R*^{J}*)(R*^{K}*)(R*^{L}*)(Y*^{M}*), wherein L_{A}154-(V2)(V1)(V1)(V1)(V1)(Y1) to L_{A}154-(V156)(V156)(V156)(V156)( V156)(Y50), having the structure | 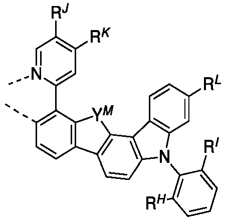 |
| L_{A}155-(R*^{H}*)(R*^{I}*)(R*^{J}*)(R*^{K}*)(R*^{L}*)(Y*^{M}*), wherein L_{A}155-(V2)(V1)(V1)(V1)(V1)(Y1) to L_{A}155-(V156)(V156)(V156)(V156)( V156)(Y50), having the structure | 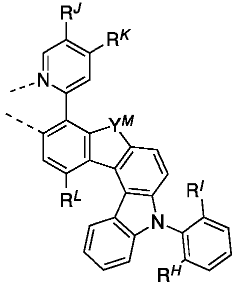 | L_{A}156-(R*^{H}*)(R*^{I}*)(R*^{J}*)(R*^{K}*)(R*^{L}*)(Y*^{M}*), wherein L_{A}156-(R2)(V1)(V1)(V1)(V1)(Y1) to L_{A}156-(V156)(V156)(V156)(V156)( V156)(Y50), having the structure | 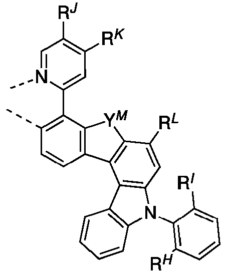 |
| L_{A}157-(R*^{H}*)(R*^{I}*)(R*^{J}*)(R*^{K}*)(R*^{L}*)(Y*^{M}*), wherein L_{A}157-(V2)(V1)(V1)(V1)(V1)(Y1) to L_{A}157-(V156)(V156)(V156)(V156)( V156)(Y50), having the structure | 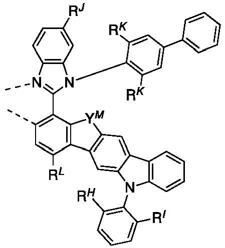 | L_{A}158-(R*^{H}*)(R*^{I}*)(R*^{J}*)(R*^{K}*)(R*^{L}*)(Y*^{M}*), wherein L_{A}158-(V2)(V1)(V1)(V1)(V1)(Y1) to L_{A}158-(V156)(V156)(V156)(V156)( V156)(Y50), having the structure | 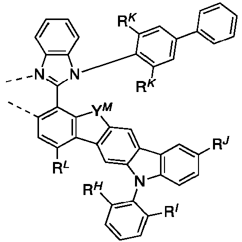 |
| L_{A}159-(R*^{H}*)(R*^{I}*)(R*^{J}*)(R*^{K}*)(R*^{L}*)(Y*^{M}*), wherein L_{A}159-(V2)(V1)(V1)(V1)(V1)(Y1) to L_{A}159-(V156)(V156)(V156)(V156)( V156)(Y50), having the structure | 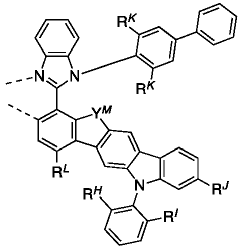 | L_{A}160-(R*^{H}*)(R*^{I}*)(R*^{J}*)(R*^{K}*)(R*^{L}*)(Y*^{M}*), wherein L_{A}160-(V2)(V1)(V1)(V1)(V1)(Y1) to L_{A}160-(V156)(V156)(V156)(V156)( V156)(Y50), having the structure | 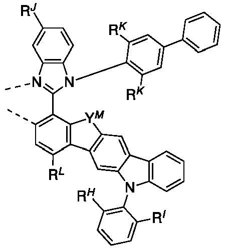 |
| L_{A}161-(R*^{H}*)(R*^{I}*)(R*^{J}*)(R*^{K}*)(R*^{L}*)(Y*^{M}*), wherein L_{A}161-(V2)(V1)(V1)(V1)(V1)(Y1) to L_{A}161-(V156)(V156)(V156)(V156)( V156)(Y50), having the structure | 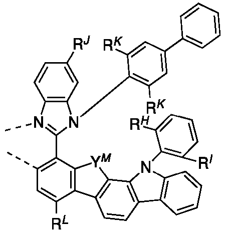 | L_{A}162-(R*^{H}*)(R*^{I}*)(R*^{J}*)(R*^{K}*)(R*^{L}*)(Y*^{M}*), wherein L_{A}162-(V2)(V1)(V1)(V1)(V1)(Y1) to L_{A}162-(V156)(V156)(V156)(V156)( V156)(Y50), having the structure | 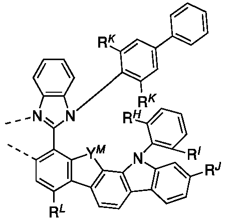 |
| L_{A}163-(R*^{H}*)(R*^{I}*)(R*^{J}*)(R*^{K}*)(R*^{L}*)(Y*^{M}*), wherein L_{A}163-(V2)(V1)(V1)(V1)(V1)(Y1) to L_{A}163-(V156)(V156)(V156)(V156)( V156)(Y50), having the structure | 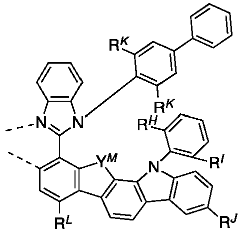 | L_{A}164-(R*^{H}*)(R*^{I}*)(R*^{J}*)(R*^{K}*)(R*^{L}*)(Y*^{M}*), wherein L_{A}164-(V2)(V1)(V1)(V1)(V1)(Y1) to L_{A}164-(V156)(V156)(V156)(V156)( V156)(Y50), having the structure | 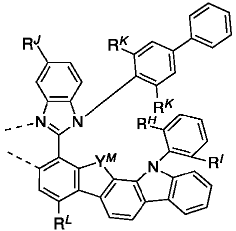 |
| L_{A}165-(R*^{H}*)(R*^{I}*)(R*^{J}*)(R*^{K}*)(R*^{L}*)(Y*^{M}*), wherein L_{A}165-(V2)(V1)(V1)(V1)(V1)(Y1) to L_{A}165-(V156)(V156)(V156)(V156)( V156)(Y50), having the structure | 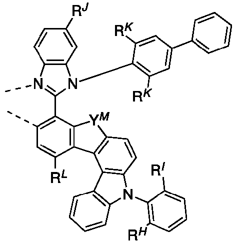 | L_{A}166-(R*^{H}*)(R*^{I}*)(R*^{J}*)(R*^{K}*)(R*^{L}*)(Y*^{M}*), wherein L_{A}166-(V2)(V1)(V1)(V1)(V1)(Y1) to L_{A}166-(V156)(V156)(V156)(V156)( V156)(Y50), having the structure | 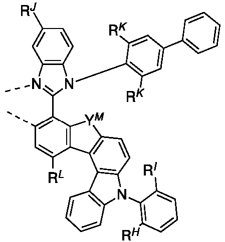 |
| L_{A}167-(R*^{H}*)(R*^{I}*)(R*^{J}*)(R*^{K}*)(R*^{L}*)(Y*^{M}*), wherein L_{A}167-(V2)(V1)(V1)(V1)(V1)(Y1) to L_{A}167-(V156)(V156)(V156)(V156)( V156)(Y50), having the structure | 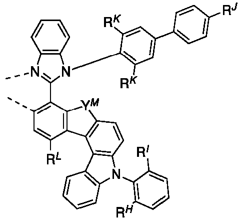 | L_{A}168-(R*^{H}*)(R*^{I}*)(R*^{J}*)(R*^{K}*)(R*^{L}*)(Y*^{M}*), wherein L_{A}168-(R2)(V1)(V1)(V1)(V1)(Y1) to L_{A}168-(V156)(V156)(V156)(V156)( V156)(Y50), having the structure | 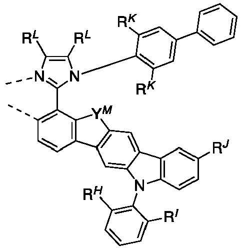 |
| L_{A}169-(R*^{H}*)(R*^{I}*)(R*^{J}*)(R*^{K}*)(R*^{L}*)(Y*^{M}*), wherein L_{A}169-(V2)(V1)(V1)(V1)(V1)(Y1) to L_{A}169-(V156)(V156)(V156)(V156)( V156)(Y50), having the structure | 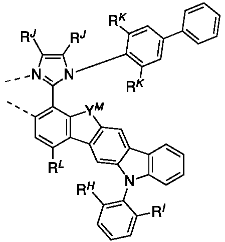 | L_{A}170-(R*^{H}*)(R*^{I}*)(R*^{J}*)(R*^{K}*)(R*^{L}*)(Y*^{M}*), wherein L_{A}170-(V2)(V1)(V1)(V1)(V1)(Y1) to L_{A}170-(V156)(V156)(V156)(V156)( V156)(Y50), having the structure | 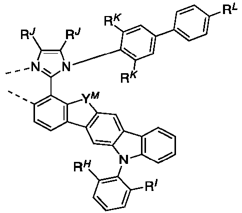 |
| L_{A}171-(R*^{H}*)(R*^{I}*)(R*^{J}*)(R*^{K}*)(R*^{L}*)(Y*^{M}*), wherein L_{A}171-(V2)(V1)(V1)(V1)(V1)(Y1) to L_{A}171-(V156)(V156)(V156)(V156)( V156)(Y50), having the structure | 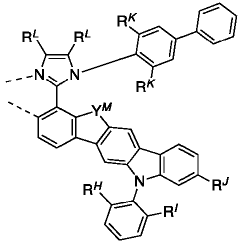 | L_{A}172-(R*^{H}*)(R*^{I}*)(R*^{J}*)(R*^{K}*)(R*^{L}*)(Y*^{M}*), wherein L_{A}172-(V2)(V1)(V1)(V1)(V1)(Y1) to L_{A}172-(V156)(V156)(V156)(V156)( V156)(Y50), having the structure | 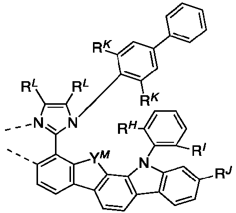 |
| L_{A}173-(R*^{H}*)(R*^{I}*)(R*^{J}*)(R*^{K}*)(R*^{L}*)(Y*^{M}*), wherein L_{A}173-(V2)(V1)(V1)(V1)(V1)(Y1) to L_{A}173-(V156)(V156)(V156)(V156)( V156)(Y50), having the structure | 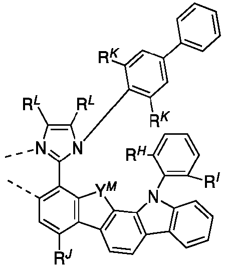 | L_{A}174-(R*^{H}*)(R*^{I}*)(R*^{J}*)(R*^{K}*)(R*^{L}*)(Y*^{M}*), wherein L_{A}174-(V2)(V1)(V1)(V1)(V1)(Y1) to L_{A}174-(V156)(V156)(V156)(V156)( V156)(Y50), having the structure | 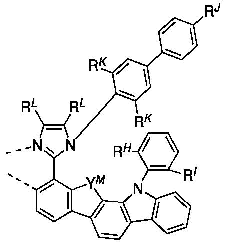 |
| L_{A}175-(R*^{H}*)(R*^{I}*)(R*^{J}*)(R*^{K}*)(R*^{L}*)(Y*^{M}*), wherein L_{A}175-(V2)(V1)(V1)(V1)(V1)(Y1) to L_{A}175-(V156)(V156)(V156)(V156)( V156)(Y50), having the structure | 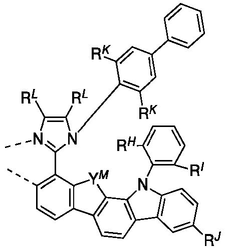 | L_{A}176-(R*^{H}*)(R*^{I}*)(R*^{J}*)(R*^{K}*)(R*^{L}*)(Y*^{M}*), wherein L_{A}176-(V2)(V1)(V1)(V1)(V1)(Y1) to L_{A}176-(V156)(V156)(V156)(V156)( V156)(Y50), having the structure | 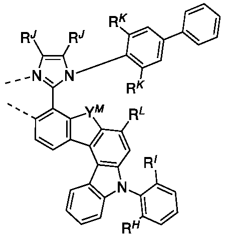 |
| L_{A}177-(R*^{H}*)(R*^{I}*)(R*^{J}*)(R*^{K}*)(R*^{L}*)(Y*^{M}*), wherein L_{A}177-(V2)(V1)(V1)(V1)(V1)(Y1) to L_{A}177-(V156)(V156)(V156)(V156)( V156)(Y50), having the structure | 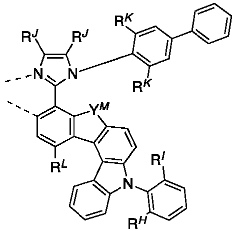 | L_{A}178-(R*^{H}*)(R*^{I}*)(R*^{J}*)(R*^{K}*)(R*^{L}*)(Y*^{M}*), wherein L_{A}178-(V2)(V1)(V1)(V1)(V1)(Y1) to L_{A}178-(V156)(V156)(V156)(V156)( V156)(Y50), having the structure | 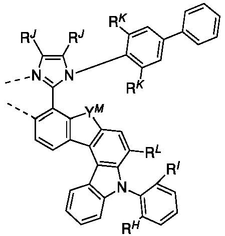 |
| L_{A}179-(R*^{H}*)(R*^{I}*)(R*^{J}*)(R*^{K}*)(R*^{L}*)(Y*^{M}*), wherein L_{A}179-(V2)(V1)(V1)(V1)(V1)(Y1) to L_{A}179-(V156)(V156)(V156)(V156)( V156)(Y50), having the structure | 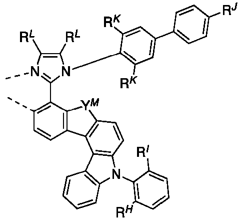 | L_{A}180-(R*^{H}*)(R*^{I}*)(R*^{J}*)(R*^{K}*)(R*^{L}*)(Y*^{M}*), wherein L_{A}180-(V2)(V1)(V1)(V1)(V1)(Y1) to L_{A}180-(V156)(V156)(V156)(V156)( V156)(Y50), having the structure | 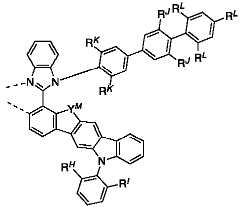 |
| L_{A}181-(R*^{H}*)(R*^{I}*)(R*^{J}*)(R*^{K}*)(R*^{L}*)(Y*^{M}*), wherein L_{A}181-(V2)(V1)(V1)(V1)(V1)(Y1) to L_{A}181-(V156)(V156)(V156)(V156)( V156)(Y50), having the structure | 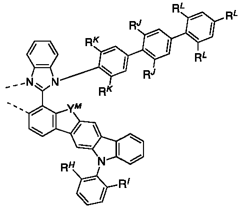 | L_{A}182-(R*^{H}*)(R*^{I}*)(R*^{J}*)(R*^{K}*)(R*^{L}*)(Y*^{M}*), wherein L_{A}182-(V2)(V1)(V1)(V1)(V1)(Y1) to L_{A}182-(V156)(V156)(V156)(V156)( V156)(Y50), having the structure | 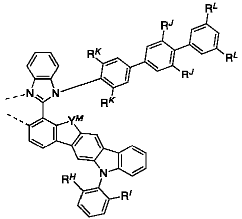 |
| L_{A}183-(R*^{H}*)(R*^{I}*)(R*^{J}*)(R*^{K}*)(R*^{L}*)(Y*^{M}*), wherein L_{A}183-(V2)(V1)(V1)(V1)(V1)(Y1) to L_{A}183-(V156)(V156)(V156)(V156)( V156)(Y50), having the structure | 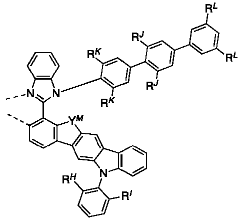 | L_{A}184-(R*^{H}*)(R*^{I}*)(R*^{J}*)(R*^{K}*)(R*^{L}*)(Y*^{M}*), wherein L_{A}184-(V2)(V1)(V1)(V1)(V1)(Y1) to L_{A}184-(V156)(V156)(V156)(V156)( V156)(Y50), having the structure | 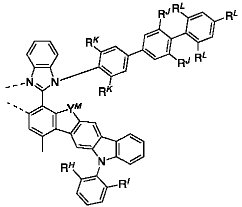 |
| L_{A}185-(R*^{H}*)(R*^{I}*)(R*^{J}*)(R*^{K}*)(R*^{L}*)(Y*^{M}*), wherein L_{A}185-(V2)(V1)(V1)(V1)(V1)(Y1) to L_{A}185-(V156)(V156)(V156)(V156)( V156)(Y50), having the structure | 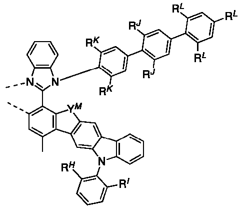 | L_{A}186-(R*^{H}*)(R*^{I}*)(R*^{J}*)(R*^{K}*)(R*^{L}*)(Y*^{M}*), wherein L_{A}186-(V2)(V1)(V1)(V1)(V1)(Y1) to L_{A}186-(V156)(V156)(V156)(V156)( V156)(Y50), having the structure | 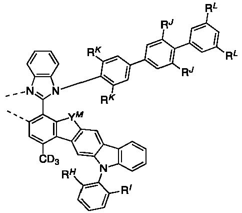 |
| L_{A}187-(R*^{H}*)(R*^{I}*)(R*^{J}*)(R*^{K}*)(R*^{L}*)(Y*^{M}*), wherein L_{A}187-(V2)(V1)(V1)(V1)(V1)(Y1) to L_{A}187-(V156)(V156)(V156)(V156)( V156)(Y50), having the structure | 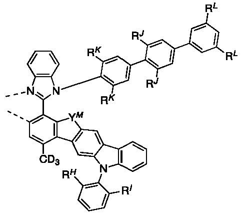 | L_{A}188-(R*^{H}*)(R*^{I}*)(R*^{J}*)(R*^{K}*)(R*^{L}*)(Y*^{M}*), wherein L_{A}188-(V2)(V1)(V1)(V1)(V1)(Y1) to L_{A}188-(V156)(V156)(V156)(V156)( V156)(Y50), having the structure | 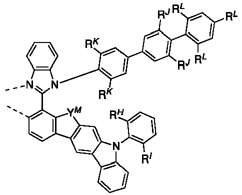 |
| L_{A}189-(R*^{H}*)(R*^{I}*)(R*^{J}*)(R*^{K}*)(R*^{L}*)(Y*^{M}*), wherein L_{A}189-(V2)(V1)(V1)(V1)(V1)(Y1) to L_{A}189-(V156)(V156)(V156)(V156)( V156)(Y50), having the structure | 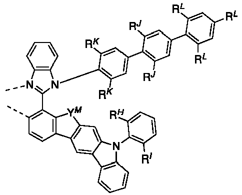 | L_{A}190-(R*^{H}*)(R*^{I}*)(R*^{J}*)(R*^{K}*)(R*^{L}*)(Y*^{M}*), wherein L_{A}190-(V2)(V1)(V1)(V1)(V1)(Y1) to L_{A}190-(V156)(V156)(V156)(V156)( V156)(Y50), having the structure | 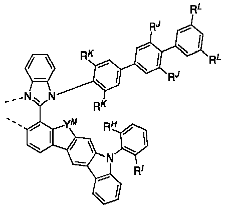 |
| L_{A}191-(R*^{H}*)(R*^{I}*)(R*^{J}*)(R*^{K}*)(R*^{L}*(Y*^{M}*), wherein L_{A}191-(V2)(V1)(V1)(V1)(V1)(Y1) to L_{A}191-(V156)(V156)(V156)(V156)( V156)(Y50), having the structure | 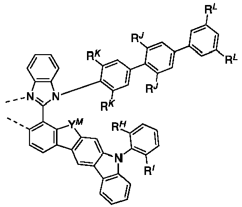 | L_{A}192-(R*^{H}*)(R*^{I}*)(R*^{J}*)(R*^{K}*)(R*^{L}*)(Y*^{M}*), wherein L_{A}192-(V2)(V1)(V1)(V1)(V1)(Y1) to L_{A}192-(V156)(V156)(V156)(V156)( V156)(Y50), having the structure | 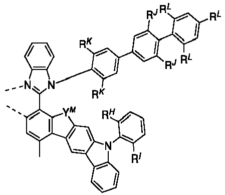 |
| L_{A}193-(R*^{H}*)(R*^{I}*)(R*^{J}*)(R*^{K}*)(R*^{L}*)(Y*^{M}*), wherein L_{A}193-(V2)(V1)(V1)(V1)(V1)(Y1) to L_{A}193-(V156)(V156)(V156)(V156)( V156)(Y50), having the structure | 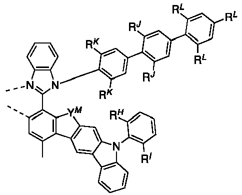 | L_{A}194-(R*^{H}*)(R*^{I}*)(R*^{J}*)(R*^{K}*)(R*^{L}*)(Y*^{M}*), wherein L_{A}194-(V2)(V1)(V1)(V1)(V1)(Y1) to L_{A}194-(V156)(V156)(V156)(V156)( V156)(Y50), having the structure | 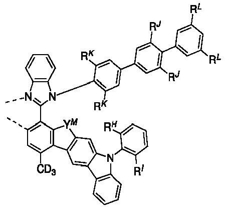 |
| L_{A}195-(R*^{H}*)(R*^{I}*)(R*^{J}*)(R*^{K}*)(R*^{L}*)(Y*^{M}*), wherein L_{A}195-(V2)(V1)(V1)(V1)(V1)(Y1) to L_{A}195-(V156)(V156)(V156)(V156)( V156)(Y50), having the structure | 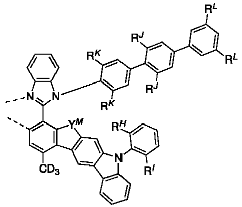 | L_{A}196-(R*^{H}*)(R*^{I}*)(R*^{J}*)(R*^{K}*)(R*^{L}*)(Y*^{M}*), wherein L_{A}196-(V2)(V1)(V1)(V1)(V1)(Y1) to L_{A}196-(V156)(V156)(V156)(V156)( V156)(Y50), having the structure | 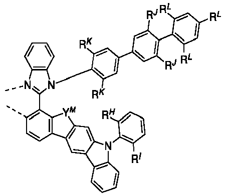 |
| L_{A}197-(R*^{H}*)(R*^{I}*)(R*^{J}*)(R*^{K}*)(R*^{L}*)(Y*^{M}*), wherein L_{A}197-(V2)(V1)(V1)(V1)(V1)(Y1) to L_{A}197-(V156)(V156)(V156)(V156)( V156)(Y50), having the structure | 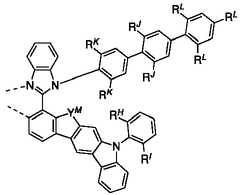 | L_{A}198-(R*^{H}*)(R*^{I}*)(R*^{J}*)(R*^{K}*)(R*^{L}*)(Y*^{M}*), wherein L_{A}198-(V2)(V1)(V1)(V1)(V1)(Y1) to L_{A}198-(V156)(V156)(V156)(V156)( V156)(Y50), having the structure | 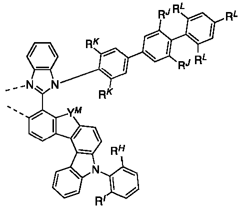 |
| L_{A}199-(R*^{H}*)(R*^{I}*)(R*^{J}*)(R*^{K}*)(R*^{L}*)(Y*^{M}*), wherein L_{A}199-(V2)(V1)(V1)(V1)(V1)(Y1) to L_{A}199-(V156)(V156)(V156)(V156)( V156)(Y50), having the structure | 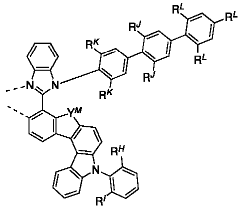 | L_{A}200-(R*^{H}*)(R*^{I}*)(R*^{J}*)(R*^{K}*)(R*^{L}*)(Y*^{M}*), wherein L_{A}200-(V2)(V1)(V1)(V1)(V1)(Y1) to L_{A}200-(V156)(V156)(V156)(V156)( V156)(Y50), having the structure | 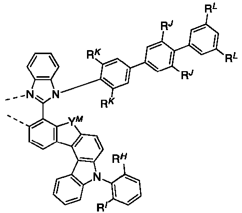 |
| L_{A}201-(R*^{H}*)(R*^{I}*)(R*^{J}*)(R*^{K}*)(R*^{L}*)(Y*^{M}*), wherein L_{A}201-(V2)(V1)(V1)(V1)(V1)(Y1) to L_{A}201-(V156)(V156)(V156)(V156)( V156)(Y50), having the structure | 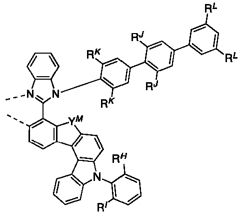 | L_{A}202-(R*^{H}*)(R*^{I}*)(R*^{J}*)(R*^{K}*)(R*^{L}*)(Y*^{M}*), wherein L_{A}202-(V2)(V1)(V1)(V1)(V1)(Y1) to L_{A}202-(V156)(V156)(V156)(V156)( V156)(Y50), having the structure | 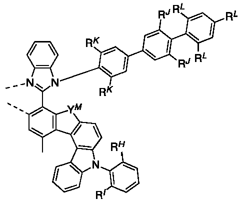 |
| L_{A}203-(R*^{H}*)(R*^{I}*)(R*^{J}*)(R*^{K}*)(R*^{L}*)(Y*^{M}*), wherein L_{A}203-(V2)(V1)(V1)(V1)(V1)(Y1) to L_{A}203-(V156)(V156)(V156)(V156)( V156)(Y50), having the structure | 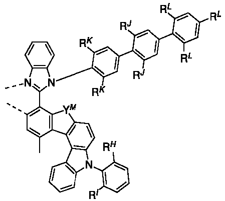 | L_{A}204-(R*^{H}*)(R*^{I}*)(R*^{J}*)(R*^{K}*)(R*^{L}*)(Y*^{M}*), wherein L_{A}204-(V2)(V1)(V1)(V1)(V1)(Y1) to L_{A}204-(V156)(V156)(V156)(V156)( V156)(Y50), having the structure | 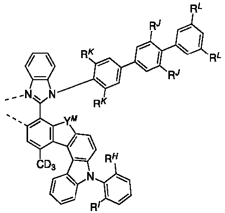 |
| L_{A}205-(R*^{H}*)(R*^{I}*)(R*^{J}*)(R*^{K}*)(R*^{L}*)(Y*^{M}*), wherein L_{A}205-(V2)(V1)(V1)(V1)(V1)(Y1) to L_{A}205-(V156)(V156)(V156)(V156)( V156)(Y50), having the structure | 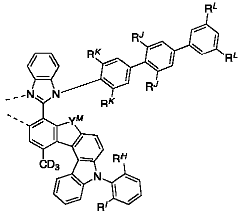 | L_{A}206-(R*^{H}*)(R*^{I}*)(R*^{J}*)(R*^{K}*)(R*^{L}*)(Y*^{M}*), wherein L_{A}206-(V2)(V1)(V1)(V1)(V1)(Y1) to L_{A}206-(V156)(V156)(V156)(V156)( V156)(Y50), having the structure | 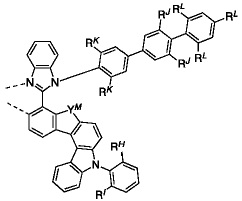 |
| L_{A}207-(R*^{H}*)(R*^{I}*)(R*^{J}*)(R*^{K}*)(R*^{L}*)(Y*^{M}*), wherein L_{A}207-(V2)(V1)(V1)(V1)(V1)(Y1) to L_{A}207-(V156)(V156)(V156)(V156)( V156)(Y50), having the structure | 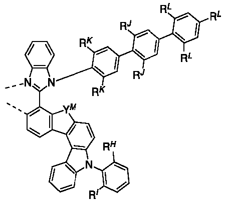 | L_{A}208-(R*^{H}*)(R*^{I}*)(R*^{J}*)(R*^{K}*)(R*^{L}*)(Y*^{M}*), wherein L_{A}208-(V2)(V1)(V1)(V1)(V1)(Y1) to L_{A}208-(V156)(V156)(V156)(V156)( V156)(Y50), having the structure | 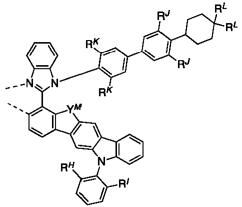 |
| L_{A}209-(R*^{H}*)(R*^{I}*)(R*^{J}*)(R*^{K}*)(R*^{L}*)(Y*^{M}*), wherein L_{A}209-(V2)(V1)(V1)(V1)(V1)(Y1) to L_{A}209-(V156)(V156)(V156)(V156)( V156)(Y50), having the structure | 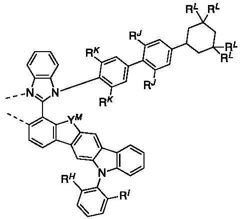 | L_{A}210-(R*^{H}*)(R*^{I}*)(R*^{J}*)(R*^{K}*)(R*^{L}*)(Y*^{M}*), wherein L_{A}210-(V2)(V1)(V1)(V1)(V1)(Y1) to L_{A}210-(V156)(V156)(V156)(V156)( V156)(Y50), having the structure | 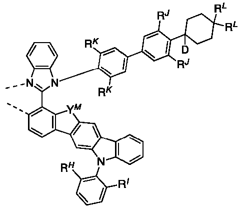 |
| L_{A}211-(R*^{H}*)(R*^{I}*)(R*^{J}*)(R*^{K}*)(R*^{L}*)(Y*^{M}*), wherein L_{A}211-(V2)(V1)(V1)(V1)(V1)(Y1) to L_{A}211-(V156)(V156)(V156)(V156)( V156)(Y50), having the structure | 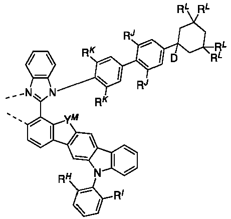 | L_{A}212-(R*^{H}*)(R*^{I}*)(R*^{J}*)(R*^{K}*)(R*^{L}*)(Y*^{M}*), wherein L_{A}212-(V2)(V1)(V1)(V1)(V1)(Y1) to L_{A}212-(V156)(V156)(V156)(V156)( V156)(Y50), having the structure | 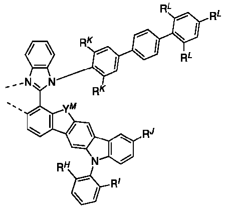 |
| L_{A}213-(R*^{H}*)(R*^{I}*)(R*^{J}*)(R*^{K}*)(R*^{L}*)(Y*^{M}*), wherein L_{A}213-(V2)(V1)(V1)(V1)(V1)(Y1) to L_{A}213-(V156)(V156)(V156)(V156)( V156)(Y50), having the structure | 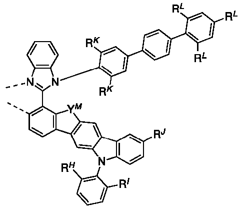 | L_{A}214-(R*^{H}*)(R*^{I}*)(R*^{J}*)(R*^{K}*)(R*^{L}*)(Y*^{M}*), wherein L_{A}214-(V2)(V1)(V1)(V1)(V1)(Y1) to L_{A}214-(V156)(V156)(V156)(V156)( V156)(Y50), having the structure | 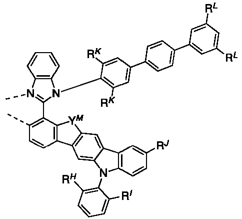 |
| L_{A}215-(R*^{H}*)(R*^{I}*)(R*^{J}*)(R*^{K}*)(R*^{L}*)(Y*^{M}*), wherein L_{A}215-(V2)(V1)(V1)(V1)(V1)(Y1) to L_{A}215-(V156)(V156)(V156)(V156)( V156)(Y50), having the structure | 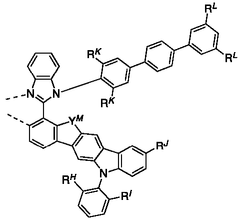 | L_{A}216-(R*^{H}*)(R*^{I}*)(R*^{J}*)(R*^{K}*)(R*^{L}*)(Y*^{M}*), wherein L_{A}216-(V2)(V1)(V1)(V1)(V1)(Y1) to L_{A}216-(V156)(V156)(V156)(V156)( V156)(Y50), having the structure | 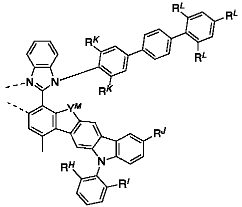 |
| L_{A}217-(R*^{H}*)(R*^{I}*)(R*^{J}*)(R*^{K}*)(R*^{L}*)(Y*^{M}*), wherein L_{A}217-(V2)(V1)(V1)(V1)(V1)(Y1) to L_{A}217-(V156)(V156)(V156)(V156)( V156)(Y50), having the structure | 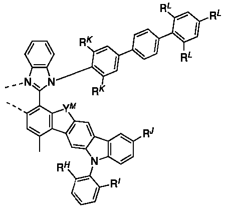 | L_{A}217-(R*^{H}*)(R*^{I}*)(R*^{J}*)(R*^{K}*)(R*^{L}*)(Y*^{M}*), wherein L_{A}217-(V2)(V1)(V1)(V1)(V1)(Y1) to L_{A}217-(V156)(V156)(V156)(V156)( V156)(Y50), having the structure | 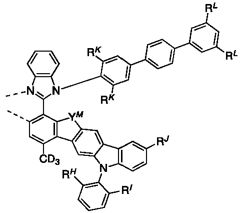 |
| L_{A}218-(R*^{H}*)(R*^{I}*)(R*^{J}*)(R*^{K}*)(R*^{L}*)(Y*^{M}*), wherein L_{A}218-(V2)(V1)(V1)(V1)(V1)(Y1) to L_{A}218-(V156)(V156)(V156)(V156)( V156)(Y50), having the structure | 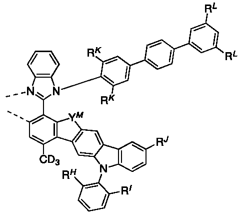 | L_{A}219-(R*^{H}*)(R*^{I}*)(R*^{J}*)(R*^{K}*)(R*^{L}*)(Y*^{M}*), wherein L_{A}219-(V2)(V1)(V1)(V1)(V1)(Y1) to L_{A}219-(V156)(V156)(V156)(V156)( V156)(Y50), having the structure | 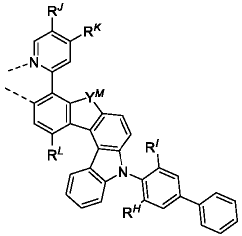 |
| L_{A}220-(R*^{H}*)(R*^{I}*)(R*^{J}*)(R*^{K}*)(R*^{L}*)(Y*^{M}*), wherein L_{A}220-(V2)(V1)(V1)(V1)(V1)(Y1) to L_{A}220-(V156)(V156)(V156)(V156)( V156)(Y50), having the structure | 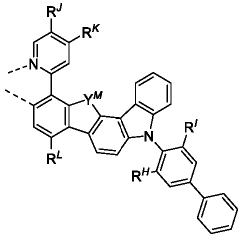 | L_{A}221-(R*^{H}*)(R*^{I}*)(R*^{J}*)(R*^{K}*)(R*^{L}*)(Y*^{M}*), wherein L_{A}221-(V2)(V1)(V1)(V1)(V1)(Y1) to L_{A}221-(V156)(V156)(V156)(V156)( V156)(Y50), having the structure | 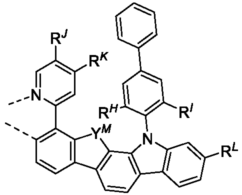 |
| L_{A}222-(R*^{H}*)(R*^{I}*)(R*^{J}*)(R*^{K}*)(R*^{L}*)(Y*^{M}*), wherein L_{A}222-(V2)(V1)(V1)(V1)(V1)(Y1) to L_{A}222-(V156)(V156)(V156)(V156)( V156)(Y50), having the structure | 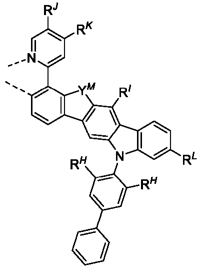 | L_{A}223-(R*^{H}*)(R*^{I}*)(R*^{J}*)(R*^{K}*)(R*^{L}*)(Y*^{M}*), wherein L_{A}223-(V2)(V1)(V1)(V1)(V1)(Y1) to L_{A}223-(V156)(V156)(V156)(V156)( V156)(Y50), having the structure | 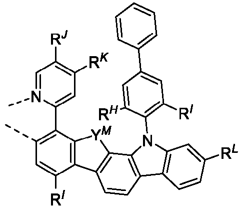 |
| L_{A}224-(R*^{H}*)(R*^{I}*)(R*^{J}*)(R*^{K}*)(R*^{L}*)(Y*^{M}*), wherein L_{A}224-(V2)(V1)(V1)(V1)(V1)(Y1) to L_{A}224-(V156)(V156)(V156)(V156)( V156)(Y50), having the structure | 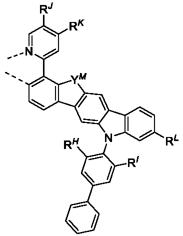 | L_{A}225-(R*^{H}*)(R*^{I}*)(R*^{J}*)(R*^{K}*)(R*^{L}*)(Y*^{M}*), wherein L_{A}225-(V2)(V1)(V1)(V1)(V1)(Y1) to L_{A}225-(V156)(V156)(V156)(V156)( V156)(Y50), having the structure | 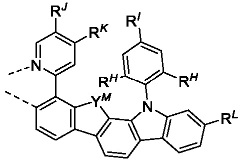 |
| L_{A}226-(R*^{H}*)(R*^{I}*)(R*^{J}*)(R*^{K}*)(R*^{L}*)(Y*^{M}*), wherein L_{A}226-(V2)(V1)(V1)(V1)(V1)(Y1) to L_{A}226-(V156)(V156)(V156)(V156)( V156)(Y50), having the structure | 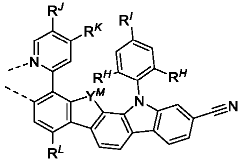 | L_{A}227-(R*^{H}*)(R*^{I}*)(R*^{J}*)(R*^{K}*)(R*^{L}*)(Y*^{M}*), wherein L_{A}227-(V2)(V1)(V1)(V1)(V1)(Y1) to L_{A}227-(V156)(V156)(V156)(V156)( V156)(Y50), having the structure | 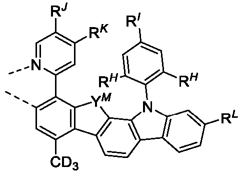 |
| L_{A}228-(R*^{H}*)(R*^{I}*)(R*^{J}*)(R*^{K}*)(R*^{L}*)(Y*^{M}*), wherein L_{A}228-(V2)(V1)(V1)(V1)(V1)(Y1) to L_{A}228-(V156)(V156)(V156)(V156)( V156)(Y50), having the structure | 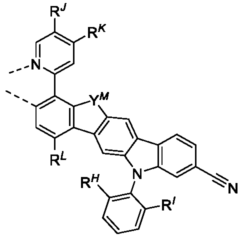 | L_{A}229-(R*^{H}*)(R*^{I}*)(R*^{J}*)(R*^{K}*)(R*^{L}*)(Y*^{M}*), wherein L_{A}229-(V2)(V1)(V1)(V1)(V1)(Y1) to L_{A}229-(V156)(V156)(V156)(V156)( V156)(Y50), having the structure | 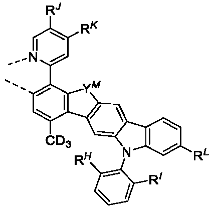 |
| L_{A}230-(R*^{H}*)(R*^{I}*)(R*^{J}*)(R*^{K}*)(R*^{L}*)(Y*^{M}*), wherein L_{A}230-(V2)(V1)(V1)(V1)(V1)(Y1) to L_{A}230-(V156)(V156)(V156)(V156)( V156)(Y50), having the structure | 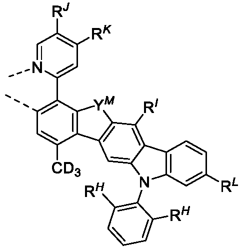 | L_{A}231-(R*^{H}*)(R*^{I}*)(R*^{J}*)(R*^{K}*)(R*^{L}*)(Y*^{M}*), wherein L_{A}231-(V2)(V1)(V1)(V1)(V1)(Y1) to L_{A}231-(V156)(V156)(V156)(V156)( V156)(Y50), having the structure | 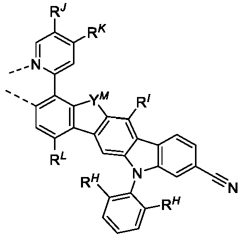 |
| L_{A}232-(R*^{H}*)(R*^{I}*)(R*^{J}*)(R*^{K}*)(R*^{L}*)(Y*^{M}*), wherein L_{A}232-(V2)(V1)(V1)(V1)(V1)(Y1) to L_{A}232-(V156)(V156)(V156)(V156)( V156)(Y50), having the structure | 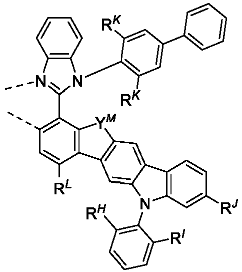 | L_{A}233-(R*^{H}*)(R*^{I}*)(R*^{J}*)(R*^{K}*)(R*^{L}*)(Y*^{M}*), wherein L_{A}233-(V2)(V1)(V1)(V1)(V1)(Y1) to L_{A}233-(V156)(V156)(V156)(V156)( V156)(Y50), having the structure | 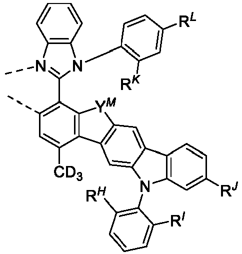 |
| L_{A}234-(R*^{H}*)(R*^{I}*)(R*^{J}*)(R*^{K}*)(R*^{L}*)(Y*^{M}*), wherein L_{A}234-(V2)(V1)(V1)(V1)(V1)(Y1) to L_{A}234-(V156)(V156)(V156)(V156)( V156)(Y50), having the structure | 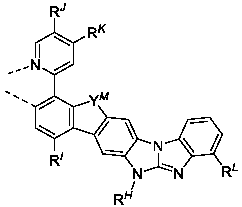 | L_{A}235-(R*^{H}*)(R*^{I}*)(R*^{J}*)(R*^{K}*)(R*^{L}*)(Y*^{M}*), wherein L_{A}235-(V2)(V1)(V1)(V1)(V1)(Y1) to L_{A}235-(V156)(V156)(V156)(V156)( V156)(Y50), having the structure | 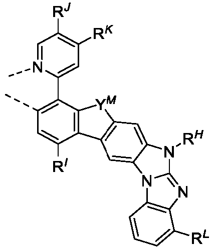 |
| L_{A}236-(R*^{H}*)(R*^{I}*)(R*^{J}*)(R*^{K}*)(R*^{L}*)(Y*^{M}*), wherein L_{A}2360-(V2)(V1)(V1)(V1)(V1)(Y1) to L_{A}236-(V156)(V156)(V156)(V156)( V156)(Y50), having the structure | 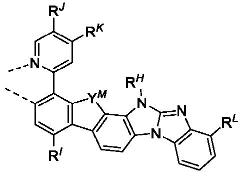 | L_{A}237-(R*^{H}*)(R*^{I}*)(R*^{J}*)(R*^{K}*)(R*^{L}*)(Y*^{M}*), wherein L_{A}237-(V2)(V1)(V1)(V1)(V1)(Y1) to L_{A}237-(V156)(V156)(V156)(V156)( V156)(Y50), having the structure | 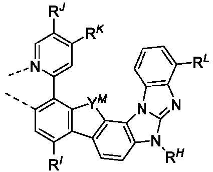 |
| L_{A}238-(R*^{H}*)(R*^{I}*)(R*^{J}*)(R*^{K}*)(R*^{L}*)(Y*^{M}*), wherein L_{A}238-(V2)(V1)(V1)(V1)(V1)(Y1) to L_{A}238-(V156)(V156)(V156)(V156)( V156)(Y50), having the structure | 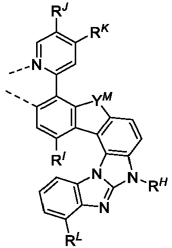 | L_{A}239-(R*^{H}*)(R*^{I}*)(R*^{J}*)(R*^{K}*)(R*^{L}*)(Y*^{M}*), wherein L_{A}239-(V2)(V1)(V1)(V1)(V1)(Y1) to L_{A}239-(V156)(V156)(V156)(V156)( V156)(Y50), having the structure | 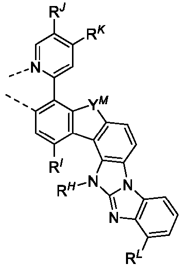 |

wherein the ligand L_{A} is selected from L_{A"*n'*}{R*^{J}*)(R*^{K}*)(R*^{L}*)(R*^{M}*)(R*^{N}*)(Y*^{M}*), wherein *n*' is an integer from 1 to 44, each of R*^{J}*, R*^{K}*, R*^{L}*, R*^{M}*, and R^{N} is independently selected from V1 to V156; Y*^{M}* is selected from Y1 to Y50; and each of L _{A"1}-(V1)(V1)(V1)(V1)(V1)(Y1) to L_{A"44}-(V156)(V156)(V156)(V156)(V156)(Y50) is defined below (LIST 8b):

| L_{A"} | Structure of L_{A"} | L_{A"} | Structure of L_{A"} |
|---|---|---|---|
| L_{A"1}(R^{J})(R^{K})(R^{L})(R^{M})(R^{N})(Y ^{M}), wherein L_{A"1}(V1)(V1)(V1)(V1)(V1)( Y1) to L_{A"1}(V156)(V156)(V156)(V1 56)(V156)(Y50) have the structure | 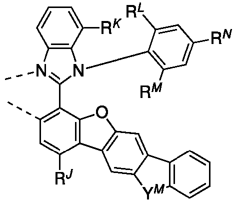 | L_{A"2}(R^{J})(R^{K})(R^{L})(R^{M})(R^{N})(Y ^{M}), wherein L_{A"2}(V1)(V1)(V1)(V1)(V1)( Y1) to L_{A"2}(V156)(V156)(V156)(V1 56)(V156)(Y50) have the structure | 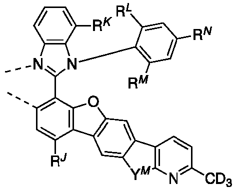 |
| L_{A"3}(R^{J})(R^{K})(R^{L})(R^{M})(R^{N})(Y ^{M}), wherein L_{A"3}(V1)(V1)(V1)(V1)(V1)( Y1) to L_{A"3}(V156)(V156)(V156)(V1 56)(V156)(Y50) have the structure | 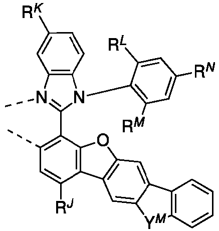 | L_{A"4}(R^{J})(R^{K})(R^{L})(R^{M})(R^{N})(Y ^{M}), wherein L_{A"4}(V1)(V1)(V1)(V1)(V1)( Y1) to L_{A"4}(V156)(V156)(V156)(V1 56)(V156)(Y50) have the structure | 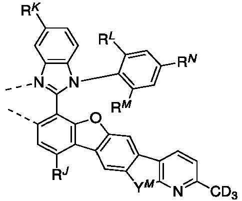 |
| L_{A"5}(R^{J})(R^{K})(R^{L})(R^{M})(R^{N})(Y ^{M}), wherein L_{A"5}(V1)(V1)(V1)(V1)(V1)( Y1) to L_{A"5}(V156)(V156)(V156)(V1 56)(V156)(Y50) have the structure | 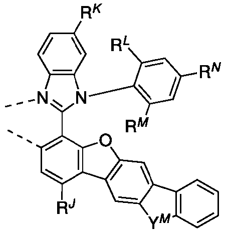 | L_{A"6}(R^{J})(R^{K})(R^{L})(R^{M})(R^{N})(Y ^{M}), wherein L_{A"6}(V1)(V1)(V1)(V1)(V1)( Y1) to L_{A"6}(V156)(V156)(V156)(V1 56)(V156)(Y50) have the structure | 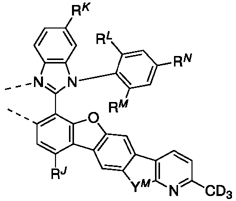 |
| L_{A"7}(R^{J})(R^{K})(R^{L})(R^{M})(R^{N})(Y ^{M}), wherein L_{A"7}(V1)(V1)(V1)(V1)(V1)( Y1) to L_{A"7}(V156)(V156)(V156)(V1 56)(V156)(Y50) have the structure | 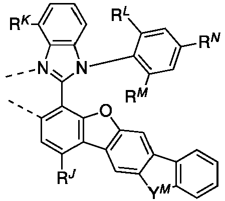 | L_{A"8}(R^{J})(R^{K})(R^{L})(R^{M})(R^{N})(Y ^{M}), wherein L_{A"8}(V1)(V1)(V1)(V1)(V1)( Y1) to L_{A"8}(V156)(V156)(V156)(V1 56)(V156)(Y50) have the structure | 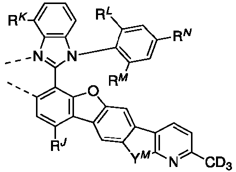 |
| L_{A"9}(R^{J})(R^{K})(R^{L})(R^{M})(R^{N})(Y ^{M}), wherein L_{A"9}(V1)(V1)(V1)(V1)(V1)( Y1) to L_{A"9}(V156)(V156)(V156)(V1 56)(V156)(Y50) have the structure | 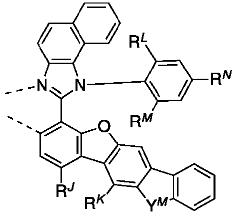 | L_{A"10}(R^{J})(R^{K})(R^{L})(R^{M})(R^{N})(Y ^{M}), wherein L_{A"10}(V1)(V1)(V1)(V1)(V1)( Y1) to L_{A"10}(V156)(V156)(V156)(V 156)(V156)(Y50) have the structure | 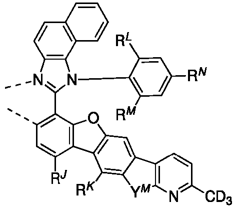 |
| L_{A"11}(R^{J})(R^{K})(R^{L})(R^{M})(R^{N})(Y ^{M}), wherein L_{A"11}(V1)(V1)(V1)(V1)(V1)( Y1) to L_{A"11}(V156)(V156)(V156)(V 156)(V156)(Y50) have the structure | 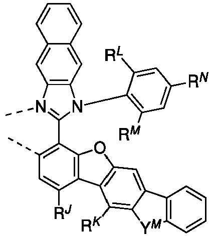 | L_{A"12}(R^{J})(R^{K})(R^{L})(R^{M})(R^{N})(Y ^{M}), wherein L_{A"12}(V1)(V1)(V1)(V1)(V1)( Y1) to L_{A"12}(V156)(V156)(V156)(V 156)(V156)(Y50) have the structure | 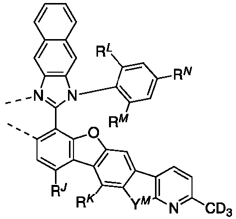 |
| L_{A"13}(R^{J})(R^{K})(R^{L})(R^{M})(R^{N})(Y ^{M}), wherein L_{A"13}(V1)(V1)(V1)(V1)(V1)( Y1) to L_{A"13}(V156)(V156)(V156)(V 156)(V156)(Y50) have the structure | 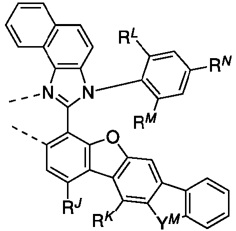 | L_{A"14}(R^{J})(R^{K})(R^{L})(R^{M})(R^{N})(Y ^{M}), wherein L_{A"14}(V1)(V1)(V1)(V1)(V1)( Y1) to L_{A"14}(V156)(V156)(V156)(V 156)(V156)(Y50) have the structure | 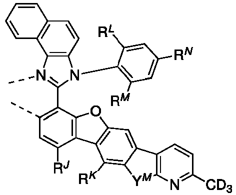 |
| L_{A"15}(R^{J})(R^{K})(R^{L})(R^{M})(R^{N})(Y ^{M}), wherein L_{A"15}(V1)(V1)(V1)(V1)(V1)( Y1) to L_{A"15}(V156)(V156)(V156)(V 156)(V156)(Y50) have the structure | 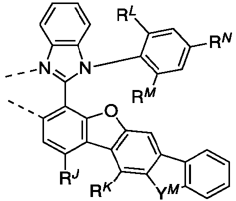 | L_{A"16}(R^{J})(R^{K})(R^{L})(R^{M})(R^{N})(Y ^{M}), wherein L_{A"16}(V1)(V1)(V1)(V1)(V1)( Y1) to L_{A"16}(V156)(V156)(V156)(V 156)(V156)(Y50) have the structure | 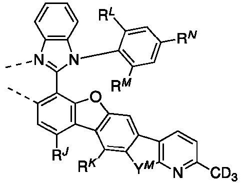 |
| L_{A"17}(R^{J})(R^{K})(R^{L})(R^{M})(R^{N})(Y ^{M}), wherein L_{A"17}(V1)(V1)(V1)(V1)(V1)( Y1) to L_{A"17}(V156)(V1 56)(V1 56)(V 156)(V156)(Y50) have the structure | 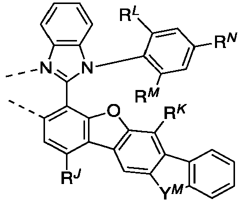 | L_{A"18}(R^{J})(R^{K})(R^{L})(R^{M})(R^{N})(Y ^{M}), wherein L_{A"18}(V1)(V1)(V1)(V1)(V1)( Y1) to L_{A"18}(V156)(V156)(V156)(V 156)(V156)(Y50) have the structure | 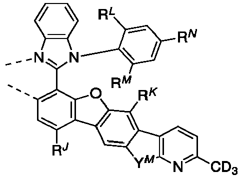 |
| L_{A"19}(R^{J})(R^{K})(R^{L})(R^{M})(R^{N})(Y ^{M}), wherein L_{A"19}(V1)(V1)(V1)(V1)(V1)( Y1) to L_{A"19}(V156)(V156)(V156)(V 156)(V156)(Y50) have the structure | 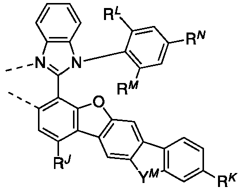 | L_{A"20}(R^{J})(R^{K})(R^{L})(R^{M})(R^{N})(Y ^{M}), wherein L_{A"20}(V1)(V1)(V1)(V1)(V1)( Y1) to L_{A"20}(V156)(V156)(V156)(V 156)(V156)(Y50) have the structure | 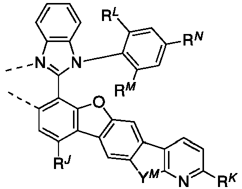 |
| L_{A"21}(R^{J})(R^{K})(R^{L})(R^{M})(R^{N})(Y ^{M}), wherein L_{A"21}(V1)(V1)(V1)(V1)(V1)( Y1) to L_{A"21}(V156)(V1 56)(V1 56)(V 156)(V156)(Y50) have the structure | 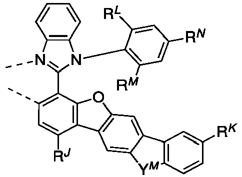 | L_{A"22}(R^{J})(R^{K})(R^{L})(R^{M})(R^{N})(Y ^{M}), wherein L_{A"22}(V1)(V1)(V1)(V1)(V1)( Y1) to L_{A"22}(V156)(V156)(V156)(V 156)(V156)(Y50) have the structure | 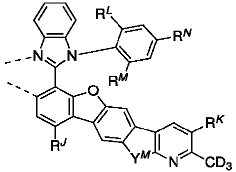 |
| L_{A"23}(R^{J})(R^{K})(R^{L})(R^{M})(R^{N})(Y ^{M}), wherein L_{A"23}(V1)(V1)(V1)(V1)(V1)( Y1) to L_{A"23}(V156)(V156)(V156)(V 156)(V156)(Y50) have the structure | 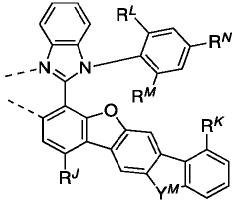 | L_{A"24}(R^{J})(R^{K})(R^{L})(R^{M})(R^{N})(Y ^{M}), wherein L_{A"24}(V1)(V1)(V1)(V1)(V1)( Y1) to L_{A"24}(V156)(V156)(V156)(V 156)(V156)(Y50)have the structure | 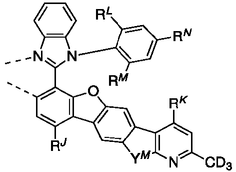 |
| L_{A"25}(R^{J})(R^{K})(R^{L})(R^{M})(R^{N})(Y ^{M}), wherein L_{A"25}(V1)(V1)(V1)(V1)(V1)( Y1) to L_{A"25}(V156)(V156)(V156)(V 156)(V156)(Y50) have the structure | 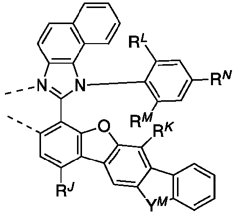 | L_{A"26}(R^{J})(R^{K})(R^{L})(R^{M})(R^{N})(Y ^{M}), wherein L_{A"26}(V1)(V1)(V1)(V1)(V1)( Y1) to L_{A"26}(V156)(V156)(V156)(V 156)(V156)(Y50) have the structure | 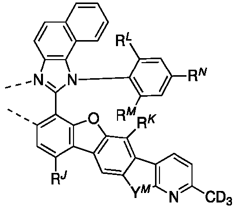 |
| L_{A"27}(R^{J})(R^{K})(R^{L})(R^{M})(R^{N})(Y ^{M}), wherein L_{A"27}(V1)(V1)(V1)(V1)(V1)( Y1) to L_{A"27}(V156)(V156)(V156)(V 156)(V156)(Y50) have the structure | 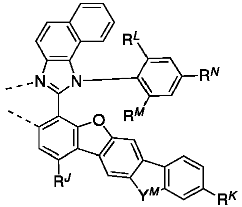 | L_{A"28}(R^{J})(R^{K})(R^{L})(R^{M})(R^{N})(Y ^{M}), wherein L_{A"28}(V1)(V1)(V1)(V1)(V1)( Y1) to L_{A"28}(V156)(V156)(V156)(V 156)(V156)(Y50) have the structure | 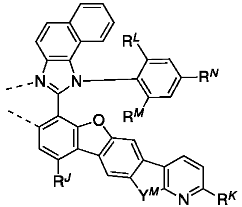 |
| L_{A"29}(R^{J})(R^{K})(R^{L})(R^{M})(R^{N})(Y ^{M}), wherein L_{A"29}(V1)(V1)(V1)(V1)(V1)( Y1) to L_{A"29}(V156)(V156)(V156)(V 156)(V156)(Y50) have the structure | 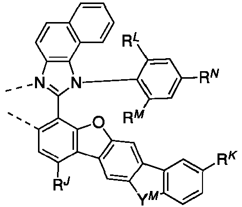 | L_{A"30}(R^{J})(R^{K})(R^{L})(R^{M})(R^{N})(Y ^{M}), wherein L_{A"30}(V1)(V1)(V1)(V1)(V1)( Y1) to L_{A"30}(V156)(V156)(V156)(V 156)(V156)(Y50) have the structure | 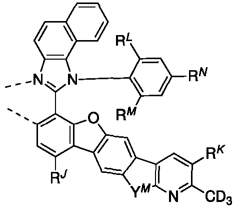 |
| L_{A"31}(R^{J})(R^{K})(R^{L})(R^{M})(R^{N})(Y ^{M}), wherein L_{A"31}(V1)(V1)(V1)(V1)(V1)( Y1) to L_{A"31}(V156)(V156)(V156)(V 156)(V156)(Y50) have the structure | 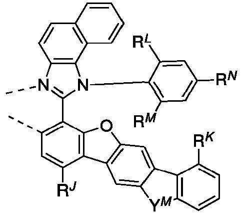 | L_{A"32}(R^{J})(R^{K})(R^{L})(R^{M})(R^{N})(Y ^{M}), wherein L_{A"32}(V1)(V1)(V1)(V1)(V1)( Y1) to L_{A"32}(V156)(V156)(V156)(V 156)(V156)(Y50) have the structure | 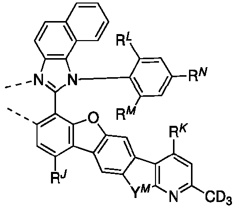 |
| L_{A"33}(R^{J})(R^{K})(R^{L})(R^{M})(R^{N})(Y ^{M}), wherein L_{A"33}(V1)(V1)(V1)(V1)(V1)( Y1) to L_{A"33}(V156)(V156)(V156)(V 156)(V156)(Y50) have the structure | 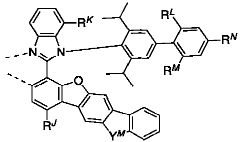 | L_{A"34}(R^{J})(R^{K})(R^{L})(R^{M})(R^{N})(Y ^{M}), wherein L_{A"34}(V1)(V1)(V1)(V1)(V1)( Y1) to L_{A"34}(V156)(V156)(V156)(V 156)(V156)(Y50) have the structure | 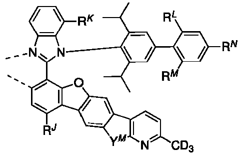 |
| L_{A"35}(R^{J})(R^{K})(R^{L})(R^{M})(R^{N})(Y ^{M}), wherein L_{A"35}(V1)(V1)(V1)(V1)(V1)( Y1) to L_{A"35}(V156)(V156)(V156)(V 156)(V156)(Y50) have the structure | 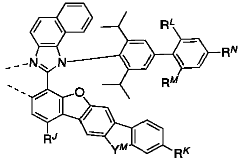 | L_{A"36}(R^{J})(R^{K})(R^{L})(R^{M})(R^{N})(Y ^{M}), wherein L_{A"36}(V1)(V1)(V1)(V1)(V1)( Y1) to L_{A"36}(V156)(V156)(V156)(V 156)(V156)(Y50) have the structure | 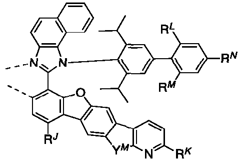 |
| L_{A"37}(R^{J})(R^{K})(R^{L})(R^{M})(R^{N})(Y ^{M}), wherein L_{A"37}(V1)(V1)(V1)(V1)(V1)( Y1) to L_{A"37}(V156)(V156)(V156)(V 156XV156)(Y50) have the structure | 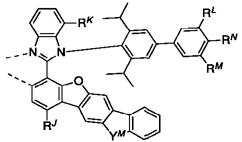 | L_{A"38}(R^{J})(R^{K})(R^{L})(R^{M})(R^{N})(Y ^{M}), wherein L_{A"38}(V1)(V1)(V1)(V1)(V1)( Y1) to L_{A"38}(V156)(V156)(V156)(V 156)(V156)(Y50) have the structure | 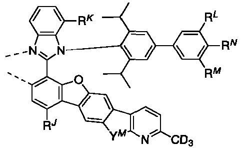 |
| L_{A"39}(R^{J})(R^{K})(R^{L})(R^{M})(R^{N})(Y ^{M}), wherein L_{A"39}(V1)(V1)(V1)(V1)(V1)( Y1) to L_{A"39}(V156)(V156)(V156)(V 156)(V156)(Y50) have the structure | 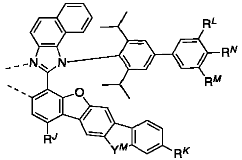 | L_{A"40}(R^{J})(R^{K})(R^{L})(R^{M})(R^{N})(Y ^{M}), wherein L_{A"40}(V1)(V1)(V1)(V1)(V1)( Y1) to L_{A"40}(V156)(V156)(V156)(V 156)(V156)(Y50) have the structure | 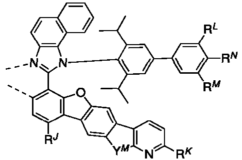 |
| L_{A"41}(R^{J})(R^{K})(R^{L})(R^{M})(R^{N})(Y ^{M}), wherein L_{A"41}(V1)(V1)(V1)(V1)(V1)( Y1) to L_{A"41}(V156)(V156)(V156)(V 156)(V156)(Y50) have the structure | 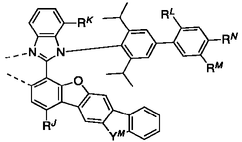 | L_{A"42}(R^{J})(R^{K})(R^{L})(R^{M})(R^{N})(Y ^{M}), wherein L_{A"42}(V1)(V1)(V1)(V1)(V1)( Y1) to L_{A"42}(V156)(V156)(V156)(V 156)(V156)(Y50) have the structure | 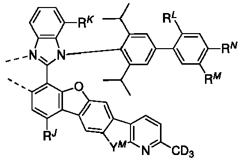 |
| L_{A"43}(R^{J})(R^{K})(R^{L})(R^{M})(R^{N})(Y ^{M}), wherein L_{A"43}(V1)(V1)(V1)(V1)(V1)( Y1) to L_{A"43}(V156)(V156)(V156)(V 156)(V156)(Y50) have the structure | 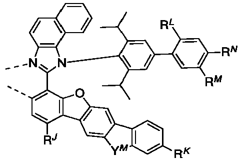 | L_{A"44}(R^{J})(R^{K})(R^{L})(R^{M})(R^{N})(Y ^{M}), wherein L_{A"44}(V1)(V1)(V1)(V1)(V1)( Y1) to L_{A"44}(V156)(V156)(V156)(V 156)(V156)(Y50) have the structure | 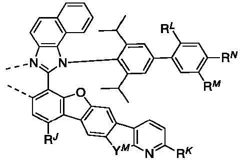 |

wherein V1 to V156 have the following structures as defined in the following LIST 9: 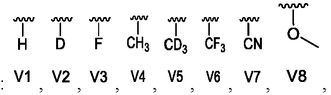 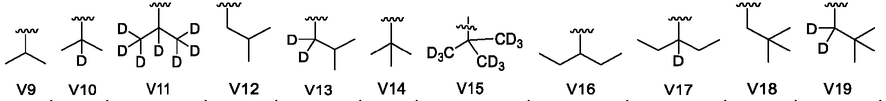 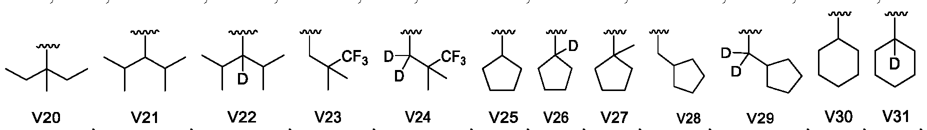 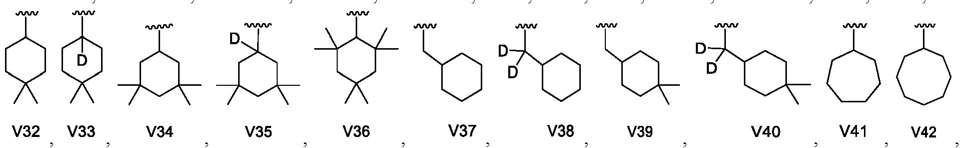 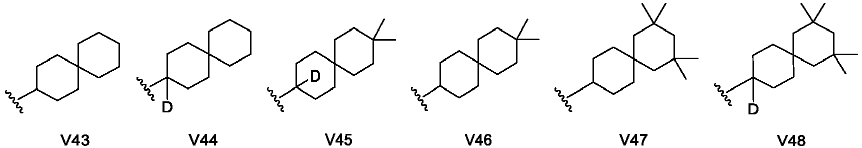 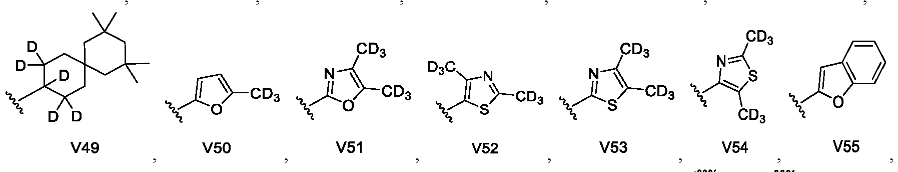 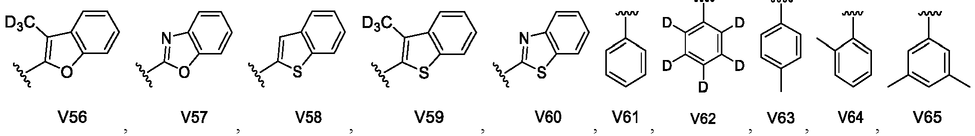 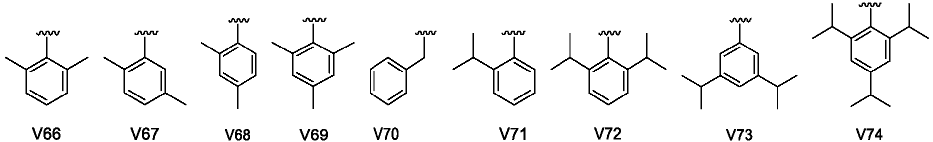 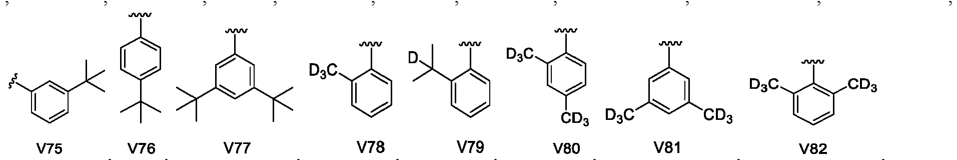 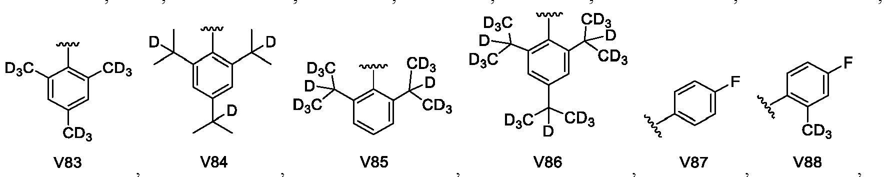 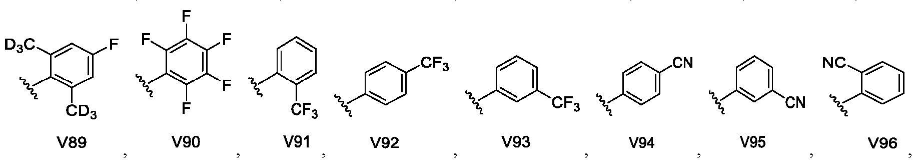 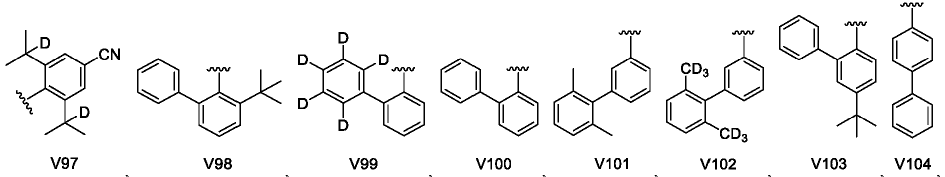 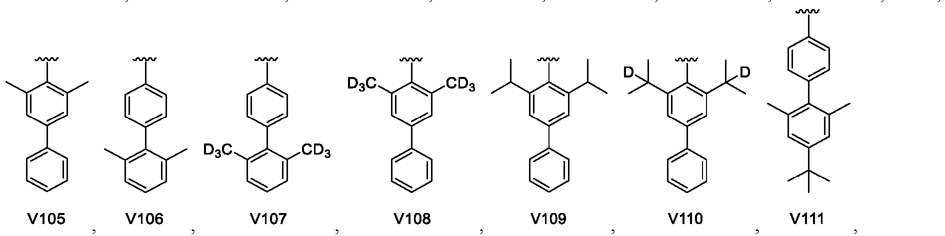 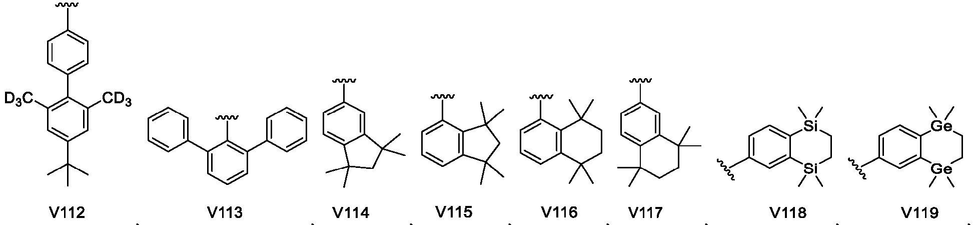 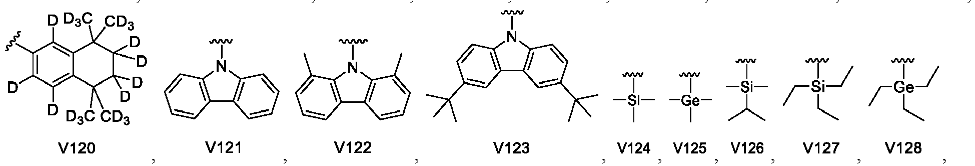 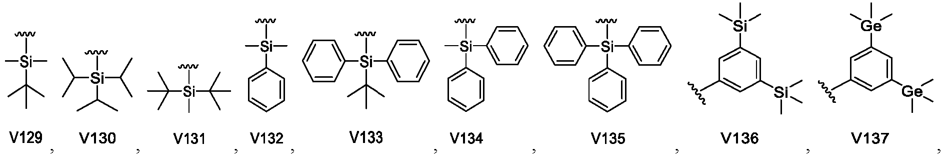 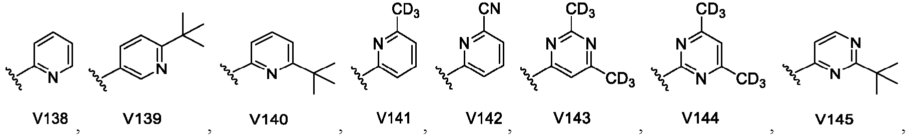 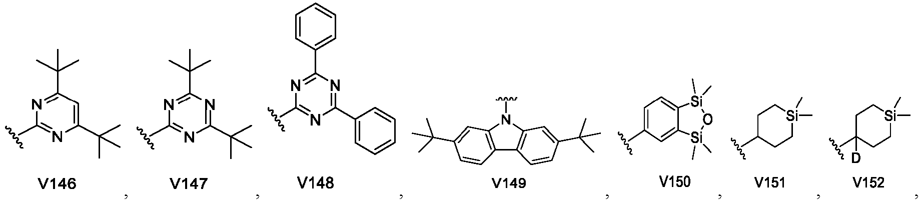 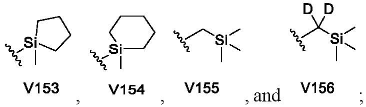 and
wherein Y1 to Y50 have the structures defined in the following LIST 10:

| | Structure | | Structure | | Structure |
|---|---|---|---|---|---|
| Y1 | 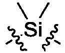 | Y2 | 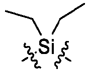 | Y3 | 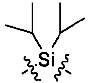 |
| Y4 | 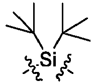 | Y5 | 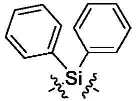 | Y6 | 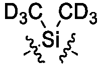 |
| Y7 | 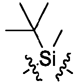 | Y8 | 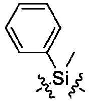 | Y9 | 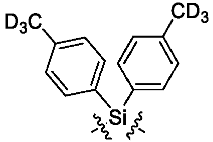 |
| Y10 | 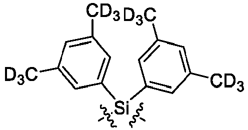 | Y11 | 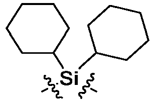 | Y12 | 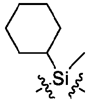 |
| Y13 | 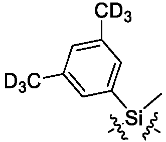 | Y14 | 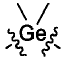 | Y15 | 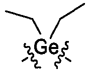 |
| Y16 | 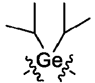 | Y17 | 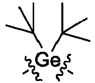 | Y18 | 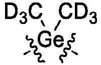 |
| Y19 | 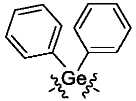 | Y20 | 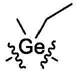 | Y21 | 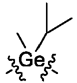 |
| Y22 | 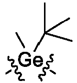 | Y23 | 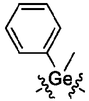 | Y24 | 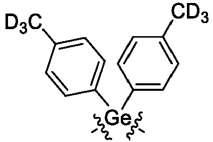 |
| Y25 | 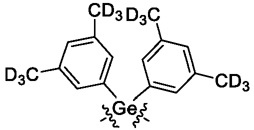 | Y26 | 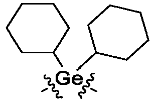 | Y27 | 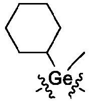 |
| Y28 | 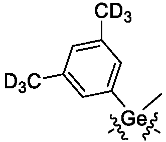 | Y29 | 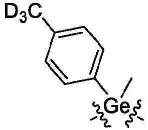 | Y30 | 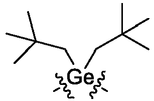 |
| Y31 | 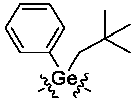 | Y32 | 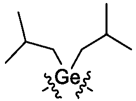 | Y33 | 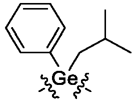 |
| Y34 | 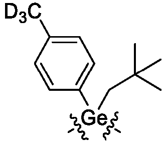 | Y35 | 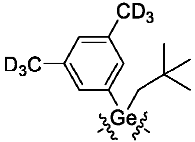 | Y36 | 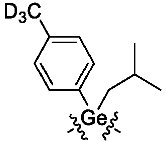 |
| Y37 | 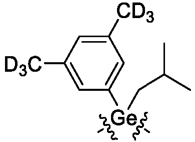 | Y38 | 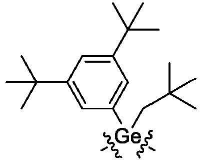 | Y39 | 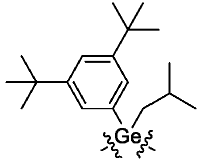 |
| Y40 | 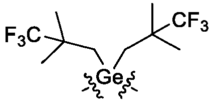 | Y41 | 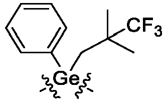 | Y42 | 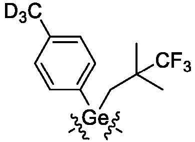 |
| Y43 | 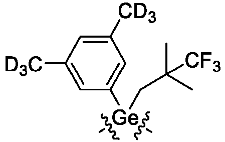 | Y44 | 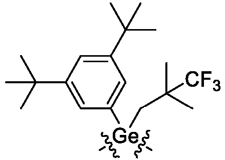 | Y45 | 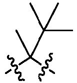 |
| Y46 | 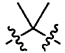 | Y47 | 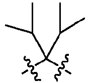 | Y48 | 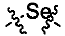 |
| Y49 | 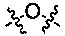 | Y50 | 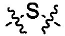 | | |

In some embodiments, the compound has a formula of M(L_{A})ₚ(L_{B})_{q}(L_{C})ᵣ wherein L_{B} and L_{C} are each a bidentate ligand, and wherein p is 1, 2, or 3; q is 0, 1, or 2; r is 0, 1, or 2; and p+q+r is the oxidation state of the metal M.

In some embodiments, the compound has a formula selected from the group consisting of Ir(L_{A})₃, Ir(L_{A})(L_{B})₂, Ir(L_{A})₂(L_{B}), Ir(L_{A})₂(L_{C}), and Ir(L_{A})(L_{B})(L_{C}); and wherein L_{A}, L_{B}, and L_{C} are different from each other.

In some embodiments, L_{B} comprises an electron-withdrawing group from the EWG1 LIST as defined herein. In some embodiments, L_{B} comprises an electron-withdrawing group from the EWG2 LIST as defined herein. In some embodiments, L_{B} comprises an electron-withdrawing group from the EWG3 LIST as defined herein. In some embodiments, L_{B} comprises an electron-withdrawing group from the EWG4 LIST as defined herein. In some embodiments, L_{B} comprises an electron-withdrawing group from the Pi-EWG LIST as defined herein.

In some embodiments, L_{C} comprises an electron-withdrawing group from the EWG1 LIST as defined herein. In some embodiments, L_{C} comprises an electron-withdrawing group from the EWG2 LIST as defined herein. In some embodiments, L_{C} comprises an electron-withdrawing group from the EWG3 LIST as defined herein. In some embodiments, L_{C} comprises an electron-withdrawing group from the EWG4 LIST as defined herein. In some embodiments, L_{C} comprises an electron-withdrawing group from the Pi-EWG LIST as defined herein.

In some embodiments, L_{B} is a substituted or unsubstituted phenylpyridine, and L_{C} is a substituted or unsubstituted acetylacetonate.

In some embodiments, the compound has a formula of Pt(L_{A})(L_{B}); and wherein L_{A} and L_{B} can be same or different. In some embodiments, L_{A} and L_{B} are connected to form a tetradentate ligand.

In some embodiments, ligand L_{B} and L_{C} are each independently selected from the group consisting of the structures of the following LIST 11: 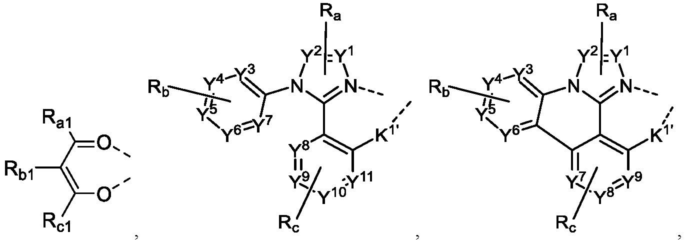 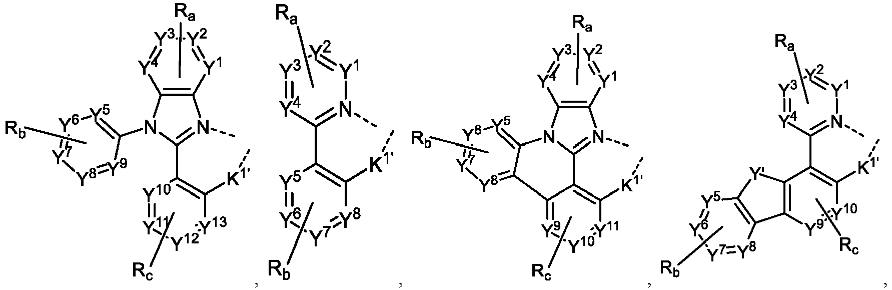 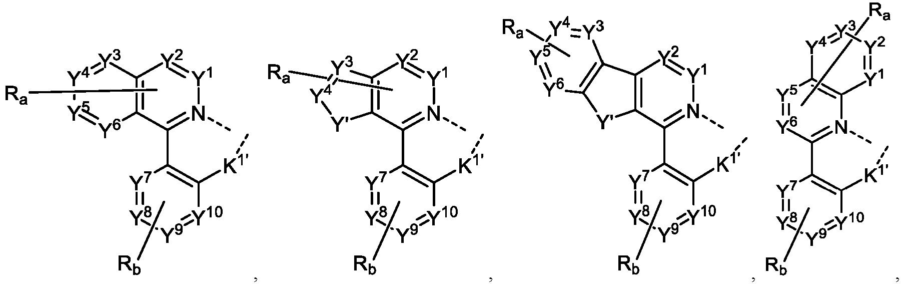 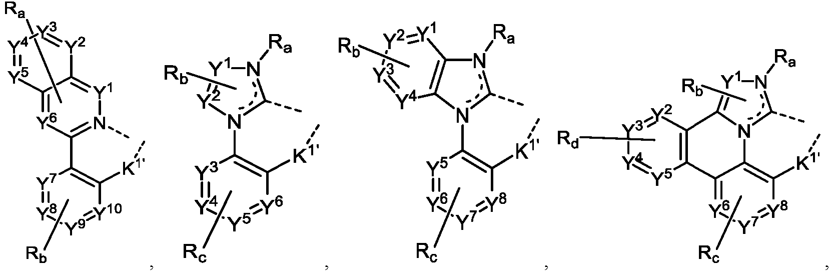 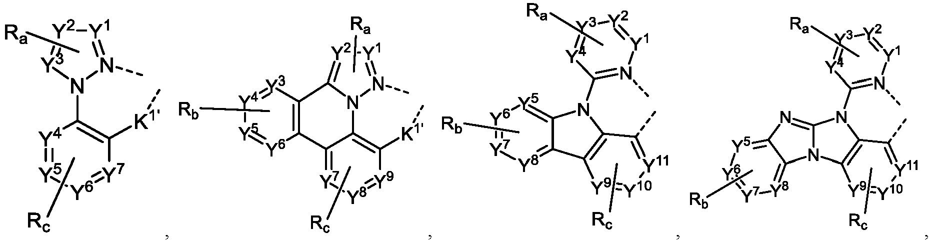 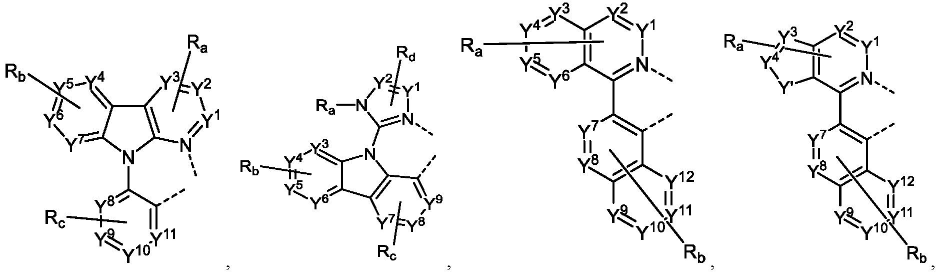 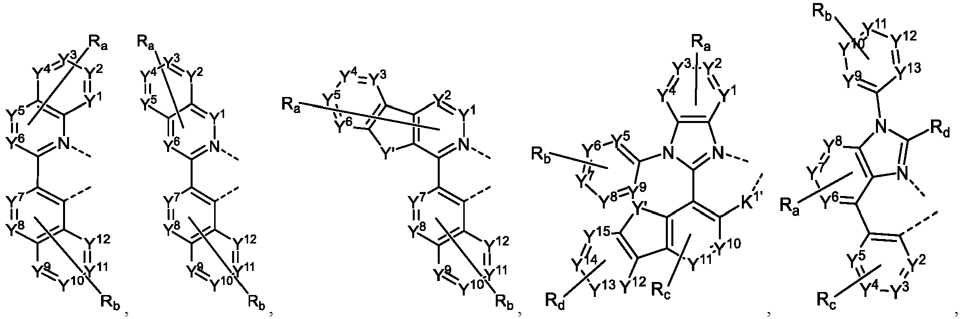 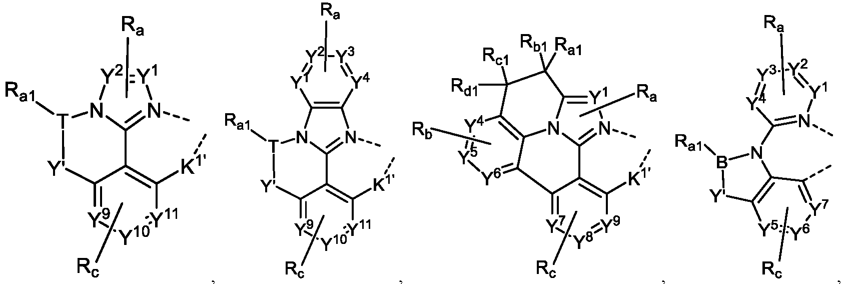 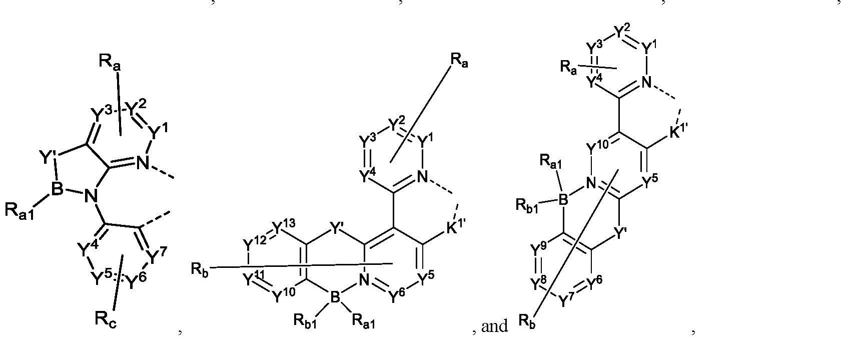 wherein:
T is selected from the group consisting of B, Al, Ga, and In;
K^{1'} is selected from the group consisting of a single bond, O, S, NRₑ, PRₑ, BRₑ, CRₑR_{f}, and SiRₑR_{f};
each of Y¹ to Y¹³ is independently selected from the group consisting of C and N;
Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} independently represents from mono to the maximum allowed number of substitutions, or no substitution;
each of Rₐ₁, R_{b1}, R_{c1}, R_{d1}, Rₐ, R_{b}, R_{c}, R_{d}, Rₑ, and R_{f} is independently a hydrogen or a subsituent selected from the group consisting of the General Substituents defined herein; and
any two substituents of Rₐ₁, R_{b1}, R_{c1}, R_{d1}, Rₐ, R_{b}, R_{c}, and R_{d} can be fused or joined to form a ring or form a multidentate ligand.

In some embodiments, ligand L_{B} and L_{C} are each independently selected from the group consisting of the structures of the following LIST 12: 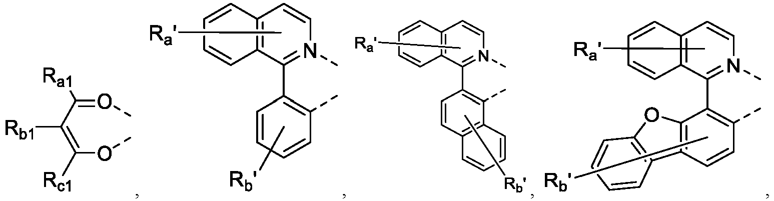 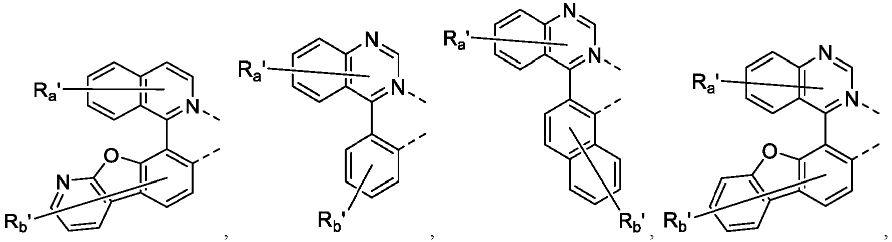 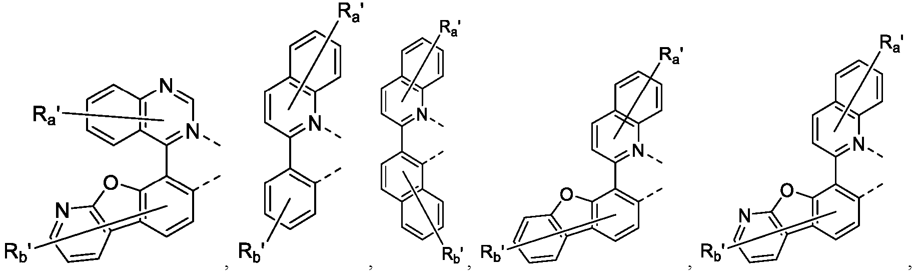 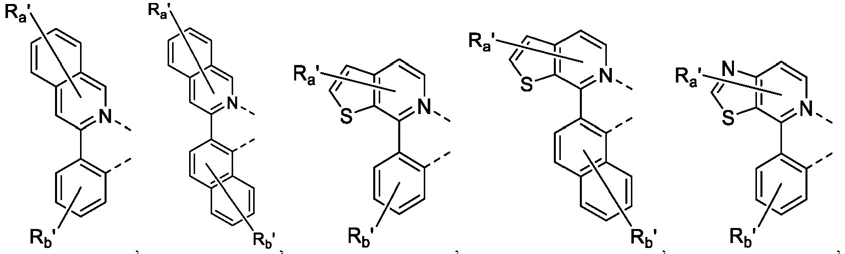 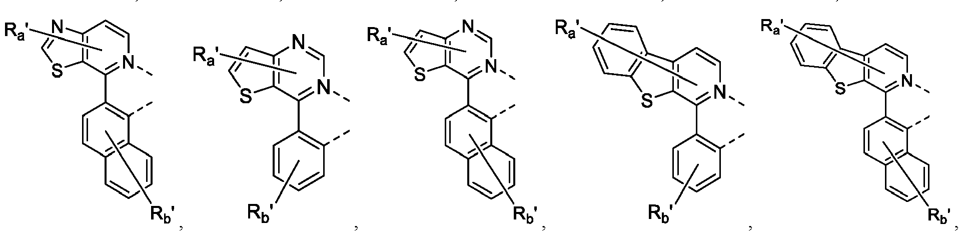 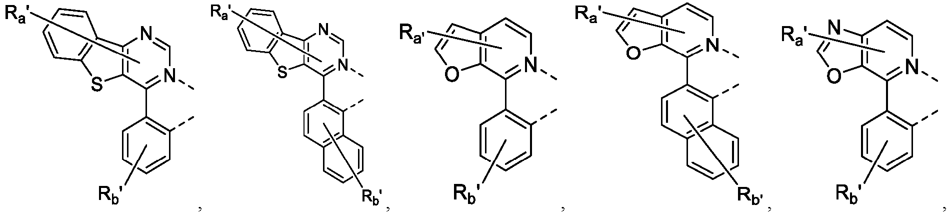 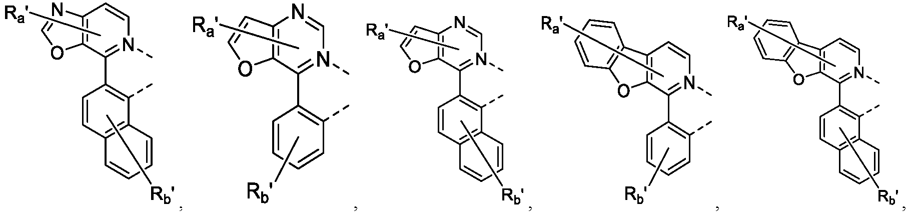 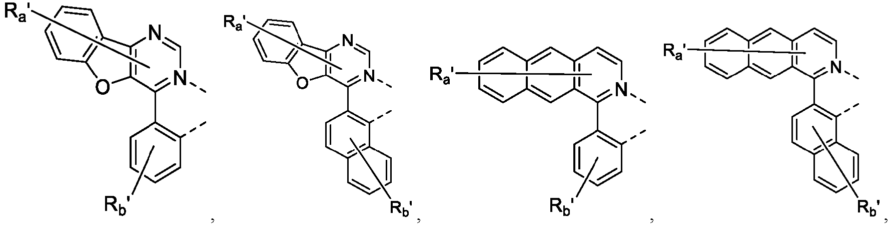 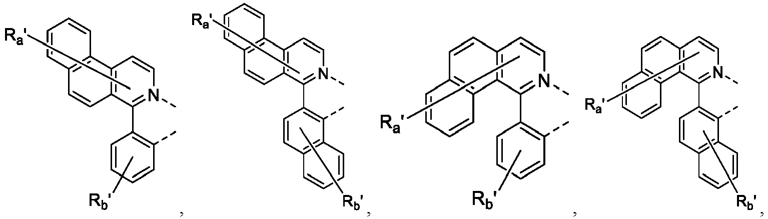 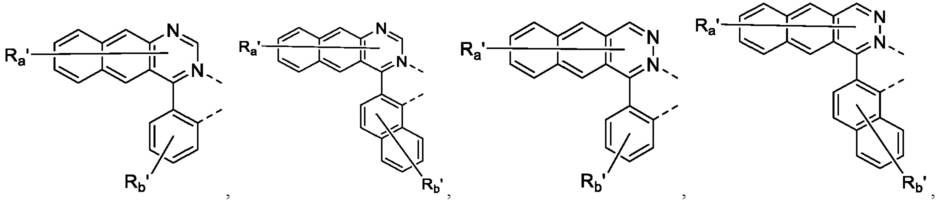 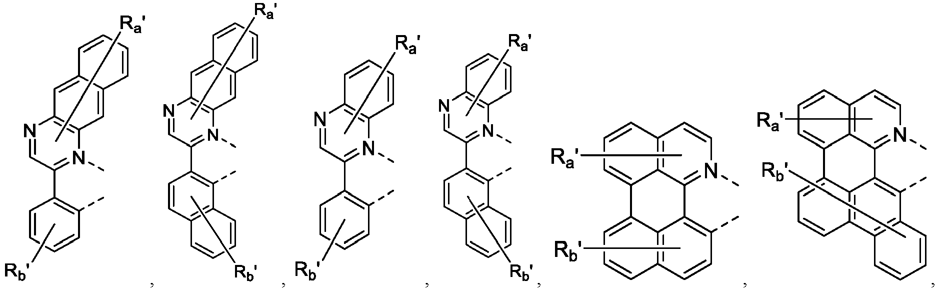 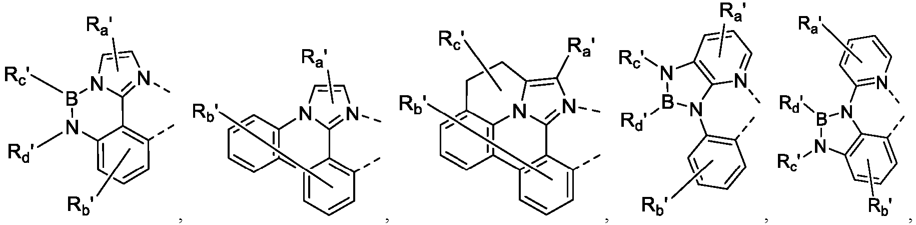 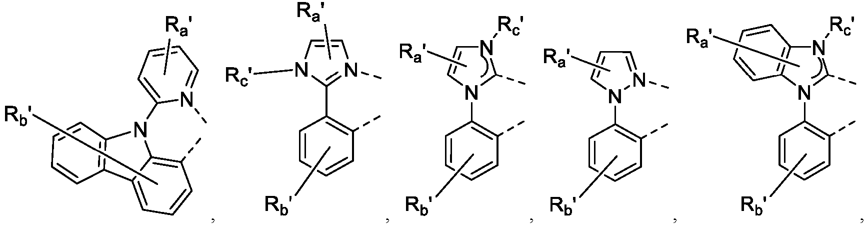 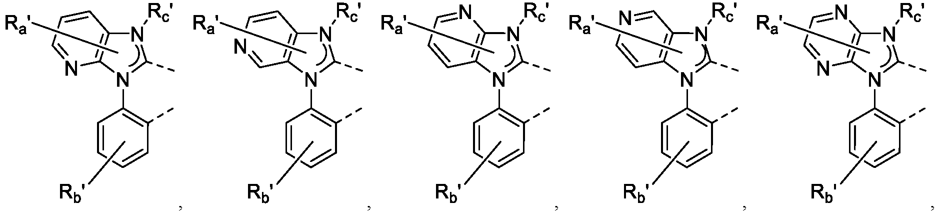 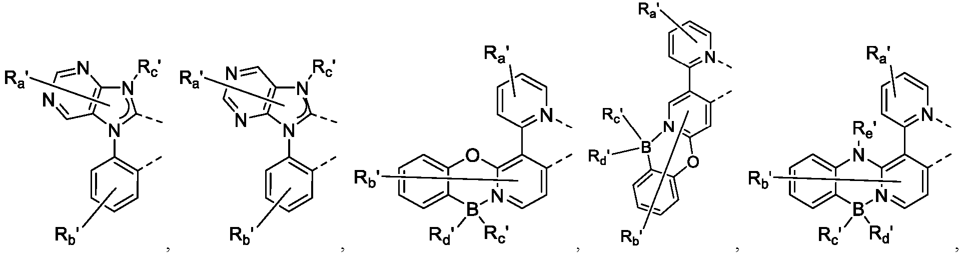 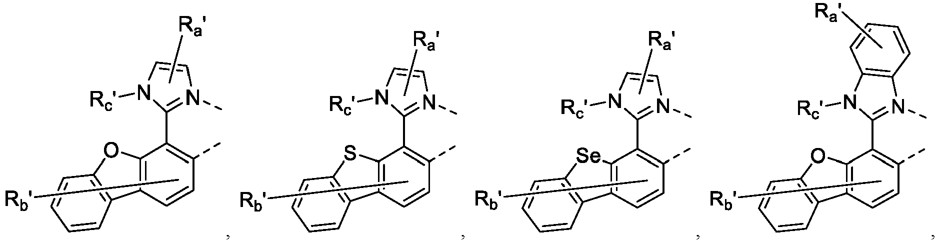 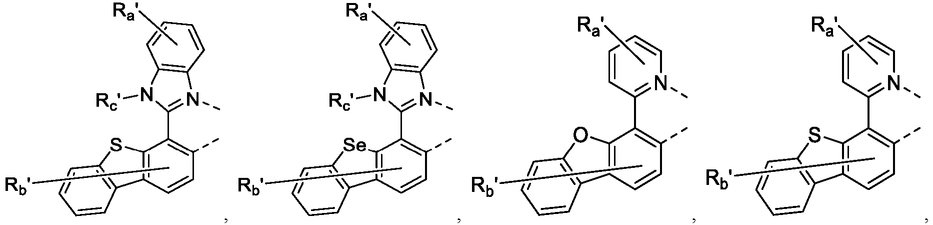 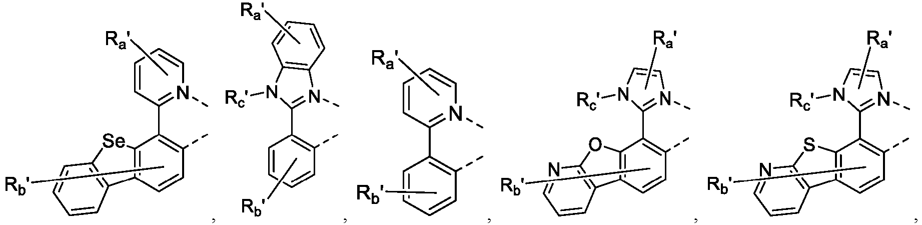 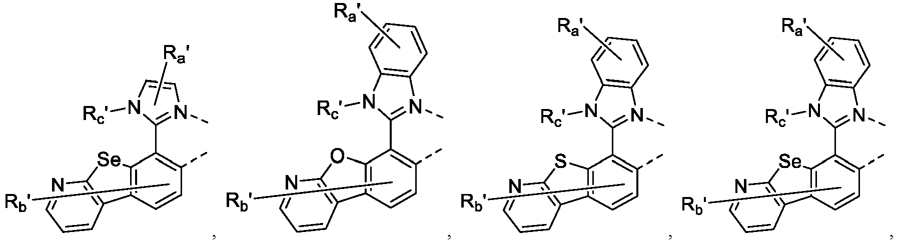 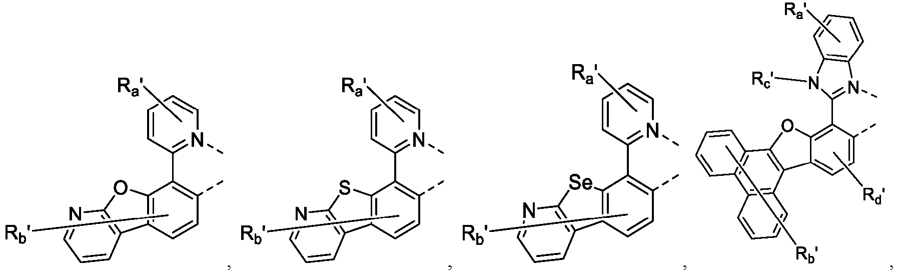 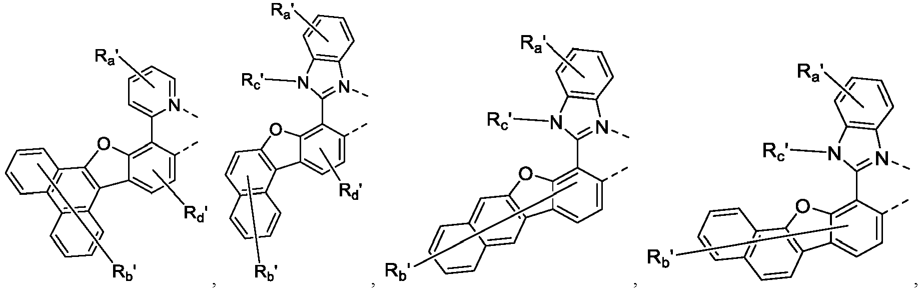 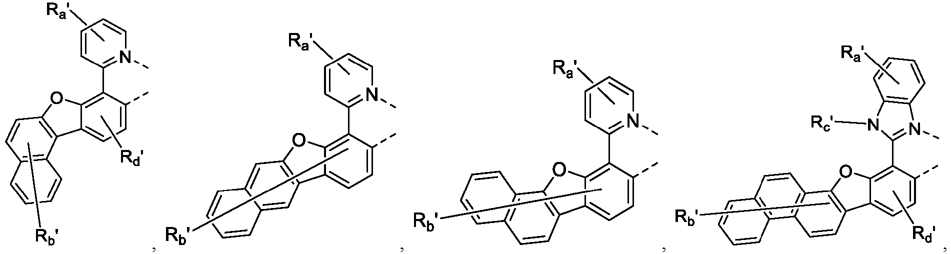 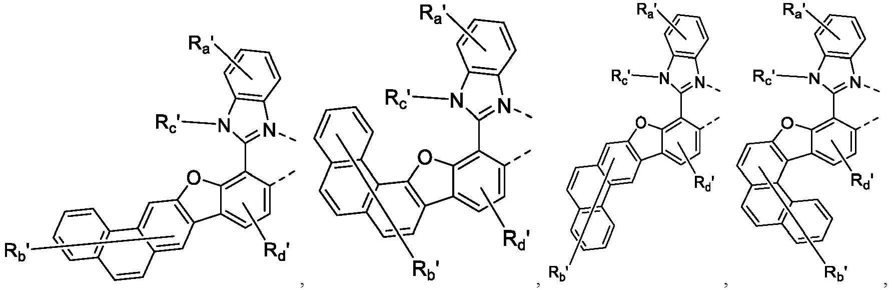 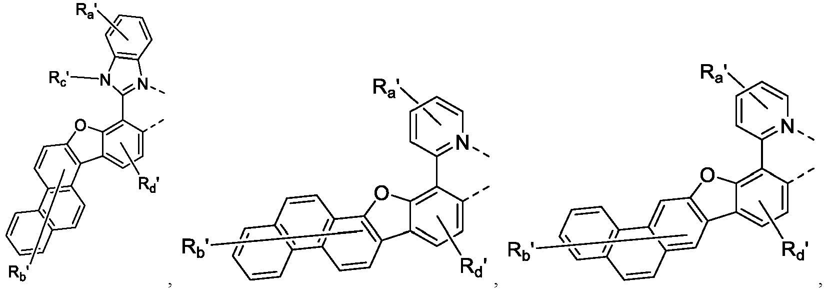 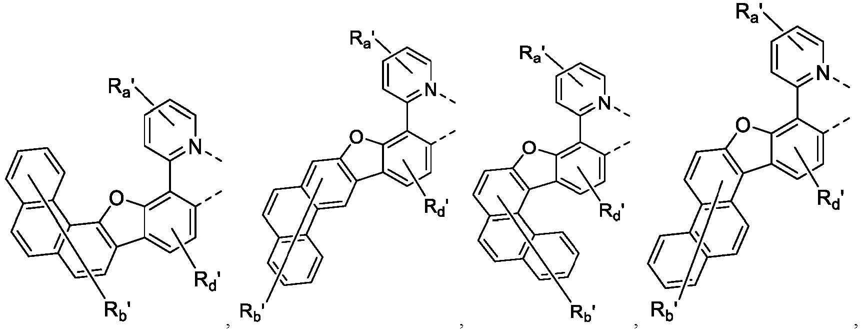 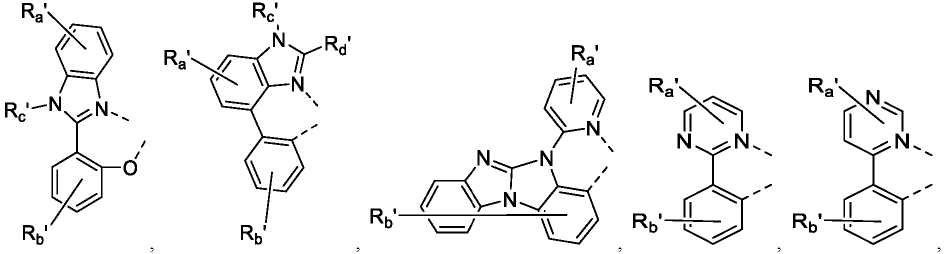 and 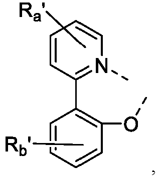 wherein:
Rₐ', R_{b}', R_{c}', R_{d}', and Rₑ' each independently represents zero, mono, or up to a maximum allowed number of substitution to its associated ring;
Rₐ', R_{b}', R_{c}', R_{d}', and Rₑ' each independently hydrogen or a substituent selected from the group consisting of the General Substituents defined herein; and
two substituents of Rₐ', R_{b}', R_{c}', R_{d}', and Rₑ' can be fused or joined to form a ring or form a multidentate ligand.

In some embodiments, L_{C} comprises a structure of 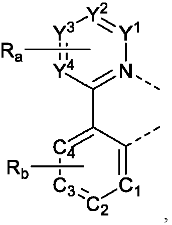 wherein the variables are the same as previously defined. In some embodiments, each of Y¹ to Y⁴ is independently carbon. In some embodiments, at least one of Y¹ to Y⁴ is N. In some embodiments, exactly one of Y¹ to Y⁴ is N. In some embodiments, Y¹ is N. In some embodiments, Y² is N. In some embodiments, Y³ is N. In some embodiments, Y⁴ is N.

In some embodiments, Y¹ is carbon and attached to Rₐ₁. In some such embodiments, Rₐ₁ may be selected from the group consisting of the General Substituents defined herein. In some such embodiments, Rₐ₁ may be selected from the group consisting of the Preferred General Substituents defined herein. In some such embodiments, Rₐ₁ is a tertiary alkyl, silyl or germyl. In some such embodiments, Rₐ₁ is a tertiary alkyl. In some embodiments, Y² is carbon and attached to Rₐ₂. In some such embodiments, Rₐ₂ may be selected from the group consisting of the General Substituents defined herein. In some such embodiments, Rₐ₂ may be selected from the group consisting of the Preferred General Substituents defined herein. In some such embodiments, Rₐ₂ is a tertiary alkyl, silyl or germyl. In some such embodiments, Rₐ₂ is a tertiary alkyl. In some embodiments, Y³ is carbon and attached to Rₐ₃. In some such embodiments, Rₐ₃ may be selected from the group consisting of the General Substituents defined herein. In some such embodiments, Rₐ₃ may be selected from the group consisting of the Preferred General Substituents defined herein. In some such embodiments, Rₐ₃ is a tertiary alkyl, silyl or germyl. In some such embodiments, Rₐ₃ is a tertiary alkyl. In some embodiments, Y⁴ is carbon and attached to Rₐ₄. In some such embodiments, Rₐ₄ may be selected from the group consisting of the General Substituents defined herein. In some such embodiments, Rₐ₄ may be selected from the group consisting of the Preferred General Substituents defined herein. In some such embodiments, Rₐ₄ is a tertiary alkyl, silyl or germyl. In some such embodiments, Rₐ₄ is a tertiary alkyl.

In some embodiments, Y¹ to Y³ is C, Y⁴ is N, and the Rₐ₃ attached to Y³ is a tertiary alkyl, silyl or germyl. In some embodiments, Y¹ to Y³ is C, Y⁴ is N, and the Rₐ₂ attached to Y² is a tertiary alkyl, silyl or germyl.

In some embodiments, at least one of R_{b} is a tertiary alkyl, silyl, or germyl. In some embodiments, the tertiary alkyl is tert-butyl. In some embodiments, at least one pair of Rₐ and R_{b} are joined or fused to form a ring.

In some embodiments, R_{b1} is attached to C1 (carbon atom). In some such embodiments, R_{b1} may be selected from the group consisting of the General Substituents defined herein. In some such embodiments, R_{b1} may be selected from the group consisting of the Preferred General Substituents defined herein. In some such embodiments, R_{b1} is a tertiary alkyl, silyl or germyl. In some such embodiments, R_{b1} is a tertiary alkyl. In some embodiments, the tertiary alkyl is *tert*-butyl. In some embodiments, R_{b2} is attached to C2 (carbon atom). In some such embodiments, R_{b2} may be selected from the group consisting of the General Substituents defined herein. In some such embodiments, R_{b2} may be selected from the group consisting of the Preferred General Substituents defined herein. In some such embodiments, R_{b2} is a tertiary alkyl, silyl or germyl. In some such embodiments, R_{b2} is a tertiary alkyl. In some embodiments, the tertiary alkyl is *tert*-butyl. In some embodiments, R_{b3} is attached to C3 (carbon atom). In some such embodiments, R_{b3} may be selected from the group consisting of the General Substituents defined herein. In some such embodiments, R_{b3} may be selected from the group consisting of the Preferred General Substituents defined herein. In some such embodiments, R_{b3} is a tertiary alkyl, silyl or germyl. In some such embodiments, R_{b3} is a tertiary alkyl. In some embodiments, the tertiary alkyl is *tert*-butyl. In some embodiments, R_{b4} is attached to C4 (carbon atom). In some such embodiments, R_{b4} may be selected from the group consisting of the General Substituents defined herein. In some such embodiments, R_{b4} may be selected from the group consisting of the Preferred General Substituents defined herein. In some such embodiments, R_{b4} is a tertiary alkyl, silyl or germyl. In some such embodiments, R_{b4} is a tertiary alkyl. In some embodiments, the tertiary alkyl is *tert*-butyl.

In some embodiments, the compound has formula Ir(L_{A})(L_{Bk})₂, formula Ir(L_{A})₂(L_{Bk}), formula Ir(L_{A})₂(L_{C}), or Ir(L_{A})(L_{Bk})(L_{C}),
wherein L_{A} is according to the structures of Formula I defined herein, including L_{A}1-(V1)(V1)(V1)(Y1)(Y1) to L_{A}34-(V156)(V156)(V156)(Y50)(Y44), L_{A}35-(V1)(V1)(V1)(Y1)(Y1) to L_{A}122-(V156)(V156)(V156)(Y50)(Y50), L_{A}123-(V1)(V1)(V1)(Y1)(Y1) to L_{A}146-(V156)(V156)(V156)(Y47)(Y50), L_{A}147-(V2)(V1)(V1)(V1)(V1)(Y1) to L_{A}239-(V156)(V156)(V156)(V156)(V156)(Y50), and L_{A"1}-(V1)(V1)(V1)(V1)(V1)(Y1) to L_{A"44}-(V156)(V156)(V156)(V156)(V156)(Y50);
wherein k is an integer from 1 to 543, and each L_{B*k*} has the structure defined in the following LIST 13: 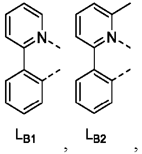 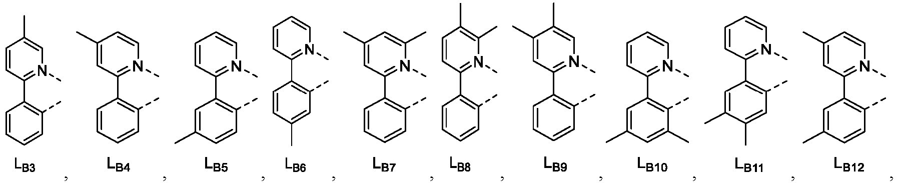 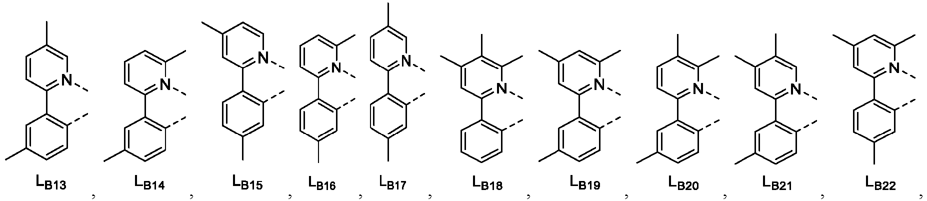 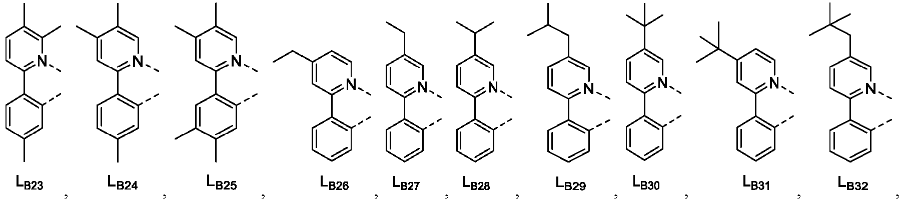 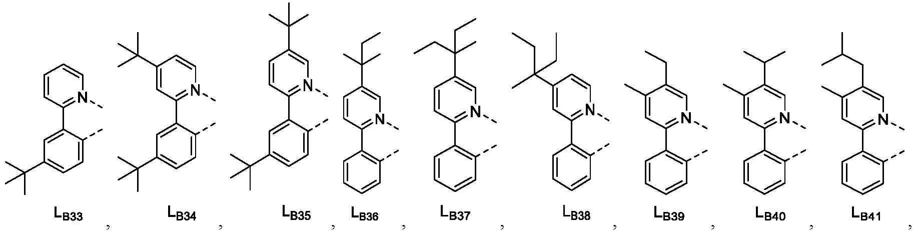 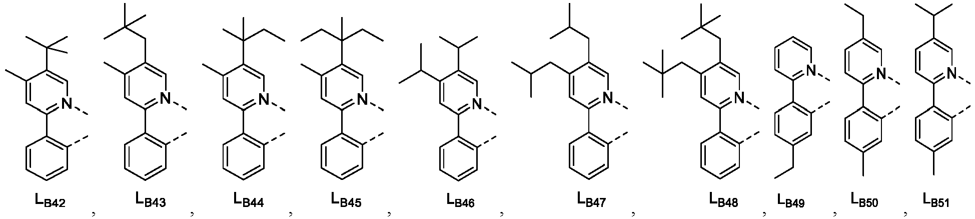 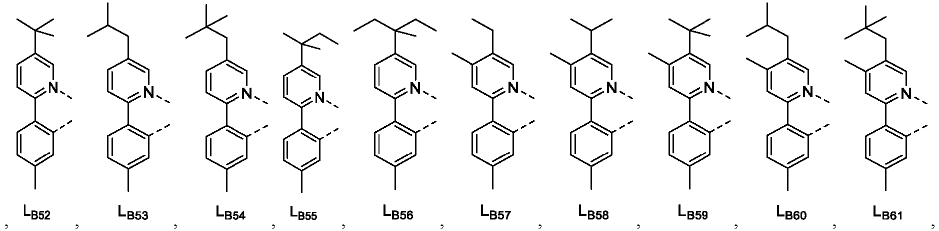 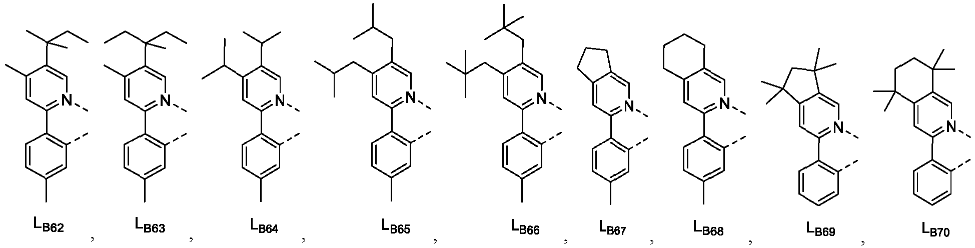 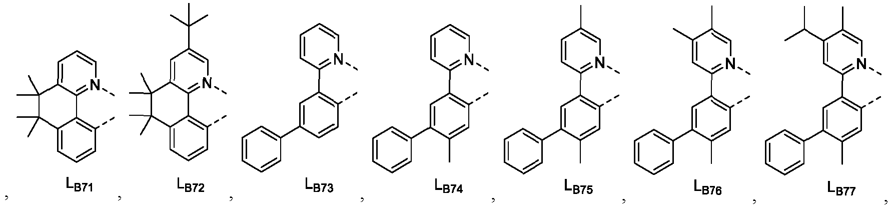 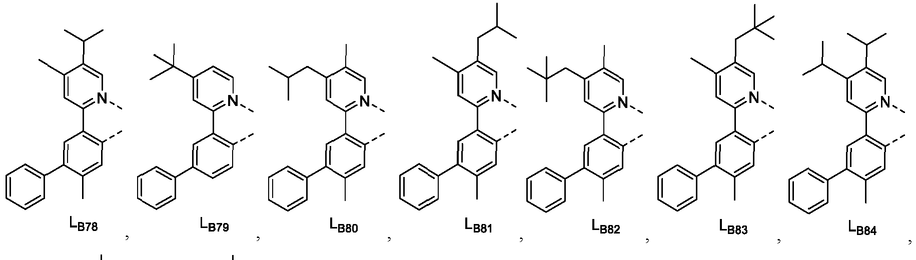 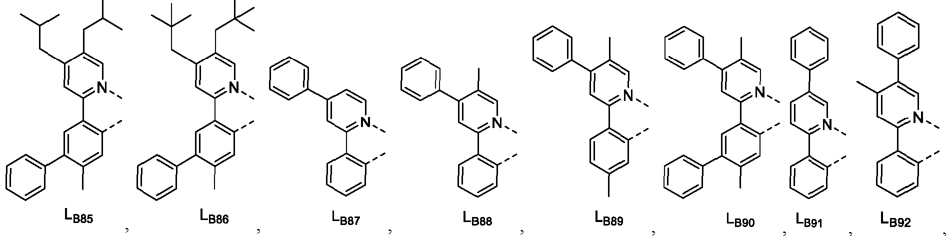 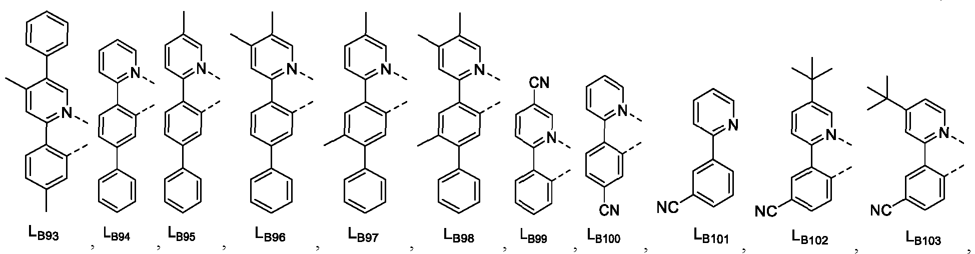 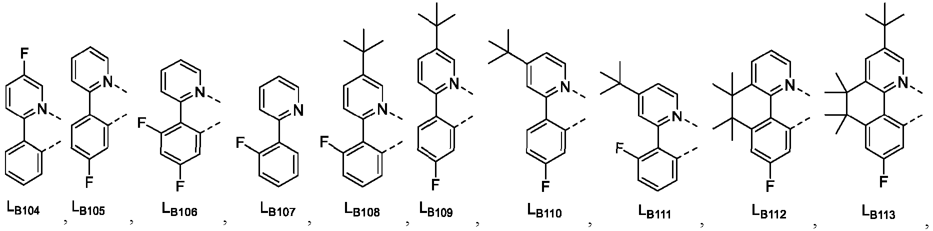 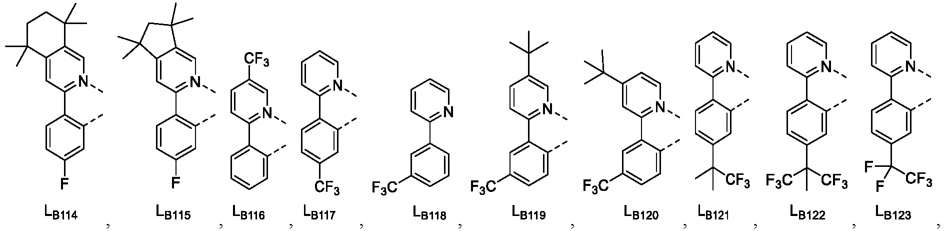 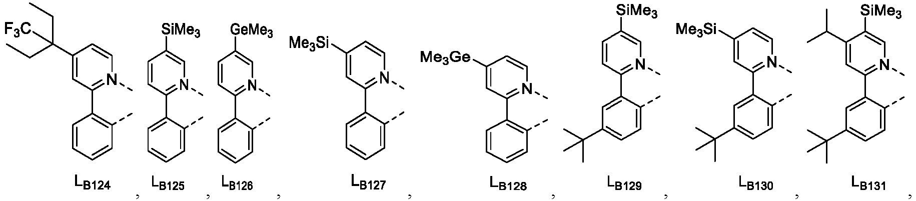 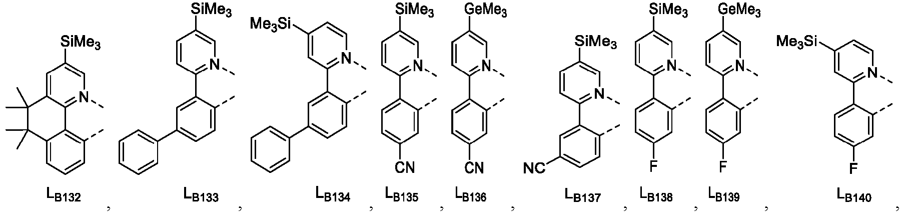 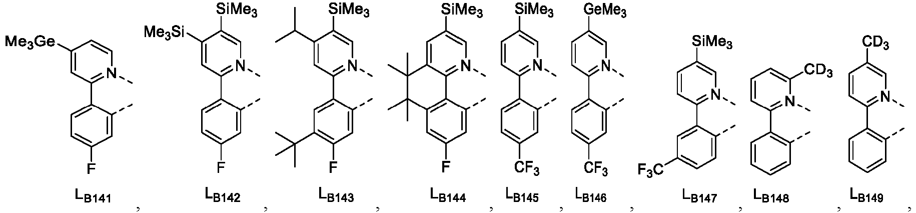 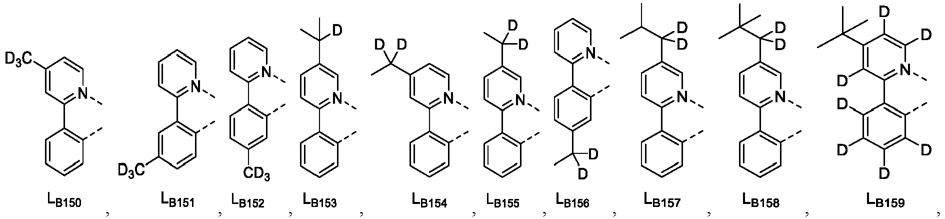 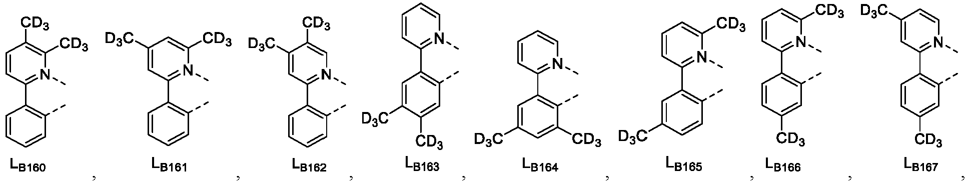 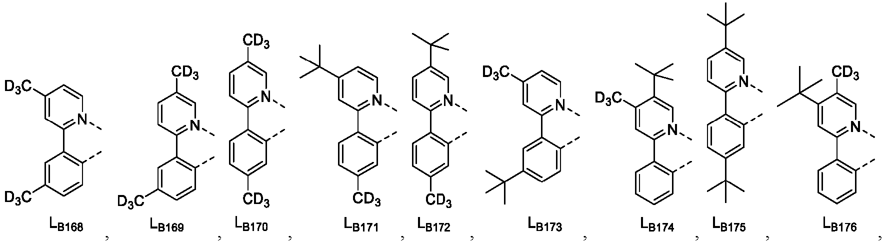 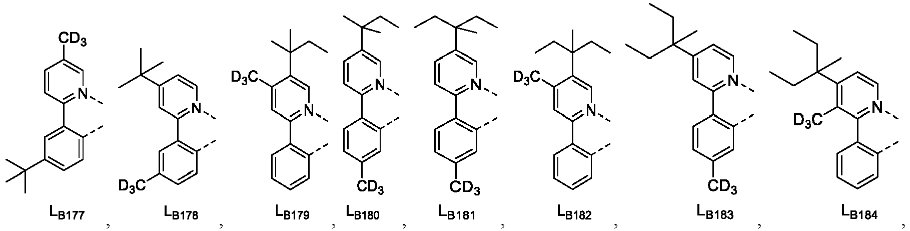 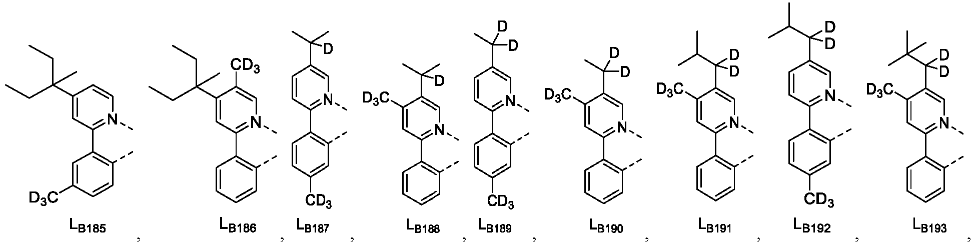 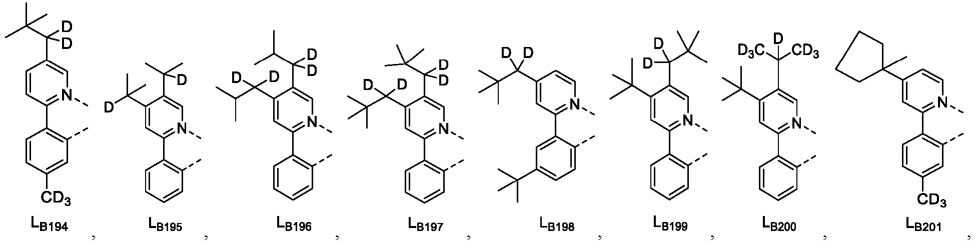 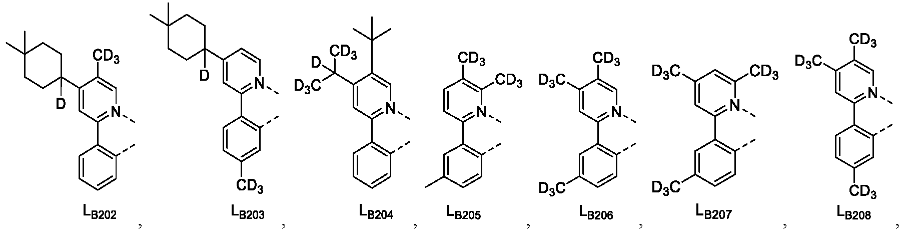 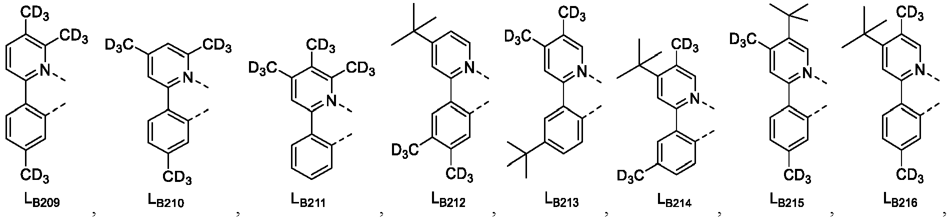 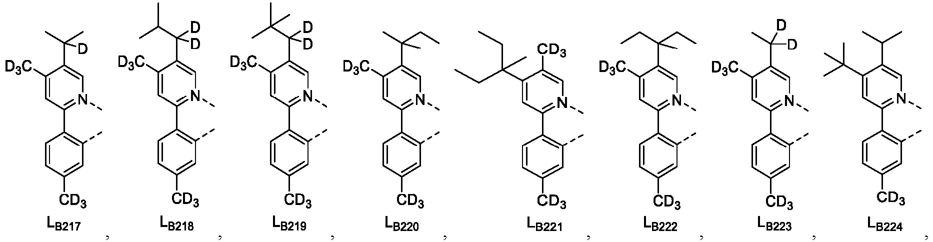 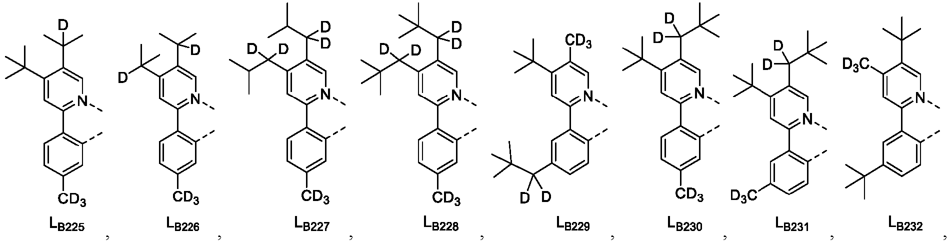 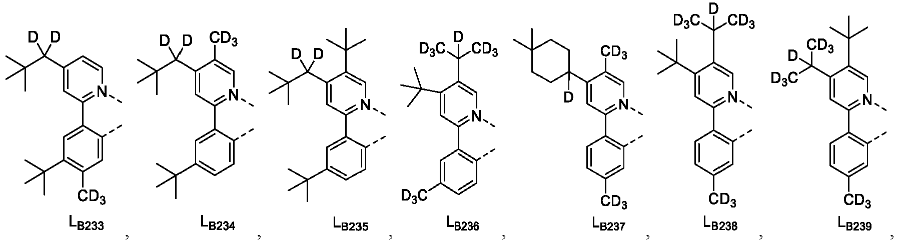 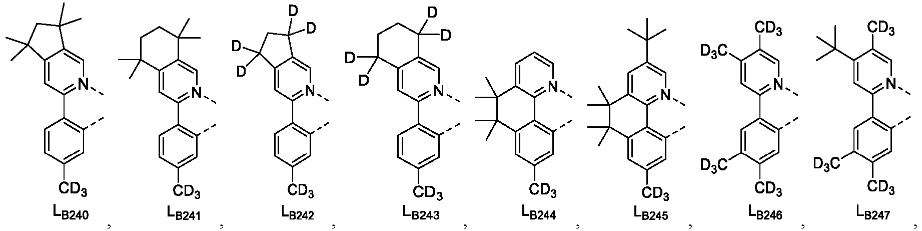 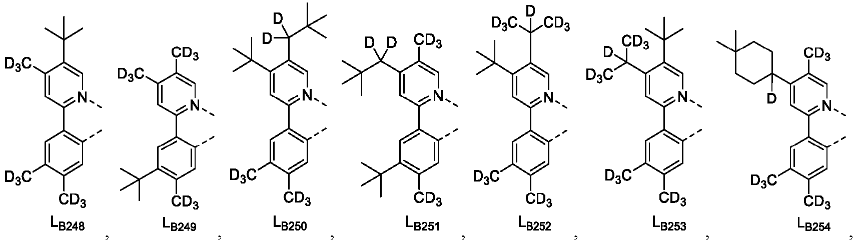 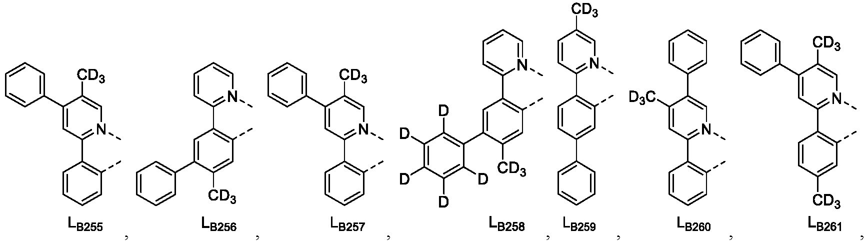 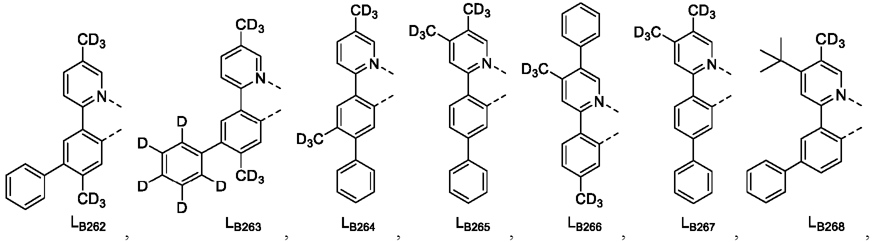 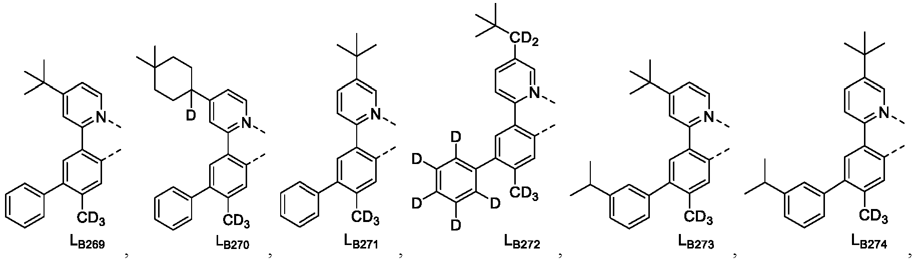 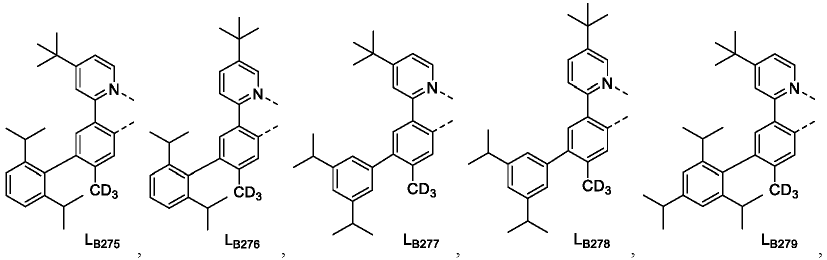 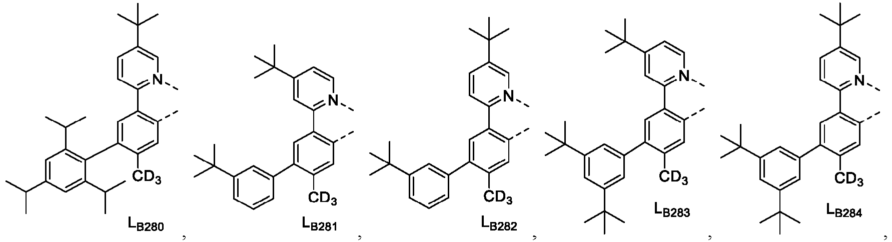 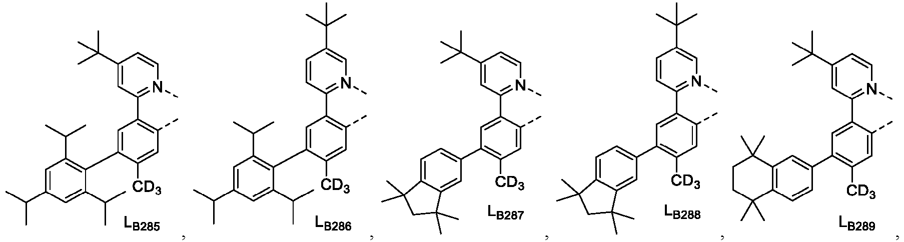 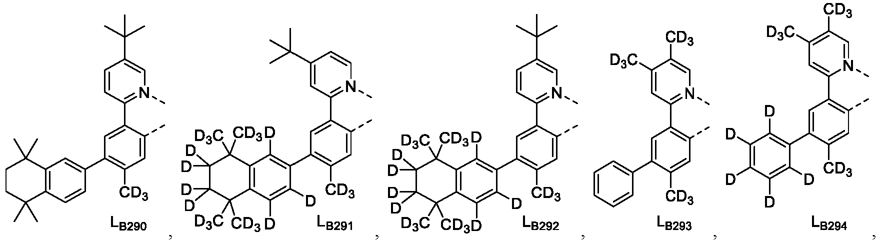 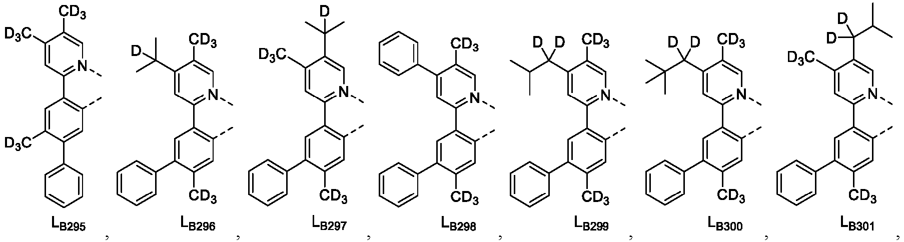 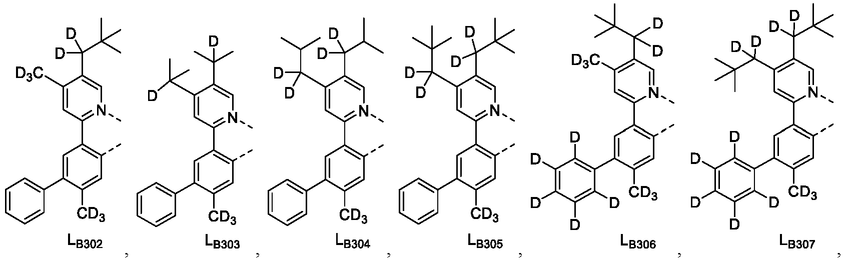 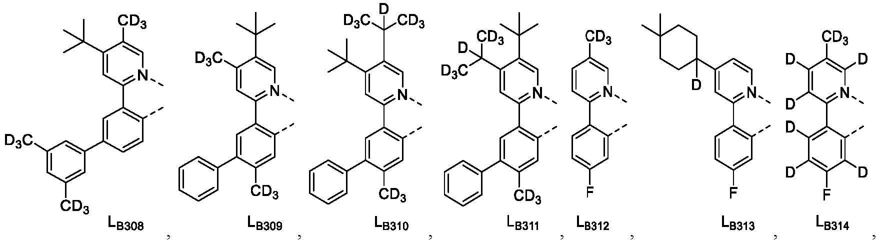 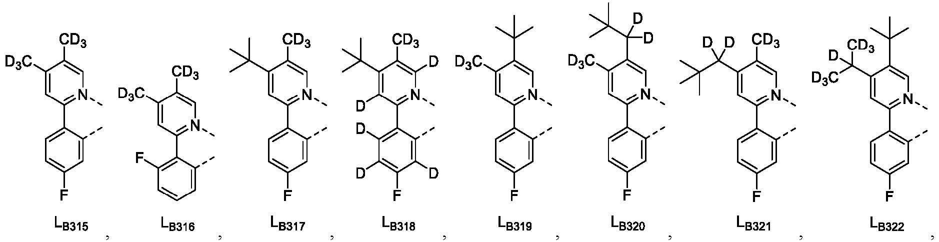 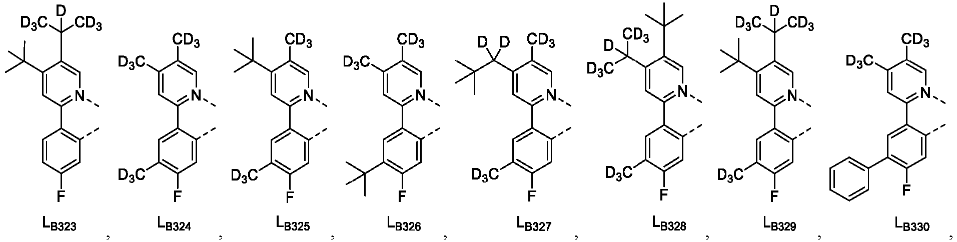 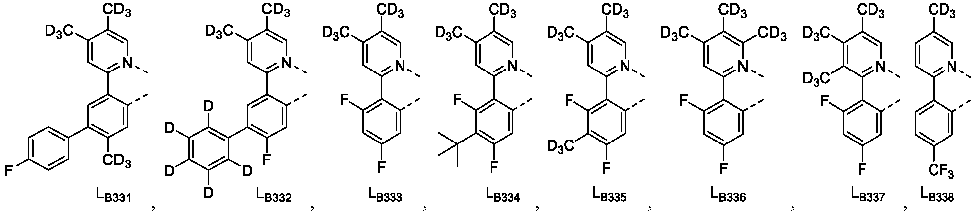 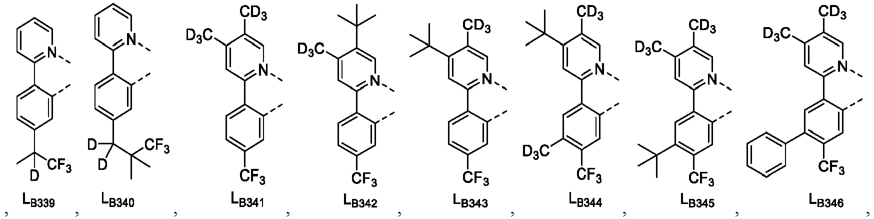 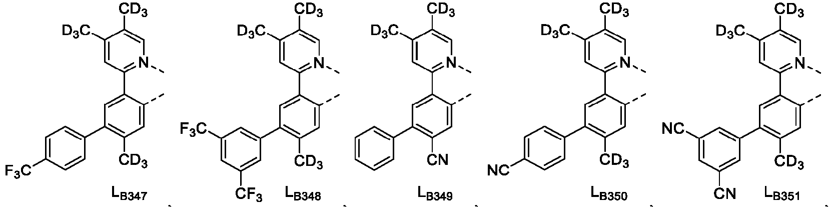 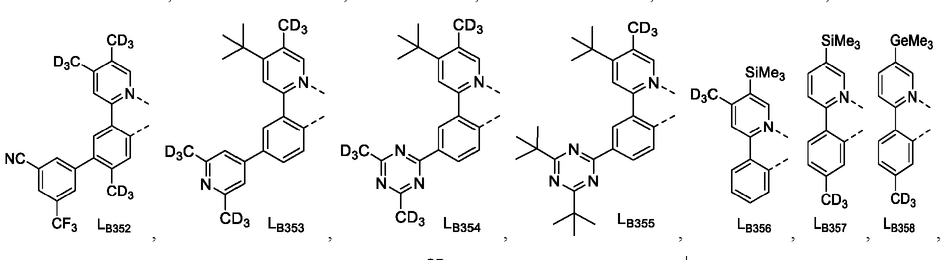 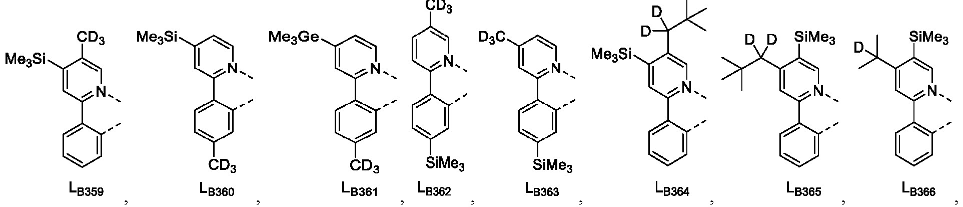 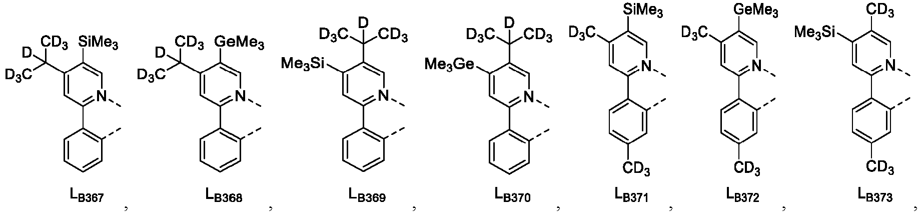 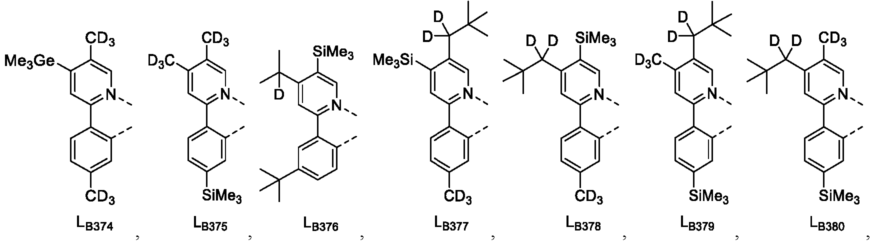 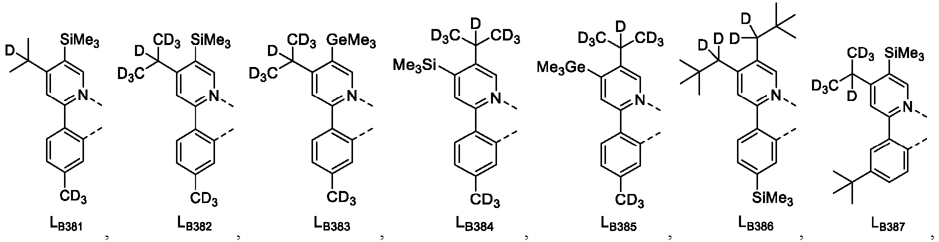 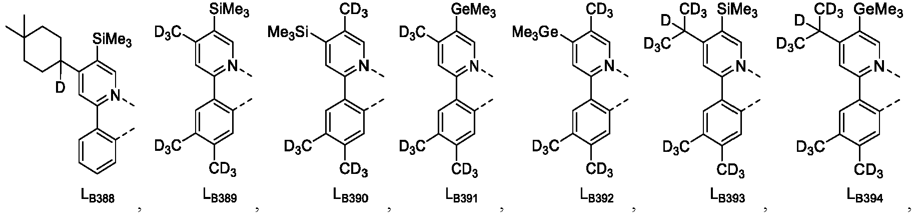 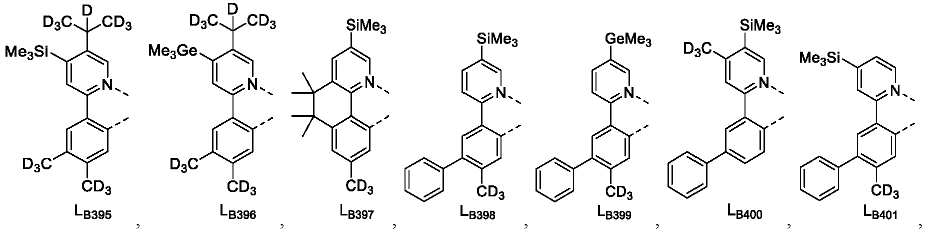 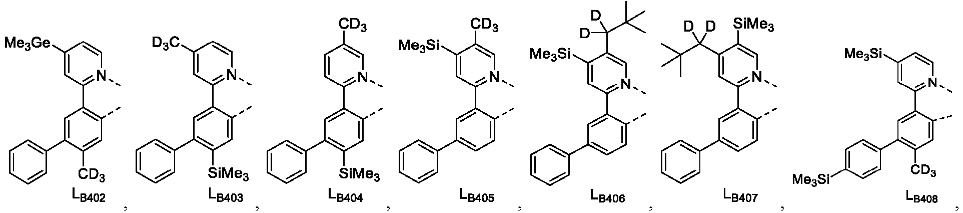 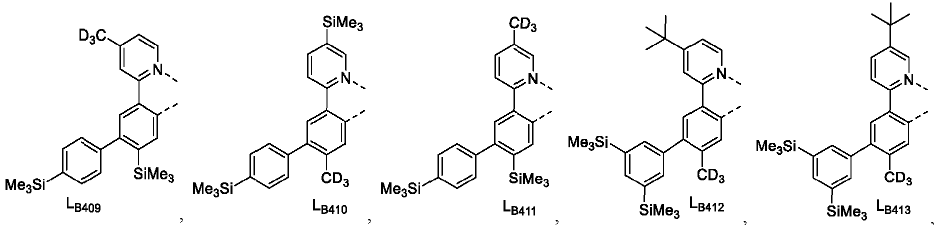 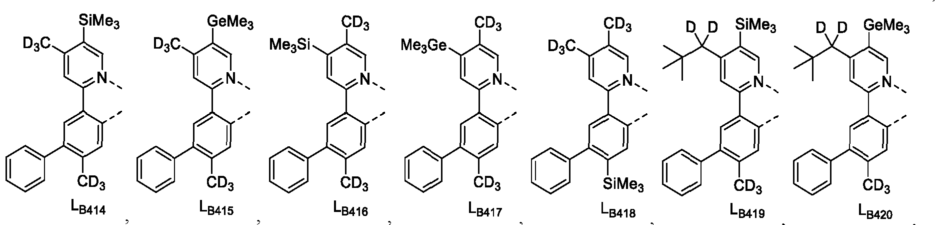 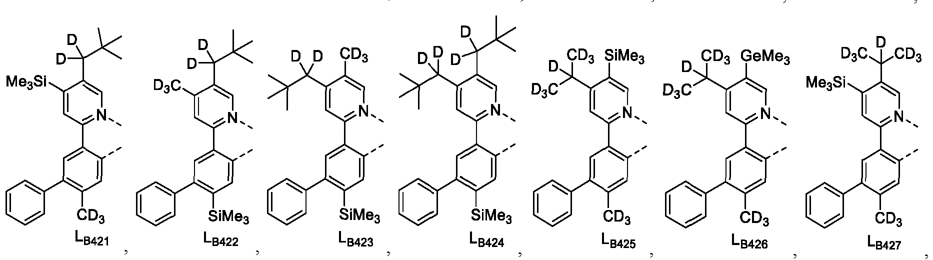 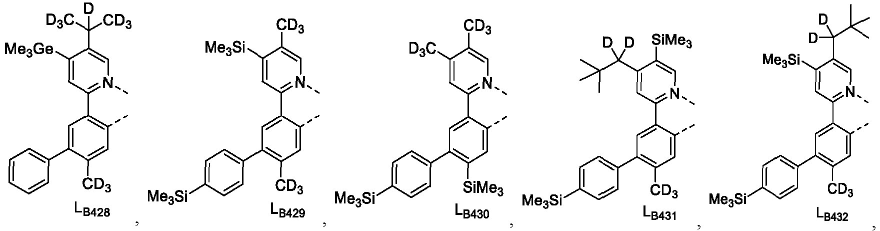 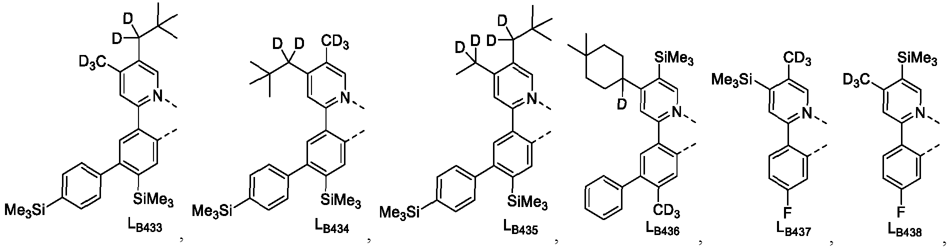 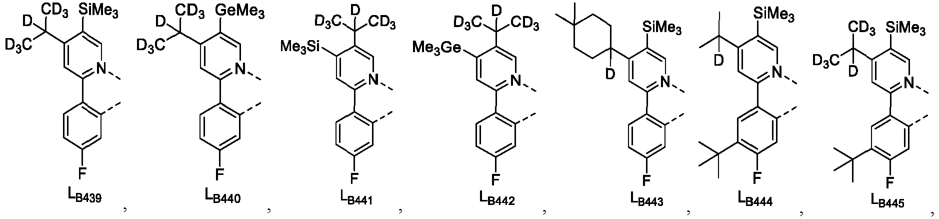 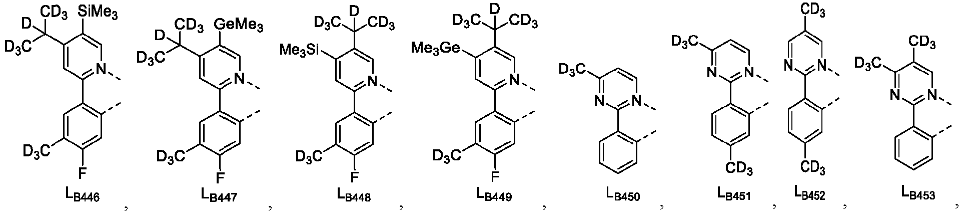 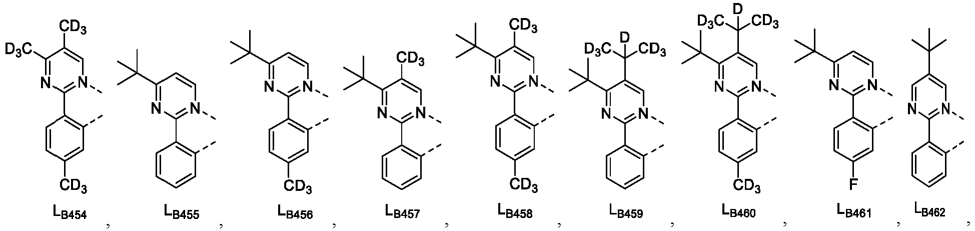 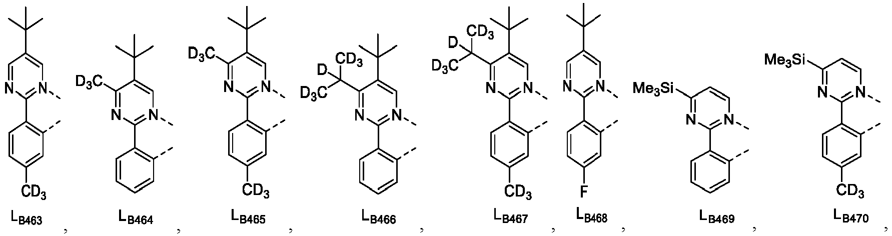 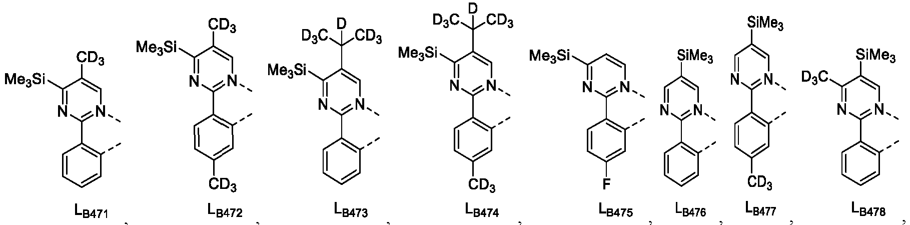 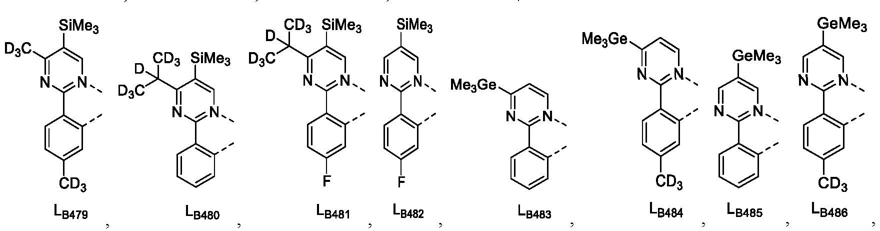 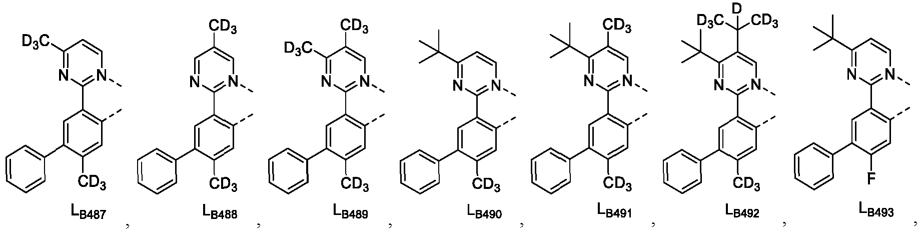 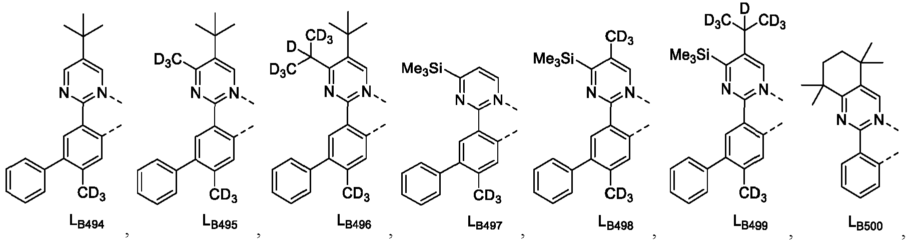 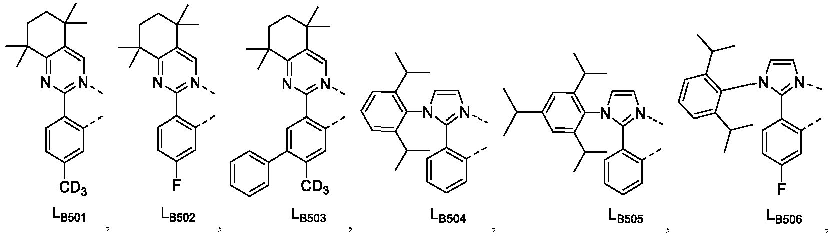 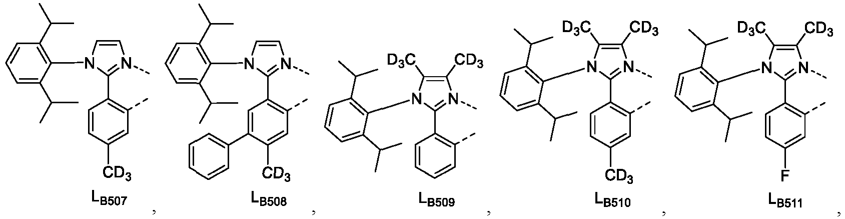 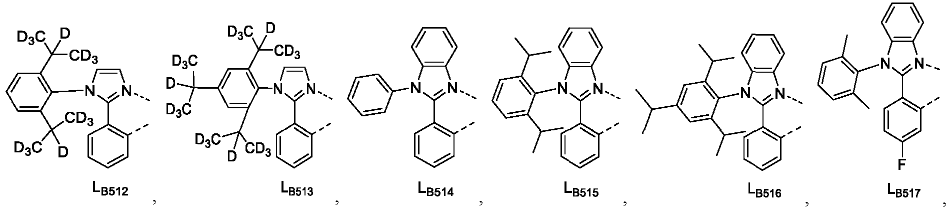 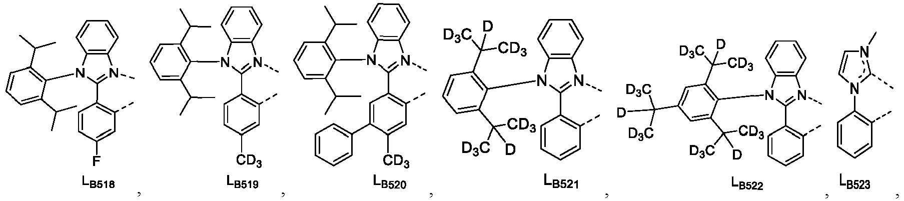 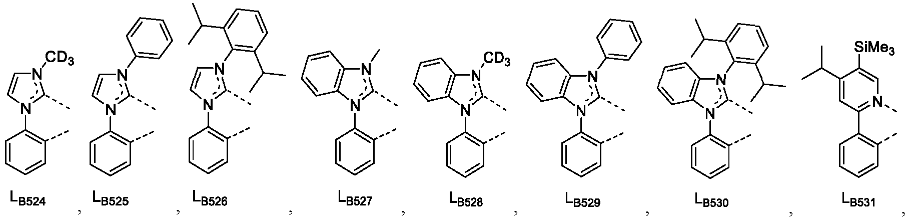 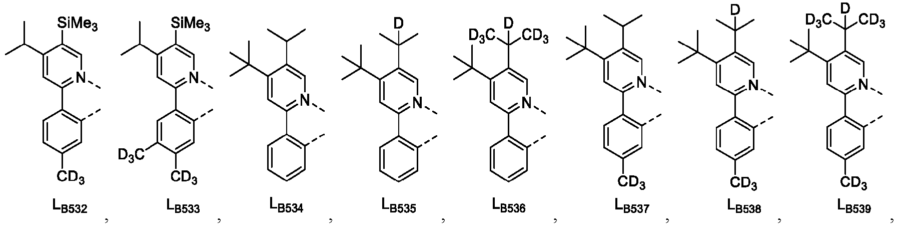 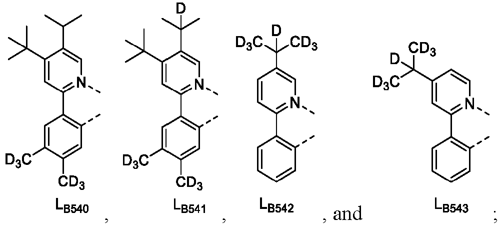 wherein L_{C} is selected from L_{C*j*-I} and L_{C*j*-II}, and each L_{C*j*-I} has a structure based on formula 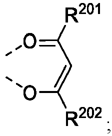 and
each L_{C*j*-II} has a structure based on formula 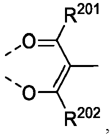 wherein for each L_{C*j*} in L_{C*j*-I} and L_{C*j*-II}, R²⁰¹ and R²⁰² are each independently defined in the following LIST 14:

| **L_{C*j*}** | **R²⁰¹** | **R²⁰²** | **L_{C*j*}** | **R²⁰¹** | **R²⁰²** | **L_{C*j*}** | **R²⁰¹** | **R²⁰²** | **L_{C*j*}** | **R²⁰¹** | **R²⁰²** |
|---|---|---|---|---|---|---|---|---|---|---|---|
| L_{C1} | R^{D1} | R^{D1} | L_{C193} | R^{D1} | R^{D3} | L_{C385} | R^{D17} | R^{D40} | L_{C577} | R^{D143} | R^{D120} |
| L_{C2} | R^{D2} | R^{D2} | L_{C194} | R^{D1} | R^{D4} | L_{C386} | R^{D17} | R^{D41} | L_{C578} | R^{D143} | R^{D133} |
| L_{C3} | R^{D3} | R^{D3} | L_{C195} | R^{D1} | R^{D5} | L_{C387} | R^{D17} | R^{D42} | L_{C579} | R^{D143} | R^{D134} |
| L_{C4} | R^{D4} | R^{D4} | L_{C196} | R^{D1} | R^{D9} | L_{C388} | R^{D17} | R^{D43} | L_{C580} | R^{D143} | R^{D135} |
| L_{C5} | R^{D5} | R^{D5} | L_{C197} | R^{D1} | R^{D10} | L_{C389} | R^{D17} | R^{D48} | L_{C581} | R^{D143} | R^{D136} |
| L_{C6} | R^{D6} | R^{D6} | L_{C198} | R^{D1} | R^{D17} | L_{C390} | R^{D17} | R^{D49} | L_{C582} | R^{D143} | R^{D144} |
| L_{C7} | R^{D7} | R^{D7} | L_{C199} | R^{D1} | R^{D18} | L_{C391} | R^{D17} | R^{D50} | L_{C583} | R^{D143} | R^{D145} |
| L_{C8} | R^{D8} | R^{D8} | L_{C200} | R^{D1} | R^{D20} | L_{C392} | R^{D17} | R^{D54} | L_{C584} | R^{D143} | R^{D146} |
| L_{C9} | R^{D9} | R^{D9} | L_{C201} | R^{D1} | R^{D22} | L_{C393} | R^{D17} | R^{D55} | L_{C585} | R^{D143} | R^{D147} |
| L_{C10} | R^{D10} | R^{D10} | L_{C202} | R^{D1} | R^{D37} | L_{C394} | R^{D17} | R^{D58} | L_{C586} | R^{D143} | R^{D149} |
| L_{C11} | R^{D11} | R^{D11} | L_{C203} | R^{D1} | R^{D40} | L_{C395} | R^{D17} | R^{D59} | L_{C587} | R^{D143} | R^{D151} |
| L_{C12} | R^{D12} | R^{D12} | L_{C204} | R^{D1} | R^{D41} | L_{C396} | R^{D17} | R^{D78} | L_{C588} | R^{D143} | R^{D154} |
| L_{C13} | R^{D13} | R^{D13} | L_{C205} | R^{D1} | R^{D42} | L_{C397} | R^{D17} | R^{D79} | L_{C589} | R^{D143} | R^{D155} |
| L_{C14} | R^{D14} | R^{D14} | L_{C206} | R^{D1} | R^{D43} | L_{C398} | R^{D17} | R^{D81} | L_{C590} | R^{D143} | R^{D161} |
| L_{C15} | R^{D15} | R^{D15} | L_{C207} | R^{D1} | R^{D48} | L_{C399} | R^{D17} | R^{D87} | L_{C591} | R^{D143} | R^{D175} |
| L_{C16} | R^{D16} | R^{D16} | L_{C208} | R^{D1} | R^{D49} | L_{C400} | R^{D17} | R^{D88} | L_{C592} | R^{D144} | R^{D3} |
| L_{C17} | R^{D17} | R^{D17} | L_{C209} | R^{D1} | R^{D50} | L_{C401} | R^{D17} | R^{D89} | L_{C593} | R^{D144} | R^{D5} |
| L_{C18} | R^{D18} | R^{D18} | L_{C210} | R^{D1} | R^{D54} | L_{C402} | R^{D17} | R^{D93} | L_{C594} | R^{D144} | R^{D17} |
| L_{C19} | R^{D19} | R^{D19} | L_{C211} | R^{D1} | R^{D55} | L_{C403} | R^{D17} | R^{D116} | L_{C595} | R^{D144} | R^{D18} |
| L_{C20} | R^{D20} | R^{D20} | L_{C212} | R^{D1} | R^{D58} | L_{C404} | R^{D17} | R^{D117} | L_{C596} | R^{D144} | R^{D20} |
| L_{C21} | R^{D21} | R^{D21} | L_{C213} | R^{D1} | R^{D59} | L_{C405} | R^{D17} | R^{D118} | L_{C597} | R^{D144} | R^{D22} |
| L_{C22} | R^{D22} | R^{D22} | L_{C214} | R^{D1} | R^{D78} | L_{C406} | R^{D17} | R^{D119} | L_{C598} | R^{D144} | R^{D37} |
| L_{C23} | R^{D23} | R^{D23} | L_{C215} | R^{D1} | R^{D79} | L_{C407} | R^{D17} | R^{D120} | L_{C599} | R^{D144} | R^{D40} |
| L_{C24} | R^{D24} | R^{D24} | L_{C216} | R^{D1} | R^{D81} | L_{C408} | R^{D17} | R^{D133} | L_{C600} | R^{D144} | R^{D41} |
| L_{C25} | R^{D25} | R^{D25} | L_{C217} | R^{D1} | R^{D87} | L_{C409} | R^{D17} | R^{D134} | L_{C601} | R^{D144} | R^{D42} |
| L_{C26} | R^{D26} | R^{D26} | L_{C218} | R^{D1} | R^{D88} | L_{C410} | R^{D17} | R^{D135} | L_{C602} | R^{D144} | R^{D43} |
| L_{C27} | R^{D27} | R^{D27} | L_{C219} | R^{D1} | R^{D89} | L_{C411} | R^{D17} | R^{D136} | L_{C603} | R^{D144} | R^{D48} |
| L_{C28} | R^{D28} | R^{D28} | L_{C220} | R^{D1} | R^{D93} | L_{C412} | R^{D17} | R^{D143} | L_{C604} | R^{D144} | R^{D49} |
| L_{C29} | R^{D29} | R^{D29} | L_{C221} | R^{D1} | R^{D116} | L_{C413} | R^{D17} | R^{D144} | L_{C605} | R^{D144} | R^{D54} |
| L_{C30} | R^{D30} | R^{D30} | L_{C222} | R^{D1} | R^{D117} | L_{C414} | R^{D17} | R^{D145} | L_{C606} | R^{D144} | R^{D58} |
| L_{C31} | R^{D31} | R^{D31} | L_{C223} | R^{D1} | R^{D118} | L_{C415} | R^{D17} | R^{D146} | L_{C607} | R^{D144} | R^{D59} |
| L_{C32} | R^{D32} | R^{D32} | L_{C224} | R^{D1} | R^{D119} | L_{C416} | R^{D17} | R^{D147} | L_{C608} | R^{D144} | R^{D78} |
| L_{C33} | R^{D33} | R^{D33} | L_{C225} | R^{D1} | R^{D120} | L_{C417} | R^{D17} | R^{D149} | L_{C609} | R^{D144} | R^{D79} |
| L_{C34} | R^{D34} | R^{D34} | L_{C226} | R^{D1} | R^{D133} | L_{C418} | R^{D17} | R^{D151} | L_{C610} | R^{D144} | R^{D81} |
| L_{C35} | R^{D35} | R^{D35} | L_{C227} | R^{D1} | R^{D134} | L_{C419} | R^{D17} | R^{D154} | L_{C611} | R^{D144} | R^{D87} |
| L_{C36} | R^{D36} | R^{D36} | L_{C228} | R^{D1} | R^{D135} | L_{C420} | R^{D17} | R^{D155} | L_{C612} | R^{D144} | R^{D88} |
| L_{C37} | R^{D37} | R^{D37} | L_{C229} | R^{D1} | R^{D136} | L_{C421} | R^{D17} | R^{D161} | L_{C613} | R^{D144} | R^{D89} |
| L_{C38} | R^{D38} | R^{D38} | L_{C230} | R^{D1} | R^{D143} | L_{C422} | R^{D17} | R^{D175} | L_{C614} | R^{D144} | R^{D93} |
| L_{C39} | R^{D39} | R^{D39} | L_{C231} | R^{D1} | R^{D144} | L_{C423} | R^{D50} | R^{D3} | L_{C615} | R^{D144} | R^{D116} |
| L_{C40} | R^{D40} | R^{D40} | L_{C232} | R^{D1} | R^{D145} | L_{C424} | R^{D50} | R^{D5} | L_{C616} | R^{D144} | R^{D117} |
| L_{C41} | R^{D41} | R^{D41} | L_{C233} | R^{D1} | R^{D146} | L_{C425} | R^{D50} | R^{D18} | L_{C617} | R^{D144} | R^{D118} |
| L_{C42} | R^{D42} | R^{D42} | L_{C234} | R^{D1} | R^{D147} | L_{C426} | R^{D50} | R^{D20} | L_{C618} | R^{D144} | R^{D119} |
| L_{C43} | R^{D43} | R^{D43} | L_{C235} | R^{D1} | R^{D149} | L_{C427} | R^{D50} | R^{D22} | L_{C619} | R^{D144} | R^{D120} |
| L_{C44} | R^{D44} | R^{D44} | L_{C236} | R^{D1} | R^{D151} | L_{C428} | R^{D50} | R^{D37} | L_{C620} | R^{D144} | R^{D133} |
| L_{C45} | R^{D45} | R^{D45} | L_{C237} | R^{D1} | R^{D154} | L_{C429} | R^{D50} | R^{D40} | L_{C621} | R^{D144} | R^{D134} |
| L_{C46} | R^{D46} | R^{D46} | L_{C238} | R^{D1} | R^{D155} | L_{C430} | R^{D50} | R^{D41} | L_{C622} | R^{D144} | R^{D135} |
| L_{C47} | R^{D47} | R^{D47} | L_{C239} | R^{D1} | R^{D161} | L_{C431} | R^{D50} | R^{D42} | L_{C623} | R^{D144} | R^{D136} |
| L_{C48} | R^{D48} | R^{D48} | L_{C240} | R^{D1} | R^{D175} | L_{C432} | R^{D50} | R^{D43} | L_{C624} | R^{D144} | R^{D145} |
| L_{C49} | R^{D49} | R^{D49} | L_{C241} | R^{D4} | R^{D3} | L_{C433} | R^{D50} | R^{D48} | L_{C625} | R^{D144} | R^{D146} |
| L_{C50} | R^{D50} | R^{D50} | L_{C242} | R^{D4} | R^{D5} | L_{C434} | R^{D50} | R^{D49} | L_{C626} | R^{D144} | R^{D147} |
| L_{C51} | R^{D51} | R^{D51} | L_{C243} | R^{D4} | R^{D9} | L_{C435} | R^{D50} | R^{D54} | L_{C627} | R^{D144} | R^{D149} |
| L_{C52} | R^{D52} | R^{D52} | L_{C244} | R^{D4} | R^{D10} | L_{C436} | R^{D50} | R^{D55} | L_{C628} | R^{D144} | R^{D151} |
| L_{C53} | R^{D53} | R^{D53} | L_{C245} | R^{D4} | R^{D17} | L_{C437} | R^{D50} | R^{D58} | L_{C629} | R^{D144} | R^{D154} |
| L_{C54} | R^{D54} | R^{D54} | L_{C246} | R^{D4} | R^{D18} | L_{C438} | R^{D50} | R^{D59} | L_{C630} | R^{D144} | R^{D155} |
| L_{C55} | R^{D55} | R^{D55} | L_{C247} | R^{D4} | R^{D20} | L_{C439} | R^{D50} | R^{D78} | L_{C631} | R^{D144} | R^{D161} |
| L_{C56} | R^{D56} | R^{D56} | L_{C248} | R^{D4} | R^{D22} | L_{C440} | R^{D50} | R^{D79} | L_{C632} | R^{D144} | R^{D175} |
| L_{C57} | R^{D57} | R^{D57} | L_{C249} | R^{D4} | R^{D37} | L_{C441} | R^{D50} | R^{D81} | L_{C633} | R^{D145} | R^{D3} |
| L_{C58} | R^{D58} | R^{D58} | L_{C250} | R^{D4} | R^{D40} | L_{C442} | R^{D50} | R^{D87} | L_{C634} | R^{D145} | R^{D5} |
| L_{C59} | R^{D59} | R^{D59} | L_{C251} | R^{D4} | R^{D41} | L_{C443} | R^{D50} | R^{D88} | L_{C635} | R^{D145} | R^{D17} |
| L_{C60} | R^{D60} | R^{D60} | L_{C252} | R^{D4} | R^{D42} | L_{C444} | R^{D50} | R^{D89} | L_{C636} | R^{D145} | R^{D18} |
| L_{C61} | R^{D61} | R^{D61} | L_{C253} | R^{D4} | R^{D43} | L_{C445} | R^{D50} | R^{D93} | L_{C637} | R^{D145} | R^{D20} |
| L_{C62} | R^{D62} | R^{D62} | L_{C254} | R^{D4} | R^{D48} | L_{C446} | R^{D50} | R^{D116} | L_{C638} | R^{D145} | R^{D22} |
| L_{C63} | R^{D63} | R^{D63} | L_{C255} | R^{D4} | R^{D49} | L_{C447} | R^{D50} | R^{D117} | L_{C639} | R^{D145} | R^{D37} |
| L_{C64} | R^{D64} | R^{D64} | L_{C256} | R^{D4} | R^{D50} | L_{C448} | R^{D50} | R^{D118} | L_{C640} | R^{D145} | R^{D40} |
| L_{C65} | R^{D65} | R^{D65} | L_{C257} | R^{D4} | R^{D54} | L_{C449} | R^{D50} | R^{D119} | L_{C641} | R^{D145} | R^{D41} |
| L_{C66} | R^{D66} | R^{D66} | L_{C258} | R^{D4} | R^{D55} | L_{C450} | R^{D50} | R^{D120} | L_{C642} | R^{D145} | R^{D42} |
| L_{C67} | R^{D67} | R^{D67} | L_{C259} | R^{D4} | R^{D58} | L_{C451} | R^{D50} | R^{D133} | L_{C643} | R^{D145} | R^{D43} |
| L_{C68} | R^{D68} | R^{D68} | L_{C260} | R^{D4} | R^{D59} | L_{C452} | R^{D50} | R^{D134} | L_{C644} | R^{D145} | R^{D48} |
| L_{C69} | R^{D69} | R^{D69} | L_{C261} | R^{D4} | R^{D78} | L_{C453} | R^{D50} | R^{D135} | L_{C645} | R^{D145} | R^{D49} |
| L_{C70} | R^{D70} | R^{D70} | L_{C262} | R^{D4} | R^{D79} | L_{C454} | R^{D50} | R^{P136} | L_{C646} | R^{D145} | R^{D54} |
| L_{C71} | R^{D71} | R^{D71} | L_{C263} | R^{D4} | R^{D81} | L_{C455} | R^{D50} | R^{D143} | L_{C647} | R^{D145} | R^{D58} |
| L_{C72} | R^{D72} | R^{D72} | L_{C264} | R^{D4} | R^{D87} | L_{C456} | R^{D50} | R^{D144} | L_{C648} | R^{D145} | R^{D59} |
| L_{C73} | R^{D73} | R^{D73} | L_{C265} | R^{D4} | R^{D88} | L_{C457} | R^{D50} | R^{D145} | L_{C649} | R^{D145} | R^{D78} |
| L_{C74} | R^{D74} | R^{D74} | L_{C266} | R^{D4} | R^{D89} | L_{C458} | R^{D50} | R^{D146} | L_{C650} | R^{D145} | R^{D79} |
| L_{C75} | R^{D75} | R^{D75} | L_{C267} | R^{D4} | R^{D93} | L_{C459} | R^{D50} | R^{D147} | L_{C651} | R^{D145} | R^{D81} |
| L_{C76} | R^{D76} | R^{D76} | L_{C268} | R^{D4} | R^{D116} | L_{C460} | R^{D50} | R^{D149} | L_{C652} | R^{D145} | R^{D87} |
| L_{C77} | R^{D77} | R^{D77} | L_{C269} | R^{D4} | R^{D117} | L_{C461} | R^{D50} | R^{D151} | L_{C653} | R^{D145} | R^{D88} |
| L_{C78} | R^{D78} | R^{D78} | L_{C270} | R^{D4} | R^{D118} | L_{C462} | R^{D50} | R^{D154} | L_{C654} | R^{D145} | R^{D89} |
| L_{C79} | R^{D79} | R^{D79} | L_{C271} | R^{D4} | R^{D119} | L_{C463} | R^{D50} | R^{D155} | L_{C655} | R^{D145} | R^{D93} |
| L_{C80} | R^{D80} | R^{D80} | L_{C272} | R^{D4} | R^{D120} | L_{C464} | R^{D50} | R^{D161} | L_{C656} | R^{D145} | R^{D116} |
| L_{C81} | R^{D81} | R^{D81} | L_{C273} | R^{D4} | R^{D133} | L_{C465} | R^{D50} | R^{D175} | L_{C657} | R^{D145} | R^{D117} |
| L_{C82} | R^{D82} | R^{D82} | L_{C274} | R^{D4} | R^{D134} | L_{C466} | R^{D55} | R^{D3} | L_{C658} | R^{D145} | R^{D118} |
| L_{C83} | R^{D83} | R^{D83} | L_{C275} | R^{D4} | R^{D135} | L_{C467} | R^{D55} | R^{D5} | L_{C659} | R^{D145} | R^{D119} |
| L_{C84} | R^{D84} | R^{D84} | L_{C276} | R^{D4} | R^{D136} | L_{C468} | R^{D55} | R^{D18} | L_{C660} | R^{D145} | R^{D120} |
| L_{C85} | R^{D85} | R^{D85} | L_{C277} | R^{D4} | R^{D143} | L_{C469} | R^{D55} | R^{D20} | L_{C661} | R^{D145} | R^{DI33} |
| L_{C86} | R^{D86} | R^{D86} | L_{C278} | R^{D4} | R^{D144} | L_{C470} | R^{D55} | R^{D22} | L_{C662} | R^{D145} | R^{D134} |
| L_{C87} | R^{D87} | R^{D87} | L_{C279} | R^{D4} | R^{D145} | L_{C471} | R^{D55} | R^{D37} | L_{C663} | R^{D145} | R^{D135} |
| L_{C88} | R^{D88} | R^{D88} | L_{C280} | R^{D4} | R^{D146} | L_{C472} | R^{D55} | R^{D40} | L_{C664} | R^{D145} | R^{D136} |
| L_{C89} | R^{D89} | R^{D89} | L_{C281} | R^{D4} | R^{D147} | L_{C473} | R^{D55} | R^{D41} | L_{C665} | R^{D145} | R^{D146} |
| L_{C90} | R^{D90} | R^{D90} | L_{C282} | R^{D4} | R^{D149} | L_{C474} | R^{D55} | R^{D42} | L_{C666} | R^{D145} | R^{D147} |
| L_{C91} | R^{D91} | R^{D91} | L_{C283} | R^{D4} | R^{D151} | L_{C475} | R^{D55} | R^{D43} | L_{C667} | R^{D145} | R^{D149} |
| L_{C92} | R^{D92} | R^{D92} | L_{C284} | R^{D4} | R^{D154} | L_{C476} | R^{D55} | R^{D48} | L_{C668} | R^{D145} | R^{D151} |
| L_{C93} | R^{D93} | R^{D93} | L_{C285} | R^{D4} | R^{D155} | L_{C477} | R^{D55} | R^{D49} | L_{C669} | R^{D145} | R^{D154} |
| L_{C94} | R^{D94} | R^{D94} | L_{C286} | R^{D4} | R^{D161} | L_{C478} | R^{D55} | R^{D54} | L_{C670} | R^{D145} | R^{D155} |
| L_{C95} | R^{D95} | R^{D95} | L_{C287} | R^{D4} | R^{D175} | L_{C479} | R^{D55} | R^{D58} | L_{C671} | R^{D145} | R^{D161} |
| L_{C96} | R^{D96} | R^{D96} | L_{C288} | R^{D9} | R^{D3} | L_{C480} | R^{D55} | R^{D59} | L_{C672} | R^{D145} | R^{D175} |
| L_{C97} | R^{D97} | R^{D97} | L_{C289} | R^{D9} | R^{D5} | L_{C481} | R^{D55} | R^{D78} | L_{C673} | R^{D146} | R^{D3} |
| L_{C98} | R^{D98} | R^{D98} | L_{C290} | R^{D9} | R^{D10} | L_{C482} | R^{D55} | R^{D79} | L_{C674} | R^{D146} | R^{D5} |
| L_{C99} | R^{D99} | R^{D99} | L_{C291} | R^{D9} | R^{D17} | L_{C483} | R^{D55} | R^{D81} | L_{C675} | R^{D146} | R^{D17} |
| L_{C100} | R^{D100} | R^{D100} | L_{C292} | R^{D9} | R^{D18} | L_{C484} | R^{D55} | R^{D87} | L_{C676} | R^{D146} | R^{D18} |
| L_{C101} | R^{D101} | R^{D101} | L_{C293} | R^{D9} | R^{D20} | L_{C485} | R^{D55} | R^{D88} | L_{C677} | R^{D146} | R^{D20} |
| L_{C102} | R^{D102} | R^{D102} | L_{C294} | R^{D9} | R^{D22} | L_{C486} | R^{D55} | R^{D59} | L_{C678} | R^{D146} | R^{D22} |
| L_{C103} | R^{D103} | R^{D103} | L_{C295} | R^{D9} | R^{D37} | L_{C487} | R^{D55} | R^{D93} | L_{C679} | R^{D146} | R^{D37} |
| L_{C104} | R^{D104} | R^{P104} | L_{C296} | R^{D9} | R^{D40} | L_{C488} | R^{D55} | R^{D116} | L_{C680} | R^{D146} | R^{D40} |
| L_{C105} | R^{D105} | R^{D105} | L_{C297} | R^{D9} | R^{D41} | L_{C489} | R^{D55} | R^{D117} | L_{C681} | R^{D146} | R^{D41} |
| L_{C106} | R^{D106} | R^{P106} | L_{C298} | R^{D9} | R^{D42} | L_{C490} | R^{D55} | R^{D118} | L_{C682} | R^{D146} | R^{D42} |
| L_{C107} | R^{D107} | R^{D107} | L_{C299} | R^{D9} | R^{D43} | L_{C491} | R^{D55} | R^{D119} | L_{C683} | R^{D146} | R^{D43} |
| L_{C108} | R^{D108} | R^{D108} | L_{C300} | R^{D9} | R^{D48} | L_{C492} | R^{D55} | R^{D120} | L_{C684} | R^{D146} | R^{D48} |
| L_{C109} | R^{D109} | R^{D109} | L_{C301} | R^{D9} | R^{D49} | L_{C493} | R^{D55} | R^{D133} | L_{C685} | R^{D146} | R^{D49} |
| L_{C110} | R^{D101} | R^{D110} | L_{C302} | R^{D9} | R^{D50} | L_{C494} | R^{D55} | R^{D134} | L_{C686} | R^{D146} | R^{D54} |
| L_{C111} | R^{D111} | R^{D111} | L_{C303} | R^{D9} | R^{D54} | L_{C495} | R^{D55} | R^{D135} | L_{C687} | R^{D146} | R^{DS8} |
| L_{C112} | R^{D112} | R^{D112} | L_{C304} | R^{D9} | R^{D55} | L_{C496} | R^{D55} | R^{D136} | L_{C688} | R^{D146} | R^{D59} |
| L_{C113} | R^{D113} | R^{D113} | L_{C305} | R^{D9} | R^{D58} | L_{C497} | R^{D55} | R^{D143} | L_{C689} | R^{D146} | R^{D78} |
| L_{C114} | R^{D114} | R^{D114} | L_{C306} | R^{D9} | R^{D59} | L_{C498} | R^{D55} | R^{D144} | L_{C690} | R^{D146} | R^{D79} |
| L_{C115} | R^{D115} | R^{D115} | L_{C307} | R^{D9} | R^{D78} | L_{C499} | R^{D55} | R^{D145} | L_{C691} | R^{D146} | R^{D81} |
| L_{C116} | R^{D116} | R^{D116} | L_{C308} | R^{D9} | R^{D79} | L_{C500} | R^{D55} | R^{D146} | L_{C692} | R^{D146} | R^{D87} |
| L_{C117} | R^{D117} | R^{D117} | L_{C309} | R^{D9} | R^{D81} | L_{C501} | R^{D55} | R^{D147} | L_{C693} | R^{D146} | R^{D88} |
| L_{C118} | R^{D118} | R^{D118} | L_{C310} | R^{D9} | R^{D87} | L_{C502} | R^{D55} | R^{D149} | L_{C694} | R^{D146} | R^{D89} |
| L_{C119} | R^{D119} | R^{D119} | L_{C311} | R^{D9} | R^{D88} | L_{C503} | R^{D55} | R^{D151} | L_{C695} | R^{D146} | R^{D93} |
| L_{C120} | R^{D120} | R^{D120} | L_{C312} | R^{D9} | R^{D89} | L_{C504} | R^{D55} | R^{D154} | L_{C696} | R^{D146} | R^{D117} |
| L_{C121} | R^{D121} | R^{D121} | L_{C313} | R^{D9} | R^{D93} | L_{C505} | R^{D55} | R^{D155} | L_{C697} | R^{D146} | R^{D118} |
| L_{C122} | R^{D122} | R^{D122} | L_{C314} | R^{D9} | R^{D116} | L_{C506} | R^{D55} | R^{D161} | L_{C698} | R^{D146} | R^{D119} |
| L_{C123} | R^{D123} | R^{D123} | L_{C315} | R^{D9} | R^{D117} | L_{C507} | R^{D55} | R^{D175} | L_{C699} | R^{D146} | R^{D120} |
| L_{C124} | R^{D124} | R^{D124} | L_{C316} | R^{D9} | R^{D118} | L_{C508} | R^{D116} | R^{D3} | L_{C700} | R^{D146} | R^{D133} |
| L_{C125} | R^{D125} | R^{D125} | L_{C317} | R^{D9} | R^{D119} | L_{C509} | R^{D116} | R^{D5} | L_{C701} | R^{D146} | R^{D134} |
| L_{C126} | R^{D126} | R^{D126} | L_{C318} | R^{D9} | R^{D120} | L_{C510} | R^{D116} | R^{D17} | L_{C702} | R^{D146} | R^{D135} |
| L_{C127} | R^{D127} | R^{D127} | L_{C319} | R^{D9} | R^{D133} | L_{C511} | R^{D116} | R^{D18} | L_{C703} | R^{D146} | R^{D136} |
| L_{C128} | R^{D128} | R^{D128} | L_{C320} | R^{D9} | R^{D134} | L_{C512} | R^{D116} | R^{D20} | L_{C704} | R^{D146} | R^{D146} |
| L_{C129} | R^{D129} | R^{D129} | L_{C321} | R^{D9} | R^{D135} | L_{C513} | R^{D116} | R^{D22} | L_{C705} | R^{D146} | R^{D147} |
| L_{C130} | R^{D130} | R^{D130} | L_{C322} | R^{D9} | R^{D136} | L_{C514} | R^{D116} | R^{D37} | L_{C706} | R^{D146} | R^{D149} |
| L_{C131} | R^{D131} | R^{D131} | L_{C323} | R^{D9} | R^{D143} | L_{C515} | R^{D116} | R^{D40} | L_{C707} | R^{D146} | R^{D151} |
| L_{C132} | R^{D132} | R^{D132} | L_{C324} | R^{D9} | R^{D144} | L_{C516} | R^{D116} | R^{D41} | L_{C708} | R^{D146} | R^{D154} |
| L_{C133} | R^{D133} | R^{D133} | L_{C325} | R^{D9} | R^{D145} | L_{C517} | R^{D116} | R^{D42} | L_{C709} | R^{D146} | R^{D155} |
| L_{C134} | R^{D134} | R^{D134} | L_{C326} | R^{D9} | R^{D146} | L_{C518} | R^{D116} | R^{D43} | L_{C710} | R^{D146} | R^{D161} |
| L_{C135} | R^{D135} | R^{D135} | L_{C327} | R^{D9} | R^{D147} | L_{C519} | R^{D116} | R^{D48} | L_{C711} | R^{D146} | R^{D175} |
| L_{C136} | R^{D136} | R^{D136} | L_{C328} | R^{D9} | R^{D149} | L_{C520} | R^{D116} | R^{D49} | L_{C712} | R^{D133} | R^{D3} |
| L_{C137} | R^{D137} | R^{D137} | L_{C329} | R^{D9} | R^{D151} | L_{C521} | R^{D116} | R^{D54} | L_{C713} | R^{D133} | R^{D5} |
| L_{C138} | R^{D138} | R^{D138} | L_{C330} | R^{D9} | R^{D154} | L_{C522} | R^{D116} | R^{D58} | L_{C714} | R^{D133} | R^{D3} |
| L_{C139} | R^{D139} | R^{D139} | L_{C331} | R^{D9} | R^{D155} | L_{C523} | R^{D116} | R^{D59} | L_{C715} | R^{D133} | R^{D18} |
| L_{C140} | R^{D140} | R^{D140} | L_{C332} | R^{D9} | R^{D161} | L_{C524} | R^{D116} | R^{D78} | L_{C716} | R^{D133} | R^{D20} |
| L_{C141} | R^{D141} | R^{D141} | L_{C333} | R^{D9} | R^{D175} | L_{C525} | R^{D116} | R^{D79} | L_{C717} | R^{D133} | R^{D22} |
| L_{C142} | R^{D142} | R^{D142} | L_{C334} | R^{D10} | R^{D3} | L_{C526} | R^{D116} | R^{D81} | L_{C718} | R^{D133} | R^{D37} |
| L_{C143} | R^{D143} | R^{D143} | L_{C335} | R^{D10} | R^{D5} | L_{C527} | R^{D116} | R^{D87} | L_{C719} | R^{D133} | R^{D40} |
| L_{C144} | R^{D144} | R^{D144} | L_{C336} | R^{D10} | R^{D17} | L_{C528} | R^{D116} | R^{D88} | L_{C720} | R^{D133} | R^{D41} |
| L_{C145} | R^{D145} | R^{D145} | L_{C337} | R^{D10} | R^{D18} | L_{C529} | R^{D116} | R^{D59} | L_{C721} | R^{D133} | R^{D42} |
| L_{C146} | R^{D146} | R^{D146} | L_{C338} | R^{D10} | R^{D20} | L_{C530} | R^{D116} | R^{D93} | L_{C722} | R^{D133} | R^{D43} |
| L_{C147} | R^{D147} | R^{D147} | L_{C339} | R^{D10} | R^{D22} | L_{C531} | R^{D116} | R^{D117} | L_{C723} | R^{D133} | R^{D48} |
| L_{C148} | R^{D148} | R^{D148} | L_{C340} | R^{D10} | R^{D37} | L_{C532} | R^{D116} | R^{D118} | L_{C724} | R^{D133} | R^{D49} |
| L_{C149} | R^{D149} | R^{D149} | L_{C341} | R^{D10} | R^{D40} | L_{C533} | R^{D116} | R^{D119} | L_{C725} | R^{D133} | R^{D54} |
| L_{C150} | R^{D150} | R^{D150} | L_{C342} | R^{D10} | R^{D41} | L_{C534} | R^{D116} | R^{D120} | L_{C726} | R^{D133} | R^{D58} |
| L_{C151} | R^{D151} | R^{D151} | L_{C343} | R^{D10} | R^{D42} | L_{C535} | R^{D116} | R^{D133} | L_{C727} | R^{D133} | R^{D59} |
| L_{C152} | R^{D152} | R^{D152} | L_{C344} | R^{D10} | R^{D43} | L_{C536} | R^{D116} | R^{D134} | L_{C728} | R^{D133} | R^{D78} |
| L_{C153} | R^{D153} | R^{D153} | L_{C345} | R^{D10} | R^{D48} | L_{C537} | R^{D116} | R^{D135} | L_{C729} | R^{D133} | R^{D79} |
| L_{C154} | R^{D154} | R^{D154} | L_{C346} | R^{D10} | R^{D49} | L_{C538} | R^{D116} | R^{D136} | L_{C730} | R^{D133} | R^{D81} |
| L_{C155} | R^{D155} | R^{D155} | L_{C347} | R^{D10} | R^{D50} | L_{C539} | R^{D116} | R^{D143} | L_{C731} | R^{D133} | R^{D87} |
| L_{C156} | R^{D156} | R^{D156} | L_{C348} | R^{D10} | R^{D54} | L_{C540} | R^{D116} | R^{D144} | L_{C732} | R^{D133} | R^{D88} |
| L_{C157} | R^{D157} | R^{D157} | L_{C349} | R^{D10} | R^{D55} | L_{C541} | R^{D116} | R^{D145} | L_{C733} | R^{D133} | R^{D59} |
| L_{C158} | R^{D158} | R^{D158} | L_{C350} | R^{D10} | R^{D58} | L_{C542} | R^{D116} | R^{D146} | L_{C734} | R^{D133} | R^{D93} |
| L_{C159} | R^{D159} | R^{D159} | L_{C351} | R^{D10} | R^{D59} | L_{C543} | R^{D116} | R^{D147} | L_{C735} | R^{D133} | R^{D117} |
| L_{C160} | R^{D160} | R^{D160} | L_{C352} | R^{D10} | R^{D78} | L_{C544} | R^{D116} | R^{D149} | L_{C736} | R^{D133} | R^{D118} |
| L_{C161} | R^{D161} | R^{D161} | L_{C353} | R^{D10} | R^{D79} | L_{C545} | R^{D116} | R^{D151} | L_{C737} | R^{D133} | R^{D119} |
| L_{C162} | R^{D162} | R^{D162} | L_{C354} | R^{D10} | R^{D81} | L_{C546} | R^{D116} | R^{D154} | L_{C738} | R^{D133} | R^{D120} |
| L_{C163} | R^{D163} | R^{D163} | L_{C355} | R^{D10} | R^{D87} | L_{C547} | R^{D116} | R^{D155} | L_{C739} | R^{D133} | R^{D133} |
| L_{C164} | R^{D164} | R^{D164} | L_{C356} | R^{D10} | R^{D88} | L_{C548} | R^{D116} | R^{D161} | L_{C740} | R^{D133} | R^{D134} |
| L_{C165} | R^{D165} | R^{D165} | L_{C357} | R^{D10} | R^{D89} | L_{C549} | R^{D116} | R^{D175} | L_{C741} | R^{D133} | R^{D135} |
| L_{C166} | R^{D166} | R^{D166} | L_{C358} | R^{D10} | R^{D93} | L_{C550} | R^{D143} | R^{D3} | L_{C742} | R^{D133} | R^{D136} |
| L_{C167} | R^{D167} | R^{D167} | L_{C359} | R^{D10} | R^{D116} | L_{C551} | R^{D143} | R^{D5} | L_{C743} | R^{D133} | R^{D146} |
| L_{C168} | R^{D168} | R^{D168} | L_{C360} | R^{D10} | R^{D117} | L_{C552} | R^{D143} | R^{D17} | L_{C744} | R^{D133} | R^{D147} |
| L_{C169} | R^{D169} | R^{D169} | L_{C361} | R^{D10} | R^{D118} | L_{C553} | R^{D143} | R^{D18} | L_{C745} | R^{D133} | R^{D149} |
| L_{C170} | R^{D170} | R^{D170} | L_{C362} | R^{D10} | R^{D119} | L_{C554} | R^{D143} | R^{D20} | L_{C746} | R^{D133} | R^{D151} |
| L_{C171} | R^{D171} | R^{D171} | L_{C363} | R^{D10} | R^{D120} | L_{C555} | R^{D143} | R^{D22} | L_{C747} | R^{D133} | R^{D154} |
| L_{C172} | R^{D172} | R^{D172} | L_{C364} | R^{D10} | R^{D133} | L_{C556} | R^{D143} | R^{D37} | L_{C748} | R^{D133} | R^{D155} |
| L_{C173} | R^{D173} | R^{D173} | L_{C365} | R^{D10} | R^{D134} | L_{C557} | R^{D143} | R^{D40} | L_{C749} | R^{D133} | R^{D161} |
| L_{C174} | R^{D174} | R^{D174} | L_{C366} | R^{D10} | R^{D135} | L_{C558} | R^{D143} | R^{D41} | L_{C750} | R^{D133} | R^{D175} |
| L_{C175} | R^{D175} | R^{D175} | L_{C367} | R^{D10} | R^{D136} | L_{C559} | R^{D143} | R^{D42} | L_{C751} | R^{D175} | R^{D3} |
| L_{C176} | R^{D176} | R^{D176} | L_{C368} | R^{D10} | R^{D143} | L_{C560} | R^{D143} | R^{D43} | L_{C752} | R^{D175} | R^{D5} |
| L_{C177} | R^{D177} | R^{D177} | L_{C369} | R^{D10} | R^{D144} | L_{C561} | R^{D143} | R^{D48} | L_{C753} | R^{D175} | R^{D18} |
| L_{C178} | R^{D178} | R^{D178} | L_{C370} | R^{D10} | R^{D145} | L_{C562} | R^{D143} | R^{D49} | L_{C754} | R^{D175} | R^{D20} |
| L_{C179} | R^{D179} | R^{D179} | L_{C371} | R^{D10} | R^{D146} | L_{C563} | R^{D143} | R^{D54} | L_{C755} | R^{D175} | R^{D22} |
| L_{C180} | R^{D180} | R^{D180} | L_{C372} | R^{D10} | R^{D147} | L_{C564} | R^{D143} | R^{D58} | L_{C756} | R^{D175} | R^{D37} |
| L_{C181} | R^{D181} | R^{D181} | L_{C373} | R^{D10} | R^{D149} | L_{C565} | R^{D143} | R^{D59} | L_{C757} | R^{D175} | R^{D40} |
| L_{C182} | R^{D182} | R^{D182} | L_{C374} | R^{D10} | R^{D151} | L_{C566} | R^{D143} | R^{D78} | L_{C758} | R^{D175} | R^{D41} |
| L_{C183} | R^{D183} | R^{D183} | L_{C375} | R^{D10} | R^{D154} | L_{C567} | R^{D143} | R^{D79} | L_{C759} | R^{D175} | R^{D42} |
| L_{C184} | R^{D184} | R^{D184} | L_{C376} | R^{D10} | R^{D155} | L_{C568} | R^{D143} | R^{D81} | L_{C760} | R^{D175} | R^{D43} |
| L_{C185} | R^{D185} | R^{D185} | L_{C377} | R^{D10} | R^{D161} | L_{C569} | R^{D143} | R^{D87} | L_{C761} | R^{D175} | R^{D48} |
| L_{C186} | R^{D186} | R^{D186} | L_{C378} | R^{D10} | R^{D175} | L_{C570} | R^{D143} | R^{D88} | L_{C762} | R^{D175} | R^{D49} |
| L_{C187} | R^{D187} | R^{D187} | L_{C379} | R^{D17} | R^{D3} | L_{C571} | R^{D143} | R^{D59} | L_{C763} | R^{D175} | R^{D54} |
| L_{C188} | R^{D188} | R^{D188} | L_{C380} | R^{D17} | R^{D5} | L_{C572} | R^{D143} | R^{D93} | L_{C764} | R^{D175} | R^{D58} |
| L_{C189} | R^{D189} | R^{D189} | L_{C381} | R^{D17} | R^{D18} | L_{C573} | R^{D143} | R^{D116} | L_{C765} | R^{D175} | R^{D59} |
| L_{C190} | R^{D190} | R^{D190} | L_{C382} | R^{D17} | R^{D20} | L_{C574} | R^{D143} | R^{D117} | L_{C766} | R^{D175} | R^{D78} |
| L_{C191} | R^{D191} | R^{D191} | L_{C383} | R^{D17} | R^{D22} | L_{C575} | R^{D143} | R^{D118} | L_{C767} | R^{D175} | R^{D79} |
| L_{C192} | R^{D192} | R^{D192} | L_{C384} | R^{D17} | R^{D37} | L_{C576} | R^{D143} | R^{D119} | L_{C768} | R^{D175} | R^{D81} |
| L_{C769} | R^{D193} | R^{D193} | L_{C877} | R^{D1} | R^{D193} | L_{C985} | R^{D4} | R^{D193} | L_{C1093} | R^{D9} | R^{D193} |
| L_{C770} | R^{D194} | R^{D194} | L_{C878} | R^{D1} | R^{D194} | L_{C986} | R^{D4} | R^{D194} | L_{C1094} | R^{D9} | R^{D194} |
| L_{C771} | R^{D195} | R^{D195} | L_{C879} | R^{D1} | R^{D195} | L_{C987} | R^{D4} | R^{D195} | L_{C1095} | R^{D9} | R^{D195} |
| L_{C772} | R^{D196} | R^{D196} | L_{C880} | R^{D1} | R^{D196} | L_{C988} | R^{D4} | R^{D196} | L_{C1096} | R^{D9} | R^{D196} |
| L_{C773} | R^{D197} | R^{D197} | L_{C881} | R^{D1} | R^{D197} | L_{C989} | R^{D4} | R^{D197} | L_{C1097} | R^{D9} | R^{D197} |
| L_{C774} | R^{D198} | R^{D198} | L_{C882} | R^{D1} | R^{D198} | L_{C990} | R^{D4} | R^{D198} | L_{C1098} | R^{D9} | R^{D198} |
| L_{C775} | R^{D199} | R^{D199} | L_{C883} | R^{D1} | R^{D199} | L_{C991} | R^{D4} | R^{D199} | L_{C1099} | R^{D9} | R^{D199} |
| L_{C776} | R^{D200} | R^{D200} | L_{C884} | R^{D1} | R^{D200} | L_{C992} | R^{D4} | R^{D200} | L_{C1100} | R^{D9} | R^{D200} |
| L_{C777} | R^{D201} | R^{D201} | L_{C885} | R^{D1} | R^{D201} | L_{C993} | R^{D4} | R^{D201} | L_{C1101} | R^{D9} | R^{D201} |
| L_{C778} | R^{D202} | R^{D202} | L_{C886} | R^{D1} | R^{D202} | L_{C994} | R^{D4} | R^{D202} | L_{C1102} | R^{D9} | R^{D202} |
| L_{C779} | R^{D203} | R^{D203} | L_{C887} | R^{D1} | R^{D203} | L_{C995} | R^{D4} | R^{D203} | L_{C1103} | R^{D9} | R^{D203} |
| L_{C780} | R^{D204} | R^{D204} | L_{C888} | R^{D1} | R^{D204} | L_{C996} | R^{D4} | R^{D204} | L_{C1104} | R^{D9} | R^{D204} |
| L_{C781} | R^{D205} | R^{D205} | L_{C889} | R^{D1} | R^{D205} | L_{C997} | R^{D4} | R^{D205} | L_{C1105} | R^{D9} | R^{D205} |
| L_{C782} | R^{D206} | R^{D206} | L_{C890} | R^{D1} | R^{D206} | L_{C998} | R^{D4} | R^{D206} | L_{C1106} | R^{D9} | R^{D206} |
| L_{C783} | R^{D207} | R^{D207} | L_{C891} | R^{D1} | R^{D207} | L_{C999} | R^{D4} | R^{D207} | L_{C1107} | R^{D9} | R^{D207} |
| L_{C784} | R^{D208} | R^{D208} | L_{C892} | R^{D1} | R^{D208} | L_{C1000} | R^{D4} | R^{D208} | L_{C1108} | R^{D9} | R^{D208} |
| L_{C785} | R^{D209} | R^{D209} | L_{C893} | R^{D1} | R^{D209} | L_{C1001} | R^{D4} | R^{D209} | L_{C1109} | R^{D9} | R^{D209} |
| L_{C786} | R^{D210} | R^{D210} | L_{C894} | R^{D1} | R^{D210} | L_{C1002} | R^{D4} | R^{D210} | L_{C1110} | R^{D9} | R^{D210} |
| L_{C787} | R^{D211} | R^{D211} | L_{C895} | R^{D1} | R^{D211} | L_{C1003} | R^{D4} | R^{D211} | L_{C1111} | R^{D9} | R^{D211} |
| L_{C788} | R^{D212} | R^{D212} | L_{C896} | R^{D1} | R^{D212} | L_{C1004} | R^{D4} | R^{D212} | L_{C1112} | R^{D9} | R^{D212} |
| L_{C789} | R^{D213} | R^{D213} | L_{C897} | R^{D1} | R^{D213} | L_{C1005} | R^{D4} | R^{D213} | L_{C1113} | R^{D9} | R^{D213} |
| L_{C790} | R^{D214} | R^{D214} | L_{C898} | R^{D1} | R^{D214} | L_{C1006} | R^{D4} | R^{D214} | L_{C1114} | R^{D9} | R^{D214} |
| L_{C791} | R^{D215} | R^{D215} | L_{C899} | R^{D1} | R^{D215} | L_{C1007} | R^{D4} | R^{D215} | L_{C1115} | R^{D9} | R^{D215} |
| L_{C792} | R^{D216} | R^{D216} | L_{C900} | R^{D1} | R^{D216} | L_{C1008} | R^{D4} | R^{D216} | L_{C1116} | R^{D9} | R^{D216} |
| L_{C793} | R^{D217} | R^{D217} | L_{C901} | R^{D1} | R^{D217} | L_{C1009} | R^{D4} | R^{D217} | L_{C1117} | R^{D9} | R^{D217} |
| L_{C794} | R^{D218} | R^{D218} | L_{C902} | R^{D1} | R^{D218} | L_{C1010} | R^{D4} | R^{D218} | L_{C1118} | R^{D9} | R^{D218} |
| L_{C795} | R^{D219} | R^{D219} | L_{C903} | R^{D1} | R^{D219} | L_{C1011} | R^{D4} | R^{D219} | L_{C1119} | R^{D9} | R^{D219} |
| L_{C796} | R^{D220} | R^{D220} | L_{C904} | R^{D1} | R^{D220} | L_{C1012} | R^{D4} | R^{D220} | L_{C1120} | R^{D9} | R^{D220} |
| L_{C797} | R^{D221} | R^{D221} | L_{C905} | R^{D1} | R^{D221} | L_{C1013} | R^{D4} | R^{D221} | L_{C1121} | R^{D9} | R^{D221} |
| L_{C798} | R^{D222} | R^{D222} | L_{C906} | R^{D1} | R^{D222} | L_{C1014} | R^{D4} | R^{D222} | L_{C1122} | R^{D9} | R^{D222} |
| L_{C799} | R^{D223} | R^{D223} | L_{C907} | R^{D1} | R^{D223} | L_{C1015} | R^{D4} | R^{D223} | L_{C1123} | R^{D9} | R^{D223} |
| L_{C800} | R^{D224} | R^{D224} | L_{C908} | R^{D1} | R^{D224} | L_{C1016} | R^{D4} | R^{D224} | L_{C1124} | R^{D9} | R^{D224} |
| L_{C801} | R^{D225} | R^{D225} | L_{C909} | R^{D1} | R^{D225} | L_{C1017} | R^{D4} | R^{D225} | L_{C1125} | R^{D9} | R^{D225} |
| L_{C802} | R^{D226} | R^{D226} | L_{C910} | R^{D1} | R^{D226} | L_{C1018} | R^{D4} | R^{D226} | L_{C1126} | R^{D9} | R^{D226} |
| L_{C803} | R^{D227} | R^{D227} | L_{C911} | R^{D1} | R^{D227} | L_{C1019} | R^{D4} | R^{D227} | L_{C1127} | R^{D9} | R^{D227} |
| L_{C804} | R^{D228} | R^{D228} | L_{C912} | R^{D1} | R^{D228} | L_{C1020} | R^{D4} | R^{D228} | L_{C1128} | R^{D9} | R^{D228} |
| L_{C805} | R^{D229} | R^{D229} | L_{C913} | R^{D1} | R^{D229} | L_{C1021} | R^{D4} | R^{D229} | L_{C1129} | R^{D9} | R^{D229} |
| L_{C806} | R^{D230} | R^{D230} | L_{C914} | R^{D1} | R^{D230} | L_{C1022} | R^{D4} | R^{D230} | L_{C1130} | R^{D9} | R^{D230} |
| L_{C807} | R^{D231} | R^{D231} | L_{C915} | R^{D1} | R^{D231} | L_{C1023} | R^{D4} | R^{D231} | L_{C1131} | R^{D9} | R^{D231} |
| L_{C808} | R^{D232} | R^{D232} | L_{C916} | R^{D1} | R^{D232} | L_{C1024} | R^{D4} | R^{D232} | L_{C1132} | R^{D9} | R^{D232} |
| L_{C809} | R^{D233} | R^{D233} | L_{C917} | R^{D1} | R^{D233} | L_{C1025} | R^{D4} | R^{D233} | L_{C1133} | R^{D9} | R^{D233} |
| L_{C810} | R^{D234} | R^{D234} | L_{C918} | R^{D1} | R^{D234} | L_{C1026} | R^{D4} | R^{D234} | L_{C1134} | R^{D9} | R^{D234} |
| L_{C811} | R^{D235} | R^{D235} | L_{C919} | R^{D1} | R^{D235} | L_{C1027} | R^{D4} | R^{D235} | L_{C1135} | R^{D9} | R^{D235} |
| L_{C812} | R^{D236} | R^{D236} | L_{C920} | R^{D1} | R^{D236} | L_{C1028} | R^{D4} | R^{D236} | L_{C1136} | R^{D9} | R^{D236} |
| L_{C813} | R^{D237} | R^{D237} | L_{C921} | R^{D1} | R^{D237} | L_{C1029} | R^{D4} | R^{D237} | L_{C1137} | R^{D9} | R^{D237} |
| L_{C814} | R^{D238} | R^{D238} | L_{C922} | R^{D1} | R^{D238} | L_{C1030} | R^{D4} | R^{D238} | L_{C1138} | R^{D9} | R^{D238} |
| L_{C815} | R^{D239} | R^{D239} | L_{C923} | R^{D1} | R^{D239} | L_{C1031} | R^{D4} | R^{D239} | L_{C1139} | R^{D9} | R^{D239} |
| L_{C816} | R^{D240} | R^{D240} | L_{C924} | R^{D1} | R^{D240} | L_{C1032} | R^{D4} | R^{D240} | L_{C1140} | R^{D9} | R^{D240} |
| L_{C817} | R^{D241} | R^{D241} | L_{C925} | R^{D1} | R^{D241} | L_{C1033} | R^{D4} | R^{D241} | L_{C1141} | R^{D9} | R^{D241} |
| L_{C818} | R^{D242} | R^{D242} | L_{C926} | R^{D1} | R^{D242} | L_{C1034} | R^{D4} | R^{D242} | L_{C1142} | R^{D9} | R^{D242} |
| L_{C819} | R^{D243} | R^{D243} | L_{C927} | R^{D1} | R^{D243} | L_{C1035} | R^{D4} | R^{D243} | L_{C1143} | R^{D9} | R^{D243} |
| L_{C820} | R^{D244} | R^{D244} | L_{C928} | R^{D1} | R^{D244} | L_{C1036} | R^{D4} | R^{D244} | L_{C1144} | R^{D9} | R^{D244} |
| L_{C821} | R^{D245} | R^{D245} | L_{C929} | R^{D1} | R^{D245} | L_{C1037} | R^{D4} | R^{D245} | L_{C1145} | R^{D9} | R^{D245} |
| L_{C822} | R^{D246} | R^{D246} | L_{C930} | R^{D1} | R^{D246} | L_{C1032} | R^{D4} | R^{D246} | L_{C1146} | R^{D9} | R^{D246} |
| L_{C823} | R^{D17} | R^{D193} | L_{C931} | R^{D50} | R^{D193} | L_{C1039} | R^{D145} | R^{D193} | L_{C1147} | R^{D168} | R^{D193} |
| L_{C824} | R^{D17} | R^{D194} | L_{C932} | R^{D50} | R^{D194} | L_{C1040} | R^{D145} | R^{D194} | L_{C1148} | R^{D168} | R^{D194} |
| L_{C825} | R^{D17} | R^{D195} | L_{C933} | R^{D50} | R^{D195} | L_{C1041} | R^{D145} | R^{D195} | L_{C1149} | R^{D168} | R^{D195} |
| L_{C826} | R^{D17} | R^{D196} | L_{C934} | R^{D50} | R^{D196} | L_{C1042} | R^{D145} | R^{D196} | L_{C1150} | R^{D168} | R^{D196} |
| L_{C827} | R^{D17} | R^{D197} | L_{C935} | R^{D50} | R^{D197} | L_{C1043} | R^{D145} | R^{D197} | L_{C1151} | R^{D168} | R^{D197} |
| L_{C828} | R^{D17} | R^{D198} | L_{C936} | R^{D50} | R^{D198} | L_{C1044} | R^{D145} | R^{D198} | L_{C1152} | R^{D168} | R^{D198} |
| L_{C829} | R^{D17} | R^{D199} | L_{C937} | R^{D50} | R^{D199} | L_{C1045} | R^{D145} | R^{D199} | L_{C1153} | R^{D168} | R^{D199} |
| L_{C830} | R^{D17} | R^{D200} | L_{C938} | R^{D50} | R^{D200} | L_{C1046} | R^{D145} | R^{D200} | L_{C1154} | R^{D168} | R^{D200} |
| L_{C831} | R^{D17} | R^{D201} | L_{C939} | R^{D50} | R^{D201} | L_{C1047} | R^{D145} | R^{D201} | L_{C1155} | R^{D168} | R^{D201} |
| L_{C832} | R^{D17} | R^{D202} | L_{C940} | R^{D50} | R^{D202} | L_{C1048} | R^{D145} | R^{D202} | L_{C1156} | R^{D168} | R^{D202} |
| L_{C833} | R^{D17} | R^{D203} | L_{C941} | R^{D50} | R^{D203} | L_{C1049} | R^{D145} | R^{D203} | L_{C1157} | R^{D168} | R^{D203} |
| L_{C834} | R^{D17} | R^{D204} | L_{C942} | R^{D50} | R^{D204} | L_{C1050} | R^{D145} | R^{D204} | L_{C1158} | R^{D168} | R^{D204} |
| L_{C835} | R^{D17} | R^{D205} | L_{C943} | R^{D50} | R^{D205} | L_{C1051} | R^{D145} | R^{D205} | L_{C1159} | R^{D168} | R^{D205} |
| L_{C836} | R^{D17} | R^{D206} | L_{C944} | R^{D50} | R^{D206} | L_{C1052} | R^{D145} | R^{D206} | L_{C1160} | R^{D168} | R^{D206} |
| L_{C837} | R^{D17} | R^{D207} | L_{C945} | R^{D50} | R^{D207} | L_{C1053} | R^{D145} | R^{D207} | L_{C1161} | R^{D168} | R^{D207} |
| L_{C838} | R^{D17} | R^{D208} | L_{C946} | R^{D50} | R^{D208} | L_{C1054} | R^{D145} | R^{D208} | L_{C1162} | R^{D168} | R^{D208} |
| L_{C839} | R^{D17} | R^{D209} | L_{C947} | R^{D50} | R^{D209} | L_{C1055} | R^{D145} | R^{D209} | L_{C1163} | R^{D168} | R^{D209} |
| L_{C840} | R^{D17} | R^{D210} | L_{C948} | R^{D50} | R^{D210} | L_{C1056} | R^{D145} | R^{D210} | L_{C1164} | R^{D168} | R^{D210} |
| L_{C841} | R^{D17} | R^{D211} | L_{C949} | R^{D50} | R^{D211} | L_{C1057} | R^{D145} | R^{D211} | L_{C1165} | R^{D168} | R^{D211} |
| L_{C842} | R^{D17} | R^{D212} | L_{C950} | R^{D50} | R^{D212} | L_{C1058} | R^{D145} | R^{D212} | L_{C1166} | R^{D168} | R^{D212} |
| L_{C843} | R^{D17} | R^{D213} | L_{C951} | R^{D50} | R^{D213} | L_{C1059} | R^{D145} | R^{D213} | L_{C1167} | R^{D168} | R^{D213} |
| L_{C844} | R^{D17} | R^{D214} | L_{C952} | R^{D50} | R^{D214} | L_{C1060} | R^{D145} | R^{D214} | L_{C1168} | R^{D168} | R^{D214} |
| L_{C845} | R^{D17} | R^{D215} | L_{C953} | R^{D50} | R^{D215} | L_{C1061} | R^{D145} | R^{D215} | L_{C1169} | R^{D168} | R^{D215} |
| L_{C846} | R^{D17} | R^{D216} | L_{C954} | R^{D50} | R^{D216} | L_{C1062} | R^{D145} | R^{D216} | L_{C1170} | R^{D168} | R^{D216} |
| L_{C847} | R^{D17} | R^{D217} | L_{C955} | R^{D50} | R^{D217} | L_{C1063} | R^{D145} | R^{D217} | L_{C1171} | R^{D168} | R^{D217} |
| L_{C848} | R^{D17} | R^{D218} | L_{C956} | R^{D50} | R^{D218} | L_{C1064} | R^{D145} | R^{D218} | L_{C1172} | R^{D168} | R^{D218} |
| L_{C849} | R^{D17} | R^{D219} | L_{C957} | R^{D50} | R^{D219} | L_{C1065} | R^{D145} | R^{D219} | L_{C1173} | R^{D168} | R^{D219} |
| L_{C850} | R^{D17} | R^{D220} | L_{C958} | R^{D50} | R^{D220} | L_{C1066} | R^{D145} | R^{D220} | L_{C1174} | R^{D168} | R^{D220} |
| L_{C851} | R^{D17} | R^{D221} | L_{C959} | R^{D50} | R^{D221} | L_{C1067} | R^{D145} | R^{D221} | L_{C1175} | R^{D168} | R^{D221} |
| L_{C852} | R^{D17} | R^{D222} | L_{C960} | R^{D50} | R^{D222} | L_{C1032} | R^{D145} | R^{D222} | L_{C1176} | R^{D168} | R^{D222} |
| L_{C853} | R^{D17} | R^{D223} | L_{C961} | R^{D50} | R^{D223} | L_{C1069} | R^{D145} | R^{D223} | L_{C1177} | R^{D168} | R^{D223} |
| L_{C854} | R^{D17} | R^{D224} | L_{C962} | R^{D50} | R^{D224} | L_{C1070} | R^{D145} | R^{D224} | L_{C1178} | R^{D168} | R^{D224} |
| L_{C855} | R^{D17} | R^{D225} | L_{C963} | R^{D50} | R^{D225} | L_{C1071} | R^{D145} | R^{D225} | L_{C1179} | R^{D168} | R^{D225} |
| L_{C856} | R^{D17} | R^{D226} | L_{C964} | R^{D50} | R^{D226} | L_{C1072} | R^{D145} | R^{D226} | L_{C1180} | R^{D168} | R^{D226} |
| L_{C857} | R^{D17} | R^{D227} | L_{C965} | R^{D50} | R^{D227} | L_{C1073} | R^{D145} | R^{D227} | L_{C1181} | R^{D168} | R^{D227} |
| L_{C858} | R^{D17} | R^{D228} | L_{C966} | R^{D50} | R^{D228} | L_{C1074} | R^{D145} | R^{D228} | L_{C1182} | R^{D168} | R^{D228} |
| L_{C859} | R^{D17} | R^{D229} | L_{C967} | R^{D50} | R^{D229} | L_{C1075} | R^{D145} | R^{D229} | L_{C1183} | R^{D168} | R^{D229} |
| L_{C860} | R^{D17} | R^{D230} | L_{C968} | R^{D50} | R^{D230} | L_{C1076} | R^{D145} | R^{D230} | L_{C1184} | R^{D168} | R^{D230} |
| L_{C861} | R^{D17} | R^{D231} | L_{C969} | R^{D50} | R^{D231} | L_{C1077} | R^{D145} | R^{D231} | L_{C1185} | R^{D168} | R^{D231} |
| L_{C862} | R^{D17} | R^{D232} | L_{C970} | R^{D50} | R^{D232} | L_{C1078} | R^{D145} | R^{D232} | L_{C1186} | R^{D168} | R^{D232} |
| L_{C863} | R^{D17} | R^{D233} | L_{C971} | R^{D50} | R^{D233} | L_{C1079} | R^{D145} | R^{D233} | L_{C1187} | R^{D168} | R^{D233} |
| L_{C864} | R^{D17} | R^{D234} | L_{C972} | R^{D50} | R^{D234} | L_{C1080} | R^{D145} | R^{D234} | L_{C1188} | R^{D168} | R^{D234} |
| L_{C865} | R^{D17} | R^{D235} | L_{C973} | R^{D50} | R^{D235} | L_{C1081} | R^{D145} | R^{D235} | L_{C1189} | R^{D168} | R^{D235} |
| L_{C866} | R^{D17} | R^{D236} | L_{C974} | R^{D50} | R^{D236} | L_{C1082} | R^{D145} | R^{D236} | L_{C1190} | R^{D168} | R^{D236} |
| L_{C867} | R^{D17} | R^{D237} | L_{C975} | R^{D50} | R^{D237} | L_{C1083} | R^{D145} | R^{D237} | L_{C1191} | R^{D168} | R^{D237} |
| L_{C868} | R^{D17} | R^{D238} | L_{C976} | R^{D50} | R^{D238} | L_{C1084} | R^{D145} | R^{D238} | L_{C1192} | R^{D168} | R^{D238} |
| L_{C869} | R^{D17} | R^{D239} | L_{C977} | R^{D50} | R^{D239} | L_{C1032} | R^{D145} | R^{D239} | L_{C1193} | R^{D168} | R^{D239} |
| L_{C870} | R^{D17} | R^{D240} | L_{C978} | R^{D50} | R^{D240} | L_{C1086} | R^{D145} | R^{D240} | L_{C1194} | R^{D168} | R^{D240} |
| L_{C871} | R^{D17} | R^{D241} | L_{C979} | R^{D50} | R^{D241} | L_{C1087} | R^{D145} | R^{D241} | L_{C1195} | R^{D168} | R^{D241} |
| L_{C872} | R^{D17} | R^{D242} | L_{C980} | R^{D50} | R^{D242} | L_{C1032} | R^{D145} | R^{D242} | L_{C1196} | R^{D168} | R^{D242} |
| L_{C873} | R^{D17} | R^{D243} | L_{C981} | R^{D50} | R^{D243} | L_{C1089} | R^{D145} | R^{D243} | L_{C1197} | R^{D168} | R^{D243} |
| L_{C874} | R^{D17} | R^{D244} | L_{C982} | R^{D50} | R^{D244} | L_{C1090} | R^{D145} | R^{D244} | L_{C1198} | R^{D168} | R^{D244} |
| L_{C875} | R^{D17} | R^{D245} | L_{C983} | R^{D50} | R^{D245} | L_{C1091} | R^{D145} | R^{D245} | L_{C1199} | R^{D168} | R^{D245} |
| L_{C876} | R^{D17} | R^{D246} | L_{C984} | R^{D50} | R^{D246} | L_{C1092} | R^{D145} | R^{D246} | L_{C1200} | R^{D168} | R^{D246} |
| L_{C1201} | R^{D10} | R^{D193} | L_{C1255} | R^{D55} | R^{D193} | L_{C1309} | R^{D37} | R^{D193} | L_{C1363} | R^{D143} | R^{D193} |
| L_{C1202} | R^{D10} | R^{D194} | L_{C1256} | R^{D55} | R^{D194} | L_{C1310} | R^{D37} | R^{D194} | L_{C1364} | R^{D143} | R^{D194} |
| L_{C1203} | R^{D10} | R^{D195} | L_{C1257} | R^{D55} | R^{D195} | L_{C1311} | R^{D37} | R^{D195} | L_{C1365} | R^{D143} | R^{D195} |
| L_{C1204} | R^{D10} | R^{D196} | L_{C1258} | R^{D55} | R^{D196} | L_{C1312} | R^{D37} | R^{D196} | L_{C1366} | R^{D143} | R^{D196} |
| L_{C1205} | R^{D10} | R^{D197} | L_{C1259} | R^{D55} | R^{D197} | L_{C1313} | R^{D37} | R^{D197} | L_{C1367} | R^{D143} | R^{D197} |
| L_{C1206} | R^{D10} | R^{D198} | L_{C1260} | R^{D55} | R^{D198} | L_{C1314} | R^{D37} | R^{D198} | L_{C1368} | R^{D143} | R^{D198} |
| L_{C1207} | R^{D10} | R^{D199} | L_{C1261} | R^{D55} | R^{D199} | L_{C1315} | R^{D37} | R^{D199} | L_{C1369} | R^{D143} | R^{D199} |
| L_{C1208} | R^{D10} | R^{D200} | L_{C1262} | R^{D55} | R^{D200} | L_{C1316} | R^{D37} | R^{D200} | L_{C1370} | R^{D143} | R^{D200} |
| L_{C1209} | R^{D10} | R^{D201} | L_{C1263} | R^{D55} | R^{D201} | L_{C1317} | R^{D37} | R^{D201} | L_{C1371} | R^{D143} | R^{D201} |
| L_{C1210} | R^{D10} | R^{D202} | L_{C1264} | R^{D55} | R^{D202} | L_{C1318} | R^{D37} | R^{D202} | L_{C1372} | R^{D143} | R^{D202} |
| L_{C1211} | R^{D10} | R^{D203} | L_{C1265} | R^{D55} | R^{D203} | L_{C1319} | R^{D37} | R^{D203} | L_{C1373} | R^{D143} | R^{D203} |
| L_{C1212} | R^{D10} | R^{D204} | L_{C1266} | R^{D55} | R^{D204} | L_{C1320} | R^{D37} | R^{D204} | L_{C1374} | R^{D143} | R^{D204} |
| L_{C1213} | R^{D10} | R^{D205} | L_{C1267} | R^{D55} | R^{D205} | L_{C1321} | R^{D37} | R^{D205} | L_{C1375} | R^{D143} | R^{D205} |
| L_{C1214} | R^{D10} | R^{D206} | L_{C1268} | R^{D55} | R^{D206} | L_{C1322} | R^{D37} | R^{D206} | L_{C1376} | R^{D143} | R^{D206} |
| L_{C1215} | R^{D10} | R^{D207} | L_{C1269} | R^{D55} | R^{D207} | L_{C1323} | R^{D37} | R^{D207} | L_{C1377} | R^{D143} | R^{D207} |
| L_{C1216} | R^{D10} | R^{D208} | L_{C1270} | R^{D55} | R^{D208} | L_{C1324} | R^{D37} | R^{D208} | L_{C1378} | R^{D143} | R^{D208} |
| L_{C1217} | R^{D10} | R^{D209} | L_{C1271} | R^{D55} | R^{D209} | L_{C1325} | R^{D37} | R^{D209} | L_{C1379} | R^{D143} | R^{D209} |
| L_{C1218} | R^{D10} | R^{D210} | L_{C1272} | R^{D55} | R^{D210} | L_{C1326} | R^{D37} | R^{D210} | L_{C1380} | R^{D143} | R^{D210} |
| L_{C1219} | R^{D10} | R^{D211} | L_{C1273} | R^{D55} | R^{D211} | L_{C1327} | R^{D37} | R^{D211} | L_{C1381} | R^{D143} | R^{D211} |
| L_{C1220} | R^{D10} | R^{D212} | L_{C1274} | R^{D55} | R^{D212} | L_{C1328} | R^{D37} | R^{D212} | L_{C1382} | R^{D143} | R^{D212} |
| L_{C1221} | R^{D10} | R^{D213} | L_{C1275} | R^{D55} | R^{D213} | L_{C1329} | R^{D37} | R^{D213} | L_{C1383} | R^{D143} | R^{D213} |
| L_{C1222} | R^{D10} | R^{D214} | L_{C1276} | R^{D55} | R^{D214} | L_{C1330} | R^{D37} | R^{D214} | L_{C1384} | R^{D143} | R^{D214} |
| L_{C1223} | R^{D10} | R^{D215} | L_{C1277} | R^{D55} | R^{D215} | L_{C1331} | R^{D37} | R^{D215} | L_{C1385} | R^{D143} | R^{D215} |
| L_{C1224} | R^{D10} | R^{D216} | L_{C1278} | R^{D55} | R^{D216} | L_{C1332} | R^{D37} | R^{D216} | L_{C1386} | R^{D143} | R^{D216} |
| L_{C1225} | R^{D10} | R^{D217} | L_{C1279} | R^{D55} | R^{D217} | L_{C1333} | R^{D37} | R^{D217} | L_{C1387} | R^{D143} | R^{D217} |
| L_{C1226} | R^{D10} | R^{D218} | L_{C1280} | R^{D55} | R^{D218} | L_{C1334} | R^{D37} | R^{D218} | L_{C1388} | R^{D143} | R^{D218} |
| L_{C1227} | R^{D10} | R^{D219} | L_{C1281} | R^{D55} | R^{D219} | L_{C1335} | R^{D37} | R^{D219} | L_{C1389} | R^{D143} | R^{D219} |
| L_{C1228} | R^{D10} | R^{D220} | L_{C1282} | R^{D55} | R^{D220} | L_{C1336} | R^{D37} | R^{D220} | L_{C1390} | R^{D143} | R^{D220} |
| L_{C1229} | R^{D10} | R^{D221} | L_{C1283} | R^{D55} | R^{D221} | L_{C1337} | R^{D37} | R^{D221} | L_{C1391} | R^{D143} | R^{D221} |
| L_{C1230} | R^{D10} | R^{D222} | L_{C1284} | R^{D55} | R^{D222} | L_{C1338} | R^{D37} | R^{D222} | L_{C1392} | R^{D143} | R^{D222} |
| L_{C1231} | R^{D10} | R^{D223} | L_{C1285} | R^{D55} | R^{D223} | L_{C1339} | R^{D37} | R^{D223} | L_{C1393} | R^{D143} | R^{D223} |
| L_{C1232} | R^{D10} | R^{D224} | L_{C1286} | R^{D55} | R^{D224} | L_{C1340} | R^{D37} | R^{D224} | L_{C1394} | R^{D143} | R^{D224} |
| L_{C1233} | R^{D10} | R^{D225} | L_{C1287} | R^{D55} | R^{D225} | L_{C1341} | R^{D37} | R^{D225} | L_{C1395} | R^{D143} | R^{D225} |
| L_{C1234} | R^{D10} | R^{D226} | L_{C1288} | R^{D55} | R^{D226} | L_{C1342} | R^{D37} | R^{D226} | L_{C1396} | R^{D143} | R^{D226} |
| L_{C1235} | R^{D10} | R^{D227} | L_{C1289} | R^{D55} | R^{D227} | L_{C1343} | R^{D37} | R^{D227} | L_{C1397} | R^{D143} | R^{D227} |
| L_{C1236} | R^{D10} | R^{D228} | L_{C1290} | R^{D55} | R^{D228} | L_{C1344} | R^{D37} | R^{D228} | L_{C1398} | R^{D143} | R^{D228} |
| L_{C1237} | R^{D10} | R^{D229} | L_{C1291} | R^{D55} | R^{D229} | L_{C1345} | R^{D37} | R^{D229} | L_{C1399} | R^{D143} | R^{D229} |
| L_{C1238} | R^{D10} | R^{D230} | L_{C1292} | R^{D55} | R^{D230} | L_{C1346} | R^{D37} | R^{D230} | L_{C1400} | R^{D143} | R^{D230} |
| L_{C1239} | R^{D10} | R^{D231} | L_{C1293} | R^{D55} | R^{D231} | L_{C1347} | R^{D37} | R^{D231} | L_{C1401} | R^{D143} | R^{D231} |
| L_{C1240} | R^{D10} | R^{D232} | L_{C1294} | R^{D55} | R^{D232} | L_{C1348} | R^{D37} | R^{D232} | L_{C1402} | R^{D143} | R^{D232} |
| L_{C1241} | R^{D10} | R^{D233} | L_{C1295} | R^{D55} | R^{D233} | L_{C1349} | R^{D37} | R^{D233} | L_{C1403} | R^{D143} | R^{D233} |
| L_{C1242} | R^{D10} | R^{D234} | L_{C1296} | R^{D55} | R^{D234} | L_{C1350} | R^{D37} | R^{D234} | L_{C1404} | R^{D143} | R^{D234} |
| L_{C1243} | R^{D10} | R^{D235} | L_{C1297} | R^{D55} | R^{D235} | L_{C1351} | R^{D37} | R^{D235} | L_{C1405} | R^{D143} | R^{D235} |
| L_{C1244} | R^{D10} | R^{D236} | L_{C1298} | R^{D55} | R^{D236} | L_{C1352} | R^{D37} | R^{D236} | L_{C1406} | R^{D143} | R^{D236} |
| L_{C1245} | R^{D10} | R^{D237} | L_{C1299} | R^{D55} | R^{D237} | L_{C1353} | R^{D37} | R^{D237} | L_{C1407} | R^{D143} | R^{D237} |
| L_{C1246} | R^{D10} | R^{D238} | L_{C1300} | R^{D55} | R^{D238} | L_{C1354} | R^{D37} | R^{D238} | L_{C1408} | R^{D143} | R^{D238} |
| L_{C1247} | R^{D10} | R^{D239} | L_{C1301} | R^{D55} | R^{D239} | L_{C1355} | R^{D37} | R^{D239} | L_{C1409} | R^{D143} | R^{D239} |
| L_{C1248} | R^{D10} | R^{D240} | L_{C1302} | R^{D55} | R^{D240} | L_{C1356} | R^{D37} | R^{D240} | L_{C1410} | R^{D143} | R^{D240} |
| L_{C1249} | R^{D10} | R^{D241} | L_{C1303} | R^{D55} | R^{D241} | L_{C1357} | R^{D37} | R^{D241} | L_{C1411} | R^{D143} | R^{D241} |
| L_{C1250} | R^{D10} | R^{D242} | L_{C1304} | R^{D55} | R^{D242} | L_{C1358} | R^{D37} | R^{D242} | L_{C1412} | R^{D143} | R^{D242} |
| L_{C1251} | R^{D10} | R^{D243} | L_{C1305} | R^{D55} | R^{D243} | L_{C1359} | R^{D37} | R^{D243} | L_{C1413} | R^{D143} | R^{D243} |
| L_{C1252} | R^{D10} | R^{D244} | L_{C1306} | R^{D55} | R^{D244} | L_{C1360} | R^{D37} | R^{D244} | L_{C1414} | R^{D143} | R^{D244} |
| L_{C1253} | R^{D10} | R^{D245} | L_{C1307} | R^{D55} | R^{D245} | L_{C1361} | R^{D37} | R^{D245} | L_{C1415} | R^{D143} | R^{D245} |
| L_{C1254} | R^{D10} | R^{D246} | L_{C1308} | R^{D55} | R^{D246} | L_{C1362} | R^{D37} | R^{D246} | L_{C1416} | R^{D143} | R^{D246} |

wherein R^{D1} to R^{D246} have the structures defined in the following LIST 15: 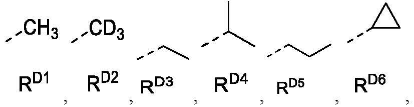 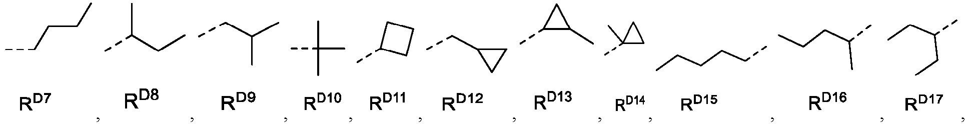 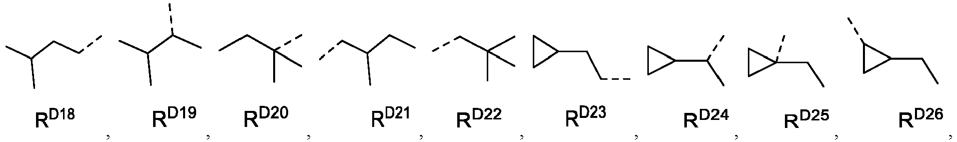 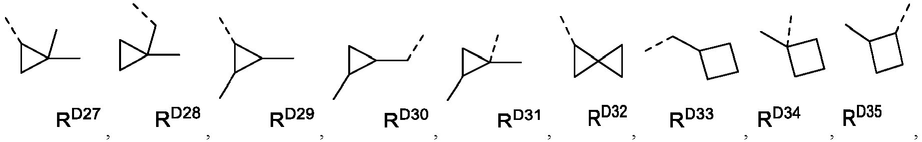 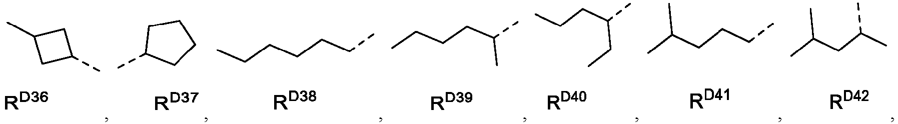 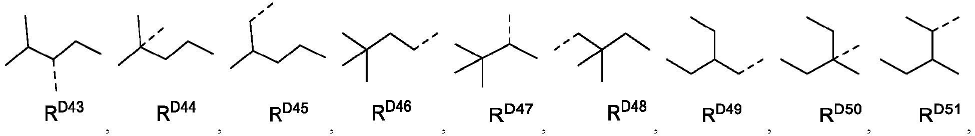 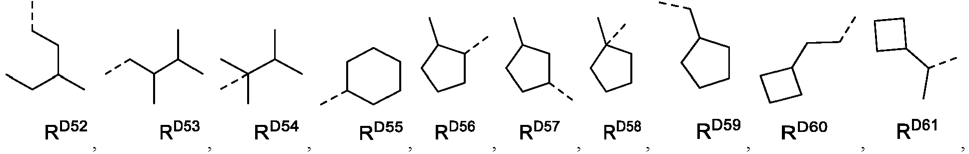 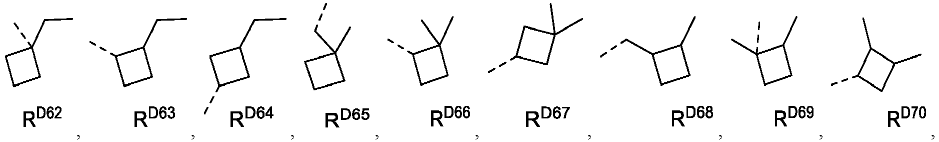 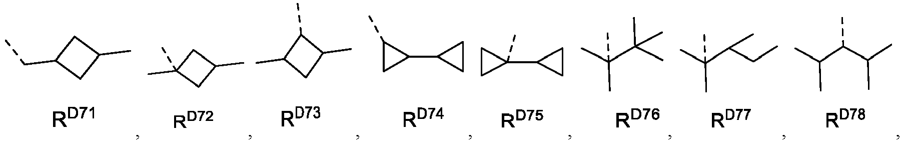 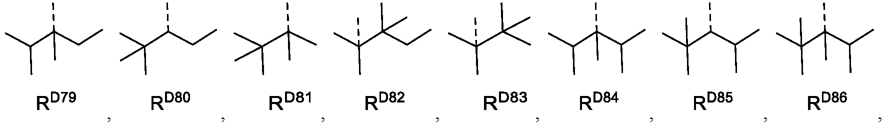 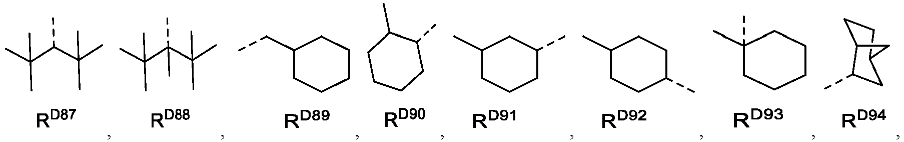 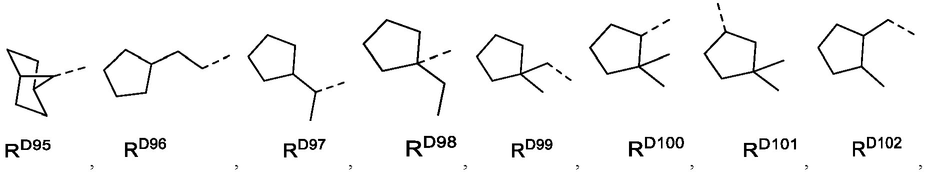 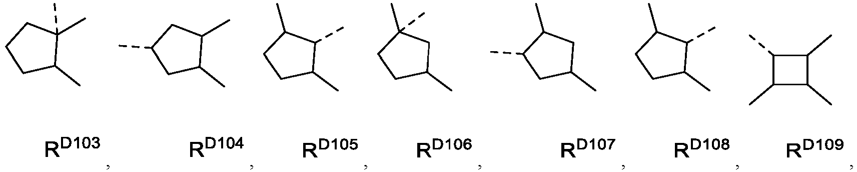 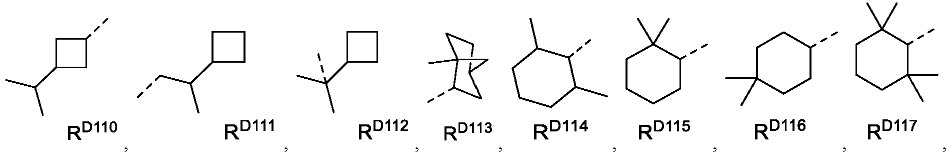 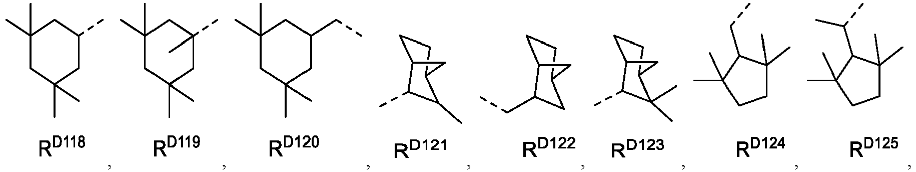 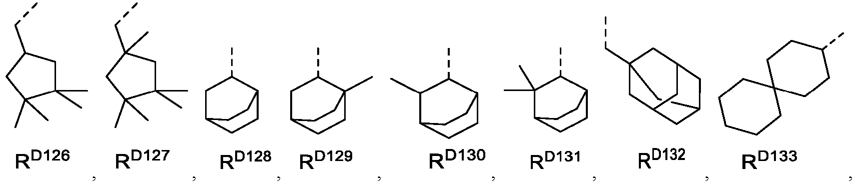 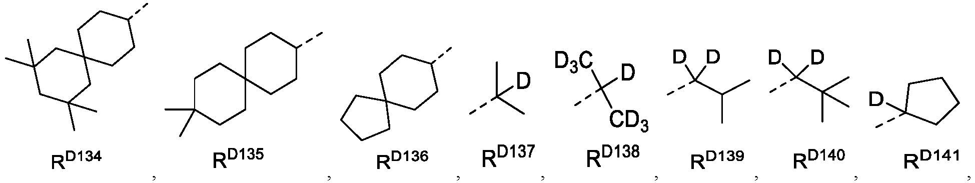 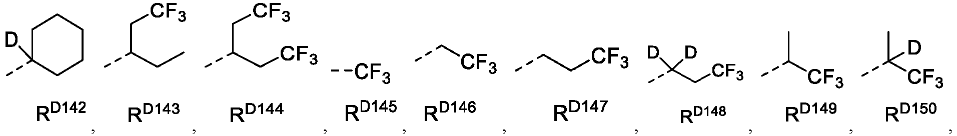 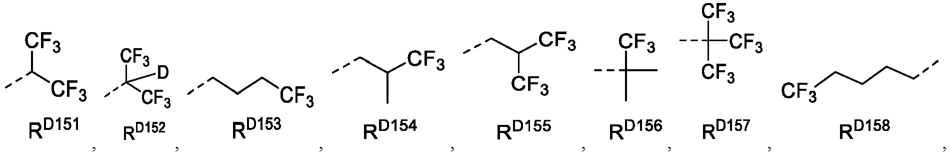 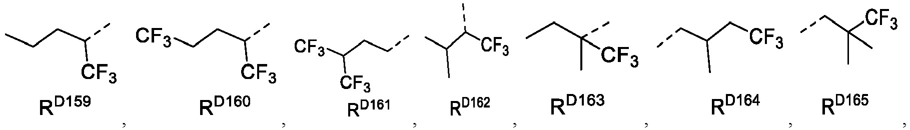 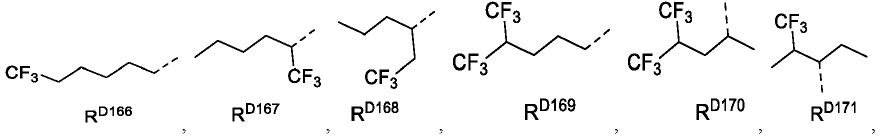 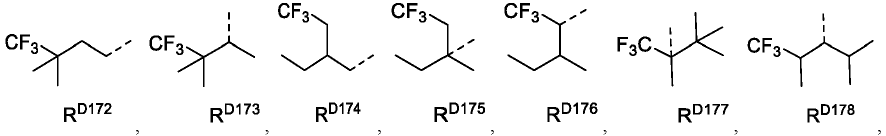 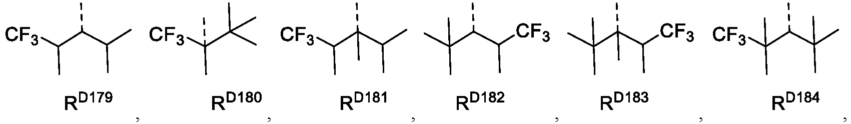 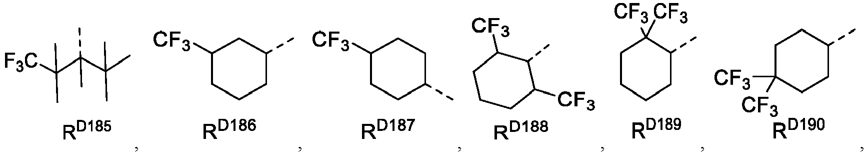 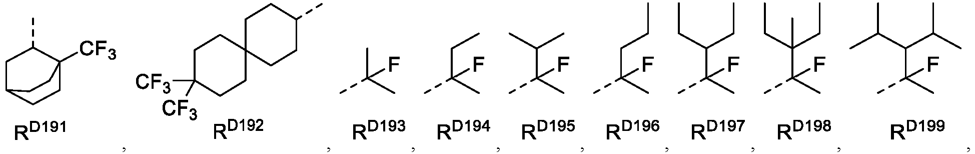 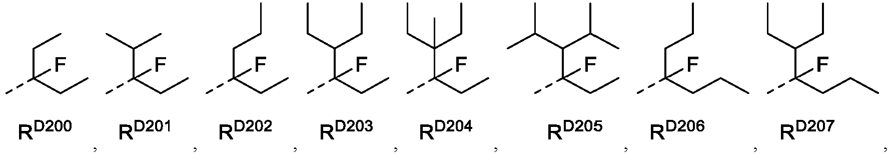 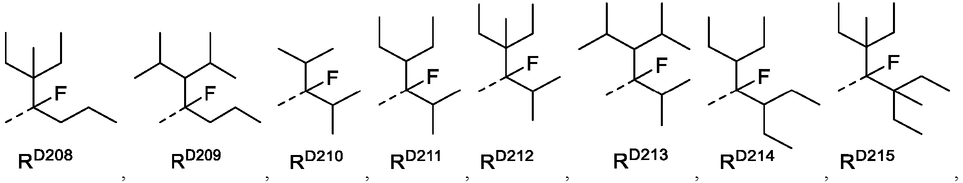 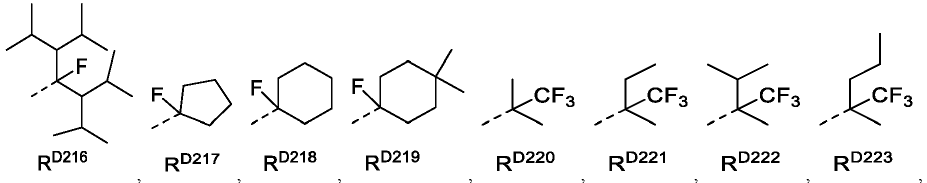 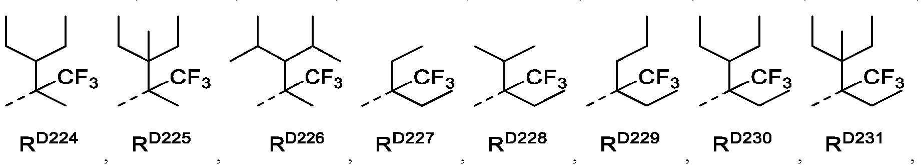 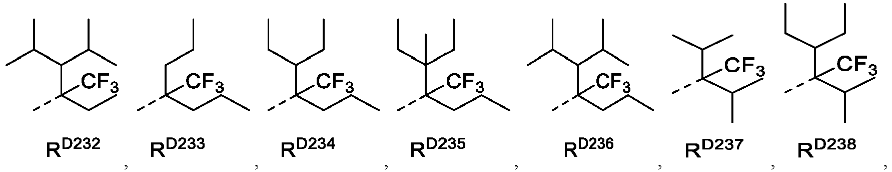 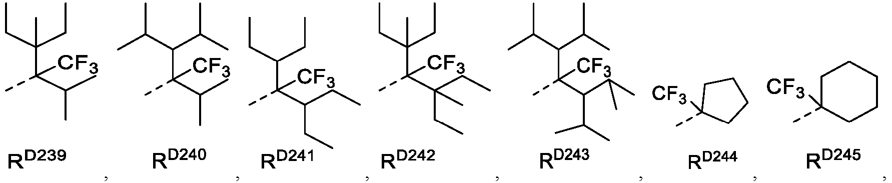 and

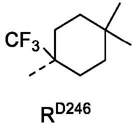

In some embodiments, the compound is selected from the group consisting of only those compounds whose L_{B*k*} corresponds to one of the following: L_{B1}, L_{B30}, L_{B31}, L_{B109}, L_{B110}, L_{B112}, L_{B113}, L_{B114}, L_{B125}, L_{B127}, L_{B138}, L_{B140}, L_{B149}, L_{B150}, L_{B170}, L_{B171}, L_{B172}, L_{B174}, L_{B208}, L_{B241}, L_{B312}, L_{B315}, L_{B356}, L_{B357}, L_{B367}, L_{B371}, L_{B382}, L_{B439}, L_{B440}, L_{B455}, L_{B456}, L_{B457}, L_{B458}, L_{B461}, L_{B462}, L_{B463}, L_{B469}, and L_{B476}.

In some embodiments, the compound is selected from the group consisting of only those compounds whose L_{B*k*} corresponds to one of the following: L_{B1}, L_{B30}, L_{B31}, L_{B125}, L_{B138}, L_{B171}, L_{B172}, L_{B356}, L_{B357}, L_{B367}, L_{B371}, L_{B382}, L_{B455}, and L_{B456}.

In some embodiments, the compound is selected from the group consisting of only those compounds having L_{C*j*-I} or L_{C*j*-II} ligand whose corresponding R²⁰¹ and R²⁰² are defined to be one of the following structures: R^{D1}, R^{D3}, R^{D4}, R^{D5}, R^{D9}, R^{D10}, R^{D17}, R^{D18}, R^{D20}, R^{D22}, R^{D37}, R^{D40}, R^{D41}, R^{D42}, R^{D43}, R^{D48}, R^{D49}, R^{D50}, R^{D54}, R^{D55}, R^{D58}, R^{D59}, R^{D78}, R^{D79}, R^{D81}, R^{D87}, R^{D88}, R^{D89}, R^{D93}, R^{D116}, R^{D117}, R^{D118}, R^{D119}, R^{D120}, R^{D133}, R^{D134}, R^{D135}, R^{D136}, R^{D143}, R^{D144}, R^{D145}, R^{D146}, R^{D147}, R^{D149}, R^{D151}, R^{D154}, R^{D155}, R^{D161}, R^{D175}, R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having L_{C*j*-I} or L_{C*j*-II} ligand whose corresponding R²⁰¹ and R²⁰² are defined to be one of selected from the following structures: R^{D1}, R^{D3}, R^{D4}, R^{D5}, R^{D9}, R^{D10}, R^{D17}, R^{D22}, R^{D43}, R^{D50}, R^{D78}, R^{D116}, R^{D118}, R^{D133}, R^{D134}, R^{D135}, R^{D136}, R^{D143}, R^{D144}, R^{D145}, R^{D146}, R^{D149}, R^{D151}, R^{D154}, R^{D155}, R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245} and R^{D246}.

In some embodiments, the compound is selected from the group consisting of only those compounds having one of the structures of the following LIST 16 for the L_{C*j*-I} ligand:

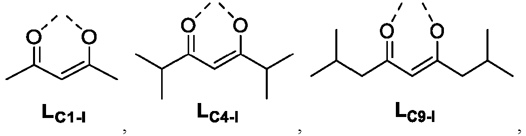

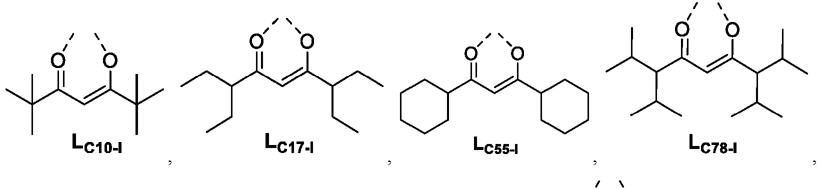

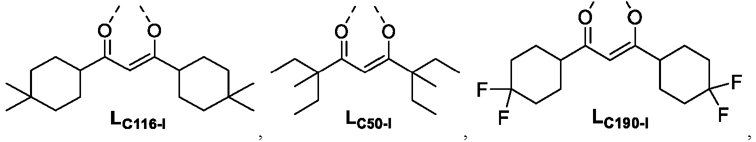

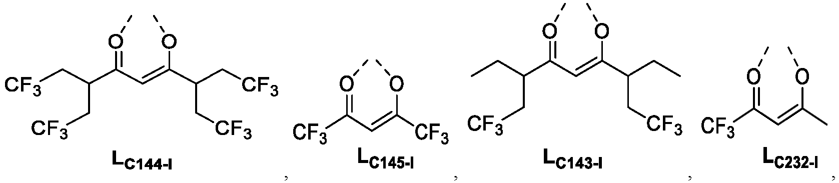

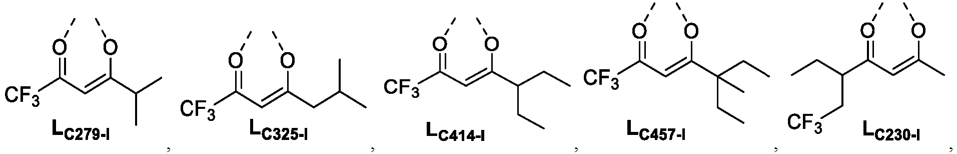

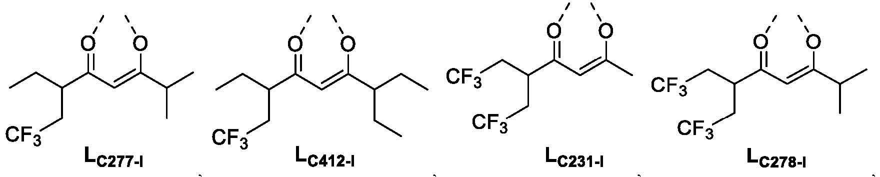

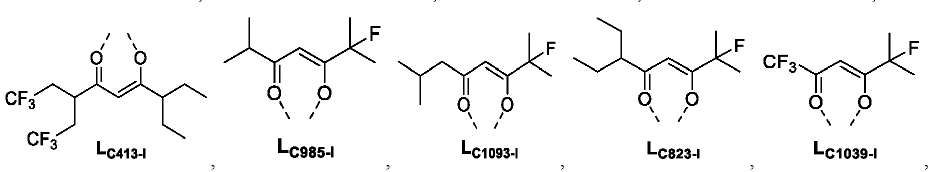

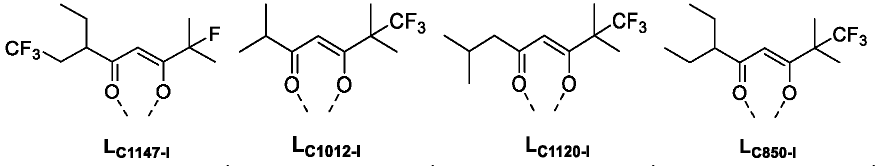

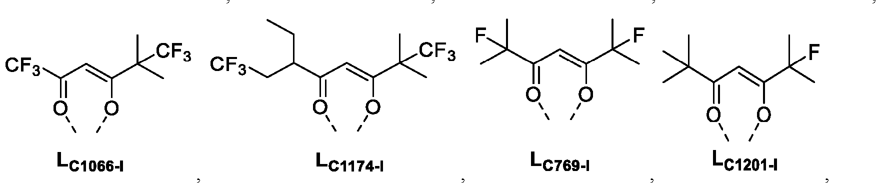

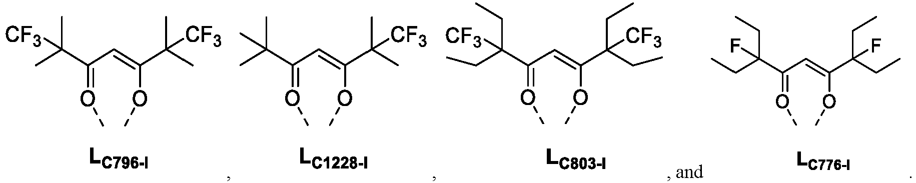

In some embodiments, L_{A} is selected from the group consisting of the structures of LIST 4, LIST 5, LIST 6, LIST 7, and LIST 8. In some embodiments, L_{B} is selected from the group consisting of the structures of LIST 11, LIST 12, and LIST 13. In some embodiments, L_{A} is selected from the group consisting of the structures of LIST 6 of L_{A*i*}(R*^{J}*)(R*^{K}*)(R^{L})(Y*^{M}*)(Y^{N'}) consisting of L _{A}1-(V1)(V1)(V1)(Y1)(Y1) to L _{A}34-(V156)(V156)(V156)(Y50)(Y44) defined herein and L_{B} is selected from the group consisting of LIST 13 of L_{Bk} consisting of L_{B1} to L_{B543} as defined herein. In some embodiments, L_{A} is selected from the group consisting of the structures of LIST 7 of L_{A*i'*}(R*^{J}*)(R*^{K}*)(R^{L})(Y*^{M}*)(Y*^{N}*) consisting of L _{A}35-(V1)(V1)(V1)(Y1)(Y1) to L _{A}122-(V156)(V156)(V156)(Y50)(Y50) defined herein and L_{B} is selected from the group consisting of LIST 13 of L_{Bk} consisting of L_{B1} to L_{B543} as defined herein. In some embodiments, L_{A} is selected from the group consisting of the structures of LIST 8 of L_{A*i*"}(R*^{J}*)(R*^{K}*)(R*^{L}*)(Y^{*M*'})(Y*^{N}*) consisting of L_{A}123-(V1)(V1)(V1)(Y1)(Y1) to L_{A}146-(V156)(V156)(V156)(Y47)(Y50) defined herein and L_{B} is selected from the group consisting of LIST 13 of L_{Bk} consisting of L_{B1} to L_{B543} as defined herein. In some embodiments, L_{A} is selected from the group consisting of the structures of LIST 8a of L_{A*n*}(R*^{H}*)(R*^{I}*)R*^{J}*)(R*^{K}*)(R^{L})(Y*^{M}*) consisting of L_{A}147-(V2)(V1)(V1)(V1)(V1)(Y1) to L_{A}239-(V156)(V156)(V156)(V156)(V156)(Y50) defined herein and L_{B} is selected from the group consisting of LIST 13 of L_{Bk} consisting of L_{B1} to L_{B543} as defined herein. In some embodiments, L_{A} is selected from the group consisting of the structures of LIST 8b of L_{A*"n*'}(R*^{H}*)(R*^{I}*)R*^{J}*)(R*^{K}*)(R*^{L}*)(Y*^{M}*) consisting of L _{A"1}-(V1)(V1)(V1)(V1)(V1)(Y1) to L_{A"44}-(V156)(V156)(V156)(V156)(V156)(Y50) defined herein and L_{B} is selected from the group consisting of LIST 13 of L_{Bk} consisting of L_{B1} to L_{B543} as defined herein.

In some embodiments, the compound can be Ir(L_{A})₂(L_{B}), Ir(L_{A})(L_{B})₂, or Ir(L_{A})(L_{B})(L_{C}).

In some embodiments, the compound can be Ir(L_{A*i*}(R*^{J}*)(R*^{K}*)(R*^{L}*)(Y*^{M}*)(Y*^{N'}*))₂(L_{B}), Ir(*L*_{A*i*}(R*^{J}*)(R*^{K}*)(R*^{L}*)(Y*^{M}*)(Y*^{N'}*))(L_{B})₂, Ir(L_{A*i'*}(R*^{J}*)(R*^{K}*)(R*^{L}*)(Y*^{M}*)(Y*^{N}*))₂(L_{B}), Ir(L_{A*i*'}(R*^{J}*)(R*^{K}*)(R*^{L}*)(Y*^{M}*)(Y*^{N}*))(L_{B})₂, Ir(L_{*Ai*"}(R*^{J}*)(R*^{K}*)(R*^{L}*)(Y*^{M'}*)(Y*^{N}*))₂(L_{B}), Ir(L_{A*i"*}(R*^{J}*)(R*^{K}*)(R*^{L}*)(Y*^{M'}*)(Y*^{N}*))(L_{B})₂, Ir(L_{A*i*}(R*^{J}*)(R*^{K}*)(R*^{L}*)(Y*^{M}*)(Y*^{N}*))₂(L_{Bk}) consisting of the compounds of Ir(L _{A}1-(V1)(V1)(V1)(Y1)(Y1))₂(L_{B1}) to Ir(L _{A}34-(V156)(V156)(V156)(Y50)(Y44))₂(L_{B543}), Ir(L_{A*i'*}(R*^{J}*)(R*^{K}*)(R*^{L}*)(Y*^{M}*)(Y*^{N}*))₂(L_{Bk}) consisting of the compounds of Ir(L _{A}35-(V1)(V1)(V1)(Y1)(Y1))₂(L_{B1}) to Ir(L _{A}122-(V156)(V156)(V156)(Y50)(Y50))₂(L_{B543})₃ Ir(L_{A*i"*}(R*^{J}*)(R*^{K}*)(R*^{L}*)(Y*^{M'}*)(Y*^{N}*))₂(L_{Bk}) consisting of the compounds of Ir(L _{A}123-(V1)(V1)(V1)(Y1)(Y1))₂(L_{B1}) to Ir(L _{A}146-(V156)(V156)(V156)(Y47)(Y50))₂(L_{B543}), Ir(L_{A*i*}(R*^{J}*)(R*^{K}*)(R*^{L}*)(Y*^{M}*)(Y*^{N'}*))(L_{Bk})₂ consisting of the compounds of Ir(L _{A}1-(V1)(V1)(V1)(Y1)(Y1))(L_{B1})₂ to Ir(L _{A}34-(V156)(V156)(V156)(Y50)(Y44))(L_{B543})₂, Ir(L_{A*i'*}(R*^{J}*)(R*^{K}*)(R*^{L}*)(Y*^{M}*)(Y*^{N}*))(L_{Bk})₂ consisting of the compounds of Ir(L _{A}35-(V1)(V1)(V1)(Y1)(Y1))(L_{B1})₂ to Ir(L _{A}122-(V156)(V156)(V156)(Y50)(Y50))(L_{B543})₂, Ir(L_{A*i"*}(R*^{J}*)(R*^{K}*)(R*^{L}*)(Y*^{M'}*)(Y*^{N}*))(L_{Bk})₂ consisting of the compounds of Ir(L _{A}123-(V1)(V1)(V1)(Y1)(Y1))(L_{B1})₂ to Ir(L_{A1}46-(V156)(V156)(V156)(Y47)(Y50))(L_{B543})₂.

In some embodiments, the compound can be Ir(L_{A*n*}(R*^{H}*)(R*^{I}*)R*^{J}*)(R*^{K}*)(R*^{L}*)(Y*^{M}*))₂(L_{B}), Ir(L_{A*n*}(R*^{H}*)(R*^{I}*)R*^{J}*)(R*^{K}*)(R*^{L}*)(Y*^{M}*))(L_{B})₂, *Ir*(L_{A*n*}(R*^{H}*)(R*^{I}*)R*^{J}*)(R*^{K}*)(R^{L})(Y*^{M}*))₂(L_{Bk}) consisting of the compounds of Ir(L _{A}147-(V2)(V1)(V1)(V1)(V1)(Y1))₂(L_{B1}) to Ir(L _{A}239-(V156)(V156)(V156)(V156)(V156)(Y50))₂(L_{B543}), Ir(L_{A*n*}(R*^{H}*)(R*^{I}*)R*^{J}*)(R*^{K}*)(R*^{L}*)(Y*^{M}*))(L_{Bk})₂ consisting of the compounds of Ir(L _{A} 147-(V2)(V1)(V1)(V1)(V1)(Y1))(L_{B1})₂ to Ir(L_{A}239-(V156)(V156)(V156)(V156)(V156)(Y50) )(L_{B543})₂.

In some embodiments, the compound can be Ir(L_{A"*n'*}(*R^{H}*)(R*^{I}*)R*^{J}*)(R*^{K}*)(R*^{L}*)(Y*^{M}*))₂(L_{B}), Ir(L_{A"*n*'}(R*^{H}*)(R*^{I}*)R*^{J}*)(R*^{K}*)(R*^{L}*)(Y*^{M}*))(L_{B})₂, Ir(L_{A"*n'*}(R*^{H}*)(R*^{I}*)R*^{J}*)(R*^{K}*)(R*^{L}*)(Y*^{M}*))₂(L_{Bk}) consisting of the compounds of Ir(L _{A"}1-(V1)(V1)(V1)(V1)(V1)(Y1))₂(L_{B1}) to Ir(L _{A"}44-(V156)(V156)(V156)(V156)(V156)(Y50))₂(L_{B543}), Ir(L_{A"*n'*}(R*^{H}*)(R*^{I}*)R*^{J}*)(R*^{K}*)(R^{L})(Y*^{M}*))(L_{Bk})₂ consisting of the compounds of Ir(L _{A"1}-(V1)(V1)(V1)(V1)(V1)(Y1))(L_{B1})₂ to Ir(L_{A"44}-(V156)(V156)(V156)(V156)(V156)(Y50) )(L_{B543})₂.

In some embodiments, the compound can be Ir(L_{A*i*}(R*^{J}*)(R*^{K}*)(R*^{L}*)(Y*^{M}*)(Y*^{N'}*)))(L_{Bk})(L_{CJ-I}) consisting of the compounds of Ir(L _{A}1-(V1)(V1)(V1)(Y1)(Y1))(L_{B1})(L_{C1-I}) to Ir(L _{A}34-(V156)(V156)(V156)(Y50)(Y44))(L_{B543})(L_{C1416-I}), lr(L_{A*i*}(R*^{J}*)(R*^{K}*)(R*^{L}*)(Y*^{M}*)(Y*^{N'}*))(L_{Bk})(L_{CJ-II}) consisting of Ir(L _{A}1-(V1)(V1)(V1)(Y1)(Y1))(L_{B1})(L_{C1-II}) to Ir(L _{A}34-(V156)(V156)(V156)(Y50)(Y44))(L_{B543})(L_{C1416-II}).

In some embodiments, the compound can be Ir(L_{A*i'*}(R*^{J}*)(R*^{K}*)(R*^{L}*)(Y*^{M}*)(Y*^{N}*)))(L_{Bk})(L_{CJ-I}) consisting of the compounds of Ir(L _{A35}-(V1)(V1)(V1)(Y1)(Y1))(L_{B}1)(L_{C1-I}) to Ir(L _{A}122-(V156)(V156)(V156)(Y50)(Y50))(L_{B543})(L_{C1416-I}), Ir(L_{Ai'}(R^{J})(R^{K})(R^{L})(Y^{M})(Y^{N}))(L_{Bk})(L_{CJ-II}) consisting of Ir(L _{A}35-(V1)(V1)(V1)(Y1)(Y1))(L_{B1})(L_{C1-II}) to Ir(L _{A}122-(V156)(V156)(V156)(Y50)(Y50))(L_{B543})(LC_{1416-II}).

In some embodiments, the compound can be Ir(L_{A*i'*'}(R*^{J}*)(R*^{K}*)(R*^{L}*)(Y*^{M'}*)(Y*^{N}*)))(L_{Bk})(L_{CJ-I}) consisting of the compounds of Ir(L _{A}123-(V1)(V1)(V1)(Y1)(Y1))(L_{B}1)(L_{C1-I}) to Ir(L _{A}146-(V156)(V156)(V156)(Y47)(Y50))(L_{B543})(L_{C1416-I}), Ir(L_{A*i"*}(R*^{J}*)(R*^{K}*)(R*^{L}*)(Y*^{M'}*)(Y*^{N}*))(L_{Bk})(L_{CJ-II}) consisting of Ir(L _{A}123-(V1)(V1)(V1)(Y1)(Y1))(L_{B1})(L_{C1-II}) to Ir(L _{A}146-(V156)(V156)(V156)(Y47)(Y50))(L_{B543})(L_{C1416-II}).

In some embodiments, the compound can be Ir(L_{A*n*}(R*^{H}*)(R*^{I}*)R*^{J}*)(R*^{K}*)(R*^{L}*)(Y*^{M}*)))(L_{Bk})(L_{CJ-I}) consisting of the compounds of Ir(L _{A}147-(V2)(V1)(V1)(V1)(V1)(Y1))(L_{B1})(L_{C1-I}) to Ir(L _{A}239-(V156)(V156)(V156)(V156)(Vl 56)(Y50))(L_{B543})(L_{C1416-I}), Ir(L_{A*n*}(R*^{H}*)(R*^{I}*)R*^{J}*)(R*^{K}*)(R*^{L}*)(Y*^{M}*))(L_{Bk})(L_{CJ-II}) consisting of Ir(L _{A}147-(V2)(V1)(V1)(V1)(V1)(Y1))(L_{B1})(L_{C1-II}) to Ir(L _{A}239-(V156)(V156)(V156)(V156)(V156)(Y50))(L_{B543})(L_{C1416-II}).

In some embodiments, the compound can be Ir(L_{A"*n'*}(R*^{H}*)(R*^{I}*)R*^{J}*)(R*^{L}*)(R*^{L}*)(Y*^{M}*))(L_{Bk})(L_{CJ-I}) consisting of the compounds of Ir(L _{A''}1-(V1)(V1)(V1)(V1)(V1)(Y1))(L_{B}1)(L_{C1-I}) to Ir(L _{A"}44-(V156)(V156)(V156)(V156)(V156)(Y50))(L_{B543})(L_{C1416-I}), Ir(L_{A"*n'*}(R*^{H}*)(R*^{I}*)R*^{J}*)(R*^{K}*)(R^{L})(Y*^{M}*))(L_{Bk})(L_{CJ-II}) consisting of Ir(L _{A"1-}(V1)(V1)(V1)(V1)(V1)(Y1))(L_{B1})(L_{C1-II}) to Ir(L _{A"44}-(V156)(V156)(V156)(V156)(V156)(Y50))(L_{B543})(L_{C1416-II}).

In some embodiments, the compound is selected from the group consisting of the structures of the following LIST 17: 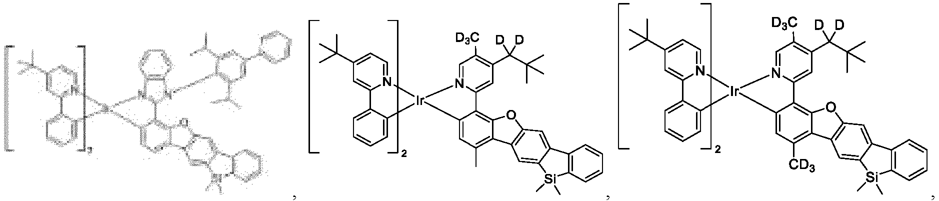 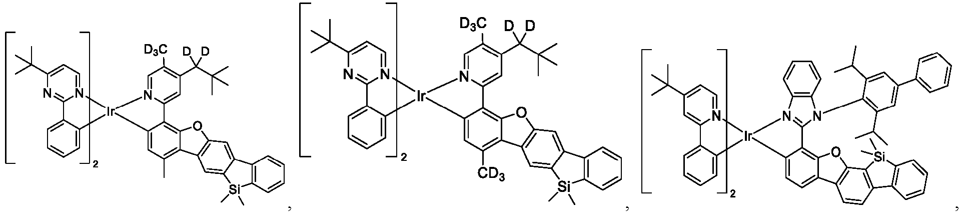 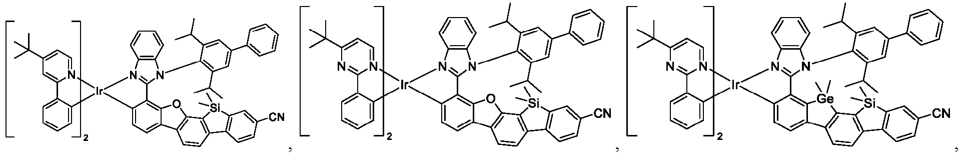 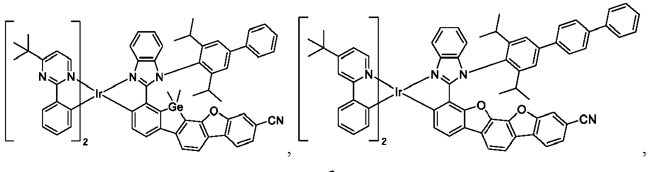 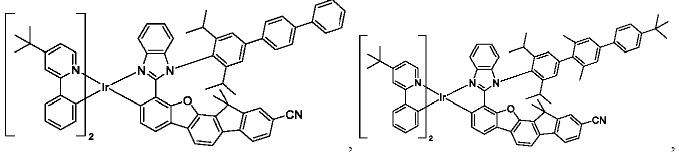 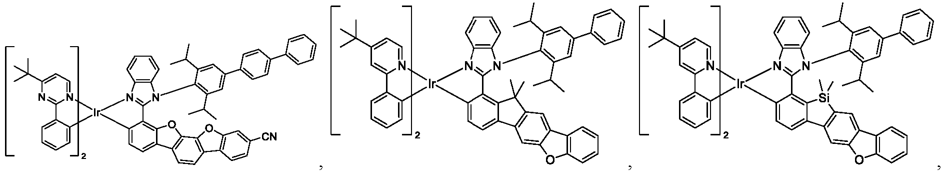 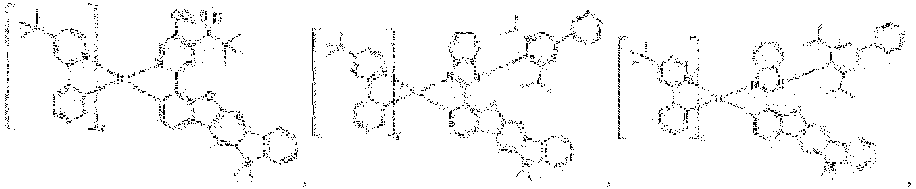 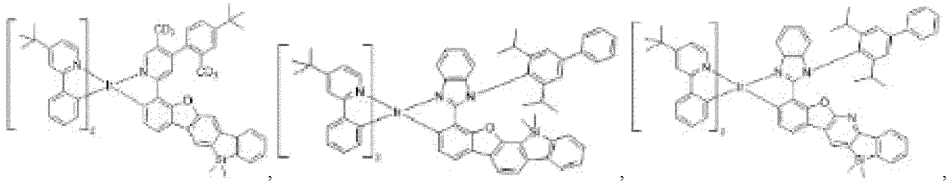 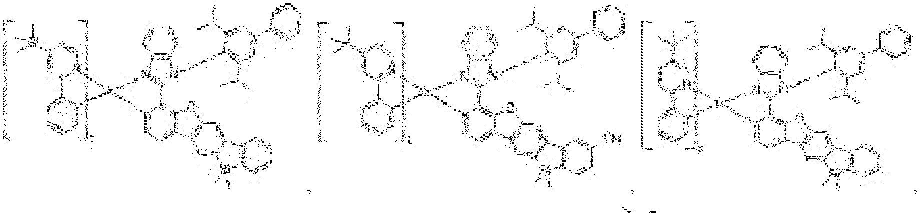 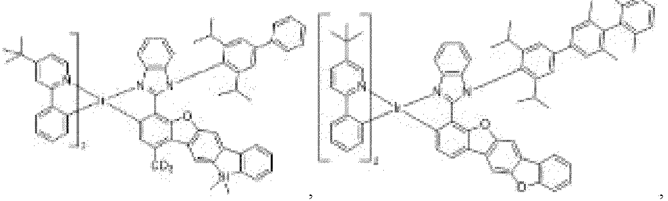 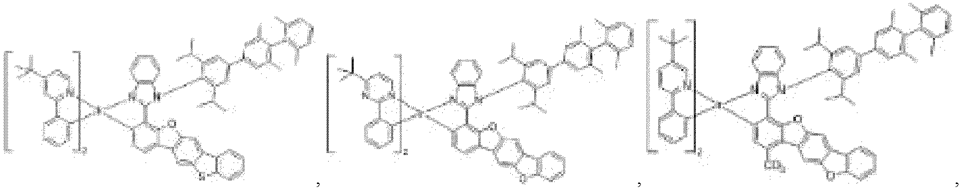 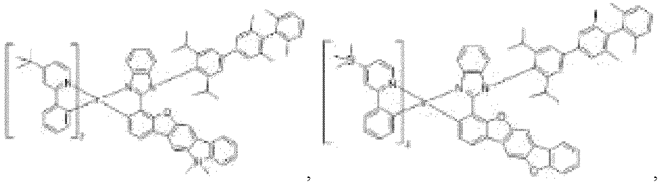 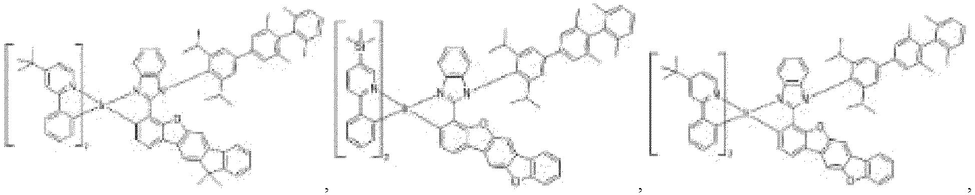 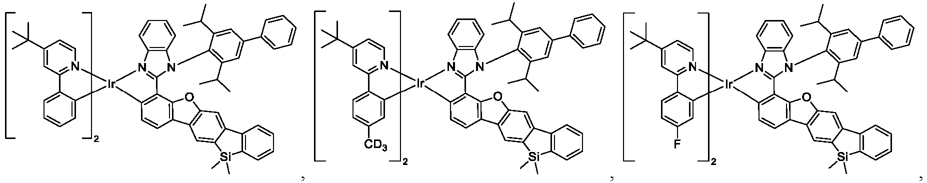 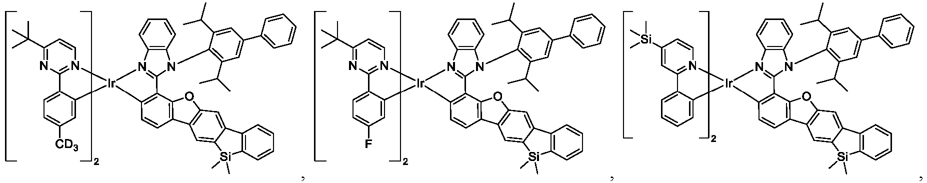 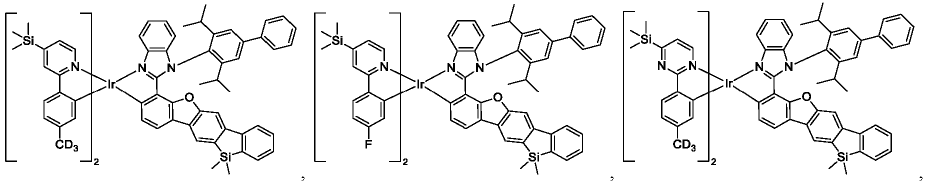 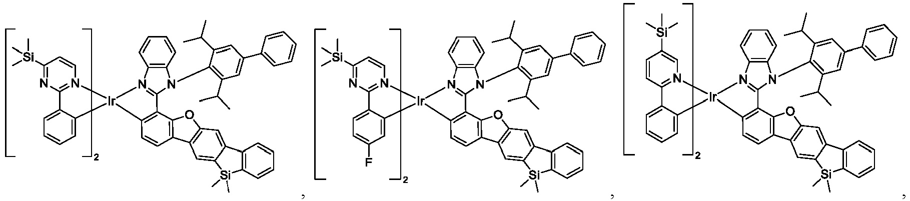 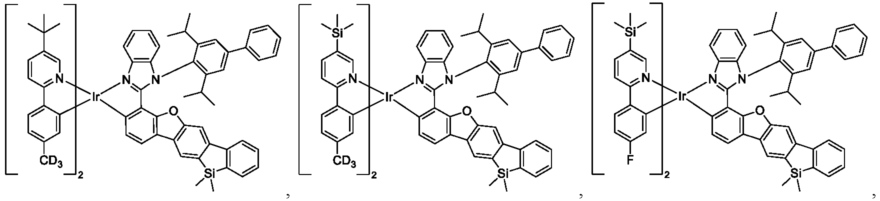 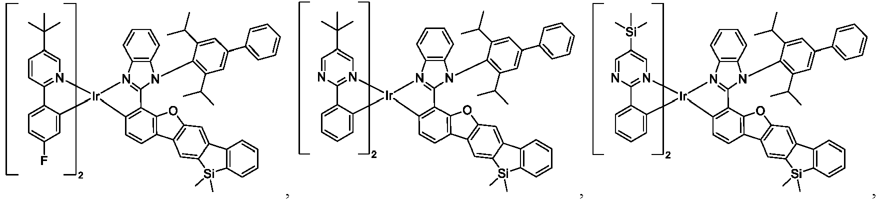 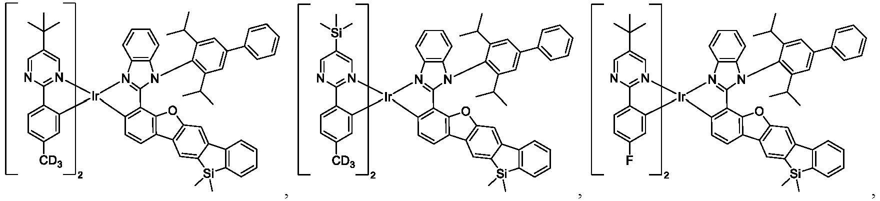 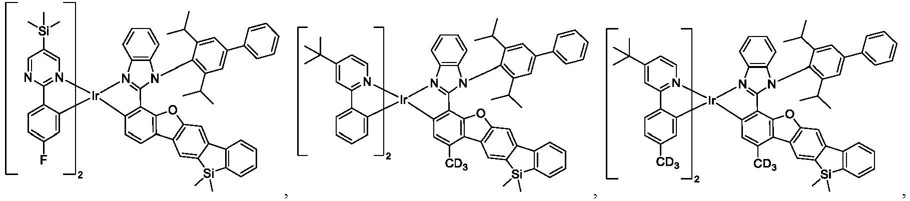 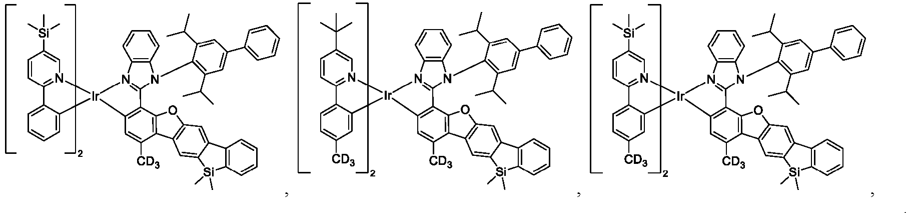 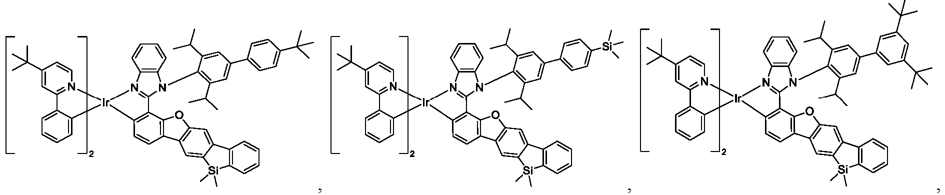 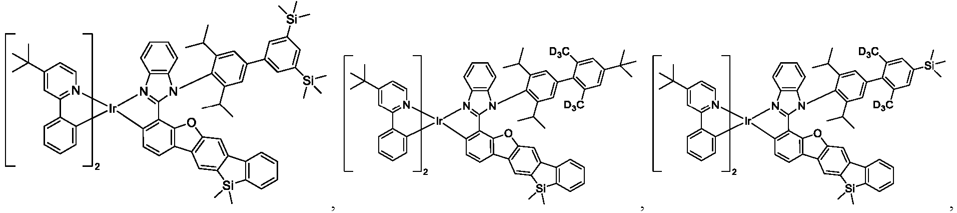 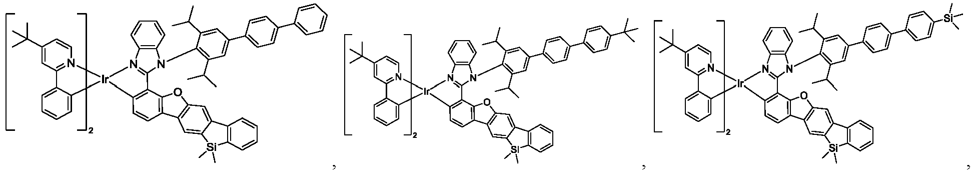 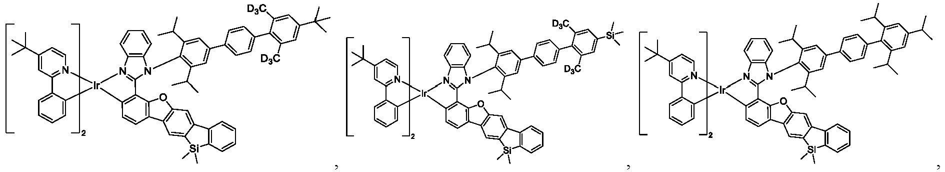 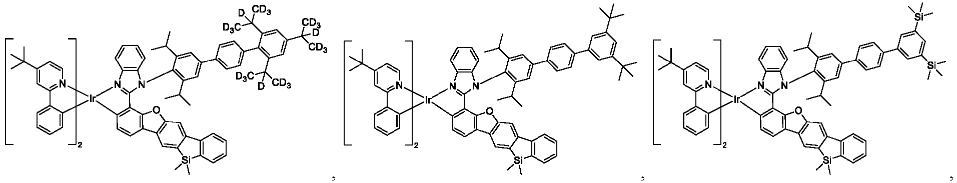 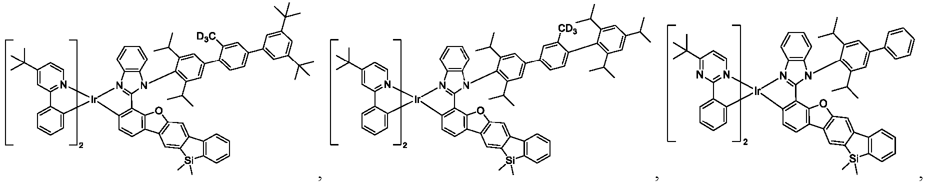 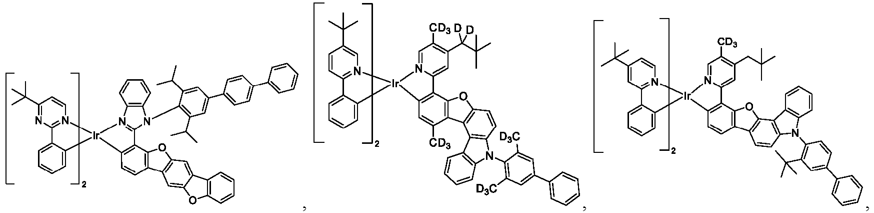 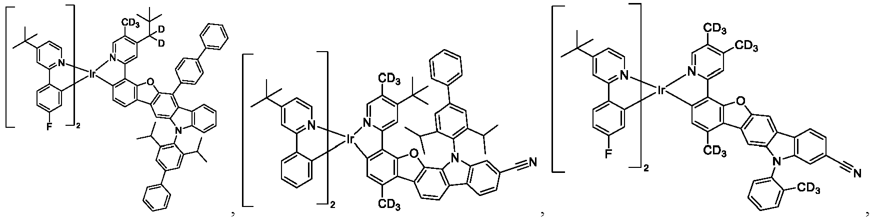 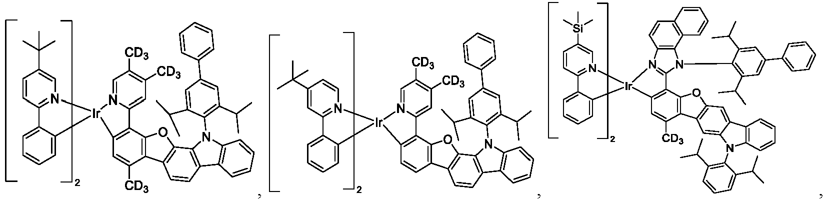 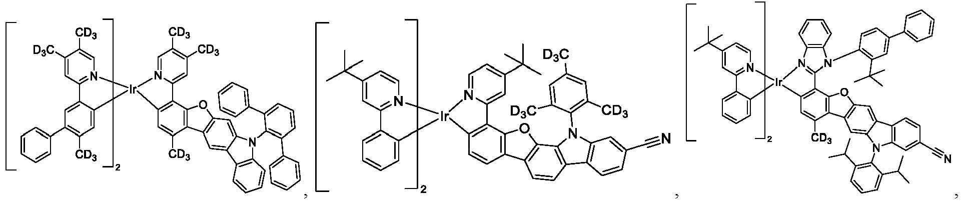 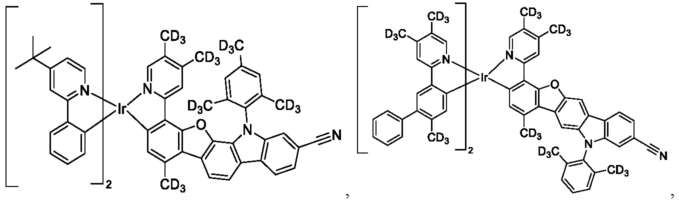 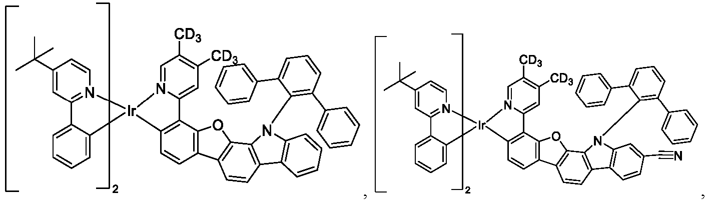 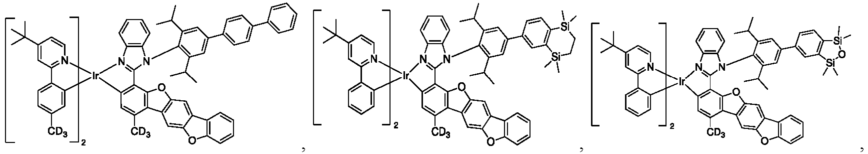 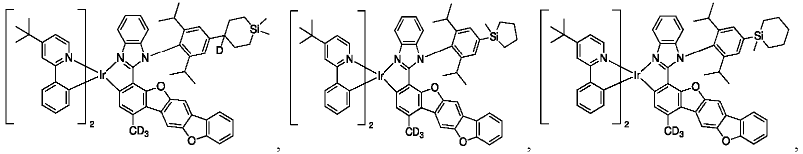 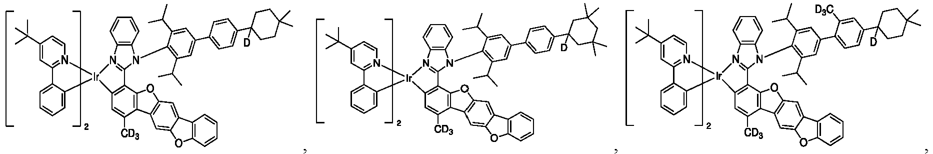 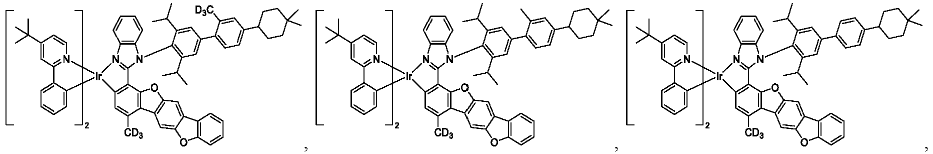 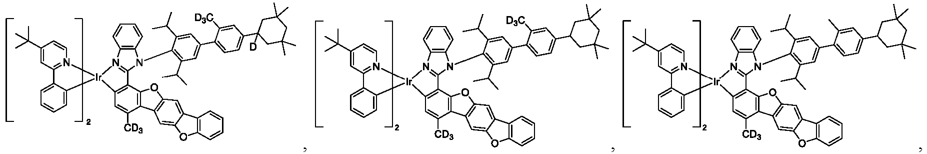 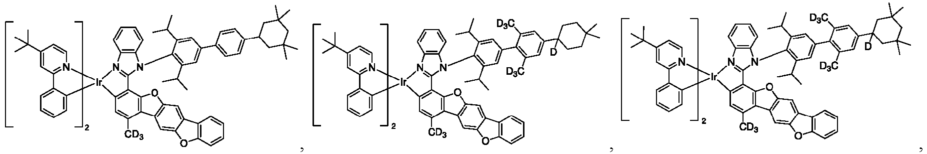 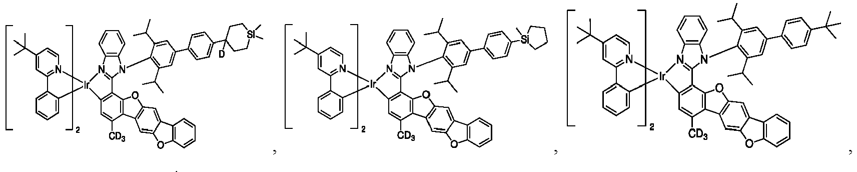 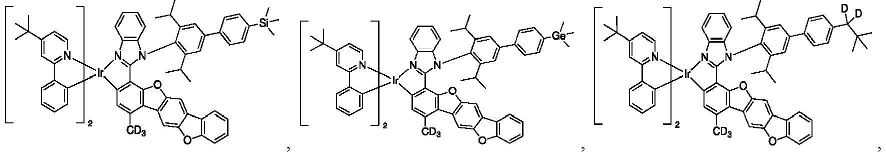 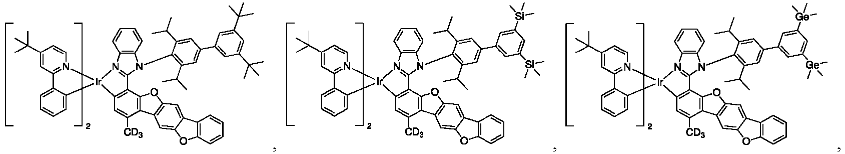 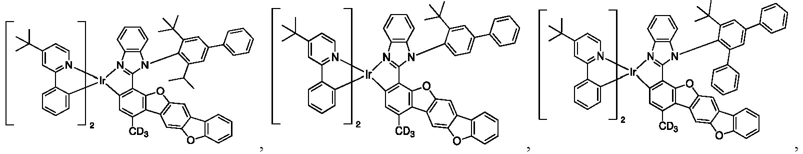 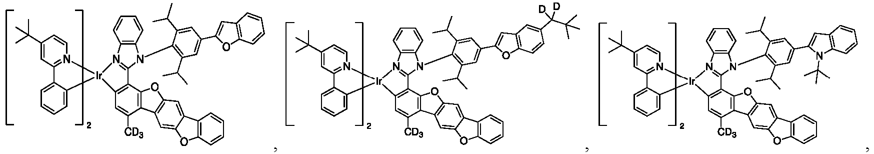 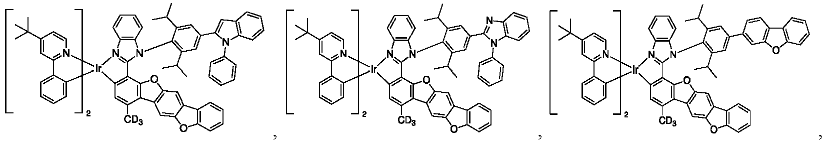 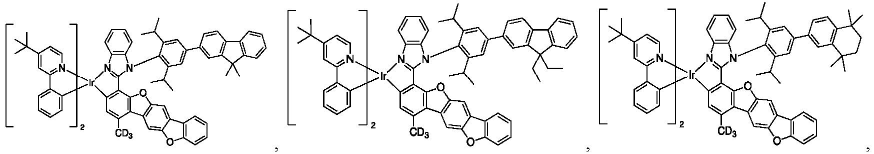 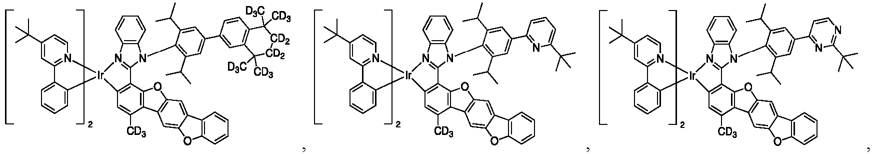 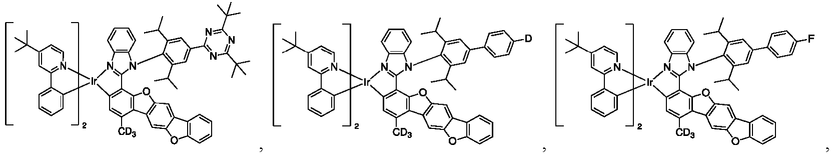 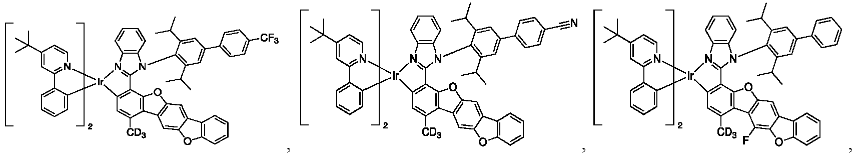 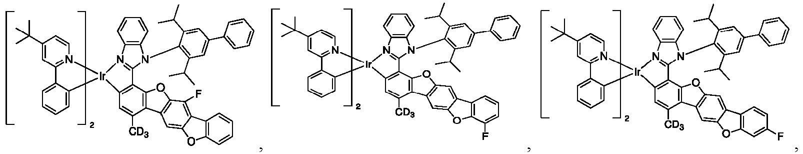 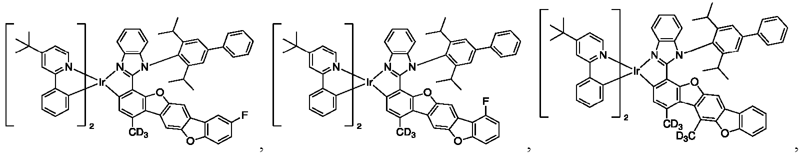 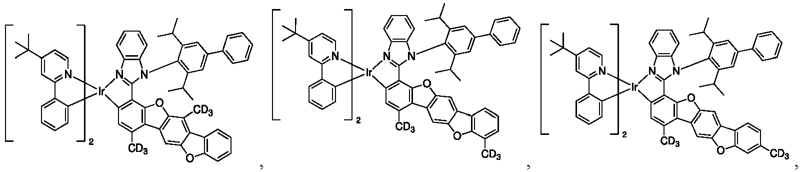 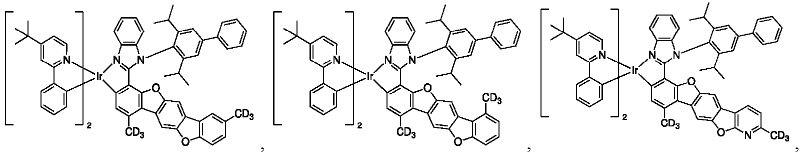 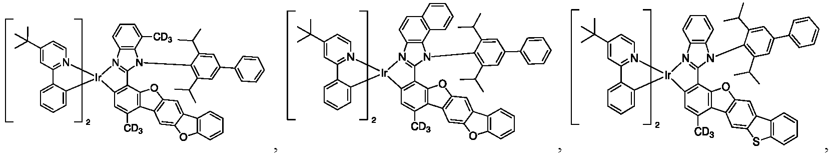 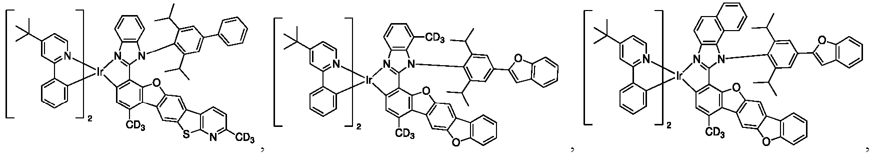 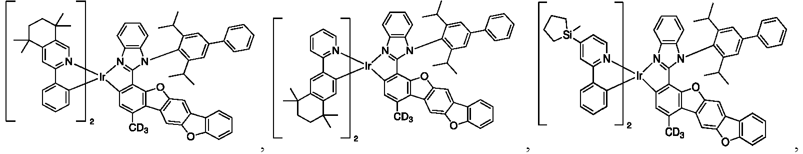 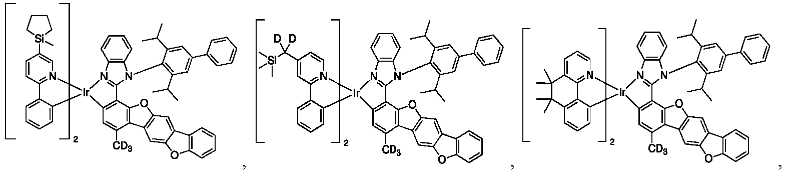 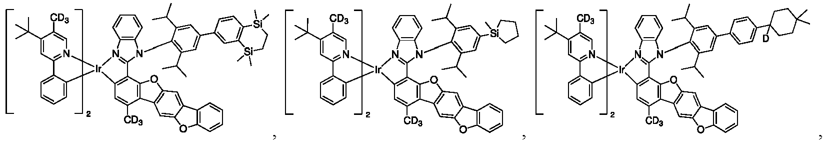 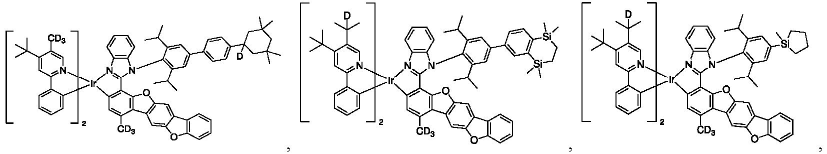 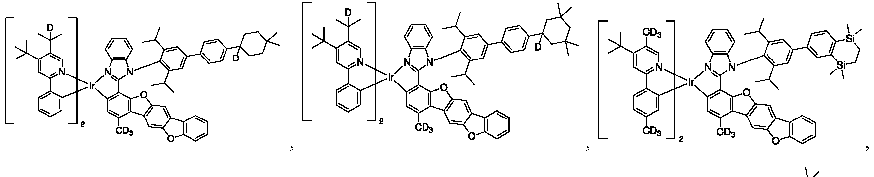 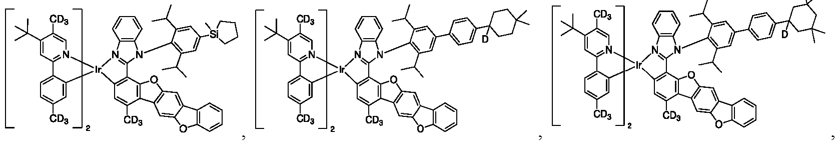 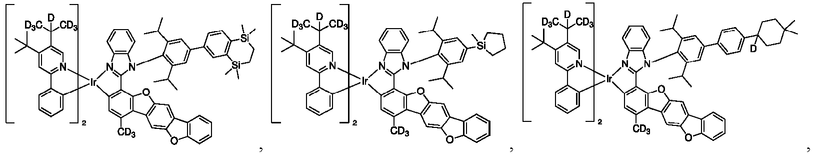 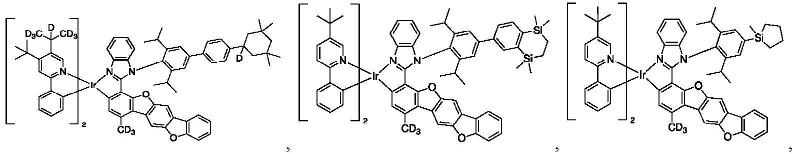 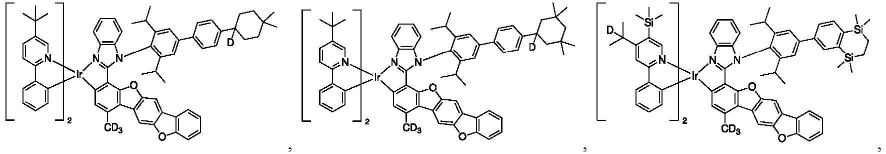 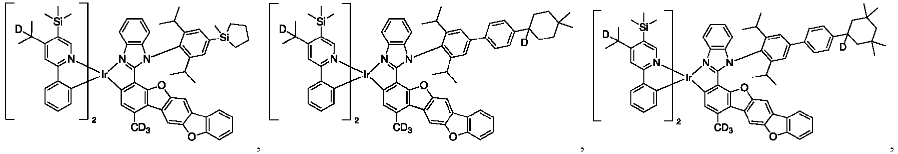 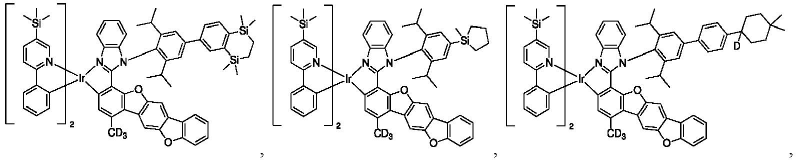 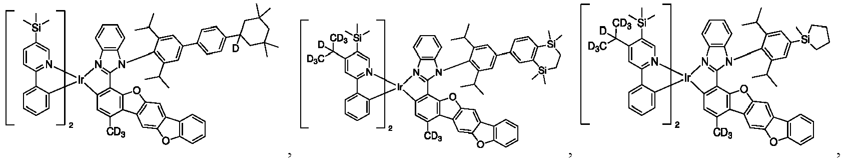 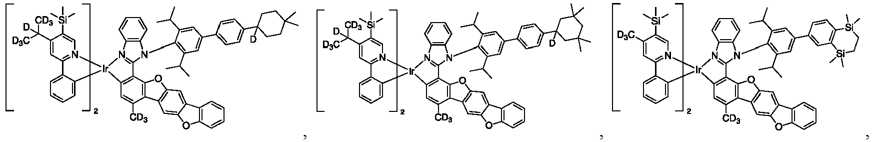 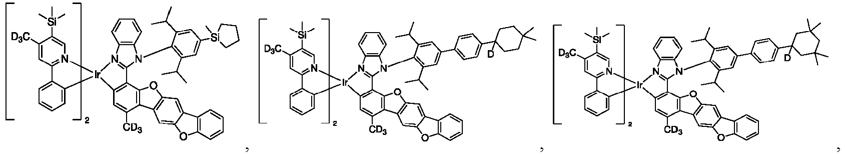 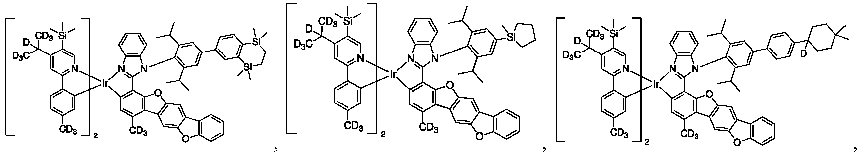 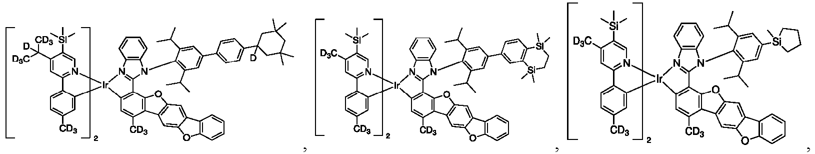 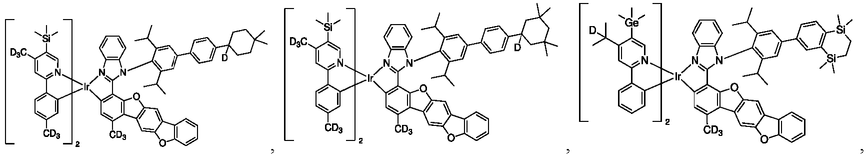 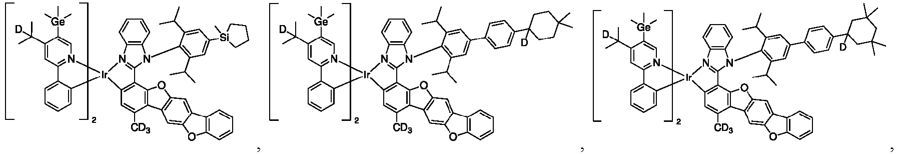 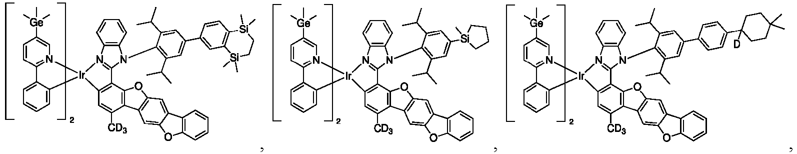 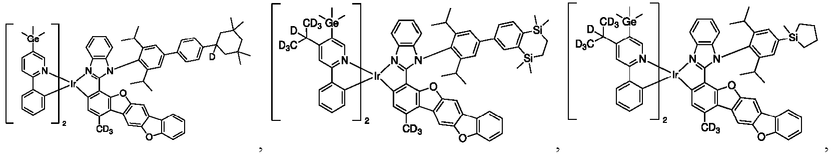 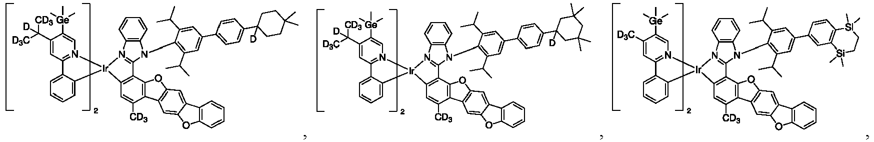 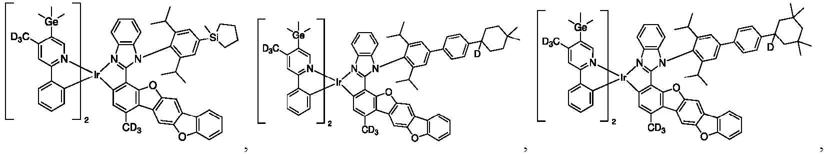 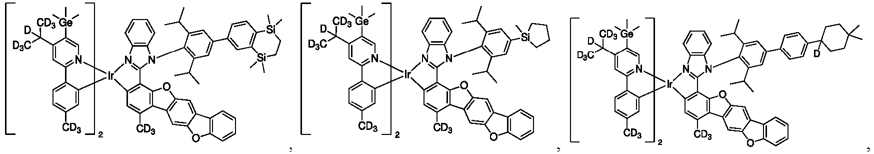 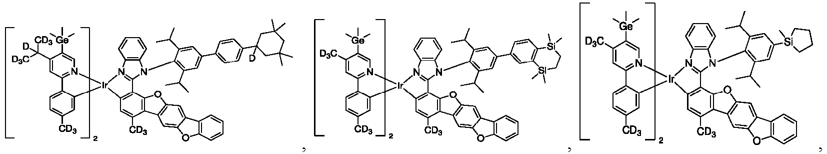 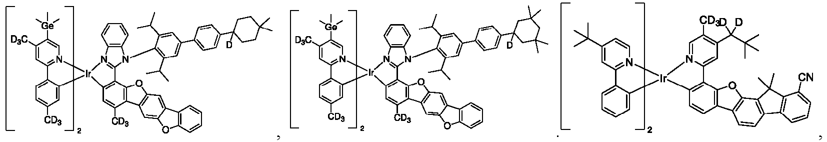 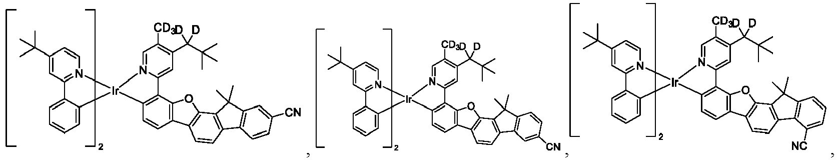 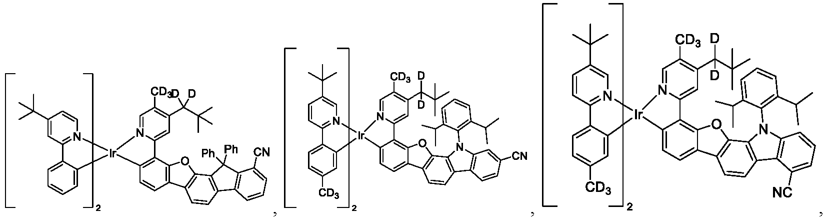 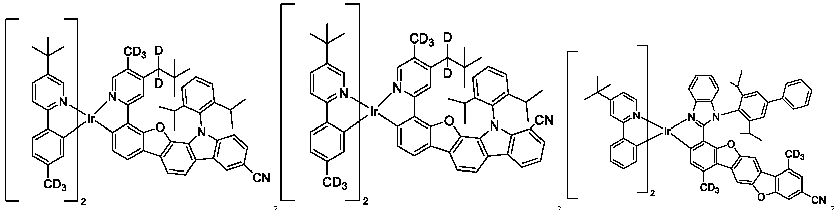 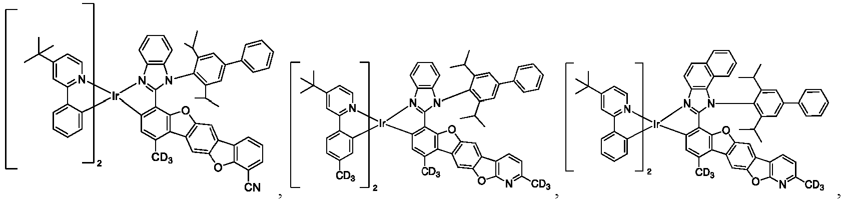 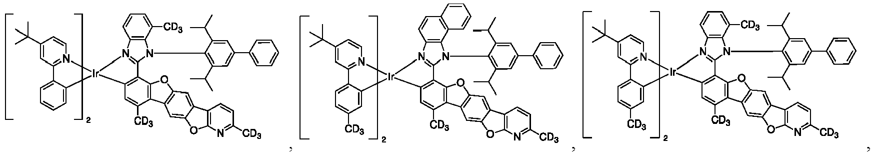 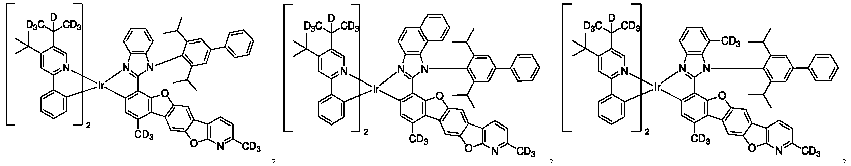 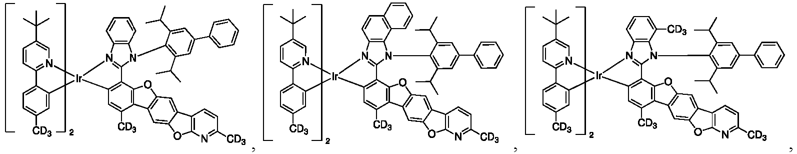 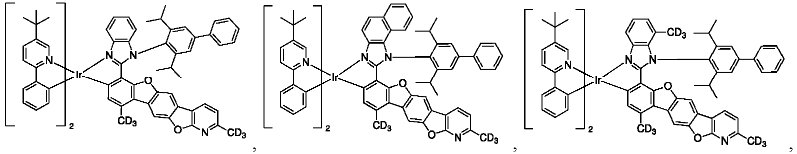 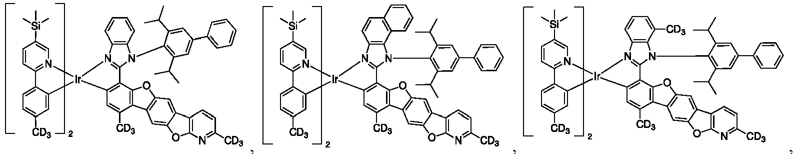 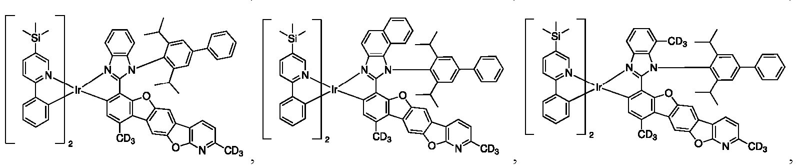 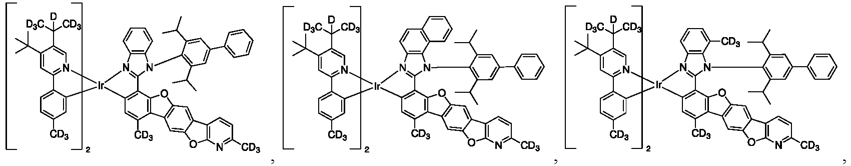 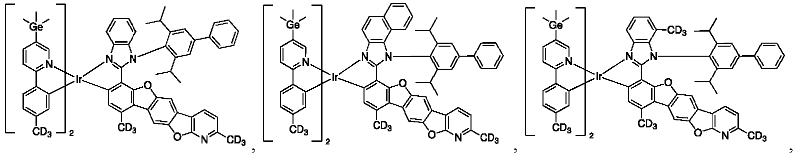 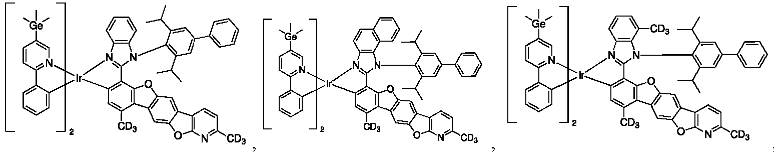 and

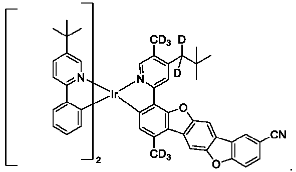

In some embodiments, the compound has a structure of Formula IV: 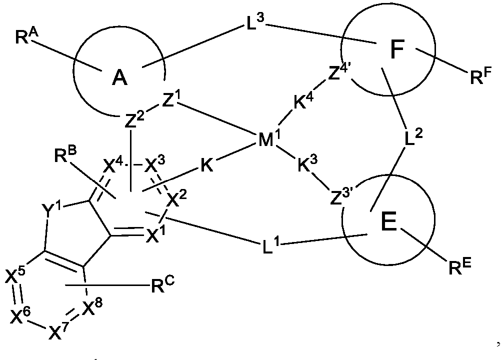 wherein:
M is Pd or Pt;
moieties E and F are each independently a monocyclic ring or a polycyclic fused ring structure, wherein the monocyclic ring or each ring of the polycyclic fused ring structure is independently a 5-membered to 10-membered carbocyclic or heterocyclic ring;
Z^{3'} and Z^{4'} are each independently C or N;
K, K³ and K⁴ are each independently selected from the group consisting of a direct bond, O, and S, wherein at least two of them are direct bonds;
L¹, L², and L³ are each independently absent or selected from the group consisting of a direct bond, BR, BRR', NR, PR, P(O)R, O, S, Se, C=O, C=S, C=Se, C=NR, C=CRR', S=O, SO₂, CR, CRR', SiRR', GeRR', alkylene, cycloalkyl, aryl, cycloalkylene, arylene, heteroarylene, and combinations thereof, wherein at least one of L¹ and L² is present;
R^{E} and R^{F} each independently represents zero, mono, or up to a maximum allowed number of substitutions;
each of R, R', R^{E}, and R^{F} is independently a hydrogen or a substituent selected from the group consisting of the General Substituents defined herein; and
two adjacent R^{A}, R^{B}, R^{C}, R^{E}, and R^{F} can be joined or fused together to form a ring.

In some embodiments of Formula IV, each of R, R', R^{E}, and R^{F} is independently a hydrogen or a substituent selected from the group consisting of deuterium, fluorine, alkyl, cycloalkyl, heteroalkyl, alkoxy, aryloxy, amino, silyl, boryl, alkenyl, cycloalkenyl, heteroalkenyl, aryl, heteroaryl, nitrile, isonitrile, sulfanyl, and combinations thereof.

In some embodiments, moieties E and F are each independently monocyclic or polycyclic ring structures, wherein the monocyclic ring or each ring of the polycyclic fused ring system is independently a 5-membered or 6-membered carbocyclic or heterocyclic rings.

In some embodiments of Formula IV, at least one R^{A}, R^{B}, R^{C}, R^{D}, R^{E}, or R^{F} is selected from the group consisting of the General Substituents defined herein. In some embodiments, at least one R^{A} is selected from the group consisting of the General Substituents defined herein. In some embodiments, at least one R^{B} is selected from the group consisting of the General Substituents defined herein. In some embodiments, at least one R^{C} is selected from the group consisting of the General Substituents defined herein. In some embodiments, at least one R^{D} is selected from the group consisting of the General Substituents defined herein. In some embodiments, at least one R^{E} is selected from the group consisting of the General Substituents defined herein. In some embodiments, at least one R^{F} is selected from the group consisting of the General Substituents defined herein. In some embodiments, at least one R^{A}, R^{B}, R^{C}, R^{D}, R^{E}, or R^{F} is selected from the group consisting of the Preferred General Substituents defined herein.

In some embodiments of Formula IV, at least one R^{A}, R^{B}, R^{C}, R^{D}, R^{E}, or R^{F} is partially or fully deuterated. In some embodiments, at least one R^{A} is partially or fully deuterated. In some embodiments, at least one R^{B} is partially or fully deuterated. In some embodiments, at least one R^{C} is partially or fully deuterated. In some embodiments, at least one R^{E} is partially or fully deuterated. In some embodiments, at least one R^{D} is partially or fully deuterated. In some embodiments, at least one R^{F} is partially or fully deuterated.

In some embodiments, wherein at least one of R, R', R^{A}, R^{B}, R^{C}, R^{E}, or R^{F} is selected from a bulky group consisting of the structures below: 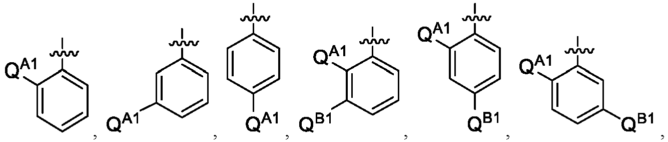 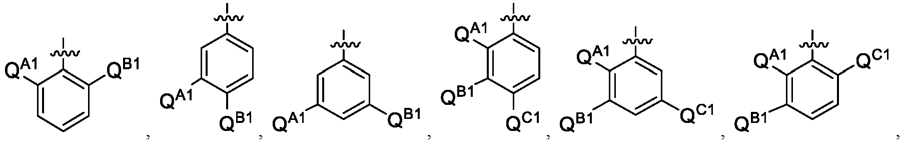 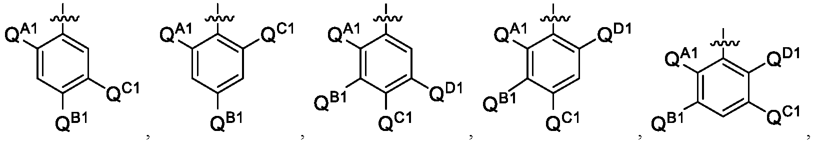 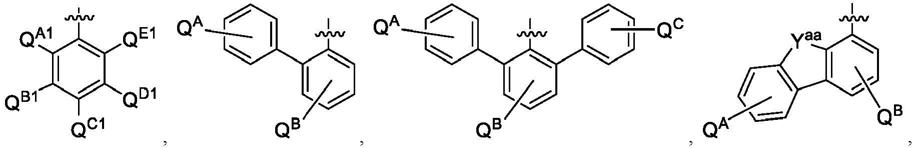 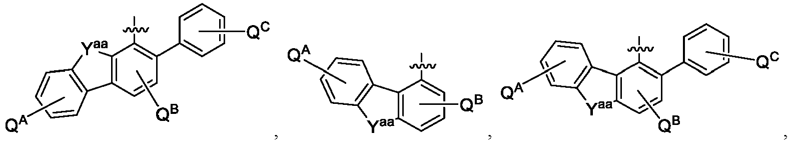 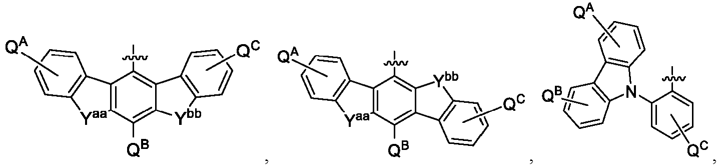 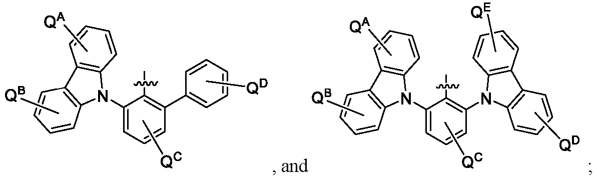
wherein each of Q^{A}, Q^{B}, Q^{C}, Q^{D}, and Q^{E} independently represents mono to the maximum allowable substitution, or no substitution,
wherein each Q^{A}, Q^{B}, Q^{C}, Q^{D}, Q^{E}, Q^{A1}, Q^{B1}, Q^{C1}, Q^{D1} and Q^{E1} is independently a hydrogen or a substituent selected from the group consisting of alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof,
each Y^{aa} and Y^{bb} is independently selected from the group consisting of a direct bond, BR, BRR', NR, PR, O, S, Se, C=O, C=S, C=Se, C=NR, C=CRR', S=O, SO₂, CR, CRR', SiRR', GeRR', alkyl, cycloalkyl, aryl, heteroaryl, and combinations thereof, and any two substituents can be joined or fused to form a ring.

In some embodiments of Formula IV, at least one R^{A} is or comprises an electron-withdrawing group from the EWG1 LIST as defined herein. In some embodiments, at least one R^{A} is or comprises an electron-withdrawing group from the EWG2 LIST as defined herein. In some embodiments, at least one R^{A} is or comprises an electron-withdrawing group from the EWG3 LIST as defined herein. In some embodiments, at least one R^{A} is or comprises an electron-withdrawing group from the EWG4 LIST as defined herein. In some embodiments, at least one R^{A} is or comprises an electron-withdrawing group from the Pi-EWG LIST as defined herein.

In some embodiments of Formula IV, at least one R^{B} is or comprises an electron-withdrawing group from the EWG1 LIST as defined herein. In some embodiments, at least one R^{B} is or comprises an electron-withdrawing group from the EWG2 LIST as defined herein. In some embodiments, at least one R^{B} is or comprises an electron-withdrawing group from the EWG3 LIST as defined herein. In some embodiments, at least one R^{B} is or comprises an electron-withdrawing group from the EWG4 LIST as defined herein. In some embodiments, at least one R^{B} is or comprises an electron-withdrawing group from the Pi-EWG LIST as defined herein.

In some embodiments of Formula IV, at least one R^{C} is or comprises an electron-withdrawing group from the EWG1 LIST as defined herein. In some embodiments, at least one R^{C} is or comprises an electron-withdrawing group from the EWG2 LIST as defined herein. In some embodiments, at least one R^{C} is or comprises an electron-withdrawing group from the EWG3 LIST as defined herein. In some embodiments, at least one R^{C} is or comprises an electron-withdrawing group from the EWG4 LIST as defined herein. In some embodiments, at least one R^{C} is or comprises an electron-withdrawing group from the Pi-EWG LIST as defined herein.

In some embodiments of Formula IV, at least one R^{D} is or comprises an electron-withdrawing group from the EWG1 LIST as defined herein. In some embodiments, at least one R^{D} is or comprises an electron-withdrawing group from the EWG2 LIST as defined herein. In some embodiments, at least one R^{D} is or comprises an electron-withdrawing group from the EWG3 LIST as defined herein. In some embodiments, at least one R^{D} is or comprises an electron-withdrawing group from the EWG4 LIST as defined herein. In some embodiments, at least one R^{D} is or comprises an electron-withdrawing group from the Pi-EWG LIST as defined herein.

In some embodiments of Formula IV, at least one R^{E} is or comprises an electron-withdrawing group from the EWG1 LIST as defined herein. In some embodiments, at least one R^{E} is or comprises an electron-withdrawing group from the EWG2 LIST as defined herein. In some embodiments, at least one R^{E} is or comprises an electron-withdrawing group from the EWG3 LIST as defined herein. In some embodiments, at least one R^{E} is or comprises an electron-withdrawing group from the EWG4 LIST as defined herein. In some embodiments, at least one R^{E} is or comprises an electron-withdrawing group from the Pi-EWG LIST as defined herein.

In some embodiments of Formula IV, at least one R^{F} is or comprises an electron-withdrawing group from the EWG1 LIST as defined herein. In some embodiments, at least one R^{F} is or comprises an electron-withdrawing group from the EWG2 LIST as defined herein. In some embodiments, at least one R^{F} is or comprises an electron-withdrawing group from the EWG3 LIST as defined herein. In some embodiments, at least one R^{F} is or comprises an electron-withdrawing group from the EWG4 LIST as defined herein. In some embodiments, at least one R^{F} is or comprises an electron-withdrawing group from the Pi-EWG LIST as defined herein.

In some embodiments of Formula IV, moiety E and moiety F are both 6-membered aromatic rings.

In some embodiments of Formula IV, moiety F is a 5-membered or 6-membered heteroaromatic ring.

In some embodiments of Formula IV, L¹ is O or CRR'.

In some embodiments of Formula IV, Z^{4'} is N and Z^{3'} is C. In some embodiments of Formula IV, Z^{4'} is C and Z^{3'} is N.

In some embodiments of Formula IV, L² is a direct bond. In some embodiments of Formula IV, L ² is NR.

In some embodiments of Formula IV, K, K³, and K⁴ are all direct bonds.

In some embodiments of Formula IV, one of K, K³, and K⁴ is O.

In some embodiments of Formula IV, the compound is selected from the group consisting of compounds having the formula of Pt(L_{A'})(L*y*): 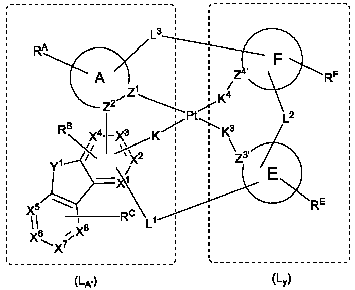
wherein L_{A'} is selected from the group consisting of the structures shown in the following LIST 18: 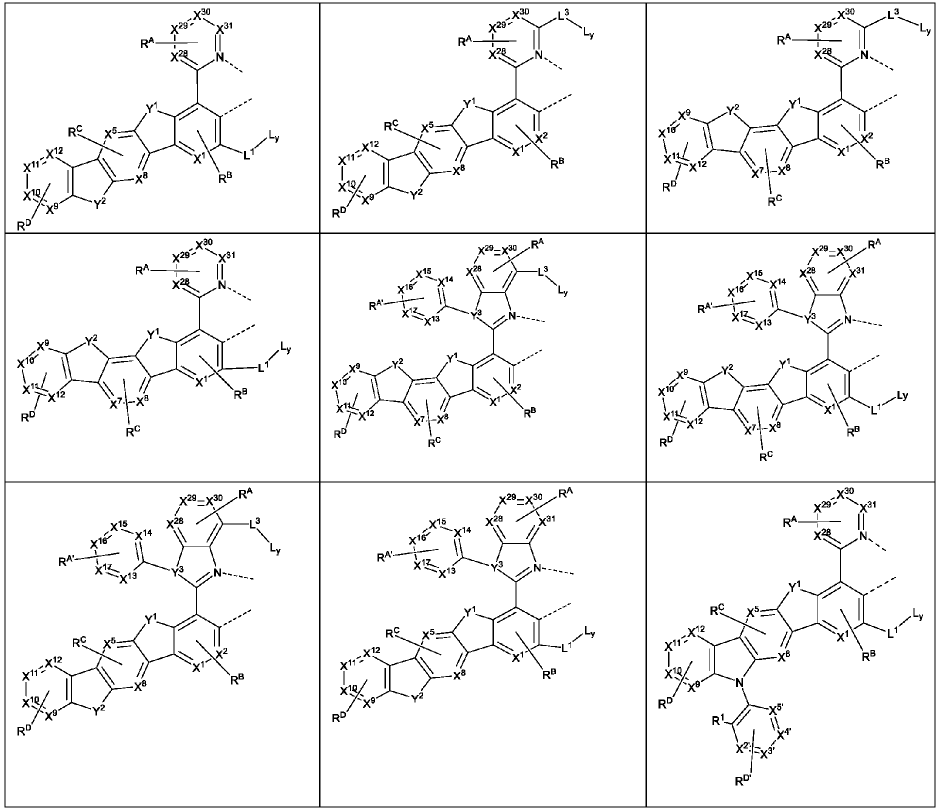 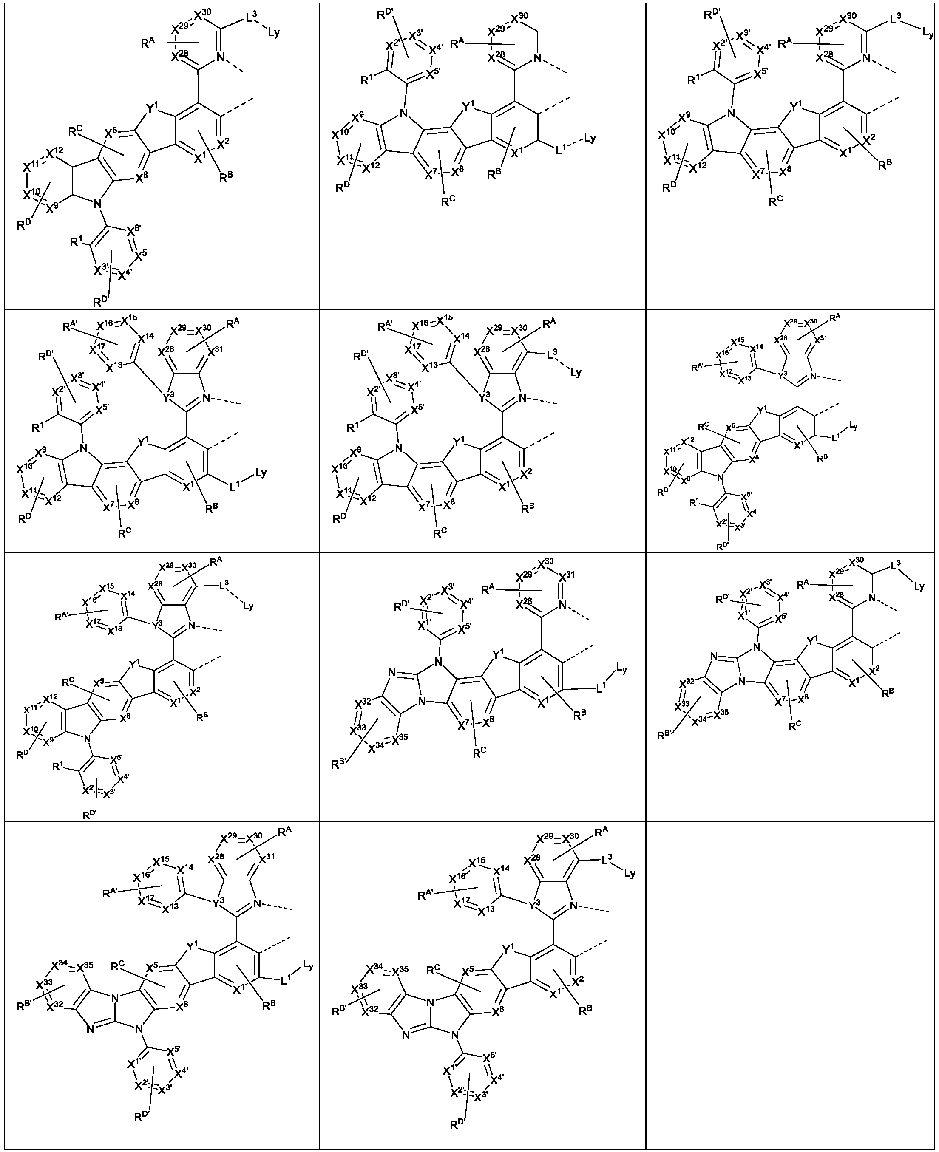
wherein L*_{y}* is selected from the group consisting of the structures shown in the following LIST 19: 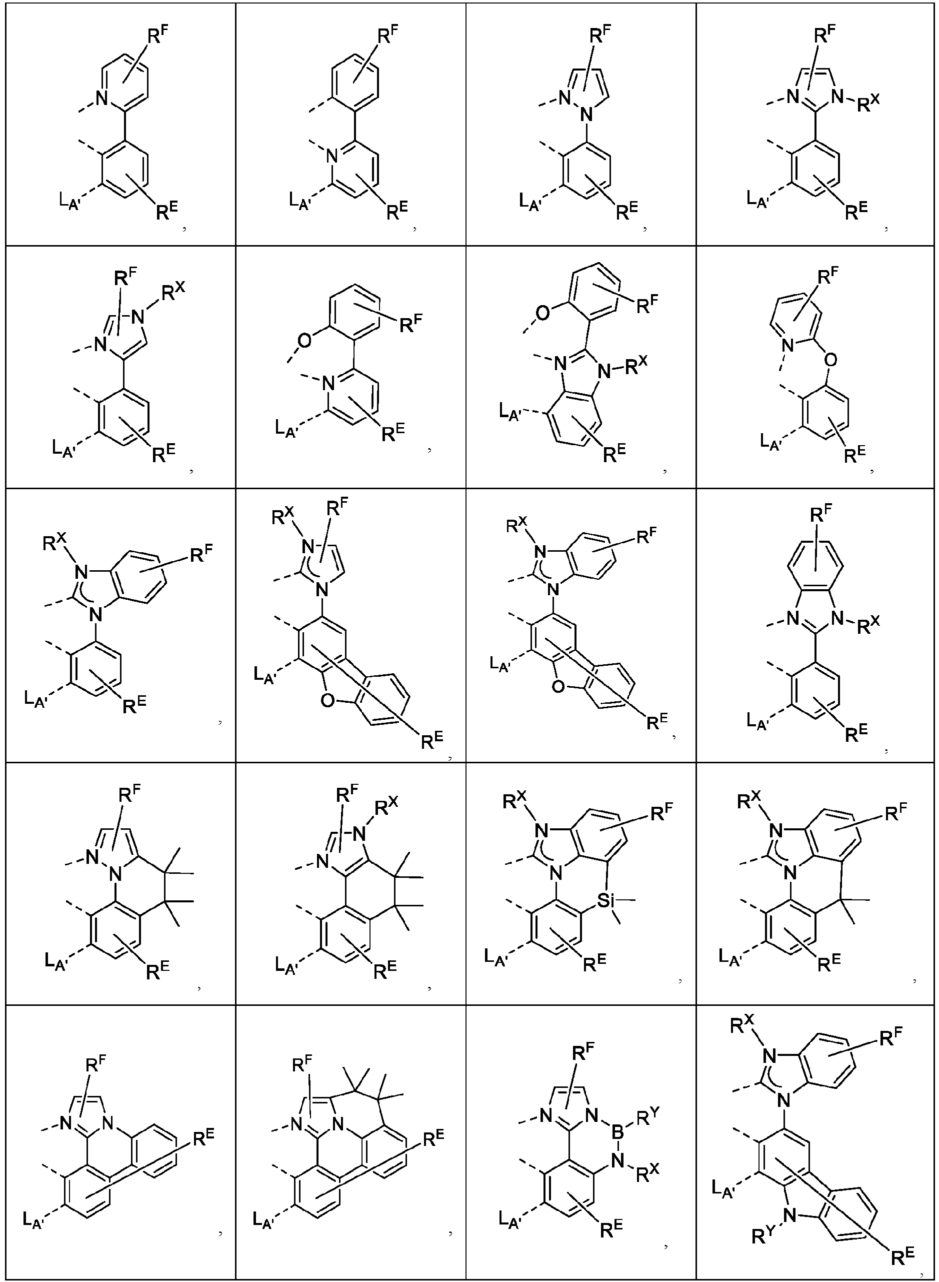 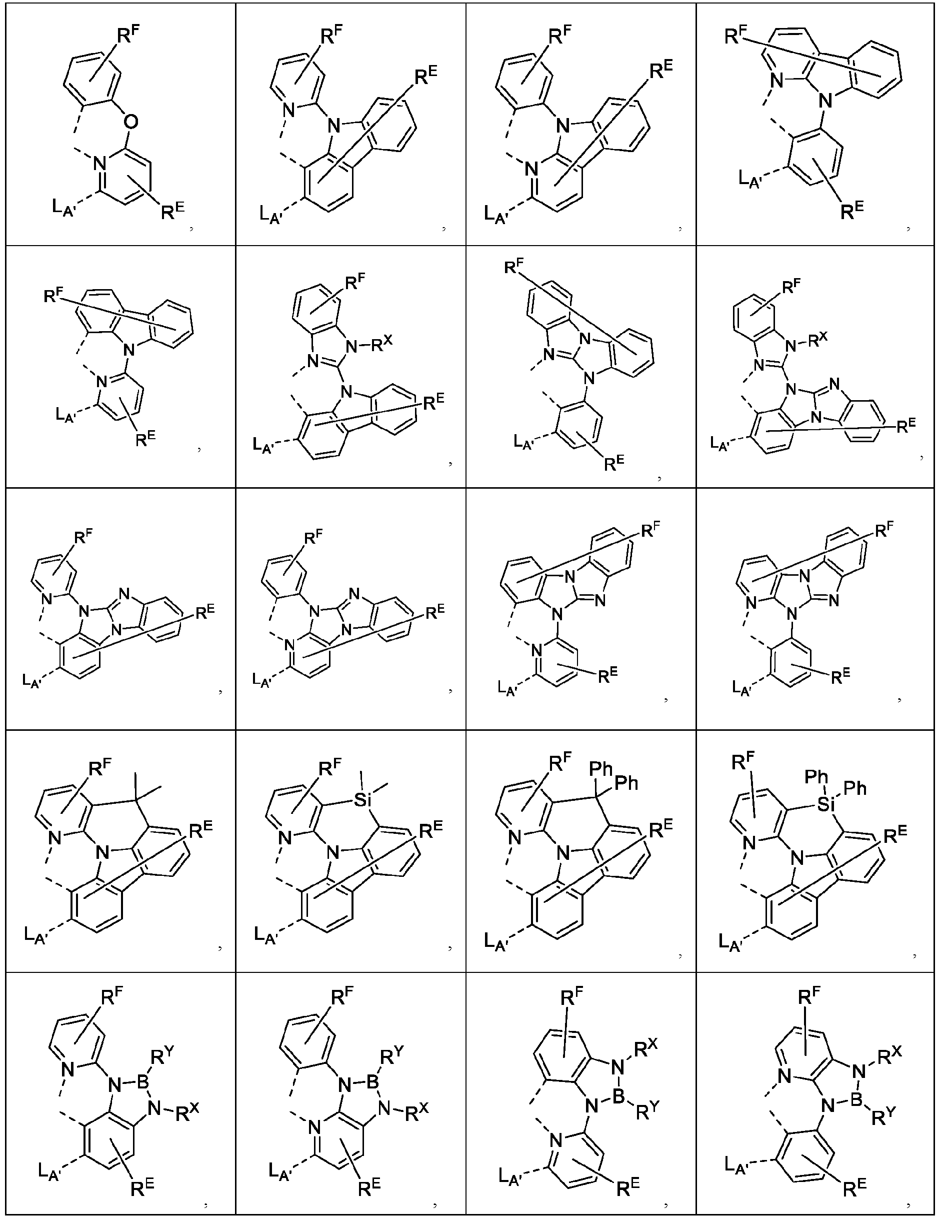 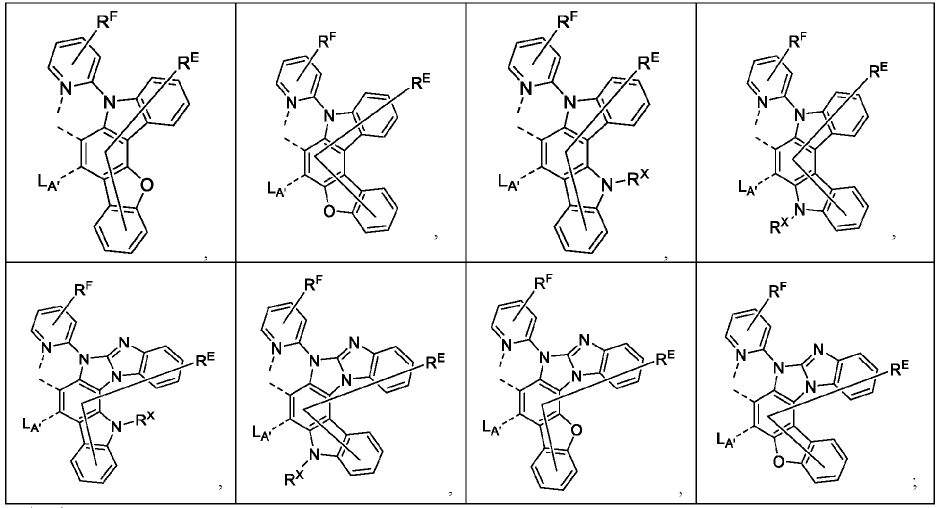 wherein:
   each of X²⁸ to X³¹ is independently C or N;
   Y³ is B, N, P, CR, SiR, or GeR;
   each of R^{A}, R^{B}, R^{C}, R^{D}, R^{A'}, R^{F}, and R^{E} independently represents mono to the maximum allowable substitutions, or no substitutions;
   each R^{A}, R^{B}, R^{C}, R^{D}, R^{A'}, R^{F}, R^{E}, R^{X}, and R^{Y} is independently hydrogen or a substituent selected from the group consisting of the General Substituents defined herein; and
   any two substituents may be joined or fused to form a ring.

In some embodiments, the compound is selected from the group consisting of the compounds having the formula of Pt(L_{A'})(L*y*): 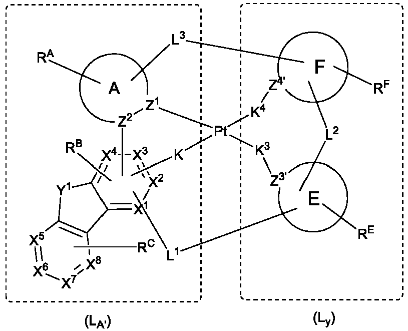 the ligand L_{A'} is selected from L_{A'}w-(R*m*)(R*n*)(R*o*)(L*p*)(E*q*)(E*r*), wherein w is an integer from 1 to 8; each of R*m*, *Rn,* and R*o* is independently selected from R1 to R411, Lp is selected from L1 to L6, E*q* and E*r* is each independently selected from E1 to E80, and each of L_{A'}1-(R1)(R1)(R1)(L1)(E1)(E1) to L_{A'}8-(R411)(R411)(R411)(L6)(E80)(E80) is defined in the following LIST 20:

| L_{A'} | Structure of L_{A'} | L_{A'} | Structure of L_{A'} |
|---|---|---|---|
| L_{A'}1-(R*m*)(R*n*)(R*o*)(L*p*)(E*q*)(E*r*), wherein L_{A'}1-(R1)(R1)(R1)(L1)(E1)(E1) to L_{A'}1-(R411)(R411)(R411)(L6) (E80)(E80) have the structure | 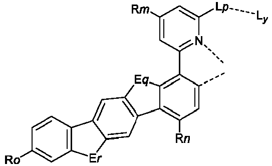 | L_{A'}2-(R*m*)(R*n*)(R*o*)(L*p*)(E*q*)(E r), wherein L_{A'}2-(R1)(R1)(R1)(L1)(E1)(E 1) to L_{A'}2-(R411)(R411)(R411)(L6) (E80)(E80) have the structure | 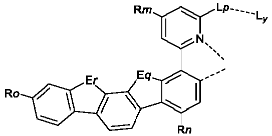 |
| L_{A'}3-(R*m*)(R*n*)(R*o*)(L*p*)(E*q*)(E*r*), wherein L_{A'}3-(R1)(R1)(R1)(L1)(E1)(E1) to L_{A'}3-(R411)(R411)(R411)(L6) (E80)(E80) have the structure | 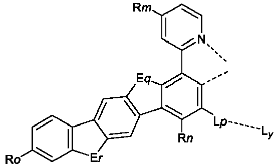 | L_{A'}4-(R*m*)(R*n*)(R*o*)(L*p*)(E*q*)(E r), wherein L_{A'}4-(R1)(R1)(R1)(L1)(E1)(E 1) to L_{A'}4-(R411)(R411)(R411)(L6) (E80)(E80) have the structure | 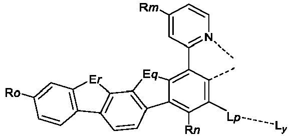 |
| L_{A'}5-(R*m*)(R*n*)(R*o*)(L*p*)(E*q*)(E*r*), wherein L_{A'}5-(R1)(R1)(R1)(L1)(E1)(E1) to L_{A'}5-(R411)(R411)(R411)(L6) (E80)(E80) have the structure | 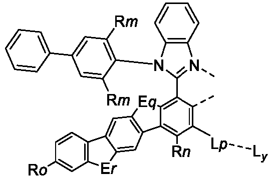 | L_{A'}6-(R*m*)(R*n*)(R*o*)(L*p*)(E*q*)(E r), wherein L_{A'}b-(R1)(R1)(R1)(L1)(E1)(E 1) to L_{A'}-6-(R411)(R411)(R411)(L6) (E80)(E80) have the structure | 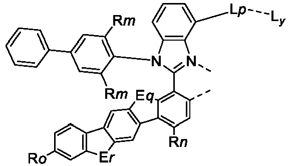 |
| L_{A'}7-(R*m*)(R*n*)(R*o*)(L*p*)(E*q*)(E*r*), wherein L_{A'}7-(R1)(R1)(R1)(L1)(E1)(E1) to L_{A'}7-(R411)(R411)(R411)(L6) (E80)(E80) have the structure | 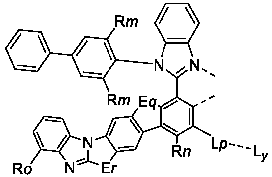 | L_{A'}8-(R*m*)(R*n*)(R*o*)(L*p*)(E*q*)(E r), wherein L_{A'}8-(R1)(R1)(R1)(L1)(E1)(E 1) to L_{A'}8-(R411)(R411)(R411)(L6) (E80)(E80) have the structure | 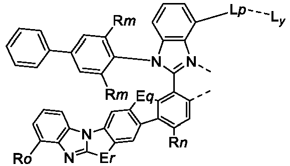 |

the ligand L_{y} is selected from L_{y}g-(R*s*)(R*t*)(R*u*)(R*v*), wherein g is an integer from 1 to 52; each of R*s*, R*t,* R*u,* and R*v* is independently selected from R1 to R411, and each of L_{y}1-(R1)(R1)(R1)(R1) to L_{y}52-(R411)(R411)(R411) (R411) have thee structures is defined in the following LIST 21:

| L_{y} | Structure of L_{y} | L_{y} | Structure of L*_{y}* |
|---|---|---|---|
| L_{y}1-(R*s*)(R*t*)(R*u*)(R*v*), wherein L_{y}1-(R1)(R1)(R1)(R1) to L_{y}1-(R411)(R411)(R411) (R411) have the structure | 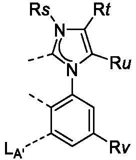 | L_{y}2-(R*s*)(R*t*)(R*u*)(R*v*), wherein L_{y}2-(R1)(R1)(R1) (R1) to L_{y}2-(R411)(R411)(R411) (R411) have the structure | 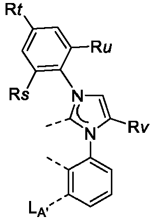 |
| L_{y}3-(R*s*)(R*t*)(R*u*)(R*v*), wherein L_{y}3-(R1)(R1)(R1)(R1) to L_{y}3-(R411)(R411)(R411) (R411) have the structure | 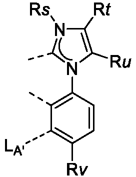 | L_{y}4-(R*s*)(R*t*)(R*u*)(R*v*), wherein L_{y}4-(R1)(R1)(R1)(R1) to L_{y}4-(R411)(R411)(R411) (R411) have the structure | 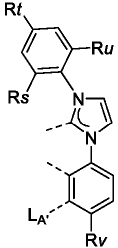 |
| L_{y}5-(R*s*)(R*t*)(R*u*)(R*v*), wherein L_{y}5-(R1)(R1)(R1)(R1) to L_{y}5-(R411)(R411)(R411)(R411), have the structure | 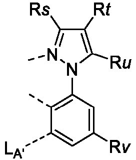 | L_{y}6-(R*s*)(R*t*)(R*u*)(R*v*), wherein L_{y}6-(R1)(R1)(R1)(R1) to L_{y}6-(R411)(R411)(R411)(R411), have the structure | 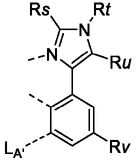 |
| L_{y}7-(R*s*)(R*t*)(R*u*)(R*v*), wherein L_{y}7-(R1)(R1)(R1)(R1) to L_{y}7-(R411)(R411)(R411)(R411), have the structure | 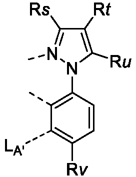 | L_{y}8-(R*s*)(R*t*)(R*u*)(R*v*), wherein L_{y}8-(R1)(R1)(R1)(R1) to L_{y}8-(R411)(R411)(R411)(R411), have the structure | 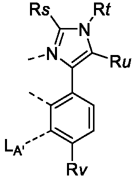 |
| L_{y}9-(R*s*)(R*t*)(R*u*)(R*v)*, wherein L_{y}9-(R1)(R1)(R1)(R1) to L_{y}9-(R411)(R411)(R411)(R411), have the structure | 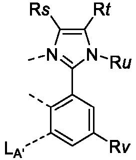 | L_{y}10-(R*s*)(R*t*)(R*u*)(R*v*), wherein L_{y}10-(R1)(R1)(R1)(R1) to L_{y}10-(R411)(R411)(R411)(R411), have the structure | 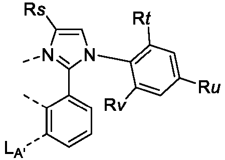 |
| L_{y}11-(R*s*)(R*t*)(R*u*)(R*v*), wherein L_{y}11-(R1)(R1)(R1)(R1) to L_{y}11-(R411)(R411)(R411)(R411), have the structure | 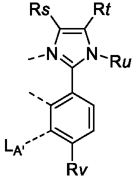 | L_{y}12-(R*s*)(R*t*)(R*u*)(R*v*), wherein L_{y}12-(R1)(R1)(R1)(R1) to L_{y}12-(R411)(R411)(R411)(R411), have the structure | 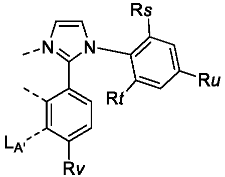 |
| L_{y}13-(R*s*)(R*t*)(R*u*)(R*v*), wherein L_{y}13-(R1)(R1)(R1)(R1) to L_{y}13-(R411)(R411)(R411)(R411), have the structure | 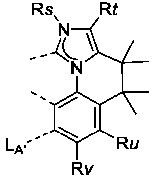 | L_{y}14-(R*s*)(R*t*)(R*u*)(R*v*), wherein L_{y}14-(R1)(R1)(R1)(R1) to L_{y}14-(R411)(R411)(R411)(R411), have the structure | 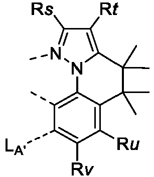 |
| L_{y}15-(R*s*)(R*t*)(R*u*)(R*v*), wherein L_{y}15-(R1)(R1)(R1)(R1) to L_{y}15-(R411)(R411)(R411)(R411), have the structure | 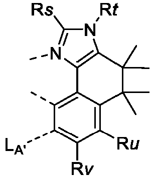 | L_{y}16-(R*s*)(R*t*)(R*u*)(R*v*), wherein L_{y}16-(R1)(R1)(R1)(R1) to L_{y}16-(R411)(R411)(R411)(R411), have the structure | 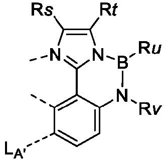 |
| L_{y}17-(R*s*)(R*t*)(R*u*)(R*v*), wherein L_{y}17-(R1)(R1)(R1)(R1) to L_{y}17-(R411)(R411)(R411)(R411), have the structure | 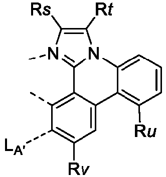 | L_{y}18-(R*s*)(R*t*)(R*u*)(R*v*), wherein L_{y}18-(R1)(R1)(R1)(R1) to L_{y}18-(R411)(R411)(R411)(R411), have the structure | 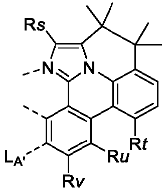 |
| L_{y}19-(Rs)(Rt)(Ru)(Rn), wherein L_{y}19-(R1)(R1)(R1)(R1) to L_{y}19-(R411)(R411)(R411)(R411), have the structure | 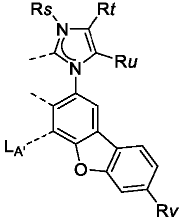 | L_{y}20-(R*s*)(R*t*)(R*u*)(R*v*), wherein L_{y}20-(R1)(R1)(R1)(R1) to L_{y}20-(R411)(R411)(R411)(R411), have the structure | 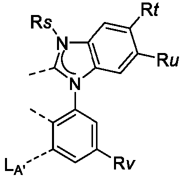 |
| L_{y}21-(R*s*)(R*t*)(R*u*)(R*v*), wherein L_{y}20-(R1)(R1)(R1)(R1) to L_{y}21-(R411)(R411)(R411)(R411), have the structure | 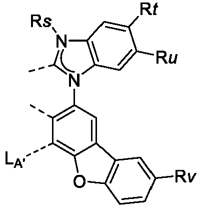 | L_{y}22-(R*s*)(R*t*)(R*u*)(R*v*), wherein L_{y}22-(R1)(R1)(R1)(R1) to L_{y}22-(R411)(R411)(R411)(R411), have the structure | 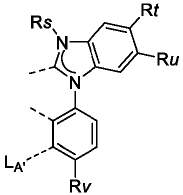 |
| L_{y}23-(R*s*)(R*t*)(R*u*)(R*v*), wherein L_{y}23-(R1)(R1)(R1)(R1) to L_{y}23-(R411)(R411)(R411)(R411), have the structure | 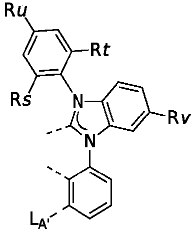 | L_{y}24-(R*s*)(R*t*)(R*u*)(R*v*), wherein L_{y}24-(R1)(R1)(R1)(R1) to L_{y}24-(R411)(R411)(R411)(R411), have the structure | 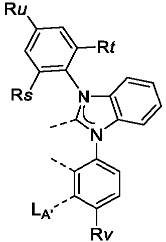 |
| L_{y}25-(R*s*)(R*t*)(R*u*)(R*v*), wherein L_{y}25-(R1)(R1)(R1)(R1) to L_{y}25-(R411)(R411)(R411)(R411), have the structure | 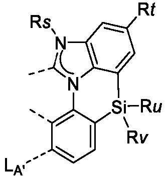 | L_{y}26-(R*s*)(R*t*)(R*u*)(R*v*), wherein L_{y}26-(R1)(R1)(R1)(R1) to L_{y}26-(R411)(R411)(R411)(R411), have the structure | 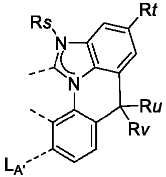 |
| L_{y}27-(R*s*)(R*t*)(R*u*)(R*v*), wherein L_{y}27-(R1)(R1)(R1)(R1) to L_{y}27-(R411)(R411)(R411)(R411), have the structure | 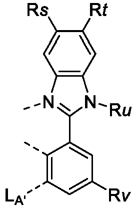 | L_{y}28-(R*s*)(R*t*)(R*u*)(R*v*), wherein L_{y}28-(R1)(R1)(R1)(R1) to L_{y}28-(R411)(R411)(R411)(R411), have the structure | 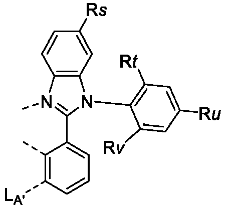 |
| L_{y}29-(R*s*)(R*t*)(R*u*)(R*v*), wherein L_{y}29-(R1)(R1)(R1)(R1) to L_{y}29-(R411)(R411)(R411)(R411), have the structure | 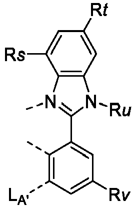 | L_{y}30-(R*s*)(R*t*)(R*u*)(R*v*), wherein L_{y}30-(R1)(R1)(R1)(R1) to L_{y}30-(R411)(R411)(R411)(R411), have the structure | 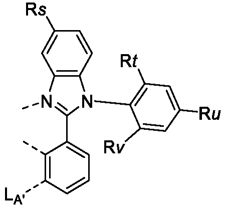 |
| L_{y}31-(R*s*)(R*t*)(R*u*)(R*v*), wherein L_{y}31-(R1)(R1)(R1)(R1) to L_{y}31-(R411)(R411)(R411)(R411), have the structure | 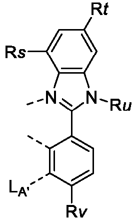 | L_{y}32-(R*s*)(R*t*)(R*u*)(R*v*), wherein L_{y}32-(R1)(R1)(R1)(R1) to L_{y}32-(R411)(R411)(R411)(R411), have the structure | 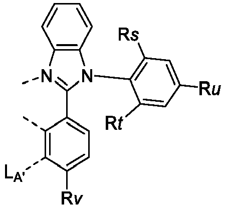 |
| L_{y}33-(R*s*)(R*t*)(R*u*)(R*v*), wherein L_{y}33-(R1)(R1)(R1)(R1) to L_{y}33-(R411)(R411)(R411)(R411), have the structure | 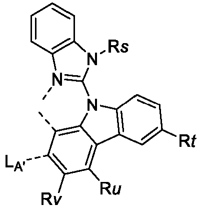 | L_{y}34-(R*s*)(R*t*)(R*u*)(R*v*), wherein L_{y}34-(R1)(R1)(R1)(R1) to L_{y}34-(R411)(R411)(R411)(R411), have the structure | 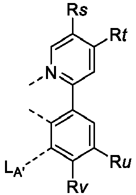 |
| L_{y}35-(R*s*)(R*t*)(R*u*)(R*v*), wherein L_{y}35-(R1)(R1)(R1)(R1) to L_{y}35-(R411)(R411)(R411)(R411), have the structure | 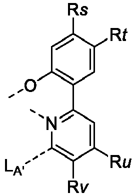 | L_{y}36-(R*s*)(R*t*)(R*u*)(R*v*), wherein L_{y}36-(R1)(R1)(R1)(R1) to L_{y}36-(R411)(R411)(R411)(R411), have the structure | 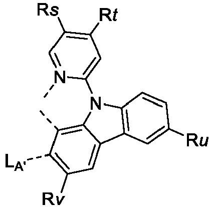 |
| L_{y}37-(R*s*)(R*t*)(R*u*)(R*v*), wherein L_{y}37-(R1)(R1)(R1)(R1) to L_{y}37-(R411)(R411)(R411)(R411), have the structure | 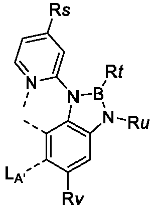 | L_{y}38-(R*s*)(R*t*)(R*u*)(R*n*), wherein L_{y}38-(R1)(R1)(R1)(R1) to L_{y}38-(R411)(R411)(R411)(R411), have the structure | 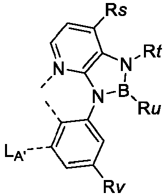 |
| L_{y}39-(R*s*)(R*t*)(R*u*)(R*v*), wherein L_{y}39-(R1)(R1)(R1)(R1) to L_{y}39-(R411)(R411)(R411)(R411), have the structure | 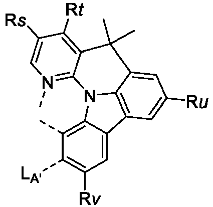 | L_{y}40-(R*s*)(R*t*)(R*u*)(R*v*), wherein L_{y}40-(R1)(R1)(R1)(R1)(R1) to L_{y}40-(R411)(R411)(R411)(R411), have the structure | 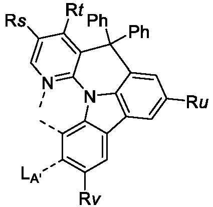 |
| L_{y}41-(R*s*)(R*t*)(R*u*)(R*v*), wherein L_{y}41-(R1)(R1)(R1)(R1) to L_{y}41-(R411)(R411)(R411)(R411), have the structure | 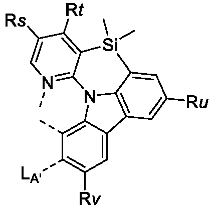 | L_{y}42-(R*s*)(R*t*)(R*u*)(R*v*), wherein L_{y}42-(R1)(R1)(R1)(R1) to L_{y}42-(R411)(R411)(R411)(R411), have the structure | 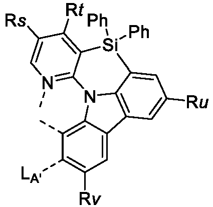 |
| L_{y}43-(R*s*)(R*t*)(R*u*)(R*v*), wherein L_{y}43-(R1)(R1)(R1)(R1) to L_{y}43-(R411)(R411)(R411)(R411), have the structure | 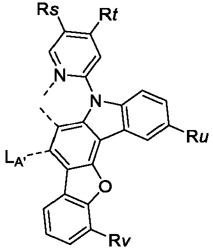 | L_{y}44-(R*s*)(R*t*)(R*u*)(R*v*), wherein L_{y}44-(R1)(R1)(R1)(R1) to L_{y}44-(R411)(R411)(R411)(R411), have the structure | 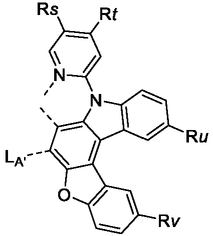 |
| L_{y}45-(R*s*)(R*t*)(R*u*)(R*v*), wherein L_{y}45-(R1)(R1)(R1)(R1) to L_{y}45-(R411)(R411)(R411)(R411), have the structure | 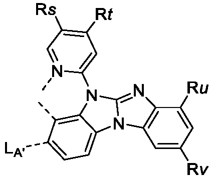 | L_{y}46-(R*s*)(R*t*)(R*u*)(R*v*), wherein L_{y}46-(R1)(R1)(R1)(R1) to L_{y}46-(R411)(R411)(R411)(R411), have the structure | 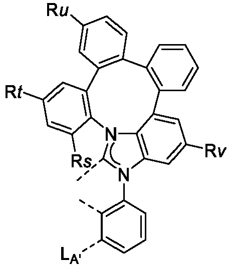 |
| L_{y}47-(R*s*)(R*t*)(R*u*)(R*v*), wherein L_{y}47-(R1)(R1)(R1)(R1) to L_{y}47-(R411)(R411)(R411)(R411), have the structure | 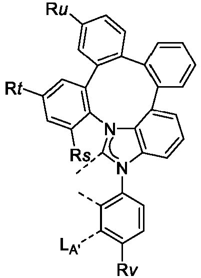 | L_{y}48-(R*s*)(R*t*)(R*u*)(R*v*), wherein L_{y}48-(R1)(R1)(R1)(R1) to L_{y}48-(R411)(R411)(R411)(R411), have the structure | 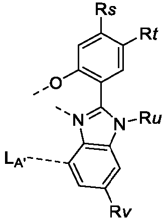 |
| L_{y}49-(R*s*)(R*t*)(R*u*)(R*v*), wherein L_{y}49-(R1)(R1)(R1)(R1) to L_{y}49-(R411)(R411)(R411)(R411), have the structure | 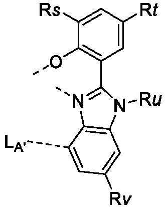 | L_{y}50-(R*s*)(R*t*)(R*u*)(R*v*), wherein L_{y}50-(R1)(R1)(R1)(R1) to L_{y}50-(R411)(R411)(R411)(R411), have the structure | 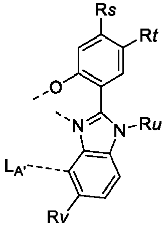 |
| L_{y}51-(R*s*)(R*t*)(R*u*)(R*v*), wherein L_{y}51-(R1)(R1)(R1)(R1) to L_{y}51-(R411)(R411)(R411)(R411), have the structure | 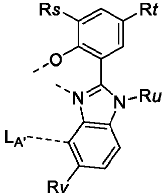 | L_{y}52-(R*s*)(R*t*)(R*u*)(R*v*), wherein L_{y}52-(R1)(R1)(R1)(R1) to L_{y}52-(R411)(R411)(R411)(R411), have the structure | 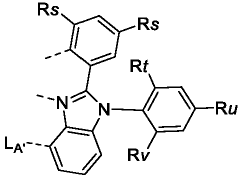 |

wherein R1 to R411 have the structures defined in LIST 9 defined herein; and
wherein L1 to L6 have the structures defined in the following LIST 22:

| | Structure | | Structure | | Structure |
|---|---|---|---|---|---|
| L1 | Direct bond | L2 | 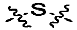 | L3 | 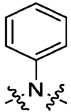 |
| L4 | 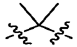 | L5 | 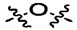 | L6 | 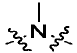 |

wherein E1 to E80 have the structures defined in the following LIST 23:

| | Structure | | Structure | | Structure |
|---|---|---|---|---|---|
| E1 | 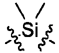 | E2 | 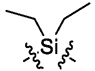 | E3 | 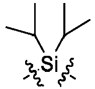 |
| E4 | 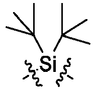 | E5 | 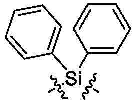 | E6 | 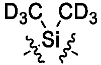 |
| E7 | 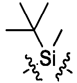 | E8 | 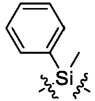 | E9 | 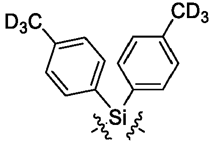 |
| E10 | 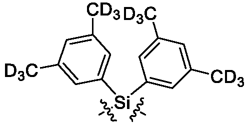 | E11 | 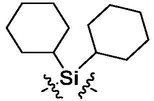 | E12 | 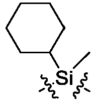 |
| E13 | 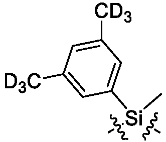 | E14 | 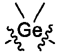 | E15 | 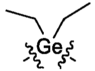 |
| E16 | 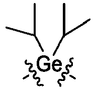 | E17 | 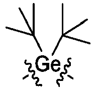 | E18 | 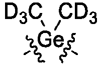 |
| E19 | 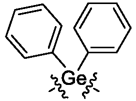 | E20 | 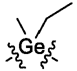 | E21 | 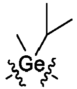 |
| E22 | 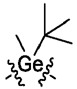 | E23 | 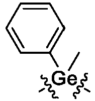 | E24 | 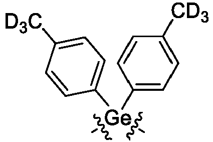 |
| E25 | 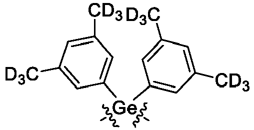 | E26 | 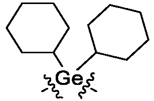 | E27 | 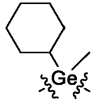 |
| E28 | 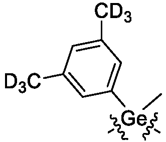 | E29 | 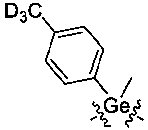 | E30 | 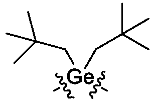 |
| E31 | 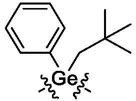 | E32 | 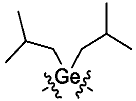 | E33 | 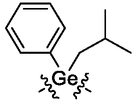 |
| E34 | 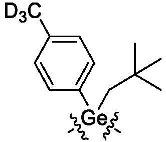 | E35 | 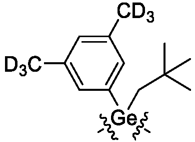 | E36 | 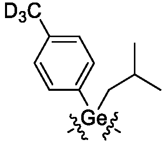 |
| E37 | 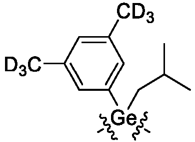 | E38 | 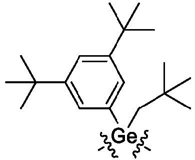 | E39 | 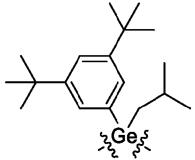 |
| E40 | 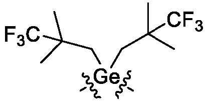 | E41 | 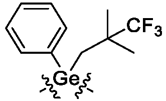 | E42 | 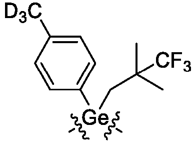 |
| E43 | 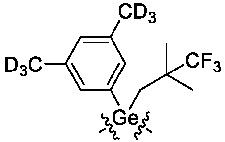 | E44 | 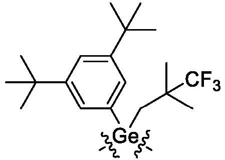 | E45 | 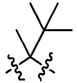 |
| E46 | 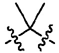 | E47 | 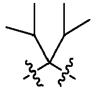 | E48 | 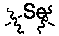 |
| E49 | 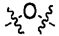 | E50 | 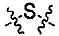 | E51 | 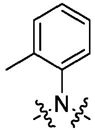 |
| E52 | 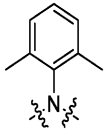 | E53 | 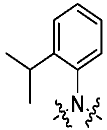 | E54 | 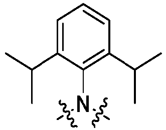 |
| E55 | 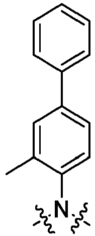 | E56 | 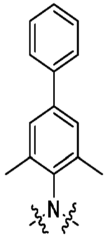 | E57 | 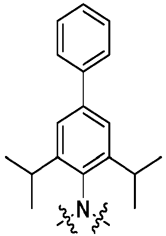 |
| E58 | 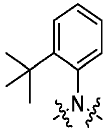 | E59 | 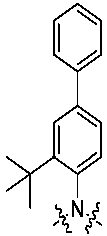 | E60 | 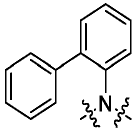 |
| E61 | 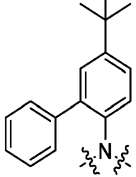 | E62 | 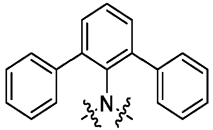 | E63 | 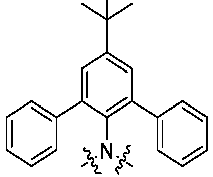 |
| E64 | 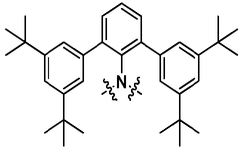 | E65 | 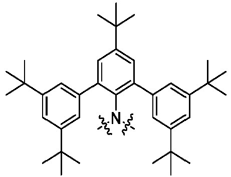 | E66 | 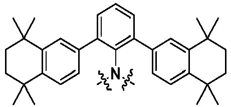 |
| E67 | 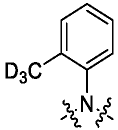 | E68 | 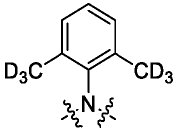 | E69 | 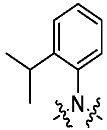 |
| E70 | 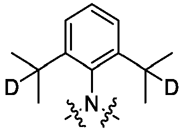 | E71 | 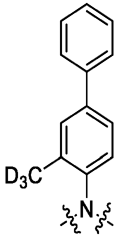 | E72 | 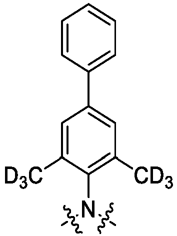 |
| E73 | 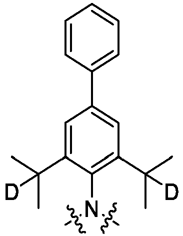 | E74 | 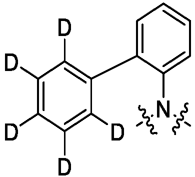 | E75 | 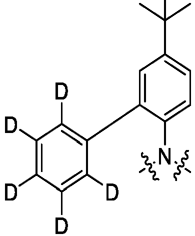 |
| E76 | 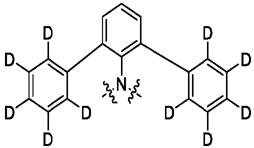 | E77 | 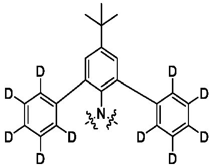 | E78 | 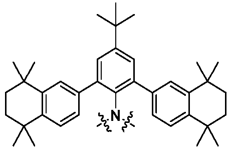 |
| E79 | 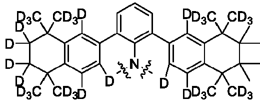 | E80 | 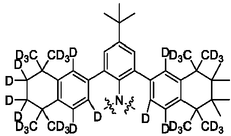 | | |

wherein R1 to R411 have the following structures as defined in the following LIST 23a:

| | Structure | | Structure | | Structure |
|---|---|---|---|---|---|
| R1 | 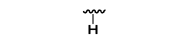 | R2 | 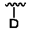 | R3 | 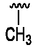 |
| R4 | 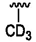 | R5 | 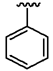 | R6 | 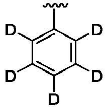 |
| R7 | 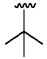 | R8 | 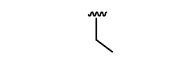 | R9 | 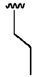 |
| R10 | 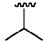 | R11 | 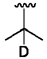 | R12 | 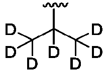 |
| R13 | 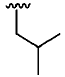 | R14 | 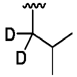 | R15 | 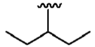 |
| R16 | 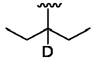 | R17 | 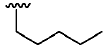 | R18 | 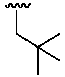 |
| R19 | 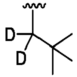 | R20 | 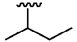 | R21 | 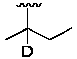 |
| R22 | 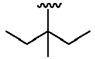 | R23 | 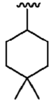 | R24 | 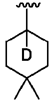 |
| R25 | 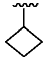 | R26 | 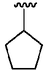 | R27 | 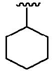 |
| R28 | 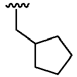 | R29 | 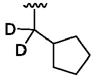 | R30 | 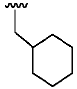 |
| R31 | 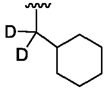 | R32 | 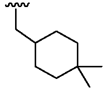 | R33 | 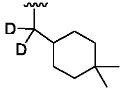 |
| R34 | 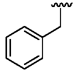 | R35 | 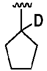 | R36 | 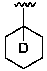 |
| R37 | 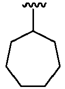 | R38 | 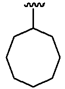 | R39 | 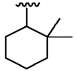 |
| R40 | 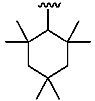 | R41 | 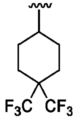 | R42 | 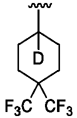 |
| R43 | 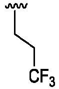 | R44 | 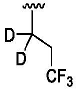 | R45 | 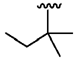 |
| R46 | 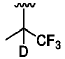 | R47 | 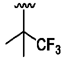 | R48 | 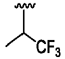 |
| R49 | 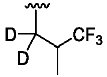 | R50 | 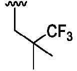 | R51 | 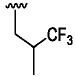 |
| R52 | 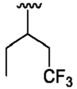 | R53 | 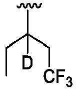 | R54 | 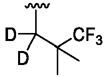 |
| R55 | 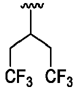 | R56 | 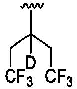 | R57 | 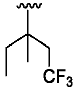 |
| R58 | 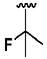 | R59 | 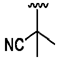 | R60 | 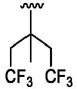 |
| R61 | 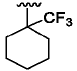 | R62 | 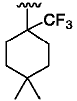 | R63 | 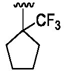 |
| R64 | 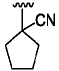 | R65 | 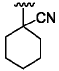 | R66 | 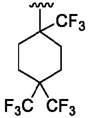 |
| R67 | 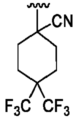 | R68 | 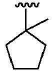 | R69 | 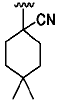 |
| R70 | 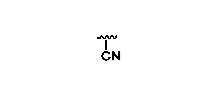 | R71 | 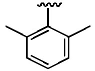 | R72 | 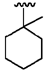 |
| R73 | 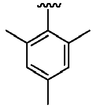 | R74 | 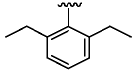 | R75 | 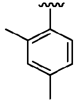 |
| R76 | 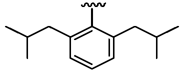 | R77 | 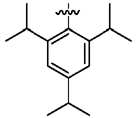 | R78 | 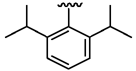 |
| R79 | 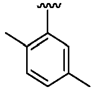 | R80 | 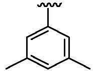 | R81 | 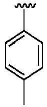 |
| R82 | 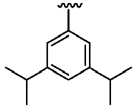 | R83 | 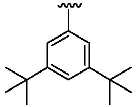 | R84 | 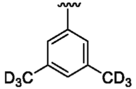 |
| R85 | 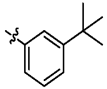 | R86 | 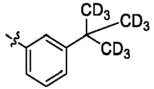 | R87 | 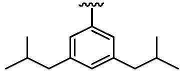 |
| R88 | 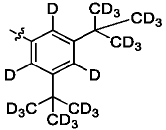 | R89 | 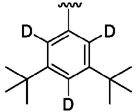 | R90 | 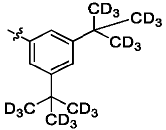 |
| R91 | 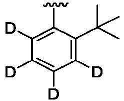 | R92 | 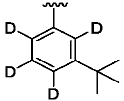 | R93 | 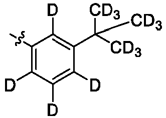 |
| R94 | 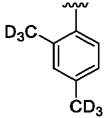 | R95 | 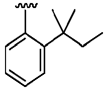 | R96 | 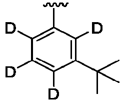 |
| R97 | 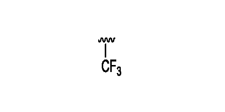 | R98 | 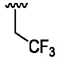 | R99 | 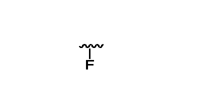 |
| R100 | 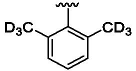 | R101 | 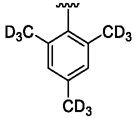 | R102 | 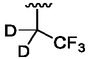 |
| R103 | 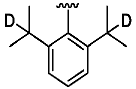 | R104 | 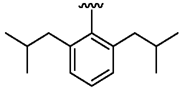 | R105 | 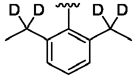 |
| R106 | 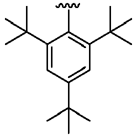 | R107 | 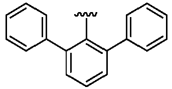 | R108 | 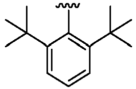 |
| R109 | 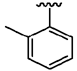 | R110 | 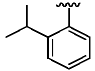 | R111 | 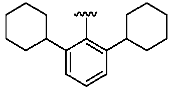 |
| R112 | 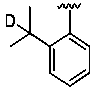 | R113 | 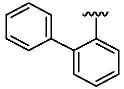 | R114 | 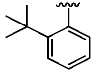 |
| R115 | 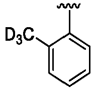 | R116 | 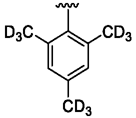 | R117 | 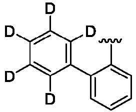 |
| R118 | 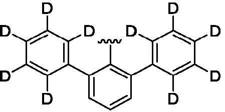 | R119 | 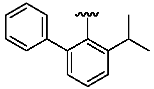 | R120 | 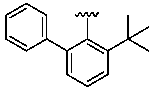 |
| R121 | 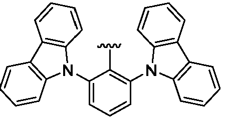 | R122 | 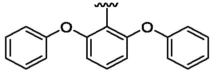 | R123 | 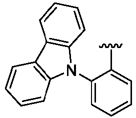 |
| R124 | 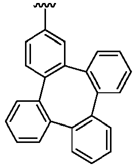 | R125 | 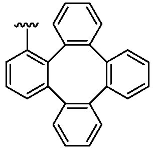 | R126 | 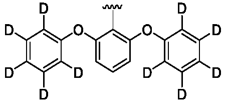 |
| R127 | 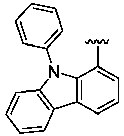 | R128 | 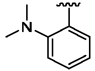 | R129 | 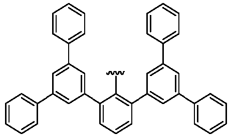 |
| R130 | 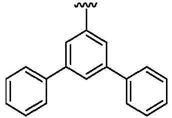 | R131 | 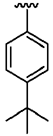 | R132 | 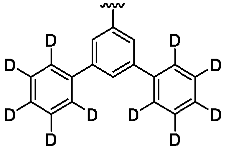 |
| R133 | 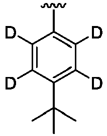 | R134 | 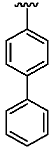 | R135 | 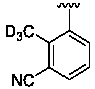 |
| R136 | 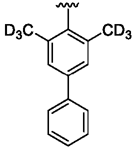 | R137 | 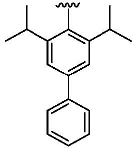 | R138 | 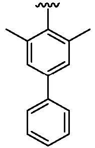 |
| R139 | 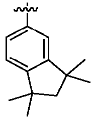 | R140 | 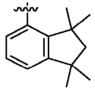 | R141 | 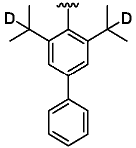 |
| R142 | 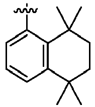 | R143 | 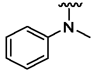 | R144 | 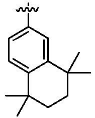 |
| R145 | 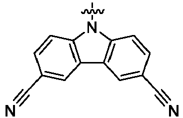 | R146 | 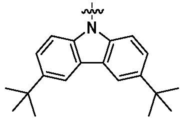 | R147 | 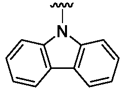 |
| R148 | 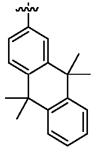 | R149 | 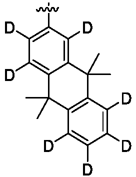 | R150 | 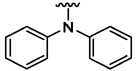 |
| R151 | 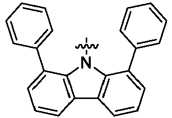 | R152 | 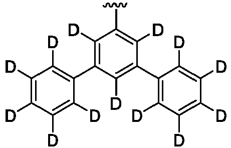 | R153 | 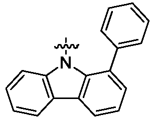 |
| | | | | | |
| R154 | 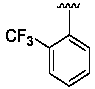 | R155 | 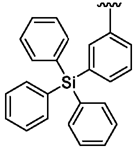 | R156 | 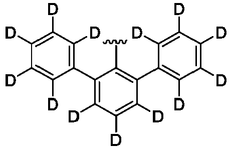 |
| R157 | 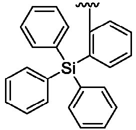 | R158 | 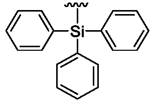 | R159 | 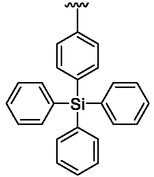 |
| R160 | 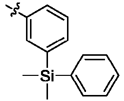 | R161 | 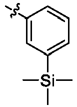 | R162 | 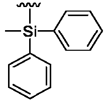 |
| R163 | 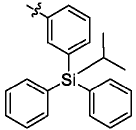 | R164 | 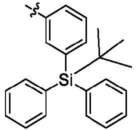 | R165 | 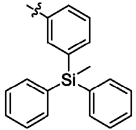 |
| R166 | 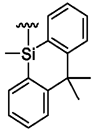 | R167 | 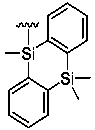 | R168 | 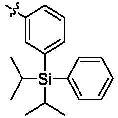 |
| R169 | 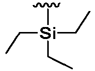 | R170 | 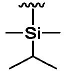 | R171 | 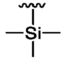 |
| R172 | 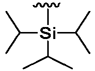 | R173 | 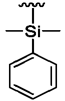 | R174 | 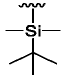 |
| R175 | 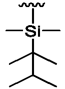 | R176 | 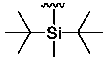 | R177 | 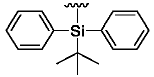 |
| R178 | 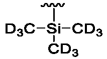 | R179 | 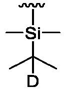 | R180 | 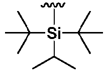 |
| R181 | 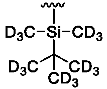 | R182 | 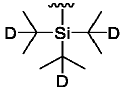 | R183 | 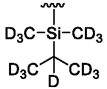 |
| R184 | 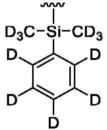 | R185 | 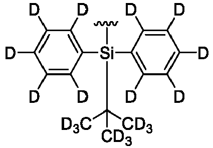 | R186 | 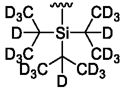 |
| R187 | 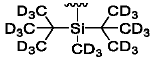 | R188 | 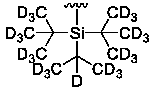 | R189 | 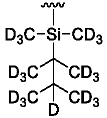 |
| R190 | 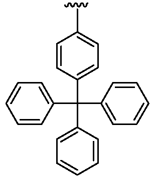 | R191 | 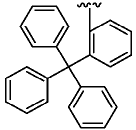 | R192 | 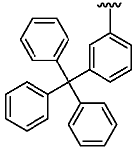 |
| R193 | 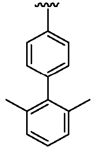 | R194 | 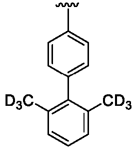 | R195 | 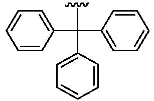 |
| R196 | 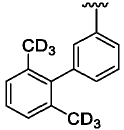 | R197 | 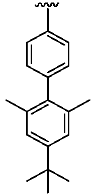 | R198 | 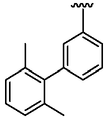 |
| R199 | 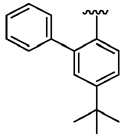 | R200 | 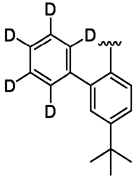 | R201 | 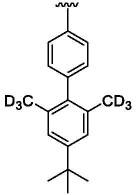 |
| R202 | 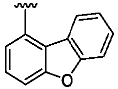 | R203 | 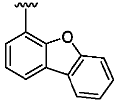 | R204 | 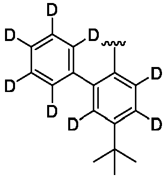 |
| R205 | 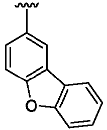 | R206 | 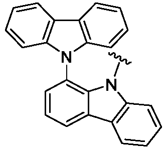 | R207 | 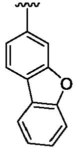 |
| R208 | 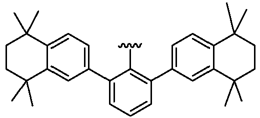 | R209 | 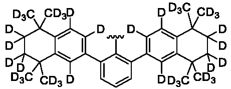 | R210 | 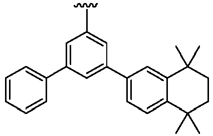 |
| R211 | 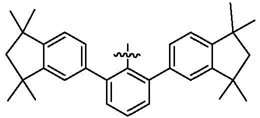 | R212 | 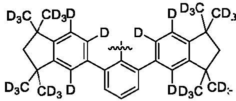 | R213 | 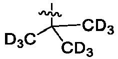 |
| R214 | 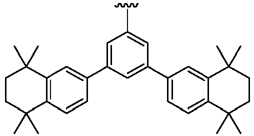 | R215 | 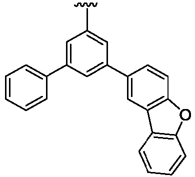 | R216 | 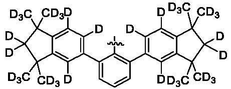 |
| R217 | 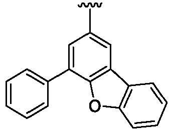 | R218 | 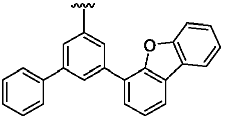 | R219 | 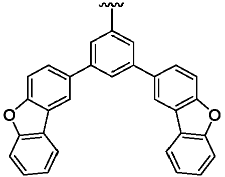 |
| R220 | 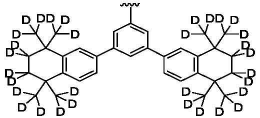 | R221 | 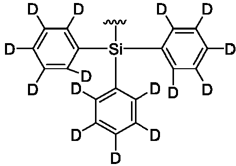 | R222 | 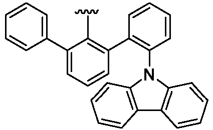 |
| R223 | 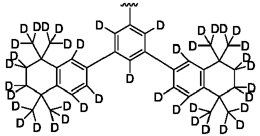 | R224 | 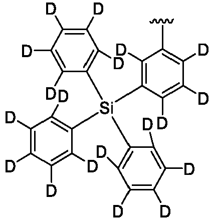 | R225 | 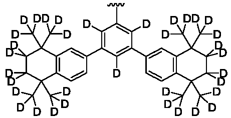 |
| R226 | 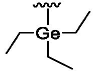 | R227 | 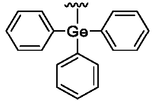 | R228 | 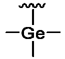 |
| R229 | 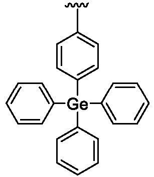 | R230 | 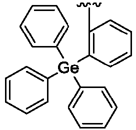 | R231 | 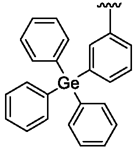 |
| R232 | 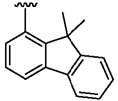 | R233 | 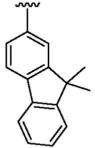 | R234 | 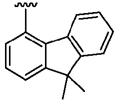 |
| R235 | 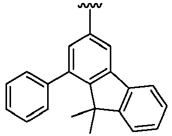 | R236 | 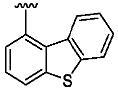 | R237 | 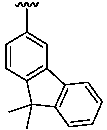 |
| R238 | 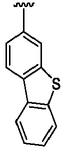 | R239 | 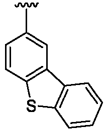 | R240 | 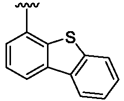 |
| R241 | 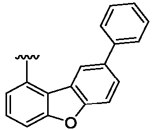 | R242 | 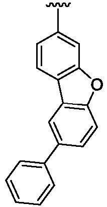 | R243 | 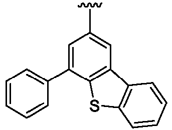 |
| R244 | 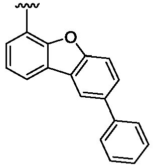 | R245 | 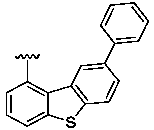 | R246 | 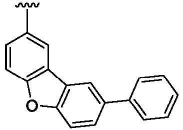 |
| R247 | 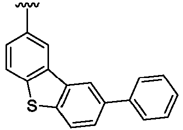 | R248 | 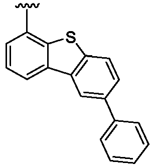 | R249 | 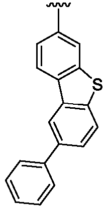 |
| R250 | 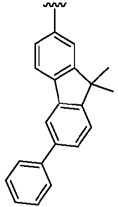 | R251 | 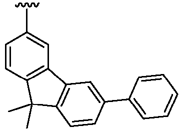 | R252 | 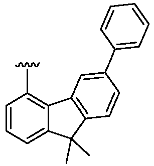 |
| R253 | 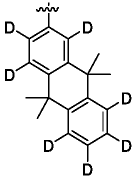 | R254 | 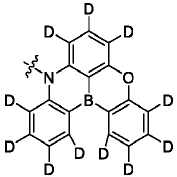 | R255 | 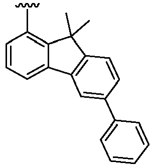 |
| R256 | 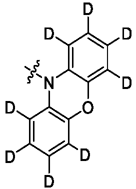 | R257 | 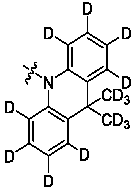 | R258 | 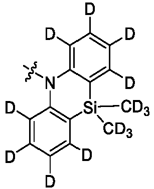 |
| R259 | 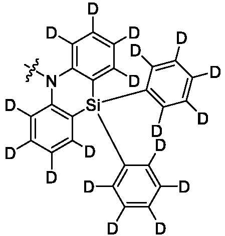 | R260 | 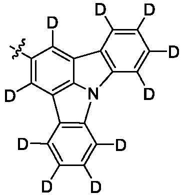 | R261 | 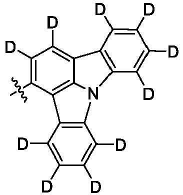 |
| R262 | 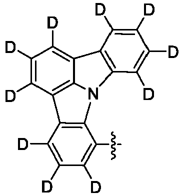 | R263 | 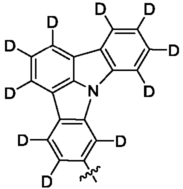 | R264 | 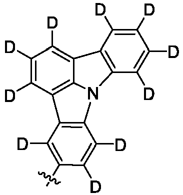 |
| R265 | 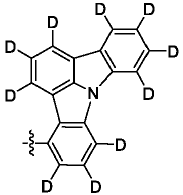 | R266 | 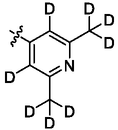 | R267 | 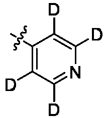 |
| R268 | 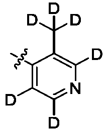 | R269 | 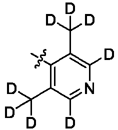 | R270 | 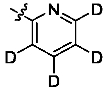 |
| R271 | 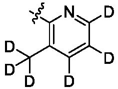 | R272 | 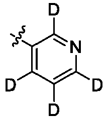 | R273 | 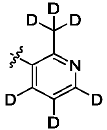 |
| R274 | 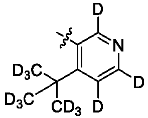 | R275 | 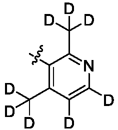 | R276 | 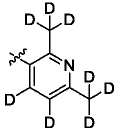 |
| R277 | 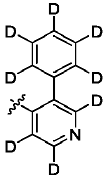 | R278 | 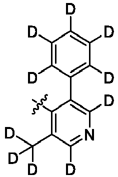 | R279 | 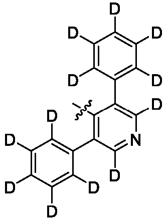 |
| R280 | 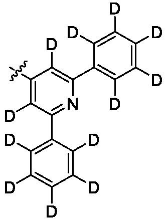 | R281 | 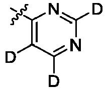 | R282 | 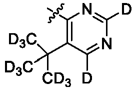 |
| R283 | 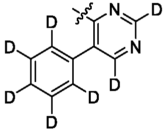 | R284 | 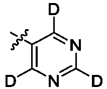 | R285 | 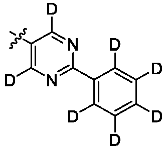 |
| R286 | 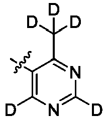 | R287 | 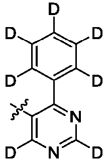 | R288 | 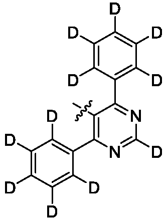 |
| R289 | 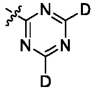 | R290 | 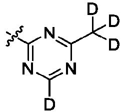 | R291 | 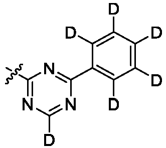 |
| R292 | 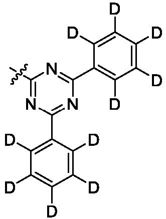 | R293 | 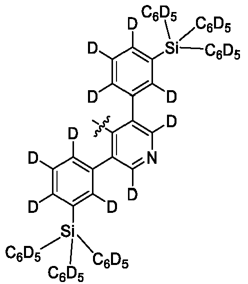 | R294 | 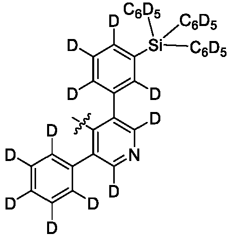 |
| R295 | 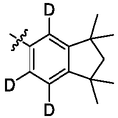 | R296 | 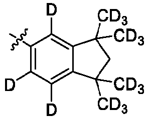 | R297 | 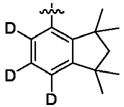 |
| R298 | 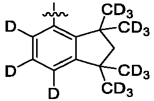 | R299 | 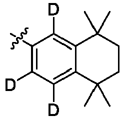 | R300 | 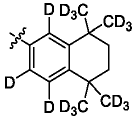 |
| R301 | 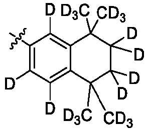 | R302 | 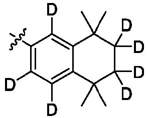 | R303 | 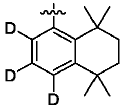 |
| R304 | 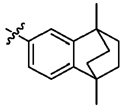 | R305 | 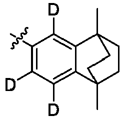 | R306 | 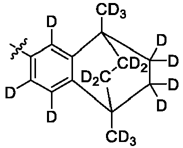 |
| R307 | 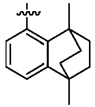 | R308 | 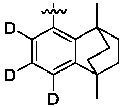 | R309 | 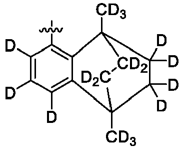 |
| R310 | 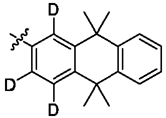 | R311 | 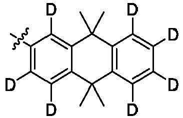 | R312 | 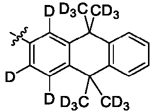 |
| R313 | 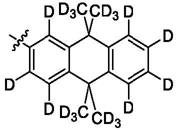 | R314 | 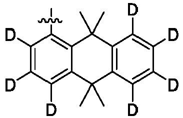 | R315 | 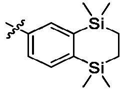 |
| R316 | 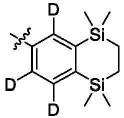 | R317 | 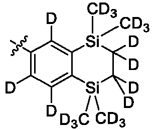 | R318 | 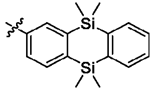 |
| R319 | 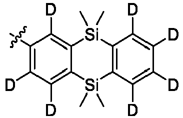 | R320 | 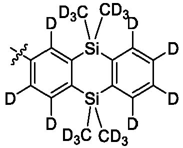 | R321 | 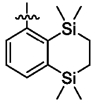 |
| R322 | 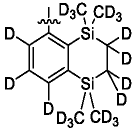 | R323 | 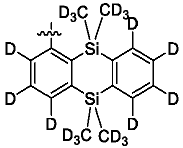 | R324 | 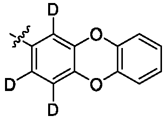 |
| R325 | 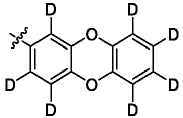 | R326 | 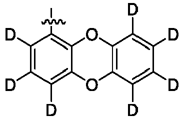 | R327 | 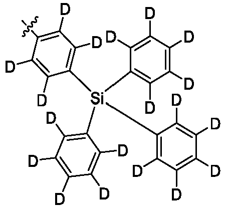 |
| R328 | 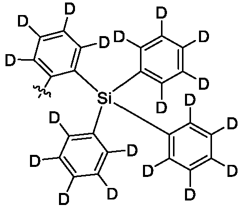 | R329 | 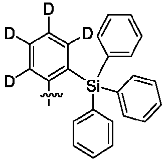 | R330 | 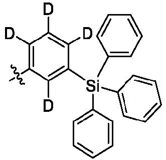 |
| R331 | 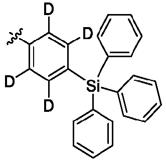 | R332 | 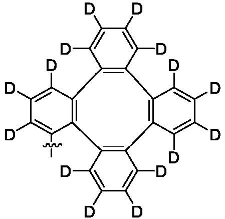 | R333 | 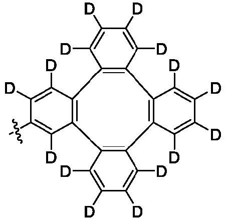 |
| R334 | 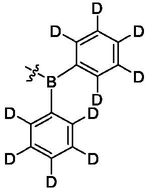 | R335 | 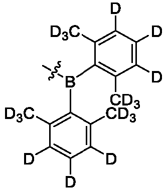 | R336 | 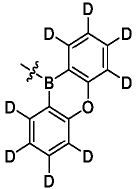 |
| R337 | 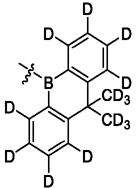 | R338 | 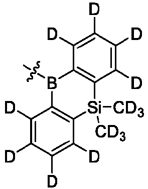 | R339 | 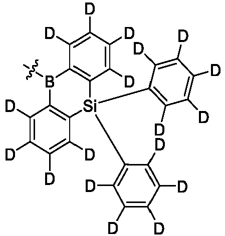 |
| R340 | 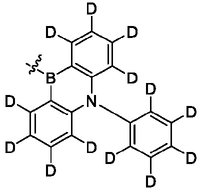 | R341 | 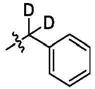 | R342 | 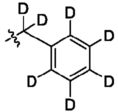 |
| R343 | 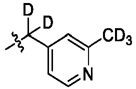 | R344 | 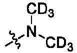 | R345 | 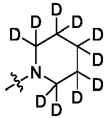 |
| R346 | 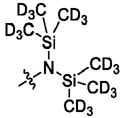 | R347 | 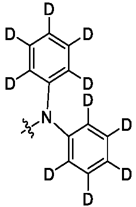 | R348 | 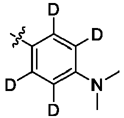 |
| R349 | 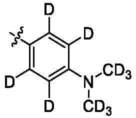 | R350 | 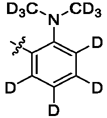 | R351 | 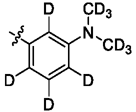 |
| R352 | 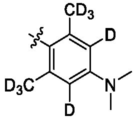 | R353 | 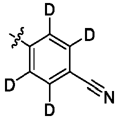 | R354 | 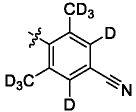 |
| R355 | 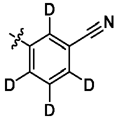 | R356 | 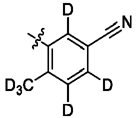 | R357 | 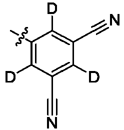 |
| R358 | 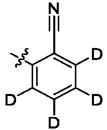 | R359 | 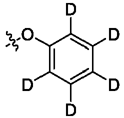 | R360 | 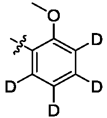 |
| R361 | 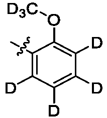 | R362 | 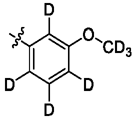 | R363 | 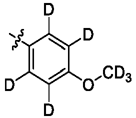 |
| R364 | 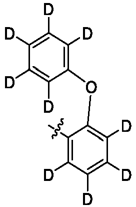 | R365 | 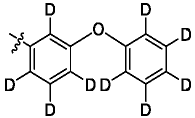 | R366 | 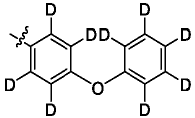 |
| R367 | 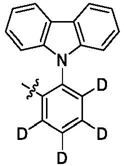 | R368 | 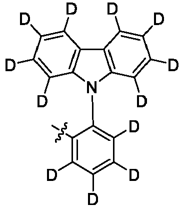 | R369 | 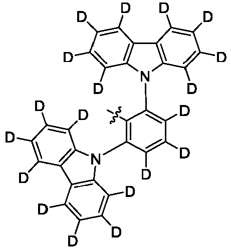 |
| R370 | 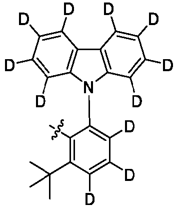 | R371 | 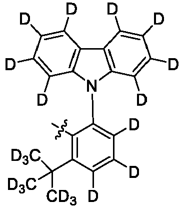 | R372 | 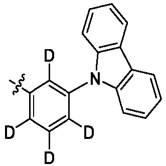 |
| R373 | 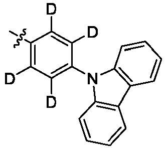 | R374 | 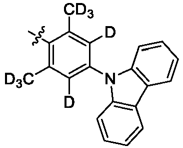 | R375 | 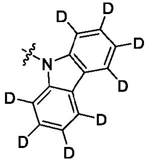 |
| R376 | 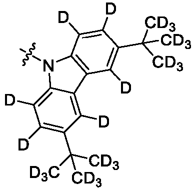 | R377 | 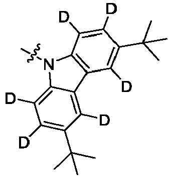 | R378 | 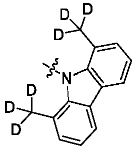 |
| R379 | 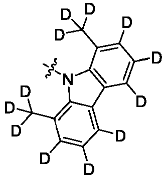 | R380 | 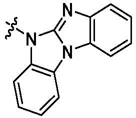 | R381 | 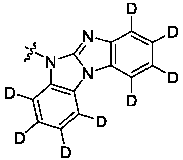 |
| R382 | 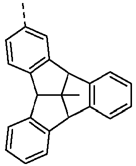 | R383 | 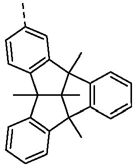 | R384 | 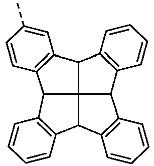 |
| R385 | 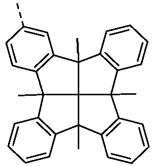 | R386 | 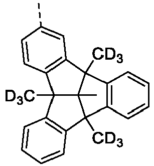 | R387 | 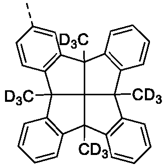 |
| R388 | 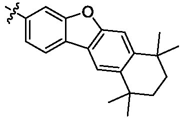 | R389 | 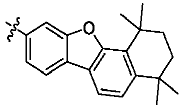 | R390 | 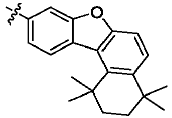 |
| R391 | 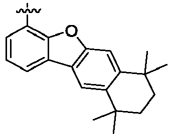 | R392 | 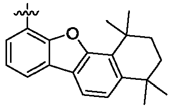 | R393 | 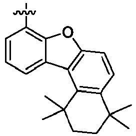 |
| R394 | 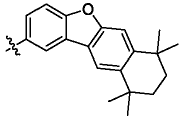 | R395 | 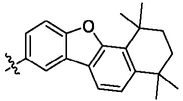 | R396 | 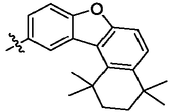 |
| R397 | 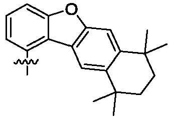 | R398 | 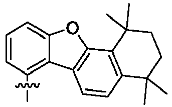 | R399 | 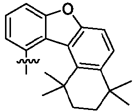 |
| R400 | 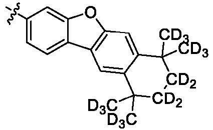 | R401 | 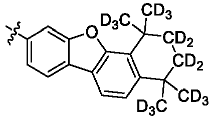 | R402 | 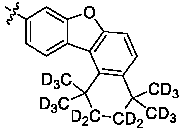 |
| R403 | 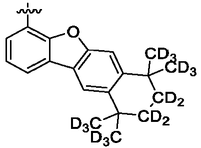 | R404 | 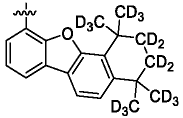 | R405 | 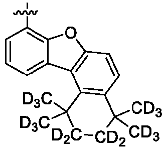 |
| R406 | 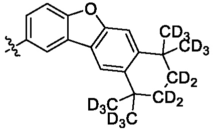 | R407 | 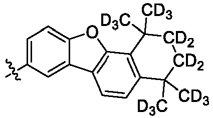 | R408 | 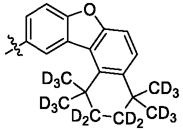 |
| R409 | 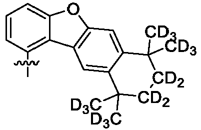 | R410 | 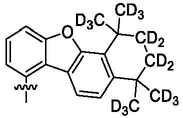 | R411 | 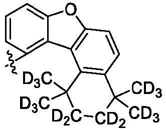 |

In some embodiments, the compound is selected from the group consisting of the structures of the following LIST 24:

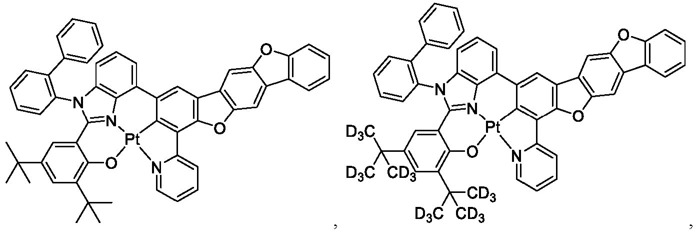

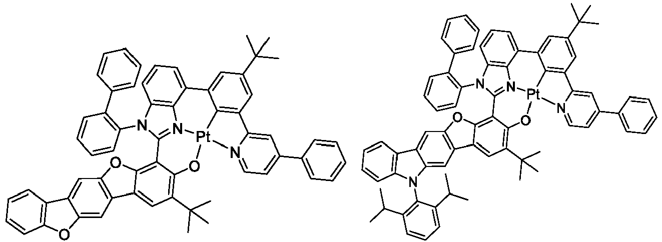

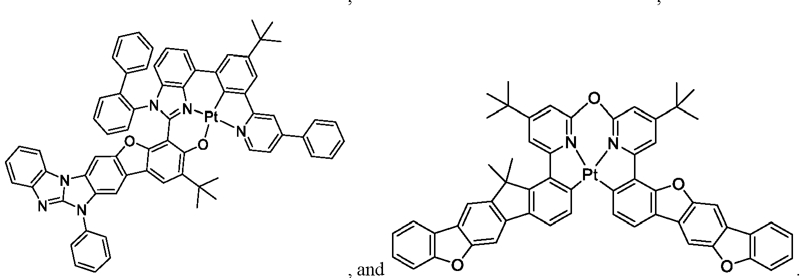

In another aspect, the present disclosure also provides a compound having a formula Ir(L_{A*})ₓ(L_{B*})_{y}(L_{C*})_{z}, wherein:
x and y are each independently 1 or 2;
z is 0 or 1 or 2;
x + y + z = 3;
L_{A*} comprises a structure of Formula V, 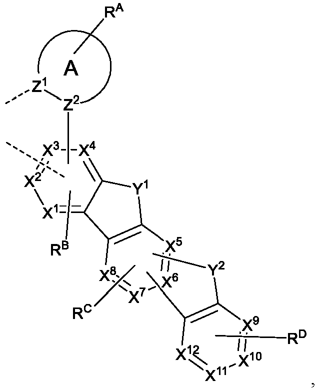
L_{B*} comprises a structure of Formula VI, 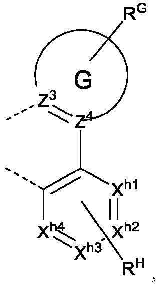
L_{C*} is a bidentate ligand;
X^{h1} - X^{h4} are each independently C or N;
Z³ and Z⁴ are each independently C or N; moiety G is a monocyclic ring or a polycyclic fused ring system, wherein the monocyclic ring or each ring of the polycyclic fused ring system is independently a 5-membered to 10-membered carbocyclic or heterocyclic ring;
each of R^{G} and R^{H} independently represents mono to the maximum allowable substitutions, or no substitutions; R, R', R^{A}, R^{B}, R^{C}, R^{D}, R^{G}, and R^{H} each are independently hydrogen or a substituent selected from the group consisting of the General Substituents defined herein;
the remaining variables are the same as previously defined;
any two substituents may be joined or fused to form a ring; and
at least one of the following conditions is true:
   (1) Y¹ and Y² are different;
   (2) at least one R^{B}, R^{C}, or R^{D} substituent comprises a substituted aromatic ring;
   (3) at least one R^{B}, R^{C}, or R^{D} substituent comprises two unfused rings;
   (4) at least one R^{B}, or one R^{C}, or two R^{D} substituents are not hydrogen;
   (5) at least one R^{B}, R^{C}, R^{D} substituent comprises a 5-membered heterocycle;
   (6) at least one R^{B}, R^{C}, R^{D} substituent comprises four or more carbon atoms;
   (7) at least one of X¹ - X¹² to X^{h1} - X^{h4} is N;
   (8) moiety A and moiety G are both 5-membered heterocycles;
   (9) moiety A and moiety G together comprise at least four ring N atoms;
   (10) at least one of Y¹ or Y² is selected from the group consisting of BR, NR, Se, CRR', SiRR', and GeRR';
   (11) R^{B}, R^{C}, and R^{D} collectively comprise at least three substituents that are not hydrogen;
   (12) each R^{B}, or each R^{C}, or each R^{D} is deuterium;
   (13) at least two R^{G} and two R^{H} substituents are not hydrogen or deuterium;
   (14) y=1, z=1, and L_{B*} and L_{C*} are not identical;
   (15) Z¹ is C, and Z² is N;
   (16) at least two R^{A}, R^{B}, R^{C}, R^{D}, R^{G}, or R^{H} substituents are joined to form a non-aromatic fused ring;
   (17) an R^{G} and an R^{H} substituent are joined to form a ring;
   (18) at least one R^{B}, R^{C}, or R^{D} substituent comprises an electron-withdrawing group;
   (19) at least two R^{B}, R^{C}, or R^{D} substituents are joined to form an aromatic fused ring;
   (20) moiety G is imidazole, and at least one R^{G} substituent comprises silyl;
   (21) at least one R^{G} or R^{H} substituent comprises a silicon atom that is not bonded directly to moiety G or moiety H;
   (21) at least one R^{G} or R^{H} substituent comprises an electron-withdrawing group;
   (22) at least one R^{G} or R^{H} substituent is a heterocyclic group;
   (23) at least two R^{G} or two R^{H} substituents are joined together to form a fully or partially unsaturated monocyclic ring or polycyclic fused ring system;
   (24) at least one R^{G} substituent and at least one R^{H} substituent are independently a secondary or tertiary alkyl group; or
   (25) moiety G is an N-heterocyclic carbene ligand (*i.e.*, Z₃ is a carbene carbon).

In some embodiments, at least one R^{B}, R^{C}, or R^{D} substituent comprises a nitrile group.

In some embodiments, Z³ is N and Z⁴ is carbon.

In some embodiments, at least two of conditions (1) - (25) are true. In some embodiments, at least three of conditions (1) - (25) are true. In some embodiments, at least four of conditions (1) - (25) are true. In some embodiments, at least five of conditions (1) - (25) are true.

In some embodiments, only or at least conditions (1) and (2) are true. In some embodiments, only or at least conditions (1) and (3) are true. In some embodiments, only or at least conditions (1) and (4) are true. In some embodiments, only or at least conditions (1), (4), and (12) are true. In some embodiments, only or at least conditions (1) and (5) are true. In some embodiments, only or at least conditions (1) and (6) are true. In some embodiments, only or at least conditions (1) and (7) are true. In some embodiments, only or at least conditions (1) and (8) are true. In some embodiments, only or at least conditions (1) and (9) are true. In some embodiments, only or at least conditions (1) and (10) are true. In some embodiments, only or at least conditions (1) and (11) are true. In some embodiments, only or at least conditions (1) and (12) are true. In some embodiments, only or at least conditions (1) and (13) are true. In some embodiments, only or at least conditions (1) and (14) are true. In some embodiments, only or at least conditions (1) and (15) are true. In some embodiments, only or at least conditions (1) and (16) are true. In some embodiments, only or at least conditions (1) and (17) are true. In some embodiments, only or at least conditions (1) and (18) are true. In some embodiments, only or at least conditions (1) and (19) are true. In some embodiments, only or at least conditions (1) and (20) are true. In some embodiments, only or at least conditions (1) and (21) are true. In some embodiments, only or at least conditions (1) and (22) are true. In some embodiments, only or at least conditions (1) and (23) are true. In some embodiments, only or at least conditions (1) and (24) are true. In some embodiments, only or at least conditions (1) and (25) are true.

In some embodiments, only or at least conditions (2) and (3) are true. In some embodiments, only or at least conditions (2) and (4) are true. In some embodiments, only or at least conditions (2) and (5) are true. In some embodiments, only or at least conditions (2) and (6) are true. In some embodiments, only or at least conditions (2) and (7) are true. In some embodiments, only or at least conditions (2) and (8) are true. In some embodiments, only or at least conditions (2) and (9) are true. In some embodiments, only or at least conditions (2) and (10) are true. In some embodiments, only or at least conditions (2) and (11) are true. In some embodiments, only or at least conditions (2) and (12) are true. In some embodiments, only or at least conditions (2) and (13) are true. In some embodiments, only or at least conditions (2) and (14) are true. In some embodiments, only or at least conditions (2) and (15) are true. In some embodiments, only or at least conditions (2) and (16) are true. In some embodiments, only or at least conditions (2) and (17) are true. In some embodiments, only or at least conditions (2) and (18) are true. In some embodiments, only or at least conditions (2) and (19) are true. In some embodiments, only or at least conditions (2) and (20) are true. In some embodiments, only or at least conditions (2) and (21) are true. In some embodiments, only or at least conditions (2) and (22) are true. In some embodiments, only or at least conditions (2) and (23) are true. In some embodiments, only or at least conditions (2) and (24) are true. In some embodiments, only or at least conditions (2) and (25) are true.

In some embodiments, only or at least conditions (3) and (4) are true. In some embodiments, only or at least conditions (3) and (5) are true. In some embodiments, only or at least conditions (3) and (6) are true. In some embodiments, only or at least conditions (3) and (7) are true. In some embodiments, only or at least conditions (3) and (8) are true. In some embodiments, only or at least conditions (3) and (9) are true. In some embodiments, only or at least conditions (3) and (10) are true. In some embodiments, only or at least conditions (3) and (11) are true. In some embodiments, only or at least conditions (3) and (12) are true. In some embodiments, only or at least conditions (3) and (13) are true. In some embodiments, only or at least conditions (3) and (14) are true. In some embodiments, only or at least conditions (3) and (15) are true. In some embodiments, only or at least conditions (3) and (16) are true. In some embodiments, only or at least conditions (3) and (17) are true. In some embodiments, only or at least conditions (3) and (18) are true. In some embodiments, only or at least conditions (3) and (19) are true. In some embodiments, only or at least conditions (3) and (20) are true. In some embodiments, only or at least conditions (3) and (21) are true. In some embodiments, only or at least conditions (3) and (22) are true. In some embodiments, only or at least conditions (3) and (23) are true. In some embodiments, only or at least conditions (3) and (24) are true. In some embodiments, only or at least conditions (3) and (25) are true.

In some embodiments, only or at least conditions (4) and (5) are true. In some embodiments, only or at least conditions (4) and (6) are true. In some embodiments, only or at least conditions (4) and (7) are true. In some embodiments, only or at least conditions (4) and (8) are true. In some embodiments, only or at least conditions (4) and (9) are true. In some embodiments, only or at least conditions (4) and (10) are true. In some embodiments, only or at least conditions (4) and (11) are true. In some embodiments, only or at least conditions (4) and (12) are true. In some embodiments, only or at least conditions (4) and (13) are true. In some embodiments, only or at least conditions (4) and (14) are true. In some embodiments, only or at least conditions (4) and (15) are true. In some embodiments, only or at least conditions (4) and (16) are true. In some embodiments, only or at least conditions (4) and (17) are true. In some embodiments, only or at least conditions (4) and (18) are true. In some embodiments, only or at least conditions (4) and (19) are true. In some embodiments, only or at least conditions (4) and (20) are true. In some embodiments, only or at least conditions (4) and (21) are true. In some embodiments, only or at least conditions (4) and (22) are true. In some embodiments, only or at least conditions (4) and (23) are true. In some embodiments, only or at least conditions (4) and (24) are true. In some embodiments, only or at least conditions (4) and (25) are true.

In some embodiments, only or at least conditions (5) and (6) are true. In some embodiments, only or at least conditions (5) and (7) are true. In some embodiments, only or at least conditions (5) and (8) are true. In some embodiments, only or at least conditions (5) and (9) are true. In some embodiments, only or at least conditions (5) and (10) are true. In some embodiments, only or at least conditions (5) and (11) are true. In some embodiments, only or at least conditions (5) and (12) are true. In some embodiments, only or at least conditions (5) and (13) are true. In some embodiments, only or at least conditions (5) and (14) are true. In some embodiments, only or at least conditions (5) and (15) are true. In some embodiments, only or at least conditions (5) and (16) are true. In some embodiments, only or at least conditions (5) and (17) are true. In some embodiments, only or at least conditions (5) and (18) are true. In some embodiments, only or at least conditions (5) and (19) are true. In some embodiments, only or at least conditions (5) and (20) are true. In some embodiments, only or at least conditions (5) and (21) are true. In some embodiments, only or at least conditions (5) and (22) are true. In some embodiments, only or at least conditions (5) and (23) are true. In some embodiments, only or at least conditions (5) and (24) are true. In some embodiments, only or at least conditions (5) and (25) are true.

In some embodiments, only or at least conditions (6) and (7) are true. In some embodiments, only or at least conditions (6) and (8) are true. In some embodiments, only or at least conditions (6) and (9) are true. In some embodiments, only or at least conditions (6) and (10) are true. In some embodiments, only or at least conditions (6) and (11) are true. In some embodiments, only or at least conditions (6) and (12) are true. In some embodiments, only or at least conditions (6) and (13) are true. In some embodiments, only or at least conditions (6) and (14) are true. In some embodiments, only or at least conditions (6) and (15) are true. In some embodiments, only or at least conditions (6) and (16) are true. In some embodiments, only or at least conditions (6) and (17) are true. In some embodiments, only or at least conditions (6) and (18) are true. In some embodiments, only or at least conditions (6) and (19) are true. In some embodiments, only or at least conditions (6) and (20) are true. In some embodiments, only or at least conditions (6) and (21) are true. In some embodiments, only or at least conditions (6) and (22) are true. In some embodiments, only or at least conditions (6) and (23) are true. In some embodiments, only or at least conditions (6) and (24) are true. In some embodiments, only or at least conditions (6) and (25) are true.

In some embodiments, only or at least conditions (7) and (8) are true. In some embodiments, only or at least conditions (7) and (9) are true. In some embodiments, only or at least conditions (7) and (10) are true. In some embodiments, only or at least conditions (7) and (11) are true. In some embodiments, only or at least conditions (7) and (12) are true. In some embodiments, only or at least conditions (7) and (13) are true. In some embodiments, only or at least conditions (7) and (14) are true. In some embodiments, only or at least conditions (7) and (15) are true. In some embodiments, only or at least conditions (7) and (16) are true. In some embodiments, only or at least conditions (7) and (17) are true. In some embodiments, only or at least conditions (7) and (18) are true. In some embodiments, only or at least conditions (7) and (19) are true. In some embodiments, only or at least conditions (7) and (20) are true. In some embodiments, only or at least conditions (7) and (21) are true. In some embodiments, only or at least conditions (7) and (22) are true. In some embodiments, only or at least conditions (7) and (23) are true. In some embodiments, only or at least conditions (7) and (24) are true. In some embodiments, only or at least conditions (7) and (25) are true.

In some embodiments, only or at least conditions (8) and (9) are true. In some embodiments, only or at least conditions (8) and (10) are true. In some embodiments, only or at least conditions (8) and (11) are true. In some embodiments, only or at least conditions (8) and (12) are true. In some embodiments, only or at least conditions (8) and (13) are true. In some embodiments, only or at least conditions (8) and (14) are true. In some embodiments, only or at least conditions (8) and (15) are true. In some embodiments, only or at least conditions (8) and (16) are true. In some embodiments, only or at least conditions (8) and (17) are true. In some embodiments, only or at least conditions (8) and (18) are true. In some embodiments, only or at least conditions (8) and (19) are true. In some embodiments, only or at least conditions (8) and (20) are true. In some embodiments, only or at least conditions (8) and (21) are true. In some embodiments, only or at least conditions (8) and (22) are true. In some embodiments, only or at least conditions (8) and (23) are true. In some embodiments, only or at least conditions (8) and (24) are true. In some embodiments, only or at least conditions (8) and (25) are true.

In some embodiments, only or at least conditions (9) and (10) are true. In some embodiments, only or at least conditions (9) and (11) are true. In some embodiments, only or at least conditions (9) and (12) are true. In some embodiments, only or at least conditions (9) and (13) are true. In some embodiments, only or at least conditions (9) and (14) are true. In some embodiments, only or at least conditions (9) and (15) are true. In some embodiments, only or at least conditions (9) and (16) are true. In some embodiments, only or at least conditions (9) and (17) are true. In some embodiments, only or at least conditions (9) and (18) are true. In some embodiments, only or at least conditions (9) and (19) are true. In some embodiments, only or at least conditions (9) and (20) are true. In some embodiments, only or at least conditions (9) and (21) are true. In some embodiments, only or at least conditions (9) and (22) are true. In some embodiments, only or at least conditions (9) and (23) are true. In some embodiments, only or at least conditions (9) and (24) are true. In some embodiments, only or at least conditions (9) and (25) are true.

In some embodiments, only or at least conditions (10) and (11) are true. In some embodiments, only or at least conditions (10) and (12) are true. In some embodiments, only or at least conditions (10) and (13) are true. In some embodiments, only or at least conditions (10) and (14) are true. In some embodiments, only or at least conditions (10) and (15) are true. In some embodiments, only or at least conditions (10) and (16) are true. In some embodiments, only or at least conditions (10) and (17) are true. In some embodiments, only or at least conditions (10) and (18) are true. In some embodiments, only or at least conditions (10) and (19) are true. In some embodiments, only or at least conditions (10) and (20) are true. In some embodiments, only or at least conditions (10) and (21) are true. In some embodiments, only or at least conditions (10) and (22) are true. In some embodiments, only or at least conditions (10) and (23) are true. In some embodiments, only or at least conditions (10) and (24) are true. In some embodiments, only or at least conditions (10) and (25) are true.

In some embodiments, only or at least conditions (11) and (12) are true. In some embodiments, only or at least conditions (11) and (13) are true. In some embodiments, only or at least conditions (11) and (14) are true. In some embodiments, only or at least conditions (11) and (15) are true. In some embodiments, only or at least conditions (11) and (16) are true. In some embodiments, only or at least conditions (11) and (17) are true. In some embodiments, only or at least conditions (11) and (18) are true. In some embodiments, only or at least conditions (11) and (19) are true. In some embodiments, only or at least conditions (11) and (20) are true. In some embodiments, only or at least conditions (11) and (21) are true. In some embodiments, only or at least conditions (11) and (22) are true. In some embodiments, only or at least conditions (11) and (23) are true. In some embodiments, only or at least conditions (11) and (24) are true. In some embodiments, only or at least conditions (11) and (25) are true.

In some embodiments, only or at least conditions (12) and (13) are true. In some embodiments, only or at least conditions (12) and (14) are true. In some embodiments, only or at least conditions (12) and (15) are true. In some embodiments, only or at least conditions (12) and (16) are true. In some embodiments, only or at least conditions (12) and (17) are true. In some embodiments, only or at least conditions (12) and (18) are true. In some embodiments, only or at least conditions (12) and (19) are true. In some embodiments, only or at least conditions (12) and (20) are true. In some embodiments, only or at least conditions (12) and (21) are true. In some embodiments, only or at least conditions (12) and (22) are true. In some embodiments, only or at least conditions (12) and (23) are true. In some embodiments, only or at least conditions (12) and (24) are true. In some embodiments, only or at least conditions (12) and (25) are true.

In some embodiments, only or at least conditions (13) and (14) are true. In some embodiments, only or at least conditions (13) and (15) are true. In some embodiments, only or at least conditions (13) and (16) are true. In some embodiments, only or at least conditions (13) and (17) are true. In some embodiments, only or at least conditions (13) and (18) are true. In some embodiments, only or at least conditions (13) and (19) are true. In some embodiments, only or at least conditions (13) and (20) are true. In some embodiments, only or at least conditions (13) and (21) are true. In some embodiments, only or at least conditions (13) and (22) are true. In some embodiments, only or at least conditions (13) and (23) are true. In some embodiments, only or at least conditions (13) and (24) are true. In some embodiments, only or at least conditions (13) and (25) are true.

In some embodiments, only or at least conditions (14) and (15) are true. In some embodiments, only or at least conditions (14) and (16) are true. In some embodiments, only or at least conditions (14) and (17) are true. In some embodiments, only or at least conditions (14) and (18) are true. In some embodiments, only or at least conditions (14) and (19) are true. In some embodiments, only or at least conditions (14) and (20) are true. In some embodiments, only or at least conditions (14) and (21) are true. In some embodiments, only or at least conditions (14) and (22) are true. In some embodiments, only or at least conditions (14) and (23) are true. In some embodiments, only or at least conditions (14) and (24) are true. In some embodiments, only or at least conditions (14) and (25) are true.

In some embodiments, only or at least conditions (15) and (16) are true. In some embodiments, only or at least conditions (15) and (17) are true. In some embodiments, only or at least conditions (15) and (18) are true. In some embodiments, only or at least conditions (15) and (19) are true. In some embodiments, only or at least conditions (15) and (20) are true. In some embodiments, only or at least conditions (15) and (21) are true. In some embodiments, only or at least conditions (15) and (22) are true. In some embodiments, only or at least conditions (15) and (23) are true. In some embodiments, only or at least conditions (15) and (24) are true. In some embodiments, only or at least conditions (15) and (25) are true.

In some embodiments, only or at least conditions (16) and (17) are true. In some embodiments, only or at least conditions (16) and (18) are true. In some embodiments, only or at least conditions (16) and (19) are true. In some embodiments, only or at least conditions (17) and (18) are true. In some embodiments, only or at least conditions (17) and (19) are true. In some embodiments, only or at least conditions (18) and (19) are true. In some embodiments, only or at least conditions (16) and (20) are true. In some embodiments, only or at least conditions (16) and (21) are true. In some embodiments, only or at least conditions (16) and (22) are true. In some embodiments, only or at least conditions (16) and (23) are true. In some embodiments, only or at least conditions (16) and (24) are true. In some embodiments, only or at least conditions (16) and (25) are true.

In some embodiments, only or at least conditions (17) and (18) are true. In some embodiments, only or at least conditions (17) and (19) are true. In some embodiments, only or at least conditions (17) and (20) are true. In some embodiments, only or at least conditions (17) and (21) are true. In some embodiments, only or at least conditions (17) and (22) are true. In some embodiments, only or at least conditions (17) and (23) are true. In some embodiments, only or at least conditions (17) and (24) are true. In some embodiments, only or at least conditions (17) and (25) are true.

In some embodiments, only or at least conditions (18) and (19) are true. In some embodiments, only or at least conditions (18) and (20) are true. In some embodiments, only or at least conditions (18) and (21) are true. In some embodiments, only or at least conditions (18) and (22) are true. In some embodiments, only or at least conditions (18) and (23) are true. In some embodiments, only or at least conditions (18) and (24) are true. In some embodiments, only or at least conditions (18) and (25) are true.

In some embodiments, only or at least conditions (19) and (20) are true. In some embodiments, only or at least conditions (19) and (21) are true. In some embodiments, only or at least conditions (19) and (22) are true. In some embodiments, only or at least conditions (19) and (23) are true. In some embodiments, only or at least conditions (19) and (24) are true. In some embodiments, only or at least conditions (19) and (25) are true.

In some embodiments, only or at least conditions (20) and (21) are true. In some embodiments, only or at least conditions (20)) and (22) are true. In some embodiments, only or at least conditions (20) and (23) are true. In some embodiments, only or at least conditions (20) and (24) are true. In some embodiments, only or at least conditions (20) and (25) are true.

In some embodiments, only or at least conditions (21) and (22) are true. In some embodiments, only or at least conditions (21) and (23) are true. In some embodiments, only or at least conditions (21) and (24) are true. In some embodiments, only or at least conditions (21)) and (25) are true.

In some embodiments, only or at least conditions (22) and (23) are true. In some embodiments, only or at least conditions (22) and (24) are true. In some embodiments, only or at least conditions (22) and (25) are true.

In some embodiments, only or at least conditions (23) and (24) are true. In some embodiments, only or at least conditions (23) and (25) are true. In some embodiments, only or at least conditions (24) and (25) are true.

In some embodiments, only or at least conditions (1), (2), and (3) are true. In some embodiments, only or at least conditions (1), (2), and (4) are true. In some embodiments, only or at least conditions (1), (2), (3), (4), (5), (6), and (10) are true. In some embodiments, only or at least conditions (1), (2), (3), (4), (5), (6), (10), and (18) are true. In some embodiments, only or at least conditions (1), (2), (3), (4), (5), (6), (7), (10), (13), and (18) are true. In some embodiments, only or at least conditions (1), (4), (6), (7), (9), (10), (11), (12), and (13) are true. In some embodiments, only or at least conditions (1), (2), (4), (6), (9), (10), (11), (13), and (16) are true. In some embodiments, only or at least conditions (1), (4), (7), (11), (12), (13), and (18) are true. In some embodiments, only or at least conditions (1), (2), (4), (5), (6), (7), (10), (11), (13), (16), and (18) are true.

In some embodiments, L_{A*} may be a structure selected from LIST 4 as defined herein. In such embodiments, all the embodiments applicable to a structure of LIST 4 can be equally applicable to L_{A*} as long as the required conditions for L_{A*} are satisfied.

In some embodiments, L_{A*} may be a structure selected from LIST 5 as defined herein. In such embodiments, all the embodiments applicable to a structure of LIST 4 can be equally applicable to L_{A*} as long as the required conditions for L_{A*} are satisfied.

It should be understood that Formula V also encompasses the following structure: 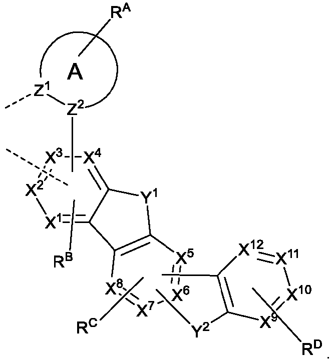 As a result, all the above embodiments are equally applicable to this structure.

In some embodiments, L_{B*} may be selected from the group consisting of the following structures: 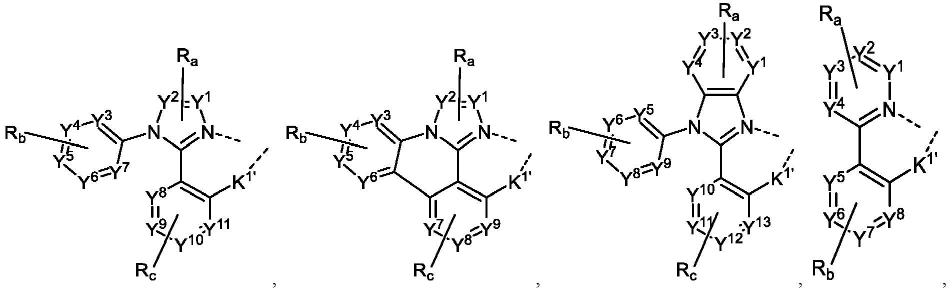 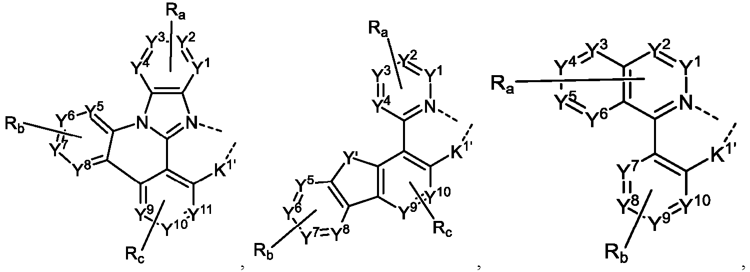 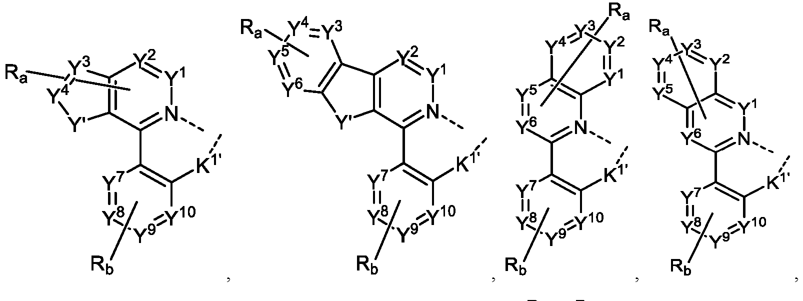 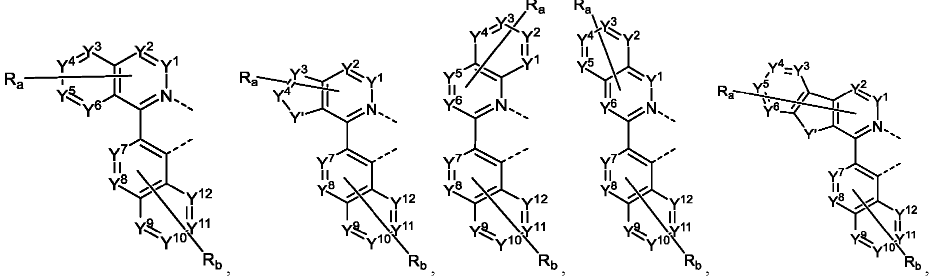 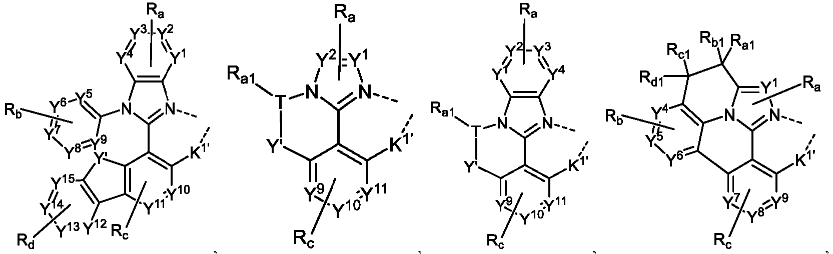 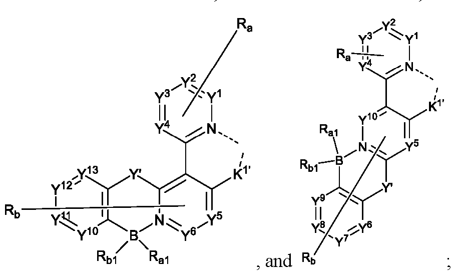 wherein:
all the varaibles are the same as previously defined; and
any two substituents can be fused or joined to form a ring or form a multidentate ligand.

In some embodiments, ligand L_{B*} be selected from the group consisting of the following structures: 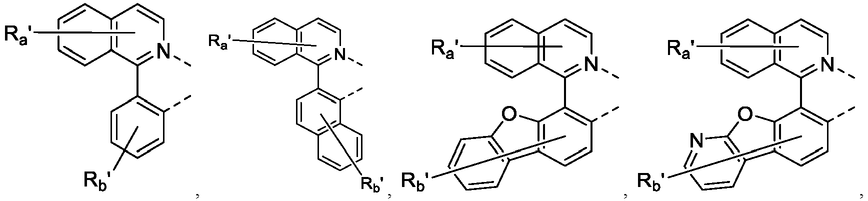 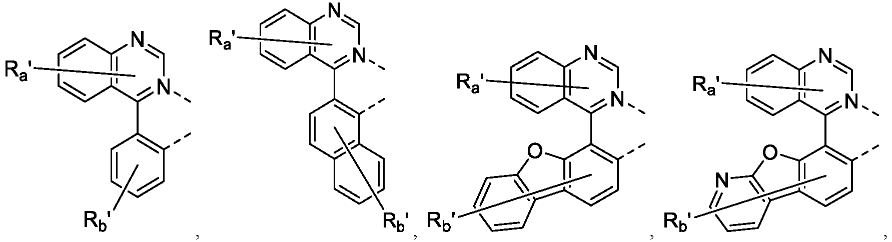 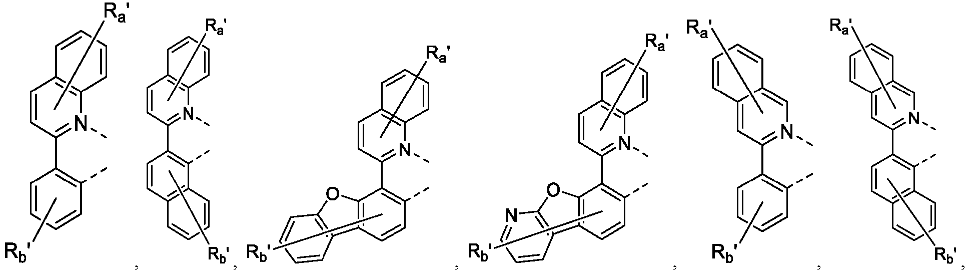 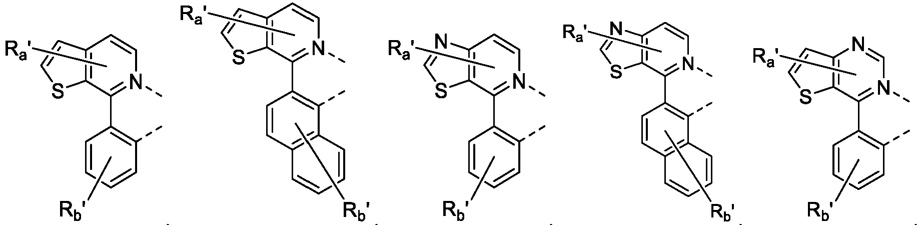 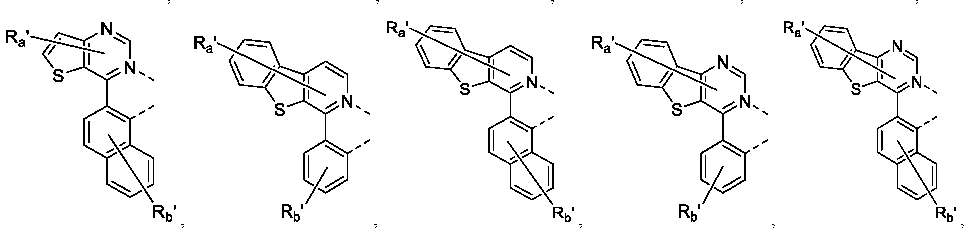 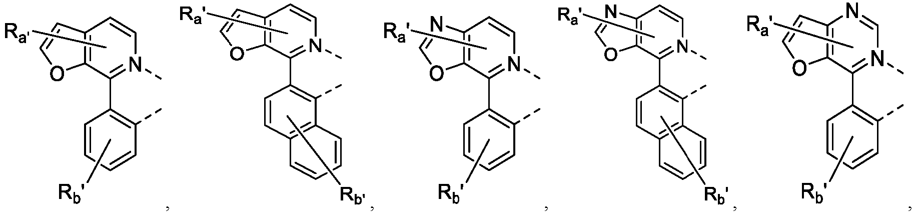 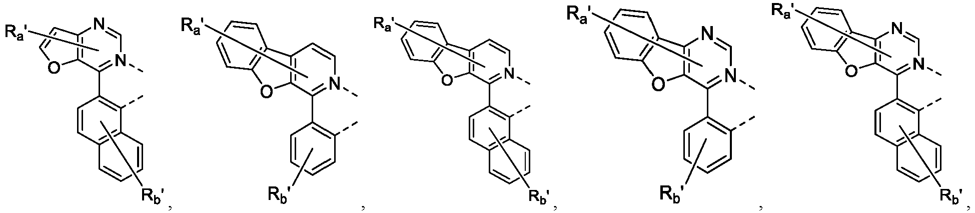 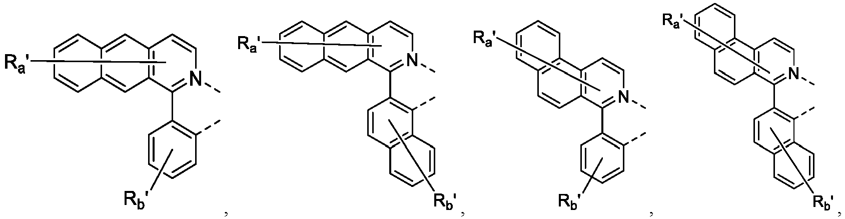 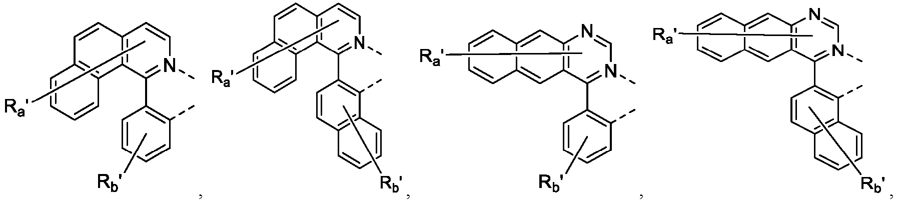 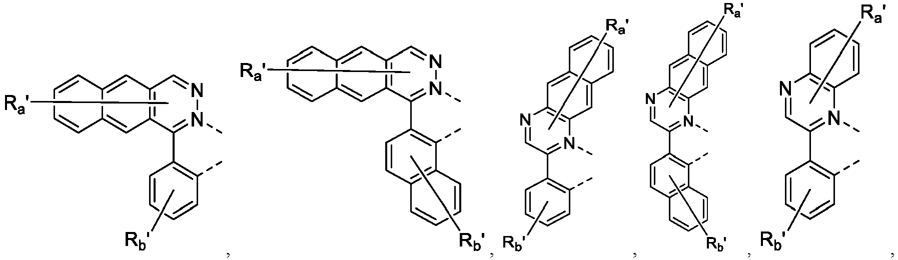 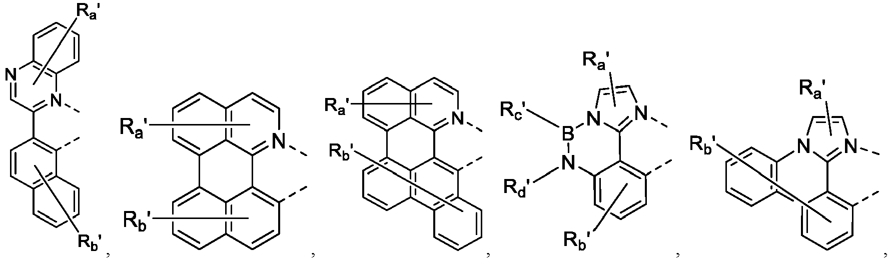 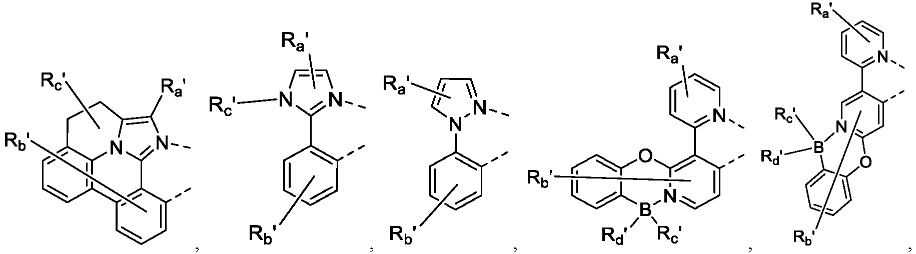 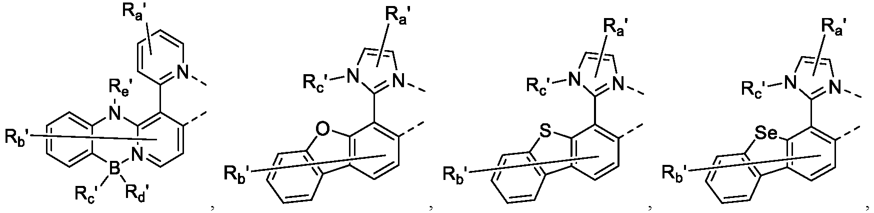 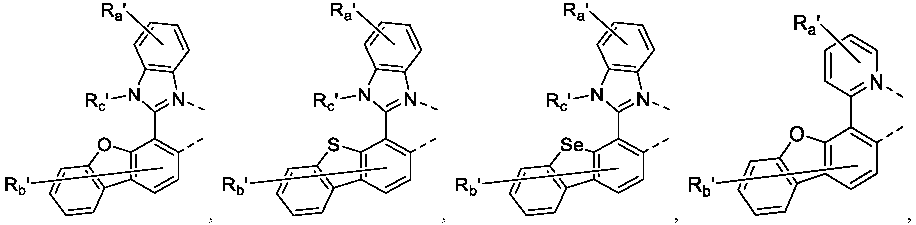 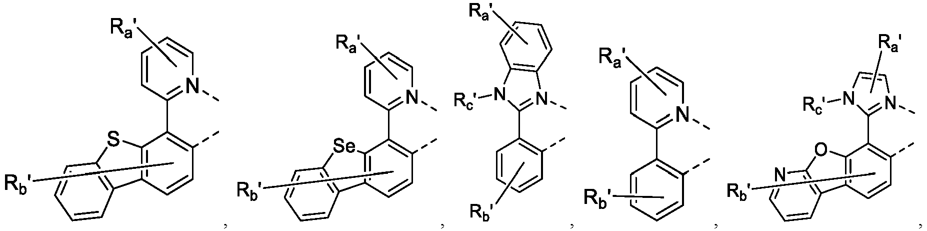 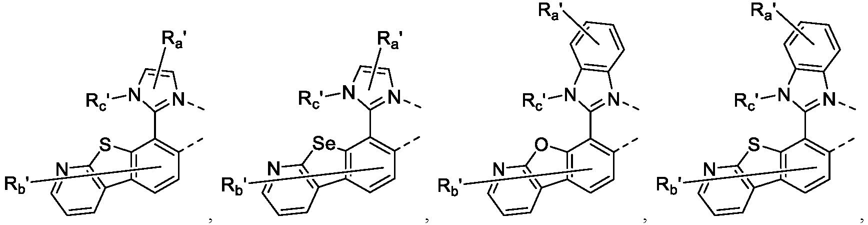 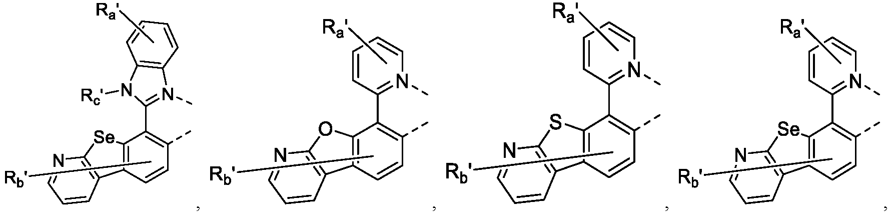 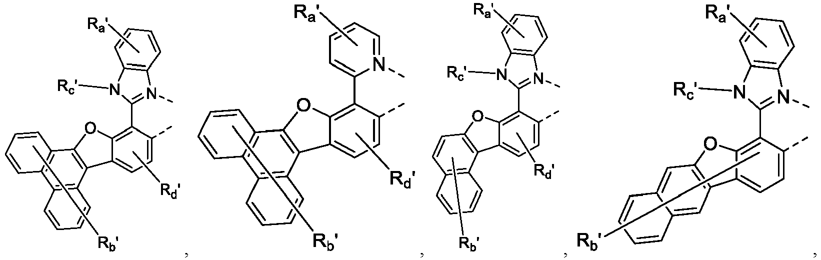 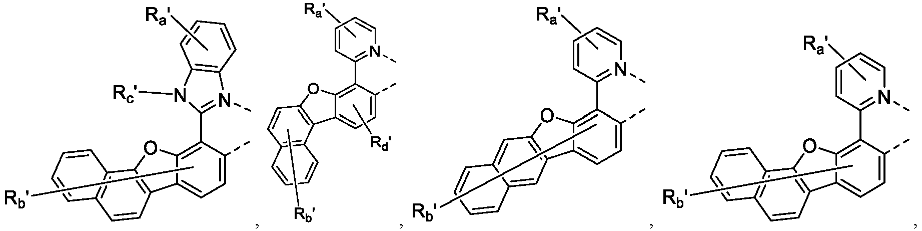 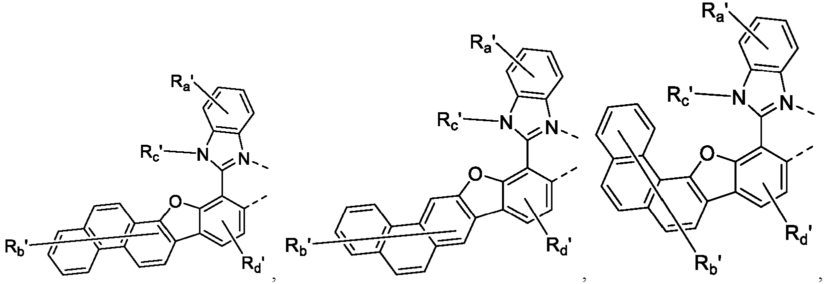 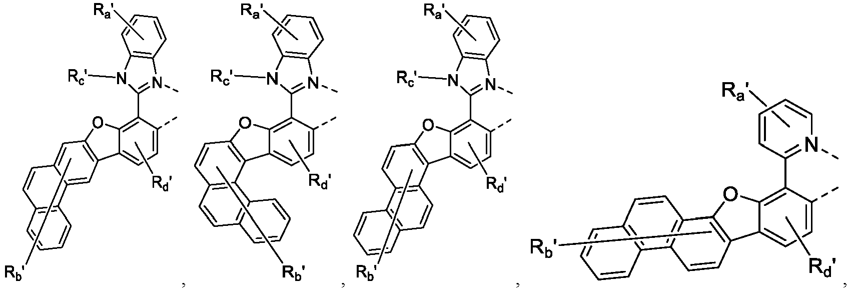 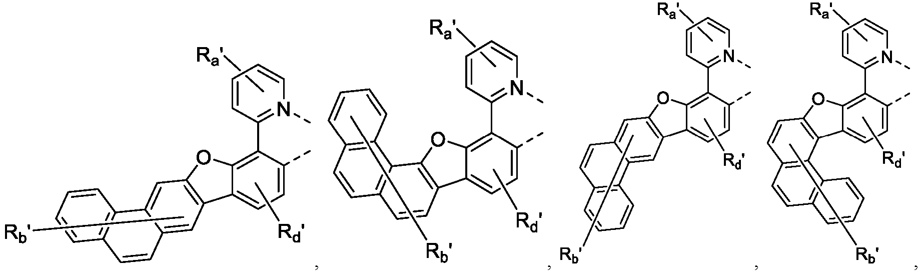 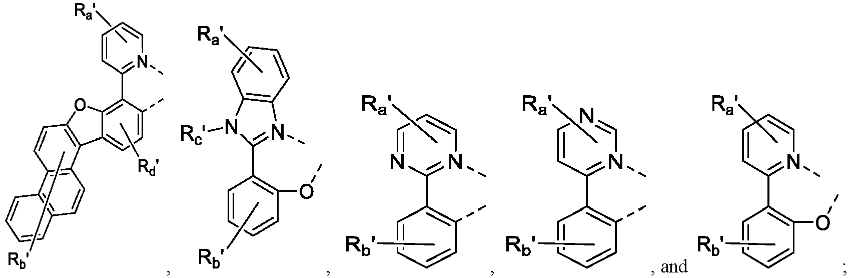 wherein:
all the varaibles are the same as previously defined; and
   any two substituents can be fused or joined to form a ring or form a multidentate ligand.

In some embodiments, L_{B*} may be a structure selected from L_{B1} to L_{B522} and from L_{B531} to L_{B543} of LIST 13 as defined herein.

In some embodiments, L_{C*} may be a structure selected from LIST 11 as defined herein. In such embodiments, all the embodiments applicable to a structure of LIST 11 can be equally applicable to L_{C*}.

In some embodiments, L_{C*} may be a structure selected from LIST 12 as defined herein. In such embodiments, all the embodiments applicable to a structure of LIST 12 can be equally applicable to L_{C*}.

In some embodiments, L_{C*} may be a structure selected from LIST 13 as defined herein.

In some embodiments, L_{C*} may be a structure of L_{C*j*-I} or L_{C*j*-II}, wherein each L_{C*j*-I} has a structure based on formula 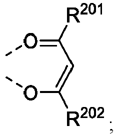 and
each L_{C*j*-II} has a structure based on formula 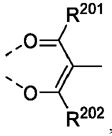 , wherein R²⁰¹ and R²⁰² are each independently defined in LIST 14 defined herein.

In some embodiments, the compound is selected from the group consisting of the structures of the following LIST 25:

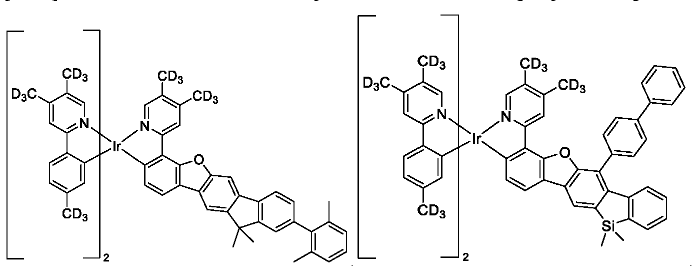

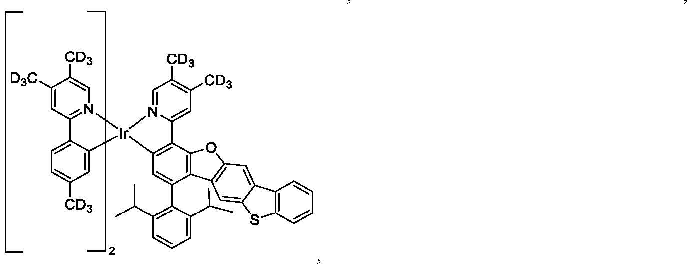

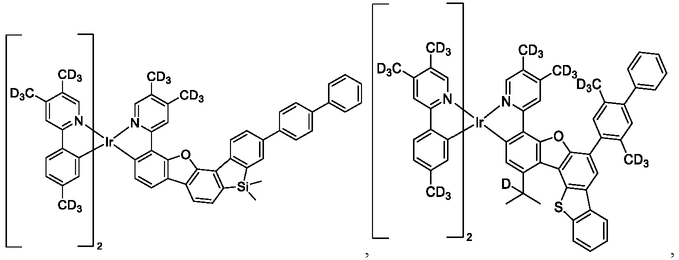

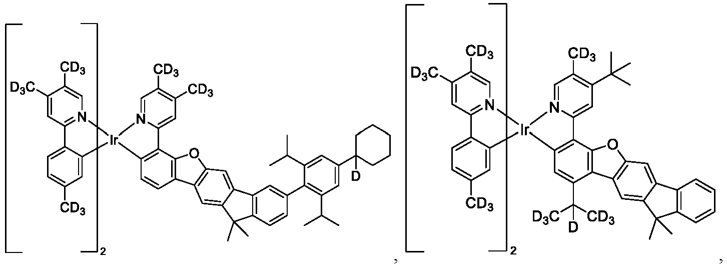

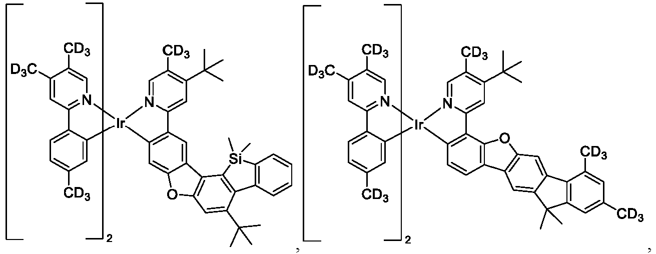

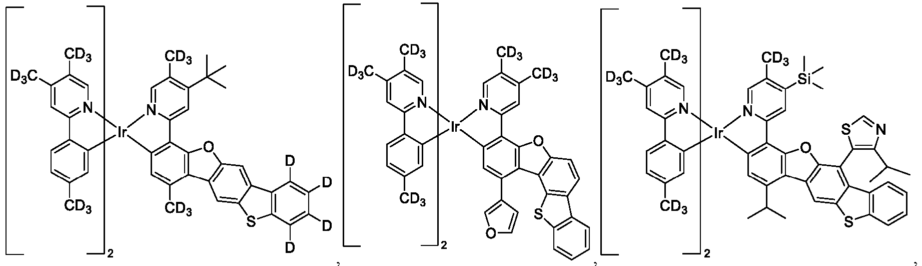

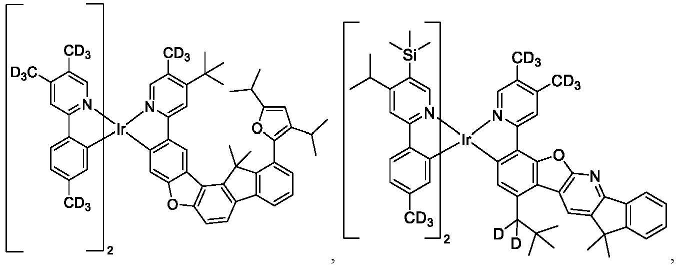

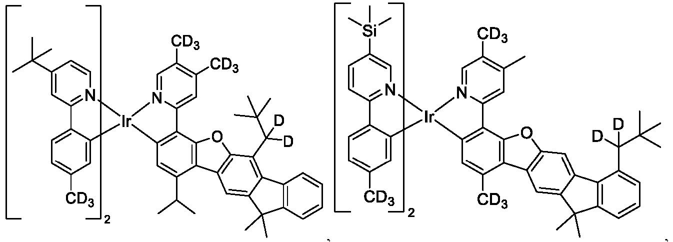

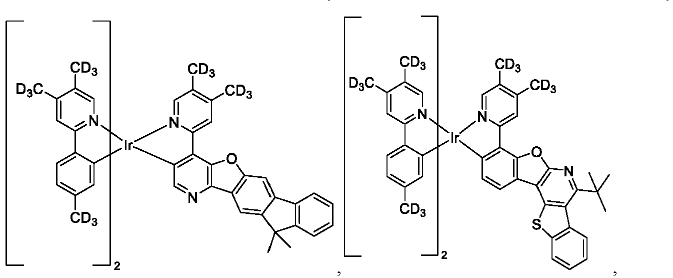

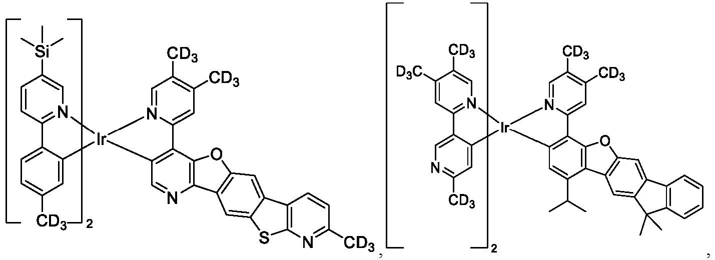

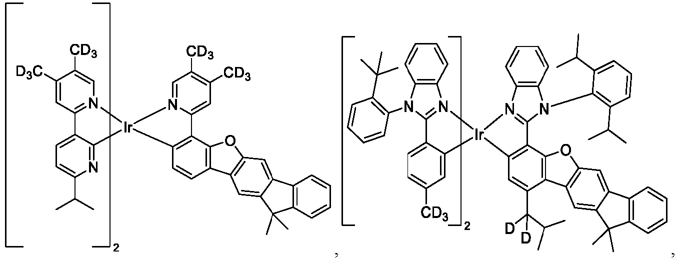

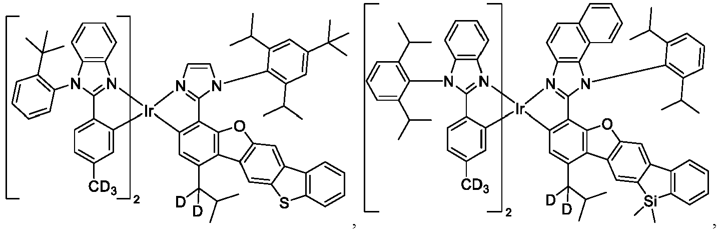

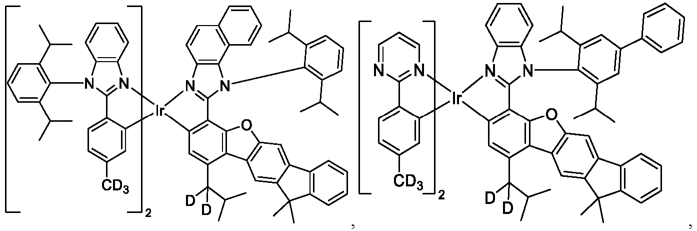

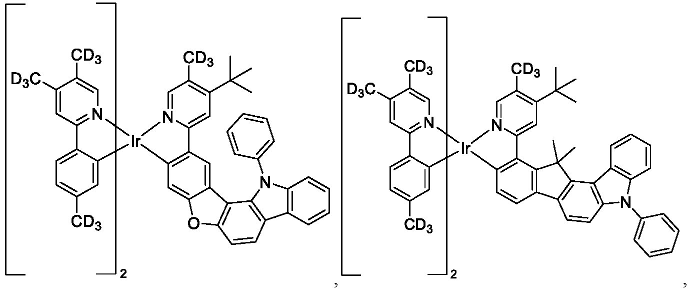

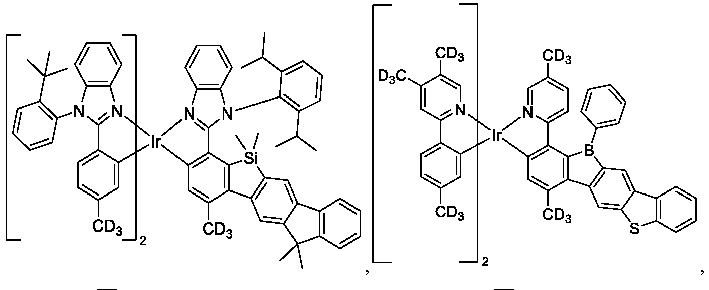

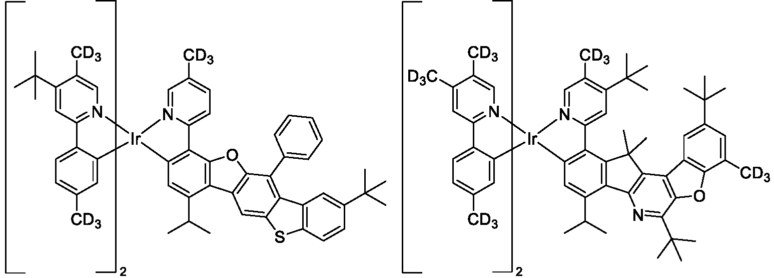

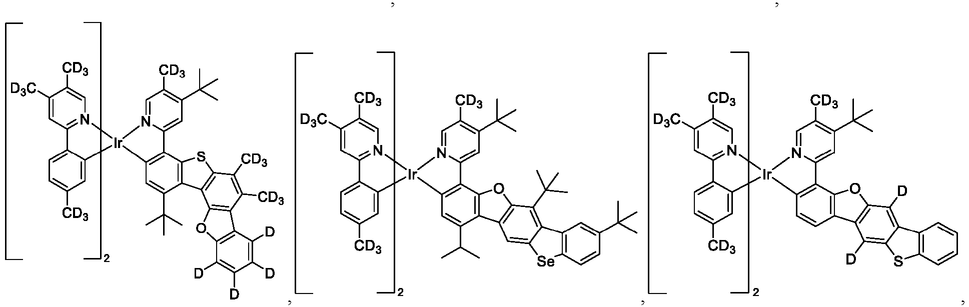

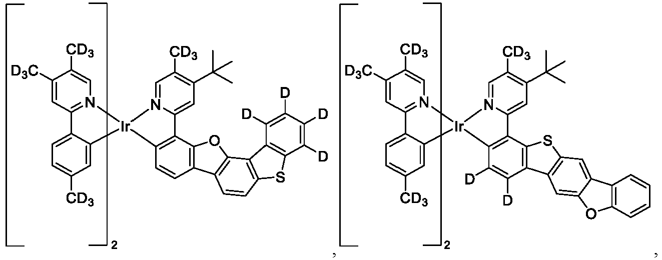

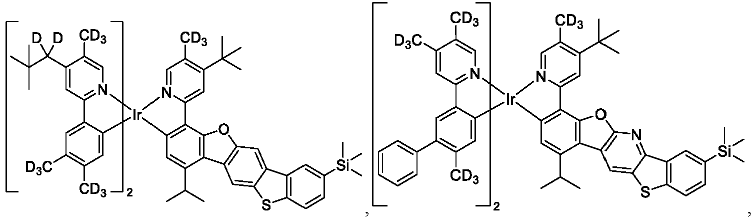

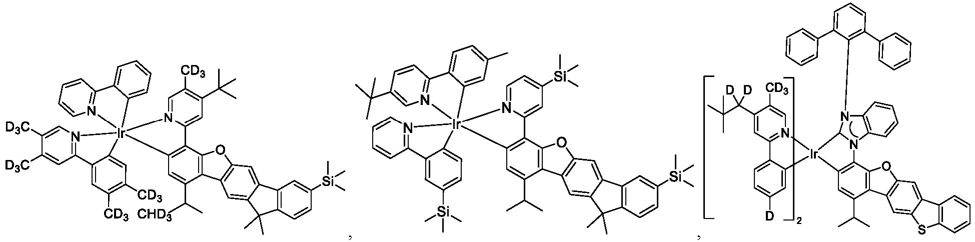

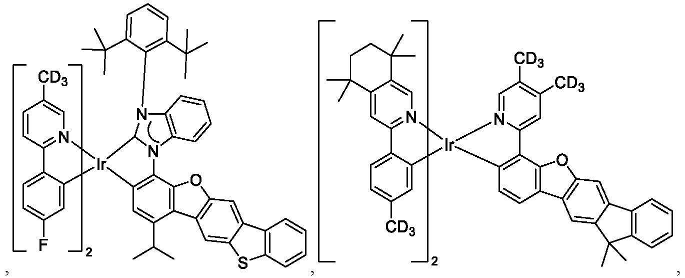

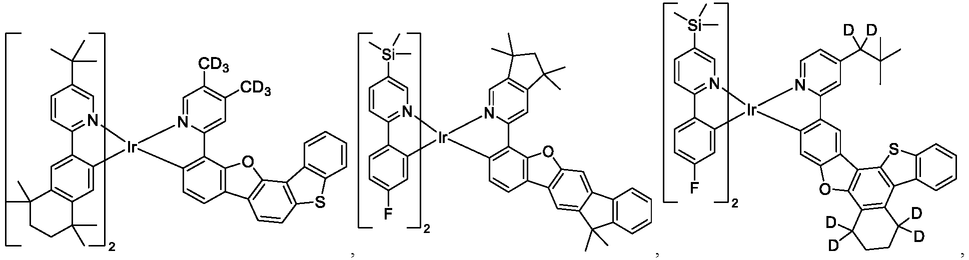

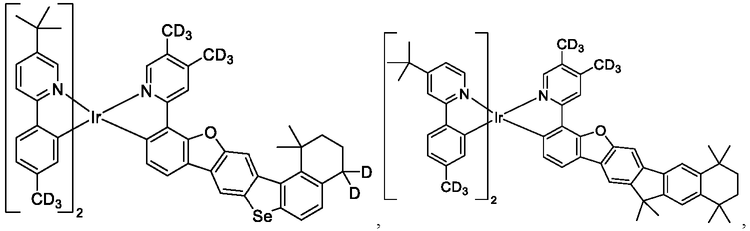

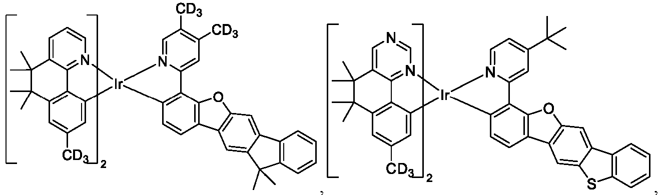

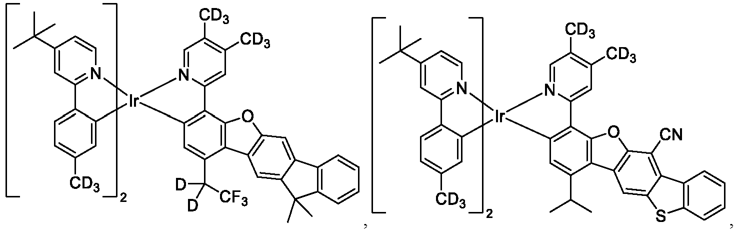

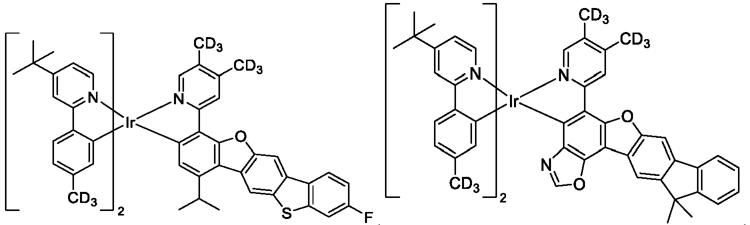

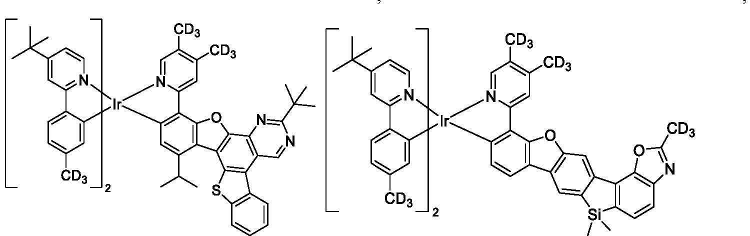

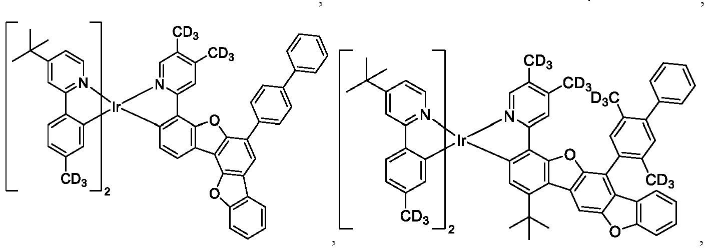

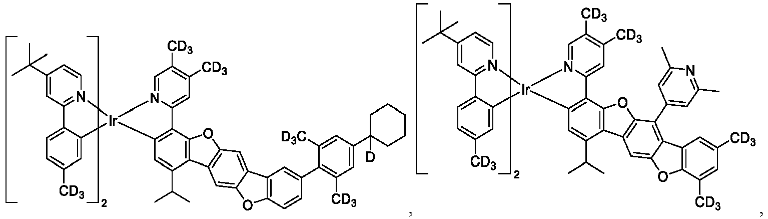

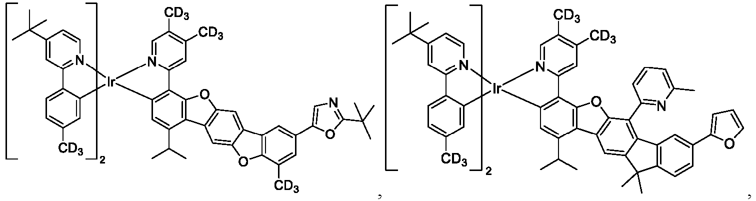

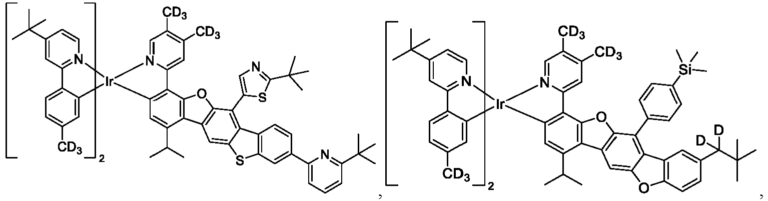

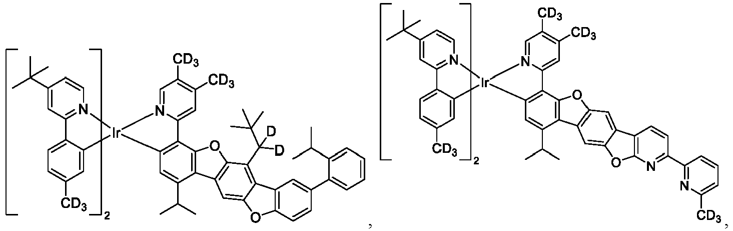

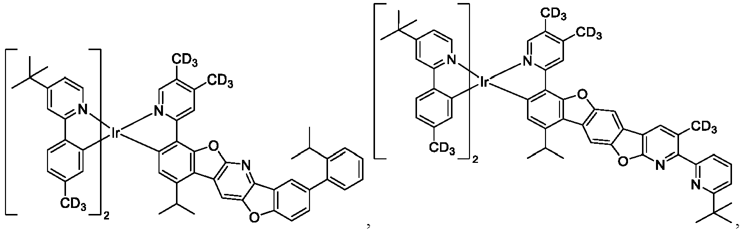

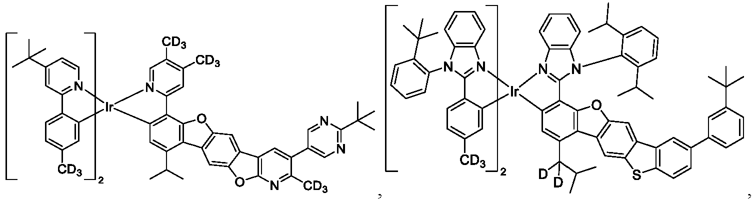

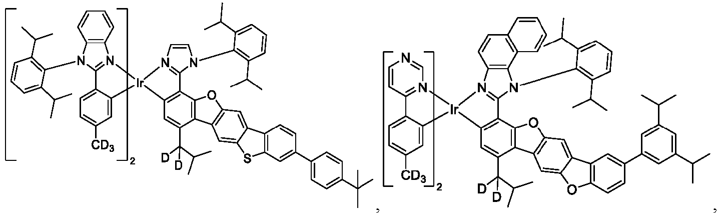

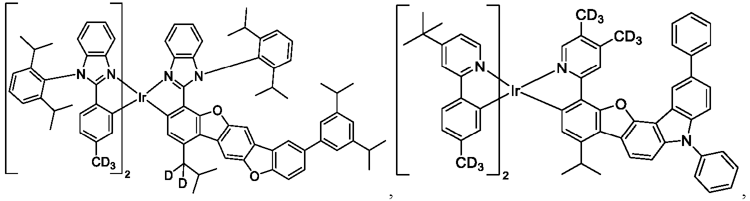

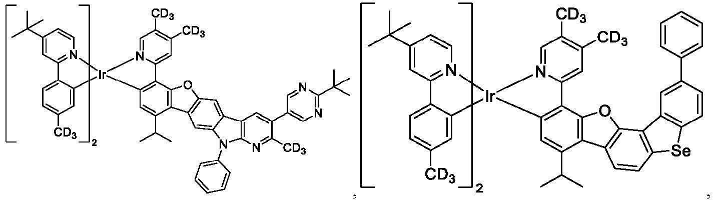

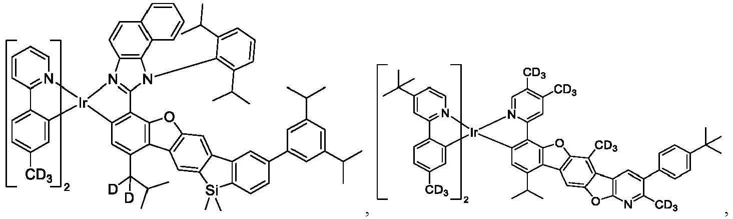

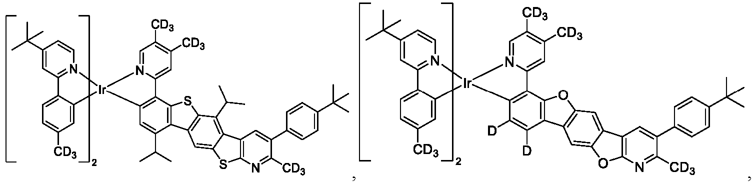

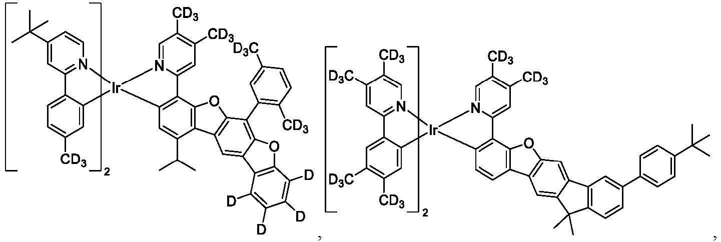

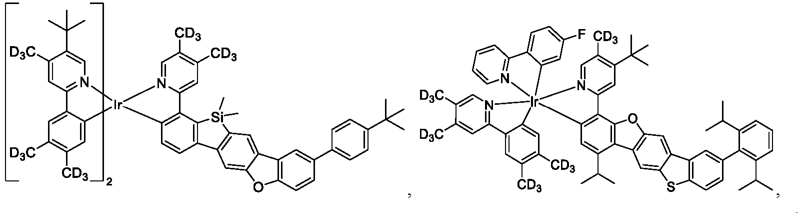

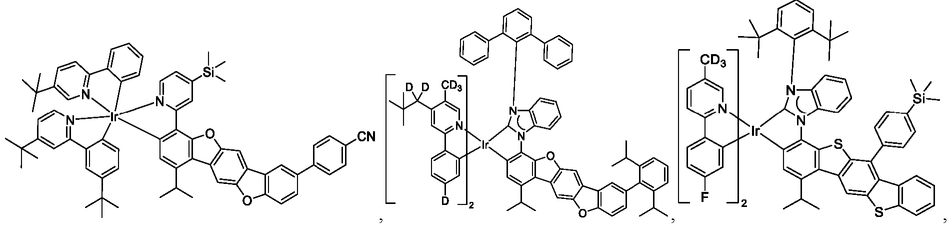

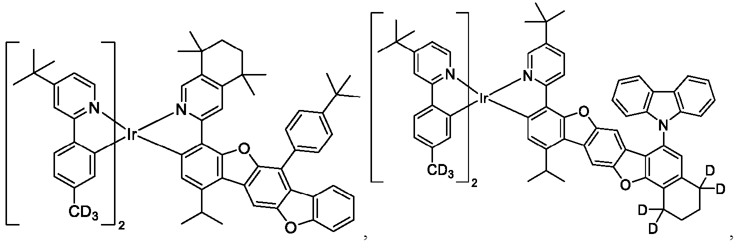

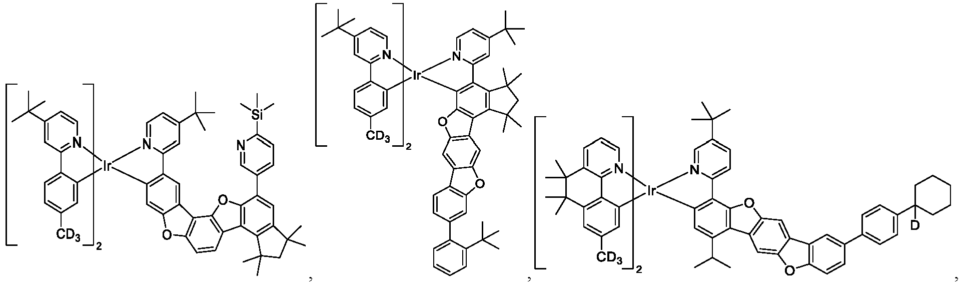

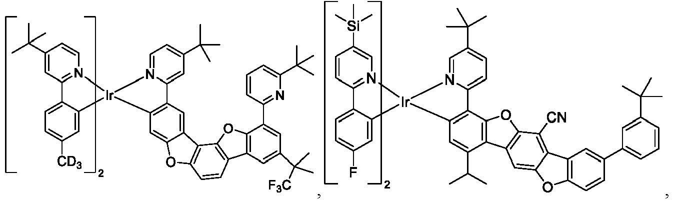

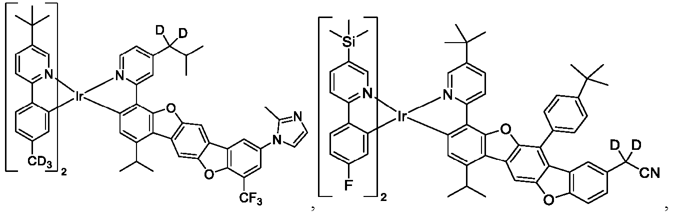

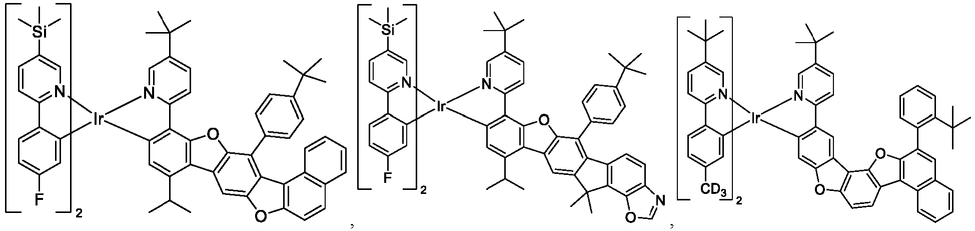

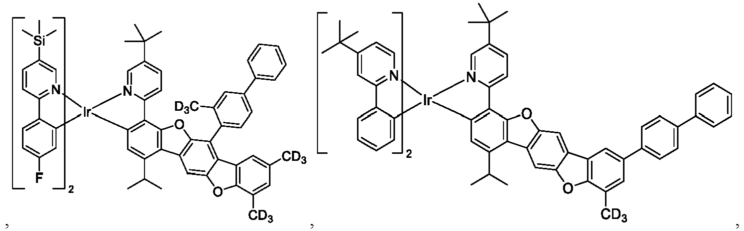

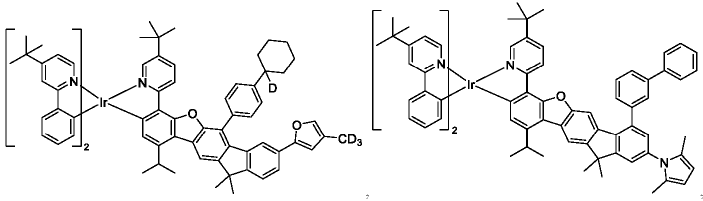

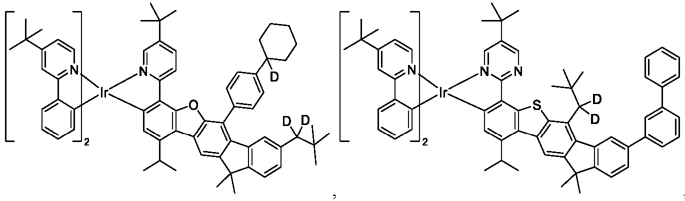

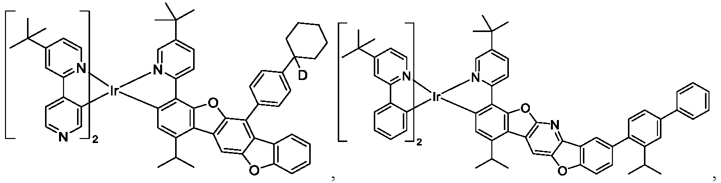

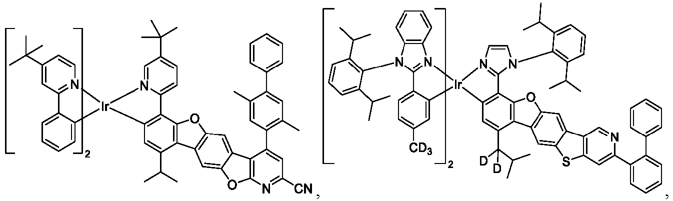

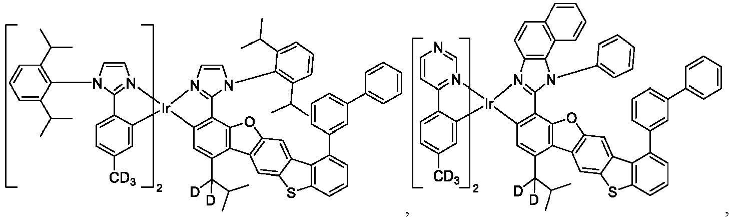

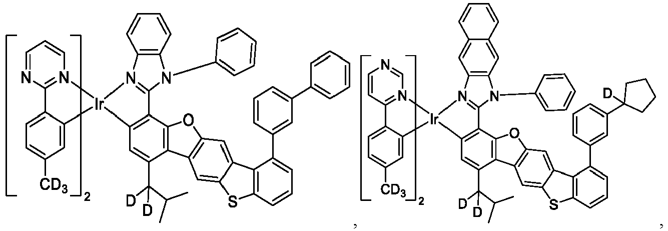

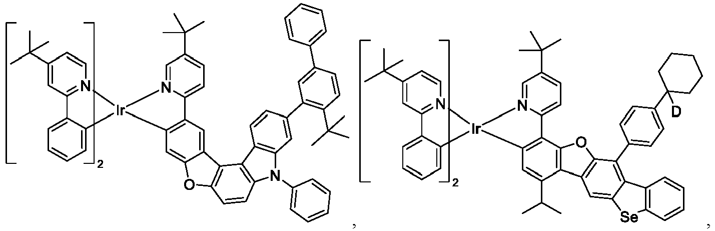

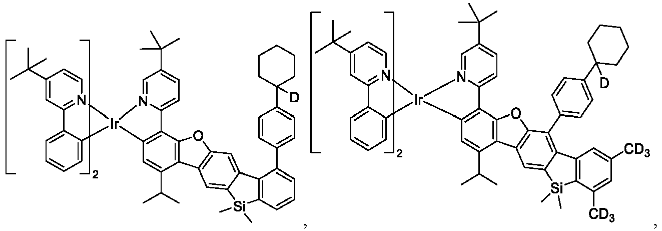

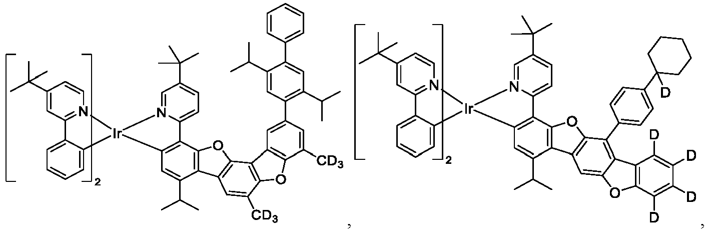

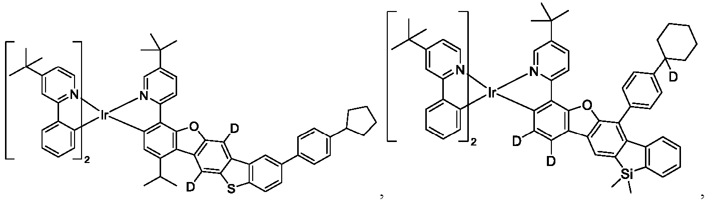

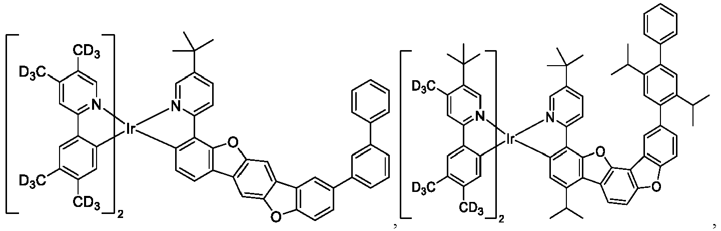

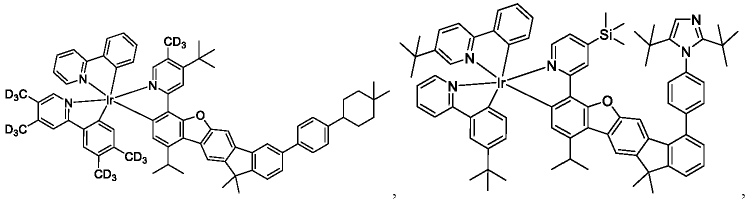

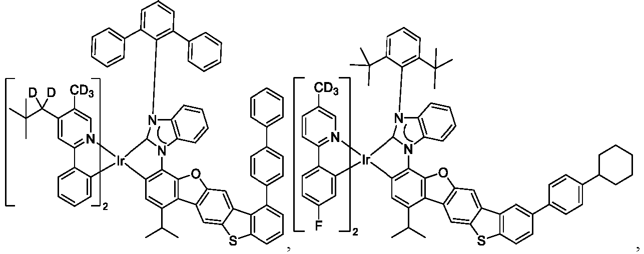

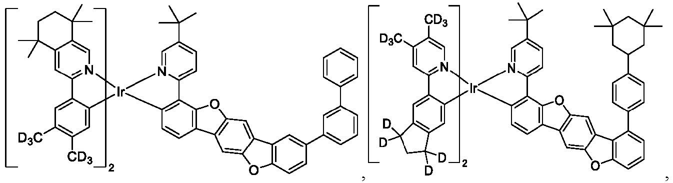

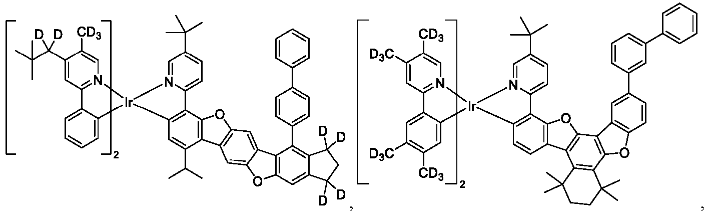

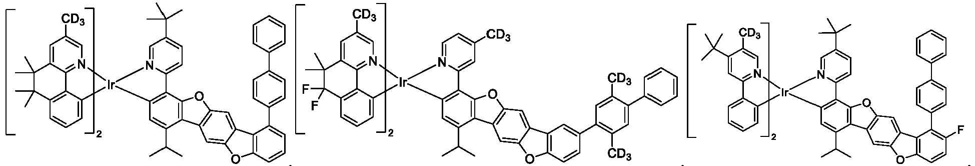

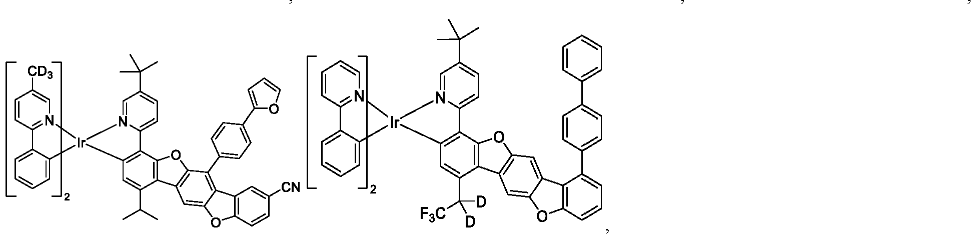

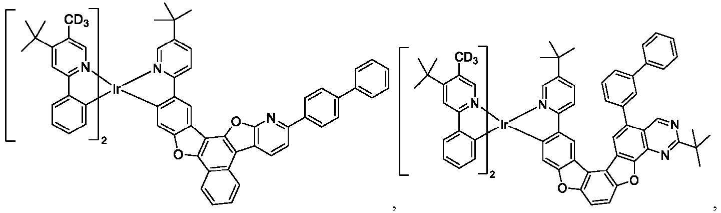

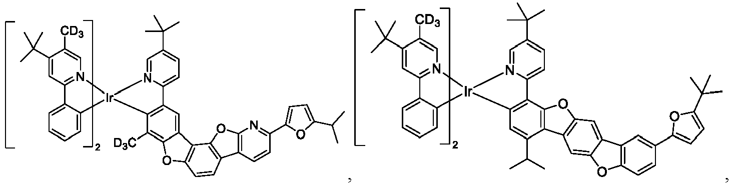

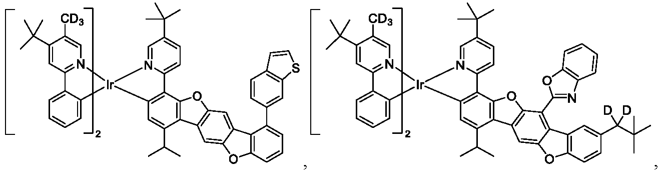

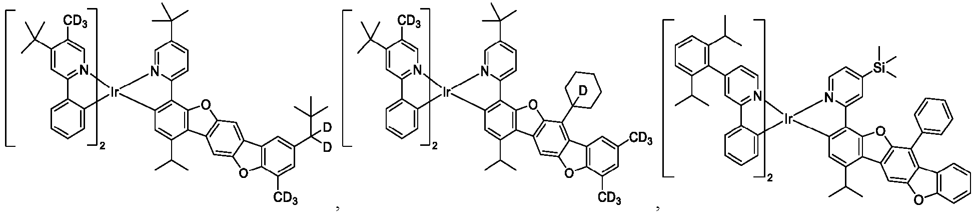

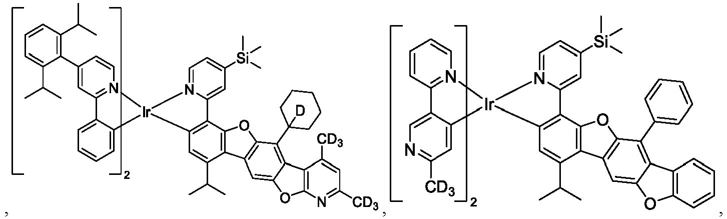

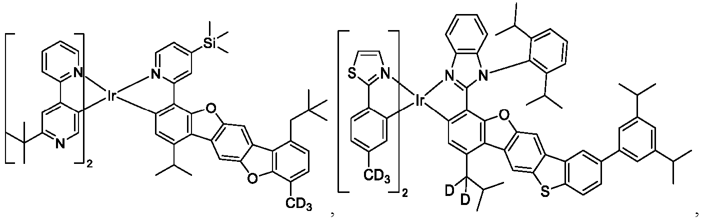

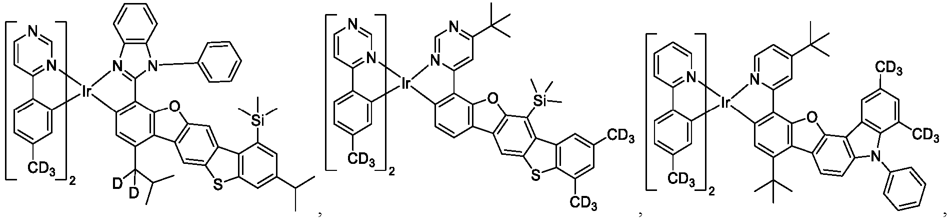

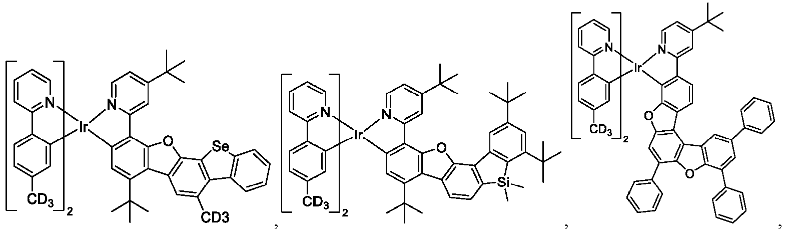

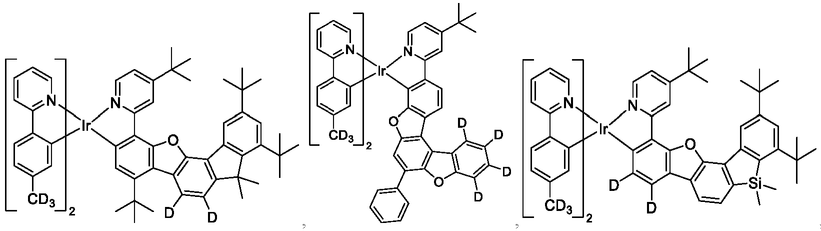

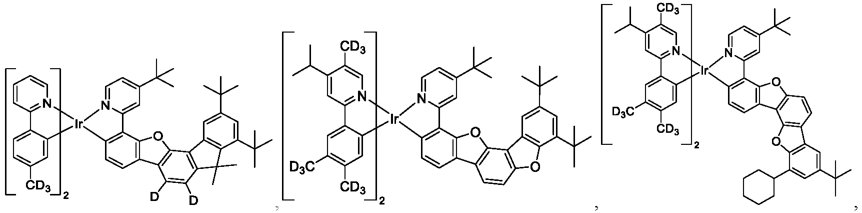

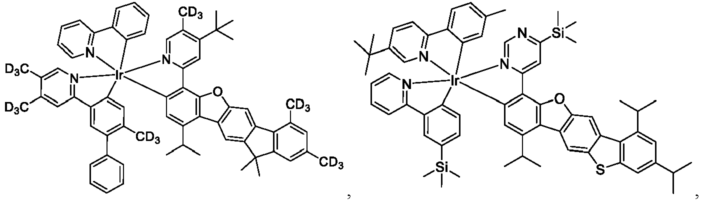

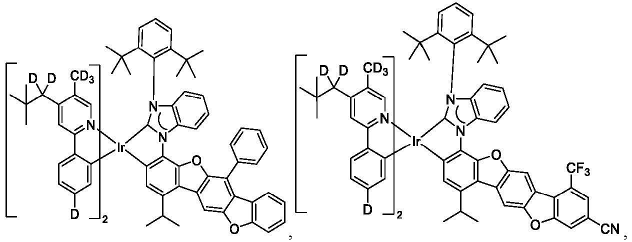

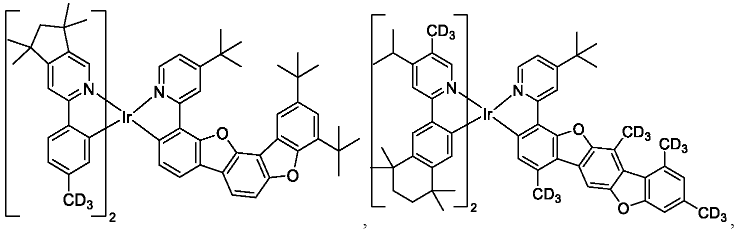

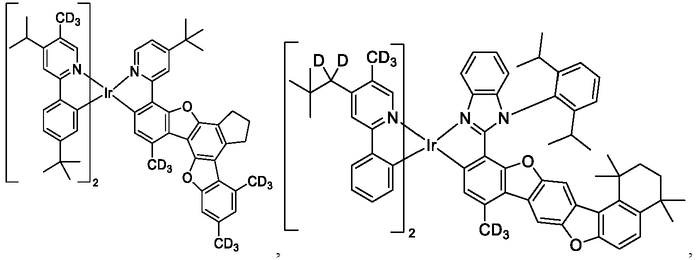

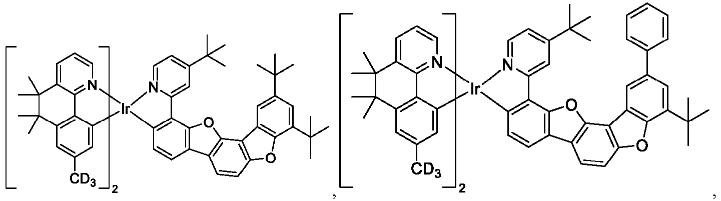

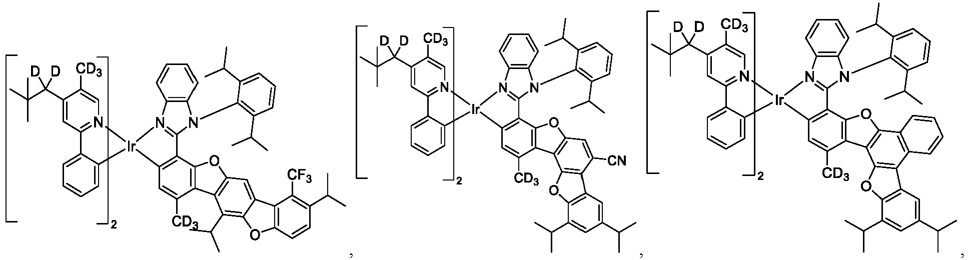

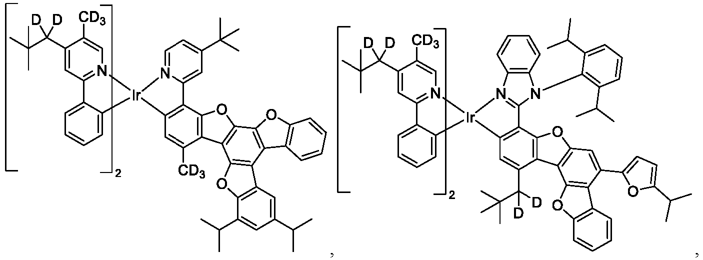

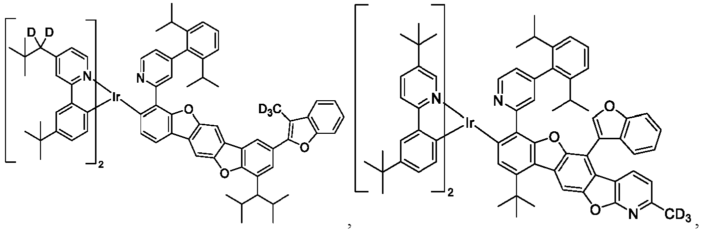

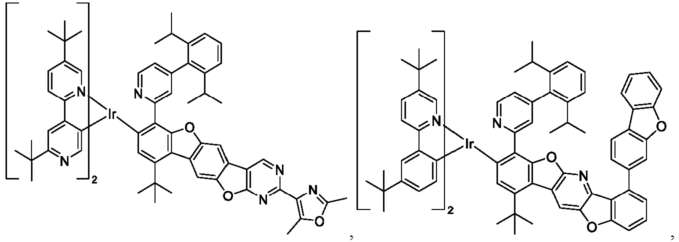

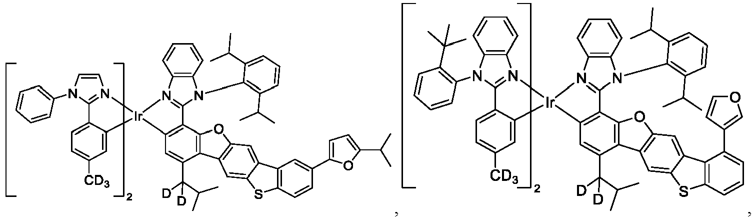

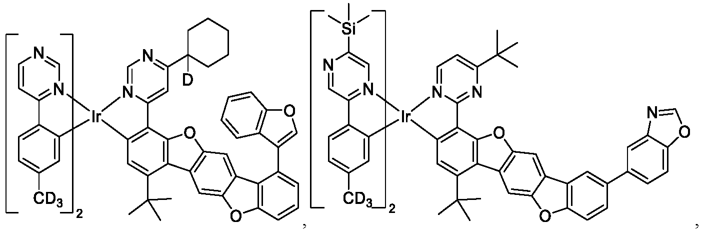

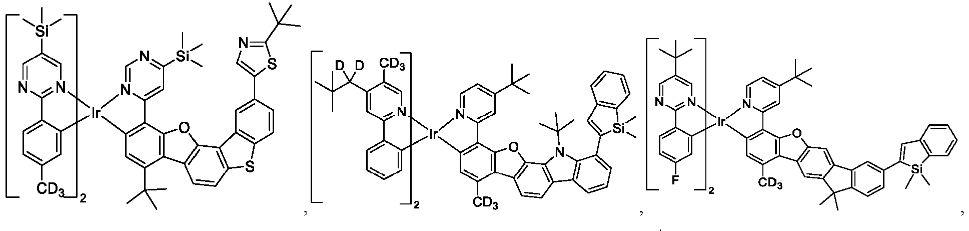

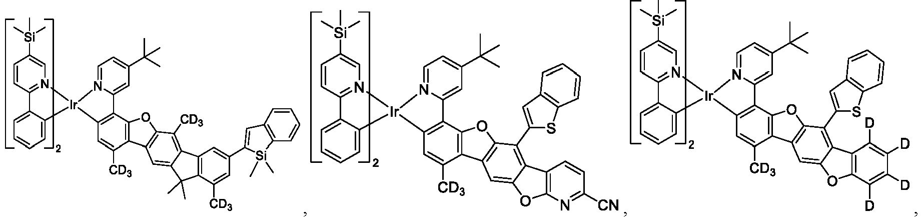

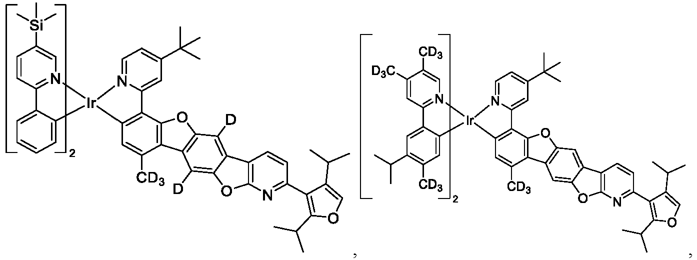

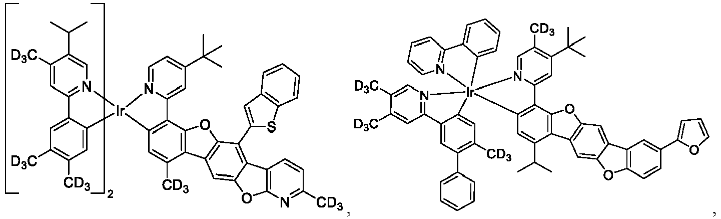

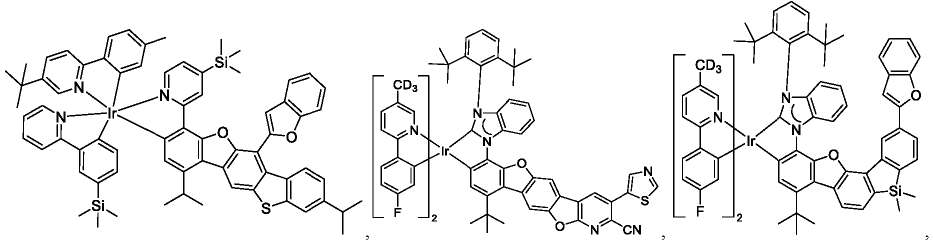

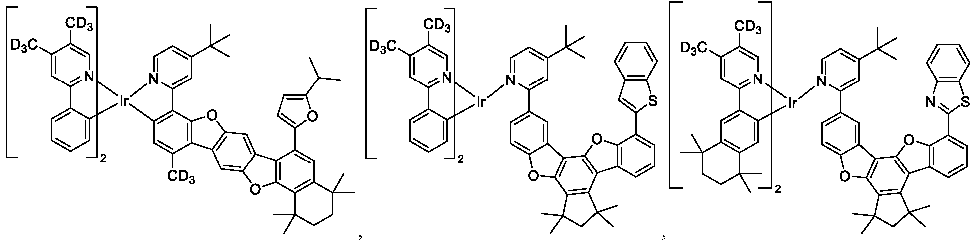

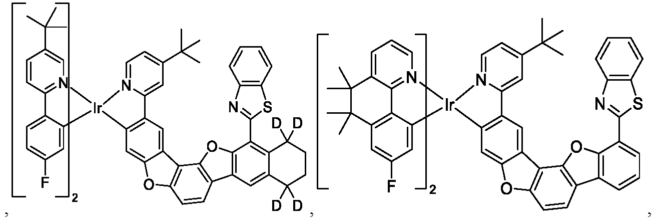

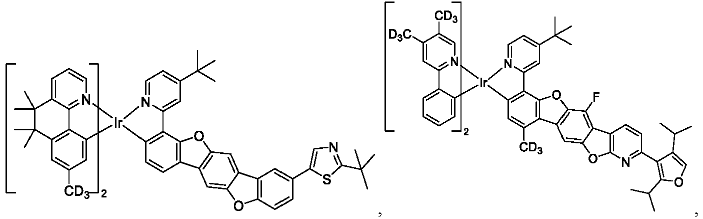

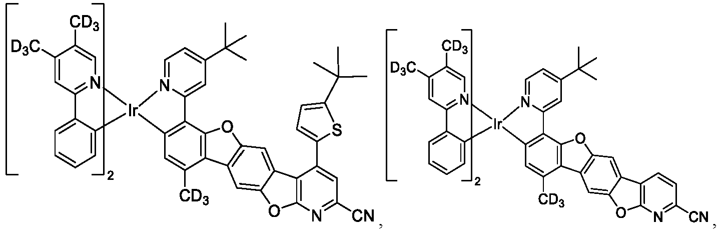

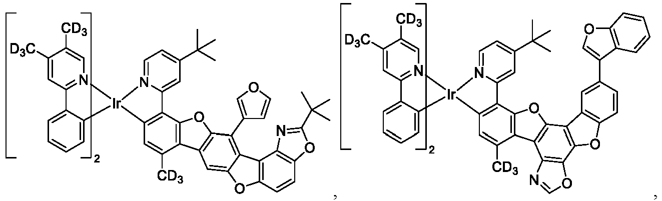

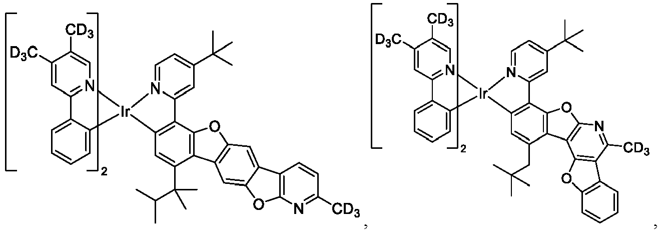

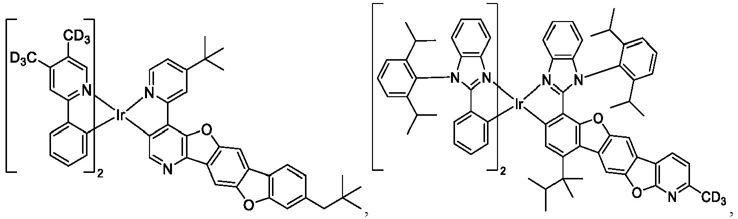

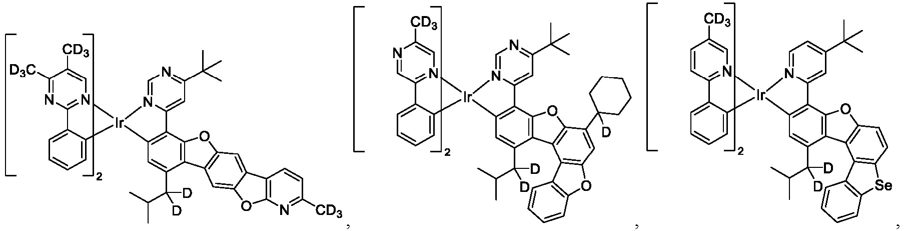

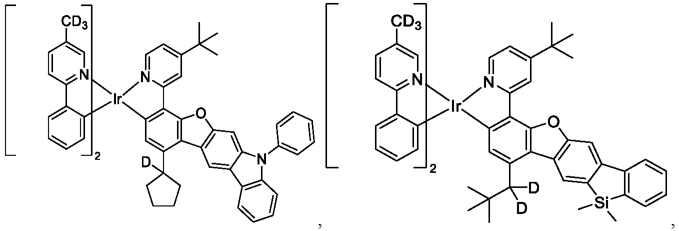

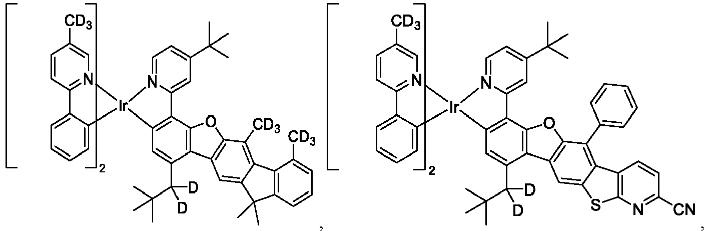

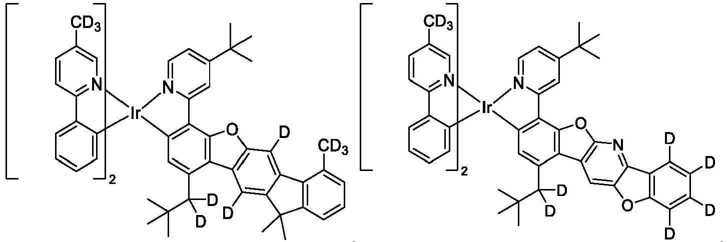

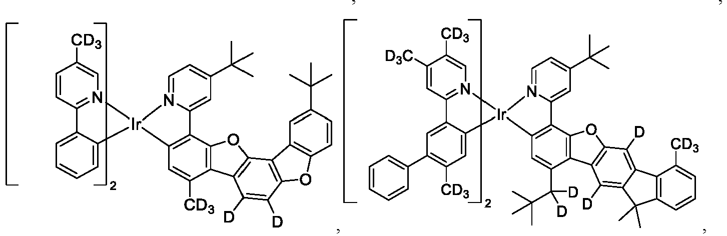

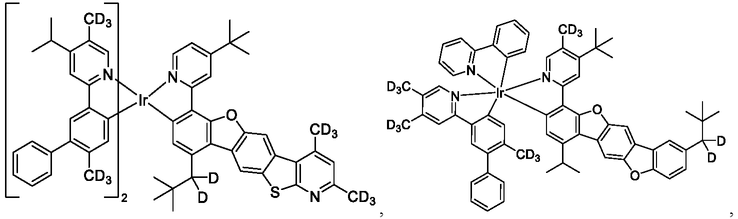

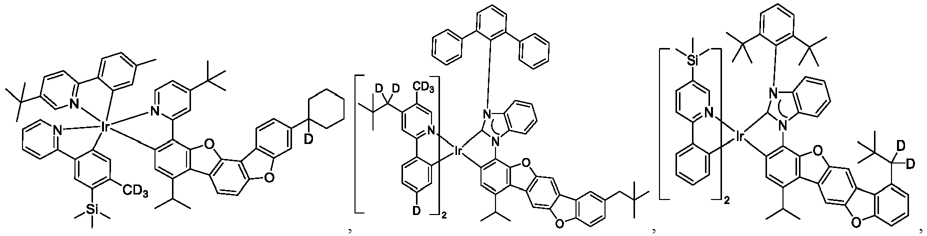

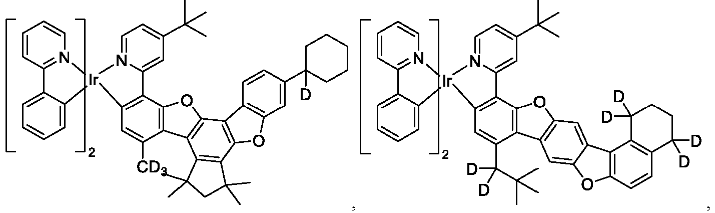

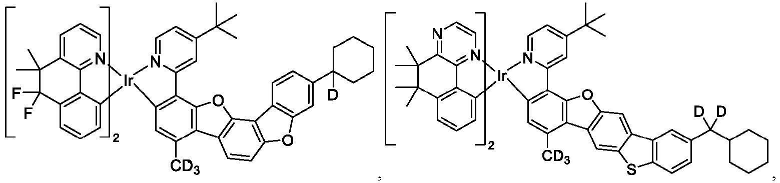

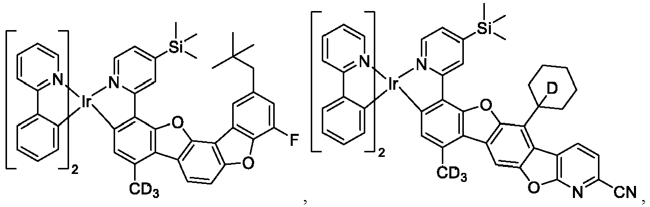

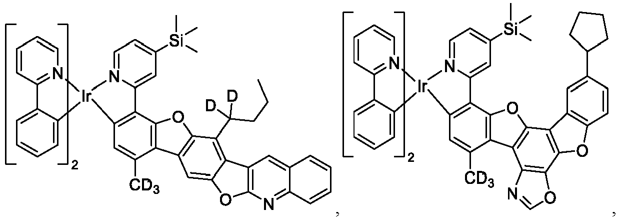

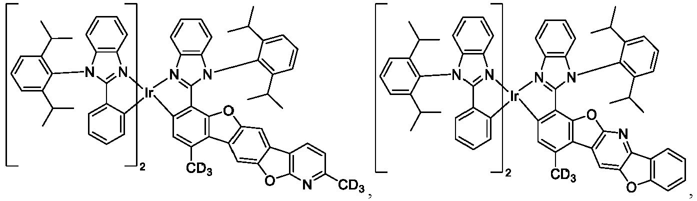

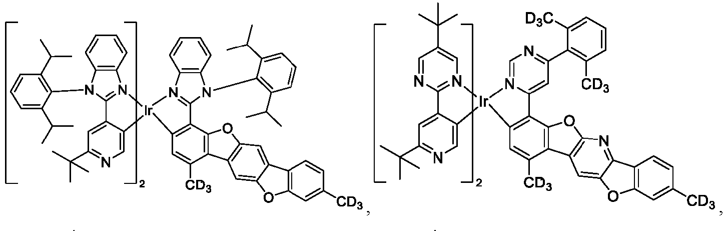

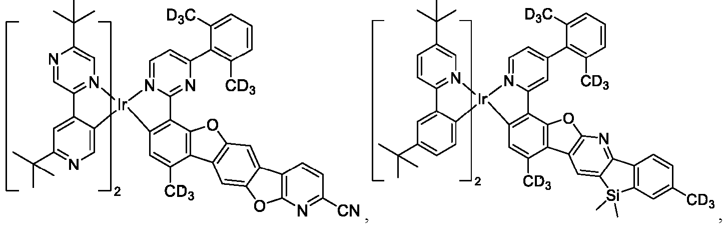

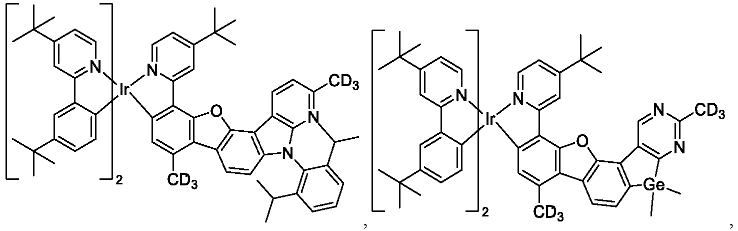

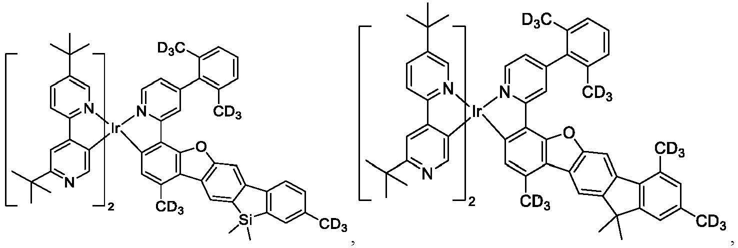

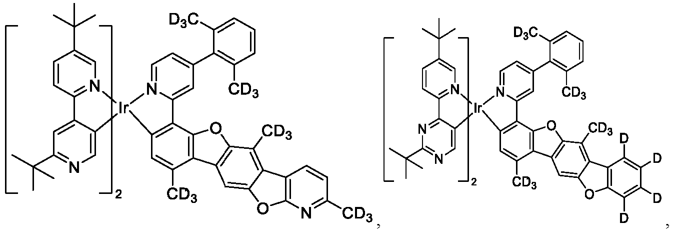

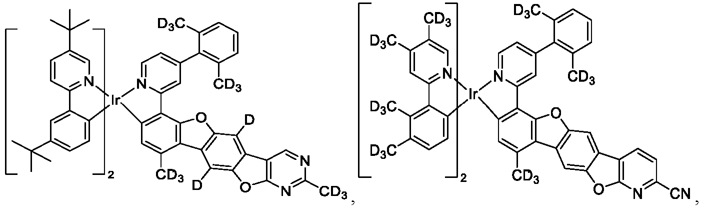

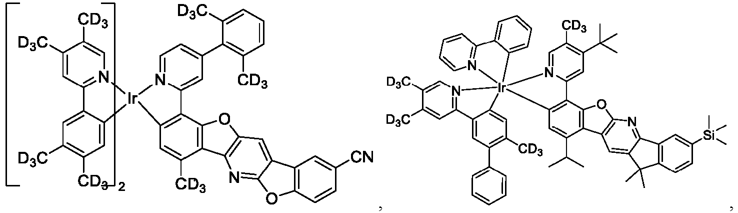

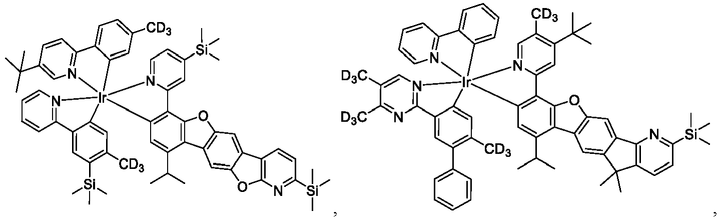

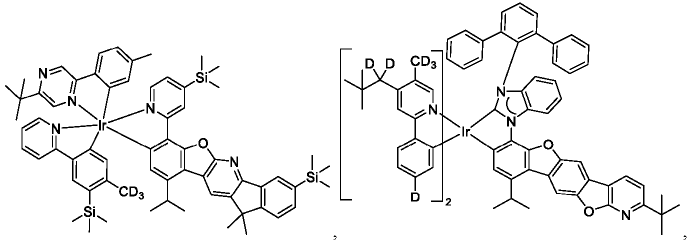

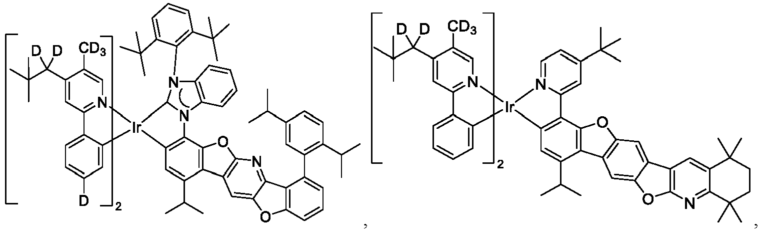

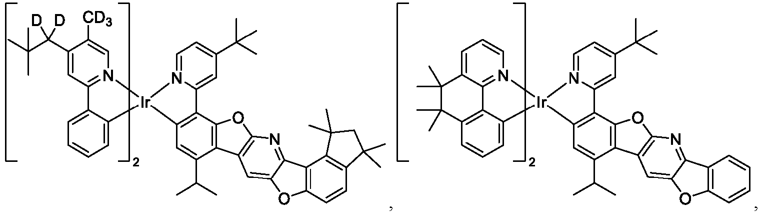

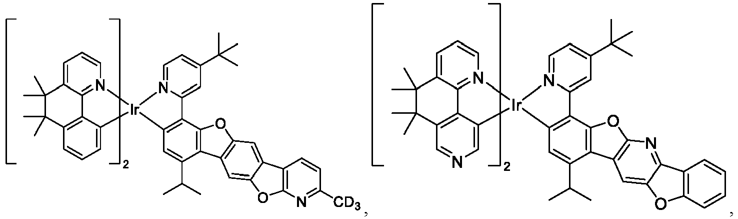

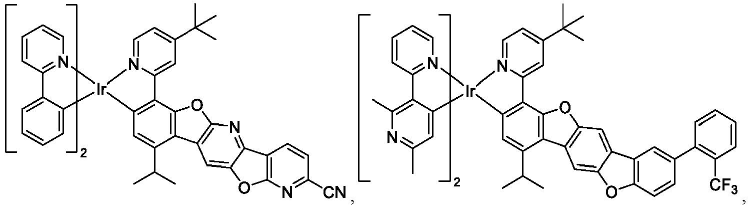

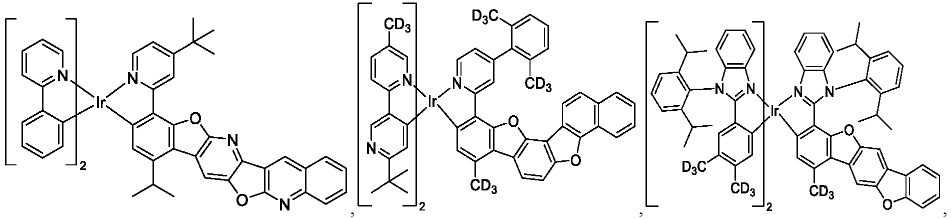

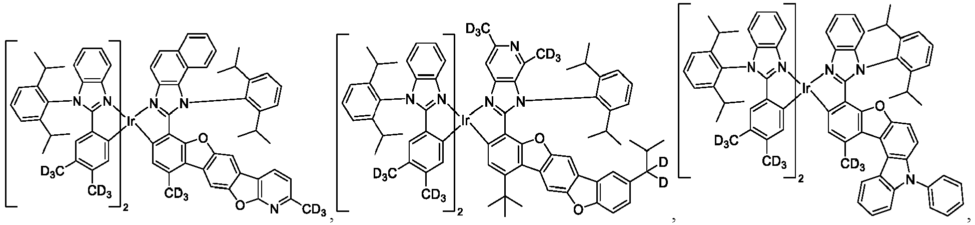

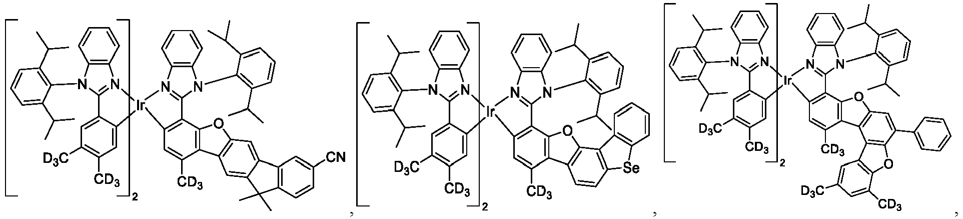

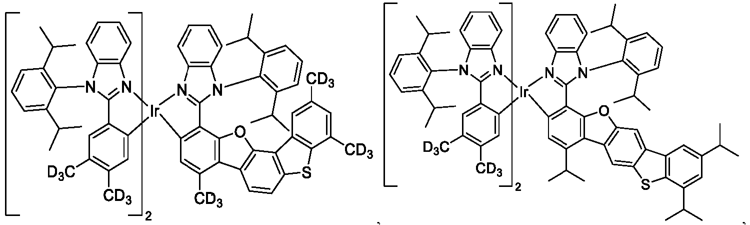

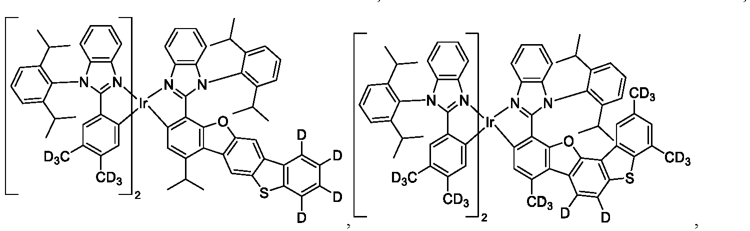

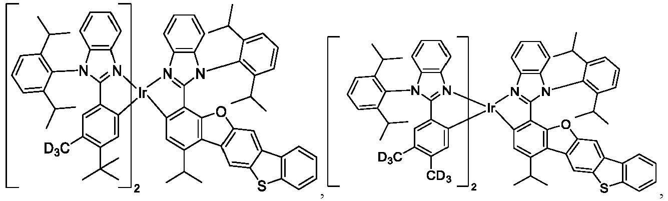

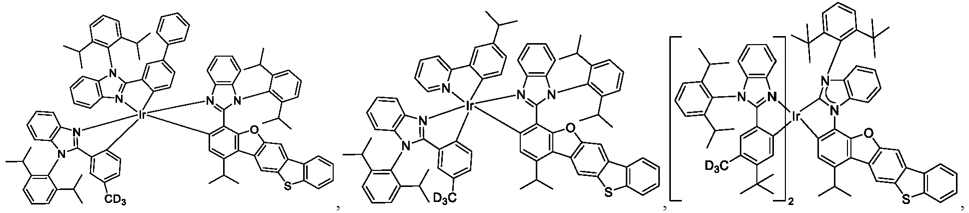

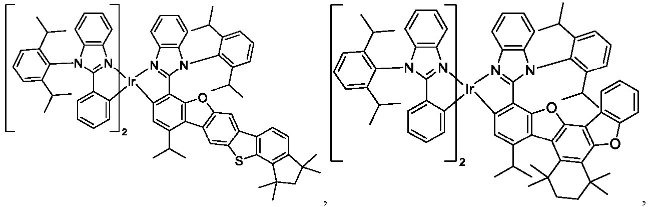

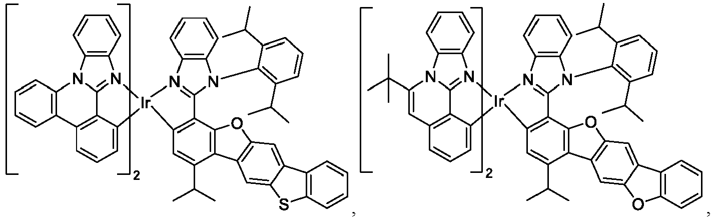

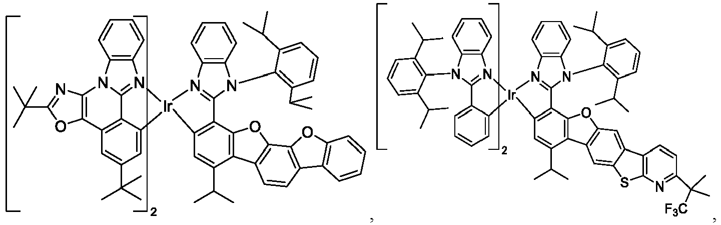

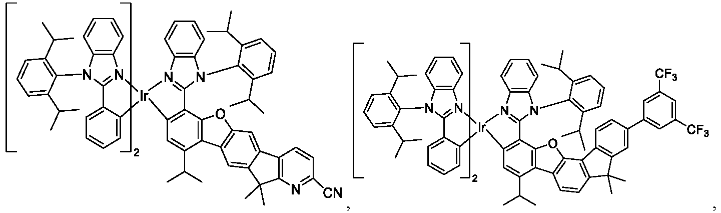

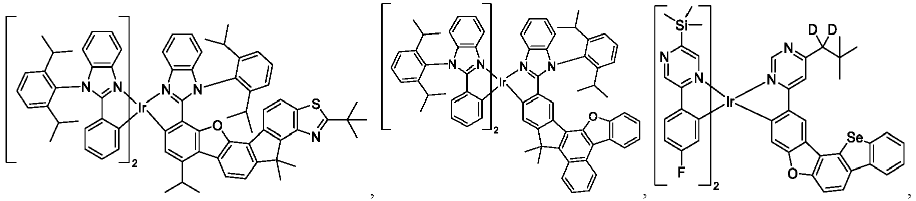

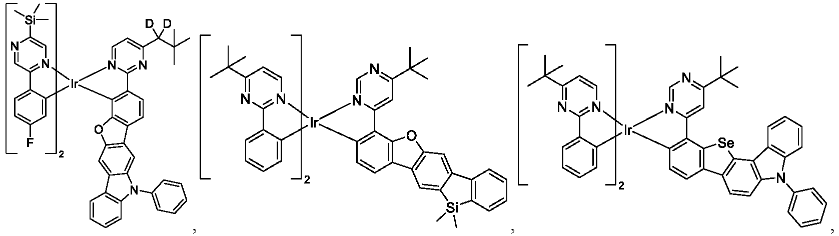

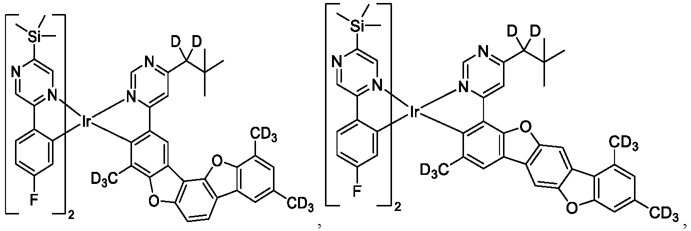

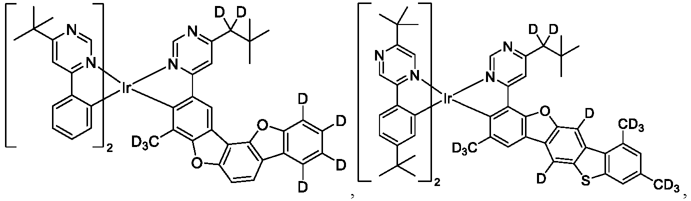

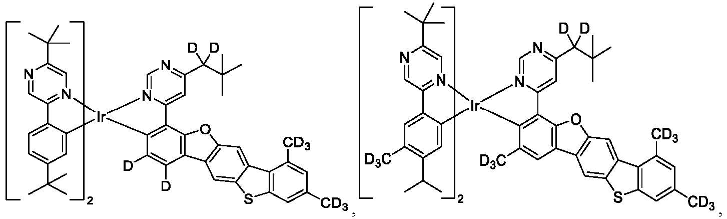

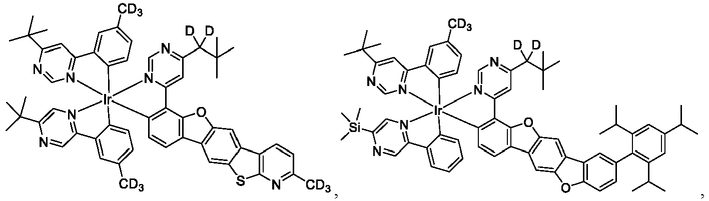

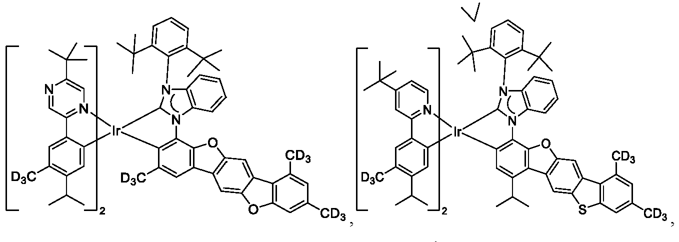

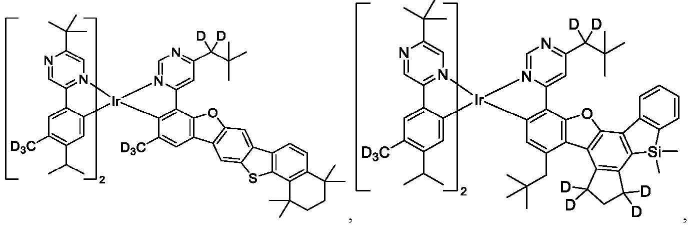

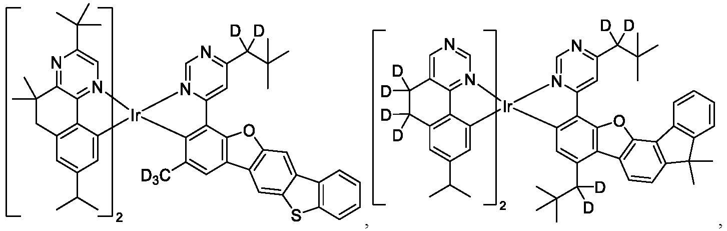

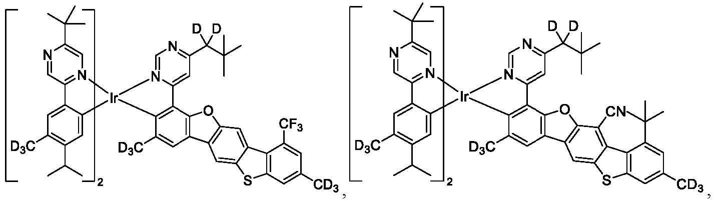

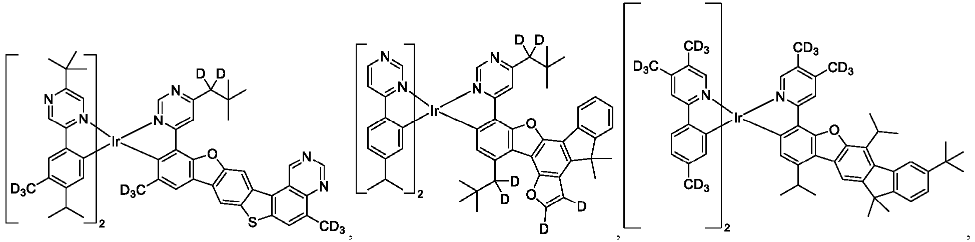

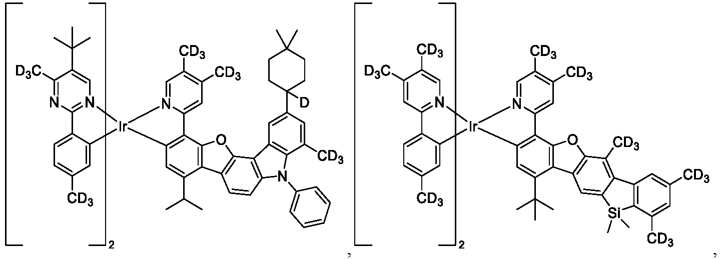

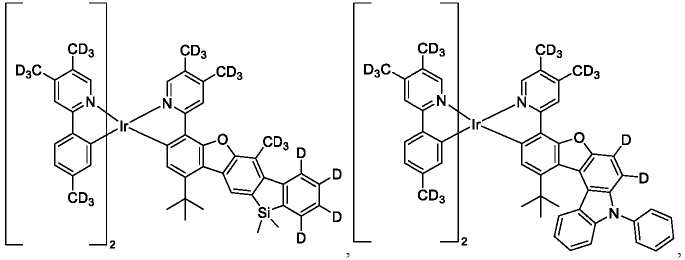

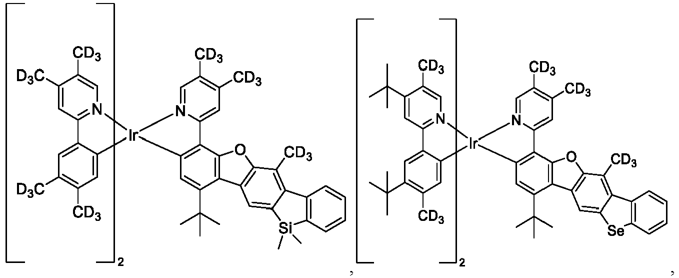

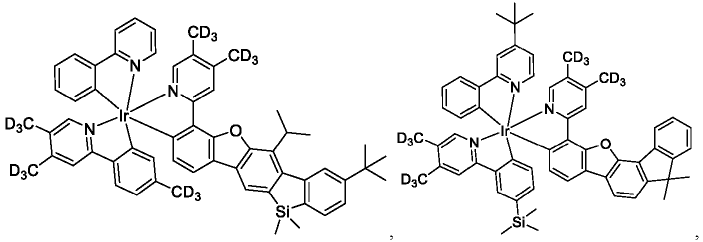

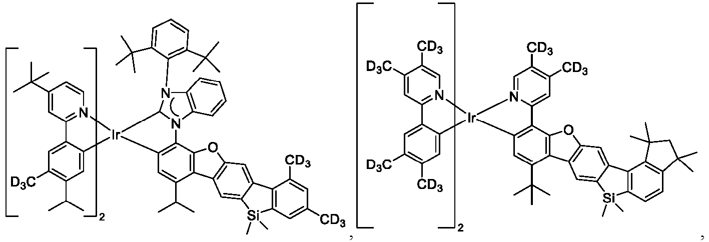

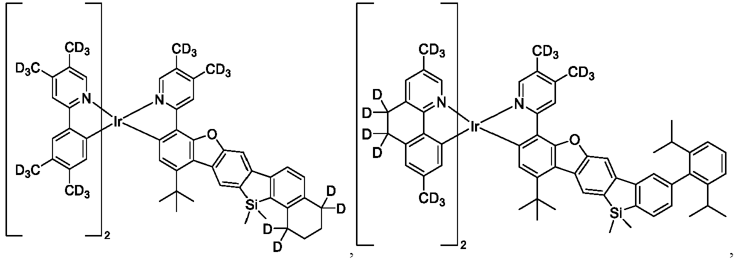

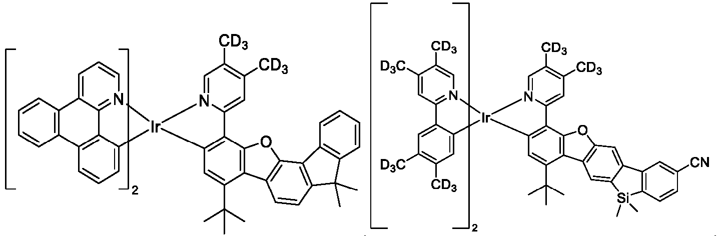

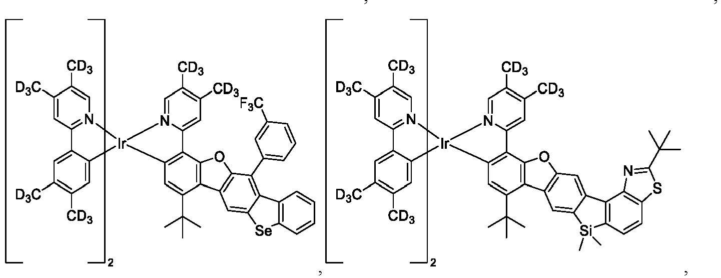

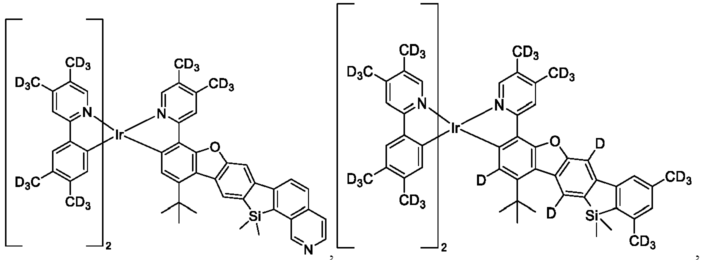

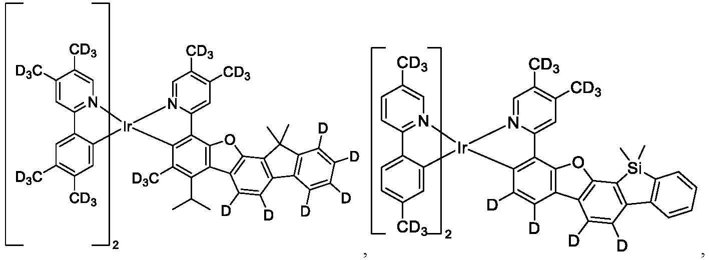

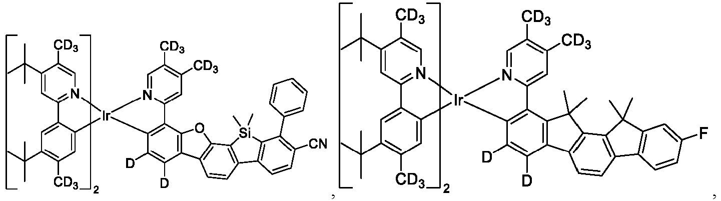

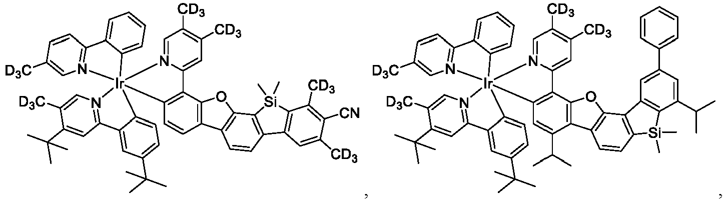

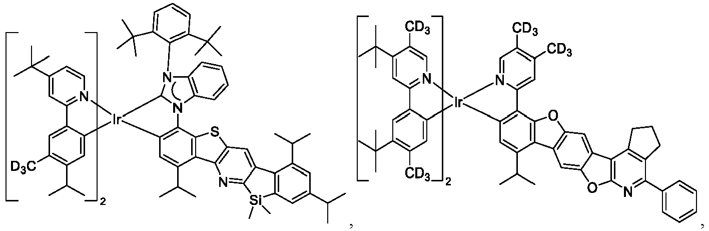

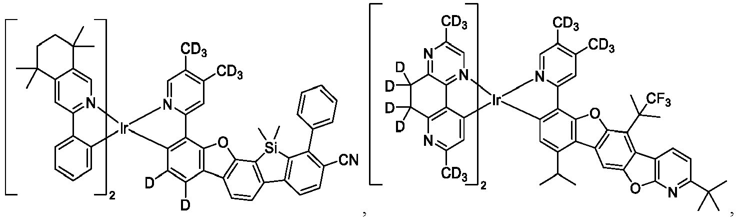

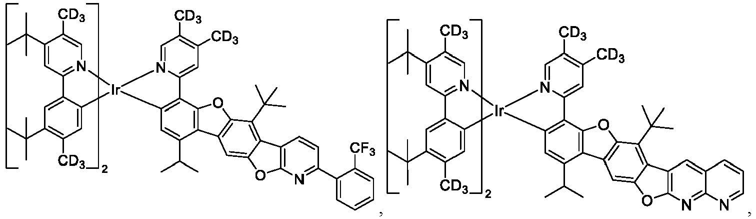

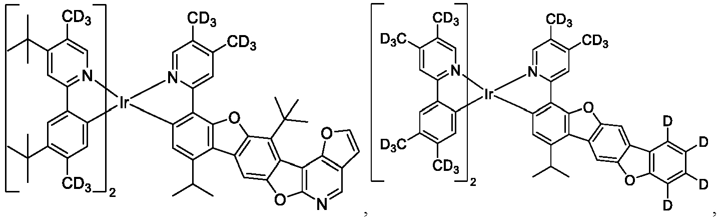

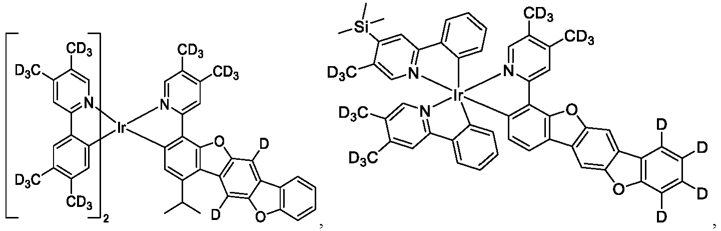

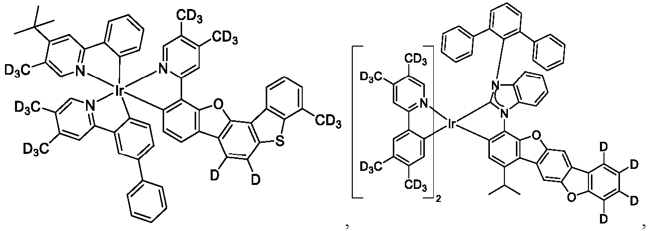

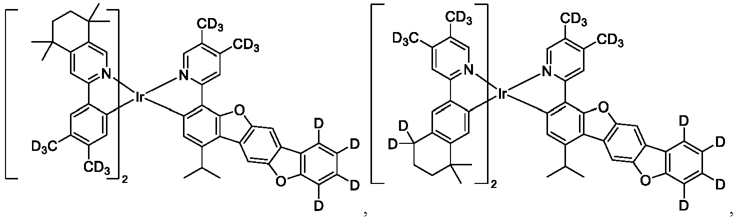

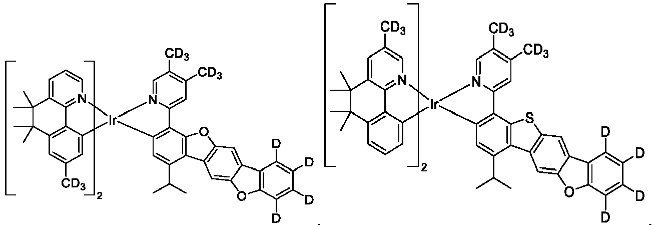

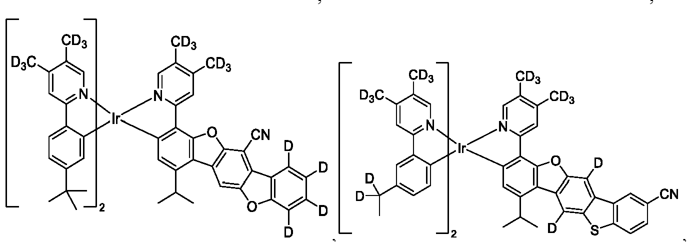

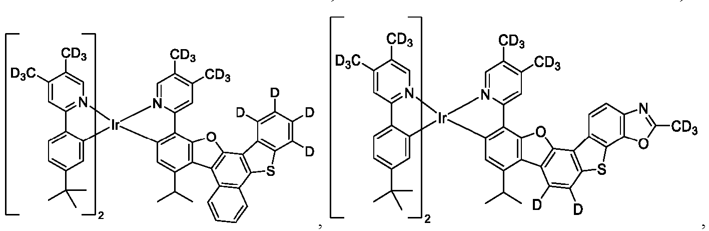

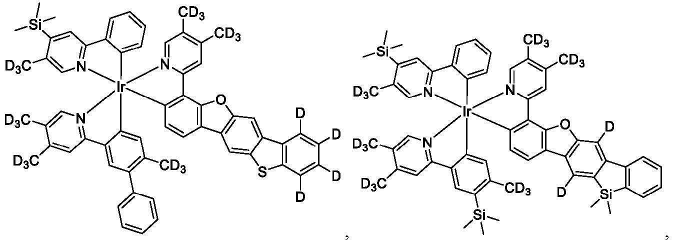

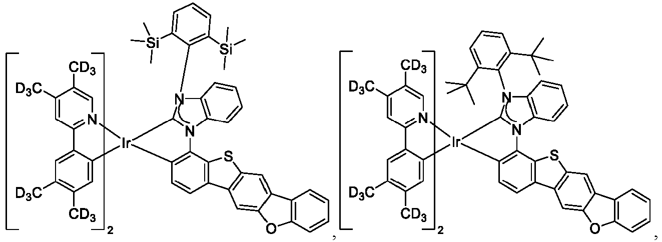

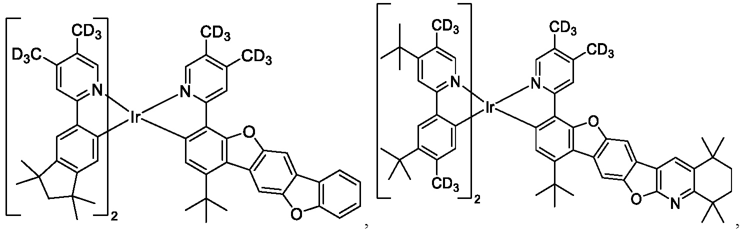

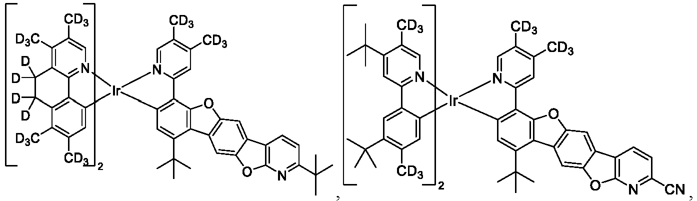

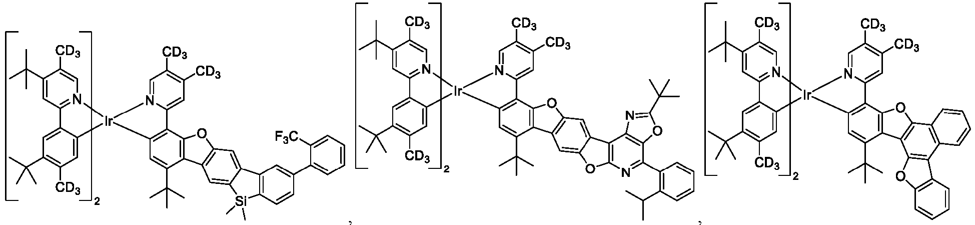

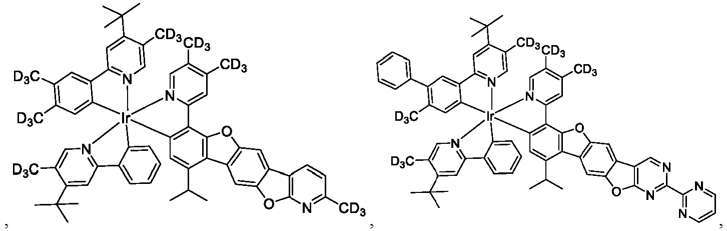

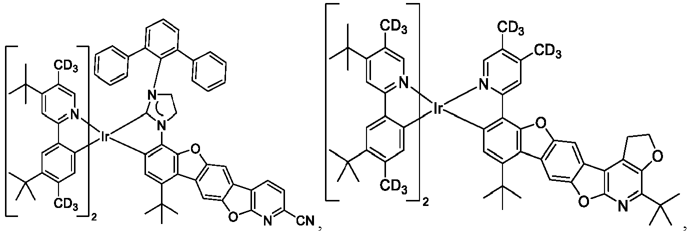

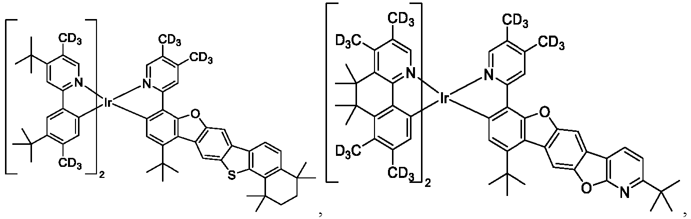

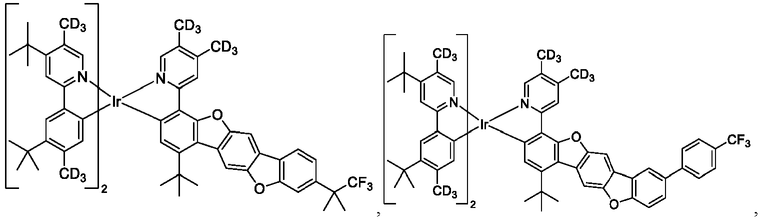

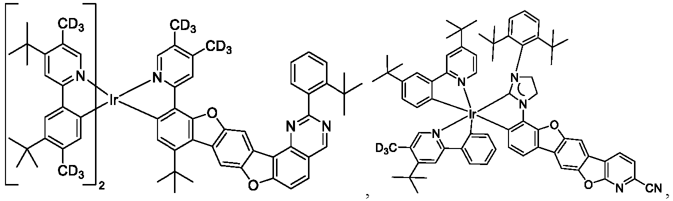

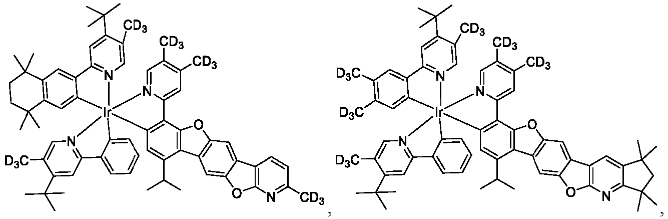

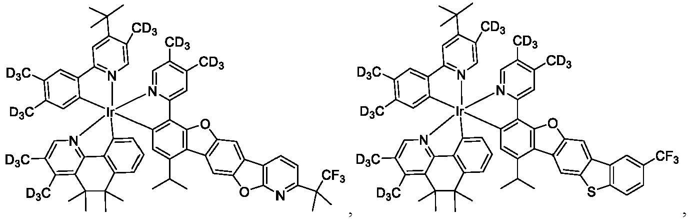

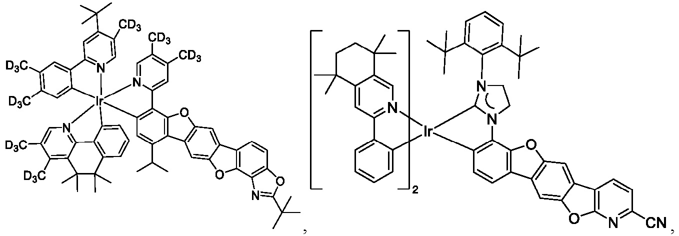

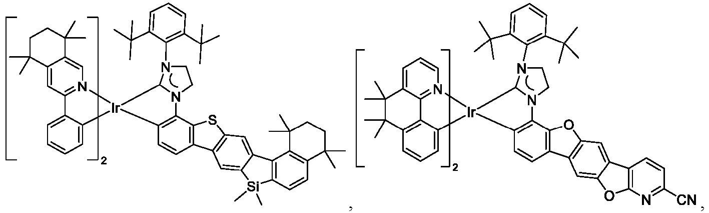

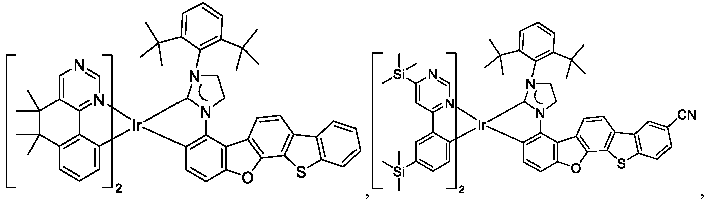

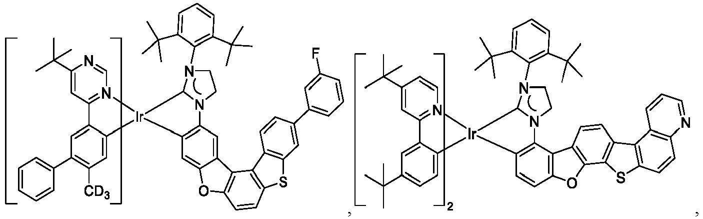

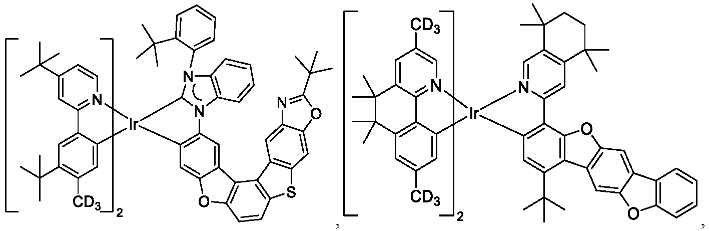

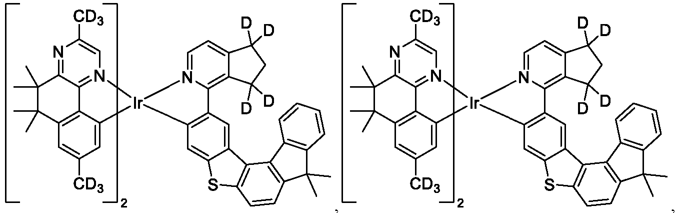

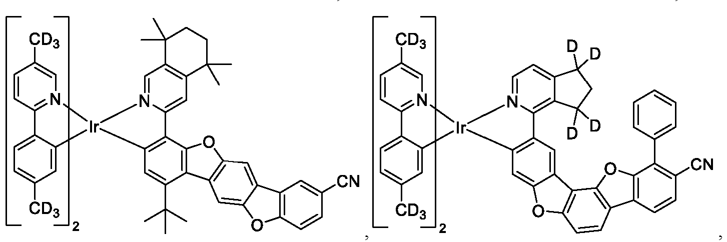

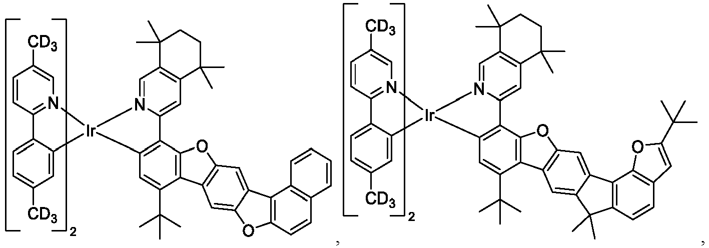

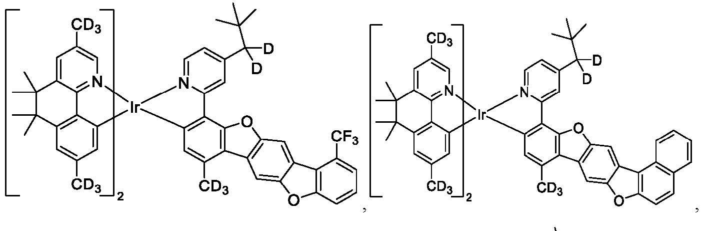

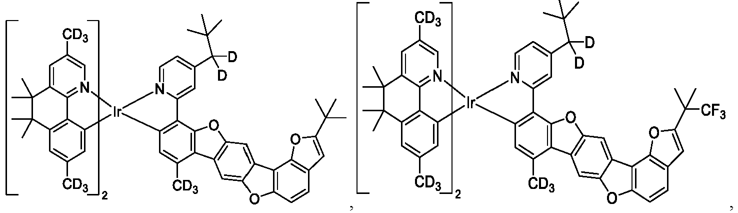

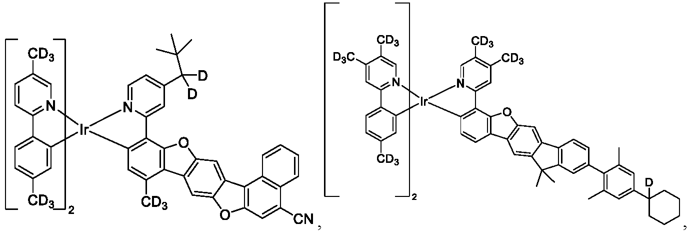

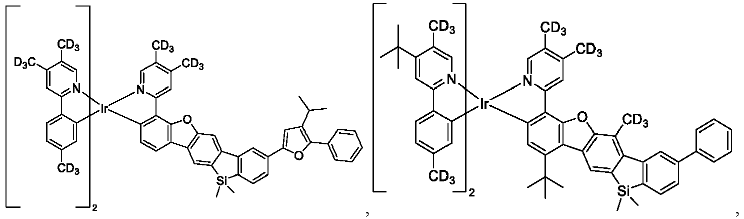

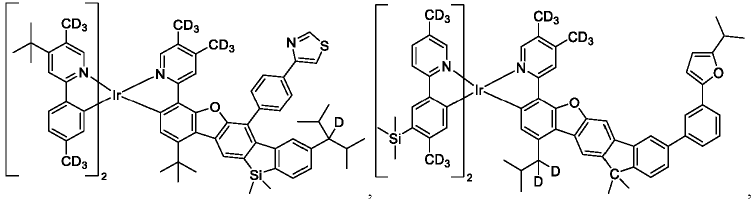

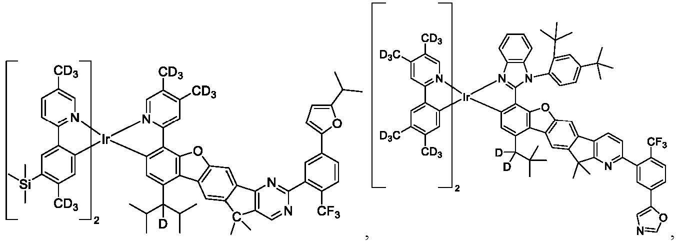

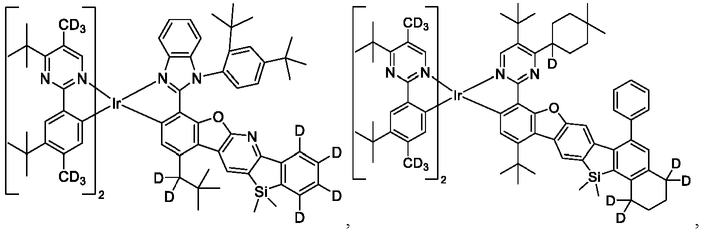

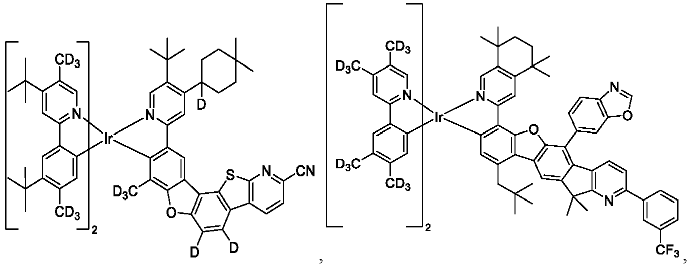

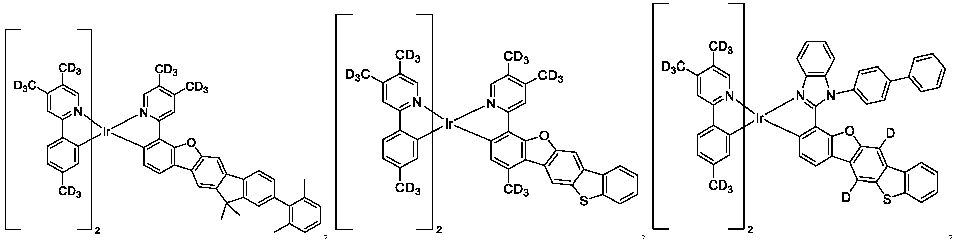

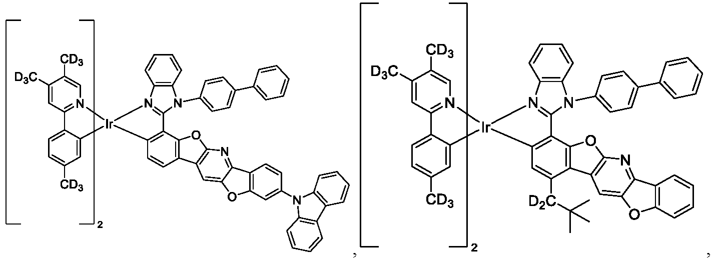

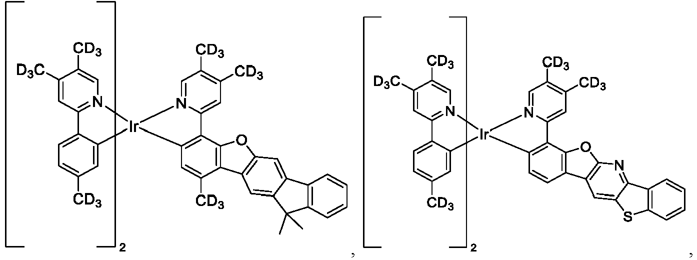

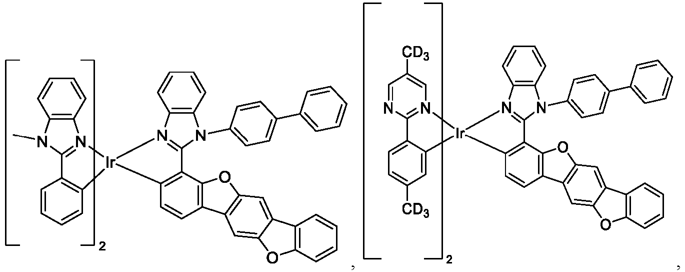

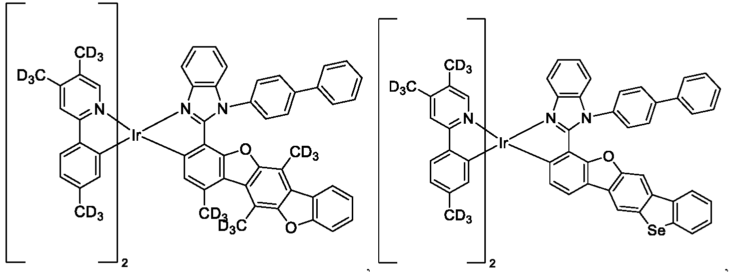

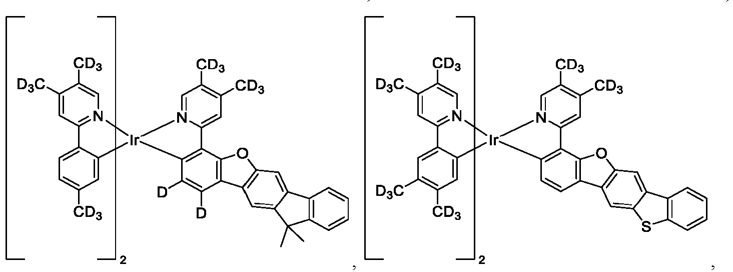

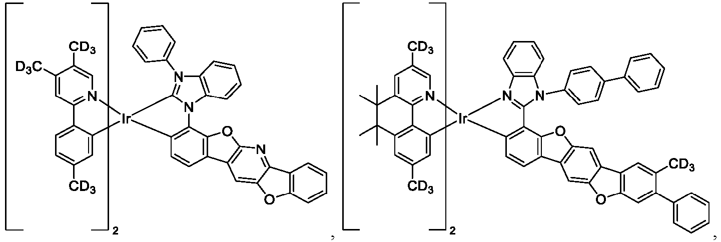

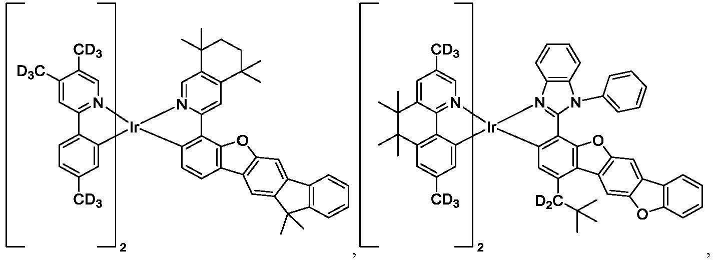

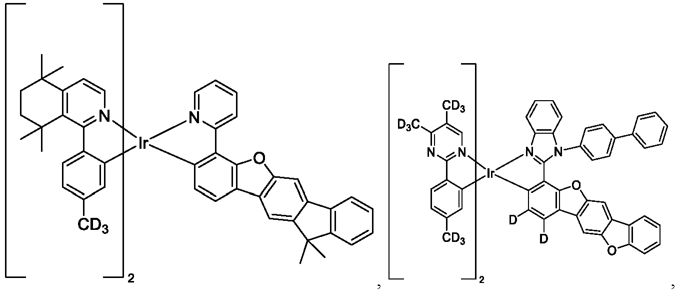

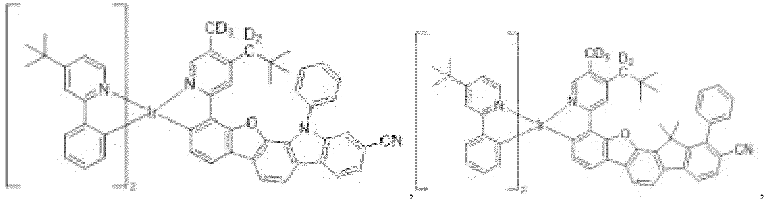

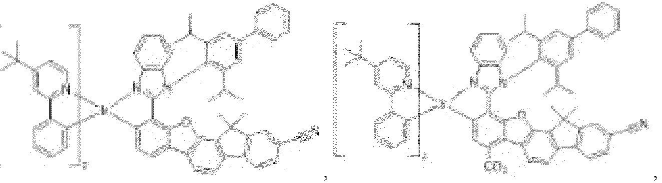

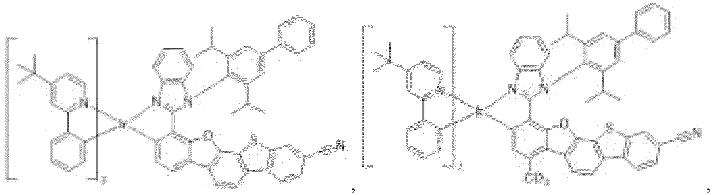

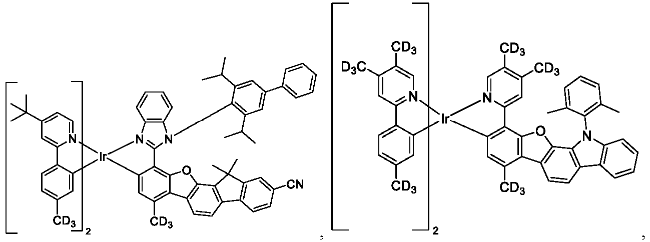

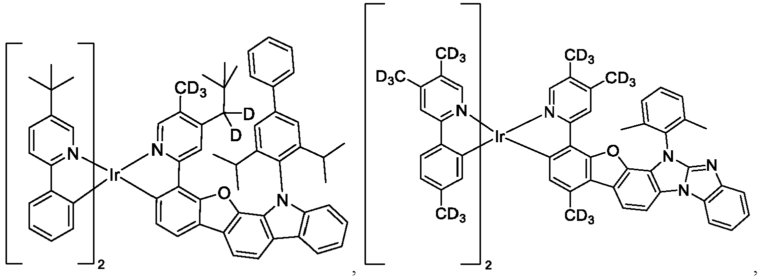

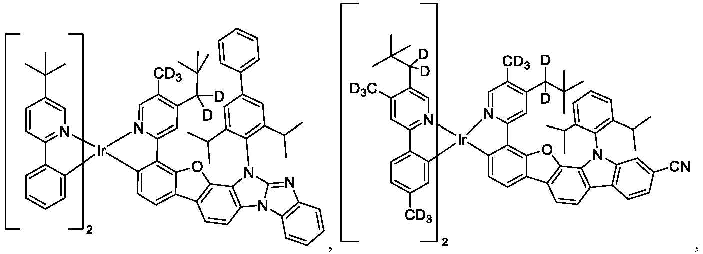

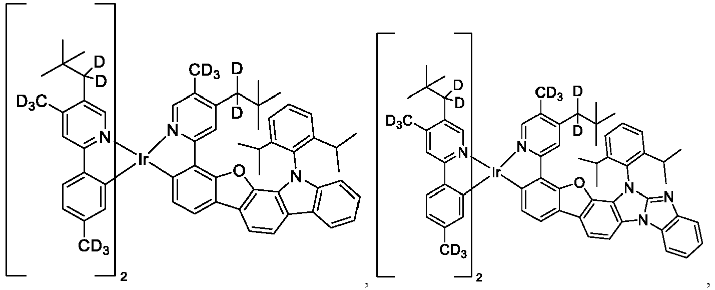

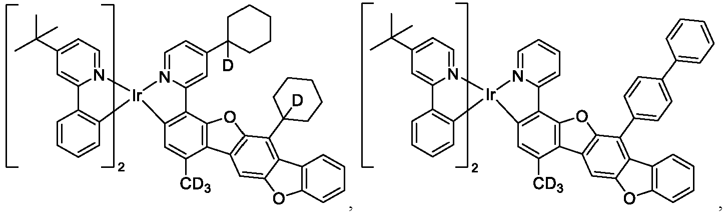

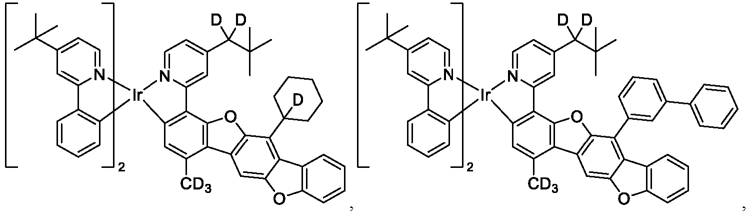

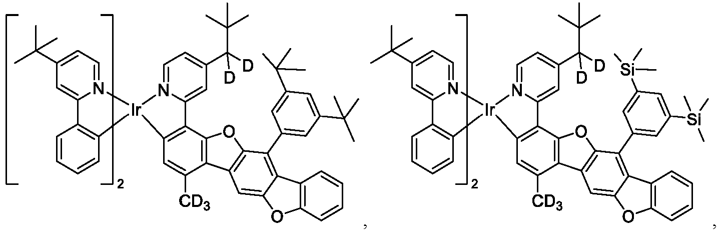

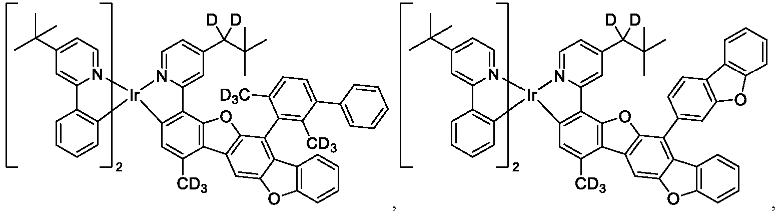

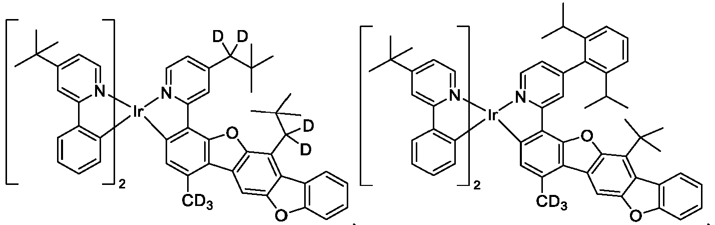

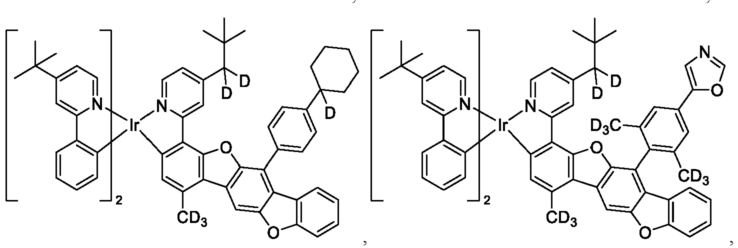

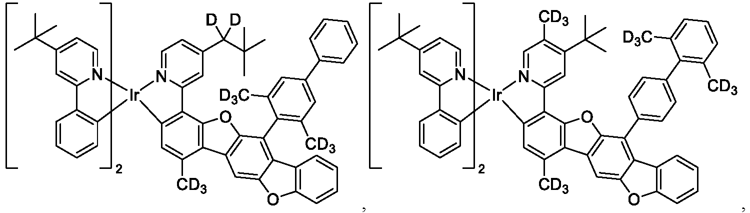

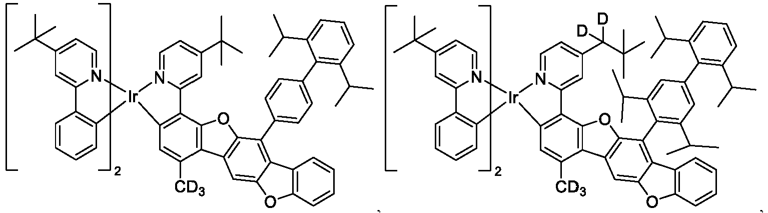

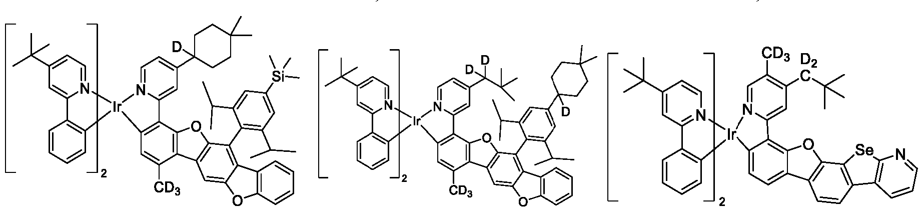

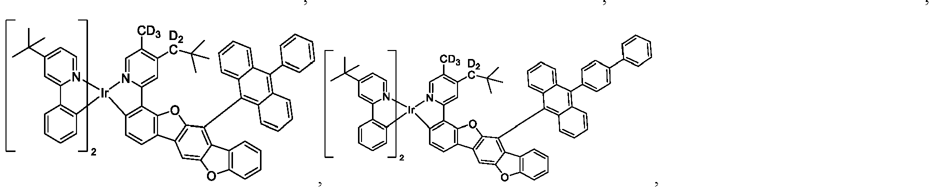

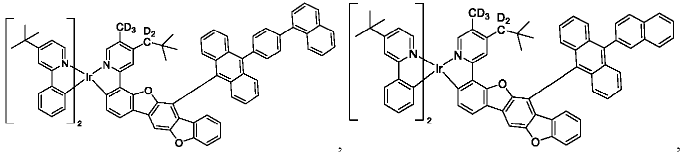

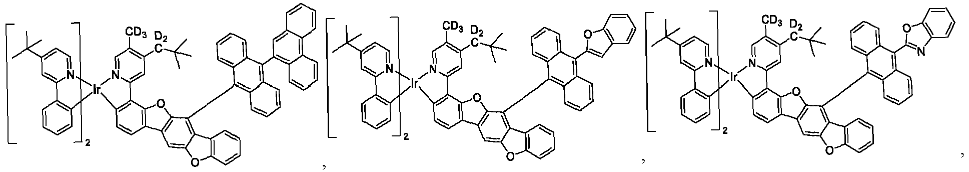

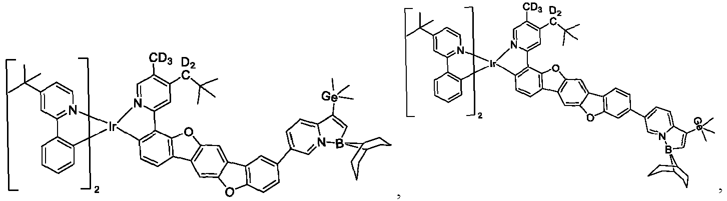

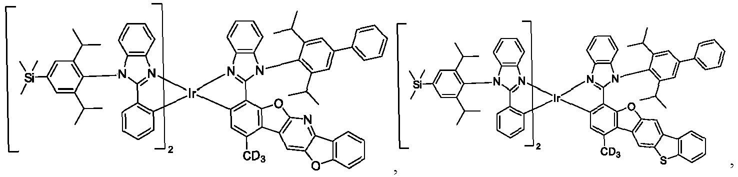

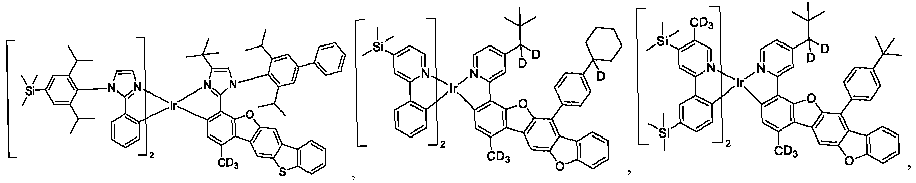

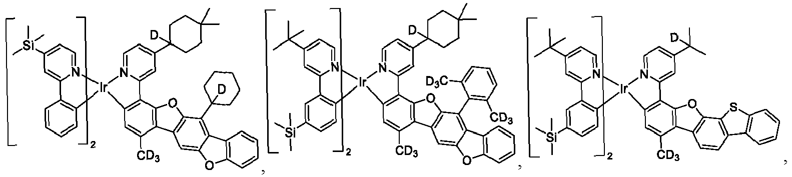

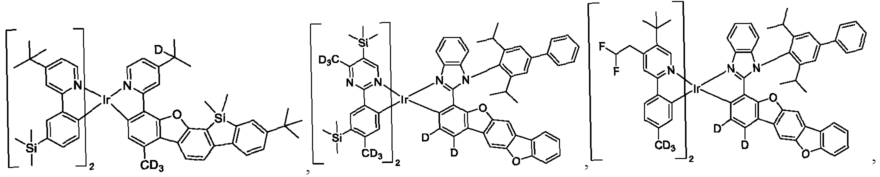

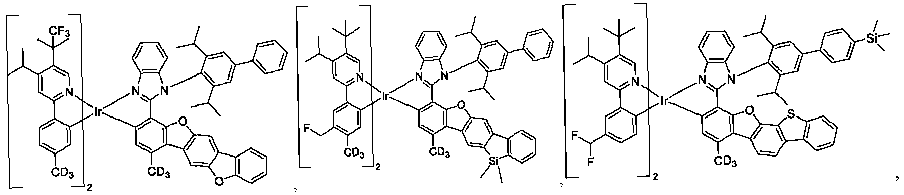

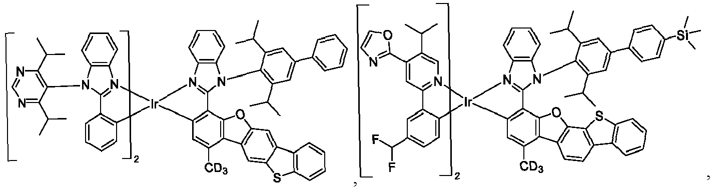

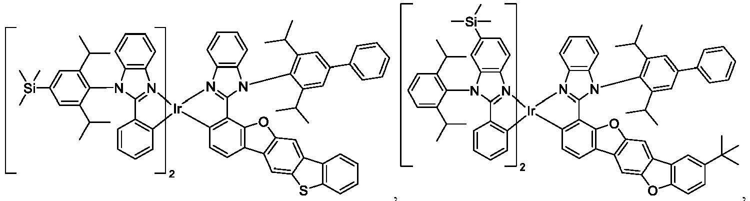

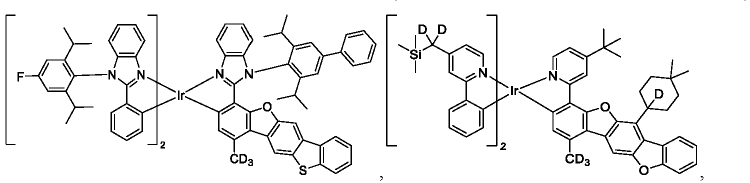

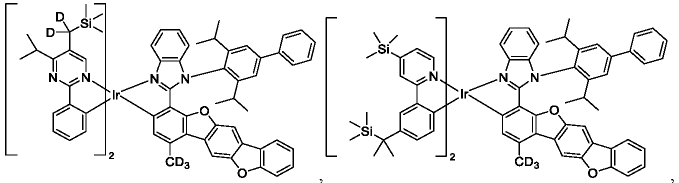

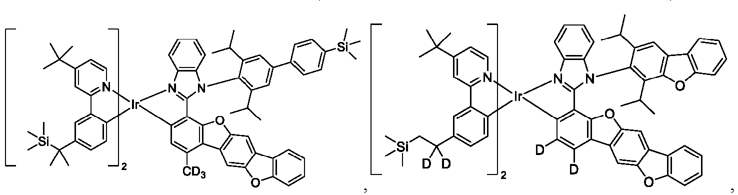

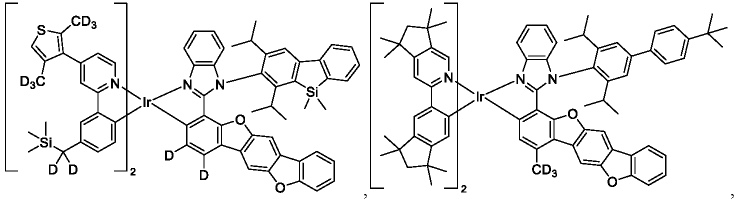

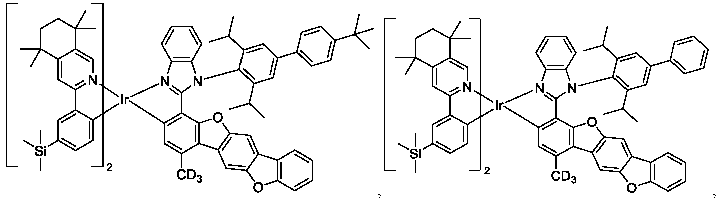

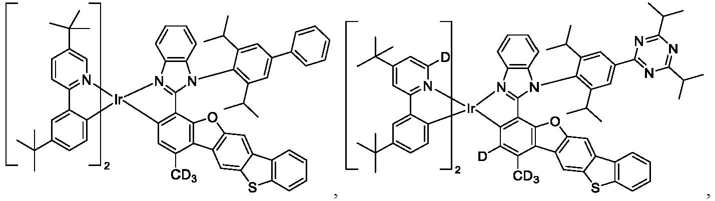

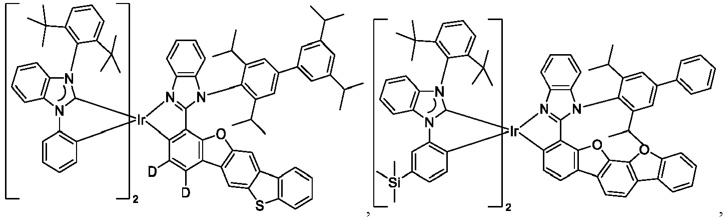

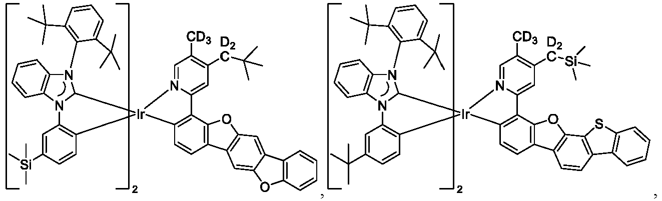

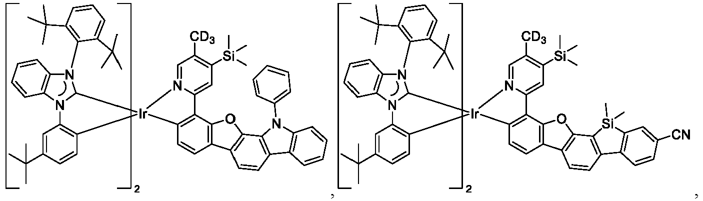

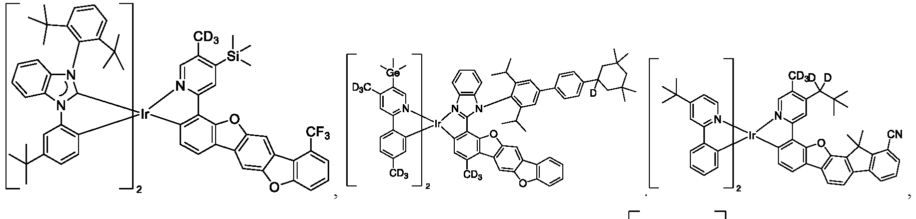

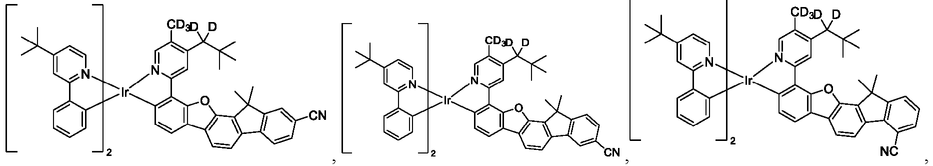

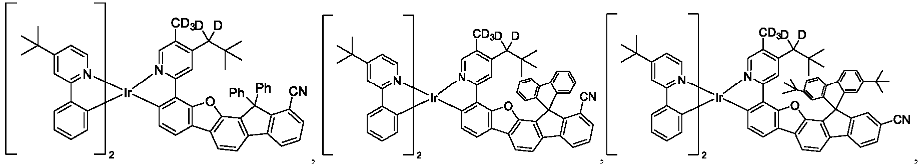

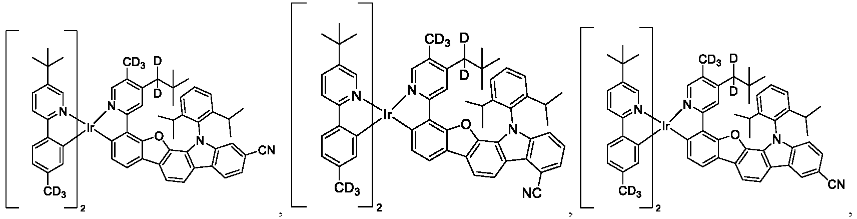

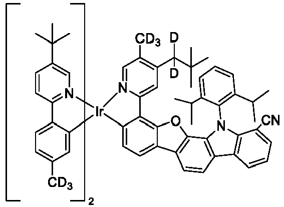

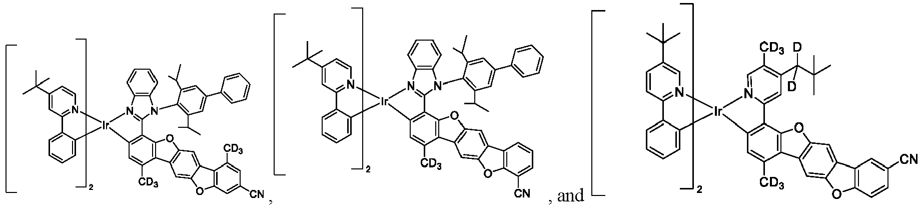

In some embodiments, the compound having a first ligand L_{A} comprising a structure of Formula I or the compound having a formula Ir(L_{A*})ₓ(L_{B*})_{y}(L_{C*})_{z} described herein is partially or fully deuterated. In some embodiments, the compound is fully deuterated. In some embodiments, the compound having a first ligand L_{A} of Formula I described herein can be at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percentage of all possible hydrogen atoms in the compound (e.g., positions that are hydrogen or deuterium) that are occupied by deuterium atoms. In some embodiments, carbon atoms comprised the ring coordinated to the metal M are fully or partially deuterated. In some embodiments, carbon atoms comprised by a polycyclic ring system coordinated to the metal M are fully or partially deuterated. In some embodiments, a substituent attached to a monocyclic or fused polycyclic ring system coordinated to the metal M is fully or partially deuterated.

In some embodiments, the compound of formula I has an emission at room temperature with a full width at half maximum (FWHM) of equal to or less than 50, 45, 40, 35, 30, 25, 20, 15, 10, or 5 nm. Narrower FWHM means better color purity for the OLED display application.

In some embodiments of heteroleptic compound having the formula of M(L_{A})ₚ(L_{B})_{q}(L_{C})ᵣ or Ir(L_{A*})ₓ(L_{B*})_{y}(L_{C*})_{z} as defined herein, the ligand L_{A} or L_{A*} has a first substituent R^{I}, where the first substituent R^{I} has a first atom a-I that is the farthest away from the metal M among all atoms in the ligand L_{A} or L_{A*}. Additionally, the ligand L_{B} or L_{B}*, if present, has a second substituent R^{II}, where the second substituent R^{II} has a first atom a-II that is the farthest away from the metal M among all atoms in the ligand L_{B} or L_{B*}. Furthermore, the ligand L_{C} or L_{C*}, if present, has a third substituent R^{III}, where the third substituent R^{III} has a first atom a-III that is the farthest away from the metal M among all atoms in the ligand L_{C} or L_{C*}.

In such heteroleptic compounds, vectors V_{D1}, V_{D2}, and V_{D3} can be defined as follows. V_{D1} represents the direction from the metal M to the first atom a-I and the vector V_{D1} has a value D¹ that represents the straight line distance between the metal M and the first atom a-I in the first substituent R^{I}. V_{D2} represents the direction from the metal M to the first atom a-II and the vector V_{D2} has a value D² that represents the straight line distance between the metal M and the first atom a-II in the second substituent R^{II}. V_{D3} represents the direction from the metal M to the first atom a-III and the vector V_{D3} has a value D³ that represents the straight line distance between the metal M and the first atom a-III in the third substituent R^{III}.

In such heteroleptic compounds, a sphere having a radius *r* is defined whose center is the metal M and the radius *r* is the smallest radius that will allow the sphere to enclose all atoms in the compound that are not part of the substituents R^{I}, R^{II} and R^{III}; and where at least one of D¹, D², and D³ is greater than the radius r by at least 1.5 Å. In some embodiments, at least one of D¹, D², and D³ is greater than the radius r by at least 2.9, 3.0, 4.3, 4.4, 5.2, 5.9, 7.3, 8.8, 10.3, 13.1, 17.6, or 19.1 Å. In some embodiments, at least two of D¹, D², and D³ is greater than the radius r by at least 1.5, 2.9, 3.0, 4.3, 4.4, 5.2, 5.9, 7.3, 8.8, 10.3, 13.1, 17.6, or 19.1 Å.

In some embodiments of such heteroleptic compound, the compound has a transition dipole moment axis and angles are defined between the transition dipole moment axis and the vectors V_{D1}, V_{D2}, and V_{D3}, where at least one of the angles between the transition dipole moment axis and the vectors V_{D1}, V_{D2}, and V_{D3} is less than 40°. In some embodiments, at least one of the angles between the transition dipole moment axis and the vectors V_{D1}, V_{D2}, and V_{D3} is less than 30°, 20°, 15°, or 10°. In some embodiments, at least two of the angles between the transition dipole moment axis and the vectors V_{D1}, V_{D2}, and V_{D3} are less than 20°. In some embodiments, at least two of the angles between the transition dipole moment axis and the vectors V_{D1}, V_{D2}, and V_{D3} are less than 15° or 10°.

In some embodiments, all three angles between the transition dipole moment axis and the vectors V_{D1}, V_{D2}, and V_{D3} are less than 20°. In some embodiments, all three angles between the transition dipole moment axis and the vectors V_{D1}, V_{D2}, and V_{D3} are less than 15° or 10°.

In some embodiments of such heteroleptic compounds, the compound has a vertical dipole ratio (VDR) of 0.33 or less. In some embodiments of such heteroleptic compounds, the compound has a VDR of 0.30, 0.25, 0.20, or 0.15 or less.

One of ordinary skill in the art would readily understand the meaning of the terms transition dipole moment axis of a compound and vertical dipole ratio of a compound. Nevertheless, the meaning of these terms can be found in U.S. pat. No. 10,672,997 whose disclosure is incorporated herein by reference in its entirety. In U.S. pat. No. 10,672,997, horizontal dipole ratio (HDR) of a compound, rather than VDR, is discussed. However, one skilled in the art readily understands that VDR = 1 - HDR.

In some embodiments, the compound can be an emissive dopant. In some embodiments, the compound can produce emissions via phosphorescence, fluorescence, thermally activated delayed fluorescence, triplet-triplet annihilation, or combinations of these processes. In some embodiments, the emissive dopant can be a racemic mixture, or can be enriched in one enantiomer. In some embodiments, the present compounds can have different stereoisomers, such as *fac* and *mer.* The current compound relates both to individual isomers and to mixtures of various isomers in any mixing ratio. In some embodiments, the compound can be homoleptic (each ligand is the same). In some embodiments, the compound can be heteroleptic (at least one ligand is different from others). When there is more than one ligand coordinated to a metal, the ligands can all be the same in some embodiments. In some other embodiments, at least one ligand is different from the other ligands. In some embodiments, every ligand can be different from every other ligand. This is also true in embodiments where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the same in some embodiments, and at least one of the ligands being linked can be different from the other ligand(s) in some other embodiments.

In yet another aspect of the present disclosure, a formulation that comprises the novel compound disclosed herein is described. The formulation can include one or more components selected from the group consisting of a solvent, an emitter, a host, a hole injection material, hole transport material, electron blocking material, hole blocking material, and an electron transport material, disclosed herein.

The present disclosure encompasses any chemical structure comprising the novel compound of the present disclosure, or a monovalent or polyvalent variant thereof. In other words, the inventive compound, or a monovalent or polyvalent variant thereof, can be a part of a larger chemical structure. Such chemical structure can be selected from the group consisting of a monomer, a polymer, a macromolecule, and a supramolecule (also known as supermolecule). As used herein, a "monovalent variant of a compound" refers to a moiety that is identical to the compound except that one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds. As used in this context, the description that a structure A comprises a moiety B means that the structure A includes the structure of moiety B not including the H or D atoms that can be attached to the moiety B. This is because at least one H or D on a given moiety structure has to be replaced to become a substituent so that the moiety B can be part of the structure A, and one or more of the H or D on a given moiety B structure can be further substituted once it becomes a part of structure A.

### C. The OLEDs and the Devices of the Present Disclosure

In another aspect, the present disclosure also provides an OLED device comprising a first organic layer that contains a compound as disclosed in the above compounds section of the present disclosure.

In some embodiments, the OLED comprises: an anode; a cathode; and an organic layer disposed between the anode and the cathode, where the organic layer comprises a compound having a first ligand L_{A} comprising a structure of Formula I or a compound having a formula Ir(L_{A*})ₓ(L_{B*})_{y}(L_{C*})_{z}.

In some embodiments, the organic layer is selected from the group consisting of HIL, HTL, EBL, EML, HBL, ETL, and EIL. In some embodiments, the organic layer may be an emissive layer and the compound as described herein may be an emissive dopant or a non-emissive dopant.

In some embodiments, the organic layer may further comprise a host, wherein host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, azaborinine, oxaborinine, dihydroacridine, xanthene, dihydrobenzoazasiline, dibenzooxasiline, phenoxazine, phenoxathiine, phenothiazine, dihydrophenazine, fluorene, naphthalene, anthracene, phenanthrene, phenanthroline, benzoquinoline, quinoline, isoquinoline, quinazoline, pyrimidine, pyrazine, pyridine, triazine, boryl, silyl, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene).

In some embodiments, the host can be selected from the group consisting of the structures of the following HOST Group 1: 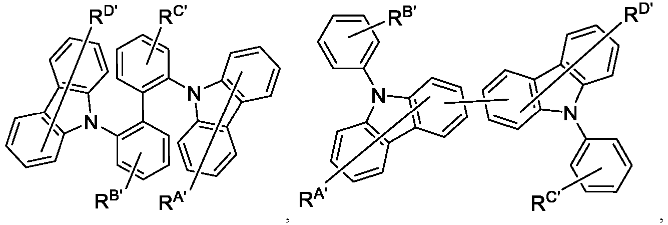 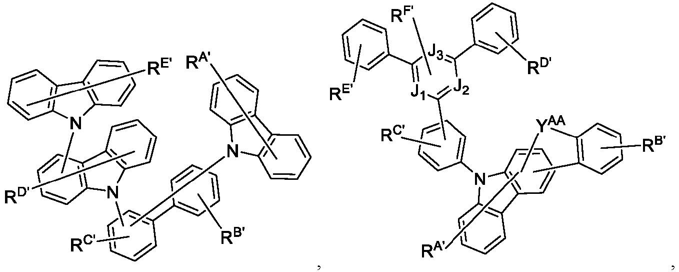 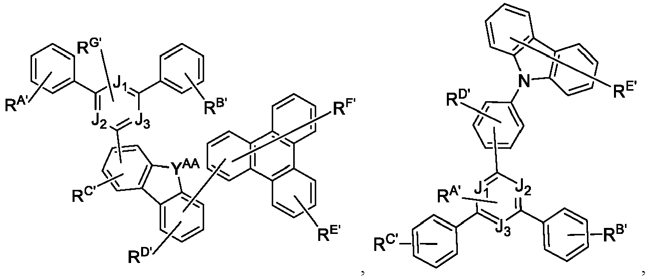 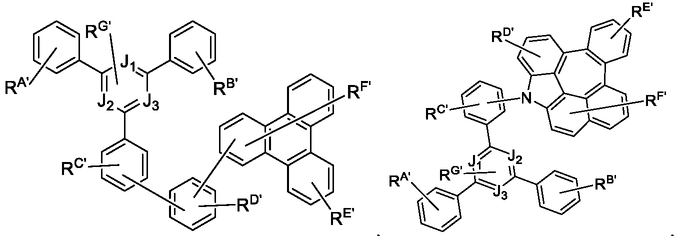 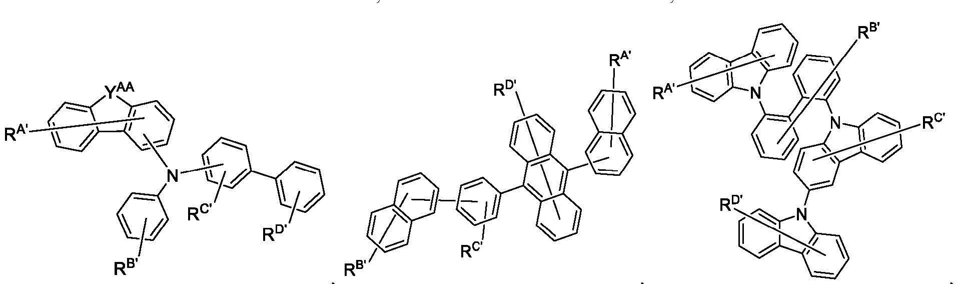 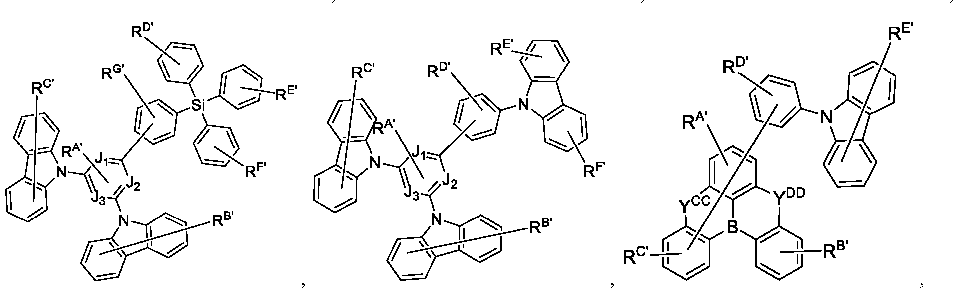 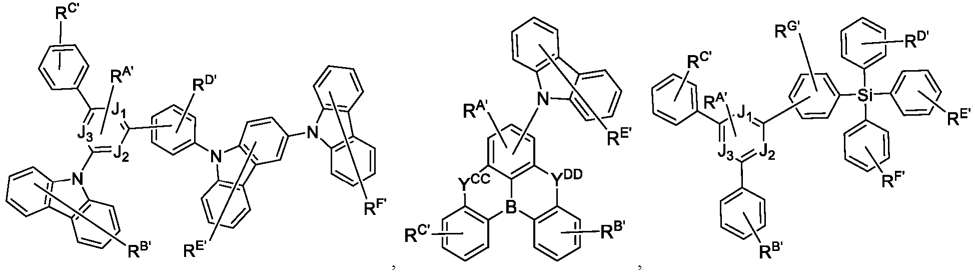 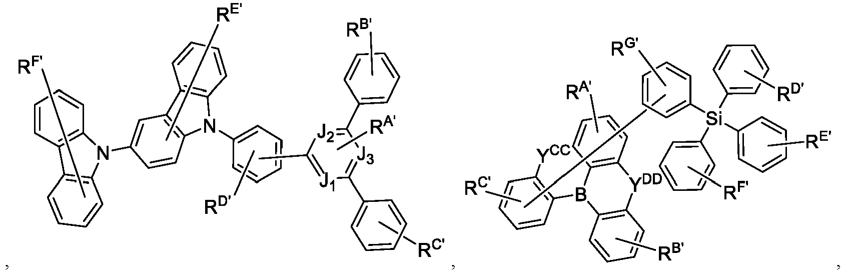 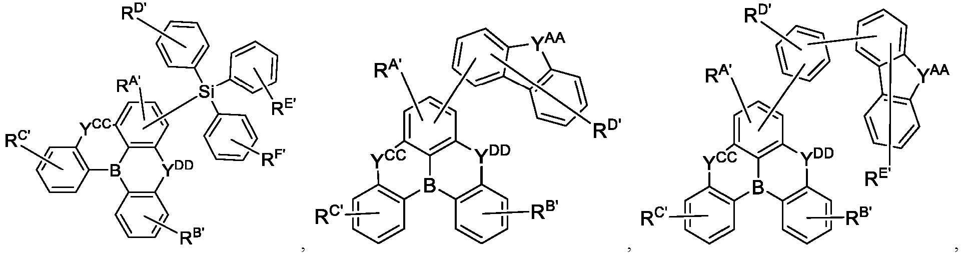 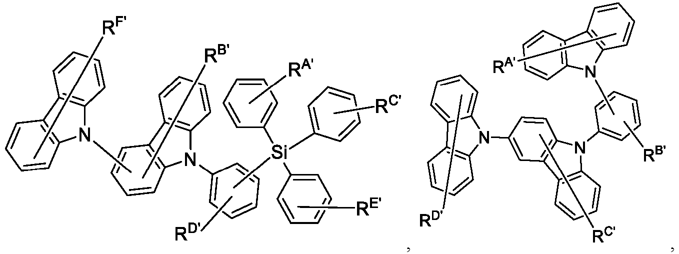 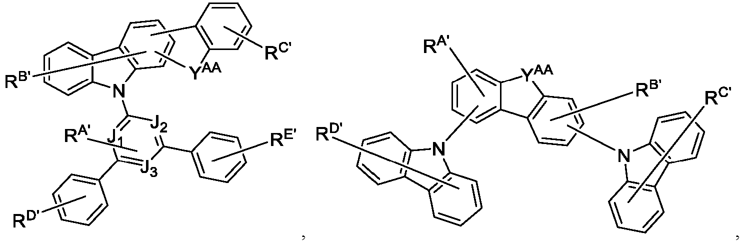 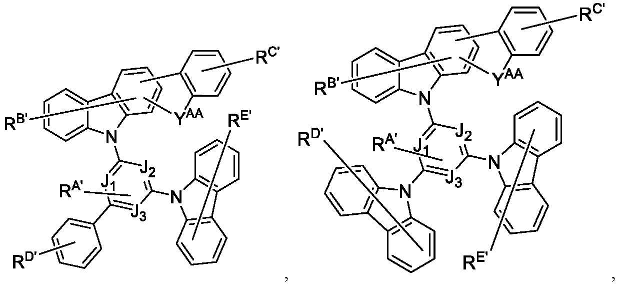 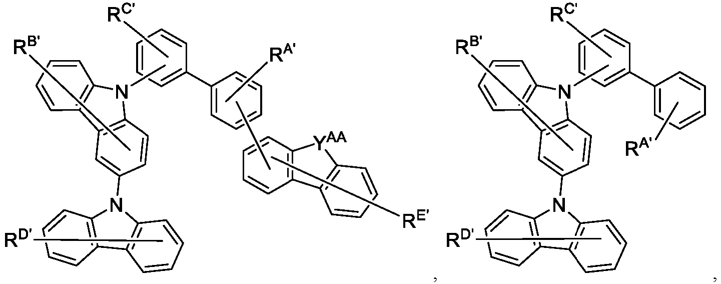 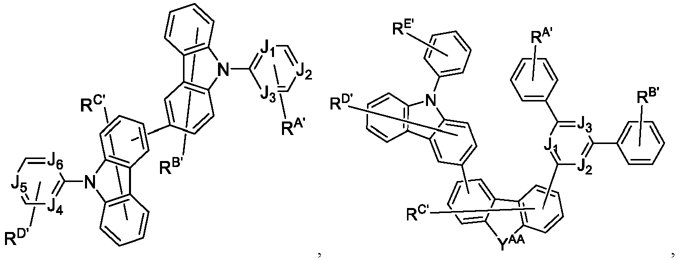 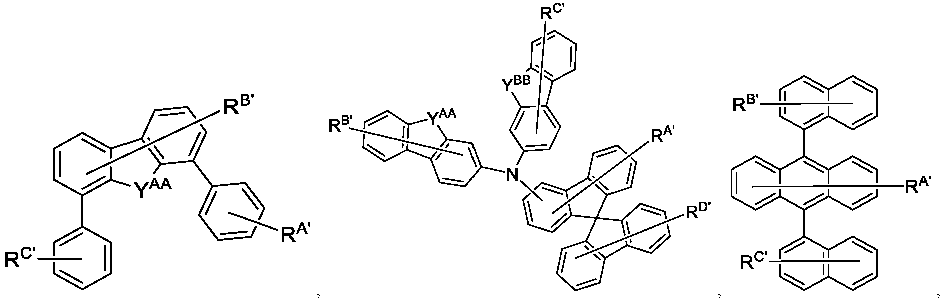 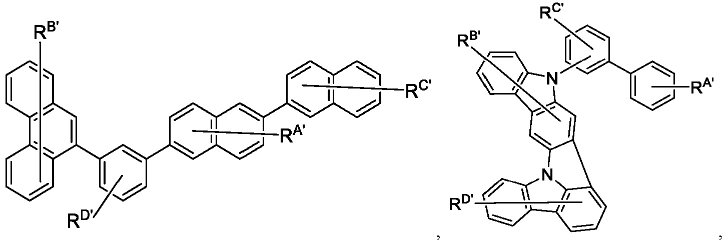 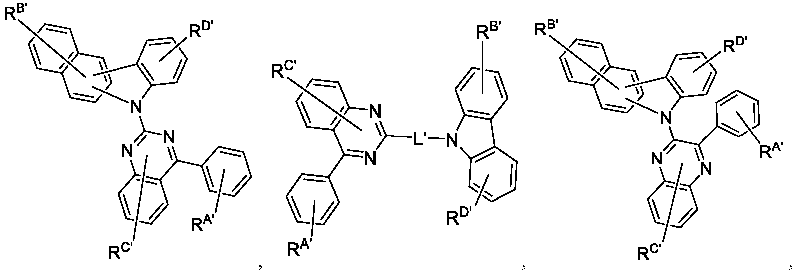 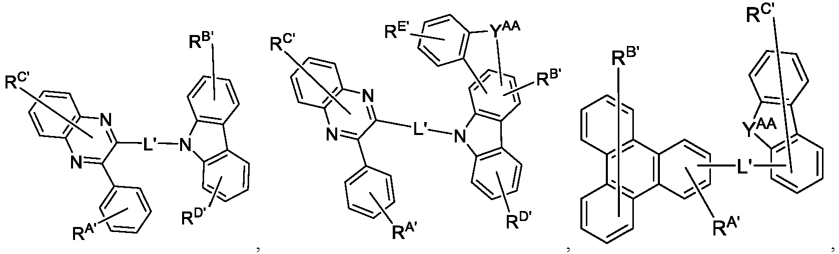 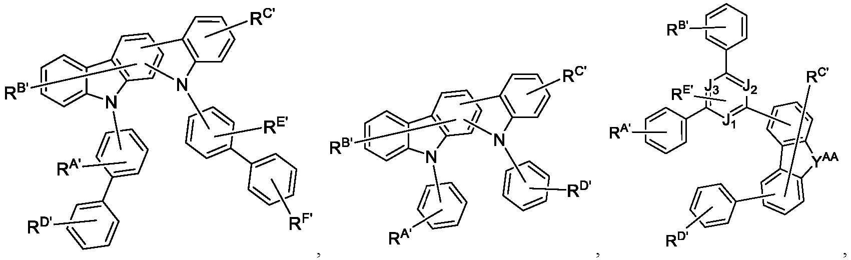 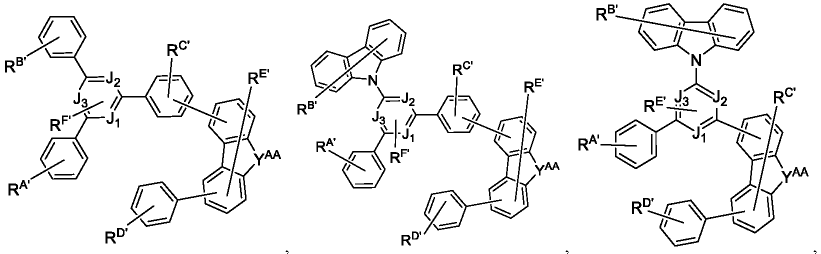 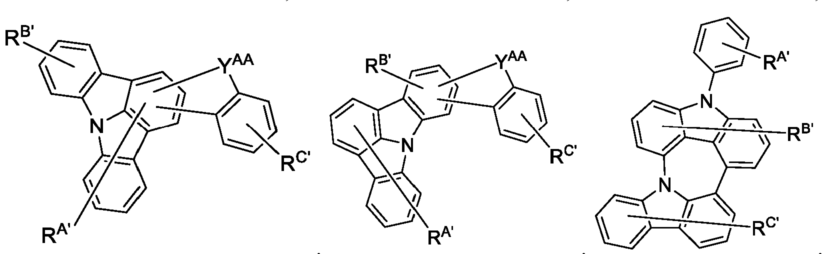 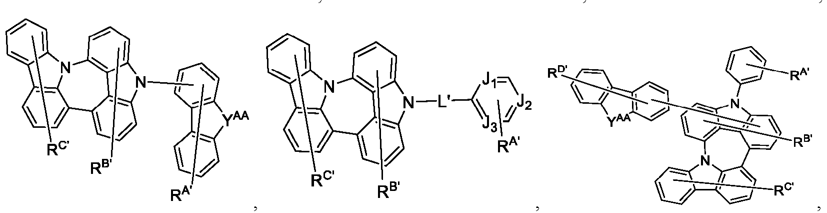 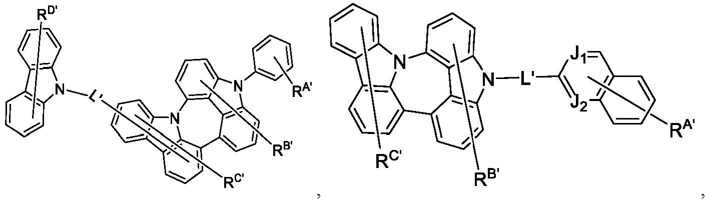 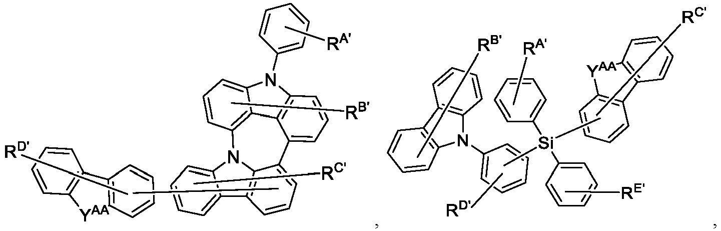 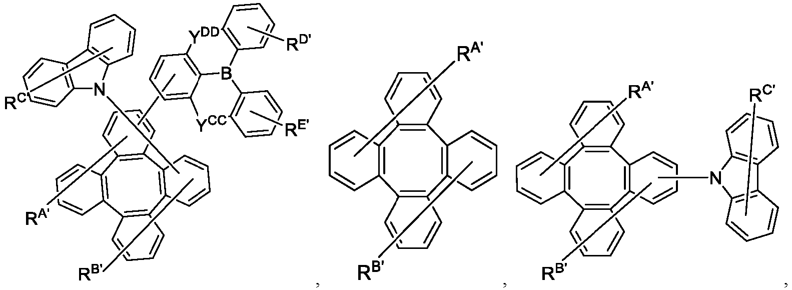 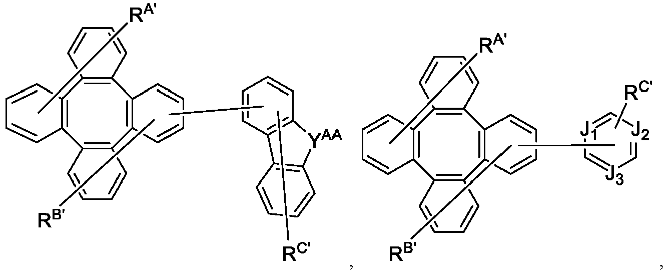 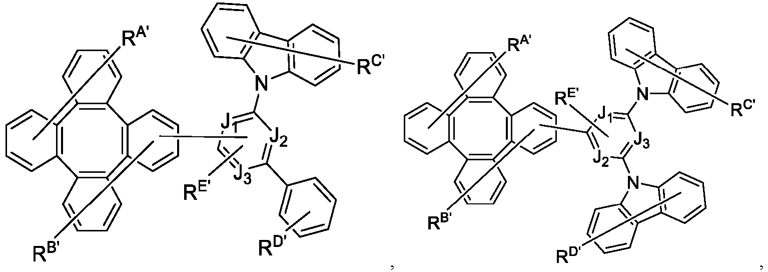 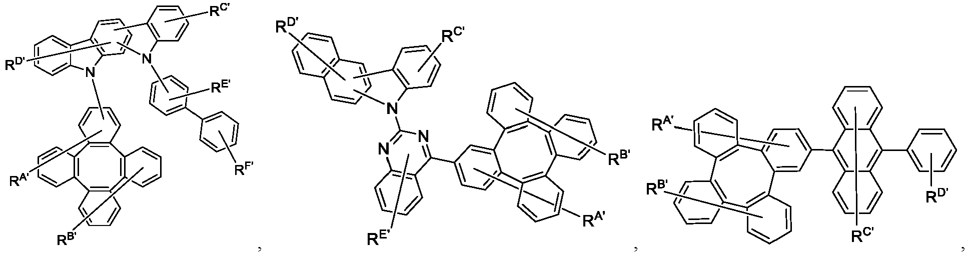 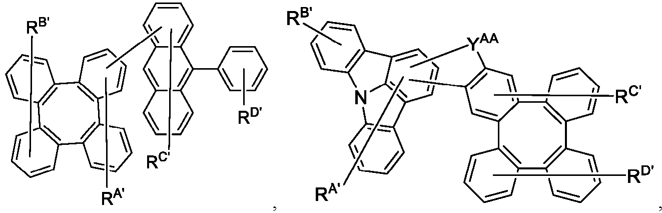 and 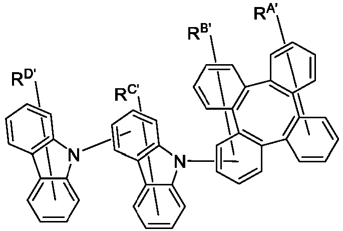 wherein:
each of J₁ to J₆ is independently C or N;
L' is a direct bond or an organic linker;
each Y^{AA}, Y^{BB}, Y^{CC}, and Y^{DD} is independently selected from the group consisting of absent a bond, direct bond, O, S, Se, CRR', SiRR', GeRR', NR, BR, BRR';
each of R^{A'}, R^{B'}, R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen or a substituent selected from the group consisting of the General Substituents as defined herein; any two substituents can be joined or fused to form a ring;
and where possible, each unsubstituted aromatic carbon atom is optionally replaced with one or more N to form an aza-substituted ring.

In some embodiments at least one of J₁ to J₃ is N. In some embodiments at least two of J₁ to J₃ are N. In some embodiments, all three of J₁ to J₃ are N. In some embodiments, each Y^{CC} and Y^{DD} is independently O, S, or SiRR', or more preferably O or S. In some embodiments, at least one unsubstituted aromatic carbon atom is replaced with N to form an aza-ring.

In some embodiments, L' is an organic linker selected from the group consisting of BR, BRR', NR, PR, P(O)R, O, S, Se, C=O, C=S, C=Se, C=NR, C=CRR', S=O, SO₂, CR, CRR', SiRR', GeRR', alkylene, cycloalkyl, aryl, cycloalkylene, arylene, heteroarylene, and combinations thereof.]

In some embodiments, the host is selected from the group consisting of EGI-MGI-EGI to EG53-MG27-EG53 with a formula of EG*a*-MG*b*-EG*c*, or EG*1*-EG*1* to EG*53*-EG*53* with a formula of EG*a*-EG*c* when MG*b* is absent, wherein *a* is an integer from 1 to 53, *b* is an integer from 1 to 27, *c* is an integer from 1 to 53. The structure of EG1 to EG53 is shown below: 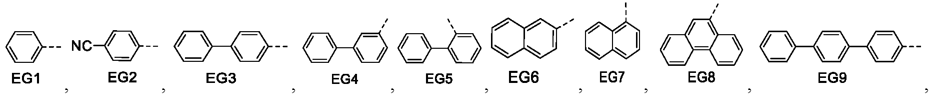 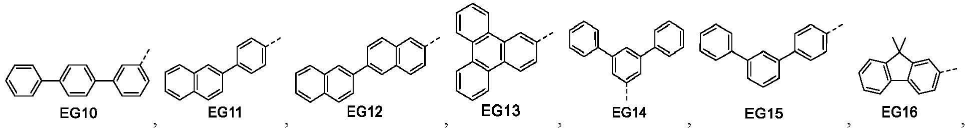 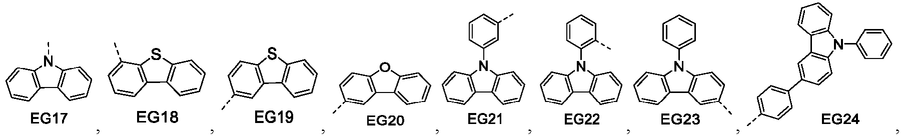 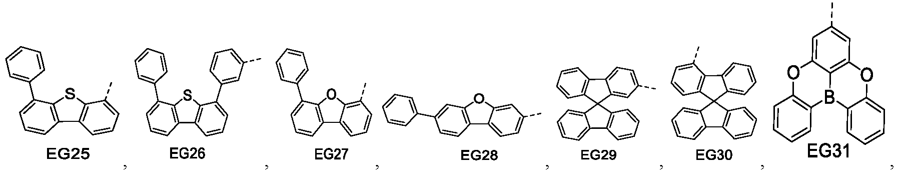 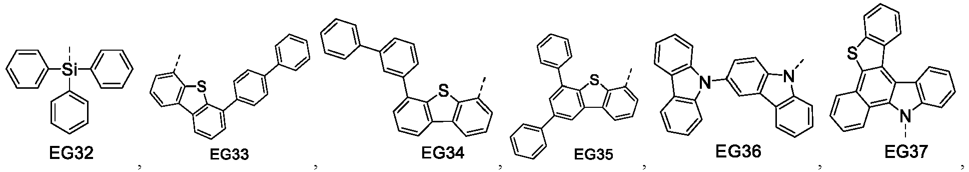 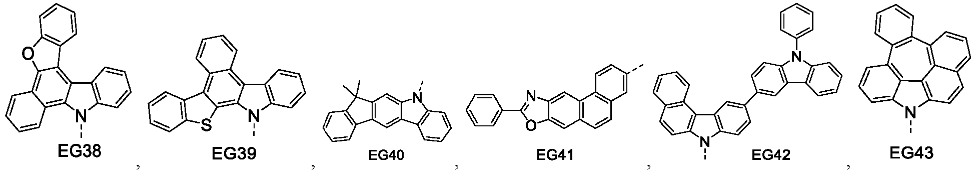 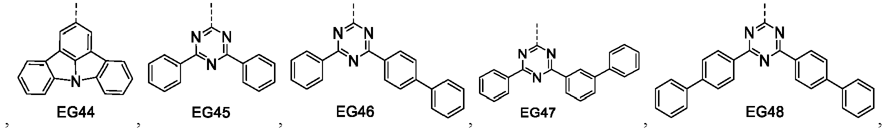 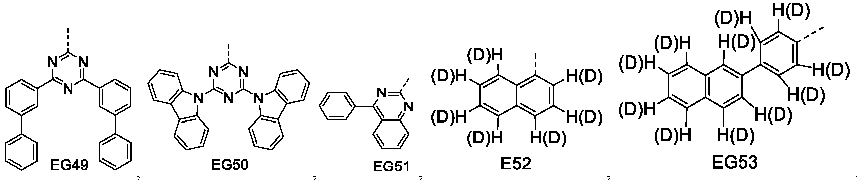 The structures of MG1 to MG27 are shown below: 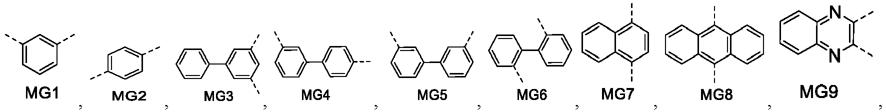 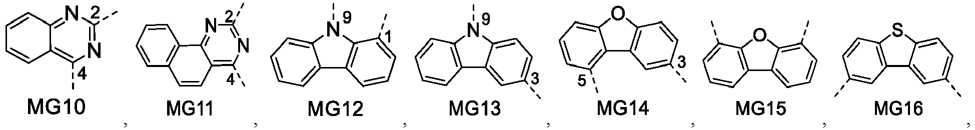 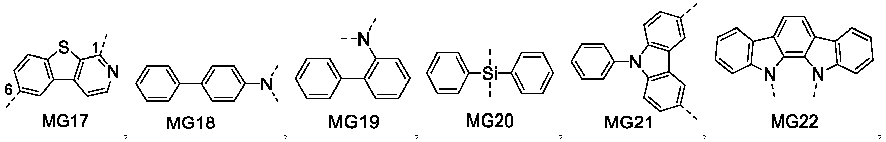 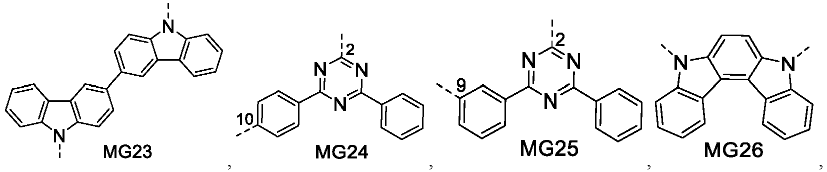 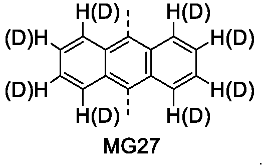 In the MG*b* structures shown above, the two bonding positions in the asymmetric structures MG10, MG11, MG12, MG13, MG14, MG17, MG24, and MG25 are labeled with numbers for identification purposes.

In some embodiments, the host can be any of the aza-substituted variants thereof, fully or partially deuterated variants thereof, and combinations thereof. In some embodiments, the host has formula EG*a*-MG*b*-Eg*c* and is selected from the group consisting of *h1* to *h112* defined in the following HOST Group 2 list, where each of MG*b*, EG*a*, and EG*c* are defined as follows:

| ***h*** | **MG*b*** | **EG*a*** | **EG*c*** | ***h*** | **MG*b*** | **EG*a*** | **EG*c*** | ***h*** | **MG*b*** | **EG*a*** | **EG*c*** |
|---|---|---|---|---|---|---|---|---|---|---|---|
| ***h1*** | MG1 | EG3 | EG36 | ***h39*** | MG13 | *3*-EG17 | *9*-EG4 | ***h77*** | MG23 | EG3 | EG4 |
| ***h2*** | MG1 | EG8 | EG12 | ***h40*** | MG13 | *3*-EG17 | *9*-EG13 | ***h78*** | MG23 | EG3 | EG5 |
| ***h3*** | MG1 | EG13 | EG14 | ***h41*** | MG13 | *3*-EG17 | *9*-EG31 | ***h79*** | MG23 | EG4 | EG4 |
| ***h4*** | MG1 | EG13 | EG18 | ***h42*** | MG13 | *3*-EG17 | *9*-EG45 | ***h80*** | MG23 | EG4 | EG5 |
| ***h5*** | MG1 | EG13 | EG25 | ***h43*** | MG13 | *3*-EG17 | *9*-EG46 | ***h81*** | MG24 | 2-EG1 | *10*-EG33 |
| ***h6*** | MG1 | EG13 | EG36 | ***h44*** | MG13 | *3*-EG17 | *9*-EG48 | ***h82*** | MG24 | *2*-EG4 | *10*-EG36 |
| ***h7*** | MG1 | EG22 | EG36 | ***h45*** | MG13 | *3*-EG17 | *9*-EG49 | ***h83*** | MG24 | *2*-EG21 | *10*-EG36 |
| ***h8*** | MG1 | EG25 | EG46 | ***h46*** | MG13 | *3*-EG32 | *9*-EG31 | ***h84*** | MG24 | *2*-EG23 | *10*-EG36 |
| ***h9*** | MG1 | EG27 | EG46 | ***h47*** | MG13 | *3*-EG44 | *9*-EG3 | ***h85*** | MG25 | *2*-EG1 | *9*-EG33 |
| ***h10*** | MG1 | EG27 | EG48 | ***h48*** | MG14 | *3*-EG13 | *5*-EG45 | ***h86*** | MG25 | *2*-EG3 | *9*-EG36 |
| ***h11*** | MG1 | EG32 | EG50 | ***h49*** | MG14 | *3*-EG23 | *5*-EG45 | ***h87*** | MG25 | *2*-EG4 | *9*-EG36 |
| ***h12*** | MG1 | EG35 | EG46 | ***h50*** | MG15 | EG3 | EG48 | ***h88*** | MG25 | *2*-EG17 | *9*-EG27 |
| ***h13*** | MG1 | EG36 | EG45 | ***h51*** | MG15 | EG17 | EG31 | ***h89*** | MG25 | *2*-EG17 | *9*-EG36 |
| ***h14*** | MG1 | EG36 | EG49 | ***h52*** | MG15 | EG31 | EG36 | ***h90*** | MG25 | *2*-EG21 | *9*-EG36 |
| ***h15*** | MG1 | EG40 | EG45 | ***h53*** | MG16 | EG17 | EG17 | ***h91*** | MG25 | *2*-EG23 | *9*-EG27 |
| ***h16*** | MG2 | EG3 | EG36 | ***h54*** | MG17 | EG17 | EG17 | ***h92*** | MG25 | *2*-EG23 | *9*-EG36 |
| ***h17*** | MG2 | EG25 | EG31 | ***h55*** | MG18 | EG16 | EG24 | ***h93*** | MG26 | EG1 | EG9 |
| ***h18*** | MG2 | EG31 | EG33 | ***h56*** | MG18 | EG16 | EG30 | ***h94*** | MG26 | EG1 | EG10 |
| ***h19*** | MG2 | EG36 | EG45 | ***h57*** | MG18 | EG20 | EG41 | ***h95*** | MG26 | EG1 | EG21 |
| ***h20*** | MG2 | EG36 | EG46 | ***h58*** | MG19 | EG16 | EG29 | ***h96*** | MG26 | EG1 | EG23 |
| ***h21*** | MG3 | EG4 | EG36 | ***h59*** | MG20 | EG1 | EG31 | ***h97*** | MG26 | EG1 | EG26 |
| ***h22*** | MG3 | EG34 | EG45 | ***h60*** | MG20 | EG17 | EG18 | ***h98*** | MG26 | EG3 | EG3 |
| ***h23*** | MG4 | EG13 | EG17 | ***h61*** | MG21 | EG23 | EG23 | ***h99*** | MG26 | EG3 | EG9 |
| ***h24*** | MG5 | EG13 | EG45 | ***h62*** | MG22 | EG1 | EG45 | ***h100*** | MG26 | EG3 | EG23 |
| ***h25*** | MG5 | EG17 | EG36 | ***h63*** | MG22 | EG1 | EG46 | ***h101*** | MG26 | EG3 | EG26 |
| ***h26*** | MG5 | EG18 | EG36 | ***h64*** | MG22 | EG3 | EG46 | ***h102*** | MG26 | EG4 | EG10 |
| ***h27*** | MG6 | EG17 | EG17 | ***h65*** | MG22 | EG4 | EG46 | ***h103*** | MG26 | EG5 | EG10 |
| ***h28*** | MG7 | EG43 | EG45 | ***h66*** | MG22 | EG4 | EG47 | ***h104*** | MG26 | EG6 | EG10 |
| ***h29*** | MG8 | EG1 | EG28 | ***h67*** | MG22 | EG9 | EG45 | ***h105*** | MG26 | EG10 | EG10 |
| ***h30*** | MG8 | EG6 | EG7 | ***h68*** | MG23 | EG1 | EG3 | ***h106*** | MG26 | EG10 | EG14 |
| ***h31*** | MG8 | EG7 | EG7 | ***h69*** | MG23 | EG1 | EG6 | ***h107*** | MG26 | EG10 | EG1 5 |
| ***h32*** | MG8 | EG7 | EG11 | ***h70*** | MG23 | EG1 | EG14 | ***h108*** | MG27 | EG52 | EG53 |
| ***h33*** | MG9 | EG1 | EG43 | ***h71*** | MG23 | EG1 | EG18 | ***h109*** | - | EG13 | EG18 |
| ***h34*** | MG10 | 4-EG1 | 2-EG37 | ***h72*** | MG23 | EG1 | EG19 | ***h110*** | - | EG17 | EG31 |
| ***h35*** | MG10 | *4*-EG1 | 2-EG38 | ***h73*** | MG23 | EG1 | EG23 | ***h111*** | - | EG17 | EG50 |
| ***h36*** | MG10 | EG1 | EG42 | ***h74*** | MG23 | EG1 | EG51 | ***h112*** | - | EG40 | EG45 |
| ***h37*** | MG11 | 4-EG1 | 2-EG39 | ***h75*** | MG23 | EG2 | EG18 | | | | |
| ***h38*** | MG12 | 1-EG17 | 9-EG31 | ***h76*** | MG23 | EG3 | EG3 | | | | |

In the table above, the EG*a* and EG*c* structures that are bonded to one of the asymmetric structures MG10, MG11, MG12, MG13, MG14, MG17, MG24, and MG25, are noted with a numeric prefix identifying their bonding position in the MGb structure.

In some embodiments, the organic layer may further comprise a host, wherein the host comprises a metal complex.

In some embodiments, the emissive layer can comprise two hosts, a first host and a second host. In some embodiments, the first host is a hole transporting host, and the second host is an electron transporting host. In some embodiments, the first host is a hole transporting host, and the second host is a bipolar host. In some embodiments, the first host is an electron transporting host, and the second host is a bipolar host. In some embodiments, the first host and the second host can form an exciplex. In some embodiments, the emissive layer can comprise a third host. In some embodiments, the third host is selected from the group consisting of an insulating host (wide band gap host), a hole transporting host, and an electron transporting host. In some embodiments, the third host forms an exciplex with one of the first host and the second host, or with both the first host and the second host. In some embodiments, the emissive layer can comprise a fourth host. In some embodiments, the fourth host is selected from the group consisting of an insulating host (wide band gap host), a hole transporting host, and an electron transporting host. In some embodiments, the fourth host forms an exciplex with one of the first host, the second host, and the third host, with two of the first host, the second host, and the third host, or with each of the first host, the second host, and the third host. In some embodiments, the electron transporting host has a LUMO less than -2.4 eV, less than -2.5 eV, less than -2.6 eV, or less than -2.7 eV. In some embodiments, the hole transporting host has a HOMO higher than -5.6 eV, higher than -5.5 eV, higher than -5.4 eV, or higher than -5.35 eV. The HOMO and LUMO values can be determined using solution electrochemistry. Solution cyclic voltammetry and differential pulsed voltammetry can be performed using a CH Instruments model 6201B potentiostat using anhydrous dimethylformamide (DMF) solvent and tetrabutylammonium hexafluorophosphate as the supporting electrolyte. Glassy carbon, platinum wire, and silver wire were used as the working, counter and reference electrodes, respectively. Electrochemical potentials can be referenced to an internal ferrocene-ferroconium redox couple (Fc/Fc+) by measuring the peak potential differences from differential pulsed voltammetry. The corresponding highest occupied molecular orbital (HOMO) and lowest unoccupied molecular orbital (LUMO) energies can be determined by referencing the cationic and anionic redox potentials to ferrocene (4.8 eV vs. vacuum) according to literature ((a) Fink, R.; Heischkel, Y.; Thelakkat, M.; Schmidt, H.-W. Chem. Mater. 1998, 10, 3620-3625. (b) Pommerehne, J.; Vestweber, H.; Guss, W.; Mahrt, R. F.; Bassler, H.; Porsch, M.; Daub, J. Adv. Mater. 1995, 7, 551).

In some embodiments, the compound as described herein may be a sensitizer or a component of a sensitizer; wherein the device may further comprise an acceptor that receives the energy from the sensitizer. In some embodiments, the acceptor is an emitter in the device. In some embodiments, the acceptor may be a fluorescent material. In some embodiments, the compound described herein can be used as a phosphorescent sensitizer in an OLED where one or multiple layers in the OLED contain an acceptor in the form of one or more non-delayed fluorescent and/or delayed fluorescence material. In some embodiments, the compound described herein can be used as one component of an exciplex to be used as a sensitizer. As a phosphorescent sensitizer, the compound must be capable of energy transfer to the acceptor and the acceptor will emit the energy or further transfer energy to a final emitter. The acceptor concentrations can range from 0.001% to 99.9%. The acceptor could be in either the same layer as the phosphorescent sensitizer or in one or more different layers. In some embodiments, the acceptor is a thermally activated delayed fluorescence (TADF) material. In some embodiments, the acceptor is a non-delayed fluorescent material. In some embodiments, the emission can arise from any or all of the sensitizer, acceptor, and final emitter. In some embodiments, the acceptor has an emission at room temperature with a full width at half maximum (FWHM) of equal to or less than 50, 45, 40, 35, 30, 25, 20, 15, 10, or 5 nm. Narrower FWHM means better color purity for the OLED display application.

As used herein, phosphorescence generally refers to emission of a photon with a change in electron spin quantum number, i.e., the initial and final states of the emission have different electron spin quantum numbers, such as from T1 to S0 state. Most of the Ir and Pt complexes currently used in OLED are phosphorescent emitters. In some embodiments, if an exciplex formation involves a triplet emitter, such exciplex can also emit phosphorescent light. On the other hand, fluorescent emitters generally refer to emission of a photon without a change in electron spin quantum number, such as from S1 to S0 state, or from D1 to D0 state. Fluorescent emitters can be delayed fluorescent or non-delayed fluorescent emitters. Depending on the spin state, fluorescent emitter can be a singlet emitter or a doublet emitter, or other multiplet emitter. It is believed that the internal quantum efficiency (IQE) of fluorescent OLEDs can exceed the 25% spin statistics limit through delayed fluorescence. There are two types of delayed fluorescence, i.e. P-type and E-type delayed fluorescence. P-type delayed fluorescence is generated from triplet-triplet annihilation (TTA). On the other hand, E-type delayed fluorescence does not rely on the collision of two triplets, but rather on the thermal population between the triplet states and the singlet excited states. Thermal energy can activate the transition from the triplet state back to the singlet state. This type of delayed fluorescence is also known as TADF. E-type delayed fluorescence characteristics can be found in an exciplex system or in a single compound. Without being bound by theory, it is believed that TADF emissions require a compound or an exciplex having a small singlet-triplet energy gap (ΔE_{S-T}) less than or equal to 400, 350, 300, 250, 200, 150, 100, or 50 meV. There are two major types of TADF emitters, one is called donor-acceptor type TADF, the other one is called multiple resonance (MR) TADF. Often, single compound donor-acceptor TADF compounds are constructed by connecting an electron donor moiety such as amino- or carbazole-derivatives and an electron acceptor moiety such as N-containing six-membered aromatic rings or cyano-substituted aromatic rings. Donor-acceptor exciplexes can be formed between a hole transporting compound and an electron transporting compound. Examples of MR-TADF materials include highly conjugated fused ring systems. In some embodiments, MR-TADF materials comprise boron, carbon, and nitrogen atoms. Such materials may comprise other atoms, such as oxygen, as well. In some embodiments, the reverse intersystem crossing time from T1 to S1 of the delayed fluorescent emission at 293K is less than or equal to 10 microseconds. In some embodiments, such time can be greater than 10 microseconds and less than 100 microseconds.

In some embodiments, the OLED may comprise an additional compound selected from the group consisting of a non-delayed fluorescence material, a delayed fluorescence material, a phosphorescent material, and combination thereof.

In some embodiments, the inventive compound described herein is a phosphorescent material.

In some embodiments, the phosphorescent material is an emitter which emits light within the OLED. In some embodiments, the phosphorescent material does not emit light within the OLED. In some embodiments, the phosphorescent material energy transfers its excited state to another material within the OLED. In some embodiments, the phosphorescent material participates in charge transport within the OLED. In some embodiments, the phosphorescent material is a sensitizer or a component of a sensitizer, and the OLED further comprises an acceptor. In some embodiments, the phosphorescent material forms an exciplex with another material within the OLED, for example a host material, an emitter material.

In some embodiments, the non-delayed fluorescence material or the delayed fluorescence material is an emitter which emits light within the OLED. In some embodiments, the non-delayed fluorescence material or the delayed fluorescence material does not emit light within the OLED. In some embodiments, the non-delayed fluorescence material or the delayed fluorescence material energy transfers its excited state to another material within the OLED. In some embodiments, the non-delayed fluorescence material or the delayed fluorescence material participates in charge transport within the OLED. In some embodiments, the non-delayed fluorescence material or the delayed fluorescence material is an acceptor, and the OLED further comprises a sensitizer.

In some embodiments of the OLED, the delayed fluorescence material comprises at least one donor group and at least one acceptor group. In some embodiments, the delayed fluorescence material is a metal complex. In some embodiments, the delayed fluorescence material is a non-metal complex. In some embodiments, the delayed fluorescence material is a Pt, Pd, Zn, Cu, Ag, or Au complex (some of them are also called metal-assisted (MA) TADF). In some embodiments, the metal-assisted delayed fluorescence material comprises a metal-carbene bond. In some embodiments, the non-delayed fluorescence material or delayed fluorescence material comprises at least one chemical group selected from the group consisting of aryl-amine, aryloxy, arylthio, triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, 5λ²,9λ²-diaza-13b-boranaphtho[2,3,4-de]anthracene, 5-oxa-9λ²-aza-13b-boranaphtho[3,2,1-de]anthracene, azaborinine, oxaborinine, dihydroacridine, xanthene, dihydrobenzoazasiline, dibenzooxasiline, phenoxazine, phenoxathiine, phenothiazine, dihydrophenazine, fluorene, naphthalene, anthracene, phenanthrene, phenanthroline, benzoquinoline, quinoline, isoquinoline, quinazoline, pyrimidine, pyrazine, pyridine, triazine, boryl, amino, silyl, aza-variants thereof, and combinations thereof. In some embodiments, non-delayed the fluorescence material or delayed fluorescence material comprises a tri(aryl/heteroaryl)borane with one or more pairs of the substituents from the aryl/heteroaryl being joined to form a ring. In some embodiments, the fluorescence material comprises at least one chemical group selected from the group consisting of naphthalene, anthracene, phenalene, phenanthrene, fluorene, pyrene, chrysene, perylene, and azulene.

In yet another aspect, the OLED of the present disclosure may also comprise an emissive region containing a compound or a formulation of the compound as disclosed in the above compounds section of the present disclosure. In some embodiments, the emissive region can comprise a compound or a formulation comprising a compound having a first ligand L_{A} comprising a structure of Formula I or a compound having a formula Ir(L_{A*})ₓ(L_{B*})_{y}(L_{C*})_{z}. In some embodiments, the emissive region consists of one or more organic layers, wherein at least one of the one or more organic layers has a minimum thickness selected from the group consisting of 350, 400, 450, 500, 550, 600, 650 and 700 Å. In some embodiments, the at least one of the one or more organic layers are formed from an Emissive System that has a figure of merit (FOM) value equal to or larger than the number selected from the group consisting of 2.50, 2.55, 2.60, 2.65, 2.70, 2.75, 2.80, 2.85, 2.90, 2.95, 3.00, 5.00, 10.0, 15.0, and 20.0. The definition of FOM is available in U.S. patent Application Publication No. 2023/0292605, and its entire contents are incorporated herein by reference. In some embodiments, the at least one of the one or more organic layers comprises a compound or a formulation of the compound as disclosed in Sections A and D of the present disclosure.

In some embodiments, the OLED or the emissive region comprising the inventive compound disclosed herein can be incorporated into a full-color pixel arrangement of a device. The full-color pixel arrangement of such a device comprises at least one pixel, wherein the at least one pixel comprises a first subpixel and a second subpixel. The first subpixel includes a first OLED comprising a first emissive region. The second subpixel includes a second OLED comprising a second emissive region. In some embodiments, the first and/or second OLED, the first and/or second emissive region can be the same or different and each can independently have the various device characteristics and the various embodiments of the inventive compounds included therein, and various combinations and subcombinations of the various device characteristics and the various embodiments of the inventive compounds included therein, as disclosed herein.

In some embodiments, the first emissive region is configured to emit a light having a peak wavelength λₘₐₓ₁; the second emissive region is configured to emit a light having a peak wavelength λₘₐₓ₂. In some embodiments, the difference between the peak wavelengths λₘₐₓ₁ and λₘₐₓ₂ is at least 4 nm but within the same color. For example, a light blue and a deep blue light as described above. In some embodiments, a first emissive region is configured to emit a light having a peak wavelength λₘₐₓ₁ in one region of the visible spectrum of 400-500 nm, 500-600 nm, 600-700 nm; and a second emissive region is configured to emit light having a peak wavelength λₘₐₓ₂ in one of the remaining regions of the visible spectrum of 400-500 nm, 500-600 nm, 600-700 nm. In some embodiments, the first emissive region comprises a first number of emissive layers that are deposited one over the other if more than one; and the second emissive region comprises a second number of emissive layers that is deposited one over the other if more than one; and the first number is different from the second number. In some embodiments, both the first emissive region and the second emissive region comprise a phosphorescent material, which may be the same or different. In some embodiments, the first emissive region comprises a phosphorescent material, while the second emissive region comprises a fluorescent material. In some embodiments, both the first emissive region and the second emissive region comprise a fluorescent material, which may be the same or different.

In some embodiments, the at least one pixel of the OLED or emissive regions includes a total of *N* subpixels; wherein the *N* subpixels comprises the first subpixel and the second subpixel; wherein each of the *N* subpixels comprises an emissive region; wherein the total number of the emissive regions within the at least one pixel is equal to or less than *N-1.* In some embodiments, the second emissive region is exactly the same as the first emissive region; and each subpixel of the at least one pixel comprises the same one emissive region as the first emissive region. In some embodiments, the full-color pixel arrangements can have a plurality of pixels comprising a first pixel region and a second pixel region; wherein at least one display characteristic in the first pixel region is different from the corresponding display characteristic of the second pixel region, and wherein the at least one display characteristic is selected from the group consisting of resolution, cavity mode, color, outcoupling, and color filter.

In some embodiments, the OLED is a stacked OLED comprising one or more charge generation layers (CGLs). In some embodiments, the OLED comprises a first electrode, a first emissive region disposed over the first electrode, a first CGL disposed over the first emissive region, a second emissive region disposed over the first CGL, and a second electrode disposed over the second emissive region. In some embodiments, the first and/or the second emissive regions can have the various device characteristics as described above for the pixelated device. In some embodiments, the stacked OLED is configured to emit white color. In some embodiments, one or more of the emissive regions in a pixelated or in a stacked OLED comprises a sensitizer and an acceptor with the various sensitizing device characteristics and the various embodiments of the inventive compounds disclosed herein. For example, the first emissive region is comprised in a sensitizing device, while the second emissive region is not comprised in a sensitizing device; in some instances, both the first and the second emissive regions are comprised in sensitizing devices.

In some embodiments, the OLED can emit light having at least 1%, 5%, 10, 30%, 50%, 70%, 80%, 90%, 95%, 99%, or 100% from the plasmonic mode. In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. In some embodiments, the enhancement layer is provided no more than a threshold distance away from the organic emissive layer, wherein the emitter material has a total non-radiative decay rate constant and a total radiative decay rate constant due to the presence of the enhancement layer. A threshold distance is where the total non-radiative decay rate constant is equal to the total radiative decay rate constant. Another threshold distance is the distance at which the total radiative decay rate constant divided by the sum of the total non-radiative decay rate constant and total radiative decay rate constant is equal to the photoluminescent yield of the emissive material without the enhancement layer present.

In some embodiments, the OLED further comprises an outcoupling layer. In some embodiments, the outcoupling layer is disposed over the enhancement layer on a side opposite the organic emissive layer The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. In some embodiments, one or more intervening layer can be disposed between the enhancement layer and the outcoupling layer. The examples for intervening layer(s) can be dielectric materials, including organic, inorganic, perovskites, oxides, and may include stacks and/or mixtures of these material s.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and a reduced efficiency roll-off of the OLED device. Placement of the enhancement layer on the cathode side, anode side, or on both sides, or the enhancement layer itself being as the CGL, results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

In some embodiments, the enhancement layer can be comprised of plasmonic materials, optically active metamaterials, or hyperbolic metamaterials. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, or Ca, alloys or mixtures of these materials, and stacks of these materials. In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly.

In some embodiments, the outcoupling layer has wavelength-sized or sub-wavelength sized features that are arranged periodically, quasi-periodically, or randomly. In some embodiments, the outcoupling layer may be composed of a plurality of nanoparticles. In some embodiments, the outcoupling layer is composed of a plurality of nanoparticles disposed over a material. In these embodiments the outcoupling layer may be tunable by at least one of: varying a size of the plurality of nanoparticle s, varying a shape of the plurality of nanoparticles, changing a material of the plurality of nanoparticles, adjusting a thickness of the material, changing the refractive index of the material, adding an additional layer disposed on the plurality of nanoparticle s, varying a thickness of the enhancement layer , or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, and Ca, alloys or mixtures of these materials, and stacks of these materials. In some embodiments the outcoupling layer is formed by lithography.

In some embodiments of a plasmonic device, the emitter, and/or host compounds used in the emissive layer has a vertical dipole ratio (VDR) of 0.33 or more. In some such embodiments, the emitter, and/or host compounds have a VDR of 0.40, 0.50, 0.60, 0.70, or more.

In yet another aspect, the present disclosure also provides a consumer product comprising an organic light-emitting device (OLED) having an anode; a cathode; and an organic layer disposed between the anode and the cathode, wherein the organic layer may comprise a compound or a formulation of the compound as disclosed in the above compounds section of the present disclosure.

In some embodiments, the consumer product comprises an OLED having an anode; a cathode; and an organic layer disposed between the anode and the cathode, wherein the organic layer may comprise a compound having a first ligand L_{A} comprising a structure of Formula I or a compound having a formula Ir(L_{A*})ₓ(L_{B*})_{y}(L_{C*})_{z}.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, and an "exciton," which is a localized electron-hole pair having an excited energy state, is formed. Light is emitted when the exciton relaxes via a photoemissive mechanism. In some cases, the exciton may be localized as an excimer or an exciplex. Non-radiative mechanisms, such as thermal relaxation, may also occur, but are generally considered undesirable.

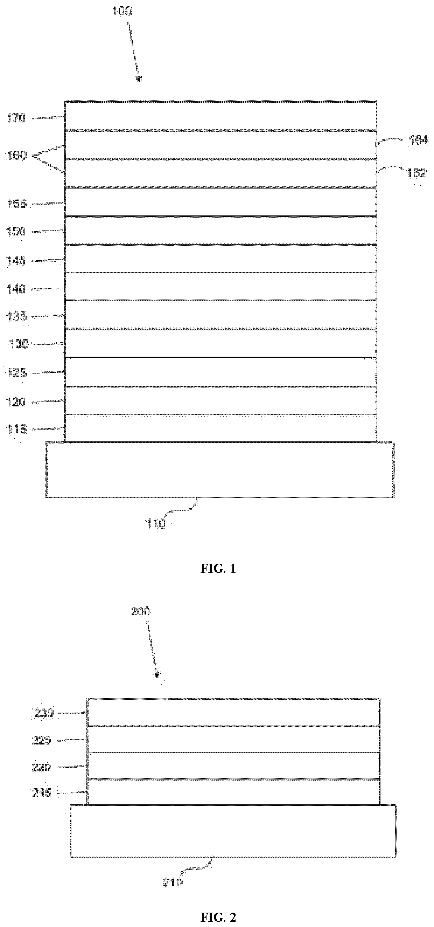

FIG. 1 shows an organic light emitting device 100. The figures are not necessarily drawn to scale. Device 100 may include a substrate 110, an anode 115, a hole injection layer (HIL) 120, a hole transport layer (HTL) 125, an electron blocking layer (EBL) 130, an emissive layer (EML) 135, a hole blocking layer (HBL) 140, an electron transport layer (ETL) 145, an electron injection layer (EIL) 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host material s are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP, also referred to as organic vapor jet deposition (OVJD)), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation, sputtering, chemical vapor deposition, atomic layer deposition, and electron beam deposition. Preferred patterning methods include deposition through a mask, photolithography, and cold welding such as described in U.S. Pat. Nos. 6,294,398 and 6,468,819, which are incorporated by reference in their entireties, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a plurality of alternative layers of polymeric material and non-polymeric material; organic material and inorganic material, or a mixture of a polymeric material and a non-polymeric material as one example described in U.S. Pat. No. 7,968,146, PCT Pat. Application Nos. PCT/US2007/023098 and PCT/US2009/042829, which are herein incorporated by reference in their entireties.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semitransparent. In some embodiments, the OLED further comprises a layer comprising carbon nanotubes. In some embodiments, the OLED further comprises one or more quantum dots. Such quantum dots can be in the emissive layer, or in other functional layers, such as a down conversion layer.

In some embodiments, the OLED comprises a RGB pixel arrangement or white plus color filter pixel arrangement. In some embodiments, the OLED is a mobile device, a handheld device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

### D. Other Materials Used in the OLED

The materials described herein are as various examples useful for a particular layer in an OLED. They may also be used in combination with a wide variety of other materials present in the device. For example, emissive dopants disclosed herein may be used by themselves in the EML, or in conjunction with a wide variety of other emitters, hosts, transport layers, blocking layers, injection layers, electrodes and other layers that may be present. The materials described or referred to below are non-limiting examples of materials that may be useful in combination with the compounds and the devices disclosed herein, and one of skill in the art can readily consult the literature to identify other materials that may be useful in combination.

### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer. In some embodiments, conductivity dopants comprise at least one chemical moiety selected from the group consisting of cyano, fluorinated aryl or heteroaryl, fluorinated alkyl or cycloalkyl, alkylene, heteroaryl, amide, benzodithiophene, and highly conjugated heteroaryl groups extended by non-ring double bonds.

### b) HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

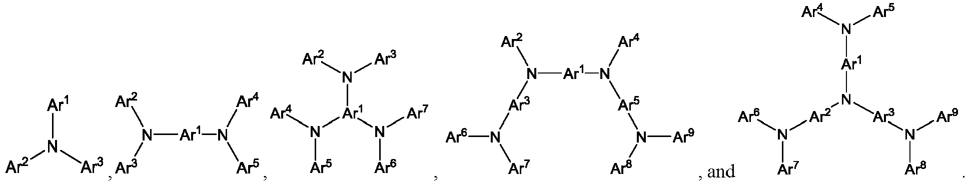

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each of Ar¹ to Ar⁹ may be unsubstituted or may be substituted by a general substituent as described above, any two substituents can be joined or fused into a ring.

In some embodiments, each Ar¹ to Ar⁹ independently comprises a moiety selected from the group consisting of: 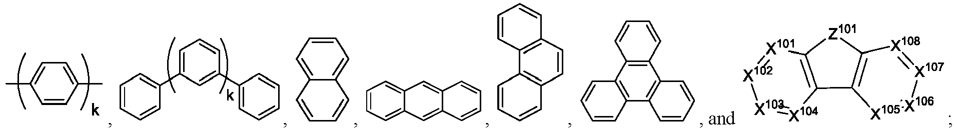 wherein k is an integer from 1 to 20; X¹⁰¹ to X¹⁰⁸ is C or N; Z¹⁰¹ is C, N, O, or S.

Examples of metal complexes used in HIL or HTL include, but are not limited to the following general formula: 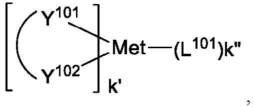 wherein Met is a metal, which can have an atomic weight greater than 40; (Y¹⁰¹-Y¹⁰²) is a bidentate ligand, the coordinating atoms of Y¹⁰¹ and Y¹⁰² are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In some embodiments, (Y¹⁰¹-Y¹⁰²) is a 2-phenylpyridine or 2-phenylimidazole derivative. In some embodiments, (Y¹⁰¹-Y¹⁰²) is a carbene ligand. In some embodiments, Met is selected from Ir, Pt, Pd, Os, Cu, and Zn. In some embodiments, the metal complex has a smallest oxidation potential in solution vs. Fc⁺/Fc couple less than about 0.6 V.

In some embodiments, the HIL/HTL material is selected from the group consisting of phthalocyanine and porphryin compounds, starburst triarylamines, CFₓ fluorohydrocarbon polymer, conducting polymers (e.g., PEDOT:PSS, polyaniline, polypthiophene), phosphonic acid and sliane SAMs, triarylamine or polythiophene polymers with conductivity dopants, Organic compounds with conductive inorganic compounds (such as molybdenum and tungsten oxides), n-type semiconducting organic complexes, metal organometallic complexes, cross-linkable compounds, polythiophene based polymers and copolymers, triarylamines, triaylamine with spirofluorene core, arylamine carbazole compounds, triarylamine with (di)benzothiophene/(di)benzofuran, indolocarbazoles, isoindole compounds, and metal carbene complexes.

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than one or more emitters closest to the EBL interface. In some embodiments, the compound used in EBL contains at least one carbazole group and/or at least one arylamine group. In some embodiments the HOMO level of the compound used in the EBL is shallower than the HOMO level of one or more of the hosts in the EML. In some embodiments, the compound used in EBL contains the same molecule or the same functional groups used as one of the hosts described herein.

### d) Hosts:

The light emitting layer of the organic EL device of the present disclosure preferably contains at least a light emitting material as the dopant, and a host material. Examples of the host material are not particularly limited, and any metal complexes or organic compounds may be used as long as the host won't fully quench the emission of the dopant.

Examples of metal complexes used as host are preferred to have the following general formula: 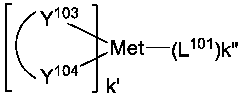 wherein Met is a metal; (Y¹⁰³-Y¹⁰⁴) is a bidentate ligand, the coordinating atoms of Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In some embodiments, the metal complexes are: 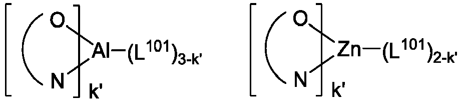 wherein (O-N) is a bidentate ligand, having metal coordinated to atoms O and N.

In some embodiments, Met is selected from Ir and Pt. In a further embodiment, (Y¹⁰³-Y¹⁰⁴) is a carbene ligand.

In some embodiments, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, aza-dibenzothiophene, aza-dibenzofuran, aza-dibenzoselenophene, aza-carbazole, aza-indolocarbazole, aza-triphenylene, aza-tetraphenylene, 5λ²-benzo[d]benzo[4,5]imidazo[3,2-a]imidazole, 5,9-dioxa-13b-boranaphtho[3,2,1-de]anthracene,; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by the general substituents as described herein or may be further fused.

In some embodiments, the host compound comprises at least one of the moieties selected from the group consisting of: 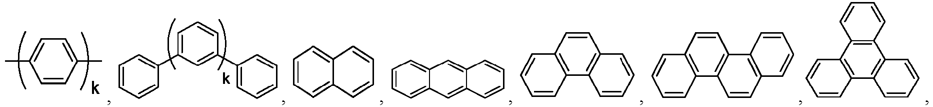 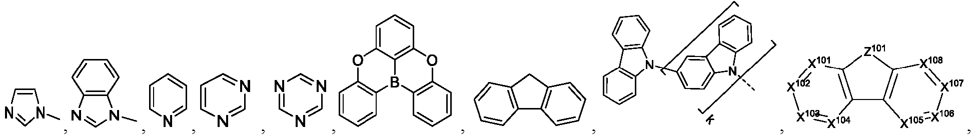 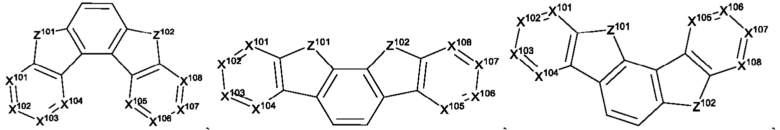 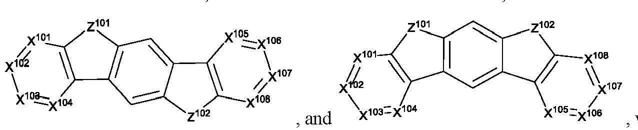 wherein k is an integer from 0 to 20 or 1 to 20. X¹⁰¹ to X¹⁰⁸ are independently selected from C or N. Z¹⁰¹ and Z¹⁰² are independently selected from C, N, O, or S.

In some embodiments, the host material is selected from the group consisting of arylcarbazoles, metal 8-hydroxyquinolates, (e.g., alq3, balq), metal phenoxybenzothiazole compounds, conjugated oligomers and polymers (e.g., polyfluorene), aromatic fused rings, zinc complexes, chrysene based compounds, aryltriphenylene compounds, poly-fused heteroaryl compounds, donor acceptor type molecules, dibenzofuran/dibenzothiophene compounds, polymers (e.g., pvk), spirofluorene compounds, spiro fluorene-carbazole compounds, indolocabazoles, 5-member ring electron deficient heterocycles (e.g., triazole, oxadiazole), tetraphenylene complexes, metal phenoxypyridine compounds, metal coordination complexes (e.g., Zn, Al with N^N ligands), dibenzothiophene/dibenzofuran-carbazole compounds, silicon/germanium aryl compounds, aryl benzoyl esters, carbazole linked by non-conjugated groups, aza-carbazole/dibenzofuran/dibenzothiophene compounds, and high triplet metal organometallic complexes (e.g., metal-carbene complexes).

### e) Emitter Materials in EML:

One or more emitter materials may be used in conjunction with the compound or device of the present disclosure. The emitter material can be emissive or non-emissive in the current device as described herein. Examples of the emitter materials are not particularly limited, and any compounds may be used as long as the compounds are capable of producing emissions in a regular OLED device. Examples of suitable emitter materials include, but are not limited to, compounds which are capable of producing emissions via phosphorescence, non-delayed fluorescence, delayed fluorescence, especially the thermally activated delayed fluorescence, i.e., TADF (also referred to as E-type delayed fluorescence), triplet-triplet annihilation, or combinations of these processes.

In some embodiments, the emitter material has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of the structures of LIGAND LIST: 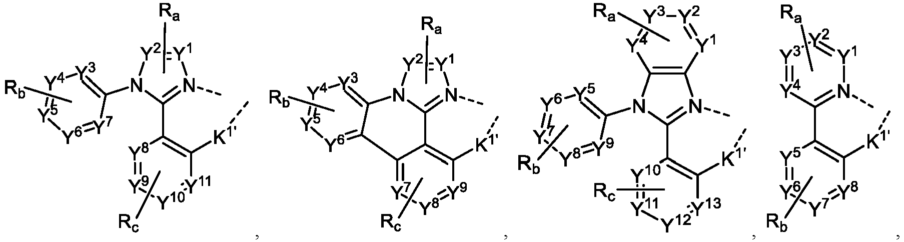 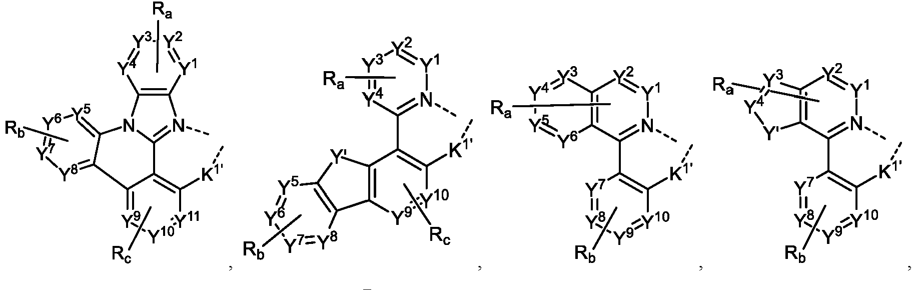 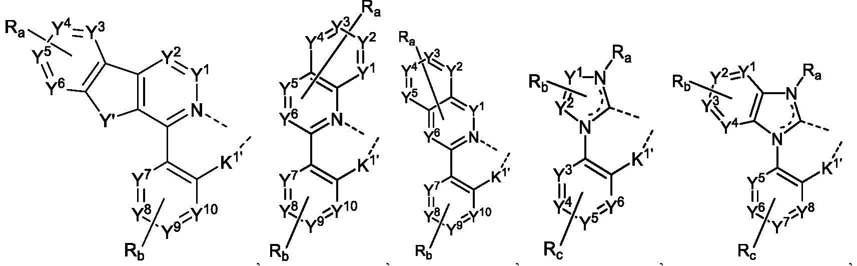 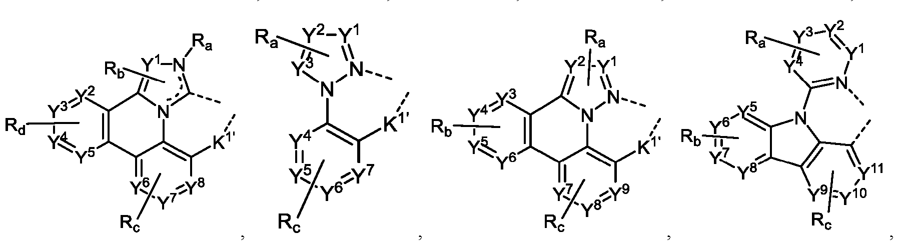 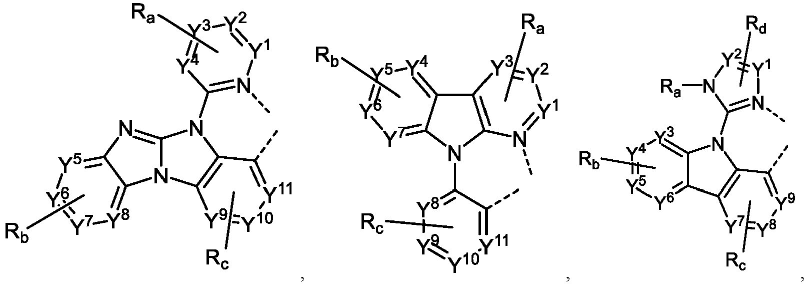 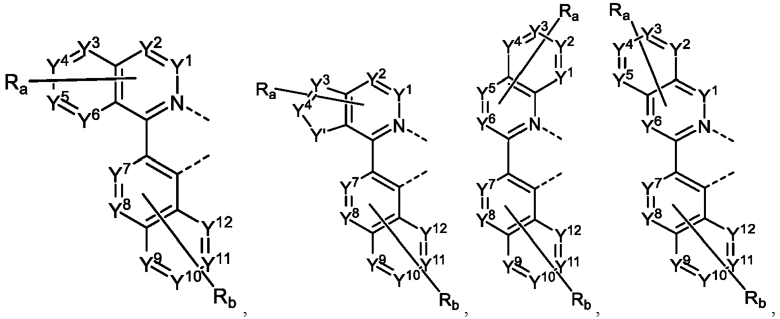 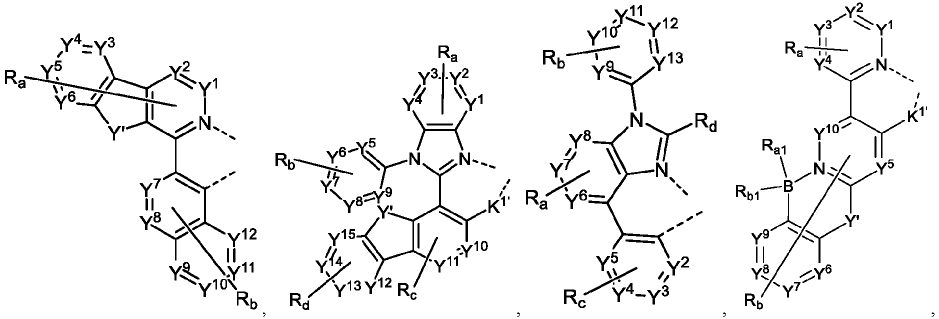 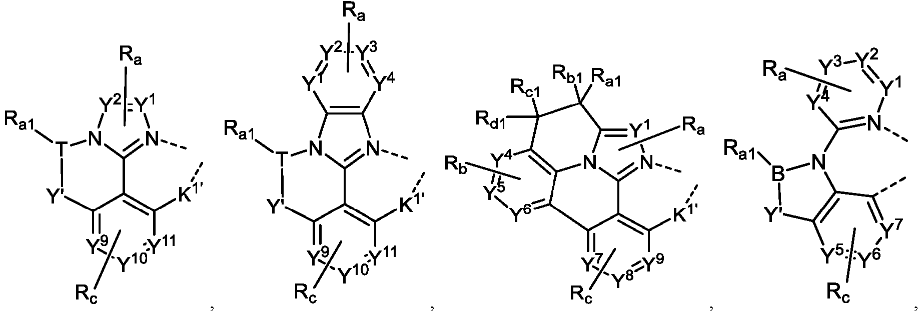 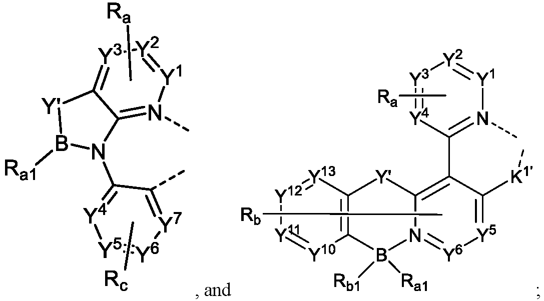 wherein each L² and L³ are independently selected from the group consisting of 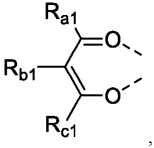 and the structures of LIGAND LIST; wherein:
M is selected from the group consisting of Ir, Rh, Re, Ru, Os, Pt, Pd, Zn, Au, Ag, and Cu;
T is selected from the group consisting of B, Al, Ga, and In;
K^{1'} is a direct bond or is selected from the group consisting of NRₑ, PRₑ, O, S, and Se;
each Y¹ to Y¹⁵ are independently selected from the group consisting of carbon and nitrogen;
Y' is selected from the group consisting of BRₑ, NRₑ, PRₑ, O, S, Se, C=O, S=O, SO₂, CRₑR_{f}, SiRₑR_{f}, and GeRₑR_{f};
each Rₐ, R_{b}, R_{c}, and R_{d} can independently represent from mono to the maximum possible number of substitutions, or no substitution;
each Rₐ₁, R_{b1}, R_{c1}, R_{d1}, Rₐ, R_{b}, R_{c}, R_{d}, Rₑ, and R_{f} is independently a hydrogen or a substituent selected from the group consisting of the general substituents as defined herein; and
wherein any two substituents can be fused or joined to form a ring or form a multidentate ligand.

In some embodiments, the emitter material is selected from the group consisting of the following Dopant Group 1: 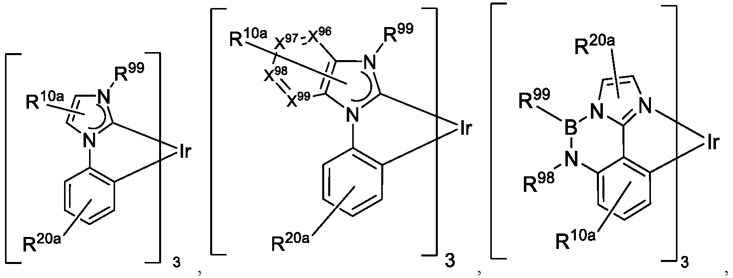 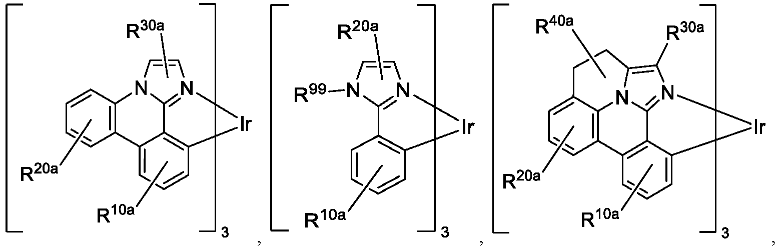 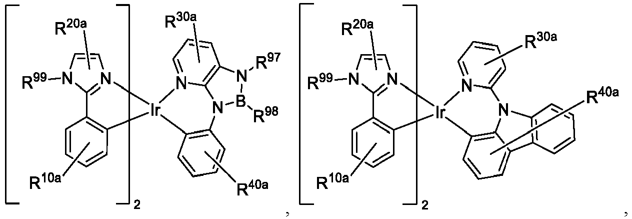 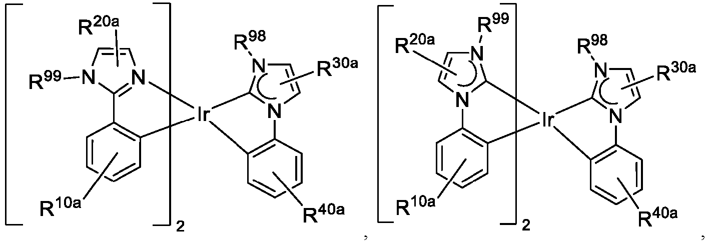 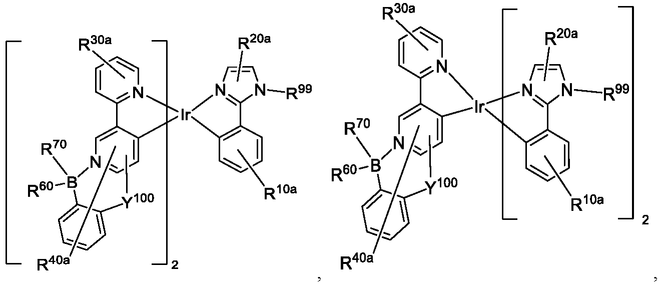 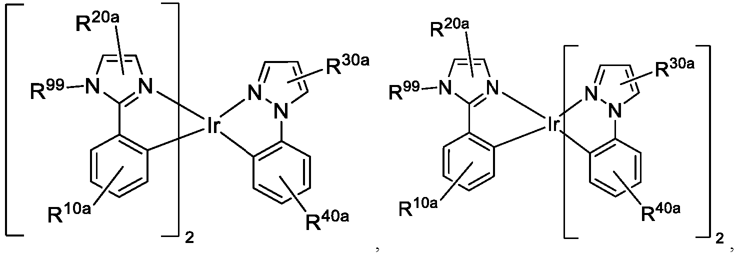 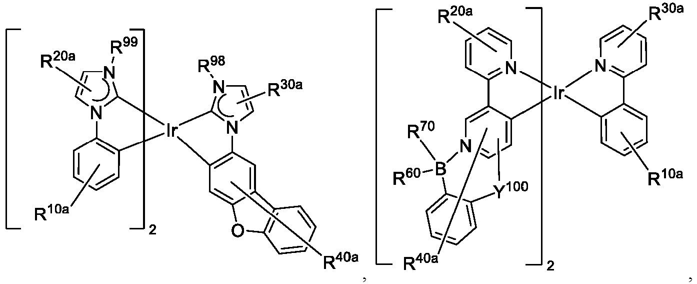 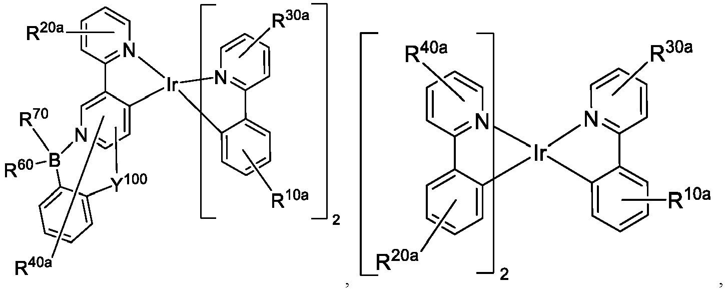 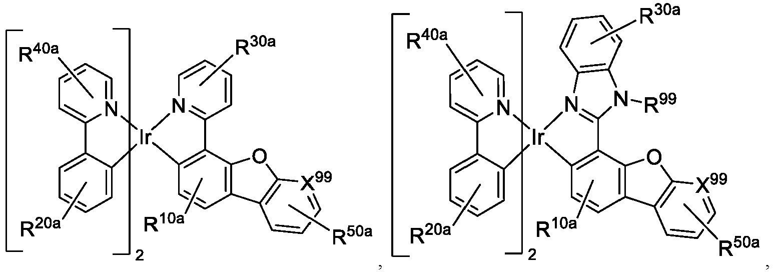 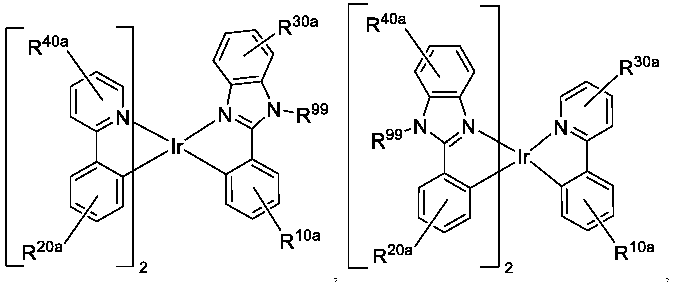 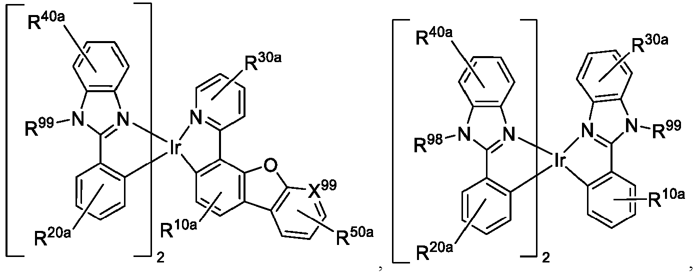 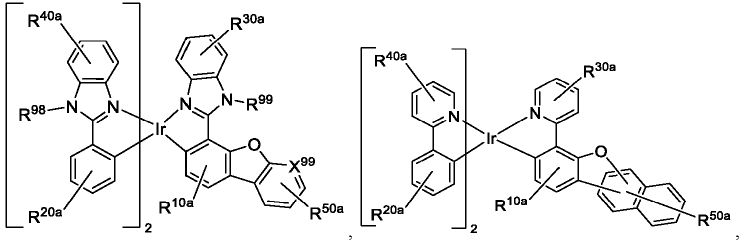 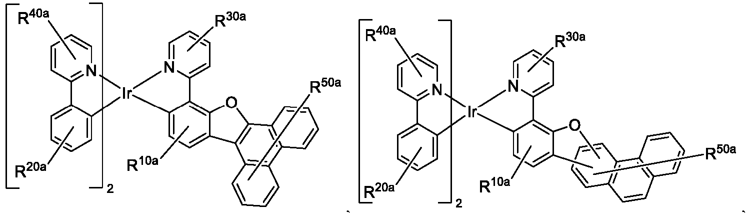 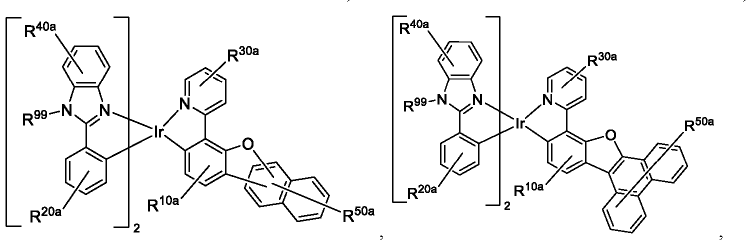 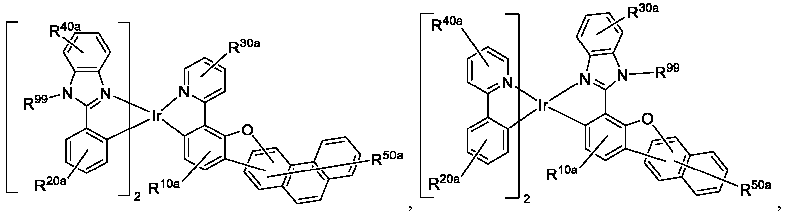 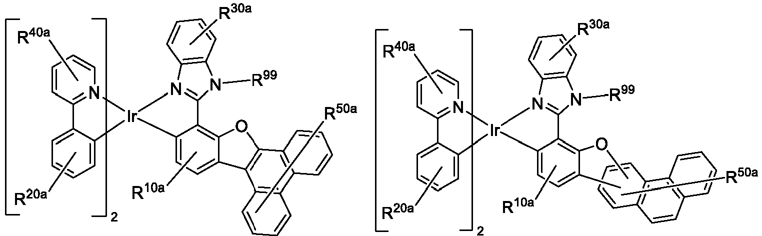 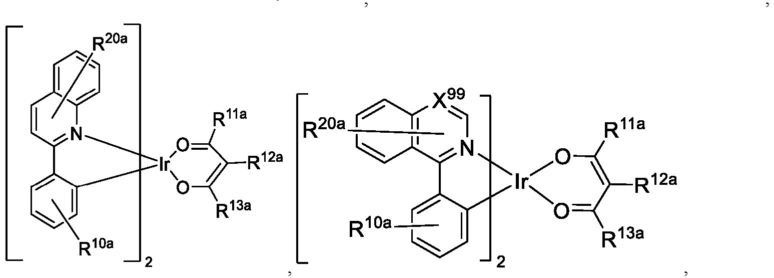 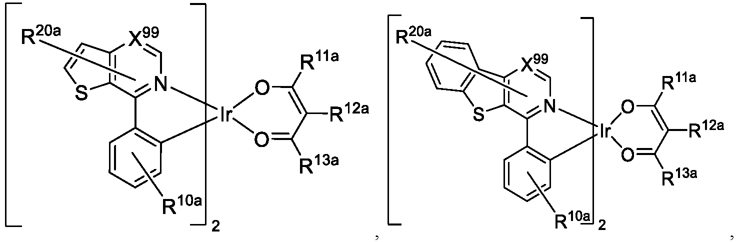 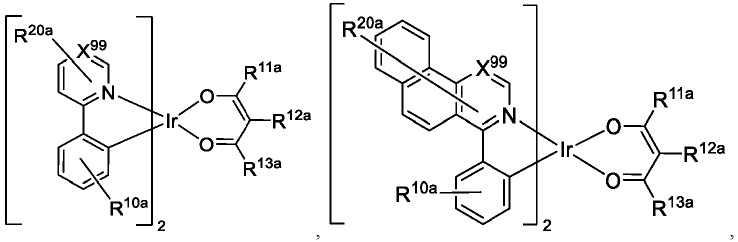 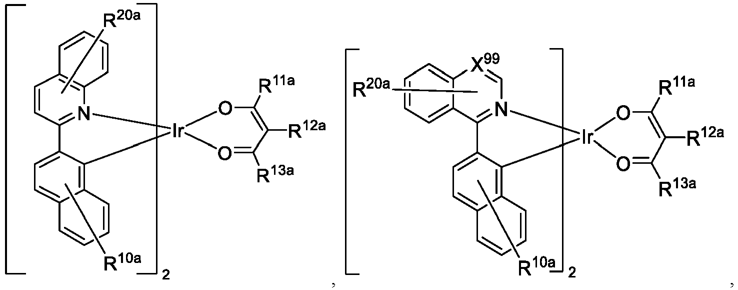 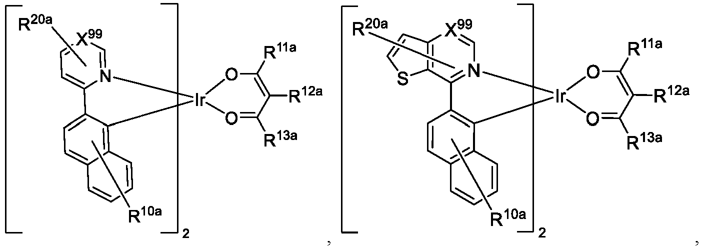 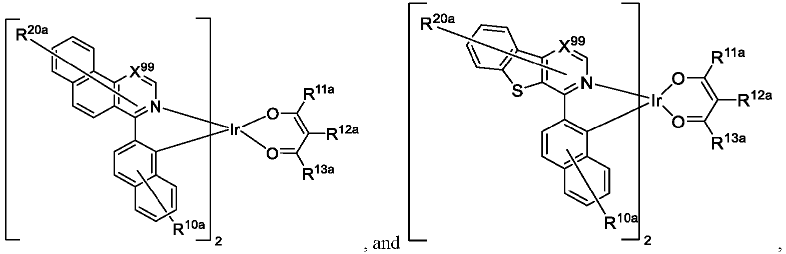 wherein
each of X⁹⁶ to X⁹⁹ is independently C or N;
each Y¹⁰⁰ is independently selected from the group consisting of a NR", O, S, and Se;
each of R^{10a}, R^{20a}, R^{30a}, R^{40a}, and R^{50a} independently represents mono substitution, up to the maximum substitutions, or no substitution;
each of R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ is independently a hydrogen or a substituent selected from the group consisting of the general substituents as defined herein; any two substituents can be joined or fused to form a ring.

In some embodiments, the emitter material is selected from the group consisting of the following Dopant Group 2: 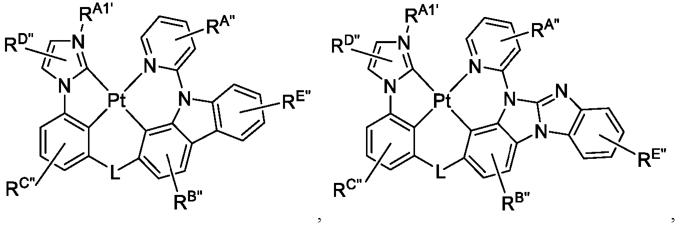 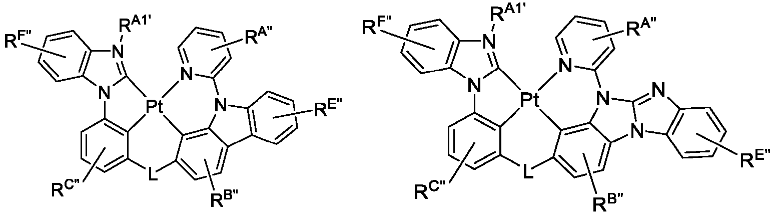 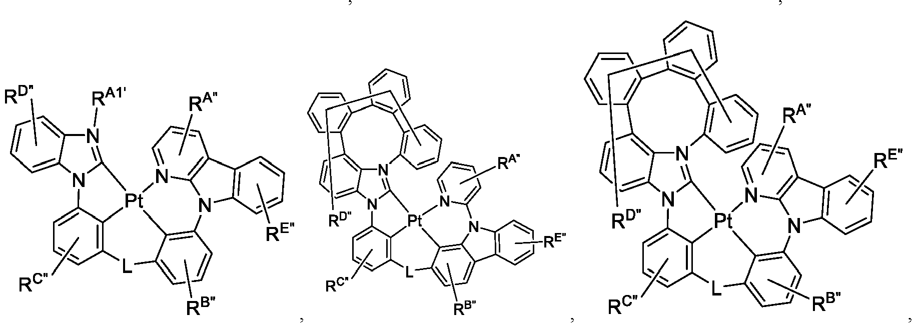 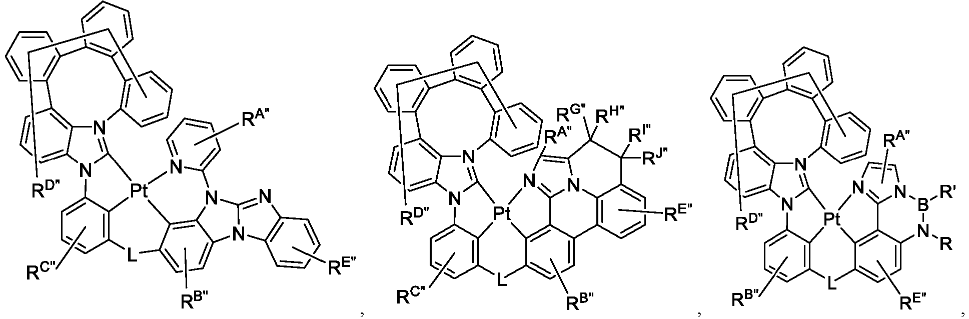 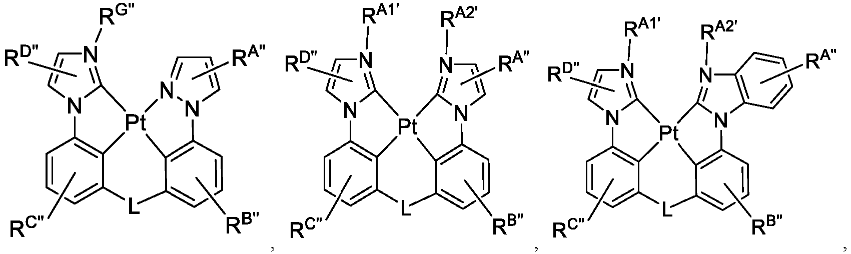 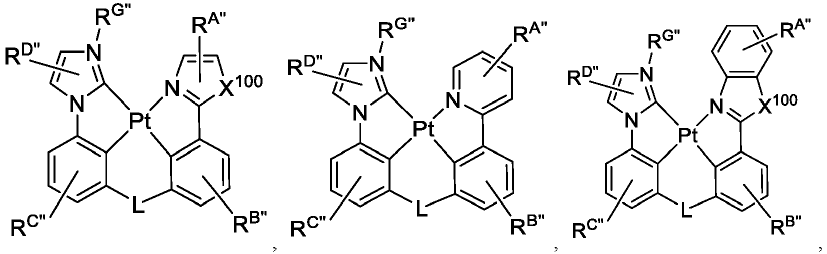 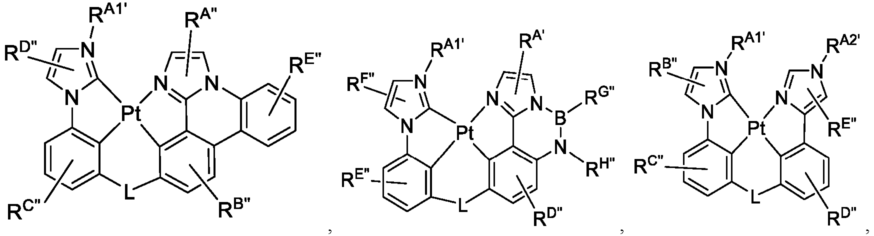 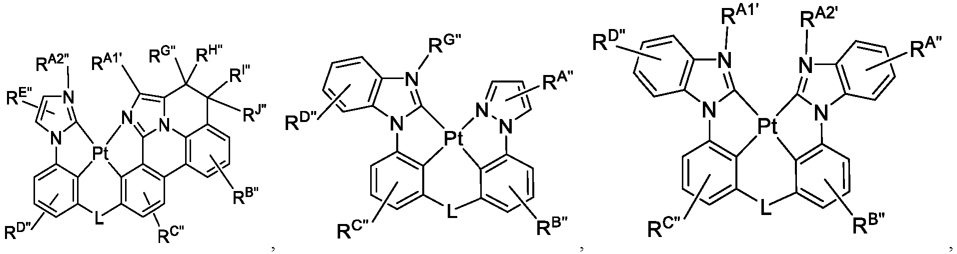 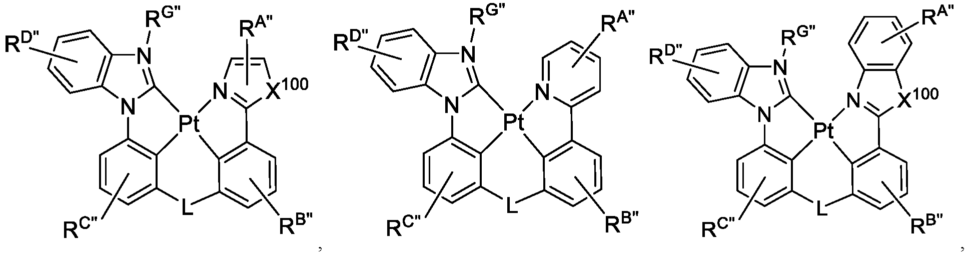 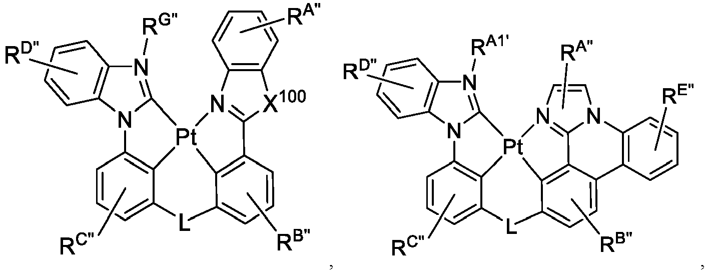 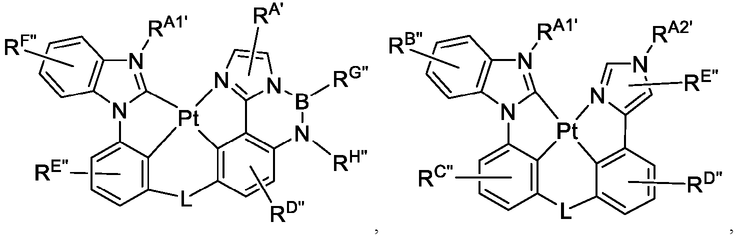 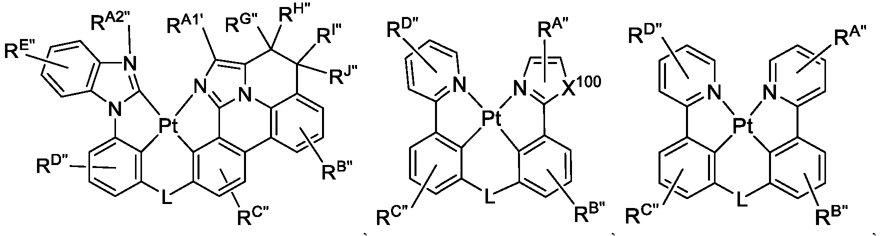 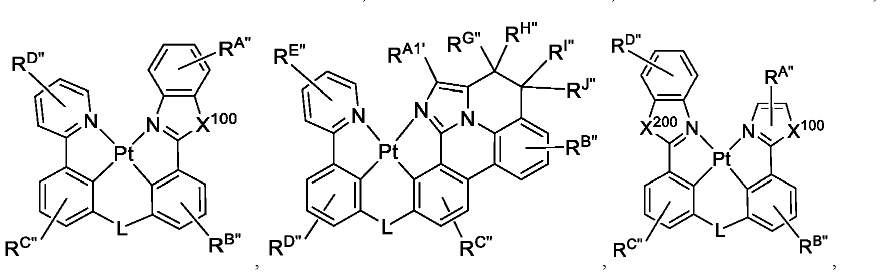 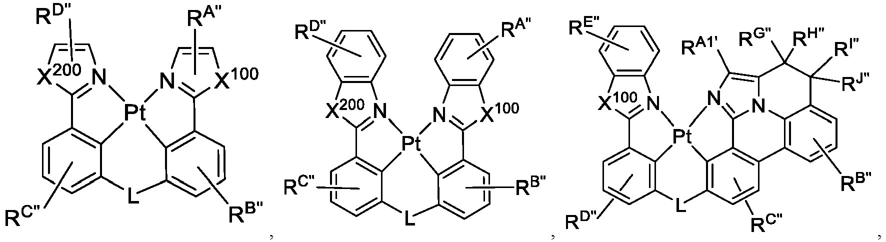 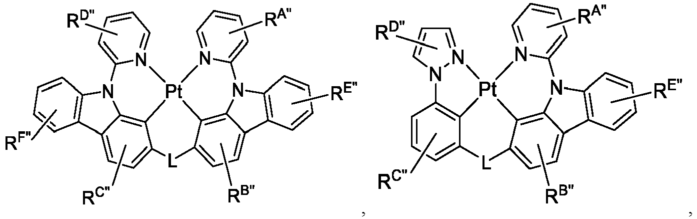 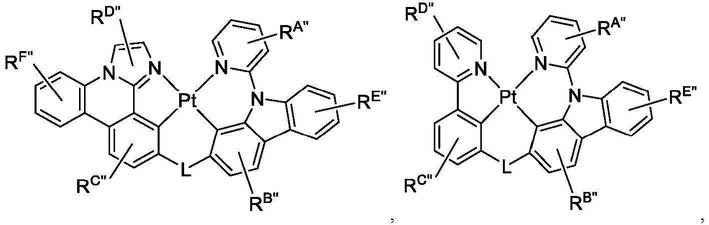 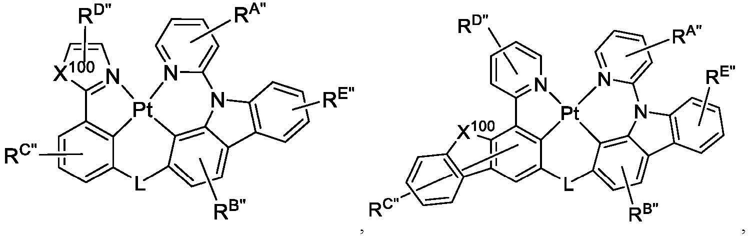 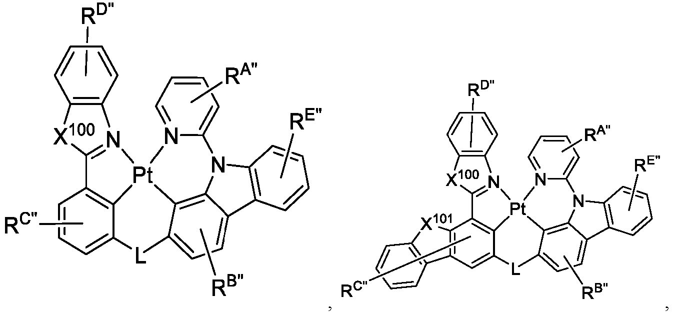 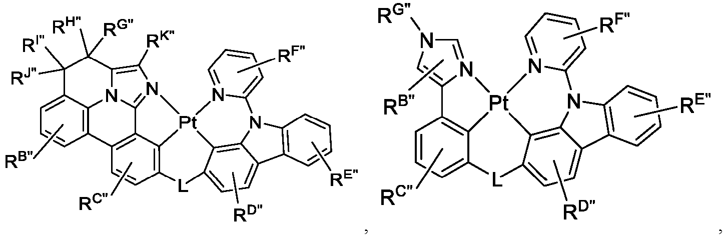 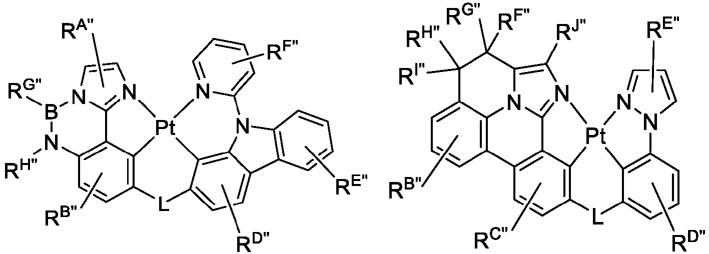 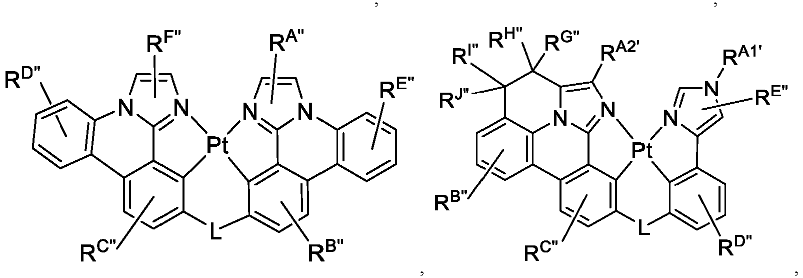 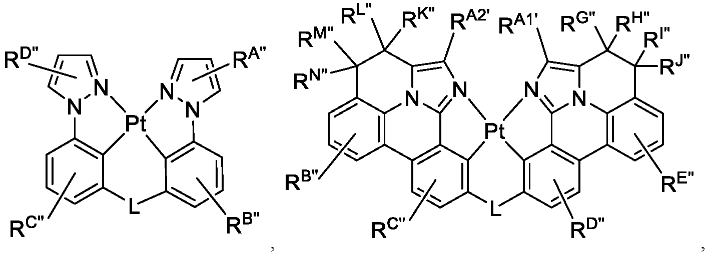 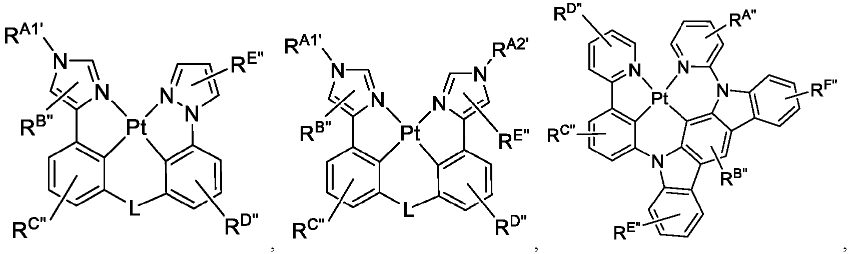 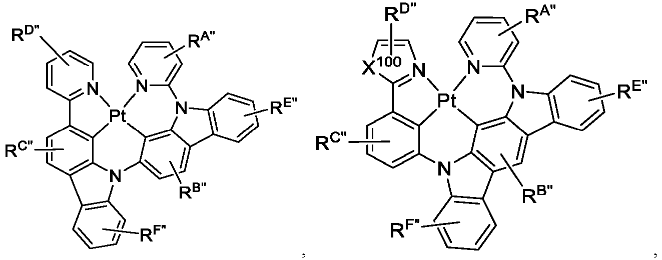 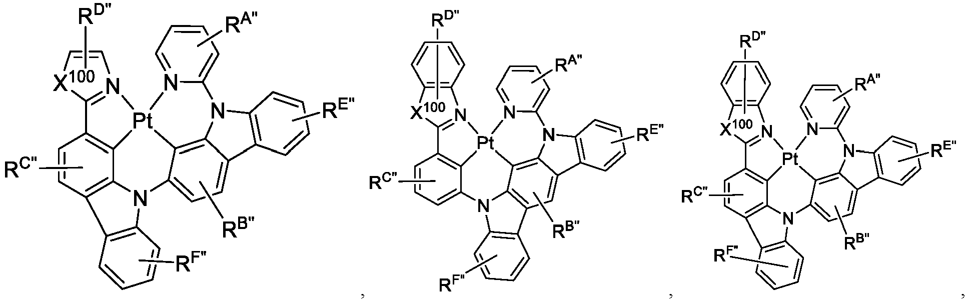 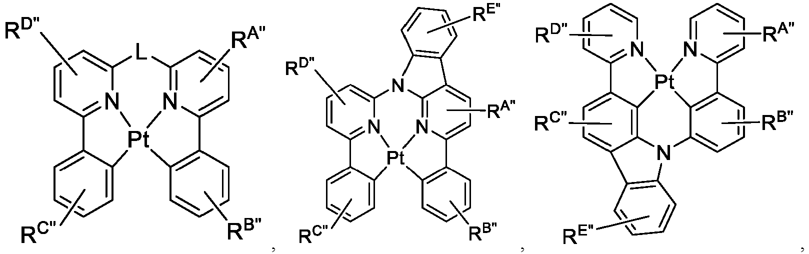 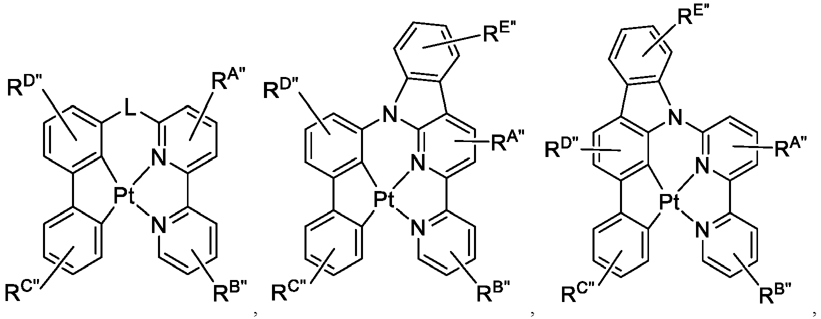 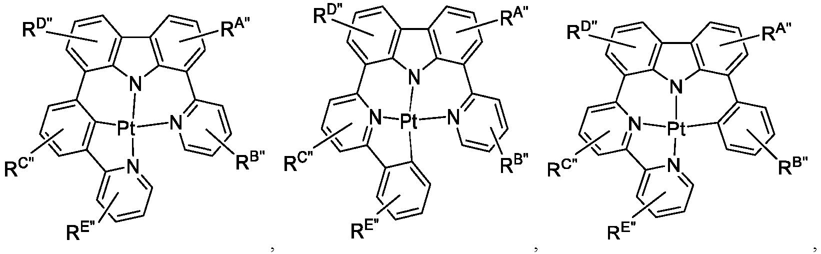 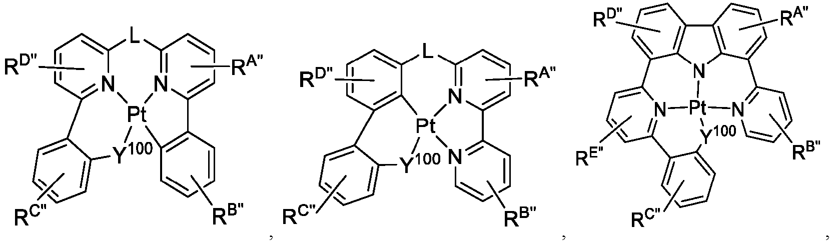 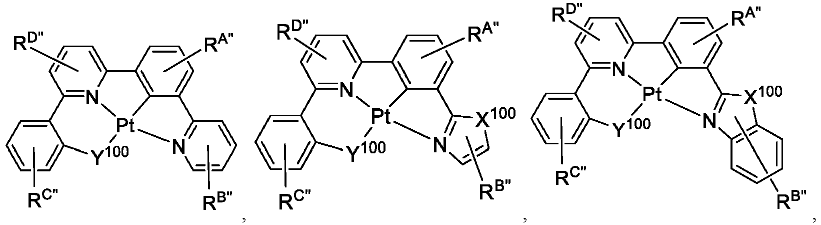 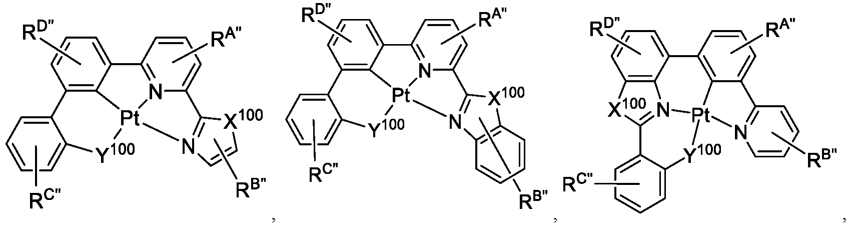 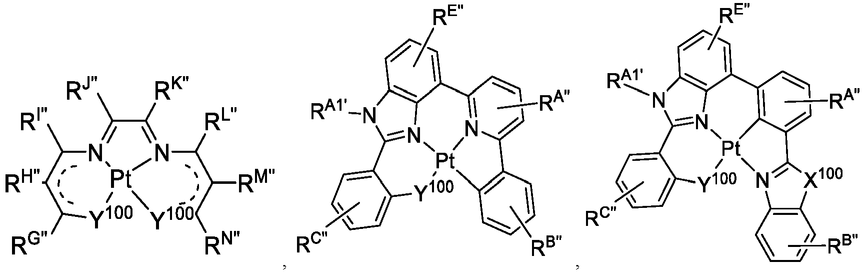 , and 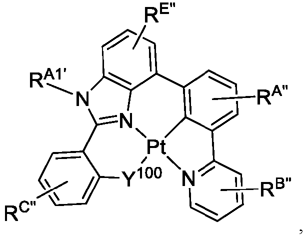 wherein:
each Y¹⁰⁰ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, SO₂, CR", CR"R"', SiR"R‴, GeR"R‴, alkyl, cycloalkyl, aryl, heteroaryl, and combinations thereof;
X¹⁰⁰ and X²⁰⁰ for each occurrence is selected from the group consisting of O, S, Se, NR", and CR"R‴;
each R^{A"}, R^{B"}, R^{C"}, R^{D"}, R^{E"}, and R^{F"} independently represents mono-, up to the maximum substitutions, or no substitutions;
each of R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of the general substituents as defined herein; and any two substituents can be joined or fused to form a ring.

In some embodiments of the above Dopant Groups 1 and 2, each unsubstituted aromatic carbon atom can be replaced with N to form an aza-ring. In some embodiments, the maximum number of N atom in one ring is 1 or 2. In some embodiments of the above Dopant Groups 2, Pt atom in each formula can be replaced by Pd atom.

In some embodiments of the OLED, the delayed fluorescence material comprises at least one donor group and at least one acceptor group. In some embodiments, the delayed fluorescence material is a metal complex. In some embodiments, the delayed fluorescence material is a non-metal complex. In some embodiments, the delayed fluorescence material is a Zn, Cu, Ag, or Au complex.

In some embodiments of the OLED, the delayed fluorescence material has the formula of M(L⁵)(L⁶), wherein M is Cu, Ag, or Au, L⁵ and L⁶ are different, and L⁵ and L⁶ are independently selected from the group consisting of: 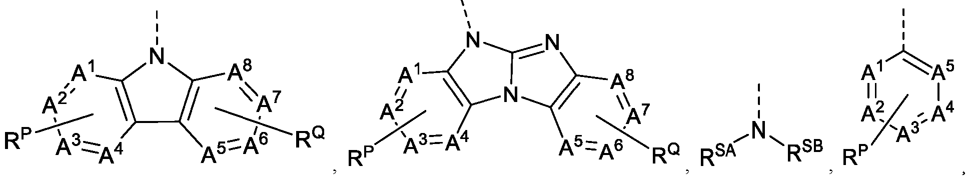 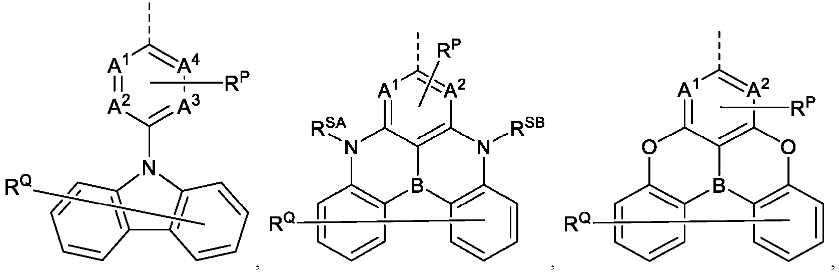 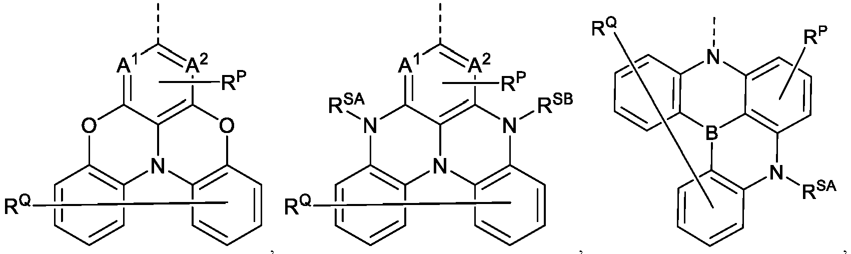 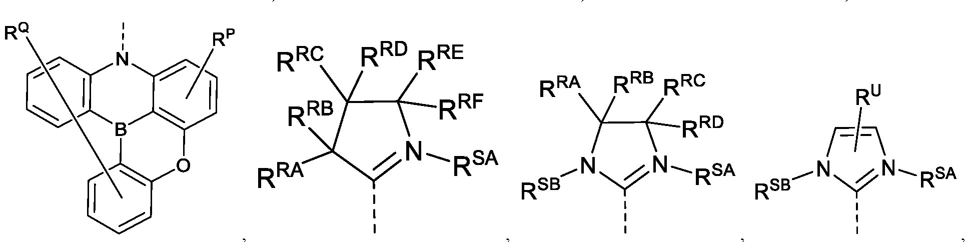 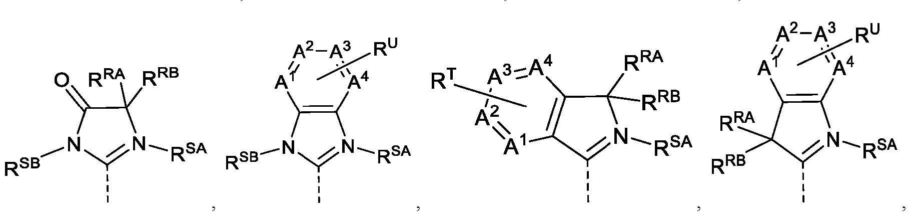 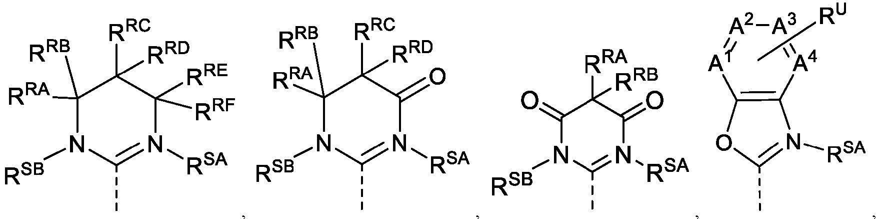 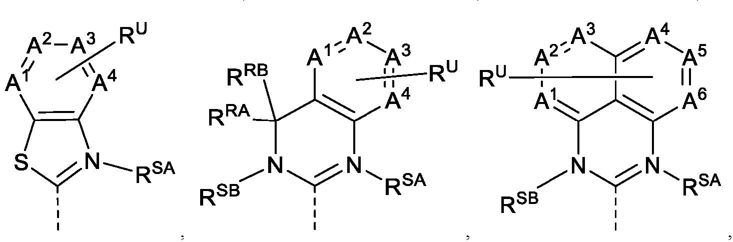 and 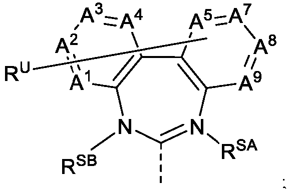
wherein A¹ - A⁹ are each independently selected from C or N;
each R^{P}, R^{Q}, and R^{U} independently represents mono-, up to the maximum substitutions, or no substitutions,
wherein each R^{P}, R^{P}, R^{U}, R^{SA}, R^{SB}, R^{RA}, R^{RB}, R^{RC}, R^{RD}, R^{RE}, and R^{RF} is independently a hydrogen or a substituent selected from the group consisting of the general substituents as defined herein; any two substituents can be joined or fused to form a ring.

In some embodiments of the OLED, the delayed fluorescence material comprises at least one of the donor moieties selected from the group consisting of: 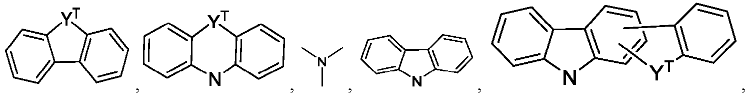 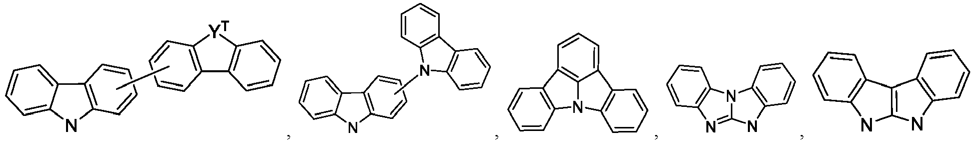 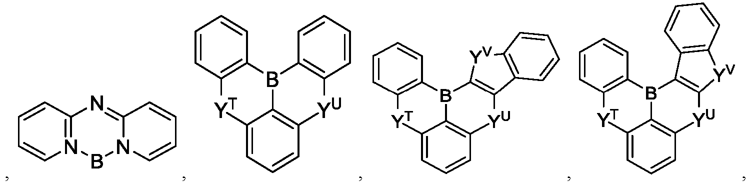 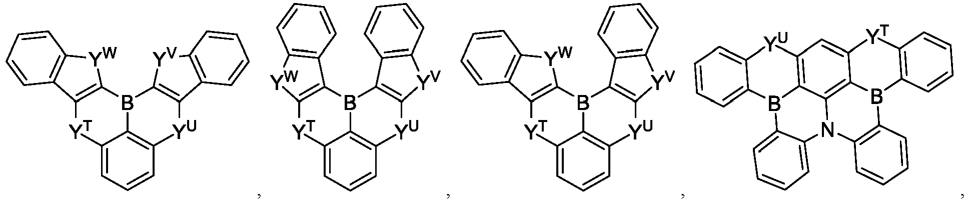 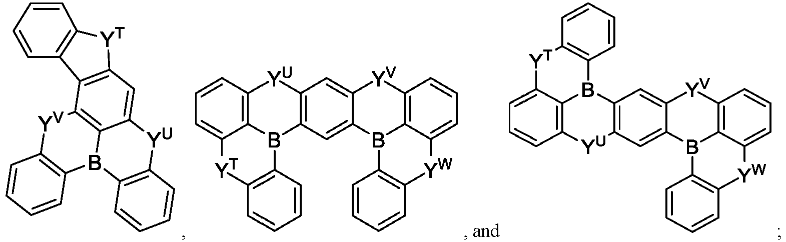 wherein Y^{T}, Y^{U} Y^{V}, and Y^{W} are each independently selected from the group consisting of B, C, Si, Ge, N, P, O, S, Se, C=O, S=O, and SO₂.

In some of the above embodiments, any carbon ring atoms up to maximum of a total number of three, together with their substituents, in each phenyl ring of any of above structures can be replaced with N.

In some embodiments, the delayed fluorescence material comprises at least one of the acceptor moieties selected from the group consisting of nitrile, isonitrile, borane, fluoride, pyridine, pyrimidine, pyrazine, triazine, aza-carbazole, aza-dibenzothiophene, aza-dibenzofuran, aza-dibenzoselenophene, aza-triphenylene, imidazole, pyrazole, oxazole, thiazole, isoxazole, isothiazole, triazole, thiadiazole, and oxadiazole. In some embodiments, the acceptor moieties and the donor moieties as described herein can be connected directly, through a conjugated linker, or a non-conjugated linker, such as a sp³ carbon or silicon atom.

In some embodiments, the fluorescent material comprises at least one of the chemical moieties selected from the group consisting of: 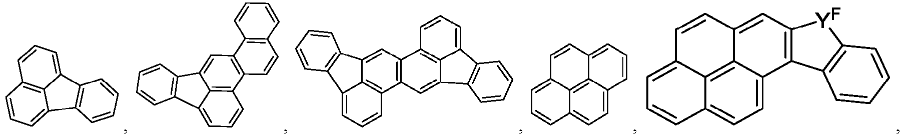 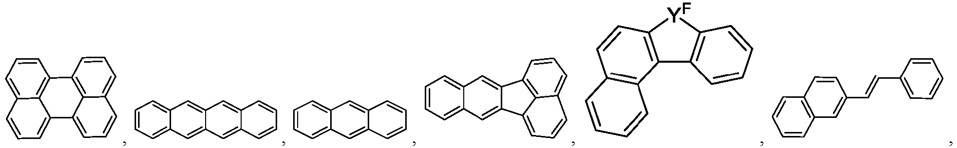 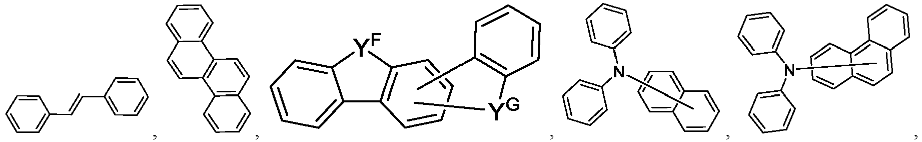 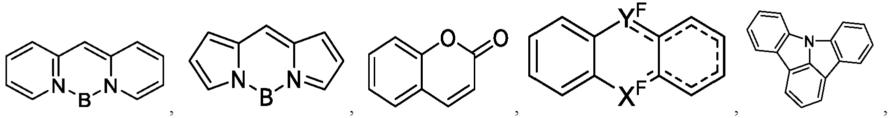 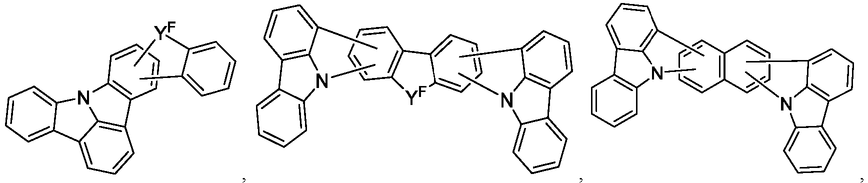 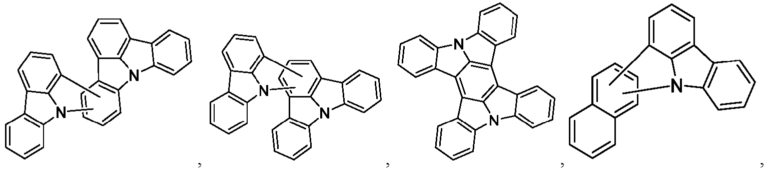 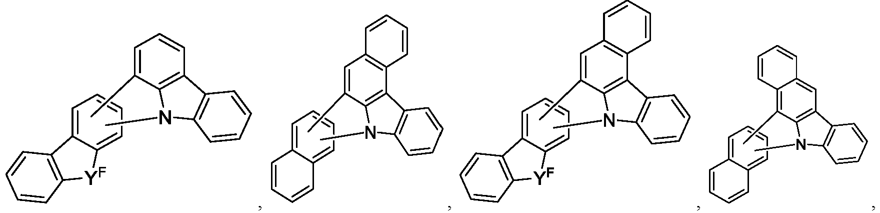 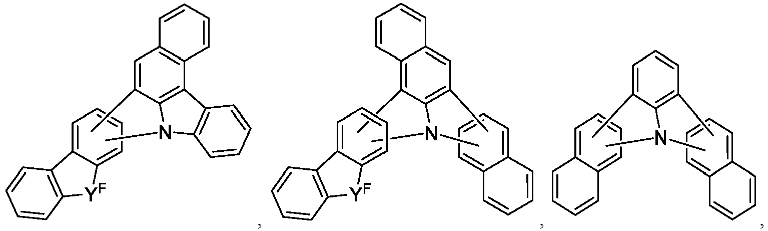 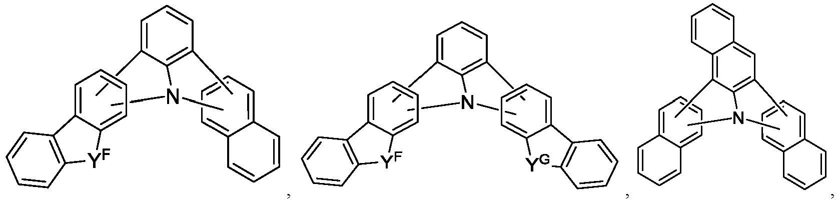 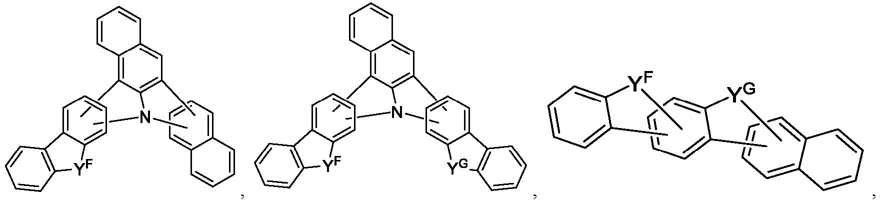 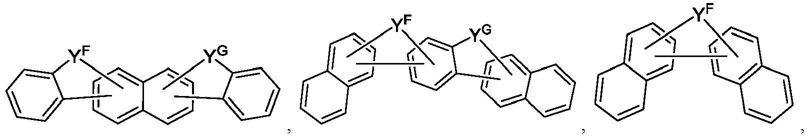 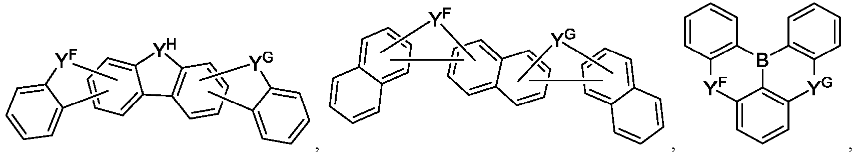 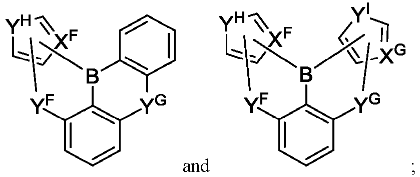
wherein Y^{F}, Y^{G}, Y^{H}, and Y^{I} are each independently selected from the group consisting of B, C, Si, Ge, N, P, O, S, Se, C=O, S=O, and SO₂,
wherein X^{F} and X^{G} are each independently selected from the group consisting of C and N.

In some of the above embodiments, any carbon ring atoms up to maximum of a total number of three, together with their substituents, in each phenyl ring of any of above structures can be replaced with N.

### f) HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further away from the vacuum level) and/or higher triplet energy than one or more of the emitters closest to the HBL interface.

In some embodiments, a compound used in the HBL contains the same molecule or the same functional groups used as host described above.

In some embodiments, a compound used in the HBL comprises at least one of the following moieties selected from the group consisting of: 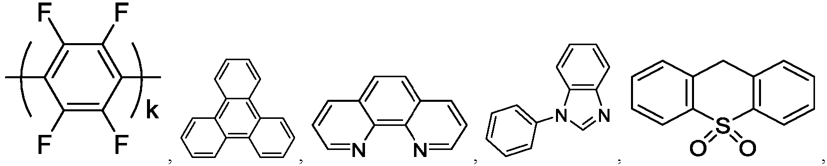 and 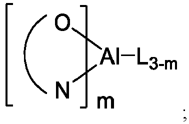 wherein k is an integer from 1 to 20; L¹⁰¹ is another ligand, k' is an integer from 1 to 3.

### g) ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In some embodiments, compound used in ETL comprises at least one of the following moieties in the molecule: 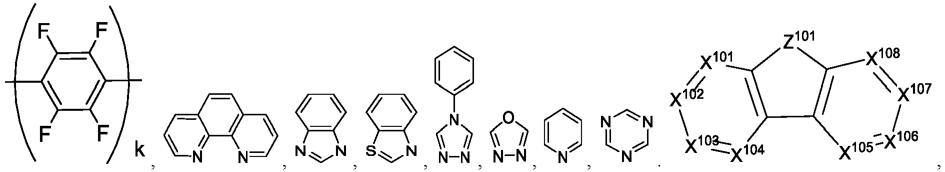 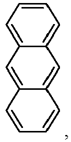 and fullerenes; wherein k is an integer from 1 to 20, X¹⁰¹ to X¹⁰⁸ is selected from C or N; Z¹⁰¹ is selected from the group consisting of C, N, O, and S.

In some embodiments, the metal complexes used in ETL contains, but not limit to the following general formula: 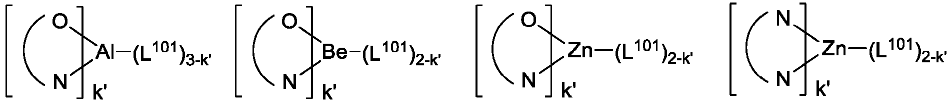 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

In some embodiments, the ETL material is selected from the group consisting of anthracene-benzoimidazole compounds, aza triphenylene derivatives, anthracene-benzothiazole compounds, metal 8-hydroxyquinolates, metal hydroxybenoquinolates, bathocuprine compounds, 5-member ring electron deficient heterocycles (e.g.,triazole, oxadiazole, imidazole, benzoimidazole), silole compounds, arylborane compounds, fluorinated aromatic compounds, fullerene (e.g., C60), triazine complexes, and Zn (N^N) complexes.

### h) Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any compounds disclosed herein, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. As used herein, percent deuteration has its ordinary meaning and includes the percent of all possible hydrogen and deuterium atoms that are replaced by deuterium atoms. In some embodiments, the deuterium atoms are attached to an aromatic ring. In some embodiments, the deuterium atoms are attached to a saturated carbon atom, such as an alkyl or cycloalkyl carbon atom. In some other embodiments, the deuterium atoms are attached to a heteroatom, such as Si, or Ge atom.

It is understood that the various embodiments described herein are by way of example only and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

### E. Experimental Data

### Synthesis of Inventive Compound 1

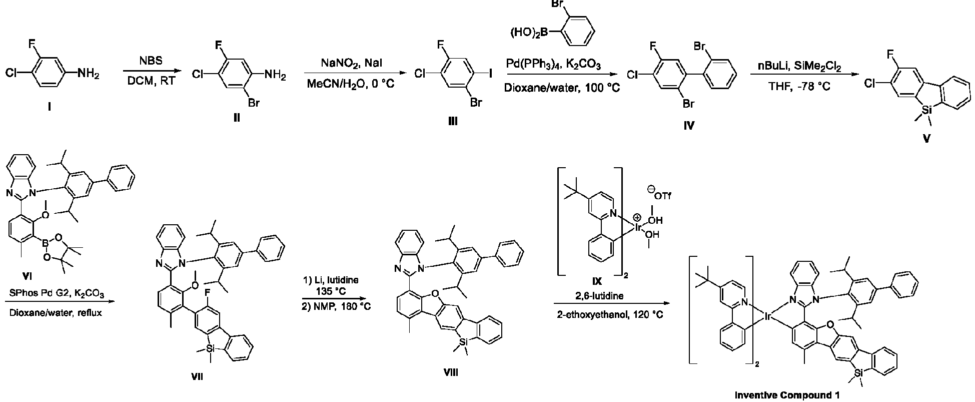

### Synthesis of compound II

To a solution of 4-chloro-3-fluoroaniline **(I)** (24.0 g, 1 Eq, 164.9 mmol) in dichloromethane (DCM) (500 mL) was added N-bromo-succinimide (28 g, 0.95 Eq, 156.6 mmol) in portions over 15 minutes. The mixture was then stirred at room temperature (~22 °C) for 1 hour (an exotherm up to 29 °C was observed). The mixture was washed with water (3 x 250 ml), then the organics were dried over Na₂SO₄, filtered and concentrated to give a brown-purple oil that then solidified to yield compound (**II**) (36.34 g, 98% yield).

### Synthesis of compound III

2-bromo-4-chloro-5-fluoroaniline (**II**) (36.34 g, 1 Eq, 161.9 mmol) was dissolved in MeCN (750 mL) in a 2 L 3-neck round-bottom flask (RBF). The atmosphere was replaced with nitrogen and the reaction cooled using an ice bath. Aqueous 4M hydrogen chloride (405 mL, 4.0 molar, 10 Eq, 1.619 mol) was added dropwise giving a brown suspension. A solution of sodium nitrite (13.40 g, 1.2 Eq, 194.3 mmol) in 40 mL water was added dropwise. The reaction was stirred for 30 minutes, then an outlet for nitrogen was equipped. The reaction was stirred for 1 hour, then the mixture was quenched with 20% sodium thiosulfate solution. The mixture was left overnight (~ 16 hours) then the yellow solid was collected by filtration. The crude was then purified by column chromatography and, upon cooling, yielded an orange solid (**III**) (16.8 g, 24% yield).

### Synthesis of compound IV

A mixture of (2-bromophenyl)boronic acid (9.66 g, 1.2 Eq, 48.09 mmol) and 1-bromo-5-chloro-4-fluoro-2-iodobenzene **(III)** (16.80 g, 80% Wt, 1 Eq, 40.08 mmol) in 1,4-Dioxane (180.0 mL) and Water (20.00 mL) was degassed with bubbling nitrogen for 20 minutes. Tetrakis(triphenylphosphine)palladium (1.6 g, 0.025 Eq, 1.002 mmol) and potassium carbonate (16.62 g, 3 Eq, 120.2 mmol) were added and the mixture was placed under a nitrogen atmosphere. The reaction mixture was heated to 100 °C for a total of 8 hours. The mixture was then cooled to room temperature and the supernatant was decanted. The inorganics were washed with EtOAc (2 x 100 ml) and combined with the reaction supernatant and concentrated in vacuo. The crude was purified by column chromatography and yielded the product **(IV)** as a colorless oil (13.85 g, 86% yield).

### Synthesis of compound V

A solution of 2,2'-dibromo-4-chloro-5-fluoro-1,1'-biphenyl **(IV)** (8.38 g, 1 Eq, 22.99 mmol) in THF (90 mL) was cooled to -78 °C and butyllithium (21 mL, 2.300 molar, 2.05 Eq, 47.14 mmol) was added slowly dropwise. Dichlorodimethylsilane (4.451 g, 4.16 mL, 1.5 Eq, 34.49 mmol) was added quickly and the mixture was allowed to warm to room temperature. The mixture was quenched with saturated aqueous NH₄Cl and the mixture was diluted with EtOAc and washed with water. The organic layer was dried over MgSO₄, filtered and concentrated in vacuo to give a yellow oil. The oil was purified by column chromatography to yield the product **(V)** as a colorless solid (3.41 g, 56% yield).

### Synthesis of compound VII

A solution of 3-chloro-2-fluoro-5,5-dimethyl-5H-dibenzo[b,d]silole **(V)** (4.36 g, 1 Eq, 16.59 mmol) in 1,4-Dioxane (90 mL) and water (9 mL) was degassed. Potassium carbonate (6.879 g, 3 Eq, 49.78 mmol) was added and the mixture was heated to 110 °C and, at temperature, SPhosPdG2 (895 mg, 0.075 Eq, 1.244 mmol) and **(VI)** (11.96 g, 1.2 Eq, 19.91 mmol) were added. The reaction mixture was heated at 110 °C for 4 hours. Additional SPhosPdG2 (0.43 g) added, and heating continued for a total of 18 hours. The mixture was then allowed to cool to room temperature. The mixture was concentrated in vacuo, suspended in dichloromethane (DCM), and concentrated onto silica. The material was purified by column chromatography which yielded the product **(VII)** as an off-white solid (8.39 g, 72% yield).

### Synthesis of compound VIII

A mixture of 1-(3,5-diisopropyl-[1,1'-biphenyl]-4-yl)-2-(3-(2-fluoro-5,5-dimethyl-5H-dibenzo[b,d]silol-3-yl)-2-methoxy-4-methylphenyl)-1H-benzo[d]imidazole **(VII)** (6.46 g, 1 Eq, 9.216 mmol), lithium iodide (7.4 g, 6 Eq, 55.29 mmol) and 2,6-lutidine (35 mL) was heated at 130 °C for 2 hours. N-methyl-2-pyrrolidone (NMP) (60 mL) was added, and the mixture was heated at 165 °C for 2 hours. The mixture was then allowed to cool to room temperature before being poured into water. A red suspension and grey gum formed. The gum was taken and dissolved in DCM and dry-loaded onto silica. The dry-loaded crude was purified by column chromatography to yield the product as a pale-orange-brown oil. The residue was triturated with MeCN resulting in a precipitate. The precipitate was collected by filtration to give a white solid **(VIII)** (2.38 g, 37% yield).

### Synthesis of Inventive Compound 1:

A 250 mL round-bottom flask was charged with dimer (**IX)** (2.629 g, 1.1 Eq, 3.183 mmol), compound **VIII** (1.930 g, 1 Eq, 2.894 mmol), 2,6-dimethylpyridine (620.2 mg, 670 µL, 2 Eq, 5.788 mmol), and 2-ethoxyethanol (96.46 mL), then sparged with N₂ for 20 minutes. The mixture was heated to 120 °C overnight, resulting in a bright yellow suspension. The reaction was cooled to room temperature and concentrated to half volume on a rotary evaporator. Methanol was added to the residue and the resulting yellow solid was collected by filtration and dried *in vacuo.* The crude material was purified by column chromatography resulting in **Inventive Compound 1** (2.23 g, 60% yield).

### Synthesis of inventive compound 2

### Synthesis of Compound X

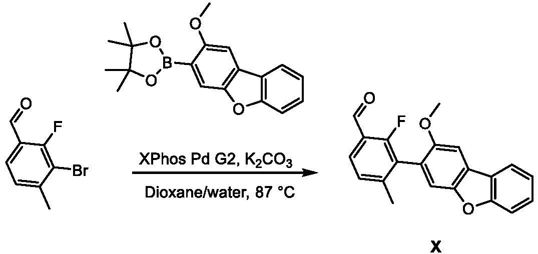

A 3 L flask was charged with 2-(2-methoxydibenzo[b,d]furan-3-yl)-4,4,5,5-tetramethyl-1,3,2-dioxaborolane (39.21 g, 1.05 Eq, 120.9 mmol), 3-bromo-2-fluoro-4-methylbenzaldehyde (25.00 g, 1 Eq, 115.2 mmol), and potassium carbonate (47.76 g, 3.0 Eq, 345.6 mmol). Then 1,4-Dioxane (921.5 mL) and water (230.4 mL) were added. The mixture was sparged with nitrogen for 5 min, then XPhos Pd G2 (4.532 g, 0.05 Eq, 5.759 mmol) was added, and the mixture was heated to 87 °C for 3 hours. The mixture was cooled to room temperature, filtered through a pad of diatomaceous earth (e.g., Celite), and concentrated. The crude mixture was extracted with ethyl acetate, washed with brine, dried, filtered, and concentrated to yield compound X, 44 g yield.

The subsequent synthetic scheme is described below.

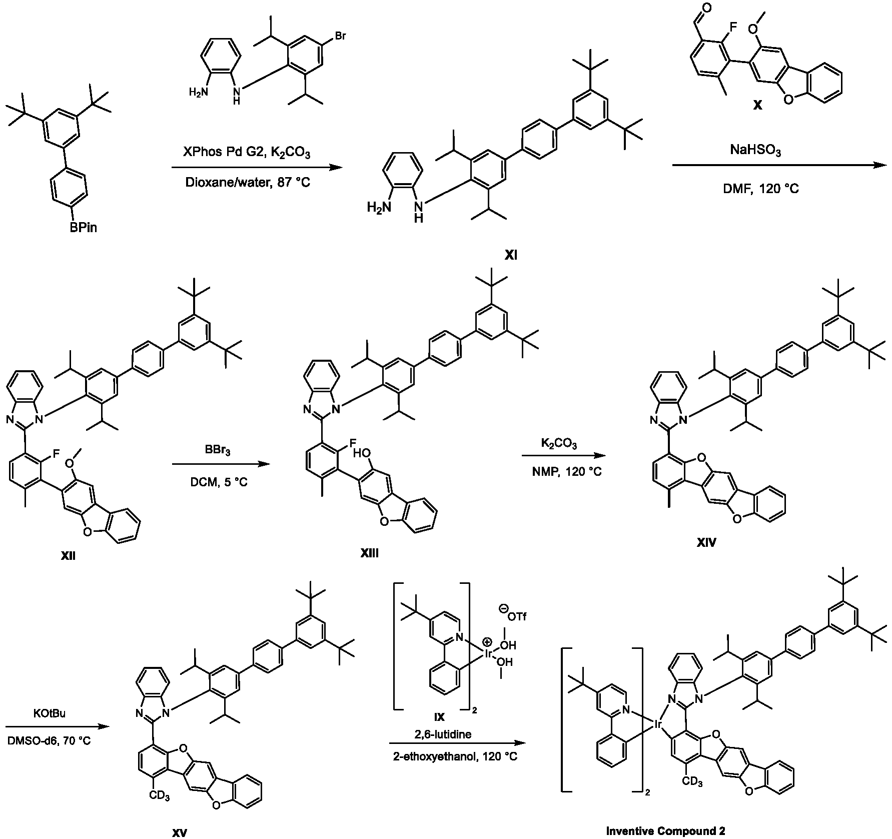

### Synthesis of Compound XI

A 4-neck flask with mechanical stirrer was charged with potassium phosphate (51.34 g, 3 Eq, 241.9 mmol), 2-(3',5'-di-tert-butyl-[1,1'-biphenyl]-4-yl)-4,4,5,5-tetramethyl-1,3,2-dioxaborolane (34.80 g, 1.1 Eq, 88.68 mmol), N1-(4-bromo-2,6-diisopropylphenyl)benzene-1,2-diamine (28.00 g, 1 Eq, 80.62 mmol), 1,4-Dioxane (1 L), and water (230.3 mL). The solution was sparged with nitrogen, then Xphos Pd G2 (2.537 g, 0.04 Eq, 3.225 mmol) was added. The flask was heated to 87 °C for 2 hours and then cooled to room temperature overnight. The mixture was passed through diatomaceous earth, extracted with ethyl acetate, dried and concentrated to yield compound **XI,** 52 g yield.

### Synthesis of Compound XII

A 3 L, 4-neck flask was charged with compound **XI** (50 g), sodium bisulfite (29.29 g, 19.79 mL, 3 Eq, 281.5 mmol), 2-fluoro-3-(2-methoxydibenzo[b,d]furan-3-yl)-4-methylbenzaldehyde **(X)** (40.79 g, 1.3 Eq, 122.0 mmol), and N,N-Dimethylformamide (938.4 mL) and heated to 120 °C for 20 hours followed by cooling to room temperature. The mixture was passed through a plug of diatomaceous earth and concentrated to a purple solid of compound **XII,** 20 g, 70% yield.

### Synthesis of Compound XIII

A 1 L, 4-neck flask, was charged with 1-(3",5"-di-tert-butyl-3,5-diisopropyl-[1,1':4',1"-terphenyl]-4-yl)-2-(2-fluoro-3-(2-methoxydibenzo[b,d]furan-3-yl)-4-methylphenyl)-1H-benzo[d]imidazole (**XII**) (20.00 g, 1 Eq, 23.61 mmol) and dry DCM (393.5 mL) at 5 °C. BBr₃ in DCM (14.79 g, 59.02 mL, 1.000 molar, 2.5 Eq, 59.02 mmol) was added dropwise over 10 min. The reaction mixture was allowed to gradually warm to room temperature overnight. The mixture was poured slowly into an ice solution. The mixture was transferred to a separatory funnel and the aqueous phase was neutralized with saturated sodium bicarbonate. The mixture was extracted with DCM, and the extracts were dried over magnesium sulfate, filtered, and concentrated under vacuum to yield a solid (compound **XIII**), 29 g yield.

### Synthesis of Compound XIV

A 1 L, 4-neck flask was charged with 3-(3-(1-(3",5"-di-tert-butyl-3,5-diisopropyl-[1,1':4',1"-terphenyl]-4-yl)-1H-benzo[d]imidazol-2-yl)-2-fluoro-6-methylphenyl)dibenzo[b,d]furan-2-ol (**XIII**) (29.00 g, 1 Eq, 34.81 mmol) and NMP (290.0 mL), followed by potassium carbonate (14.43 g, 6.115 mL, 3 Eq, 104.4 mmol). The reaction was heated to 120 °C for 16 hour. The reaction was cooled to room temperature, diluted with water, extracted with dichloromethane and concentrated to a heel. The crude material was purified by column chromatography to give desired product **(XIV)** (15 g yield).

### Synthesis of Inventive Compound 2

A solution of compound **IX** (6.1 g, 7.4 mmol), 2,6-dimethylpyridine (2.3 mL, 20.2 mmol) and dimer **XV** (5.5 g, 6.7 mmol) in ethoxyethanol (170 mL) was sparged with N₂ and heated to 120 °C for 18 hours. The reaction was then cooled to room temperature and concentrated to half volume on a rotary evaporator. MeOH was added to the residue and the resulting yellow solid was collected by filtration and dried *in vacuo.* The crude material was purified by column chromatography resulting in 5.2 g of **Inventive Compound 2.**

### Synthesis of Inventive Compound 3

Inventive **Compound 3** can be synthesized via the following route. Suzuki coupling of 2-hydroxyphenylboronic acid with the corresponding iodo, bromo, fluoro aniline followed by intramolecular S_{N}Ar yields the amino, bromo dibenzofuran. Subsequent Sandmeyer conversion of the amino group to an iodide followed by a second Suzuki coupling yields the chlorophenyl-subsituted bromodibenzofuran. Lithiation/silylation followed by dehydrogenative cyclization with Wilkinson's Catalyst yields the fused chloro silylfluorenyl dibenzofuran. Miyaura borylation and Suzuki with the corresponding chloropyridine yields the inventive ligand. Metalation under similar conditions to **Inventive Compound 1** yields **Inventive Compound 3**

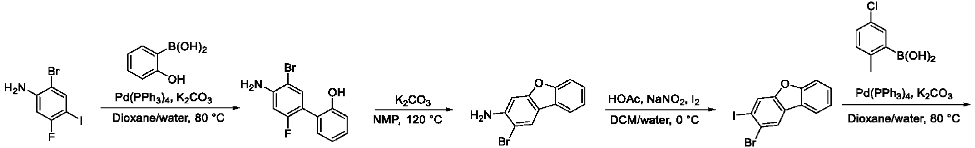

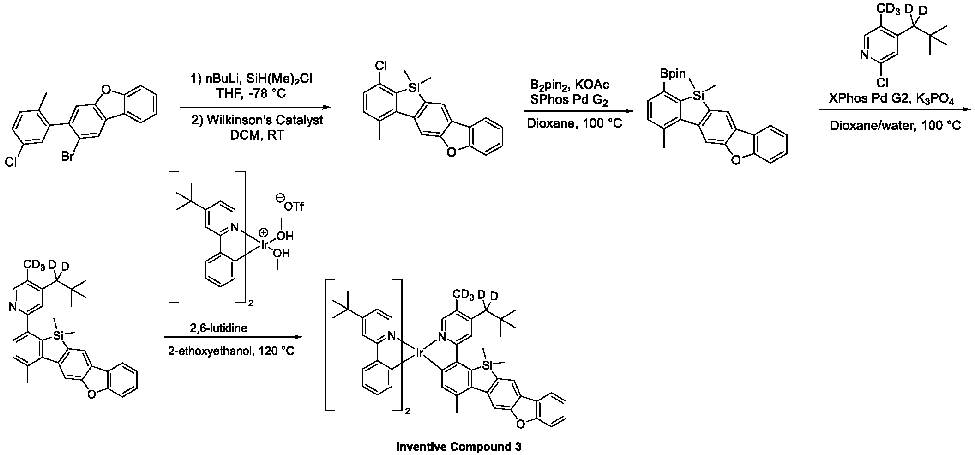

Inventive **Compound 4** can be synthesized via the following route in a manner analogous to **Inventive Compound 1.**

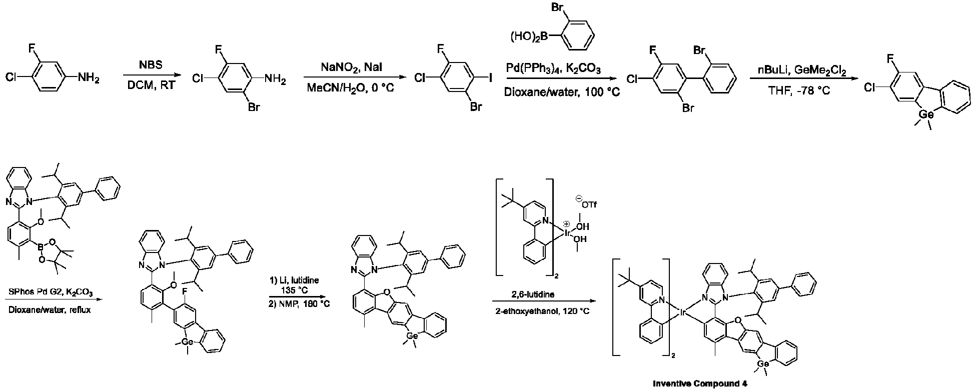

### Device Performance:

All device examples were fabricated by high vacuum (<10⁻⁷ Torr) thermal evaporation (VTE). The anode electrode was 750 Å of indium tin oxide (ITO). The cathode consisted of 10 Å of LiF followed by 1000 Å of Al. All devices were encapsulated with a glass lid sealed with an epoxy resin in a nitrogen glove box ( <1 ppm of H₂O and O₂) immediately after fabrication, and a moisture getter was incorporated inside the package.

The organic stack of the device examples consisted of sequentially, from the ITO surface, 100 Å of HATCN as the hole injection layer (HIL), 400 Å of hole transport material HTM as the hole transport layer (HTL), 50 Å of EBM as an electron blocking layer (EBL), 400 Å of H1 doped with 30 wt% H2 and 5 wt% emitter as the emissive layer (EML), 50 Å of H2 as a blocking layer (BL), and 300 Å of 35% ETM in Liq (8-quinolinolato lithium) as the electron transport layer (ETL). As used herein, HATCN, HTM, EBL, H1, H2, and ETM have the following structures:

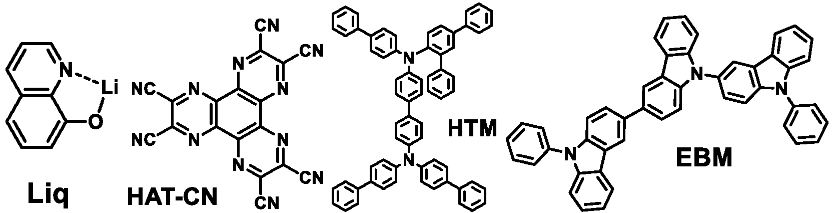

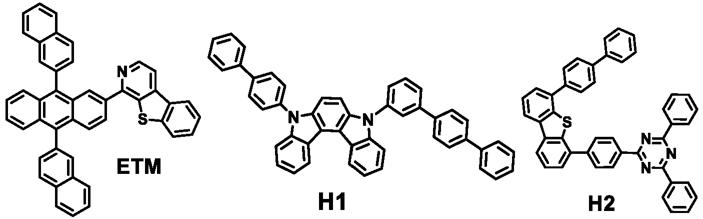

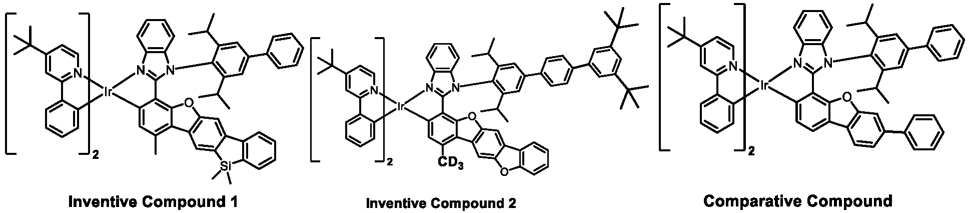

Upon fabrication, the devices were tested to measure electroluminescence (EL) and current-voltage-luminance (JVL). For this purpose, the samples were energized by a 2 channel Keysight B2902A SMU at a current density of 10 mA/cm2 and measured by a Photo Research PR735 Spectroradiometer. Radiance (W/str/cm2) from 380 nm to 1080 nm, and total integrated photon count were collected. The devices were then placed under a large area silicon photodiode for the JVL sweep. The integrated photon count of the device at 10 mA/cm2 is used to convert the photodiode current to photon count. The voltage is swept from 0 to a voltage equating to 200 mA/cm2. The EQE of the device is calculated using the total integrated photon count. All results are summarized in Table 1 below.

**Table 1**

| **Device** | **Emitter** | **λ max [nm]** | **FWHM [nm]** |
|---|---|---|---|
| Device 1 | Inventive Compound 1 | 525 | 52 |
| Device 2 | Inventive Compound 2 | 523 | 54 |
| Device 3 | Comparative Compound | 532 | 60 |

Table 1 summarizes the performance of the electroluminescent inventive devices, one of which contains a dibenzofuran/silyl fluorene fused system, the other of which has a triaryl substituent on the benzimidazole nitrogen, and the comparative compound, with a simple phenyl-substituted dibenzofuran. The inventive compounds are hypsochromically shifted to a more desirable color point, and their emission lineshapes are also significantly narrower than the comparative compound. It is believed that this narrowness can be attributed to the inventive features of fused silylfluorene for Inventive Compound 1, and the terphenyl N-substitution to lower the VDR value for inventive compound 2. Inventive Compound 2 has a VDR value of 0.82 when normalized to the VDR of the comparative compound. All those improvements are significant and unexpected and beyond the possibility of any experimental errors.

VDR is the ensemble average fraction of vertically oriented molecular dipoles of the light-emitting compound in a thin film sample of an emissive layer, where the orientation "vertical" is relative to the plane of the surface of the substrate (i.e., normal to the surface of the substrate plane) on which the thin film sample is formed. A similar concept is horizontal dipole ratio (HDR), which is the ensemble average fraction of horizontally oriented molecular dipoles of the light-emitting compound in a thin film sample of an emissive layer, where the orientation "horizontal" is relative to the plane of the surface of the substrate (i.e. parallel to the surface of the substrate plane) on which the thin film sample is formed. By definition, VDR+HDR = 1. VDR can be measured by angle dependent, polarization dependent, photoluminescence measurements. By comparing the measured emission pattern of a photo-excited thin film test sample, as a function of polarization, to the computationally modeled pattern, one can determine VDR of the thin film test sample emission layer. For example, a modelled data of p-polarized emission is shown in FIG. 3. The modelled p-polarized angle photoluminescence (PL) is plotted for emitters with different VDRs. A peak in the modelled PL is observed in the p-polarized PL around the angle of 45 degrees with the peak PL being greater when the VDR of the emitter is higher. In the example used to generate FIG. 3, a 30 nm thick film of material with a refractive index of 1.75 and the emission is monitored in a semi-infinite medium with a refractive index of 1.75. Each curve is normalized to a photoluminescence intensity of 1 at an angle of zero degrees, which is perpendicular to the surface of the film. As the VDR of the emitter is varied, the peak around 45 degrees increases greatly. When using a software to fit the VDR of experimental data, the modeled VDR would be varied until the difference between the modeled data and the experimental data is minimized.

Inventive compounds and the comparative compounds were evaluated computationally. Calculations were performed using the B3LYP functional with a CEP-31G basis set. Geometry optimizations were performed in vacuum. Excitation energies were obtained at these optimized geometries using time-dependent density functional theory (TDDFT). A continuum solvent model was applied in the TDDFT calculation to simulate tetrahydrofuran solvent. All calculations were carried out using the program Gaussian. The calculations obtained with the above-identified DFT functional set and basis set are theoretical. Computational composite protocols, such as the Gaussian16 with B3LYP and CEP-31G protocol used herein, rely on the assumption that electronic effects are additive and, therefore, larger basis sets can be used to extrapolate to the complete basis set (CBS) limit. However, when the goal of a study is to understand variations in HOMO, LUMO, S1, T1, bond dissociation energies, etc. over a series of structurally-related compounds, the additive effects are expected to be similar. Accordingly, while absolute errors from using the B3LYP may be significant compared to other computational methods, the relative differences between the HOMO, LUMO, S1, T1, and bond dissociation energy values calculated with B3LYP protocol are expected to reproduce experiment quite well. *See, e.g.,* Hong et al., Chem. Mater. 2016, 28, 5791-98, 5792-93 and Supplemental Information (discussing the reliability of DFT calculations in the context of OLED materials). Moreover, with respect to iridium or platinum complexes that are useful in the OLED art, the data obtained from DFT calculations correlate very well to actual experimental data. *See* Tavasli et al., J. Mater. Chem. 2012, 22, 6419-29, 6422 (Table 3) (showing DFT calculations closely correlating with actual data for a variety of emissive complexes); Morello, G.R., J. Mol. Model. 2017, 23:174 (studying of a variety of DFT functional sets and basis sets and concluding the combination of B3LYP and CEP-31G is particularly accurate for emissive complexes). The determination of excited state transition character is performed as a post-processing step on the above-mentioned DFT and TDDFT calculations. This analysis allows for decomposition of the excited state into the hole, *i.e.,* where the excitation originates, and the electron, i.e., the final location of the excited state. Additionally, as this analysis is performed on a calculated property it is objective and repeatable; *see* Mai et al., Coord. Chem. Rev. 2018, 361, 74-97 (discussing the theoretical basis of the excited state decomposition in transition metal complexes).

Table 2, below, summarizes DFT calculated results for the emission wavelength and HOMO and LUMO levels for the Inventive Compounds and one comparative compound. The calculated emission wavelengths for the Inventive Compounds are in a desirable range for OLED applications and the HOMO and LUMO levels are within the typically accepted ranges for OLED applications, and the LUMOs are all in a more desirable range than the comparative compound. Calculations were performed using the B3LYP functional with a CEP-31G basis set. Geometry optimizations were performed in vacuum. Excitation energies were obtained at these optimized geometries using time-dependent density functional theory (TDDFT). A continuum solvent model was applied in the TDDFT calculation to simulate tetrahydrofuran solvent. All calculations were carried out using the program Gaussian.

**Table 2 DFT Calculations**

| **Emitter** | **λ max [nm]** | **HOMO (eV)** | **LUMO (eV)** |
|---|---|---|---|
| Inventive Compound 1 | 521 | -5.04 | -1.55 |
| Inventive Compound 2 | 517 | -5.08 | -1.59 |
| Inventive Compound 3 | 534 | -5.02 | -1.62 |
| Inventive Compound 4 | 521 | -5.04 | -1.53 |
| Comparative Compound | 532 | -5.09 | -2.12 |

## Claims

1. A compound having a first ligand L_{A} comprising a structure of Formula I, 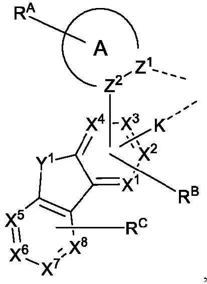 wherein: two adjacent X¹ to X⁸ are C and are joined to a structure of Formula II, 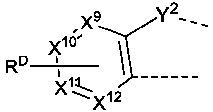 or to a structure of 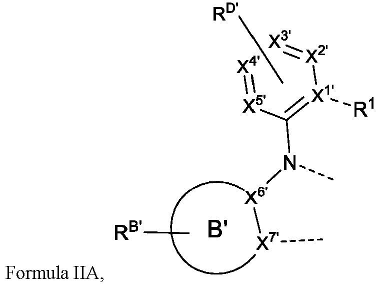 through the indicated dashed lines, with the following provisos:
(1) for Formula II: if Z¹ is N and moiety A is pyridine, then Y² is SiRR' or GeRR'; and
(2) for Formula II: if the ring containing Z¹ to Z² is an imidazole ring, then at least one of the following conditions is true:
(a) Y¹ is CRR', SiRR', or GeRR';
(b) Y² is SiRR' or GeRR'; or
(c) the R^{A} substituent attached to the imidazole ring nitrogen comprises three or more carbocyclic or heterocyclic moieties that are not fused to each other;
(3) for Formula IIA: if R¹ is present, moiety B' containing X^{6'} and X^{7'} is a 6-membered monocyclic ring, and R¹ is not H;
wherein:
each of moiety A and moiety B' is independently a monocyclic ring or a polycyclic fused ring system, wherein the monocyclic ring or each ring of the polycyclic fused ring system is independently a 5-membered to 10-membered carbocyclic or heterocyclic ring;
each of Z¹, Z², X^{1'} to X^{7'}, and X¹ to X¹² is independently C or N;
each of Y¹ and Y² is independently selected from the group consisting of BR, BRR', NR, PR, P(O)R, O, S, Se, C=O, C=S, C=Se, C=NR', C=CRR', S=O, SO₂, CRR', SiRR', GeRR';
K is selected from the group consisting of a direct bond, O, S, N(R^{α}), P(R^{α}), B(R^{α}), C(R^{α})(R^{β}), and Si(R^{α})(R^{β}),
each of R^{A}, R^{B}, R^{B'}, R^{C}, R^{D}, and R^{D'} independently represents mono to the maximum allowable substitution, or no substitution;
each R, R', R¹(if present), R^{α}, R^{β}, R^{A}, R^{B}, R^{B'}, R^{C}, R^{D}, and R^{D'} is independently hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof,
any two substituents may be joined or fused to form a ring;
L_{A} is coordinated to a metal M;
metal M is selected from the group consisting of Ir, Rh, Re, Ru, Os, Pt, Pd, Ag, Au, and Cu.
metal M may be coordinated to other ligands; and
the first ligand L_{A} may be joined with other ligands to comprise a tridentate, tetradentate, pentadentate, or hexadentate ligand.

2. The compound of claim 1, wherein each of moiety A and moiety B' is independently selected from the group consisting of following Cyclic Moiety List: benzene, pyridine, pyrimidine, pyridazine, pyrazine, triazine, imidazole, imidazole-derived carbene, pyrazole, pyrrole, oxazole, furan, thiophene, thiazole, triazole, naphthalene, quinoline, isoquinoline, quinazoline, benzofuran, aza-benzofuran, phenanthro[3,2-b]benzofuran, benzoxazole, aza-benzoxazole, benzothiophene, aza-benzothiophene, benzothiazole, aza-benzothiazole, benzoselenophene, aza-benzoselenophene, indene, aza-indene, indole, azaindole, benzimidazole, benzimidazole-derived carbene, aza-benzimidazole, benzobenzimidazole, aza-benzobenzimidazole, carbazole, aza-carbazole, dibenzofuran, aza-dibenzofuran, dibenzothiophene, aza-dibenzothiophene, quinoxaline, phthalazine, phenanthrene, aza-phenanthrene, anthracene, aza-anthracene, phenanthridine, fluorene, and aza-fluorene; and/or wherein the first ligand L_{A} comprises an electron-withdrawing group selected from the group consisting of the EWG1 LIST defined herein; and/or wherein the R^{A} attached to the imidazole ring nitrogen comprises three or more carbocyclic or heterocyclic moieties that are not fused to each other; and/or wherein two R^{D} are joined or fused to form a moiety D1, wherein moiety D1 is a monocyclic ring or a polycyclic fused ring system, wherein the monocyclic ring or each ring of the polycyclic fused ring system is independently a 5-membered or 6-membered carbocyclic or heterocyclic ring; and/or wherein metal M is Ir or Pt;
and/or
at least one of X¹ to X⁴ is N or wherein each of X¹ to X⁴ is C; and/or wherein at least one of X⁵ to X⁸ is N or wherein each of X⁵ to X⁸ is C; and/or wherein at least one of X⁹ to X¹² is N or wherein each of X⁹ to X¹² is C; and/or wherein two consecutive ones of X⁵ to X⁸ are joined to a structure of Formula II; and/or wherein Z¹ is N and the one of X¹ to X⁴ attached to K is C; and/or wherein Z² is C;
and/or
the ring containing Z¹ to Z² is an imidazole ring and Z¹ and the ring atom close to Z² are N or wherein moiety A is pyridine and Z¹ is N; and/or wherein Y¹ is selected from the group consisting of CRR', SiRR', NR, O, S, and Se; and/or wherein Y² is selected from the group consisting of CRR', SiRR', NR, O, S, and Se; and/or wherein K is a direct bond, O or S; and/or wherein at least one R^{A} comprises a substituent selected from the group consisting of alkyl, cycloalkyl, silyl, germyl, aryl, heteroaryl, and combinations thereof, and/or wherein at least one R^{B} comprises a substituent selected from the group consisting of alkyl, cycloalkyl, silyl, germyl, aryl, heteroaryl, and combinations thereof, and/or wherein at least one R^{C} comprises a substituent selected from the group consisting of alkyl, cycloalkyl, silyl, germyl, aryl, heteroaryl, and combinations thereof, and/or wherein at least one R^{D} comprises a substituent selected from the group consisting of alkyl, cycloalkyl, silyl, germyl, aryl, heteroaryl, and combinations thereof.

3. The compound of claim 1, wherein the first ligand L_{A} comprises a structure of Formula III: 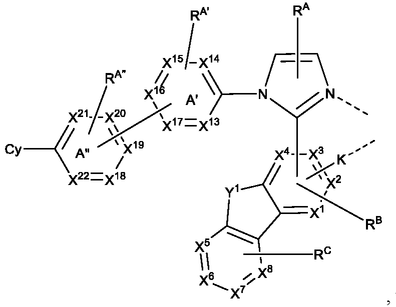 wherein:
moiety Cy is a substituted or unsubstituted monocyclic ring or polycyclic fused ring system, wherein the monocyclic ring or each ring of the polycyclic fused ring system is independently a 5-membered to 10-membered carbocyclic or heterocyclic ring;
each of X¹³ to X²² is independently C or N;
each of R^{A'} and R^{A"} independently represents mono to the maximum allowable substitutions, or no substitutions;
each R^{A'} and R^{A"} is independently hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substituents may be joined or fused to form a ring.

4. The compound of claim 1, wherein the ligand L_{A} is selected from the group consisting of the structures of LIST 4 defined herein;
wherein:
each of X¹-X³¹ is independently C or N;
each of Y¹ to Y² is independently selected from the group consisting of BR, BRR', NR, PR, P(O)R, O, S, Se, C=O, C=S, C=Se, C=NR', C=CRR', S=O, SO₂, CRR', SiRR', GeRR';
Y³ is B, N, P, CR, SiR, or GeR;
R^{A'} represents mono to the maximum allowable substitutions, or no substitutions;
each R^{A'} is independently hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
the remaining variables are the same as previously defined; and
any two adjacent substituents may be fused or joined to form a ring or form a multidentate ligand.

5. The compound of claim 1, wherein the ligand L_{A} is selected from the group consisting of the structures of LIST 5 defined herein; wherein:
each of Y¹ to Y² is independently selected from the group consisting of BR, BRR', NR, PR, P(O)R, O, S, Se, C=O, C=S, C=Se, C=NR', C=CRR', S=O, SO₂, CRR', SiRR', GeRR';
R^{A'} represents mono to the maximum allowable substitutions, or no substitutions;
each R^{A'} is independently hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
the remaining variables are the same as previously defined; and
any two adjacent substituents may be fused or joined to form a ring or form a multidentate ligand.

6. The compound of claim 1, wherein the ligand L_{A} is selected from L_{A*i*}(R*^{J}*)(R*^{K}*)(R^{L})(Y*^{M}*)(Y*^{N}*), wherein i is an integer from 1 to 34, each of R*^{J}*, R*^{K}*, and R^{L} is independently selected from R1 to R411; Y*^{M}* is selected from Y1 to Y50; and Y*^{N'}* is selected from Y1 to Y44; and each of L _{A}1-(R1)(R1)(R1)(Y1)(Y1) to L _{A}34-(R411)(R411)(R411)(Y50)(Y44) is defined in LIST 6 defined herein;
L_{A*i'*}{R*^{J}*)(R*^{K}*)(R^{L})(Y*^{M}*)(Y*^{N}*), wherein *i'* is an integer from 35 to 122, each of R*^{J}*, R*^{K}*, and R^{L} is independently selected from R1 to R411; and each of Y*^{M}* and Y*^{N}* is selected from Y1 to Y50; and each of L _{A}35-(R1)(R1)(R1)(Y1)(Y1) to L _{A}122-(R411)(R411)(R411)(Y50)(Y50) is defined in LIST 7 defined herein;
wherein the ligand L_{A} is selected from L_{A*i"*} (R*^{J}*)(R*^{K}*)(R^{L})(Y*^{M'}*)(Y*^{N}*), wherein *i'* is an integer from 123 to 146, each of R*^{J}*, R*^{K}*, and R^{L} is independently selected from R1 to R411; Y*^{M}* is selected from Y1 to Y47; Y*^{N}* is selected from Y1 to Y50; and each of L _{A}123-(R1)(R1)(R1)(Y1)(Y1) to L _{A}146-(R411)(R411)(R411)(Y47)(Y50) is defined in LIST 8 defined herein;
wherein the ligand L_{A} is selected from L_{A*n*}(R*^{H}*)(R*^{I}*)R*^{J}*)(R*^{K}*)(R^{L})(Y*^{M'}*), wherein n is an integer from 147 to 239, R*^{H}* is selected from V2 to V156; each of R*^{H}*, R*^{I},* R*^{J},* R*^{K},* and R^{L} is independently selected from V1 to V156; Y*^{M}* is selected from Y1 to Y50; and each of L _{A}147-(V2)(V1)(V1)(V1)(V1)(Y1) to L _{A}239-(V156)(V156)(V156)(V156)(V156)(Y50) is defined in LIST 8a defined herein;
wherein the ligand L_{A} is selected from L_{A"*n'*}(R*^{H}*)(R*^{I}*)R*^{J}*)(R*^{K}*)(R^{L})(Y*^{M}*), wherein *n'* is an integer from 1 to 44, R*^{H}* is selected from V2 to V156; each of R*^{J}*, R*^{K}*, R*^{L}*, R*^{M},* and R^{N} is independently selected from V1 to V156; Y*^{M}* is selected from Y1 to Y50; and each of L _{A''}1-(V1)(V1)(V1)(V1)(V1)(Y1) to L_{A"}44-(V156)(V156)(V156)(V156)(V156)(Y50) is defined below in the following LIST 8b;
wherein V1 to V156 have the following structures as defined in LIST 9 defined herein;
wherein Y1 to Y50 have the structures defined in LIST 10 defined herein.

7. The compound of claim 1, wherein the compound has a formula of M(L_{A})ₚ(L_{B})_{q}(L_{C})ᵣ wherein L_{B} and L_{C} are each a bidentate ligand; and wherein p is 1, 2, or 3; q is 0, 1, or 2; r is 0, 1, or 2; and p+q+r is the oxidation state of the metal M.

8. The compound of claim 7, wherein the compound has a formula selected from the group consisting of Ir(L_{A})₃, Ir(L_{A})(L_{B})₂, Ir(L_{A})₂(L_{B}), Ir(L_{A})₂(L_{C}), and Ir(L_{A})(L_{B})(L_{C}); and wherein L_{A}, L_{B}, and L_{C} are different from each other; or a formula of Pt(L_{A})(L_{B}); and wherein L_{A} and L_{B} can be same or different.

9. The compound of claim 7, wherein L_{B} and L_{C} are each independently selected from the group consisting of the structures of LIST 11 defined herein;
wherein:
T is selected from the group consisting of B, Al, Ga, and In;
K^{1'} is selected from the group consisting of a single bond, O, S, NRₑ, PRₑ, BRₑ, CRₑR_{f}, and SiRₑR_{f};
each of Y¹ to Y¹³ is independently selected from the group consisting of C and N;
Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} independently represents from mono to the maximum allowed number of substitutions, or no substitution;
each of Rₐ₁, R_{b1}, R_{c1}, R_{d1}, Rₐ, R_{b}, R_{c}, R_{d}, Rₑ, and R_{f} is independently a hydrogen or a subsituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof; and
any two substituents of Rₐ₁, R_{b1}, R_{c1}, R_{d1}, Rₐ, R_{b}, R_{c}, and R_{d} can be fused or joined to form a ring or form a multidentate ligand.

10. The compound of claim 7, wherein the compound has formula Ir(L_{A})(L_{Bk})₂, formula Ir(L_{A})₂(L_{Bk}), formula Ir(L_{A})₂(L_{C}), or Ir(L_{A})(L_{Bk})(L_{C}),
wherein L_{A} is according to the structures of Formula I defined herein;
wherein k is an integer from 1 to 543, and each L_{B*k*} has the structure defined in LIST 13 defined herein;
wherein L_{C} is selected from L_{C*j*-I} and L_{C*j*-II}, and each L_{C*j*-I} has a structure based on formula 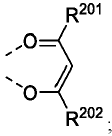
and each L_{C*j*-II} has a structure based on formula 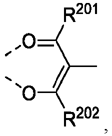 wherein for each L_{C*j*} in L_{C*j*-I} and L_{C*j*-II}, R²⁰¹ and R²⁰² are each independently defined in LIST 14 defined herein;
wherein R^{D1} to R^{D246} have the structures defined in LIST 15 defined herein.

11. The compound of claim 1, wherein the compound is selected from the group consisting of the structures of LIST 17 defined herein.

12. The compound of claim 7, wherein the compound has a structure of Formula IV: 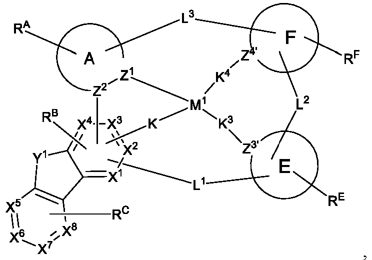 wherein:
M¹ is Pd or Pt;
moieties E and F are each independently a monocyclic ring or a polycyclic fused ring structure, wherein the monocyclic ring or each ring of the polycyclic fused ring structure is independently a 5-membered to 10-membered carbocyclic or heterocyclic ring;
Z^{3'} and Z^{4'} are each independently C or N;
K, K³ and K⁴ are each independently selected from the group consisting of a direct bond, O, and S, wherein at least two of them are direct bonds;
L¹, L², and L³ are each independently absent or selected from the group consisting of a direct bond, BR, BRR', NR, PR, P(O)R, O, S, Se, C=O, C=S, C=Se, C=NR, C=CRR', S=O, SO₂, CR, CRR', SiRR', GeRR', alkylene, cycloalkyl, aryl, cycloalkylene, arylene, heteroarylene, and combinations thereof, wherein at least one of L ¹ and L² is present;
R^{E} and R^{F} each independently represent zero, mono, or up to a maximum allowed number of substitutions;
each of R, R', R^{E}, and R^{F} is independently a hydrogen or a substituent selected from the group consisting of deuterium,
halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof; and
two adjacent R^{A}, R^{B}, R^{C}, R^{E}, and R^{F} can be joined or fused together to form a ring.

13. A compound having a formula Ir(L_{A*})ₓ(L_{B*})_{y}(L_{C*})_{z}, wherein:
x and y are each independently 1 or 2;
z is 0 or 1 or 2;
x + y + z = 3;
L_{A*} comprises a structure of Formula V, 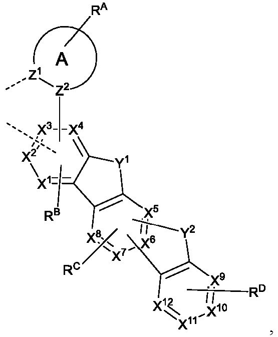
L_{B*} comprises a structure of Formula VI, 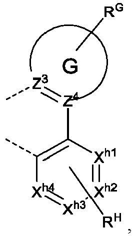
L_{C*} is a bidentate ligand;
X^{h1} - X^{h4} are each independently C or N;
Z³ and Z⁴ are each independently C or N;
moiety G is a monocyclic or a fused polycyclic ring system, wherein the monocyclic ring or each ring of the fused polycyclic ring system is independently a 5-membered to 10-membered carbocyclic or heterocyclic ring;
each R^{G}, and R^{H} independently represents mono to the maximum allowable substitution, or no substitution;
R, R', R^{A}, R^{B}, R^{C}, R^{D}, R^{G}, and R^{H} each are independently [General R-list];
the remaining variables are the same as previously defined;
any two substituents may be joined or fused to form a ring; and
at least one of the following conditions is true:
(1) Y¹ and Y² are different;
(2) at least one R^{B}, R^{C}, or R^{D} substituent comprises a substituted aromatic ring;
(3) at least one R^{B}, R^{C}, or R^{D} substituent comprises two unfused rings;
(4) at least one R^{B}, or one R^{C}, or two R^{D} substituents are not hydrogen;
(5) at least one R^{B}, R^{C}, R^{D} substituent comprises a 5-membered heterocycle;
(6) at least one R^{B}, R^{C}, R^{D} substituent comprises four or more carbon atoms;
(7) at least one of X¹ - X¹² , X^{h1} - X^{h4} is N;
(8) moiety A and moiety G are both 5-membered heterocycles;
(9) moiety A and moiety G together comprise at least four ring N atoms;
(10) at least one of Y¹ and Y² is selected from the group consisting of BR, NR, Se, CRR', SiRR', and GeRR';
(11)R^{B}, R^{C}, and R^{D} collectively comprise at least three substituents that are not hydrogen;
(12) each R^{B}, or each R^{C}, or each R^{D} is deuterium;
(13) at least two R^{G} and two R^{H} substituents are not hydrogen or deuterium;
(14) L_{B} and L_{C} are not identical;
(15)Z¹ is C, and Z² is N;
(16) at least two R^{A}, R^{B}, R^{C}, R^{D}, R^{G}, or R^{H} substituents are joined to form a non-aromatic fused ring;
(17) an R^{G} and an R^{H} substituent are joined to form a ring;
(18) at least one R^{B}, R^{C}, or R^{D} substituent comprises an electron-withdrawing group;
(19) at least two R^{B}, R^{C}, or R^{D} substituents are joined to form an aromatic fused ring;
(20) moiety G is imidazole, and at least one R^{G} substituent comprises silyl;
(21) at least one R^{G} or R^{H} substituent comprises a silicon atom that is not directly attached to moiety G or moiety H;
(21) at least one R^{G} or R^{H} substituent comprises an electron-withdrawing group;
(22) at least one R^{G} or R^{H} substituent is a heterocyclic group;
(23) at least two R^{G} or two R^{H} substituents are joined together to form a fully or partially unsaturated monocyclic or polycyclic ring system;
(24) at one R^{G} substituent and at least one R^{H} substituent are independently a secondary or tertiary alkyl group; or
(25) moiety G is an N-heterocyclic carbene ligand.

14. An organic light emitting device (OLED) comprising:
an anode;
a cathode; and
an organic layer disposed between the anode and the cathode, wherein the organic layer comprises a compound having a first ligand L_{A} comprising a structure of Formula I, 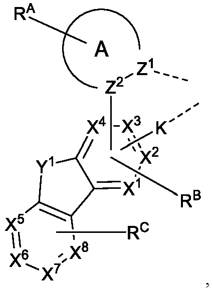 wherein:
two adjacent X¹ to X⁸ are C and are joined to a structure of Formula II, 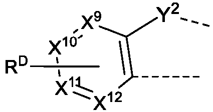 or to a structure of 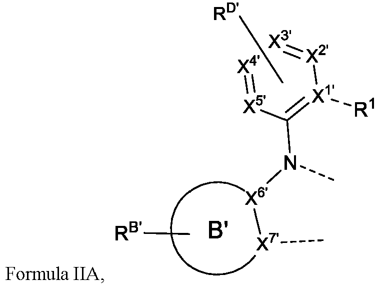 through the indicated dashed lines, with the following provisos:
(1) for Formula II: if Z¹ is N and moiety A is pyridine, then Y² is SiRR' or GeRR'; and
(2) for Formula II: if the ring containing Z¹ to Z² is an imidazole ring, then at least one of the following conditions is true:
(a) Y¹ is CRR', SiRR', or GeRR';
(b) Y² is SiRR' or GeRR'; or
(c) the R^{A} substituent attached to the imidazole ring nitrogen comprises three or more carbocyclic or heterocyclic moieties that are not fused to each other;
(3) for Formula IIA: if R¹ is present, moiety B' containing X^{6'} and X^{7'} is a 6-membered monocyclic ring, and R¹ is not H;
wherein:
each of moiety A and moiety B' is independently a monocyclic ring or a polycyclic fused ring system, wherein the monocyclic ring or each ring of the polycyclic fused ring system is independently a 5-membered to 10-membered carbocyclic or heterocyclic ring;
each of Z¹, Z², X^{1'} to X^{7'}, and X¹ to X¹² is independently C or N;
each of Y¹ and Y² is independently selected from the group consisting of BR, BRR', NR, PR, P(O)R, O, S, Se, C=O, C=S, C=Se, C=NR', C=CRR', S=O, SO₂, CRR', SiRR', GeRR';
K is selected from the group consisting of a direct bond, O, S, N(R^{α}), P(R^{α}), B(R^{α}), C(R^{α})(R^{β}), and Si(R^{α})(R^{β});
each of R^{A}, R^{B}, R^{B'}, R^{C}, R^{D}, and R^{D'} independently represents mono to the maximum allowable substitution, or no substitution;
each R, R', R¹(if present), R^{α}, R^{β}, R^{A}, R^{B}, R^{B'}, R^{C}, R^{D}, and R^{D'} is independently hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
any two substituents may be joined or fused to form a ring;
L_{A} is coordinated to a metal M;
metal M is selected from the group consisting of Ir, Rh, Re, Ru, Os, Pt, Pd, Ag, Au, and Cu.
metal M may be coordinated to other ligands; and
the first ligand L_{A} may be joined with other ligands to comprise a tridentate, tetradentate, pentadentate, or hexadentate ligand.

15. A consumer product comprising an organic light-emitting device (OLED) comprising:
an anode;
a cathode; and
an organic layer disposed between the anode and the cathode, wherein the organic layer comprises a compound according to claim 1.
